# EUROPEAN PATENT SPECIFICATION

(11) **EP 4 386 065 B1**
(45) Date of publication and mention of the grant of the patent: **25.06.2025**
(21) Application number: 23215583.8
(22) Date of filing: 11.12.2023
(51) Int. Cl.: C09K 11/06, H10K 50/11, C07F 15/00, H10K 101/10

(54) **ORGANIC ELECTROLUMINESCENT MATERIALS AND DEVICES**
ORGANISCHE ELEKTROLUMINESZENTE MATERIALIEN UND VORRICHTUNGEN
MATÉRIAUX ÉLECTROLUMINESCENTS ORGANIQUES ET DISPOSITIFS

(30) Priority: 14.12.2022 US 202263387385 P; 27.11.2023 US 202318519217
(43) Date of publication of application: 19.06.2024
(73) Proprietor: Universal Display Corporation, Ewing, NJ 08618 (US)
(72) Inventor: JI, Zhiqiang, Ewing, 08618 (US); BOUDREAULT, Pierre-Luc T., Ewing, 08618 (US); WOZNIAK, Derek Ian, Ewing, 08618 (US); LU, Tongxiang (Aaron), Ewing, 08618 (US); DYATKIN, Alexey Borisovich, Ewing, 08618 (US)
(74) Representative: Dragotti & Associati S.R.L.

(56) References cited:
- EP-A1- 3 539 972
- WO-A1-2015/171627
- WO-A1-2021/233147
- WO-A2-2014/109814
- US-A1- 2014 027 716
- US-A1- 2023 209 991

## Description

### CROSS-REFERENCE TO RELATED APPLICATIONS

This application claims priority under 35 U.S.C. § 119(e) to United States Provisional Application No. 63/387,385, filed on December 14, 2022.

### FIELD

The present disclosure generally relates to organometallic compounds and formulations and their various uses including as emitters in devices such as organic light emitting diodes and related electronic devices.

### BACKGROUND

Opto-electronic devices that make use of organic materials are becoming increasingly desirable for various reasons. Many of the materials used to make such devices are relatively inexpensive, so organic opto-electronic devices have the potential for cost advantages over inorganic devices. In addition, the inherent properties of organic materials, such as their flexibility, may make them well suited for particular applications such as fabrication on a flexible substrate. Examples of organic opto-electronic devices include organic light emitting diodes/devices (OLEDs), organic phototransistors, organic photovoltaic cells, and organic photodetectors. For OLEDs, the organic materials may have performance advantages over conventional materials.

OLEDs make use of thin organic films that emit light when voltage is applied across the device. OLEDs are becoming an increasingly interesting technology for use in applications such as flat panel displays, illumination, and backlighting.

One application for phosphorescent emissive molecules is a full color display. Industry standards for such a display call for pixels adapted to emit particular colors, referred to as "saturated" colors. In particular, these standards call for saturated red, green, and blue pixels. Alternatively, the OLED can be designed to emit white light. In conventional liquid crystal displays emission from a white backlight is filtered using absorption filters to produce red, green and blue emission. The same technique can also be used with OLEDs. The white OLED can be either a single emissive layer (EML) device or a stack structure. Color may be measured using CIE coordinates, which are well known to the art. EP3539972Al discloses a complex M-LA, which comprises ligands similar to Formula I.

### SUMMARY

In one aspect, the present disclosure provides a compound comprising a first ligand L_{A} of Formula I, 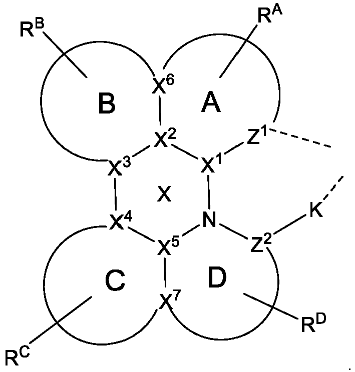 In Formula I:
moieties A, B, C, and D are each independently a monocyclic ring or polycyclic fused ring system, wherein the monocyclic ring and each ring of the polycyclic fused ring system is independently a 5 -membered or 6-membered carbocyclic or heterocyclic ring;
Z¹ and Z² are each independently C or N;
each of X¹ to X⁷ is each independently C or N;
K is selected from the group consisting of a direct bond, O, S, N(R^{α}), P(R^{α}), B(R^{α}), C(R^{α}), C(R^{α})(R^{β}), and Si(R^{α})(R^{β});
R^{A}, R^{B}, R^{C}, and R^{D} each independently represent mono to the maximum allowable substitution, or no substitution;
each R^{α}, R^{β}, R^{A}, R^{B}, R^{C}, and R^{D} is independently a hydrogen or a substituent selected from the group consisting of deuterium, halogen, alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof;
any two substituents may be joined or fused to form a ring;
L_{A} is joined to a metal M that has an atomic mass of at least 40;
M may be coordinated to other ligands; and
L_{A} may be joined with other ligands to comprise a tridentate, tetradentate, pentadentate, or hexadentate ligand.

In another aspect, the present disclosure provides a formulation comprising a compound having a first ligand L_{A} of Formula I as described herein.

In yet another aspect, the present disclosure provides an OLED having an organic layer comprising a compound having a first ligand L_{A} of Formula I as described herein.

In yet another aspect, the present disclosure provides a consumer product comprising an OLED with an organic layer comprising a compound having a first ligand L_{A} of Formula I as described herein.

### BRIEF DESCRIPTION OF THE DRAWINGS

FIG. 1 shows an organic light emitting device.
FIG. 2 shows an inverted organic light emitting device that does not have a separate electron transport layer.

### DETAILED DESCRIPTION

### A. Terminology

Unless otherwise specified, the below terms used herein are defined as follows:

As used herein, the term "organic" includes polymeric materials as well as small molecule organic materials that may be used to fabricate organic opto-electronic devices. "Small molecule" refers to any organic material that is not a polymer, and "small molecules" may actually be quite large. Small molecules may include repeat units in some circumstances. For example, using a long chain alkyl group as a substituent does not remove a molecule from the "small molecule" class. Small molecules may also be incorporated into polymers, for example as a pendent group on a polymer backbone or as a part of the backbone. Small molecules may also serve as the core moiety of a dendrimer, which consists of a series of chemical shells built on the core moiety. The core moiety of a dendrimer may be a fluorescent or phosphorescent small molecule emitter. A dendrimer may be a "small molecule," and it is believed that all dendrimers currently used in the field of OLEDs are small molecules.

As used herein, "top" means furthest away from the substrate, while "bottom" means closest to the substrate. Where a first layer is described as "disposed over" a second layer, the first layer is disposed further away from substrate. There may be other layers between the first and second layer, unless it is specified that the first layer is "in contact with" the second layer. For example, a cathode may be described as "disposed over" an anode, even though there are various organic layers in between.

As used herein, "solution processable" means capable of being dissolved, dispersed, or transported in and/or deposited from a liquid medium, either in solution or suspension form.

A ligand may be referred to as "photoactive" when it is believed that the ligand directly contributes to the photoactive properties of an emissive material. A ligand may be referred to as "ancillary" when it is believed that the ligand does not contribute to the photoactive properties of an emissive material, although an ancillary ligand may alter the properties of a photoactive ligand.

As used herein, and as would be generally understood by one skilled in the art, a first "Highest Occupied Molecular Orbital" (HOMO) or "Lowest Unoccupied Molecular Orbital" (LUMO) energy level is "greater than" or "higher than" a second HOMO or LUMO energy level if the first energy level is closer to the vacuum energy level. Since ionization potentials (IP) are measured as a negative energy relative to a vacuum level, a higher HOMO energy level corresponds to an IP having a smaller absolute value (an IP that is less negative). Similarly, a higher LUMO energy level corresponds to an electron affinity (EA) having a smaller absolute value (an EA that is less negative). On a conventional energy level diagram, with the vacuum level at the top, the LUMO energy level of a material is higher than the HOMO energy level of the same material. A "higher" HOMO or LUMO energy level appears closer to the top of such a diagram than a "lower" HOMO or LUMO energy level.

As used herein, and as would be generally understood by one skilled in the art, a first work function is "greater than" or "higher than" a second work function if the first work function has a higher absolute value. Because work functions are generally measured as negative numbers relative to vacuum level, this means that a "higher" work function is more negative. On a conventional energy level diagram, with the vacuum level at the top, a "higher" work function is illustrated as further away from the vacuum level in the downward direction. Thus, the definitions of HOMO and LUMO energy levels follow a different convention than work functions.

The terms "halo," "halogen," and "halide" are used interchangeably and refer to fluorine, chlorine, bromine, and iodine.

The term "acyl" refers to a substituted carbonyl radical (C(O)-Rₛ).

The term "ester" refers to a substituted oxycarbonyl (-O-C(O)-Rₛ or -C(O)-O-Rₛ) radical.

The term "ether" refers to an -ORₛ radical.

The terms "sulfanyl" or "thio-ether" are used interchangeably and refer to a -SRₛ radical.

The term "selenyl" refers to a -SeRₛ radical.

The term "sulfinyl" refers to a -S(O)-Rₛ radical.

The term "sulfonyl" refers to a -SO₂-Rₛ radical.

The term "phosphino" refers to a -P(Rₛ)₂ radical, wherein each Rₛ can be same or different.

The term "silyl" refers to a -Si(Rₛ)₃ radical, wherein each Rₛ can be same or different.

The term "germyl" refers to a -Ge(Rₛ)₃ radical, wherein each Rₛ can be same or different.

The term "boryl" refers to a -B(Rₛ)₂ radical or its Lewis adduct -B(Rₛ)₃ radical, wherein Rₛ can be same or different.

In each of the above, Rₛ can be hydrogen or a substituent selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, and combination thereof. Preferred Rₛ is selected from the group consisting of alkyl, cycloalkyl, aryl, heteroaryl, and combination thereof.

The term "alkyl" refers to and includes both straight and branched chain alkyl radicals. Preferred alkyl groups are those containing from one to fifteen carbon atoms and includes methyl, ethyl, propyl, 1-methylethyl, butyl, 1-methylpropyl, 2-methylpropyl, pentyl, 1-methylbutyl, 2-methylbutyl, 3-methylbutyl, 1,1-dimethylpropyl, 1,2-dimethylpropyl, 2,2-dimethylpropyl, and the like. Additionally, the alkyl group may be optionally substituted.

The term "cycloalkyl" refers to and includes monocyclic, polycyclic, and spiro alkyl radicals. Preferred cycloalkyl groups are those containing 3 to 12 ring carbon atoms and includes cyclopropyl, cyclopentyl, cyclohexyl, bicyclo[3.1.1]heptyl, spiro[4.5]decyl, spiro[5.5]undecyl, adamantyl, and the like. Additionally, the cycloalkyl group may be optionally substituted.

The terms "heteroalkyl" or "heterocycloalkyl" refer to an alkyl or a cycloalkyl radical, respectively, having at least one carbon atom replaced by a heteroatom. Optionally the at least one heteroatom is selected from O, S, N, P, B, Si and Se, preferably, O, S or N. Additionally, the heteroalkyl or heterocycloalkyl group may be optionally substituted.

The term "alkenyl" refers to and includes both straight and branched chain alkene radicals. Alkenyl groups are essentially alkyl groups that include at least one carbon-carbon double bond in the alkyl chain. Cycloalkenyl groups are essentially cycloalkyl groups that include at least one carbon-carbon double bond in the cycloalkyl ring. The term "heteroalkenyl" as used herein refers to an alkenyl radical having at least one carbon atom replaced by a heteroatom. Optionally the at least one heteroatom is selected from O, S, N, P, B, Si, and Se, preferably, O, S, or N. Preferred alkenyl, cycloalkenyl, or heteroalkenyl groups are those containing two to fifteen carbon atoms. Additionally, the alkenyl, cycloalkenyl, or heteroalkenyl group may be optionally substituted.

The term "alkynyl" refers to and includes both straight and branched chain alkyne radicals. Alkynyl groups are essentially alkyl groups that include at least one carbon-carbon triple bond in the alkyl chain. Preferred alkynyl groups are those containing two to fifteen carbon atoms. Additionally, the alkynyl group may be optionally substituted.

The terms "aralkyl" or "arylalkyl" are used interchangeably and refer to an alkyl group that is substituted with an aryl group. Additionally, the aralkyl group may be optionally substituted.

The term "heterocyclic group" refers to and includes aromatic and non-aromatic cyclic radicals containing at least one heteroatom. Optionally the at least one heteroatom is selected from O, S, N, P, B, Si, and Se, preferably, O, S, or N. Hetero-aromatic cyclic radicals may be used interchangeably with heteroaryl. Preferred hetero-non-aromatic cyclic groups are those containing 3 to 7 ring atoms which includes at least one hetero atom, and includes cyclic amines such as morpholino, piperidino, pyrrolidino, and the like, and cyclic ethers/thio-ethers, such as tetrahydrofuran, tetrahydropyran, tetrahydrothiophene, and the like. Additionally, the heterocyclic group may be optionally substituted.

The term "aryl" refers to and includes both single-ring aromatic hydrocarbyl groups and polycyclic aromatic ring systems. The polycyclic rings may have two or more rings in which two carbons are common to two adjoining rings (the rings are "fused") wherein at least one of the rings is an aromatic hydrocarbyl group, e.g., the other rings can be cycloalkyls, cycloalkenyls, aryl, heterocycles, and/or heteroaryls. Preferred aryl groups are those containing six to thirty carbon atoms, preferably six to twenty carbon atoms, more preferably six to twelve carbon atoms. Especially preferred is an aryl group having six carbons, ten carbons or twelve carbons. Suitable aryl groups include phenyl, biphenyl, triphenyl, triphenylene, tetraphenylene, naphthalene, anthracene, phenalene, phenanthrene, fluorene, pyrene, chrysene, perylene, and azulene, preferably phenyl, biphenyl, triphenyl, triphenylene, fluorene, and naphthalene. Additionally, the aryl group may be optionally substituted.

The term "heteroaryl" refers to and includes both single-ring aromatic groups and polycyclic aromatic ring systems that include at least one heteroatom. The heteroatoms include, but are not limited to O, S, N, P, B, Si, and Se. In many instances, O, S, or N are the preferred heteroatoms. Hetero-single ring aromatic systems are preferably single rings with 5 or 6 ring atoms, and the ring can have from one to six heteroatoms. The hetero-polycyclic ring systems can have two or more rings in which two atoms are common to two adjoining rings (the rings are "fused") wherein at least one of the rings is a heteroaryl, e.g., the other rings can be cycloalkyls, cycloalkenyls, aryl, heterocycles, and/or heteroaryls. The hetero-polycyclic aromatic ring systems can have from one to six heteroatoms per ring of the polycyclic aromatic ring system. Preferred heteroaryl groups are those containing three to thirty carbon atoms, preferably three to twenty carbon atoms, more preferably three to twelve carbon atoms. Suitable heteroaryl groups include dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine, preferably dibenzothiophene, dibenzofuran, dibenzoselenophene, carbazole, indolocarbazole, imidazole, pyridine, triazine, benzimidazole, 1,2-azaborine, 1,3-azaborine, 1,4-azaborine, borazine, and aza-analogs thereof. Additionally, the heteroaryl group may be optionally substituted.

Of the aryl and heteroaryl groups listed above, the groups of triphenylene, naphthalene, anthracene, dibenzothiophene, dibenzofuran, dibenzoselenophene, carbazole, indolocarbazole, imidazole, pyridine, pyrazine, pyrimidine, triazine, and benzimidazole, and the respective aza-analogs of each thereof are of particular interest.

The terms alkyl, cycloalkyl, heteroalkyl, heterocycloalkyl, alkenyl, cycloalkenyl, heteroalkenyl, alkynyl, aralkyl, heterocyclic group, aryl, and heteroaryl, as used herein, are independently unsubstituted, or independently substituted, with one or more General Substituents.

In many instances, the General Substituents are selected from the group consisting of deuterium, halogen, alkyl, cycloalkyl, heteroalkyl, heterocycloalkyl, arylalkyl, alkoxy, aryloxy, amino, silyl, germyl, boryl, alkenyl, cycloalkenyl, heteroalkenyl, alkynyl, aryl, heteroaryl, acyl, carboxylic acid, ether, ester, nitrile, isonitrile, sulfanyl, selenyl, sulfinyl, sulfonyl, phosphino, and combinations thereof.

In some instances, the Preferred General Substituents are selected from the group consisting of deuterium, fluorine, alkyl, cycloalkyl, heteroalkyl, alkoxy, aryloxy, amino, silyl, germyl, boryl, alkenyl, cycloalkenyl, heteroalkenyl, aryl, heteroaryl, nitrile, isonitrile, sulfanyl, and combinations thereof.

In some instances, the More Preferred General Substituents are selected from the group consisting of deuterium, fluorine, alkyl, cycloalkyl, alkoxy, aryloxy, amino, silyl, aryl, heteroaryl, sulfanyl, and combinations thereof.

In yet other instances, the Most Preferred General Substituents are selected from the group consisting of deuterium, fluorine, alkyl, cycloalkyl, aryl, heteroaryl, and combinations thereof.

The terms "substituted" and "substitution" refer to a substituent other than H that is bonded to the relevant position, e.g., a carbon or nitrogen. For example, when R¹ represents mono-substitution, then one R¹ must be other than H (i.e., a substitution). Similarly, when R¹ represents di-substitution, then two of R¹ must be other than H. Similarly, when R¹ represents zero or no substitution, R¹, for example, can be a hydrogen for available valencies of ring atoms, as in carbon atoms for benzene and the nitrogen atom in pyrrole, or simply represents nothing for ring atoms with fully filled valencies, e.g., the nitrogen atom in pyridine. The maximum number of substitutions possible in a ring structure will depend on the total number of available valencies in the ring atoms.

As used herein, "combinations thereof" indicates that one or more members of the applicable list are combined to form a known or chemically stable arrangement that one of ordinary skill in the art can envision from the applicable list. For example, an alkyl and deuterium can be combined to form a partial or fully deuterated alkyl group; a halogen and alkyl can be combined to form a halogenated alkyl substituent; and a halogen, alkyl, and aryl can be combined to form a halogenated arylalkyl. In one instance, the term substitution includes a combination of two to four of the listed groups. In another instance, the term substitution includes a combination of two to three groups. In yet another instance, the term substitution includes a combination of two groups. Preferred combinations of substituent groups are those that contain up to fifty atoms that are not hydrogen or deuterium, or those which include up to forty atoms that are not hydrogen or deuterium, or those that include up to thirty atoms that are not hydrogen or deuterium. In many instances, a preferred combination of substituent groups will include up to twenty atoms that are not hydrogen or deuterium.

The "aza" designation in the fragments described herein, i.e. aza-dibenzofuran, aza-dibenzothiophene, etc. means that one or more of the C-H groups in the respective aromatic ring can be replaced by a nitrogen atom, for example, and without any limitation, azatriphenylene encompasses both dibenzo[*f,h*]quinoxaline and dibenzo[*f,h*]quinoline One of ordinary skill in the art can readily envision other nitrogen analogs of the aza-derivatives described above, and all such analogs are intended to be encompassed by the terms as set forth herein.

As used herein, "deuterium" refers to an isotope of hydrogen. Deuterated compounds can be readily prepared using methods known in the art. For example, U.S. Pat. No. 8,557,400, Patent Pub. No. WO 2006/095951, and U.S. Pat. Application Pub. No. US 2011/0037057, describe the making of deuterium-substituted organometallic complexes. Further reference is made to Ming Yan, et al., Tetrahedron 2015, 71, 1425-30 and Atzrodt et al., Angew. Chem. Int. Ed. (Reviews) 2007, 46, 7744-65, describe the deuteration of the methylene hydrogens in benzyl amines and efficient pathways to replace aromatic ring hydrogens with deuterium, respectively.

It is to be understood that when a molecular fragment is described as being a substituent or otherwise attached to another moiety, its name may be written as if it were a fragment (e.g. phenyl, phenylene, naphthyl, dibenzofuryl) or as if it were the whole molecule (e.g. benzene, naphthalene, dibenzofuran). As used herein, these different ways of designating a substituent or attached fragment are considered to be equivalent.

In some instance, a pair of adjacent substituents can be optionally joined or fused into a ring. The preferred ring is a five, six, or seven-membered carbocyclic or heterocyclic ring, includes both instances where the portion of the ring formed by the pair of substituents is saturated and where the portion of the ring formed by the pair of substituents is unsaturated. As used herein, "adjacent" means that the two substituents involved can be on the same ring next to each other, or on two neighboring rings having the two closest available substitutable positions, such as 2, 2' positions in a biphenyl, or 1, 8 position in a naphthalene, as long as they can form a stable fused ring system.

### B. The Compounds of the Present Disclosure

Novel emitters with rigid ligands are disclosed herein to improve OLED device performance.

In one aspect, the present disclosure provides a compound comprising a first ligand L_{A} of Formula I, 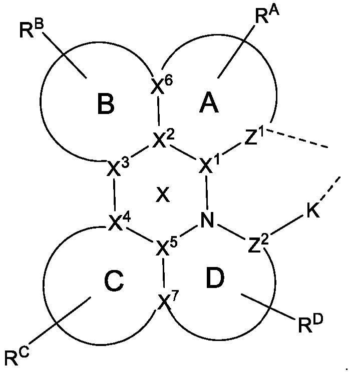 In Formula I:
moieties A, B, C, and D are each independently a monocyclic ring or polycyclic fused ring system, wherein the monocyclic ring and each ring of the polycyclic fused ring system is independently a 5 -membered or 6-membered carbocyclic or heterocyclic ring;
Z¹ and Z² are each independently C or N;
each of X¹ to X⁷ is each independently C or N;
K is selected from the group consisting of a direct bond, O, S, N(R^{α}), P(R^{α}), B(R^{α}), C(R^{α}), C(R^{α})(R^{β}), and Si(R^{α})(R^{β});
R^{A}, R^{B}, R^{C}, and R^{D} each independently represent mono to the maximum allowable substitution, or no substitution;
each R^{α}, R^{β}, R^{A}, R^{B}, R^{C}, and R^{D} is independently a hydrogen or a substituent selected from the group consisting of the General Substituents defined herein;
any two substituents may be joined or fused to form a ring;
L_{A} is joined to a metal M that has an atomic mass of at least 40;
M may be coordinated to other ligands; and
L_{A} may be joined with other ligands to comprise a tridentate, tetradentate, pentadentate, or hexadentate ligand.

It should be understood that for Formula I, the bonds between Z¹-X¹, X¹-X², X²-X⁶, X²-X³, X³-X⁴, X⁴-X⁵, and X⁵-X⁷ can be either a single bond or a double bond since they are all parts of moieties A, B, C and D which all allow single and/or double bonds, and the way all those identified bonds are all drawn in a single line is just for simplicity. In some embodiments, the identified bonds have a net, neutral charge. In some embodiments, the first ligand L_{A} will have a negative (*e.g.,* -1, -2) charge. In some embodiments, the first ligand L_{A} will have a neutral charge.

In some embodiments, each R, R^{α}, R^{β}, R^{A}, R^{B}, R^{C}, and R^{D} is independently a hydrogen or a substituent selected from the group consisting of the Preferred General Substituents defined herein. In some embodiments, each R, R^{α}, R^{β}, R^{A}, R^{B}, R^{C}, and R^{D} is independently a hydrogen or a substituent selected from the group consisting of the More Preferred General Substituents defined herein. In some embodiments, each R, R^{α}, R^{β}, R^{A}, R^{B}, R^{C}, and R^{D} is independently a hydrogen or a substituent selected from the group consisting of the Most Preferred General Substituents defined herein.

In some embodiments, metal M is selected from the group consisting of Ir, Rh, Re, Ru, Os, Pt, Pd, Ag, Au, and Cu. In some embodiments, metal M is Ir. In some embodiments, metal M is Pt.

In some embodiments, K is a direct bond. In some embodiments, K is O or S.

In some embodiments, K is selected from the group consisting of N(R^{α}), P(R^{α}), B(R^{α}), C(R^{α}), C(R^{α})(R^{β}), and Si(R^{α})(R^{β}). In some such embodiments, at least one of R^{α} or R^{β} is joined with R^{D} to form a ring fused to moiety D. In some such embodiments, at least one of R^{α} or R^{β} is joined with R^{D} to form a ring fused to moiety D. I some such embodiments, K is C(R^{α}) and R^{α} is joined with R^{D} to form a ring fused to moiety D. In some embodiments, the ring fused to moiety D is an aromatic ring. In some embodiments, the ring fused to moiety D is a benzene ring. In some embodiments, the ring fused to moiety D is naphthalene.

In some embodiments, moieties A, B, C, and D are each independently a monocyclic ring or polycyclic fused ring system, wherein the monocyclic ring and each ring of the polycyclic fused ring system is independently a 5-membered or 6-membered aryl or heteroaryl ring. In some embodiments, each one of moieties A, B, C, and D is aromatic.

In some embodiments, at least one ring of moiety A, moiety B, moiety C, or moiety D that forms a part of ring X is a 5-membered ring. In some embodiments, exactly one ring of moiety A, moiety B, moiety C, or moiety D that forms a part of ring X is a 5-membered ring. In some such embodiments, moiety A is a 5-membered ring. In some such embodiments, moiety B is a 5-membered ring. In some such embodiments, moiety C is a 5-membered ring. In some such embodiments, moiety D is a 5-membered ring.

In some embodiments, at least two rings of moiety A, moiety B, moiety C, or moiety D that form a part of ring X are 5-membered rings. In some embodiments, exactly two rings of moiety A, moiety B, moiety C, or moiety D that form a part of ring X are 5-membered rings. In some embodiments, the rings of moiety B and moiety D that form a part of ring X are 5-membered rings.

In some embodiments, each of moiety A, moiety B, moiety C, and moiety D is a monocyclic ring.

In some embodiments, each of moieties A, B, C, and D is independently selected from the group consisting of benzene, pyridine, pyrrole, furan, thiophene, thiazole, benzofuran, benzothiophene, and indole.

In some embodiments, at least one of moiety A, moiety B, moiety C, or moiety D is a polycyclic fused ring system. In some embodiments, exactly one of moiety A, moiety B, moiety C, or moiety D is a polycyclic fused ring system. In some embodiments, only moiety B is a polycyclic fused ring system.

In some embodiments, each of moieties A, B, C, and D is independently selected from the group consisting of benzene, pyridine, pyrimidine, pyridazine, pyrazine, triazine, imidazole, pyrazole, pyrrole, oxazole, furan, thiophene, thiazole, triazole, naphthalene, quinoline, isoquinoline, quinazoline, benzofuran, aza-benzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, aza-benzimidazole, carbazole, aza-carbazole, dibenzofuran, aza-dibenzofuran, dibenzothiophene, aza-dibenzothiophene, quinoxaline, phthalazine, phenanthrene, aza-phenanthrene, anthracene, aza-antracene, phenanthridine, fluorene, and aza-fluorene.

In some embodiments, moiety A is pyridine.

In some embodiments, moiety B is selected from the group consisting of benzene, naphthalene, furan, thiophene, pyrrole, indole, benzothiophene, and benzofuran.

In some embodiments, moiety C is benzene.

In some embodiments, moiety D is benzene or pyrrole.

In some embodiments, Z¹ is N and Z² is C. In some embodiments, Z¹ is carbene carbon and Z² is C.

In some embodiments, each of X¹ to X⁷ is C.

In some embodiments, at least one of X¹ to X⁷ is N. In some embodiments, exactly one of X¹ to X⁷ is N.

In some embodiments, X³ is N and each of X¹, X², and X⁴ to X⁷ is C.

In some embodiments, at least two of X¹ to X⁷ are N. In some embodiments, exactly two of X¹ to X⁷ are N.

In some embodiments, at least one R^{A} is not hydrogen. In some embodiments, at least one R^{B} is not hydrogen. In some embodiments, at least one R^{C} is not hydrogen. In some embodiments, at least one R^{D} is not hydrogen.

In some embodiments, each R^{A} is hydrogen. In some embodiments, each R^{B} is hydrogen. In some embodiments, each R^{C} is hydrogen. In some embodiments, each R^{D} is hydrogen.

In some embodiments, one R^{A} is joined to one R^{B} to form a ring.

In some embodiments, one R^{B} is joined to one R^{C} to form a ring.

In some embodiments, one R^{C} is joined to one R^{D} to form a ring.

In some embodiments, two R^{A}, two R^{B}, two R^{C}, or two R^{D} are joined to form a polycyclic fused ring structure comprising three or more rings.

In some embodiments, one R^{C} and one R^{D}, one R^{C} and one R^{B}, or one R^{A} and one R^{B} can be joined to form a polycyclic fused ring structure.

In some embodiments, each of moieties A, B, C, and D can independently be a polycyclic fused ring structure. In some embodiments, each of moieties A, B, C, and D can independently be a polycyclic fused ring structure comprising at least three fused rings. In some embodiments, the polycyclic fused ring structure has two 6-membered rings and one 5-membered ring. In some such embodiments, the 5-membered ring of moiety A or moiety D can be fused to the ring coordinated to metal M and the second 6-membered ring is fused to the 5-membered ring. In some embodiments, each of moieties A, B, C, and D can independently be selected from the group consisting of dibenzofuran, dibenzothiophene, dibenzoselenophene, and aza-variants thereof. In some such embodiments, each of moieties A, B, C, and D can independently be further substituted at the ortho- or meta-position of the O, S, or Se atom by a substituent selected from the group consisting of deuterium, fluorine, nitrile, alkyl, cycloalkyl, aryl, heteroaryl, and combinations thereof. In some such embodiments, the aza-variants contain exactly one N atom at the 6-position (ortho to the O, S, or Se) with a substituent at the 7-position (meta to the O, S, or Se).

In some embodiments, each of moieties A, B, C, and D can independently be a polycyclic fused ring structure comprising at least four fused rings. In some embodiments, the polycyclic fused ring structure comprises three 6-membered rings and one 5-membered ring. In some such embodiments, the 5-membered ring of moiety A or moiety D can be fused to the ring coordinated to metal M, the second 6-membered ring is fused to the 5-membered ring, and the third 6-membered ring is fused to the second 6-membered ring. In some such embodiments, the third 6-membered ring is further substituted by a substituent selected from the group consisting of deuterium, fluorine, nitrile, alkyl, cycloalkyl, aryl, heteroaryl, and combinations thereof.

In some embodiments, each of moieties A, B, C, and D can independently be a polycyclic fused ring structure comprising at least five fused rings. In some embodiments, the polycyclic fused ring structure comprises four 6-membered rings and one 5-membered ring or three 6-membered rings and two 5-membered rings. In some embodiments comprising two 5-membered rings, the 5-membered rings are fused together. In some embodiments comprising two 5-membered rings, the 5-membered rings are separated by at least one 6-membered ring. In some embodiments of moiety A or moiety D with one 5-membered ring, the 5-membered ring is fused to the ring coordinated to metal M, the second 6-membered ring is fused to the 5-membered ring, the third 6-membered ring is fused to the second 6-membered ring, and the fourth 6-membered ring is fused to the third-6-membered ring.

In some embodiments, each moieties A, B, C, and D can independently be an aza version of the polycyclic fused rings described above. In some such embodiments, each moieties A, B, C, and D can independently contain exactly one aza N atom. In some such embodiments, each moieties A, B, C, and D can contain exactly two aza N atoms, which can be in one ring, or in two different rings. In some such embodiments, the ring of moiety A and moiety D having aza N atom can be separated by at least two other rings from the metal M atom. In some such embodiments, the ring of moiety A and moiety D having aza N atom is separated by at least three other rings from the metal M atom. In some such embodiments, each of the ortho position of the aza N atom is substituted.

In some embodiments, the compound comprises an electron-withdrawing group. In some embodiments, the electron-withdrawing group has a Hammett constant larger than 0. In some embodiments, the electron-withdrawing group has a Hammett constant equal or larger than 0.1, 0.2, 0.3, 0.4, 0.5, 0.6, 0.7, 0.8, 0.9, 1.0, or 1.1.

In some embodiments, the compound comprises an electron-withdrawn group selected from the group consisting of the structures of the following EWGI1 LIST: F, CF₃, CN, COCH₃, CHO, COCF₃, COOMe, COOCF₃, NO₂, SF₃, SiF₃, PF₄, SF₃, OCF₃, SCF₃, SeCF₃, SOCF₃, SeOCF₃, SO₂F, SO₂CF₃, SeO₂CF₃, OSeO₂CF₃, OCN, SCN, SeCN, NC, ⁺N(R^{k2})₃, (R^{k2})₂CCN, (R^{k2})₂CCF₃, CNC(CF₃)₂, BR^{k3}R^{k2}, substituted or unsubstituted dibenzoborole, 1-substituted carbazole, 1,9-substituted carbazole, substituted or unsubstituted carbazole, substituted or unsubstituted pyridine, substituted or unsubstituted pyrimidine, substituted or unsubstituted pyrazine, substituted or unsubstituted pyridoxine, substituted or unsubstituted triazine, substituted or unsubstituted oxazole, substituted or unsubstituted benzoxazole, substituted or unsubstituted thiazole, substituted or unsubstituted benzothiazole, substituted or unsubstituted imidazole, substituted or unsubstituted benzimidazole, ketone, carboxylic acid, ester, nitrile, isonitrile, sulfinyl, sulfonyl, partially and fully fluorinated alkyl, partially and fully fluorinated aryl, partially and fully fluorinated heteroaryl, cyano-containing alkyl, cyano-containing aryl, cyano-containing heteroaryl, isocyanate, 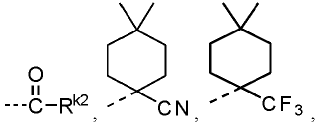 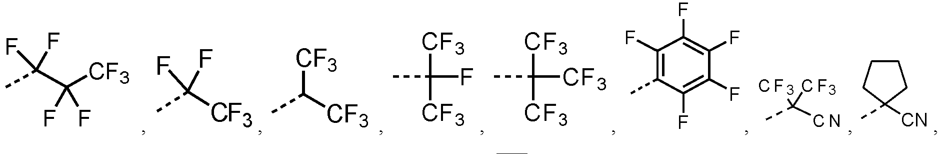 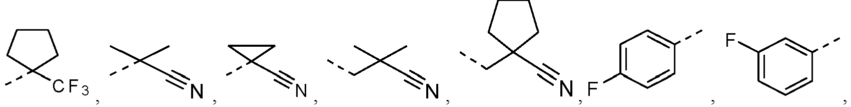 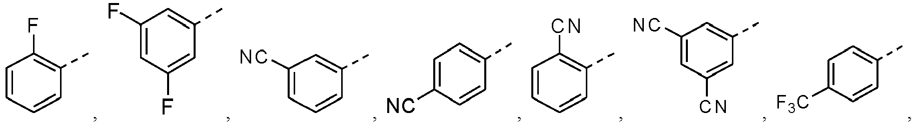 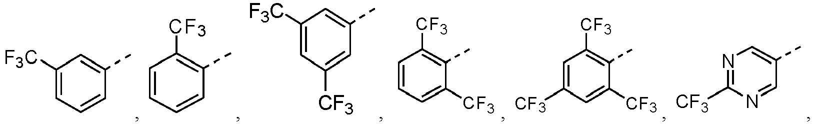 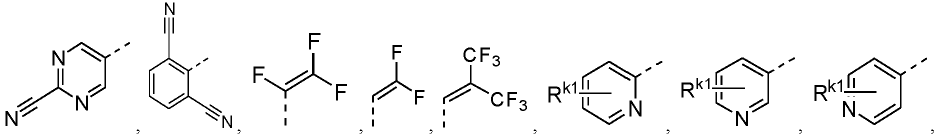 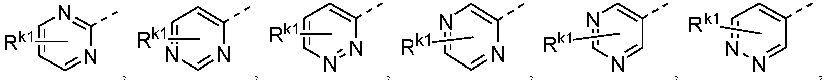 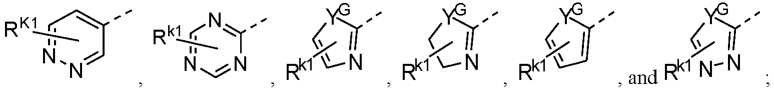
wherein each R^{k1} represents mono to the maximum allowable substitution, or no substitutions;
wherein Y^{G} is selected from the group consisting of BRₑ, NRₑ, PRₑ, O, S, Se, C=O, S=O, SO₂, CRₑR_{f}, SiRₑR_{f}, and GeRₑR_{f'}; and
wherein each of R^{k1}, R^{k2}, R^{k3}, Rₑ, and R_{f} is independently a hydrogen or a substituent selected from the group consisting of the General Substituents defined herein.

In some embodiments, the compound comprises an electron-withdrawing group selected from the group consisting of the structures of the following EWG2 List: 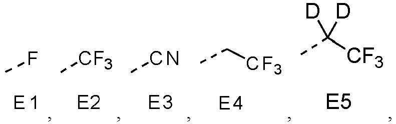 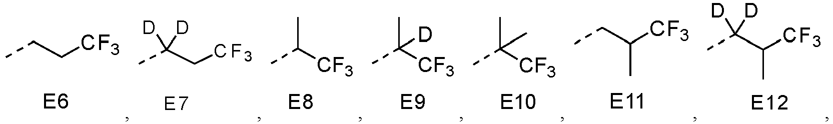 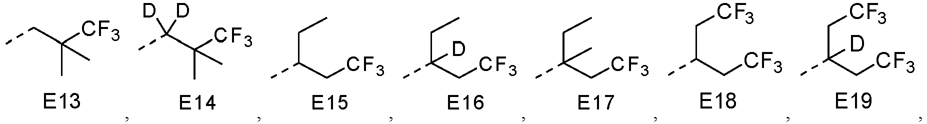 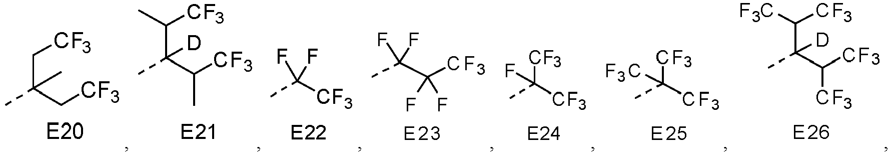 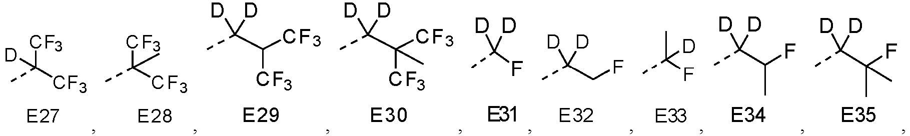 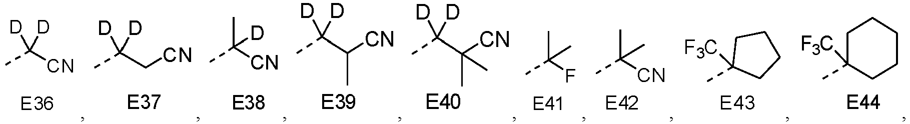 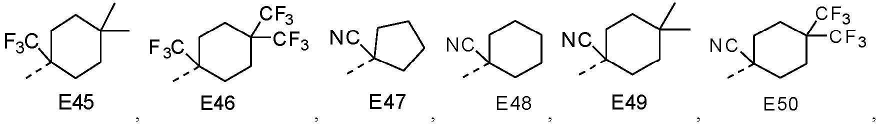 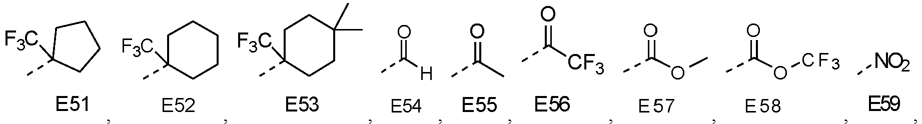 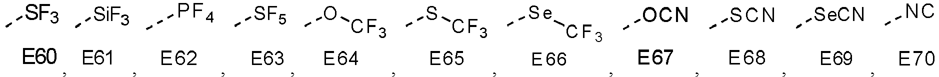 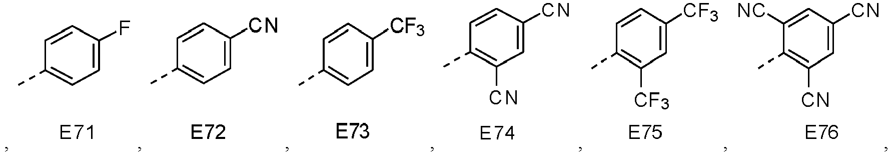 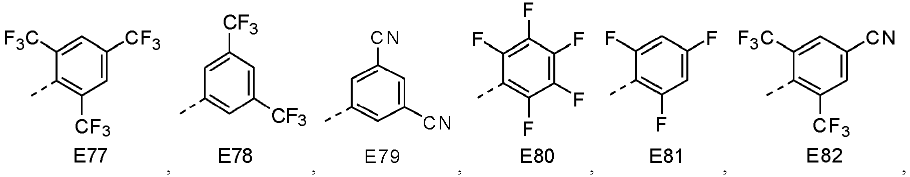 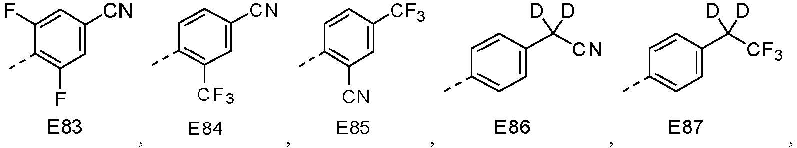 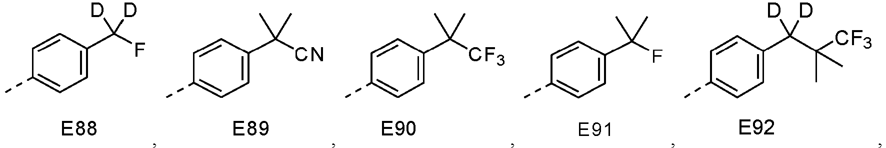 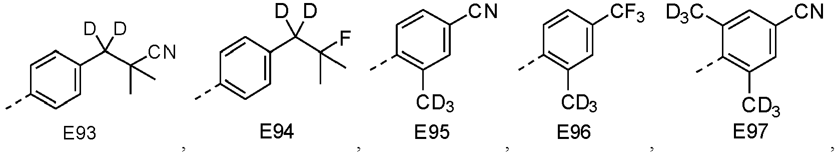 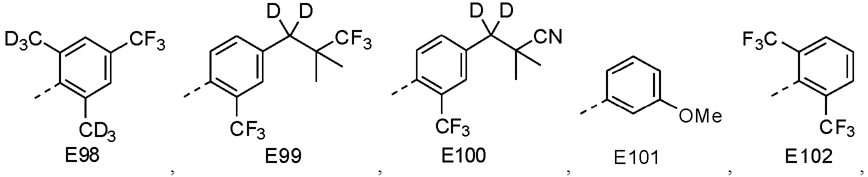 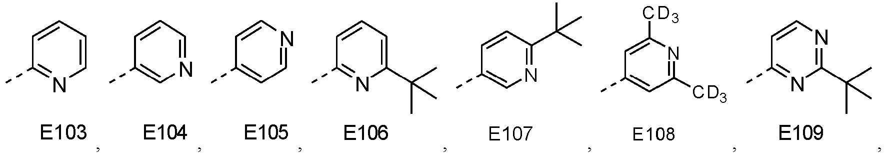 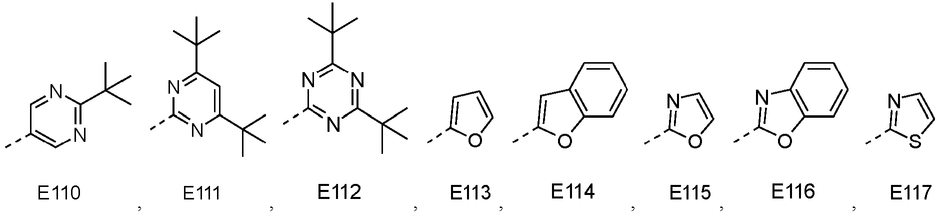 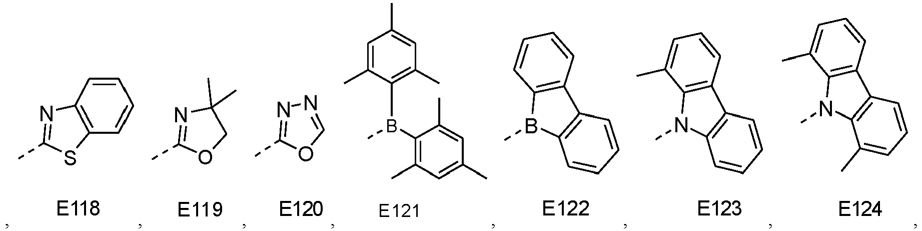 and

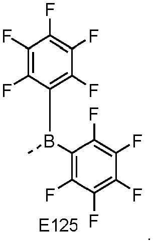

In some embodiments, the compound comprises an electron-withdrawing group selected from the group consisting of the structures of the following EWG3 LIST:

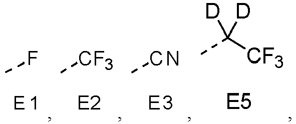

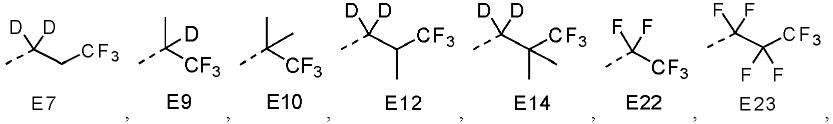

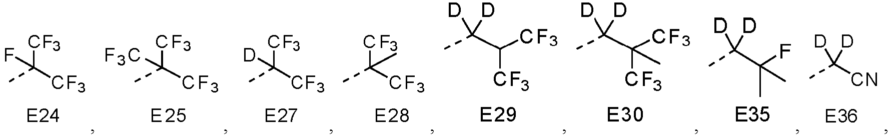

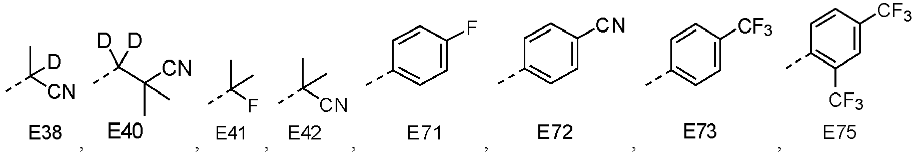

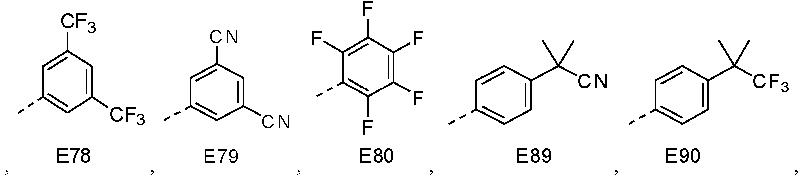

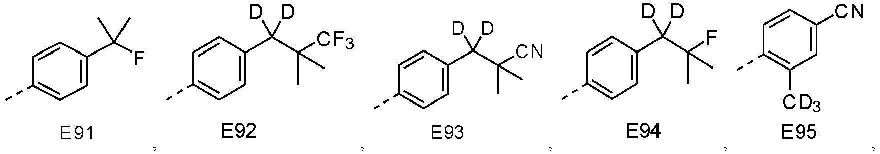

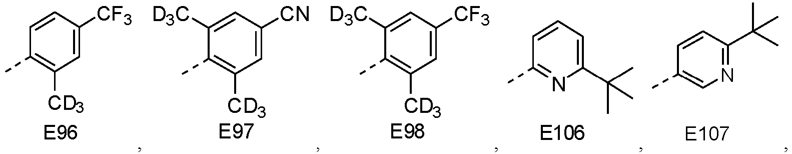

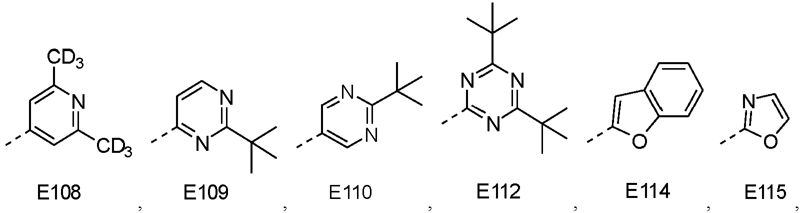

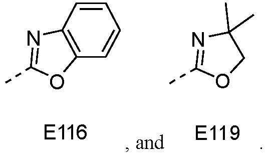

In some embodiments, the compound comprises an electron-withdrawing group selected from the group consisting of the structures of the following EWG4 LIST:

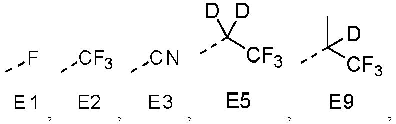

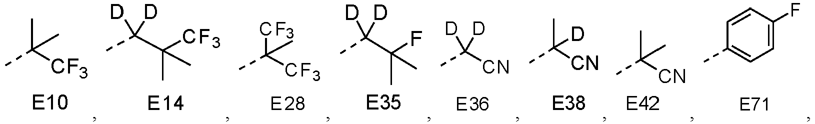

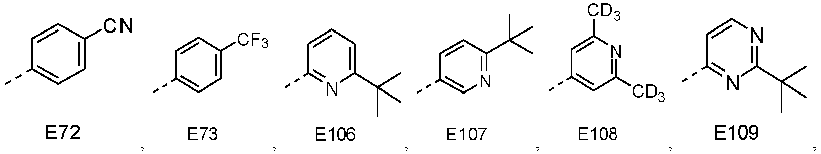

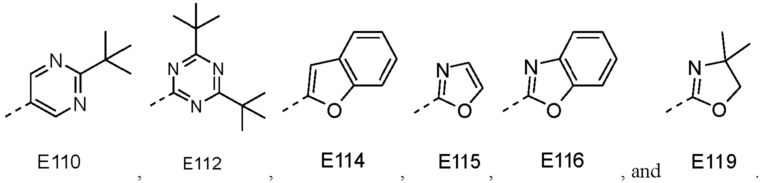

In some embodiments, the compound comprises an electron-withdrawing group that is a π-electron deficient electron-withdrawing group. In some embodiments, the π-electron deficient electron-withdrawing group is selected from the group consisting of the structures of the following Pi-EWG LIST: CN, COCH₃, CHO, COCF₃, COOMe, COOCF₃, NO₂, SF₃, SiF₃, PF₄, SF₃, OCF₃, SCF₃, SeCF₃, SOCF₃, SeOCF₃, SO₂F, SO₂CF₃, SeO₂CF₃, OSeO₂CF₃, OCN, SCN, SeCN, NC, ⁺N(R^{k2})₃, BR^{k2}R^{k3}, substituted or unsubstituted dibenzoborole, 1-substituted carbazole, 1,9-substituted carbazole, substituted or unsubstituted carbazole, substituted or unsubstituted pyridine, substituted or unsubstituted pyrimidine, substituted or unsubstituted pyrazine, substituted or unsubstituted pyridazine, substituted or unsubstituted triazine, substituted or unsubstituted oxazole, substituted or unsubstituted benzoxazole, substituted or unsubstituted thiazole, substituted or unsubstituted benzothiazole, substituted or unsubstituted imidazole, substituted or unsubstituted benzimidazole, ketone, carboxylic acid, ester, nitrile, isonitrile, sulfinyl, sulfonyl, partially and fully fluorinated aryl, partially and fully fluorinated heteroaryl, cyano-containing aryl, cyano-containing heteroaryl, isocyanate, 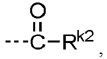 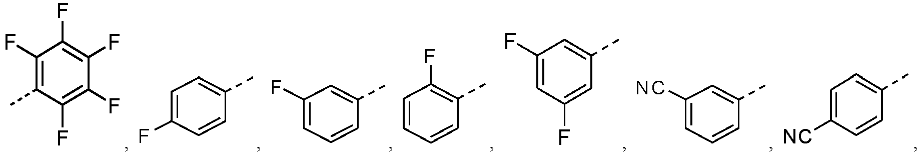 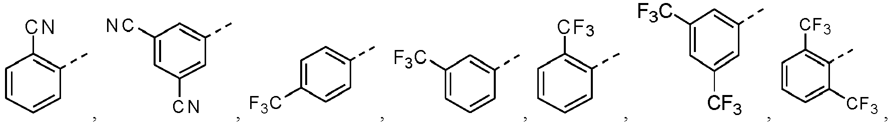 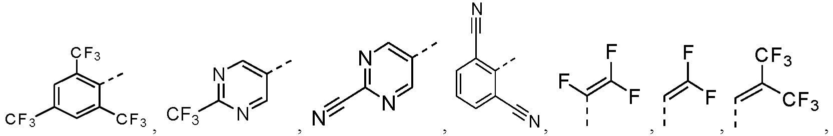 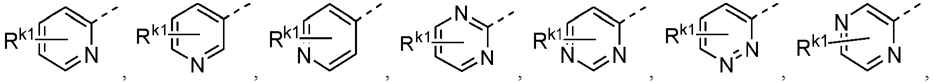 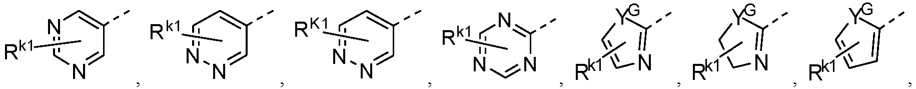 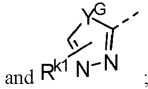 wherein the variables are the same as previously defined.

In some embodiments, ligand L_{A} is selected from the group consisting of the structures of the following LIST 1: 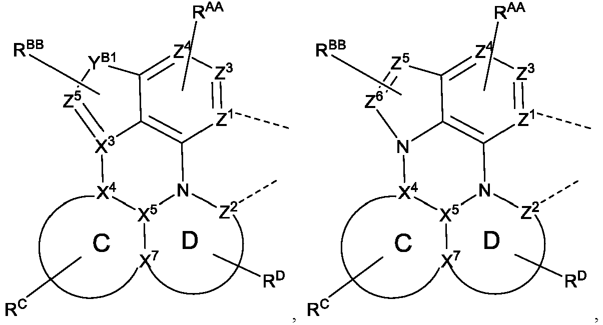 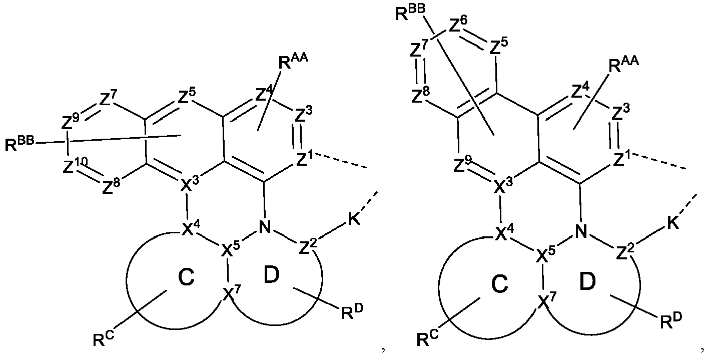 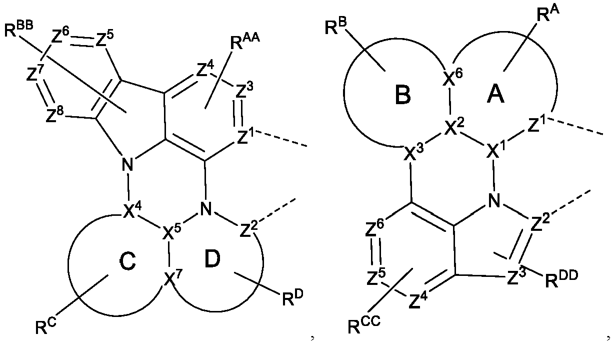 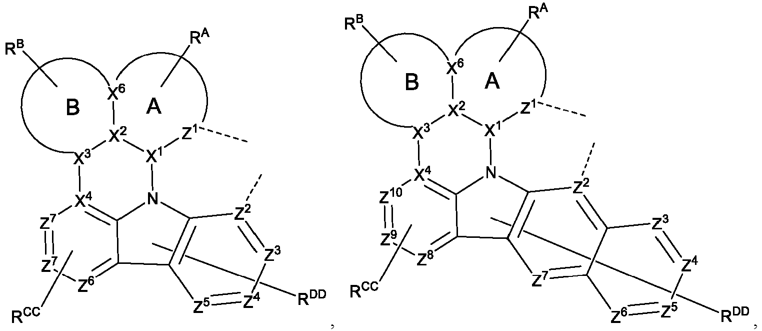 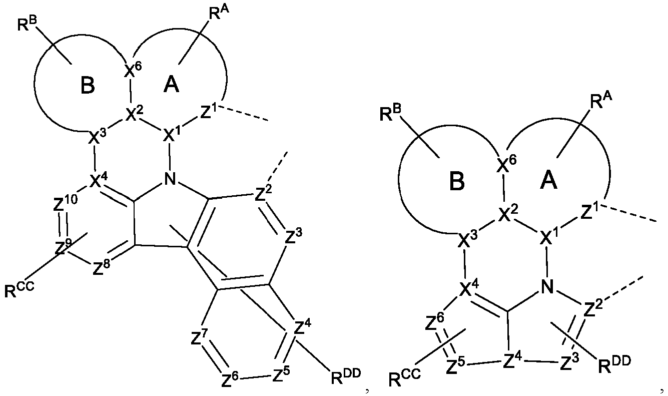 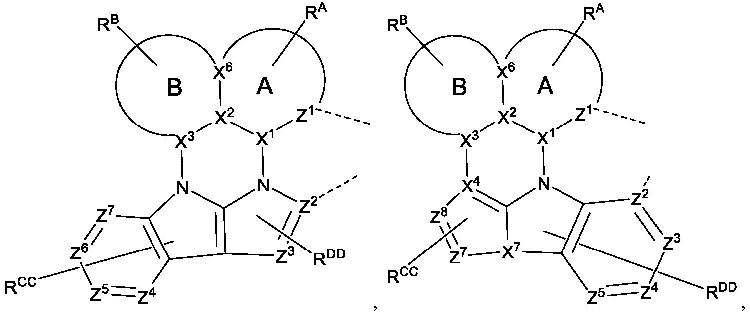 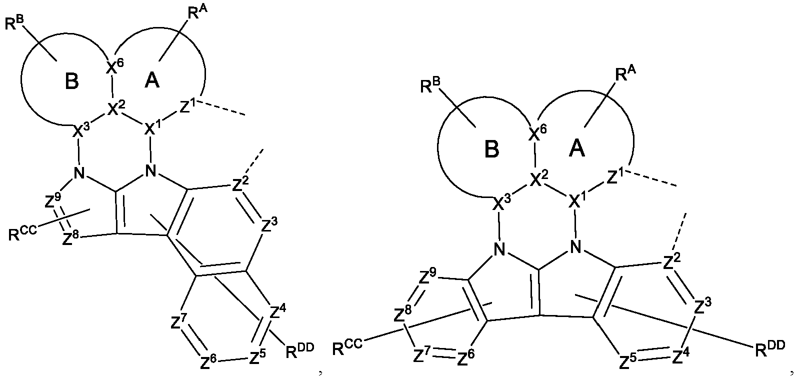 and 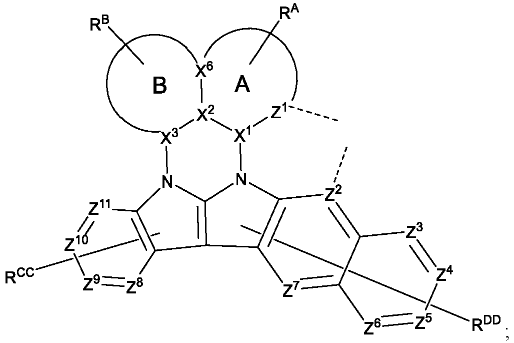 wherein:
each of Z³ to Z¹¹ is independently C or N;
each Y^{B1} is independently selected from the group consisting of BR, BRR', NR, PR, P(O)R, O, S, Se, C=O, C=S, C=Se, C=NR, C= CRR', S=O, SO₂, CR, CRR', SiRR', and GeRR';
each of R^{AA}, R^{BB}, R^{CC}, and R^{DD} independently represent mono to the maximum allowable substitution, or no substitution;
each R, R', R^{AA}, R^{BB}, R^{CC}, and R^{DD} is independently a hydrogen or a substituent selected from the group consisting of the General Substituents defined herein; and
any two substituents may be joined or fused to form a ring.

In some embodiments, ligand L_{A} is selected from the group consisting of the structures of the following LIST 2: 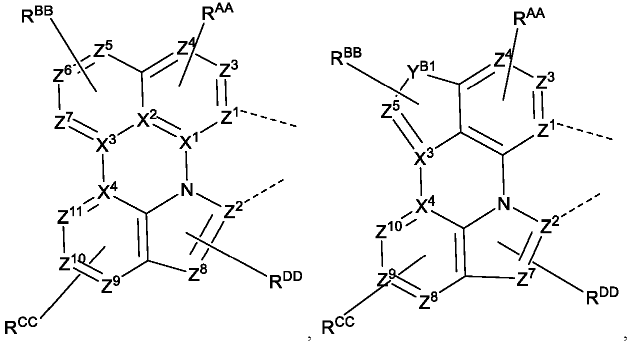 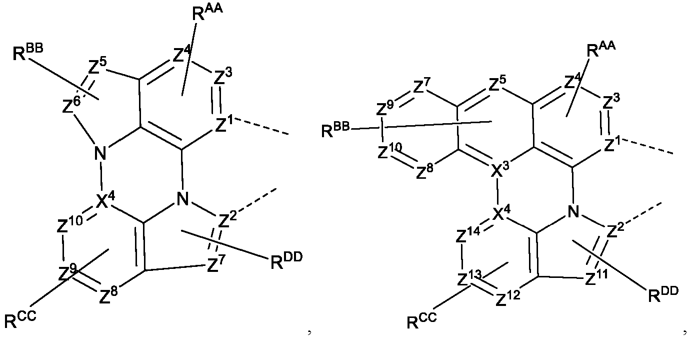 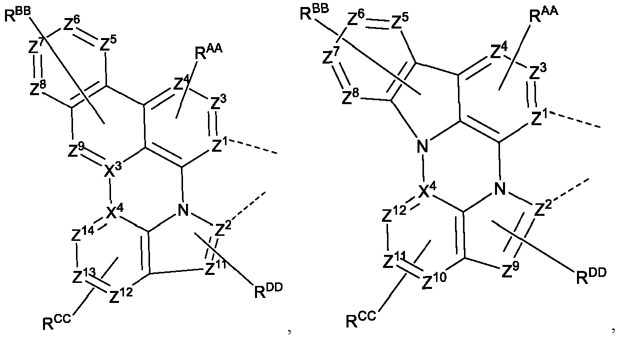 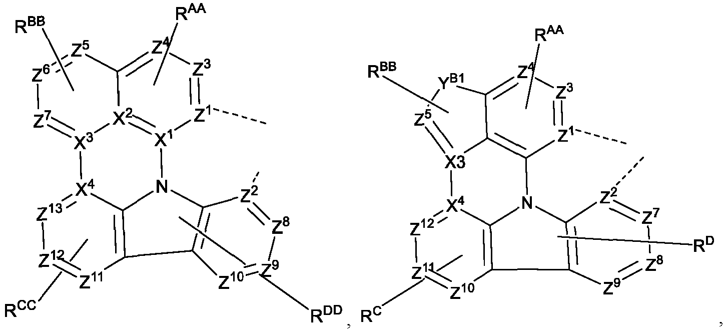 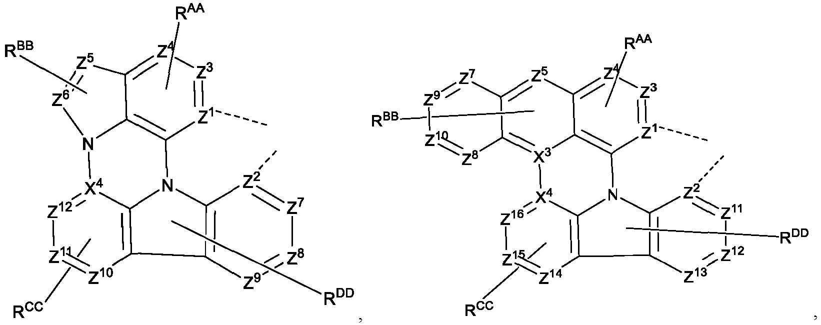 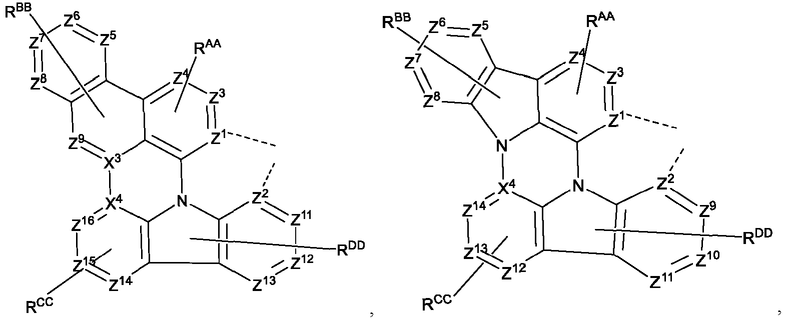 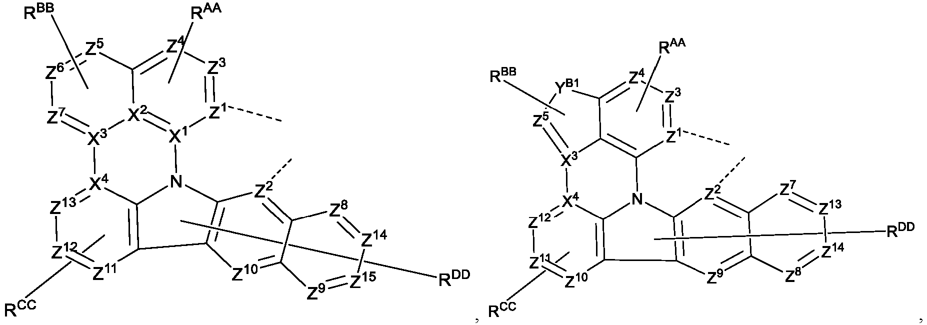 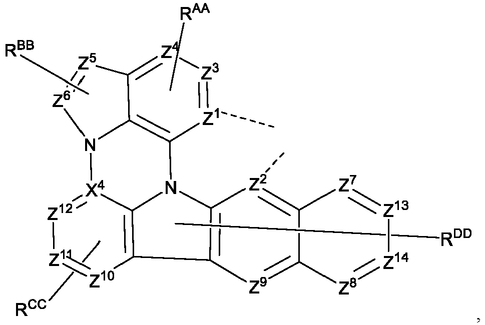 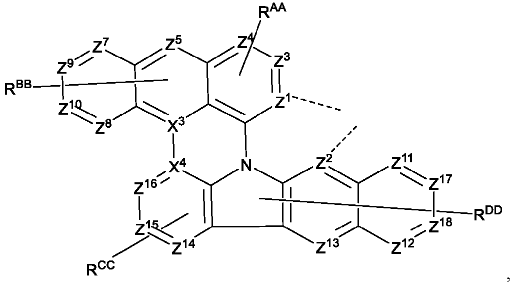 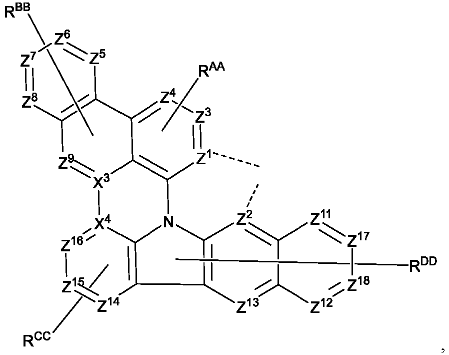 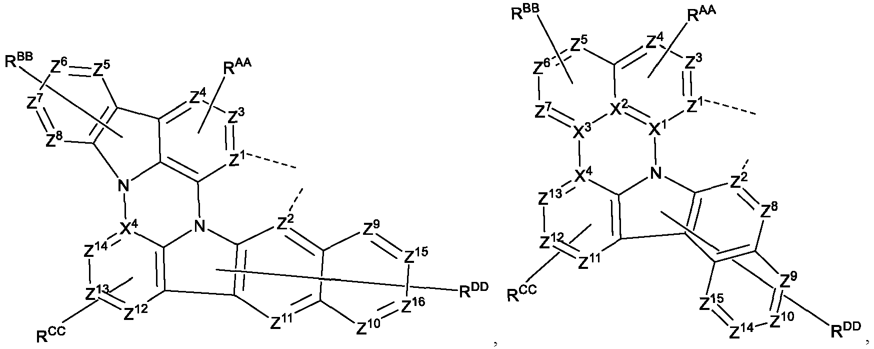 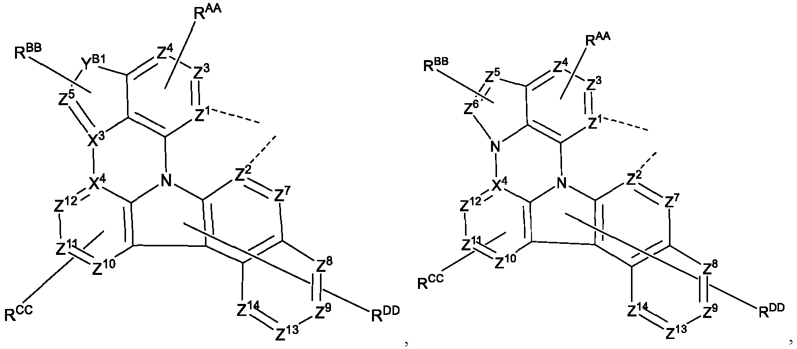 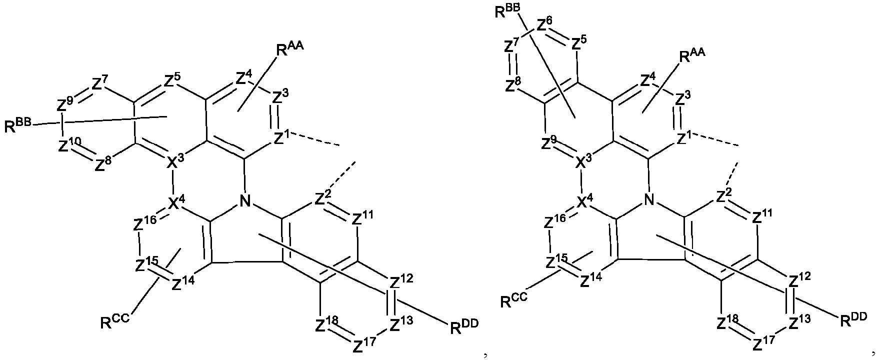 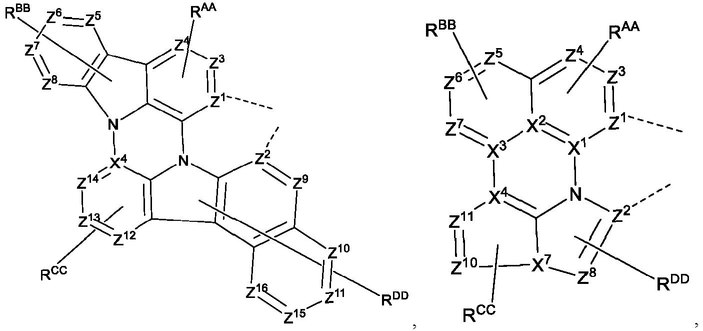 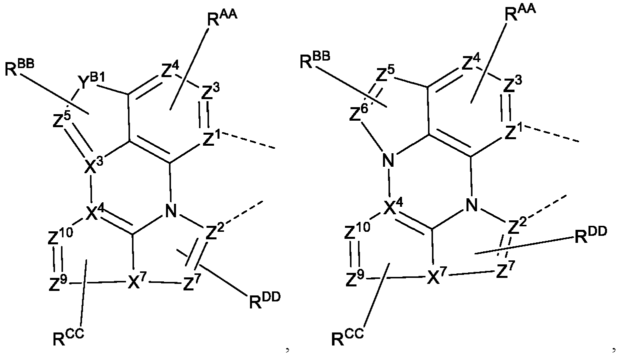 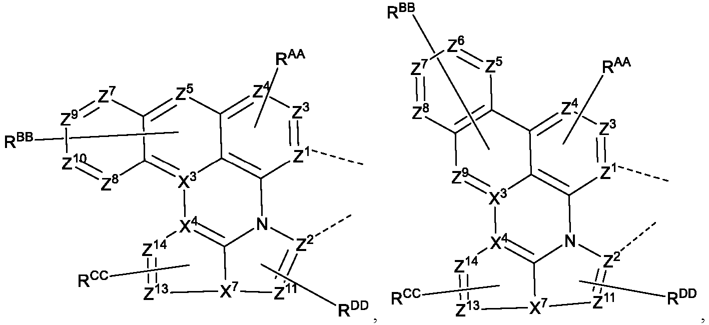 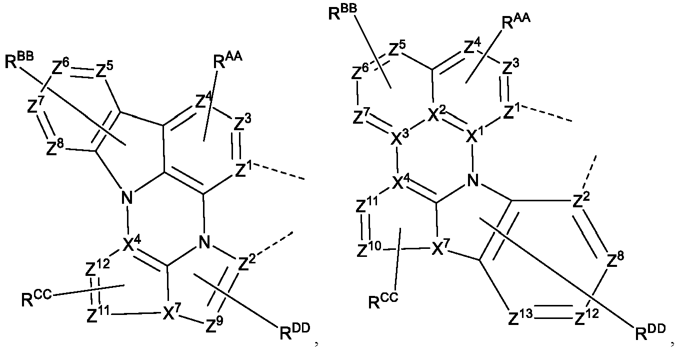 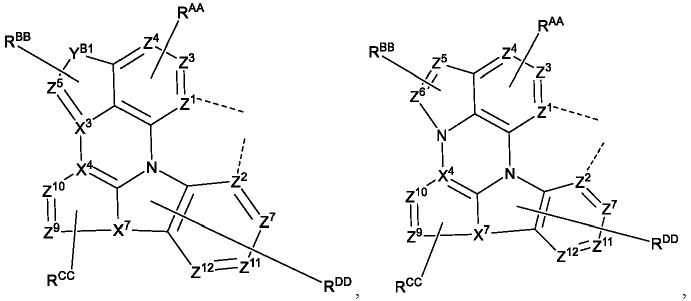 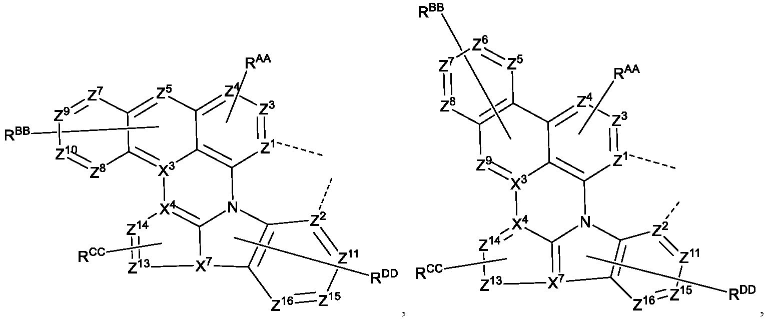 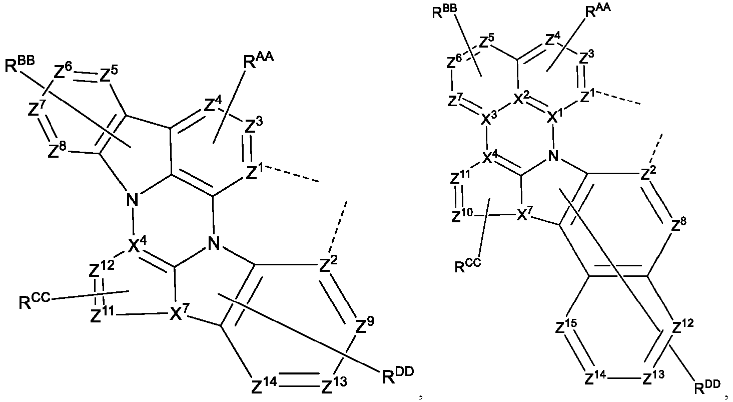 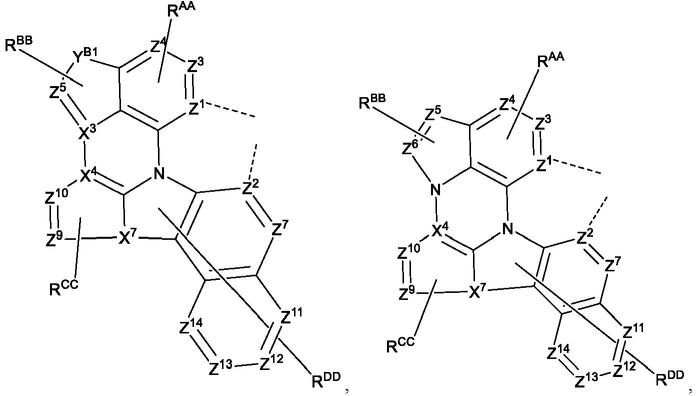 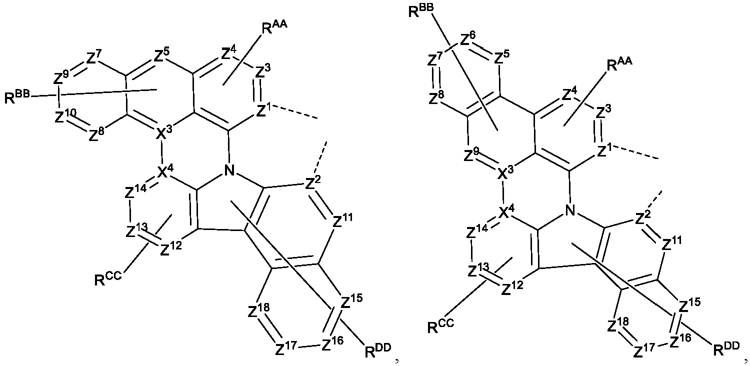 and 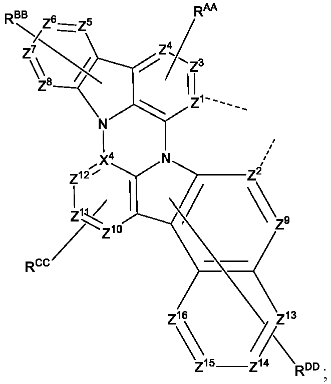 wherein:
each of Z³ to Z¹⁸ is independently C or N;
each Y^{B1} is independently selected from the group consisting of BR, BRR', NR, PR, P(O)R, O, S, Se, C=O, C=S, C=Se, C=NR, C= CRR', S=O, SO₂, CR, CRR', SiRR', and GeRR';
each of R^{AA}, R^{BB}, R^{CC}, and R^{DD} independently represent mono to the maximum allowable substitution, or no substitution;
each R, R', R^{AA}, R^{BB}, R^{CC}, and R^{DD} is independently a hydrogen or a substituent selected from the group consisting of the General Substituents defined herein; and
any two substituents may be joined or fused to form a ring.

In some embodiments, ligand L_{A} is selected from the group consisting of L_{Ai-m}, wherein i is an integer from 1 to 3136 and m is an integer from 1 to 154, and wherein L_{Ai-1} to L_{Ai-154} are defined in the following LIST 3:

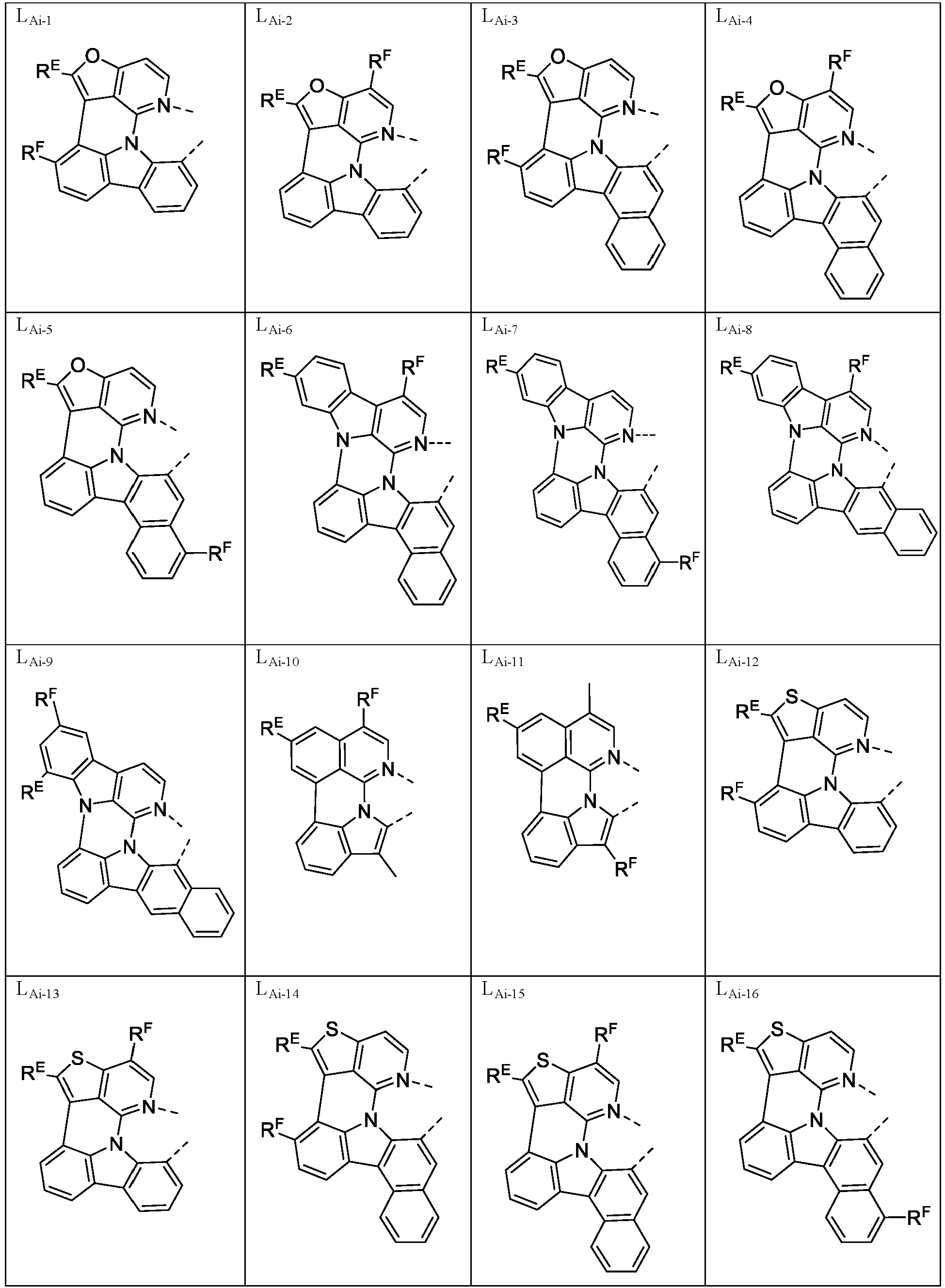

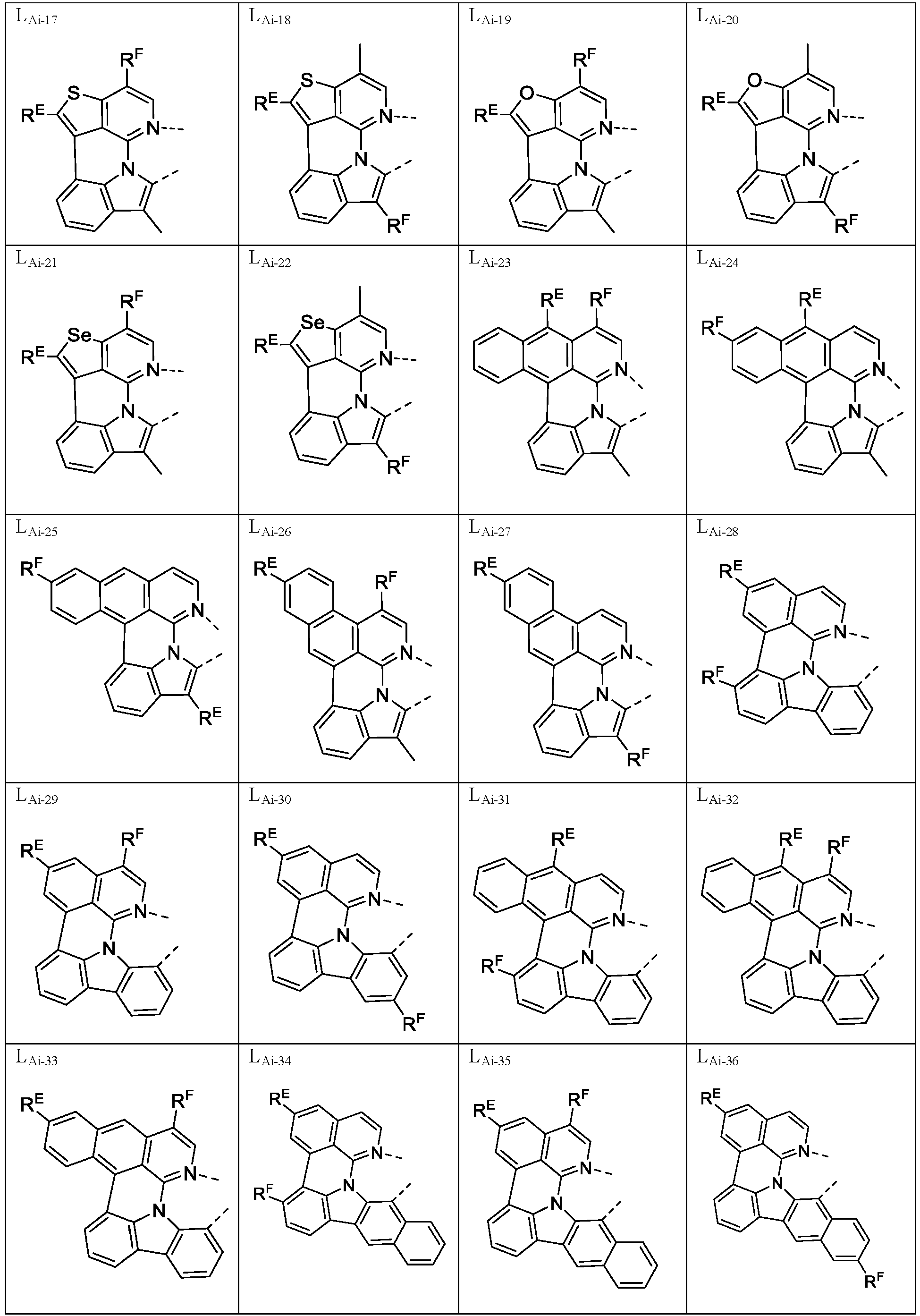

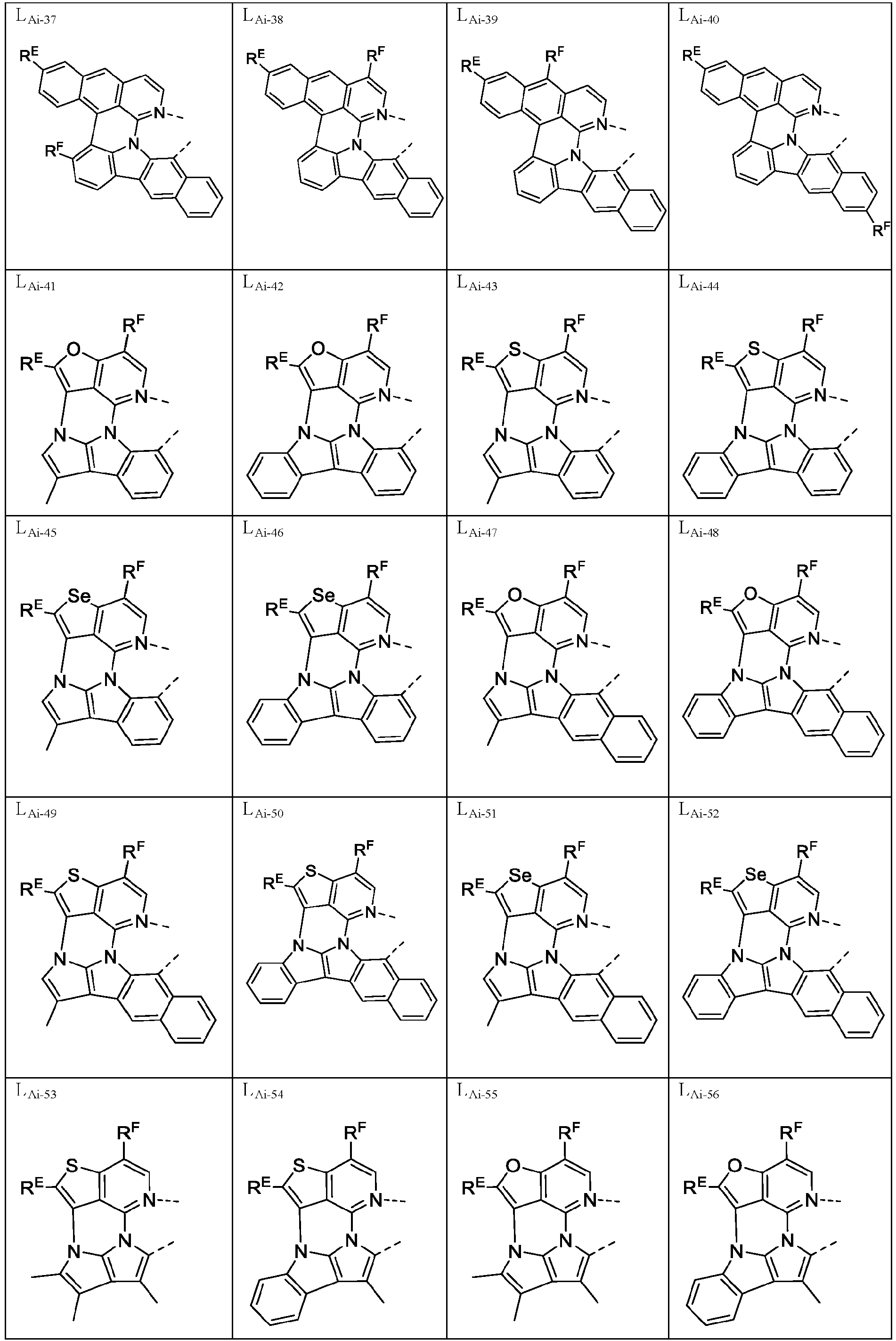

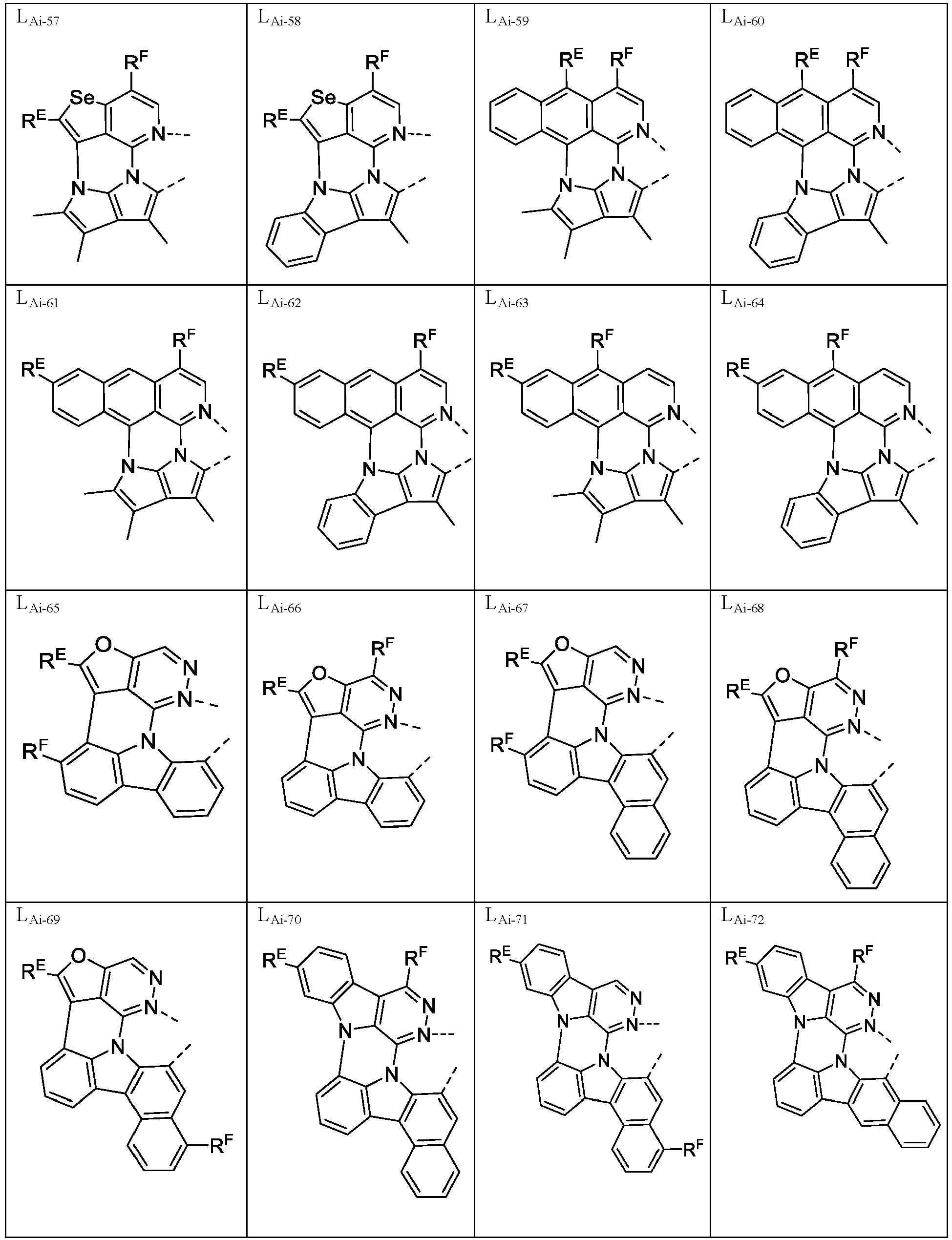

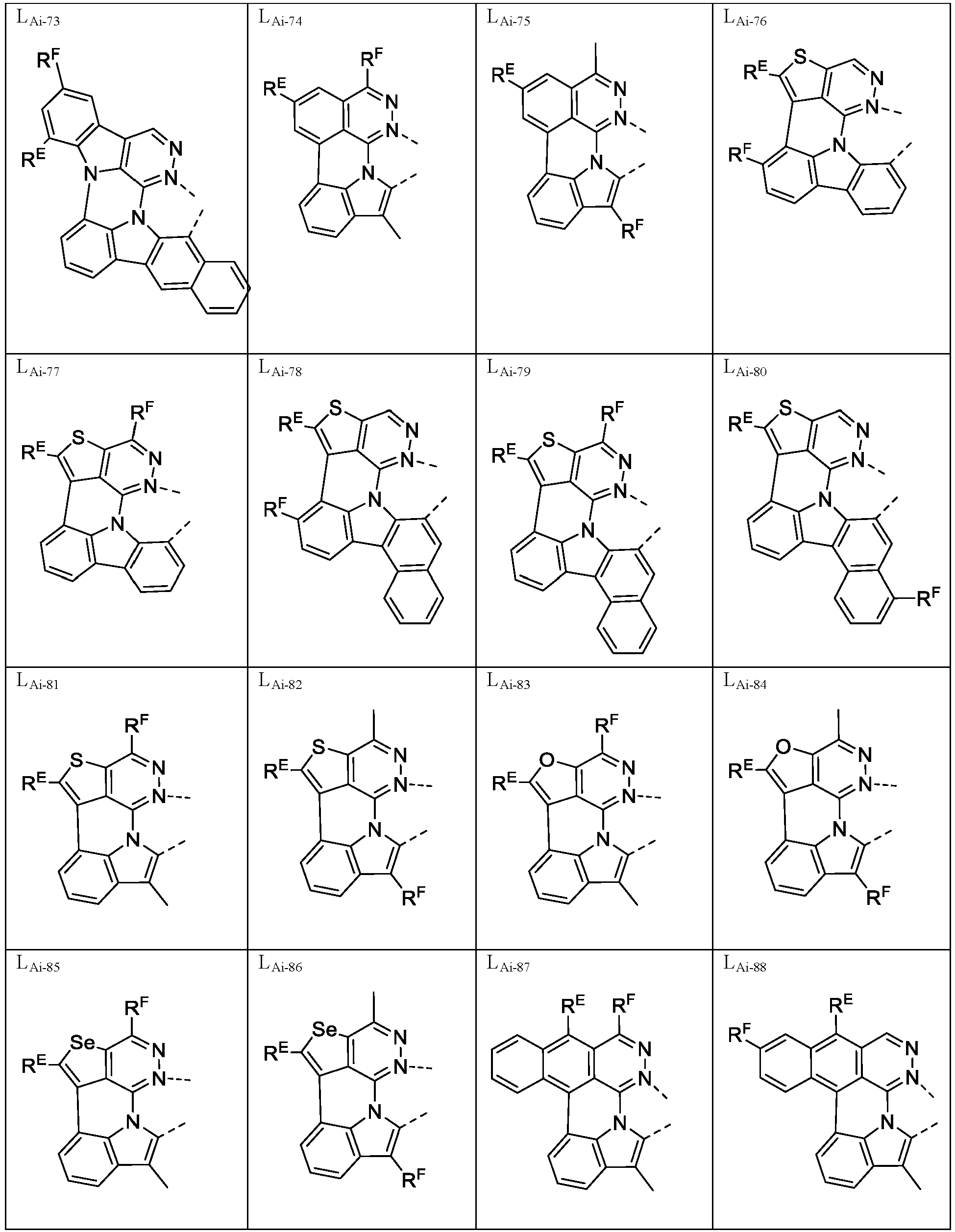

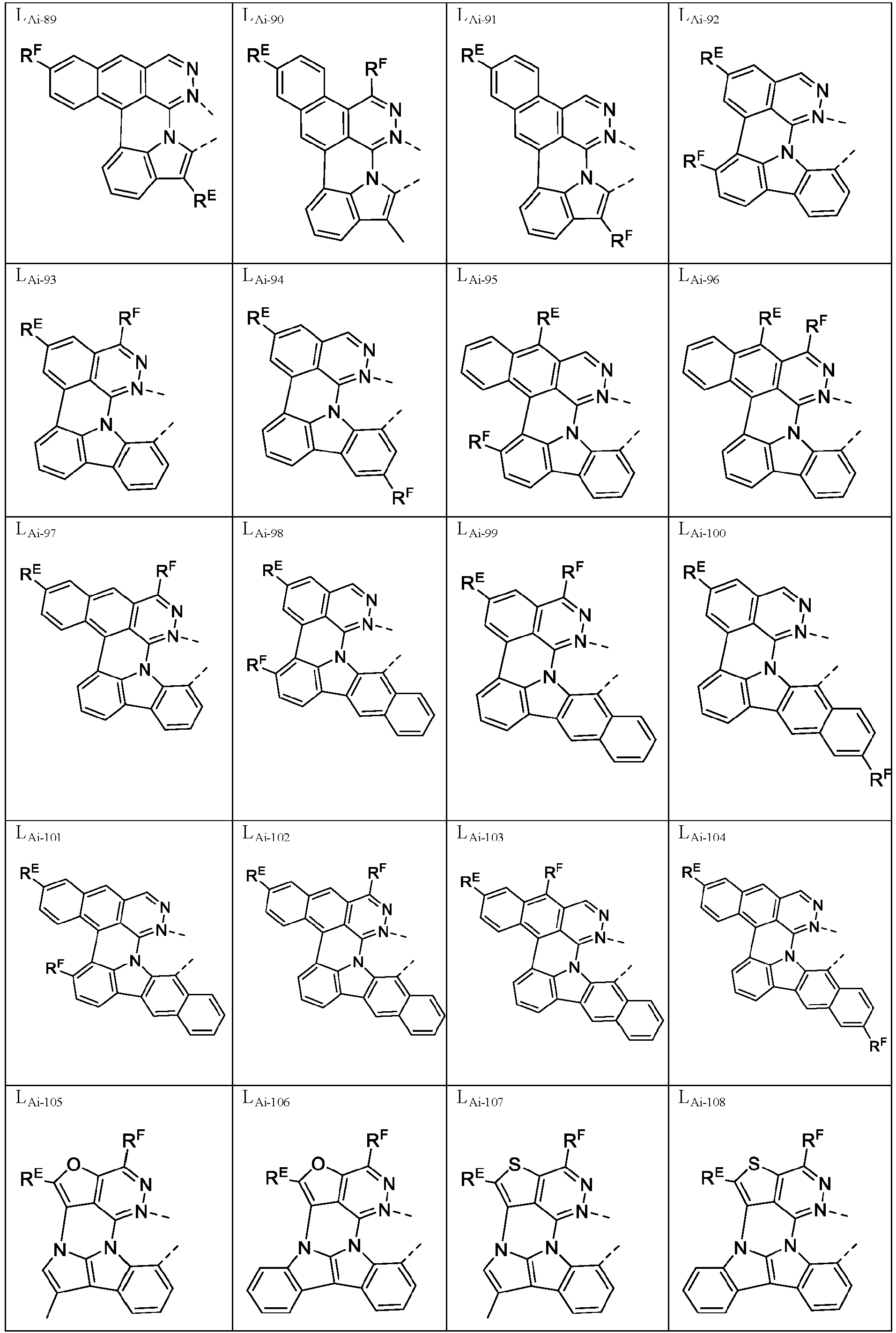

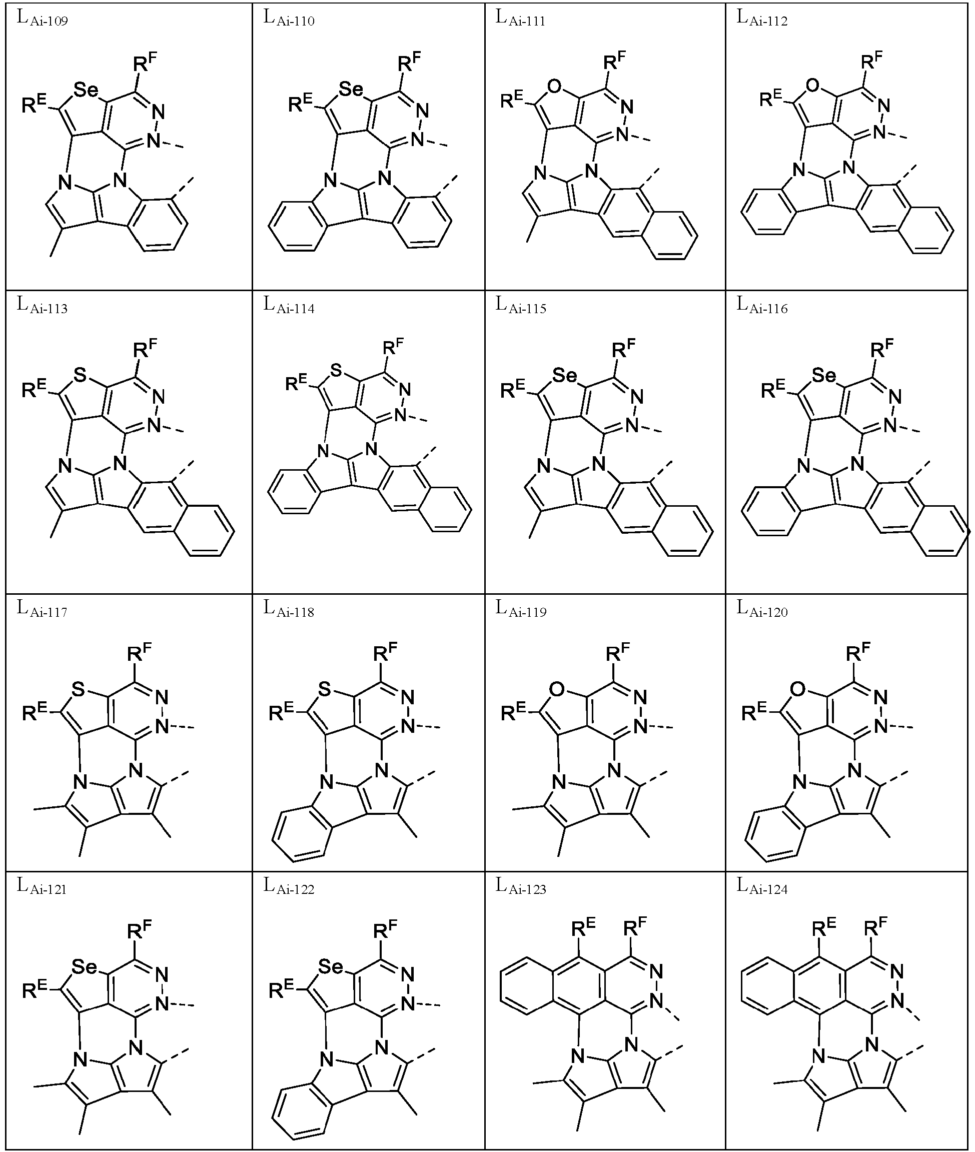

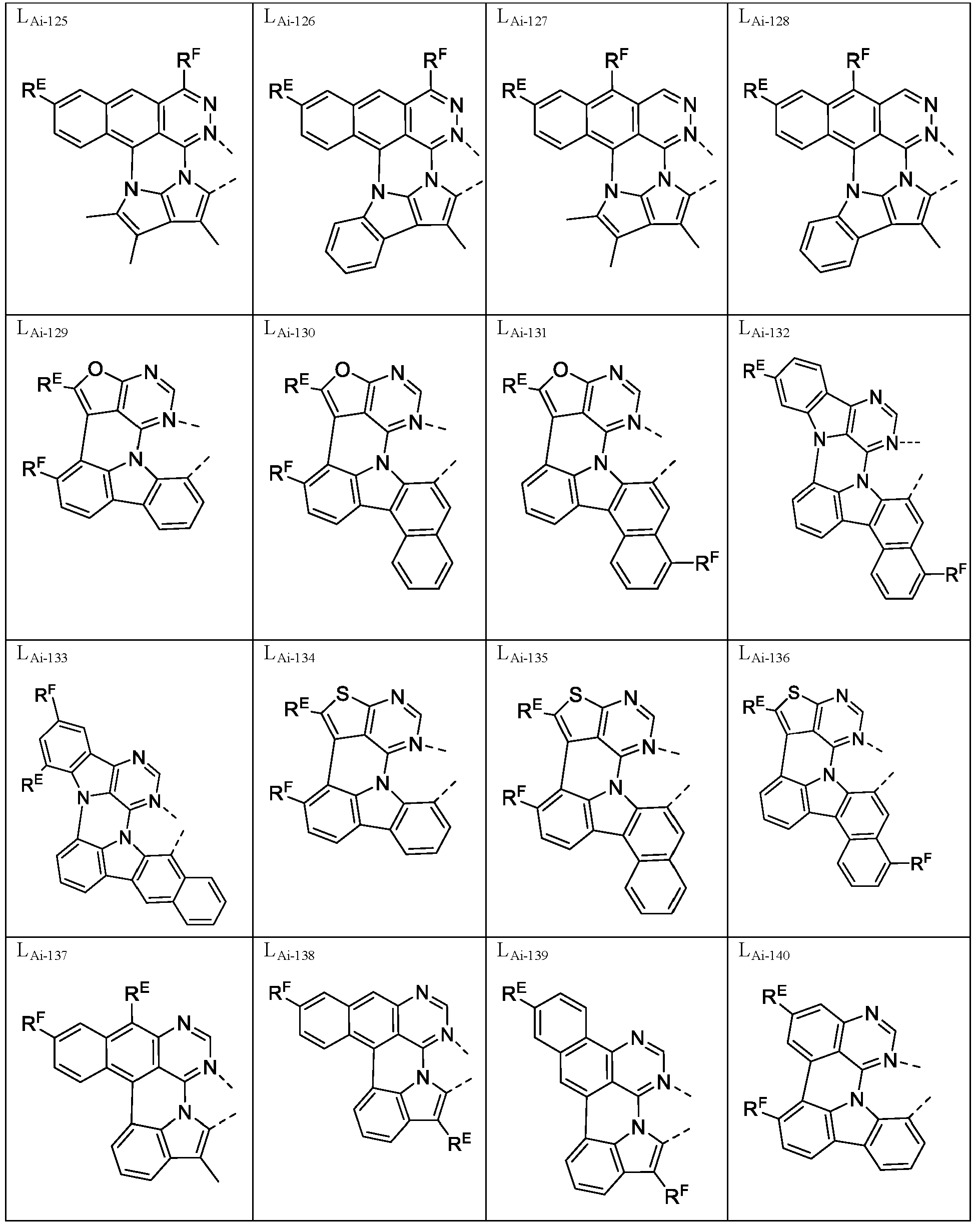

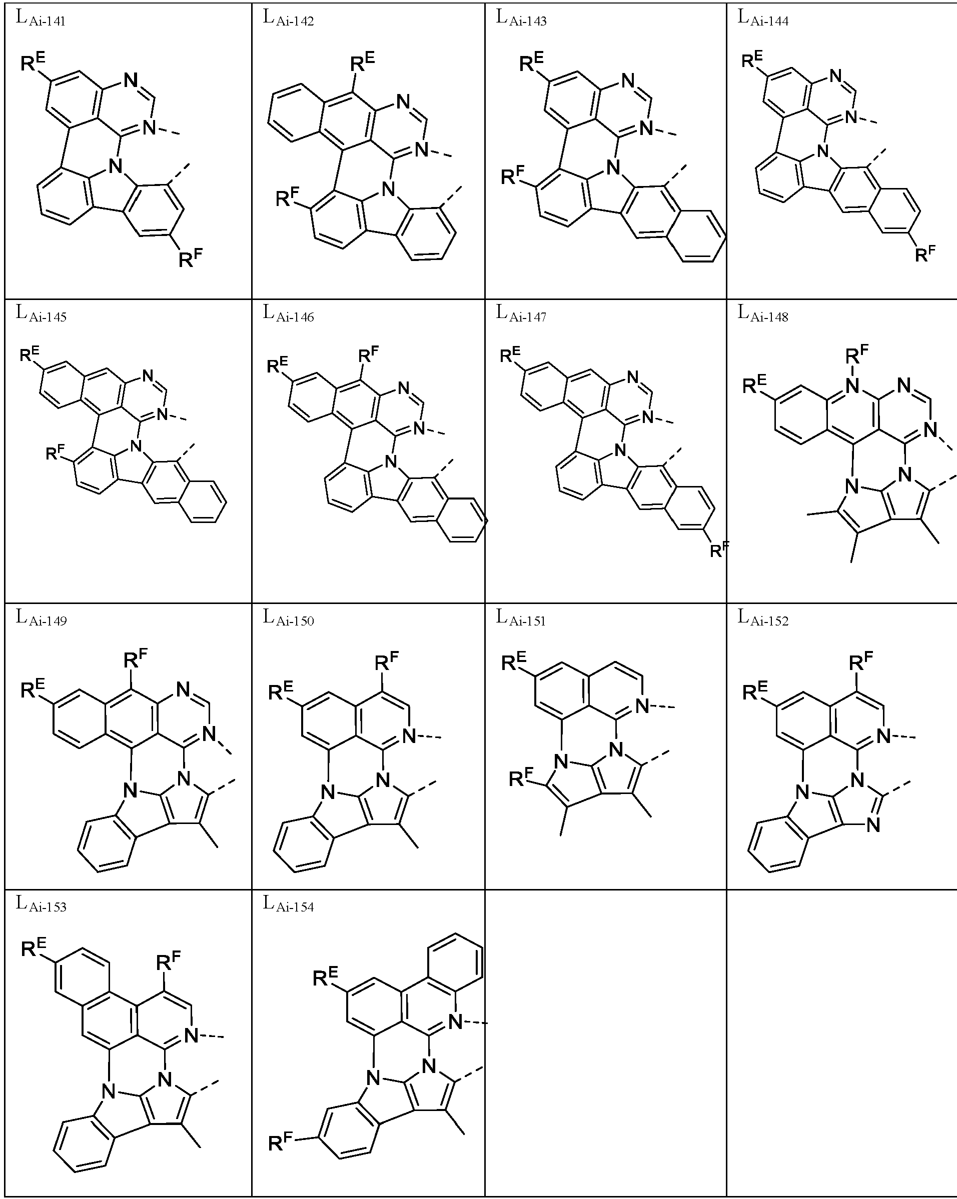

wherein, for each i, R^{E} and R^{F} are defined in the following LIST 4:

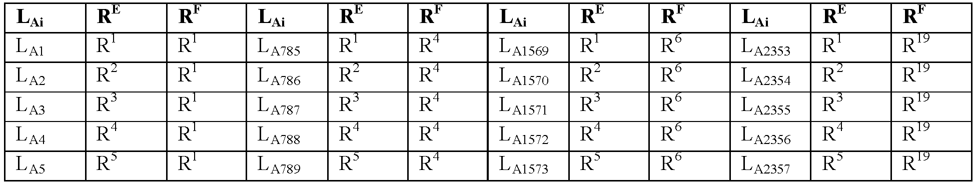

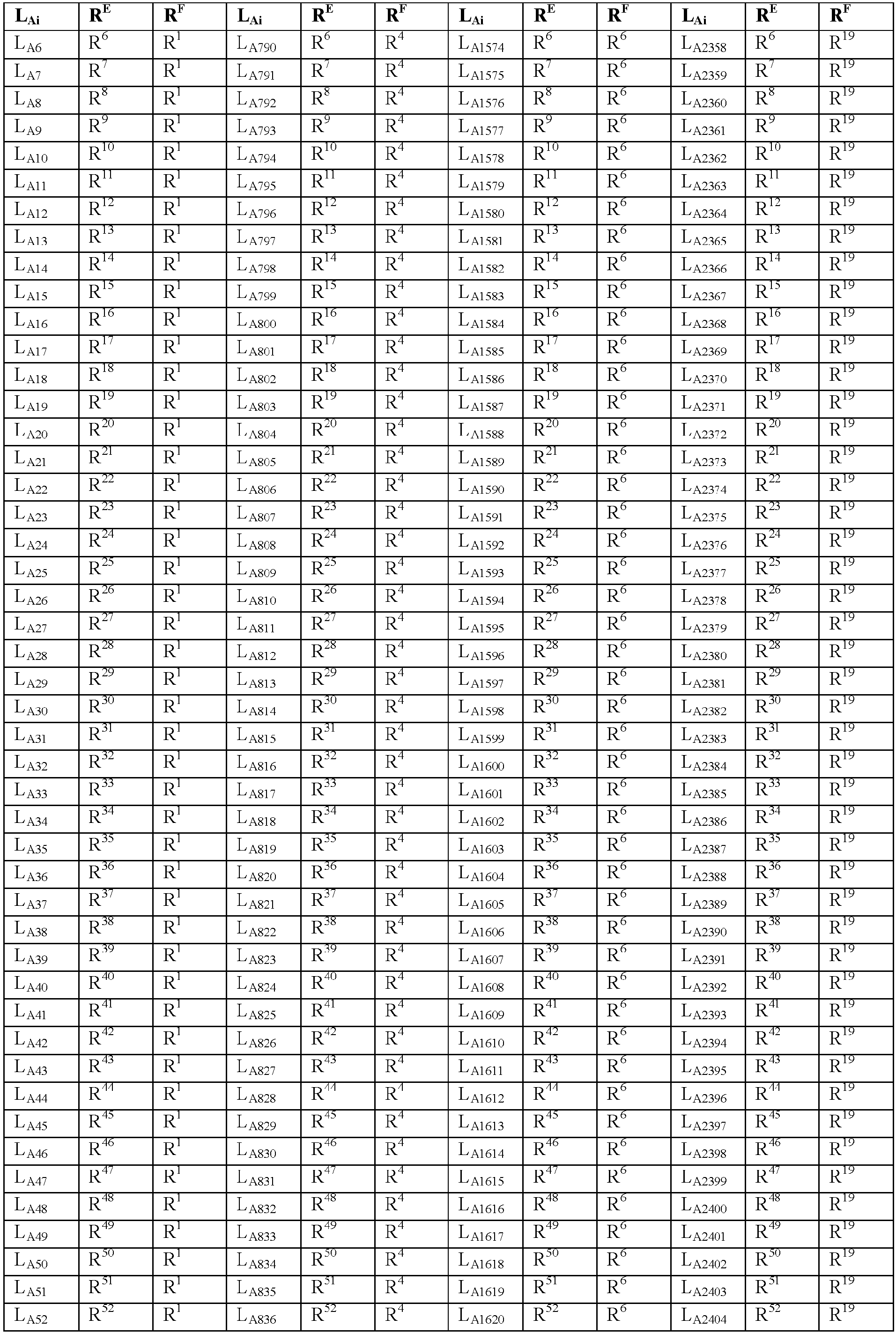

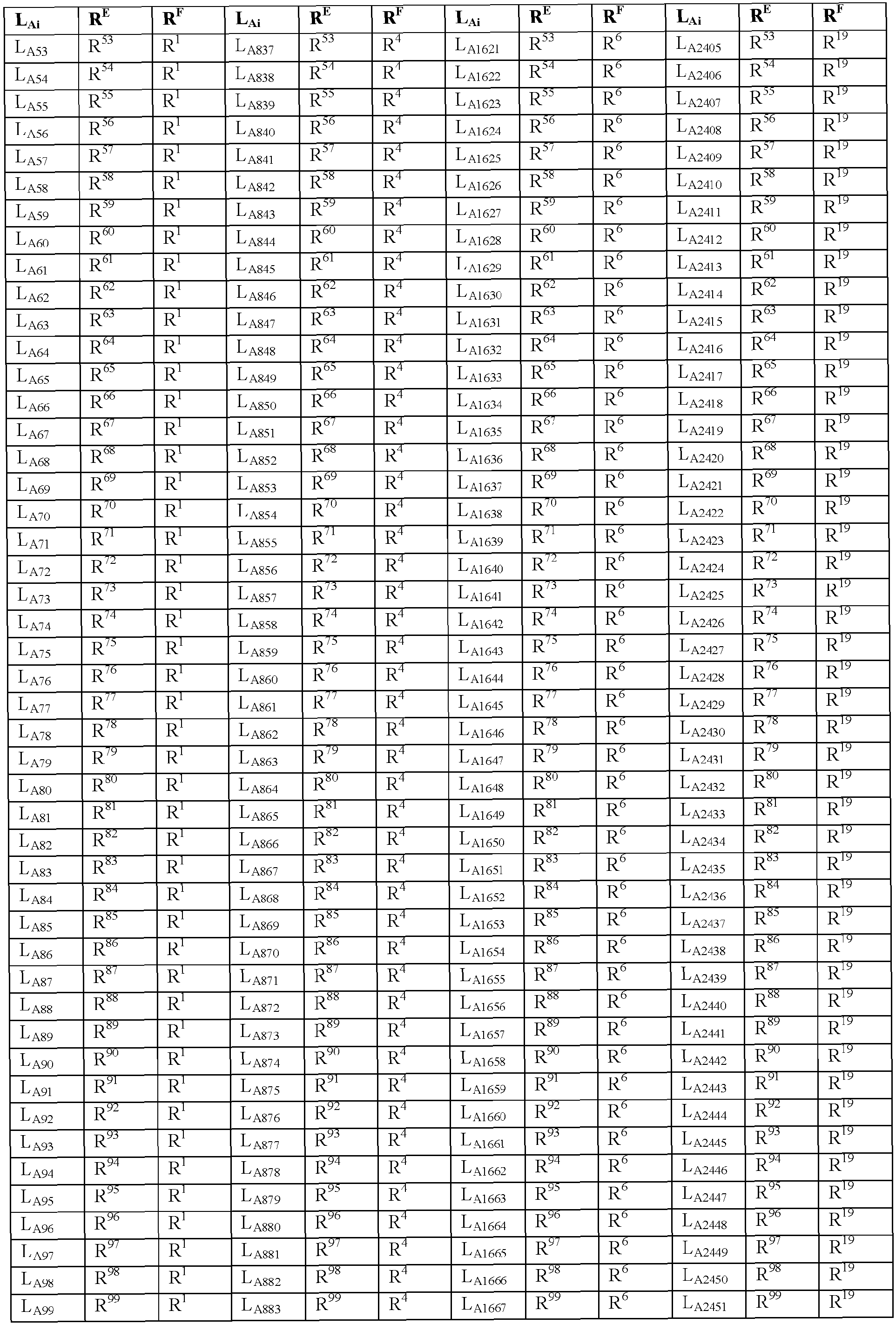

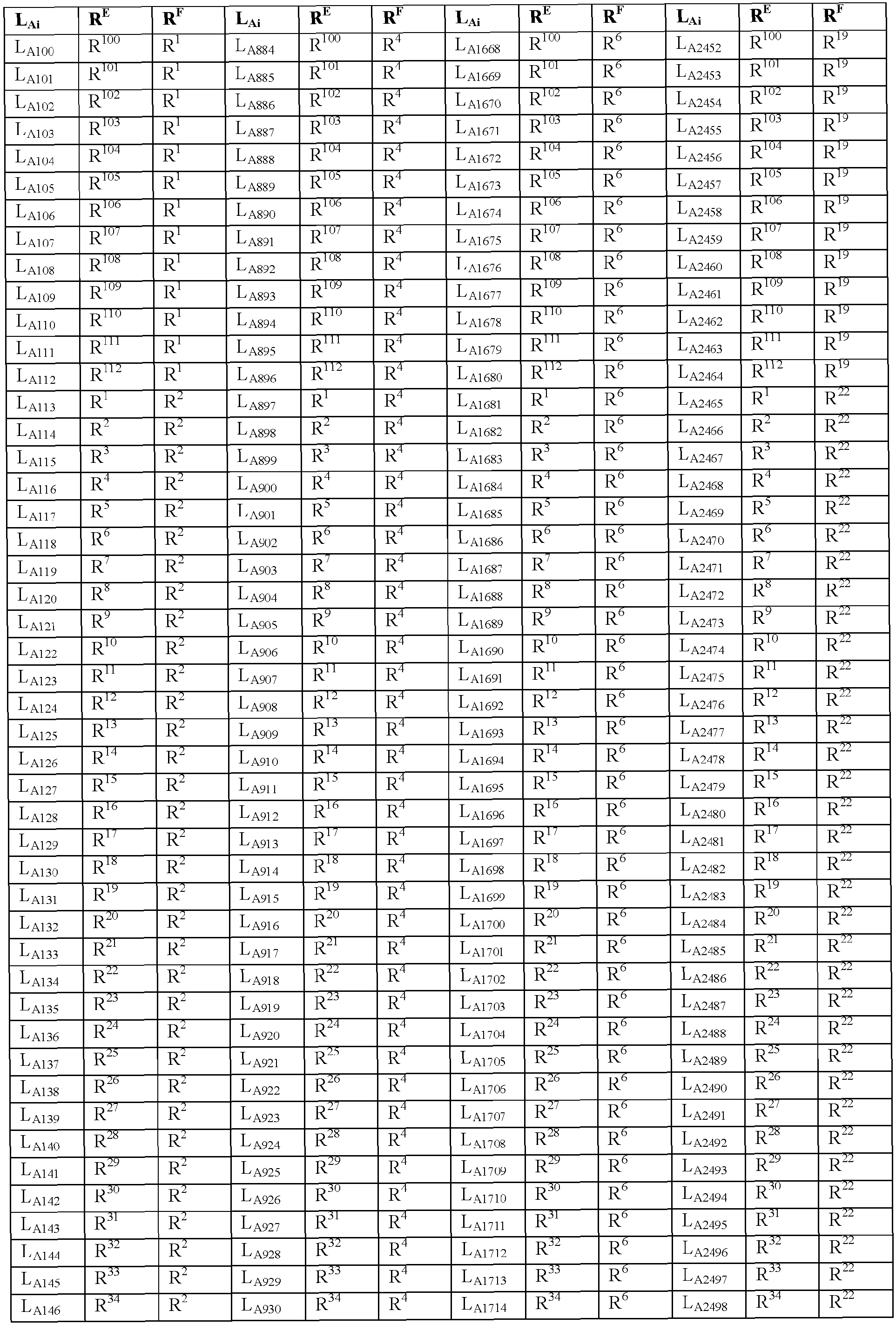

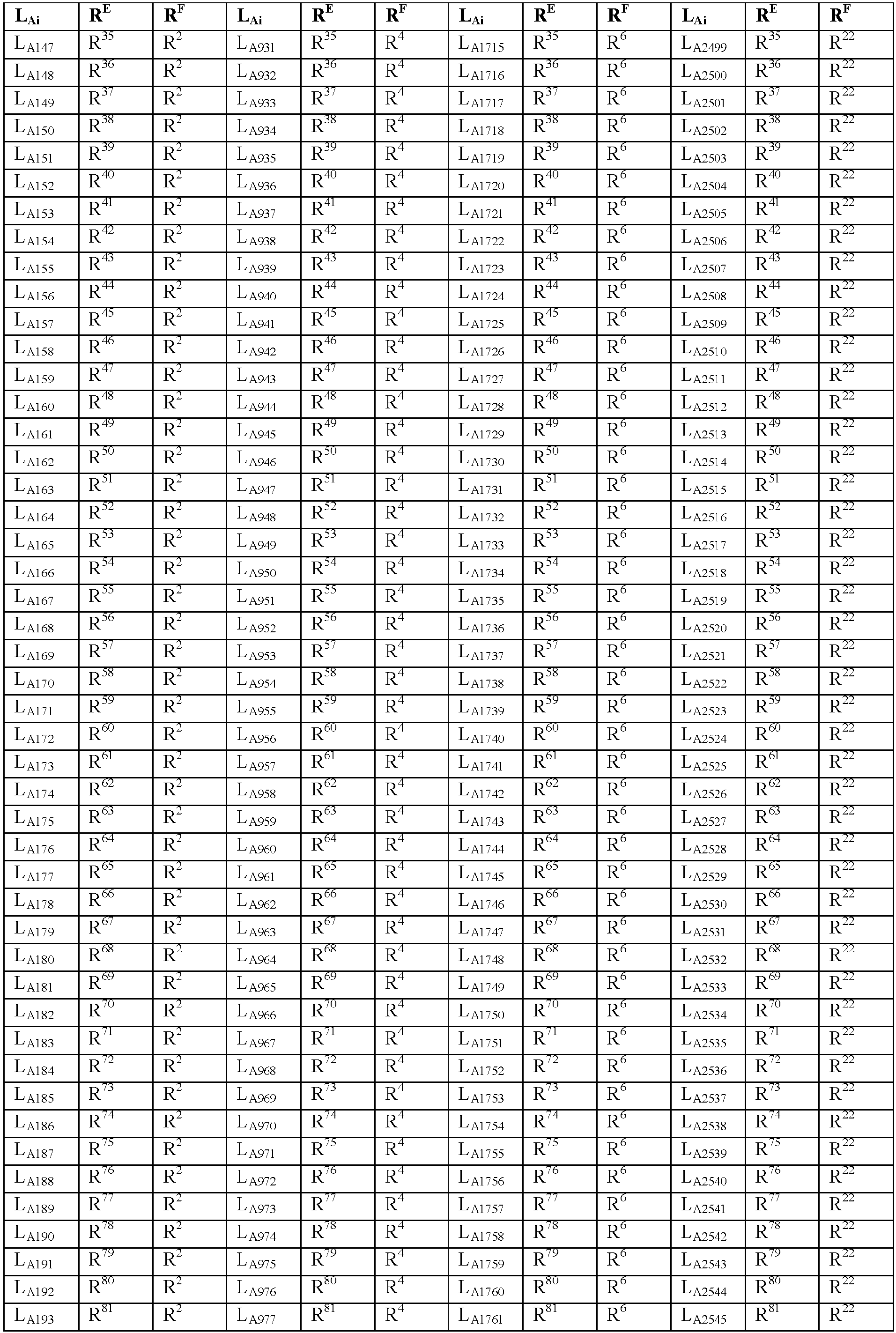

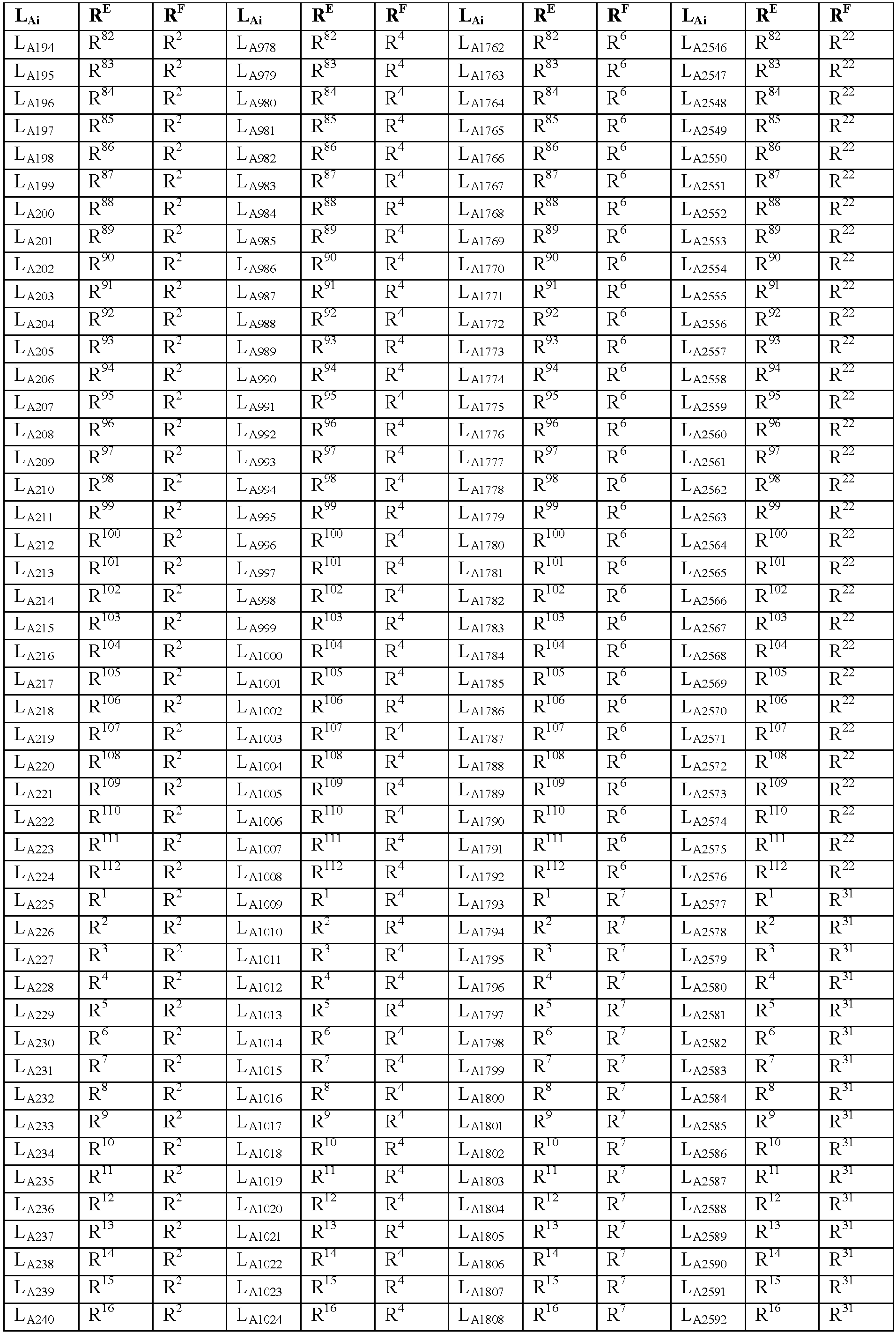

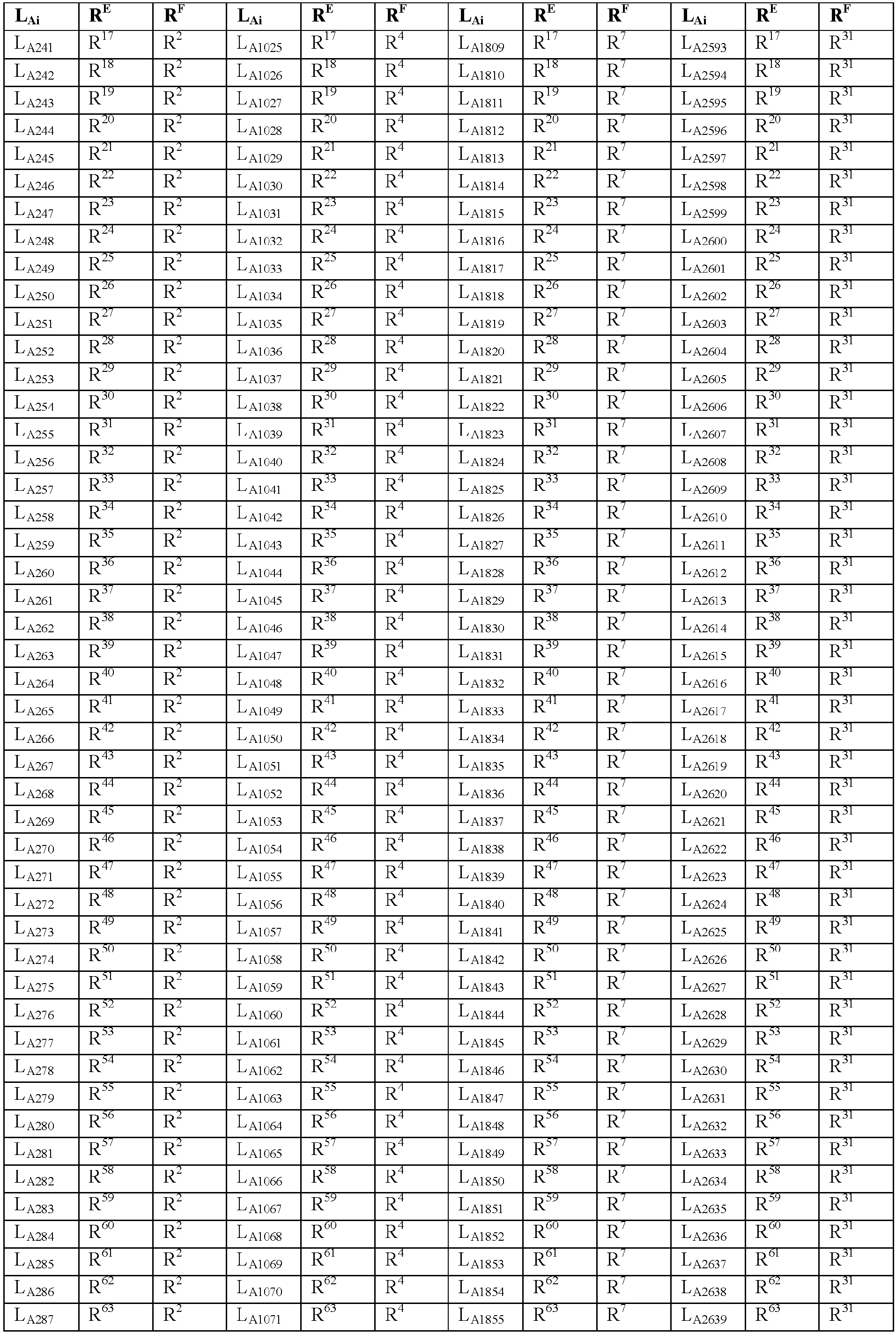

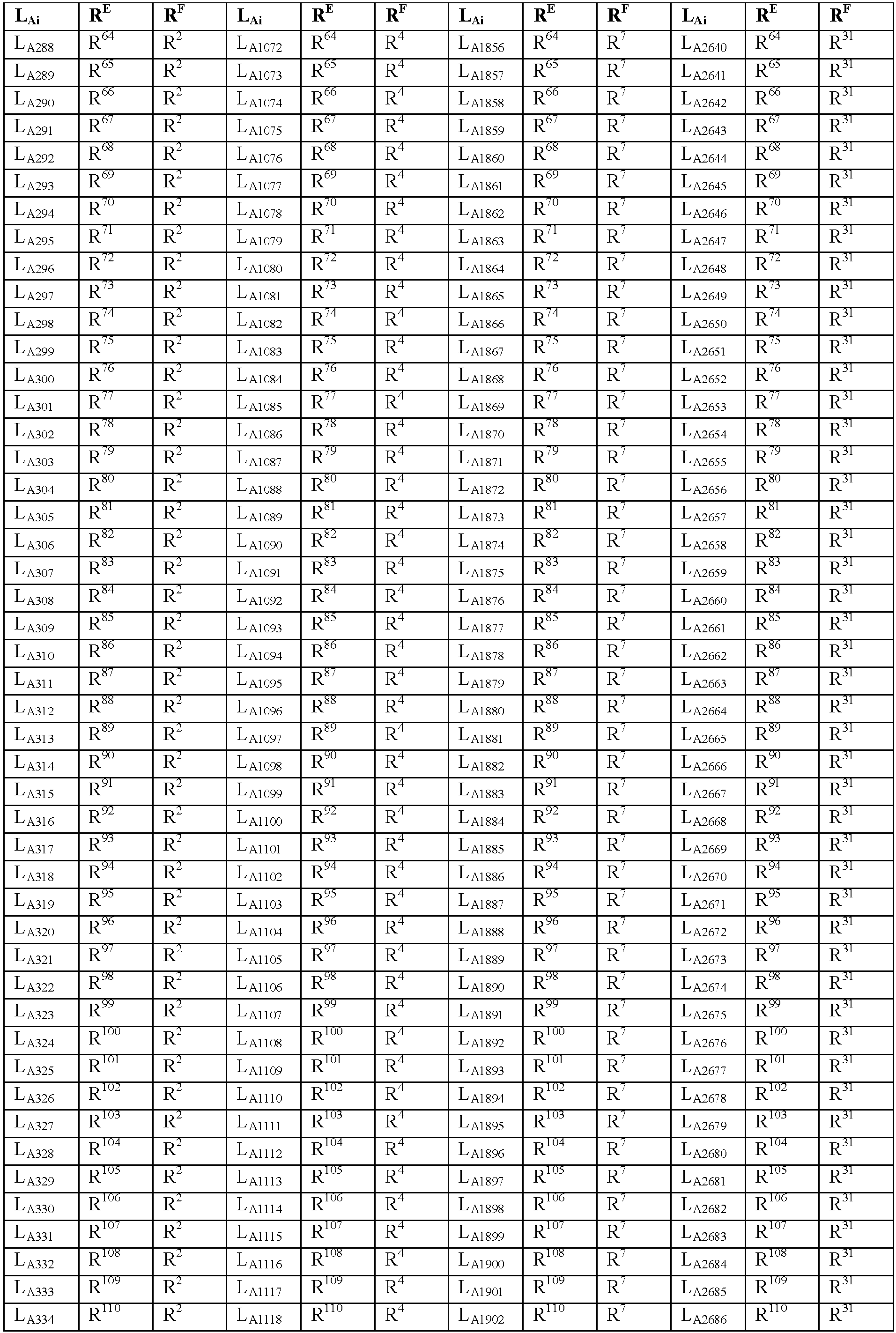

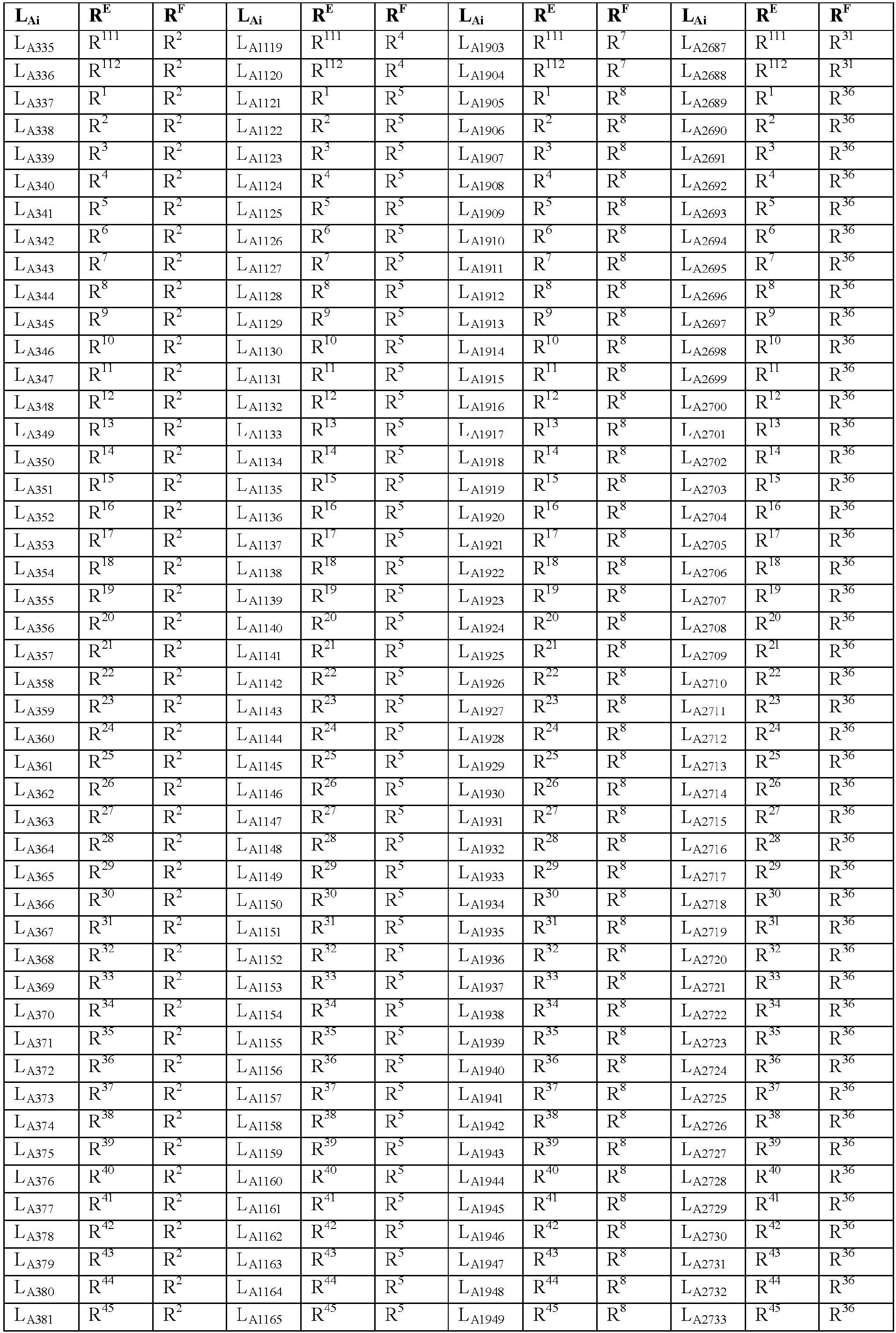

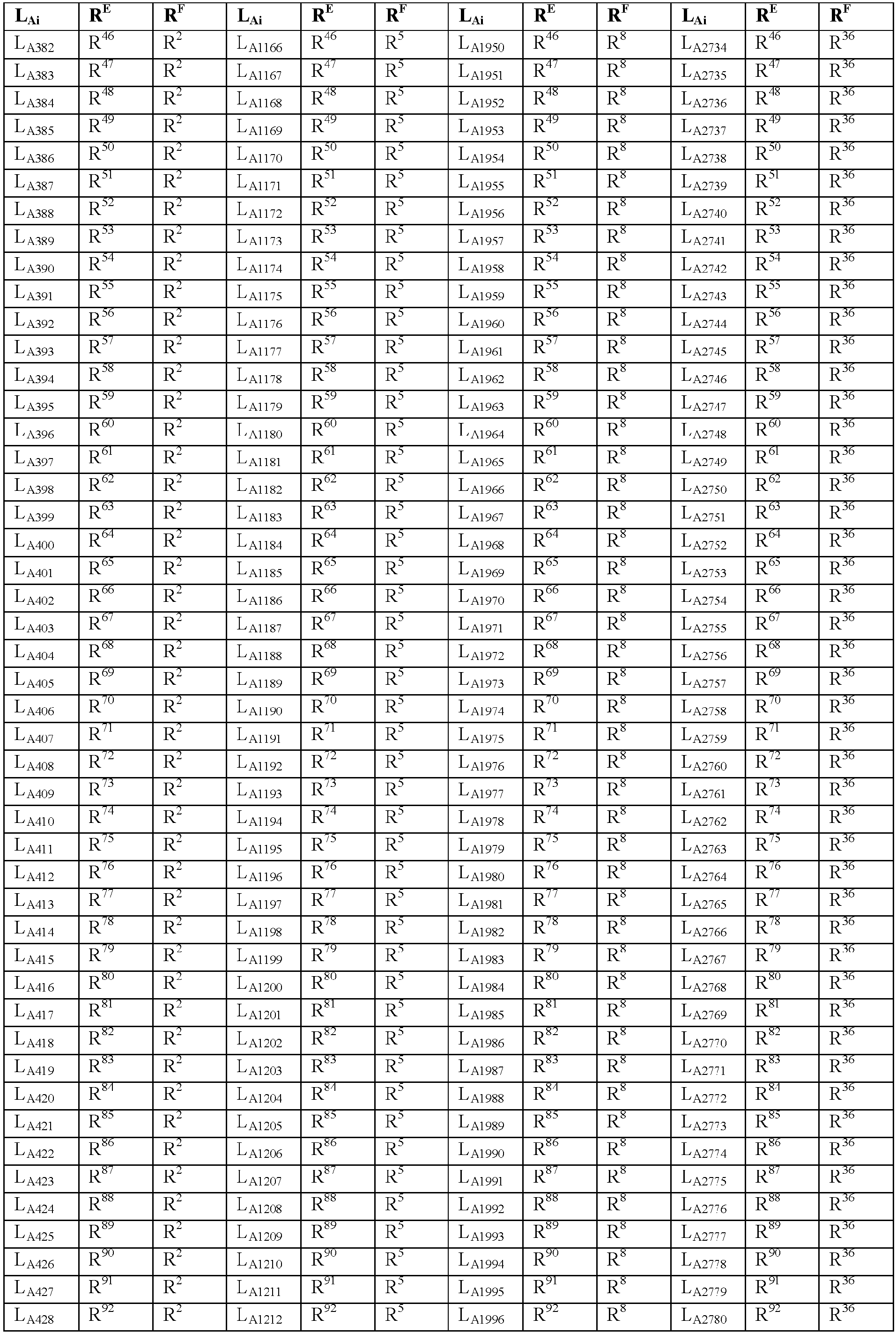

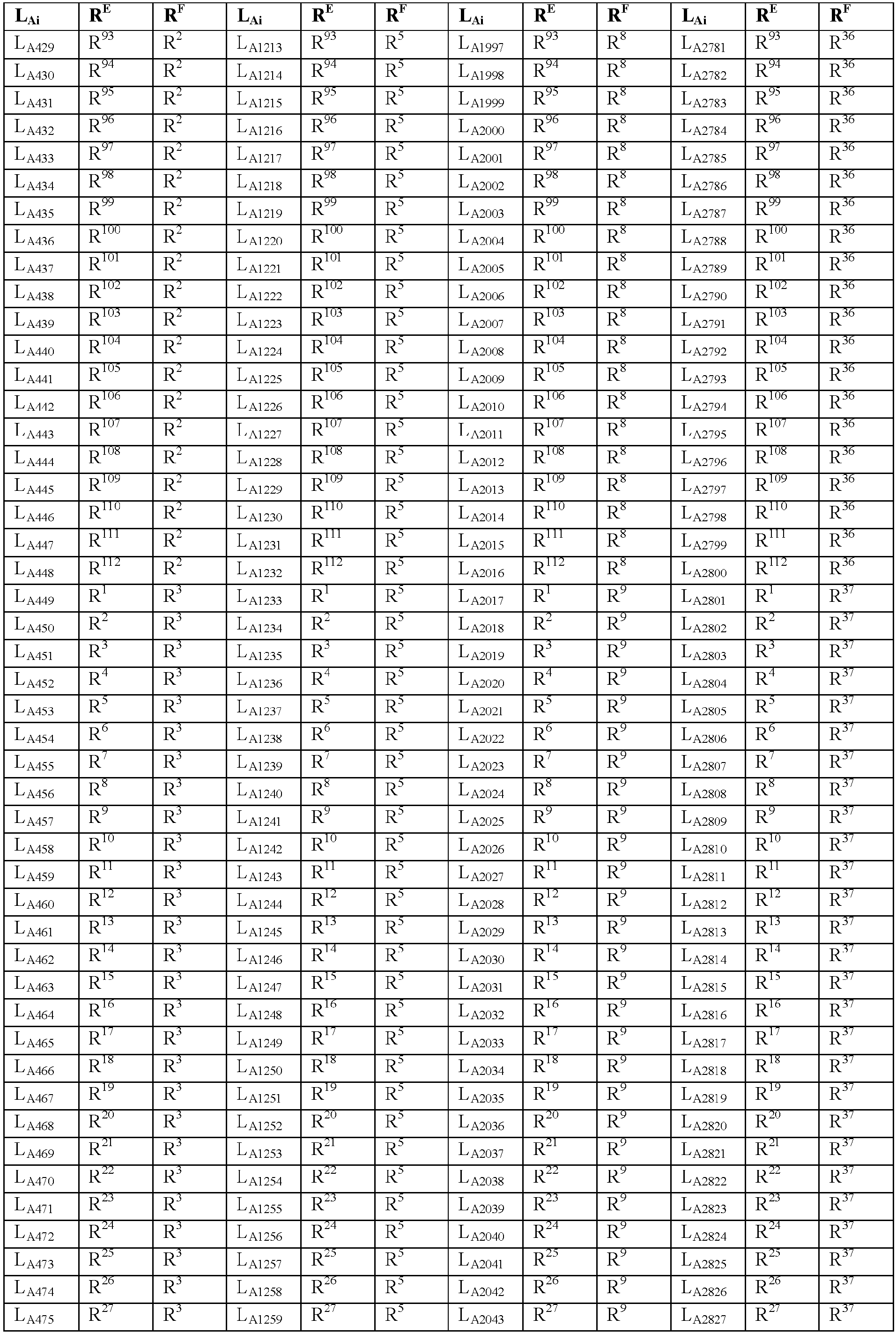

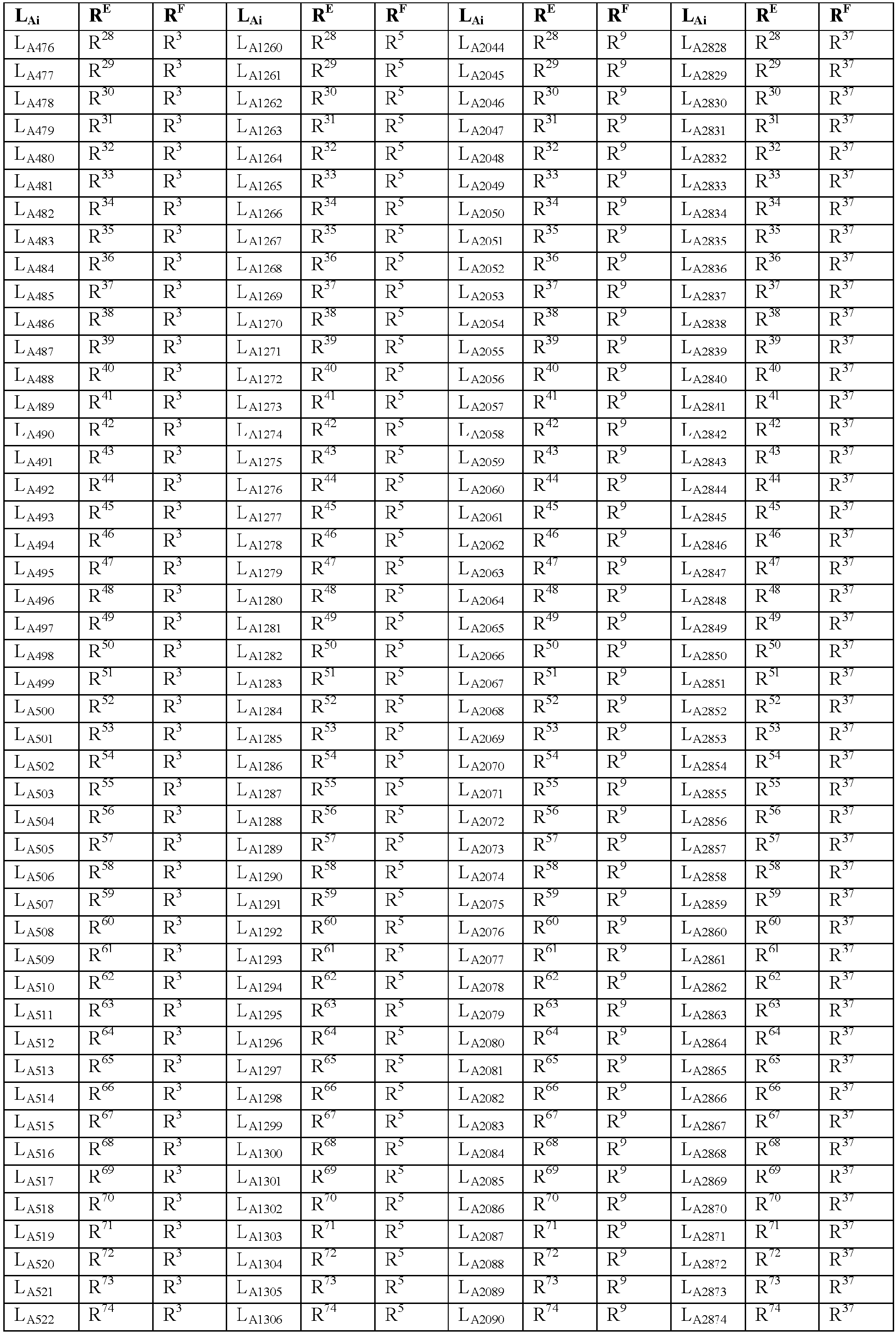

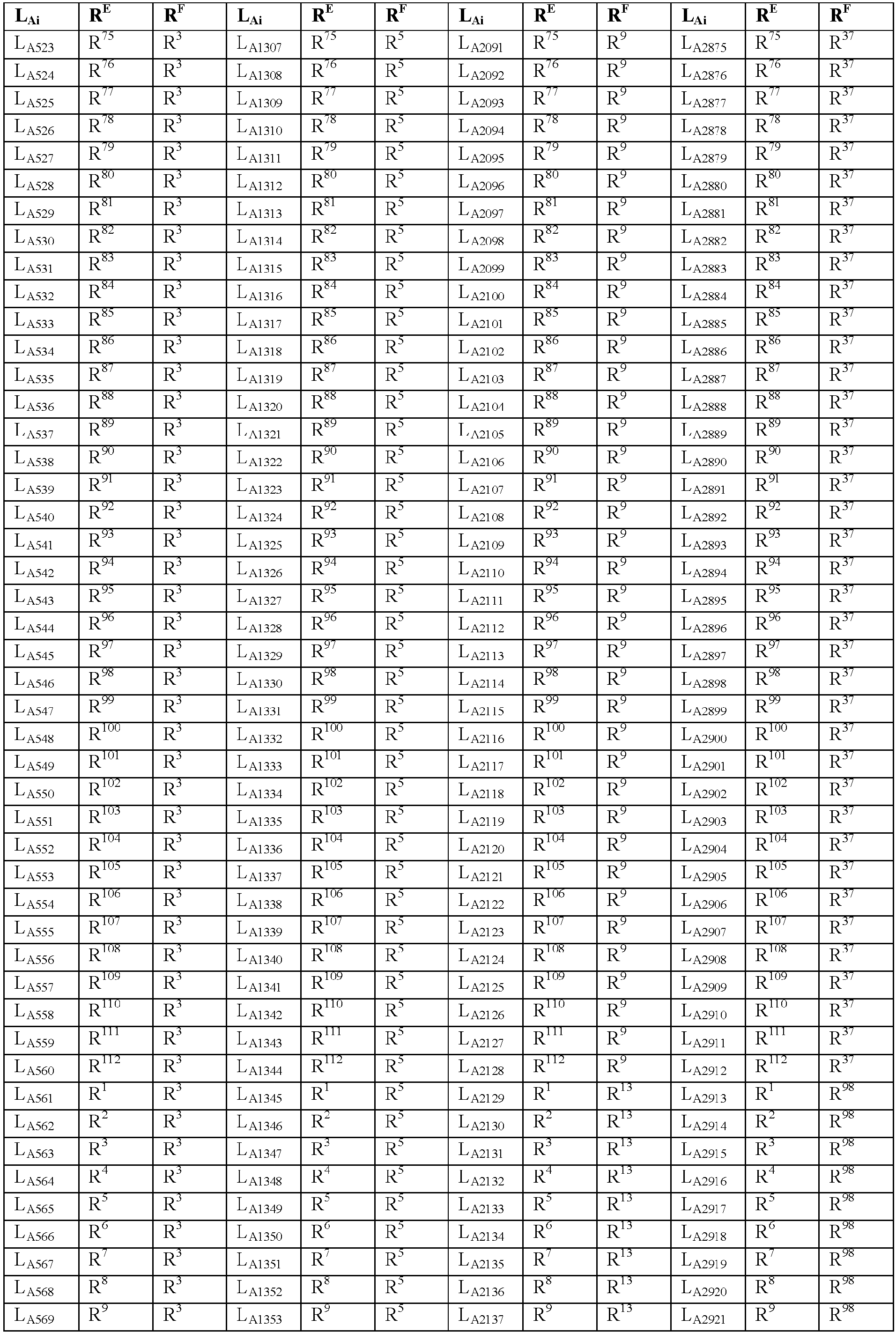

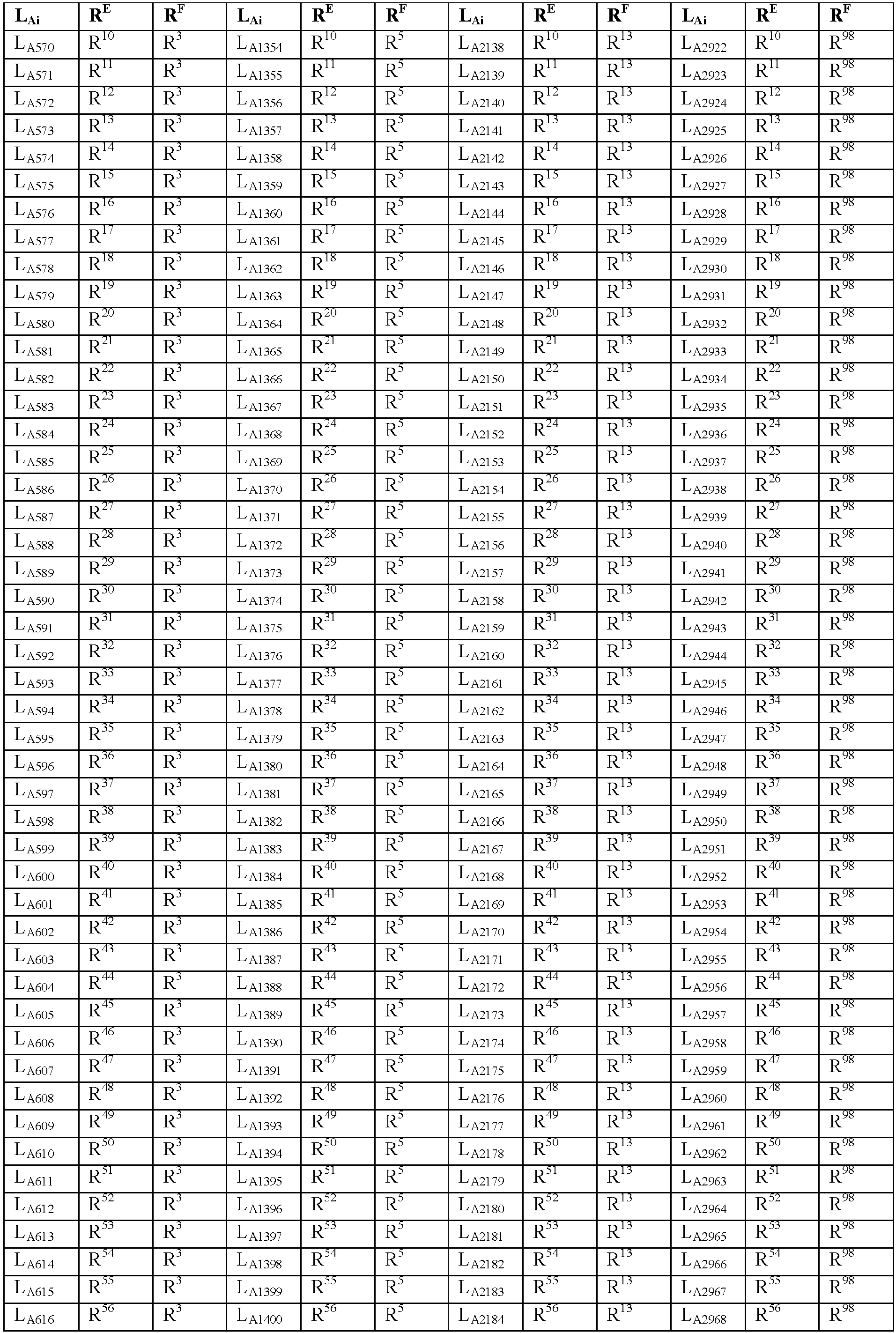

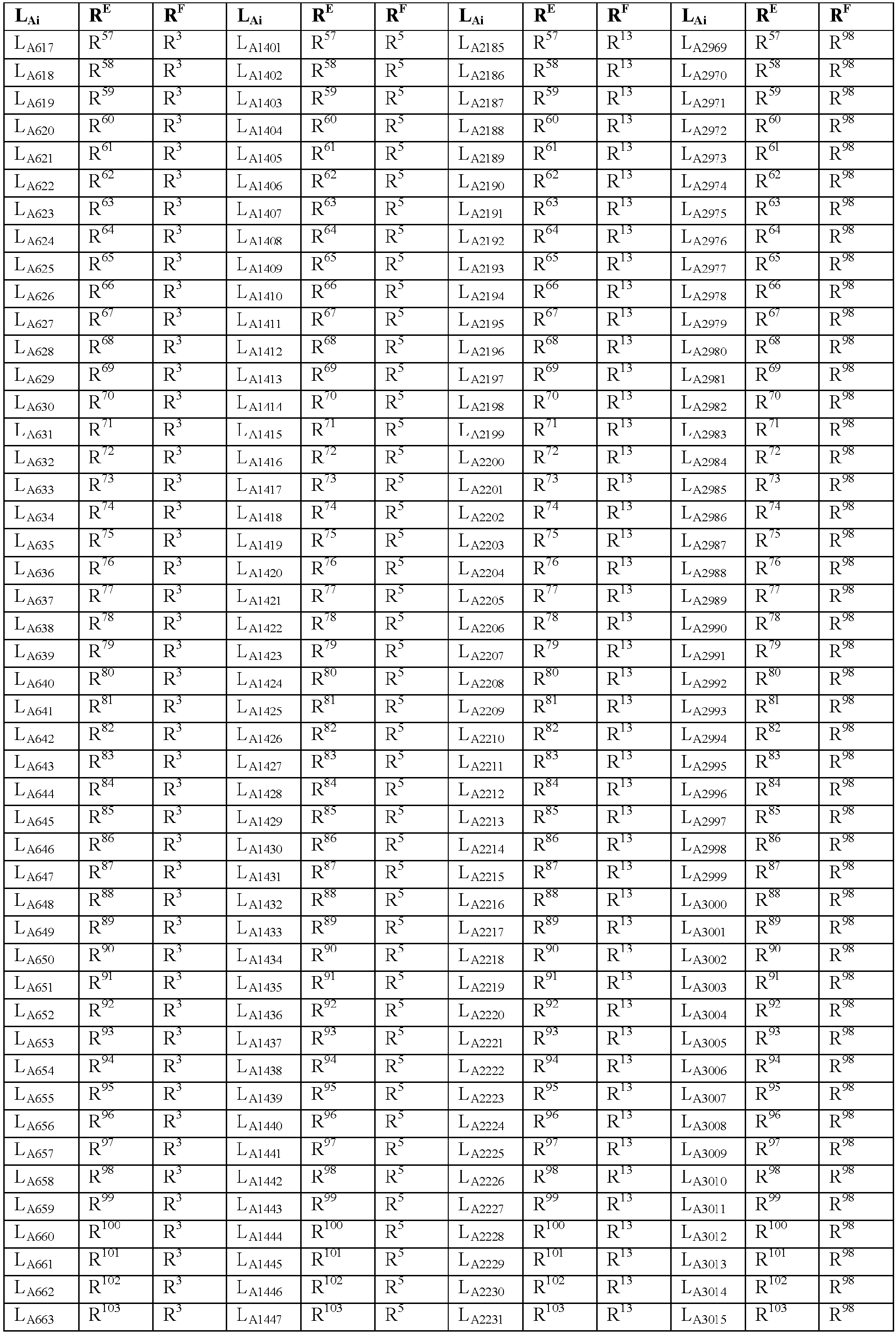

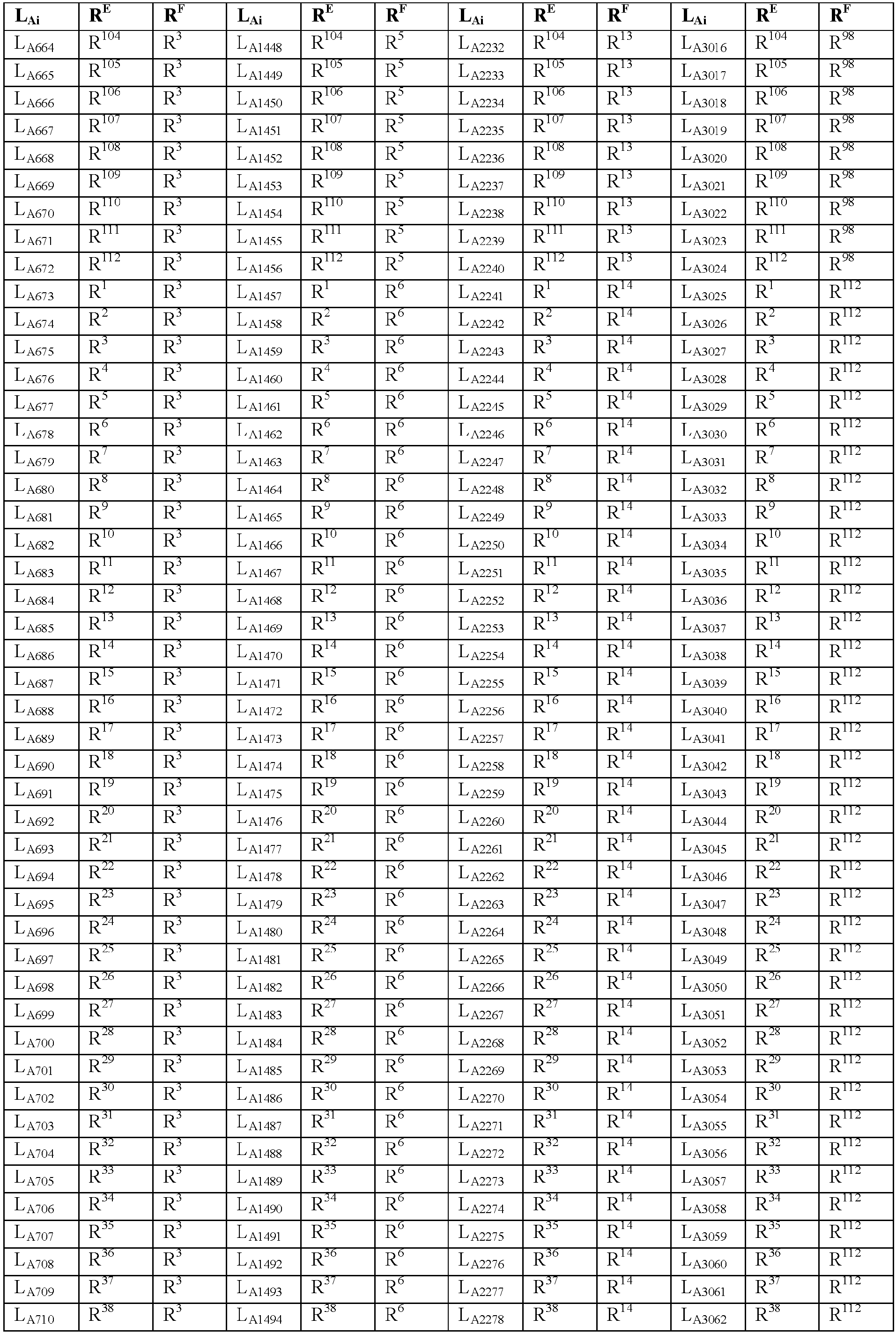

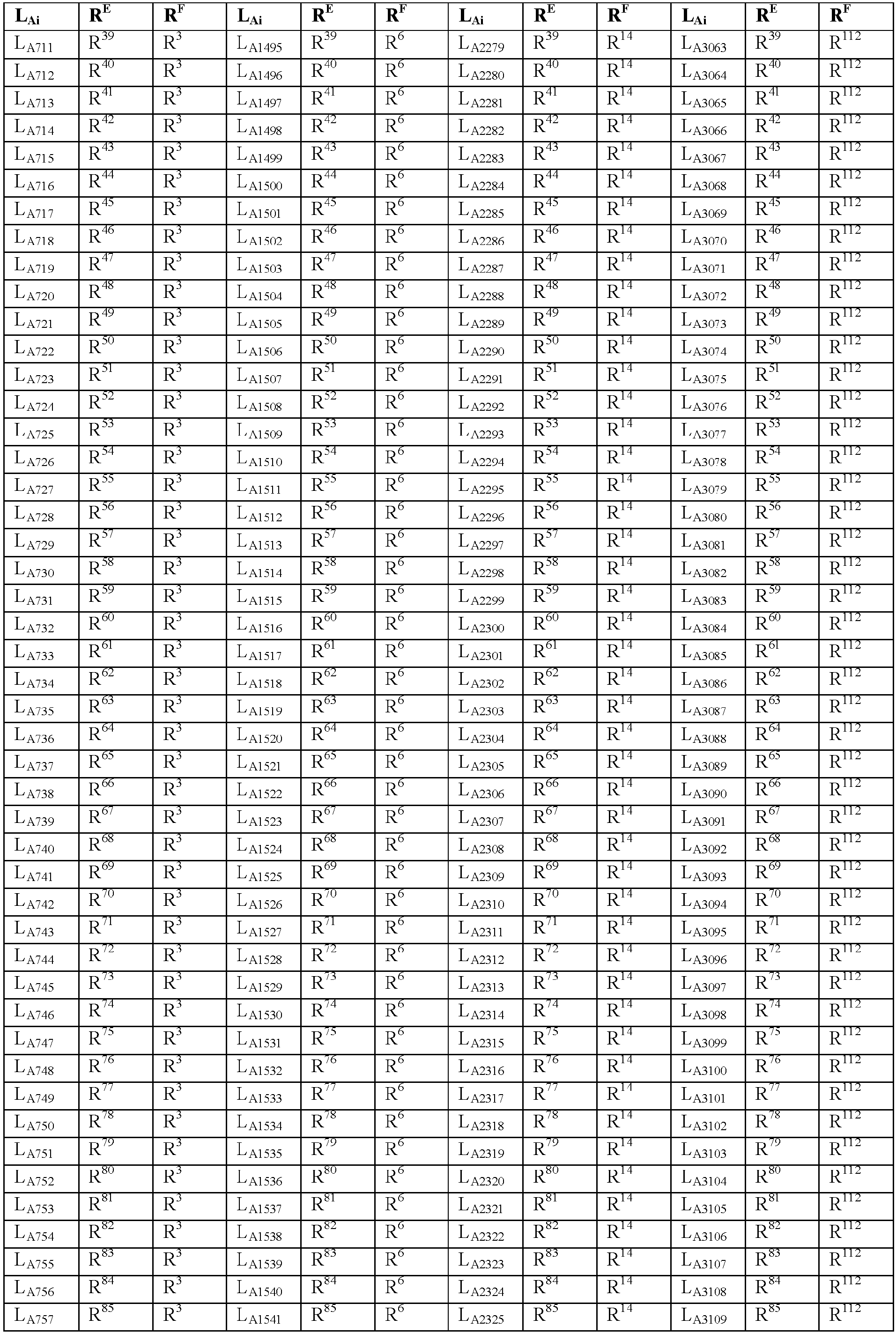

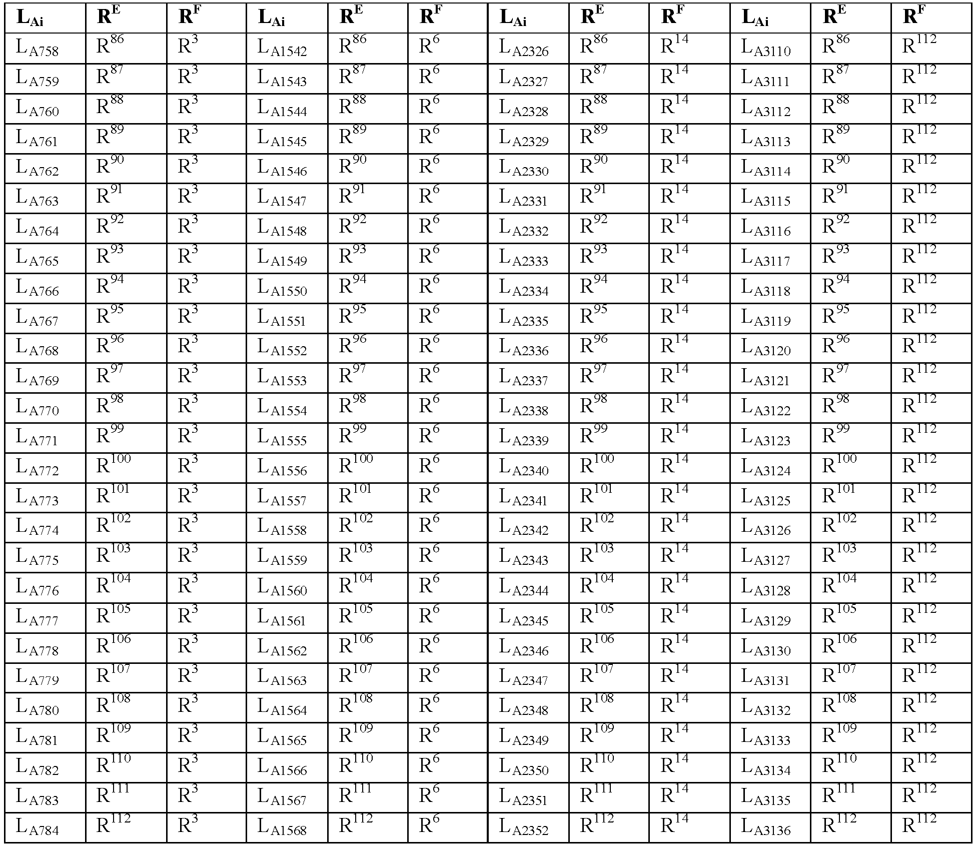

wherein R¹ to R¹¹² have the structures in the following LIST 5:

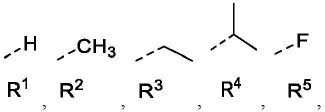

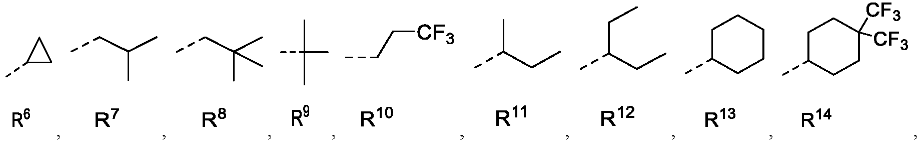

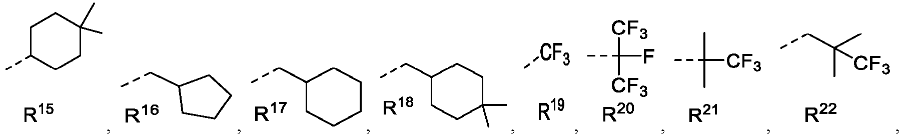

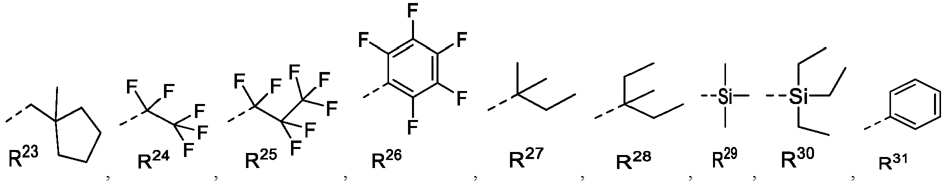

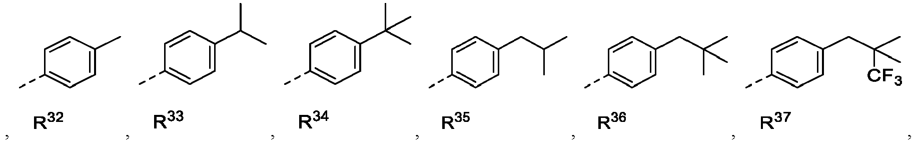

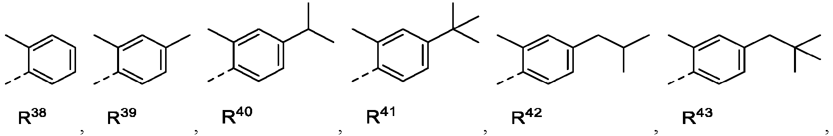

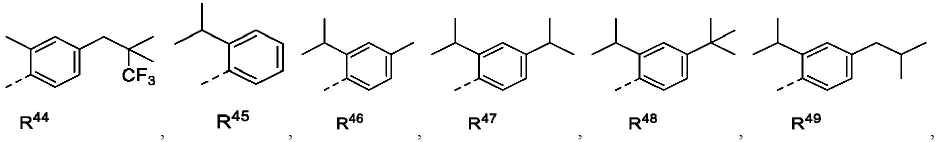

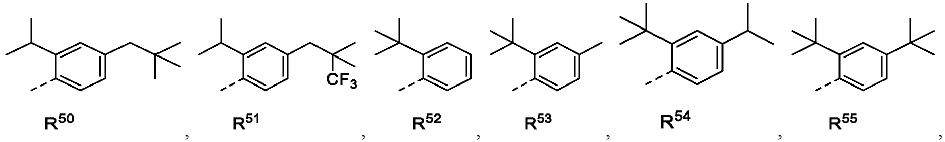

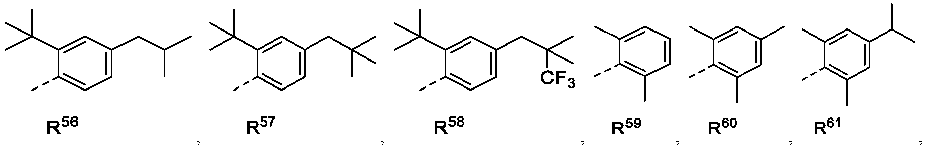

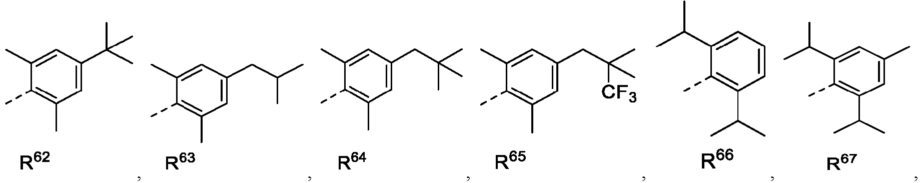

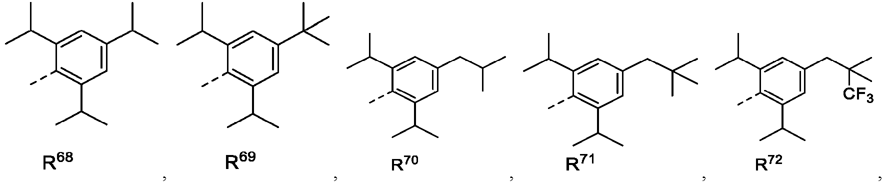

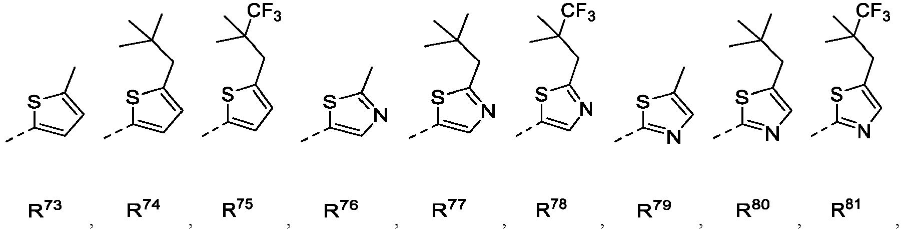

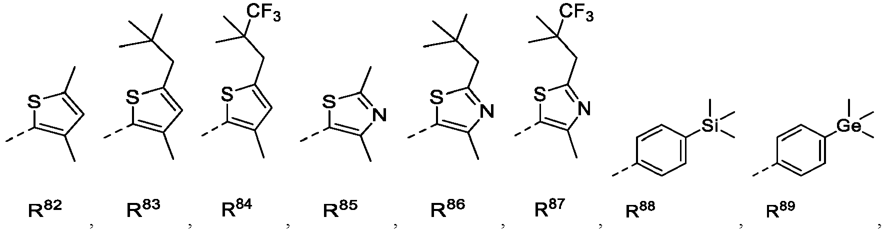

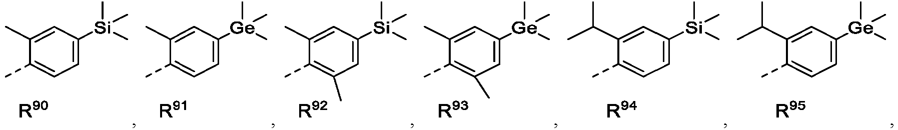

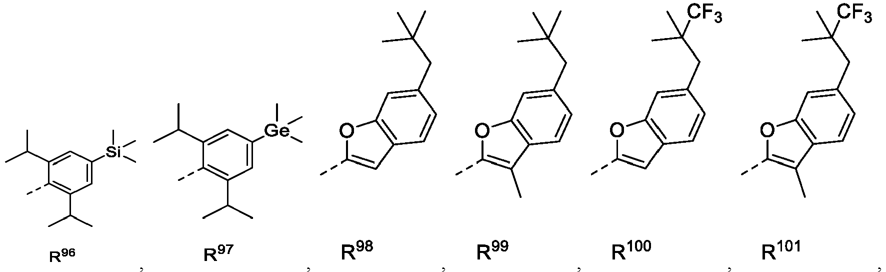

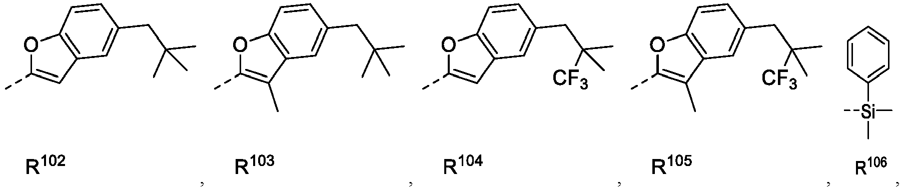

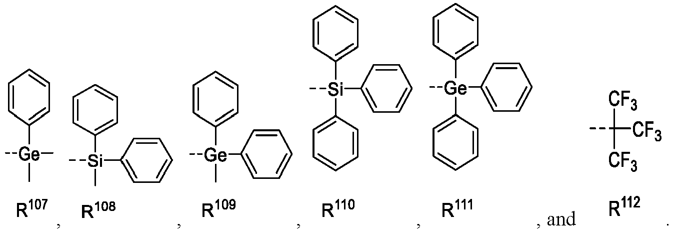

In some embodiments, the compound has a formula of M(L_{A})ₚ(L_{B})_{q}(L_{C})ᵣ wherein L_{B} and L_{C} are each a bidentate ligand; and wherein p is 1, 2, or 3; q is 0, 1, or 2; r is 0, 1, or 2; and p+q+r is the oxidation state of the metal M.

In some embodiments, the compound has a formula selected from the group consisting of Ir(L_{A})₃, Ir(L_{A})(L_{B})₂, Ir(L_{A})₂(L_{B}), Ir(L_{A})₂(L_{C}), and Ir(L_{A})(L_{B})(L_{C}); and wherein L_{A}, L_{B}, and L_{C} are different from each other.

In some embodiments, L_{B} is a substituted or unsubstituted phenylpyridine, and L_{C} is a substituted or unsubstituted acetylacetonate.

In some embodiments, the compound has a formula of Pt(L_{A})(L_{B}); and wherein L_{A} and L_{B} can be same or different. In some such embodiments, L_{A} and L_{B} are connected to form a tetradentate ligand.

In some embodiments of the compound comprising the ligand L_{A} that includes at least one of the following substituents R^{A}, R^{B}, R^{C} R^{D}, R^{AA}, R^{BB}, R^{CC}, R^{DD}, R^{E}, and R^{F}, at least one of the R^{A}, R^{B}, R^{C}, R^{D}, R^{AA}, R^{BB}, R^{CC}, R^{DD}, R^{E}, and R^{F} in the ligand L_{A} is or comprises an electron-withdrawing group from the EWG1 LIST as defined herein. In some embodiments, at least one of the R^{A}, R^{B}, R^{C}, R^{D}, R^{AA}, R^{BB}, R^{CC}, R^{DD}, R^{E}, and R^{F} in the ligand L_{A} is or comprises an electron-withdrawing group from the EWG2 LIST as defined herein. In some embodiments, at least one of the R^{A}, R^{B}, R^{C}, R^{D}, R^{AA}, R^{BB}, R^{CC}, R^{DD}, R^{F}, and R^{F} in the ligand L_{A} is or comprises an electron-withdrawing group from the EWG3 LIST as defined herein. In some embodiments, at least one of the R^{A}, R^{B}, R^{C}, R^{D}, R^{AA}, R^{BB}, R^{CC}, R^{DD}, R^{E}, and R^{F} in the ligand L_{A} is or comprises an electron-withdrawing group from the EWG4 LIST as defined herein. In some embodiments, at least one the R^{A}, R^{B}, R^{C} R^{D}, R^{AA}, R^{BB}, R^{CC}, R^{DD}, R^{E}, and R^{F} in the ligand L_{A} is or comprises an electron-withdrawing group from the Pi-EWG LIST as defined herein.

In some embodiments of the compound comprising the ligand L_{A} that includes the substituents R^{A}, at least one of R^{A} is or comprises an electron-withdrawing group from the EWG1 LIST as defined herein. In some embodiments, at least one of R^{A} is or comprises an electron-withdrawing group from the EWG2 LIST as defined herein. In some embodiments, at least one of R^{A} is or comprises an electron-withdrawing group from the EWG3 LIST as defined herein. In some embodiments, at least one of R^{A} is or comprises an electron-withdrawing group from the EWG4 LIST as defined herein. In some embodiments, at least one of R^{A} is or comprises an electron-withdrawing group from the Pi-EWG LIST as defined herein.

In some embodiments of the compound comprising the ligand L_{A} that includes the substituents R^{B}, at least one of R^{B} is or comprises an electron-withdrawing group from the EWG1 LIST as defined herein. In some embodiments, at least one of R^{B} is or comprises an electron-withdrawing group from the EWG2 LIST as defined herein. In some embodiments, at least one of R^{B} is or comprises an electron-withdrawing group from the EWG3 LIST as defined herein. In some embodiments, at least one of R^{B} is or comprises an electron-withdrawing group from the EWG4 LIST as defined herein. In some embodiments, at least one of R^{B} is or comprises an electron-withdrawing group from the Pi-EWG LIST as defined herein.

In some embodiments of the compound comprising the ligand L_{A} that includes the substituents R^{C}, at least one of R^{C} is or comprises an electron-withdrawing group from the EWG1 LIST as defined herein. In some embodiments, at least one of R^{C} is or comprises an electron-withdrawing group from the EWG2 LIST as defined herein. In some embodiments, at least one of R^{C} is or comprises an electron-withdrawing group from the EWG3 LIST as defined herein. In some embodiments, at least one of R^{C} is or comprises an electron-withdrawing group from the EWG4 LIST as defined herein. In some embodiments, at least one of R^{C} is or comprises an electron-withdrawing group from the Pi-EWG LIST as defined herein.

In some embodiments of the compound comprising the ligand L_{A} that includes the substituents R^{D}, at least one of R^{D} is or comprises an electron-withdrawing group from the EWG1 LIST as defined herein. In some embodiments, at least one of R^{D} is or comprises an electron-withdrawing group from the EWG2 LIST as defined herein. In some embodiments, at least one of R^{D} is or comprises an electron-withdrawing group from the EWG3 LIST as defined herein. In some embodiments, at least one of R^{D} is or comprises an electron-withdrawing group from the EWG4 LIST as defined herein. In some embodiments, at least one of R^{D} is or comprises an electron-withdrawing group from the Pi-EWG LIST as defined herein.

In some embodiments of the compound comprising the ligand L_{A} that includes the substituents R^{AA}, at least one of R^{AA} is or comprises an electron-withdrawing group from the EWG1 LIST as defined herein. In some embodiments, at least one of R^{AA} is or comprises an electron-withdrawing group from the EWG2 LIST as defined herein. In some embodiments, at least one of R^{AA} is or comprises an electron-withdrawing group from the EWG3 LIST as defined herein. In some embodiments, at least one of R^{AA} is or comprises an electron-withdrawing group from the EWG4 LIST as defined herein. In some embodiments, at least one of R^{AA} is or comprises an electron-withdrawing group from the Pi-EWG LIST as defined herein.

In some embodiments of the compound comprising the ligand L_{A} that includes the substituents R^{BB}, at least one of R^{BB} is or comprises an electron-withdrawing group from the EWG1 LIST as defined herein. In some embodiments, at least one of R^{BB} is or comprises an electron-withdrawing group from the EWG2 LIST as defined herein. In some embodiments, at least one of R^{BB} is or comprises an electron-withdrawing group from the EWG3 LIST as defined herein. In some embodiments, at least one of R^{BB} is or comprises an electron-withdrawing group from the EWG4 LIST as defined herein. In some embodiments, at least one of R^{BB} is or comprises an electron-withdrawing group from the Pi-EWG LIST as defined herein.

In some embodiments of the compound comprising the ligand L_{A} that includes the substituents R^{CC}, at least one of R^{CC} is or comprises an electron-withdrawing group from the EWG1 LIST as defined herein. In some embodiments, at least one of R^{CC} is or comprises an electron-withdrawing group from the EWG2 LIST as defined herein. In some embodiments, at least one of R^{CC} is or comprises an electron-withdrawing group from the EWG3 LIST as defined herein. In some embodiments, at least one of R^{CC} is or comprises an electron-withdrawing group from the EWG4 LIST as defined herein. In some embodiments, at least one of R^{CC} is or comprises an electron-withdrawing group from the Pi-EWG LIST as defined herein.

In some embodiments of the compound comprising the ligand L_{A} that includes the substituents R^{DD}, at least one of R^{DD} is or comprises an electron-withdrawing group from the EWG1 LIST as defined herein. In some embodiments, at least one of R^{DD} is or comprises an electron-withdrawing group from the EWG2 LIST as defined herein. In some embodiments, at least one of R^{DD} is or comprises an electron-withdrawing group from the EWG3 LIST as defined herein. In some embodiments, at least one of R^{DD} is or comprises an electron-withdrawing group from the EWG4 LIST as defined herein. In some embodiments, at least one of R^{DD} is or comprises an electron-withdrawing group from the Pi-EWG LIST as defined herein.

In some embodiments of the compound comprising the ligand L_{A} that includes the substituents R^{E} and R^{F}, at least one of R^{E} and R^{F} is or comprises an electron-withdrawing group from the EWG1 LIST as defined herein. In some embodiments, at least one of R^{F} and R^{F} is or comprises an electron-withdrawing group from the EWG2 LIST as defined herein. In some embodiments, at least one of R^{E} and R^{F} is or comprises an electron-withdrawing group from the EWG3 LIST as defined herein. In some embodiments, at least one of R^{E} and R^{F} is or comprises an electron-withdrawing group from the EWG4 LIST as defined herein. In some embodiments, at least one of R^{E} and R^{F} is or comprises an electron-withdrawing group from the Pi-EWG LIST as defined herein.

In some embodiments, L_{B} and L_{C} are each independently selected from the group consisting of the structures of the following LIST 6: 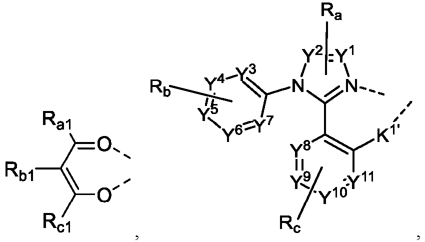 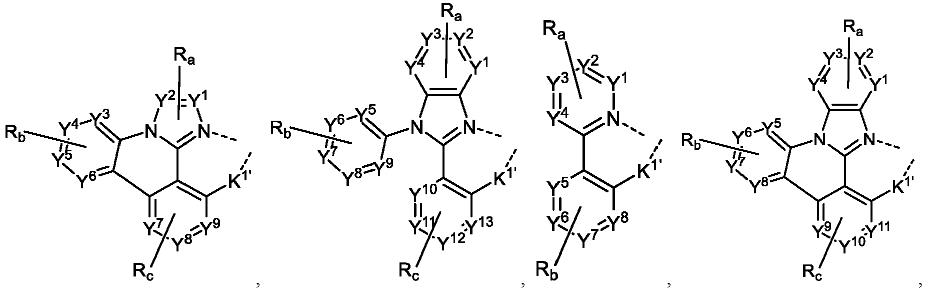 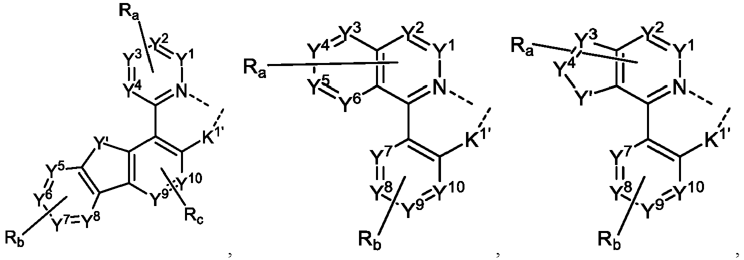 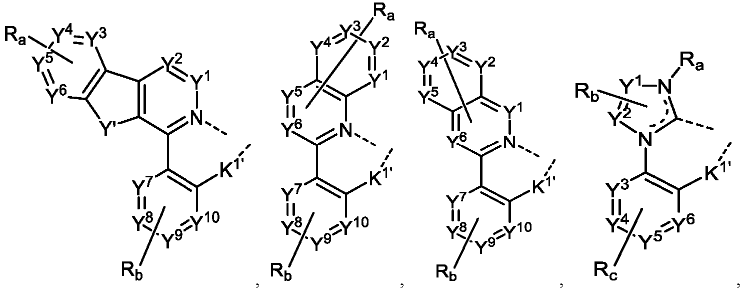 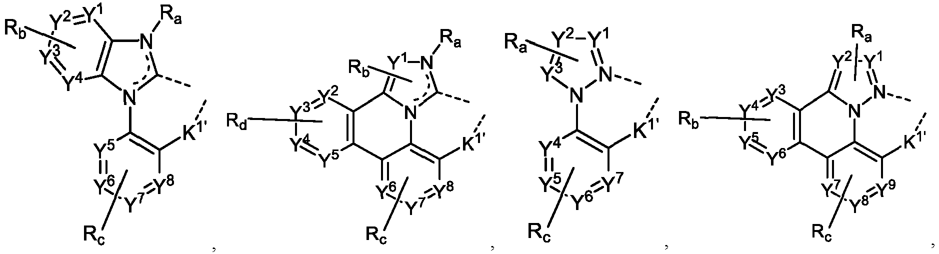 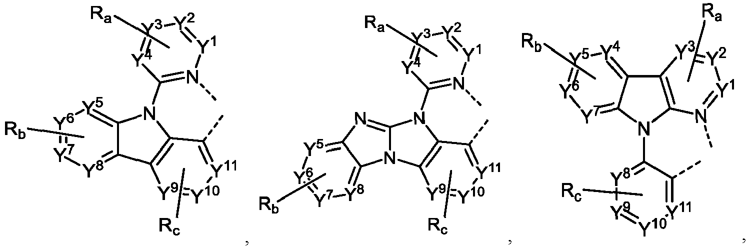 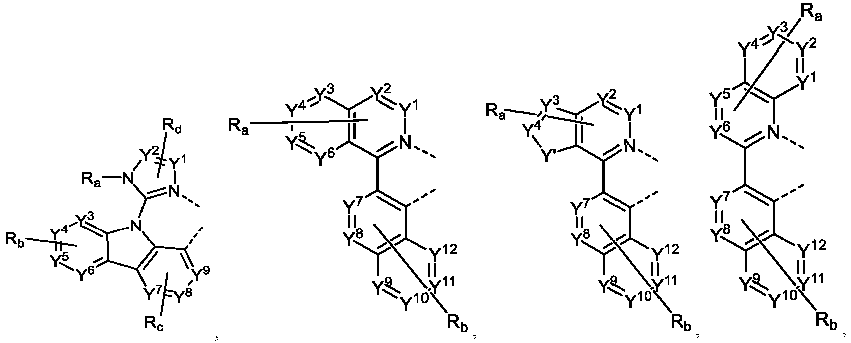 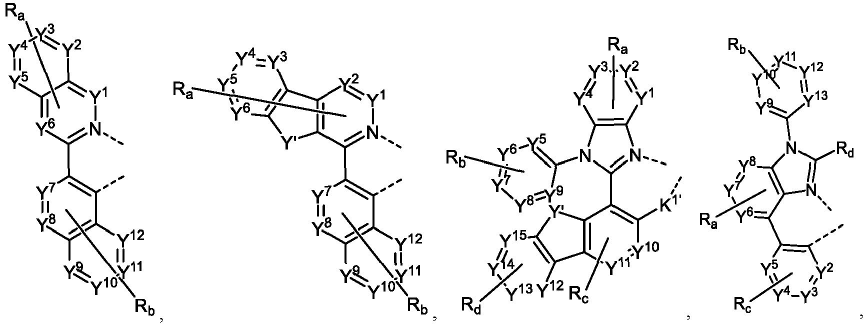 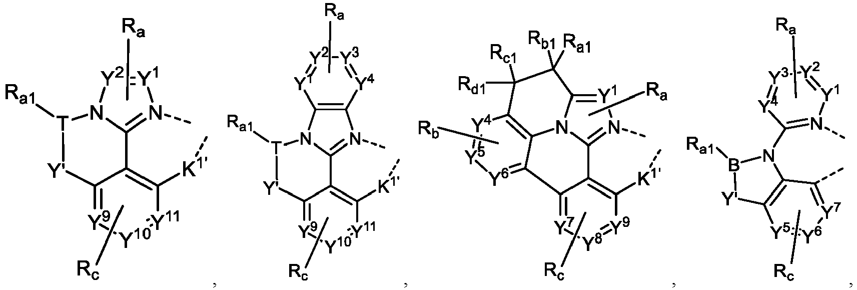 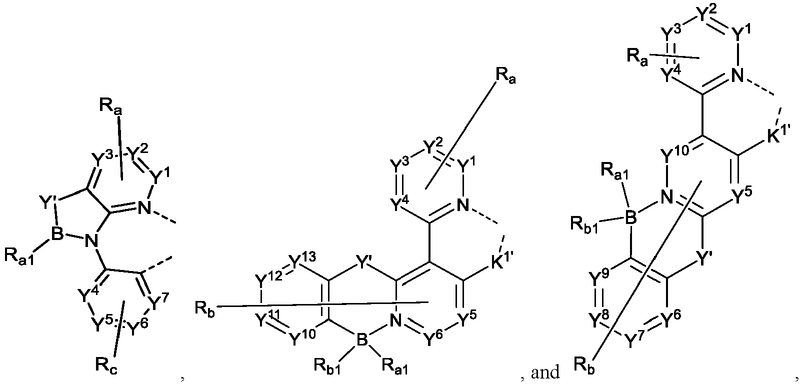 wherein:
T is selected from the group consisting of B, Al, Ga, and In;
K^{1'} is selected from the group consisting of a single bond, O, S, NRₑ, PRₑ, BRₑ, CRₑR_{f}, and SiRₑR_{f};
each of Y¹ to Y¹³ is independently selected from the group consisting of C and N;
Y' is selected from the group consisting of BRₑ, BRₑR_{f}, NRₑ, PRₑ, P(O)Rₑ, O, S, Se, C=O, C=S, C=Se, C=NRₑ, C=CRₑR_{f}, S=O, SO₂, CRₑR_{f}, SiRₑR_{f}, and GeRₑR_{f};
Rₑ and R_{f} can be fused or joined to form a ring;
each Rₐ, R_{b}, R_{c}, and R_{d} independently represents from mono to the maximum allowed number of substitutions, or no substitution;
each of Rₐ₁, R_{b1}, R_{c1}, R_{d1}, Rₐ, R_{b}, R_{c}, R_{d}, Rₑ, and R_{f} is independently a hydrogen or a subsituent selected from the group consisting of the General Substituents defined herein; and
any two substituents of Rₐ₁, R_{b1}, R_{c1}, R_{d1}, Rₐ, R_{b}, R_{c}, and R_{d} can be fused or joined to form a ring or form a multidentate ligand.

In some embodiments, L_{B} and L_{C} are each independently selected from the group consisting of the structures of the following LIST 7: 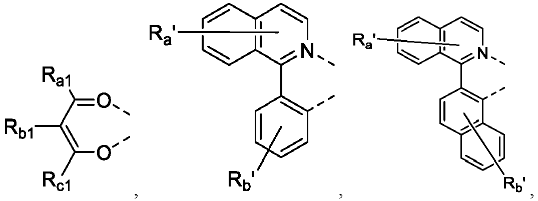 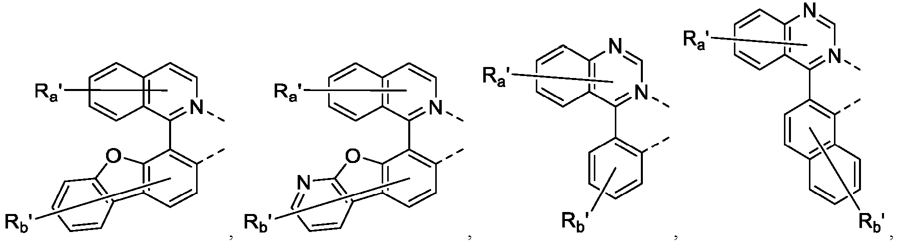 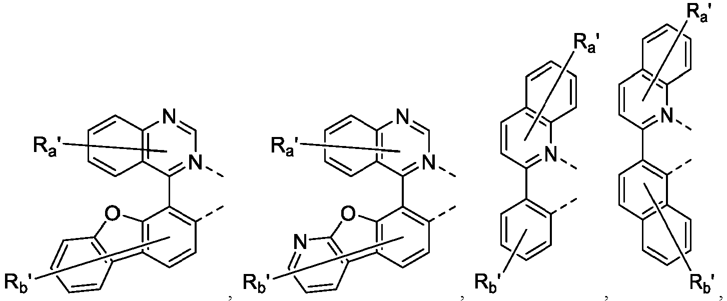 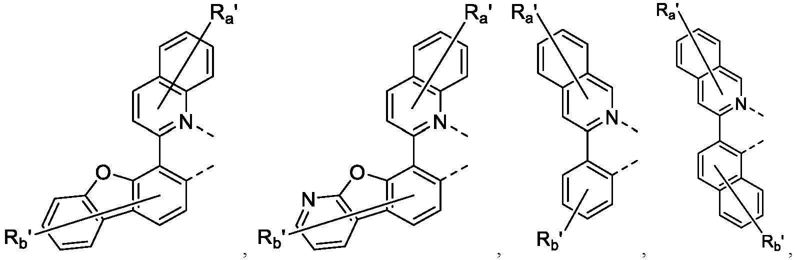 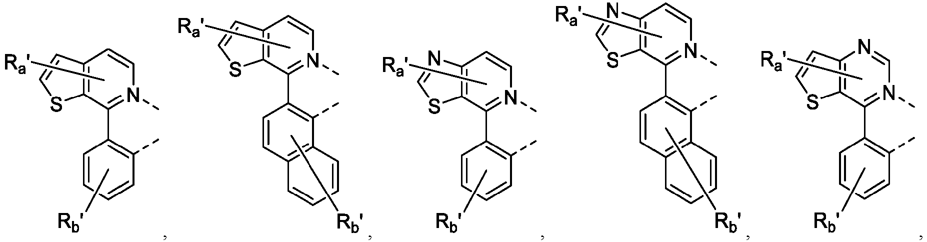 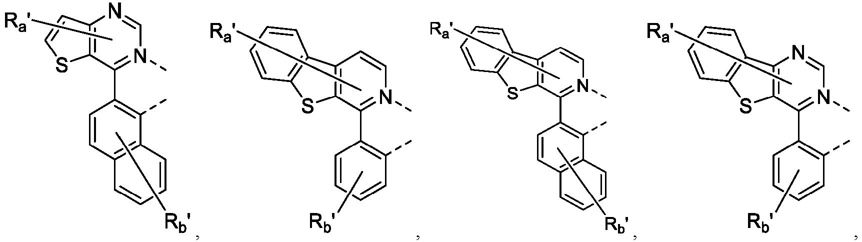 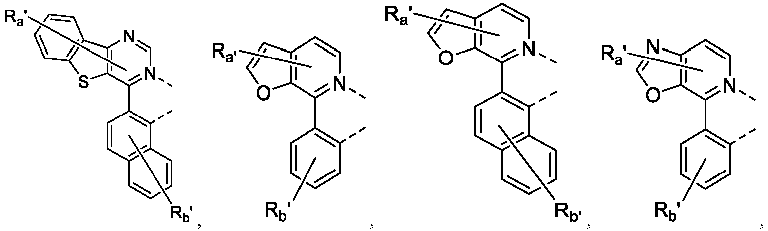 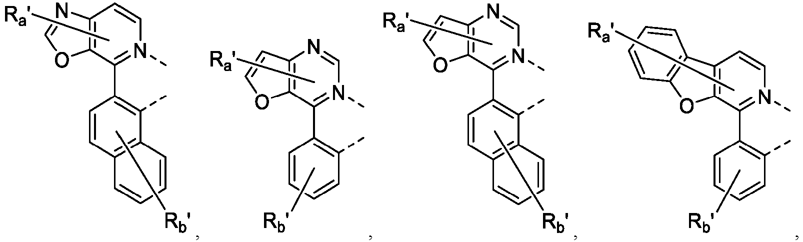 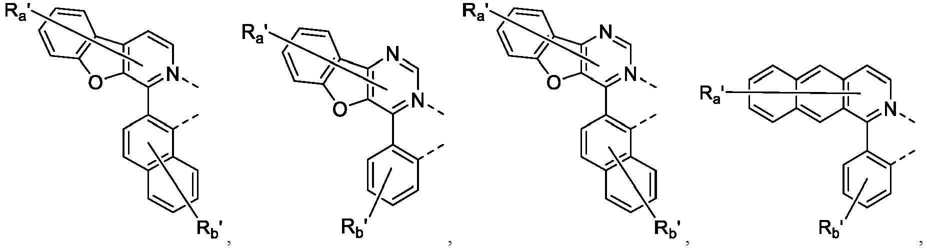 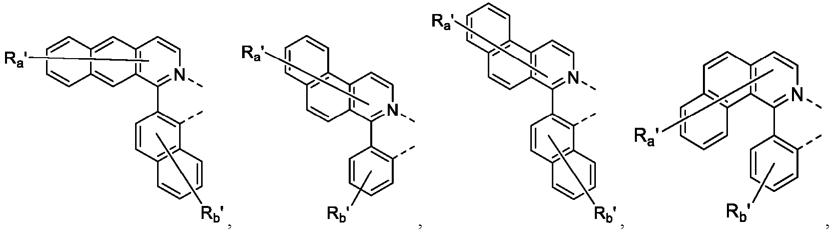 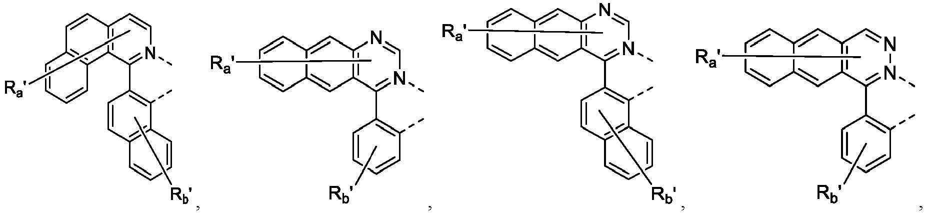 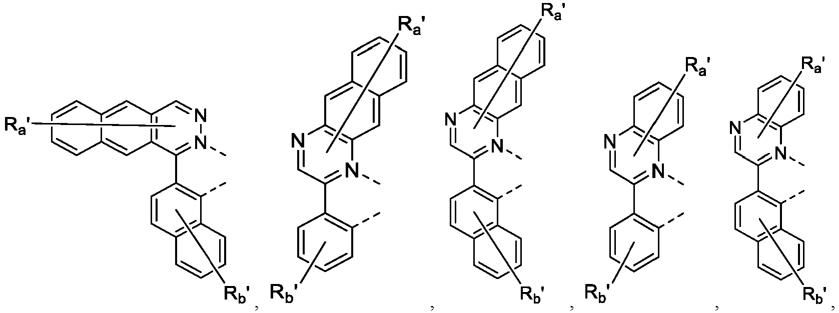 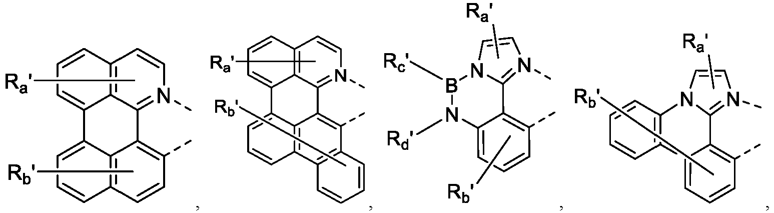 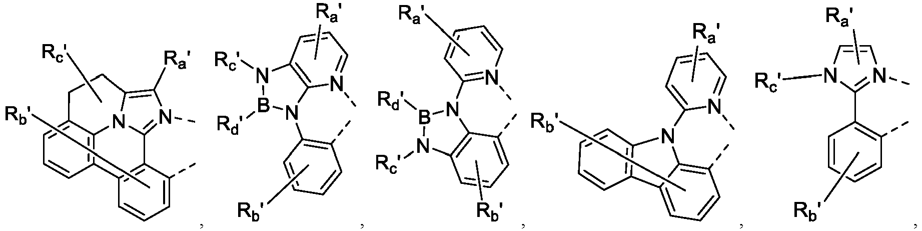 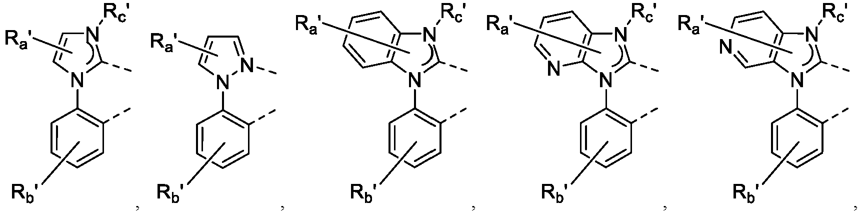 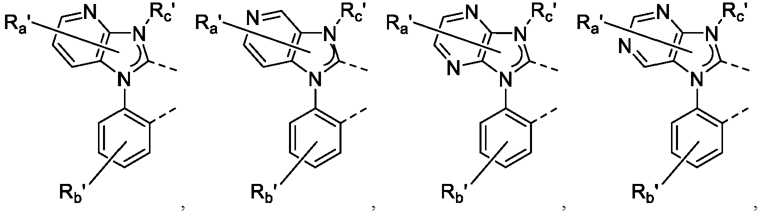 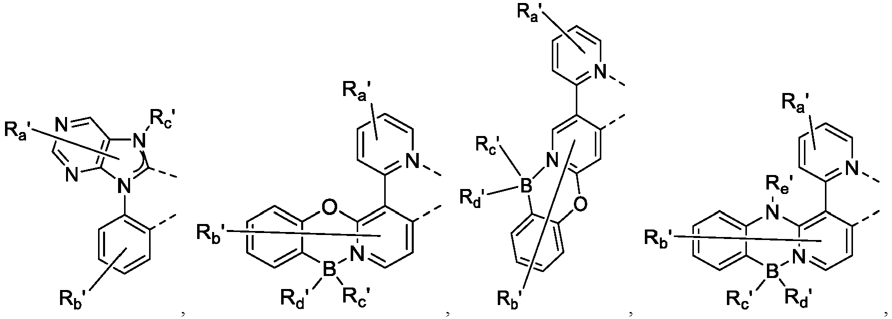 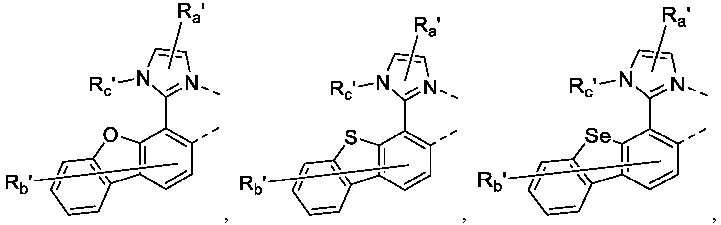 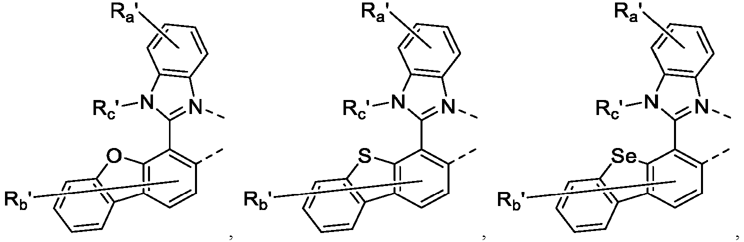 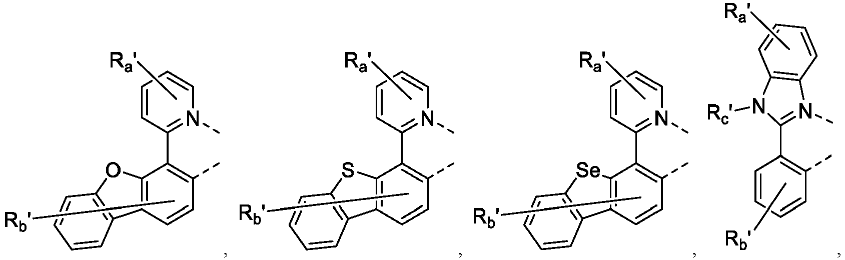 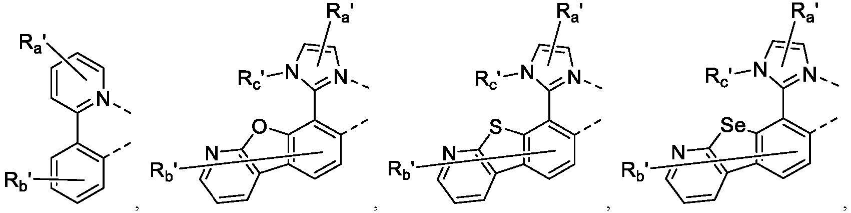 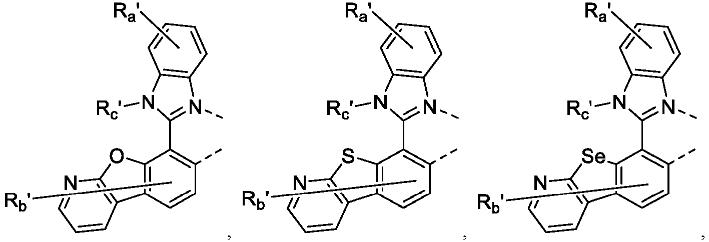 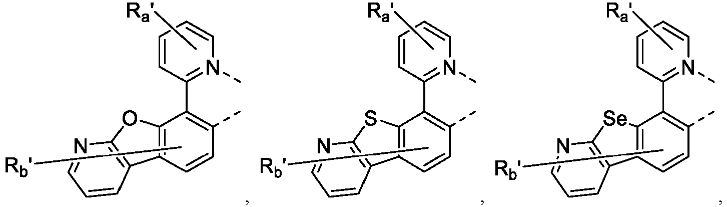 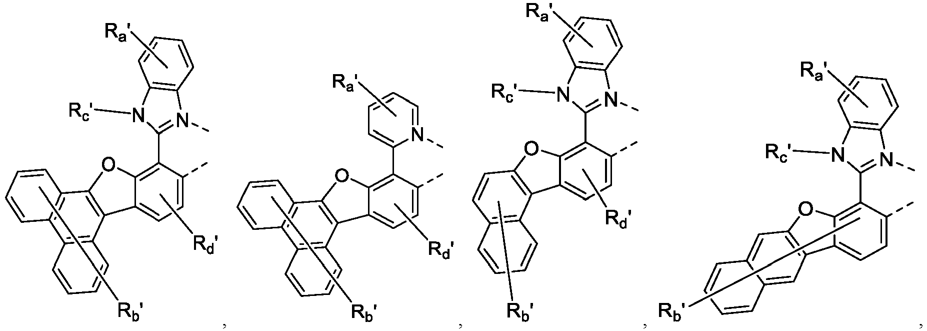 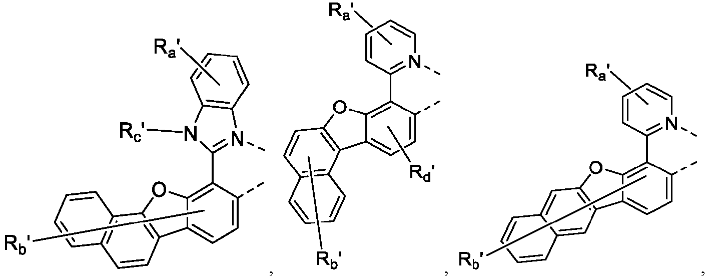 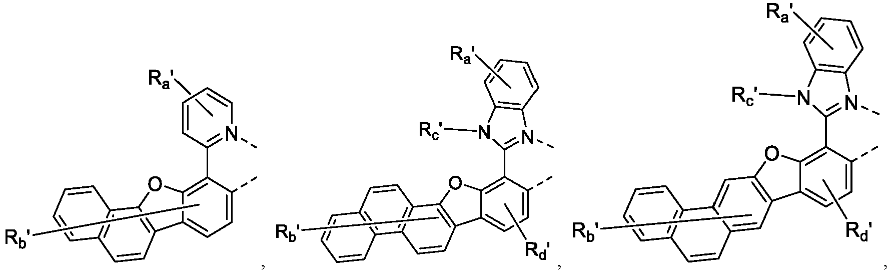 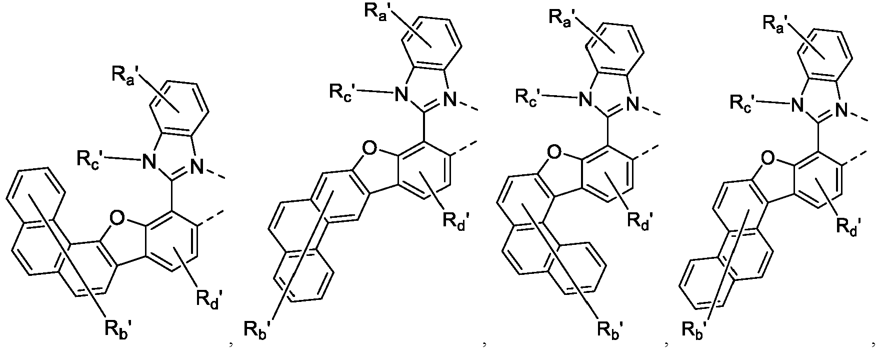 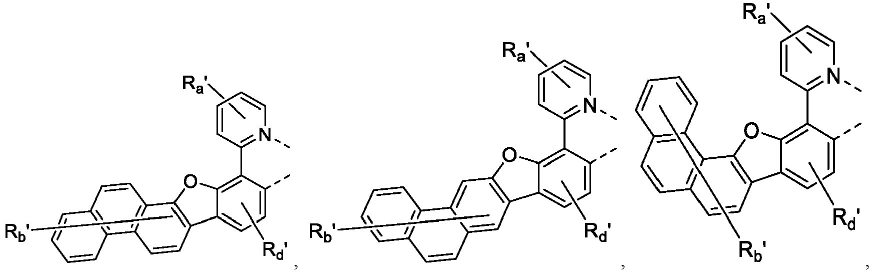 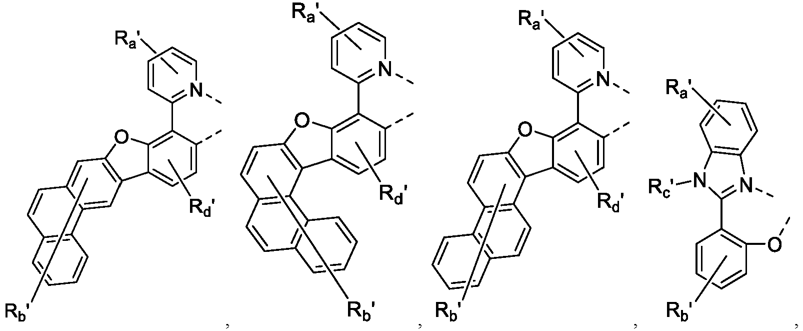 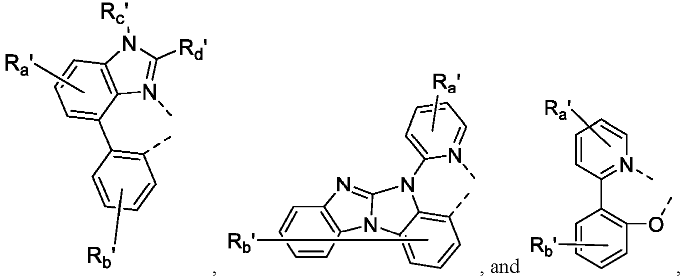 wherein:
Rₐ', R_{b}', R_{c}', R_{d}', and Rₑ' each independently represents zero, mono, or up to a maximum allowed number of substitution to its associated ring;
Rₐ', R_{b}', R_{c}', R_{d}', and Rₑ' each independently hydrogen or a substituent selected from the group consisting of the General Substituents defined herein; and
two substituents of Rₐ', R_{b}', R_{c}', R_{d}', and Rₑ' can be fused or joined to form a ring or form a multidentate ligand.

In some embodiments of the compound that includes ligand L_{B}, L_{B} comprises an electron-withdrawing group from the EWG1 LIST as defined herein. In some embodiments, L_{B} comprises an electron-withdrawing group from the EWG2 LIST as defined herein. In some embodiments, L_{B} comprises an electron-withdrawing group from the EWG3 LIST as defined herein. In some embodiments, L_{B} comprises an electron-withdrawing group from the EWG4 LIST as defined herein. In some embodiments, L_{B} comprises an electron-withdrawing group from the Pi-EWG LIST as defined herein.

In some embodiments of the compound that includes ligand L_{C}, L_{C} comprises an electron-withdrawing group from the EWG1 LIST as defined herein. In some embodiments, L_{C} comprises an electron-withdrawing group from the EWG2 LIST as defined herein. In some embodiments, L_{C} comprises an electron-withdrawing group from the EWG3 LIST as defined herein. In some embodiments, L_{C} comprises an electron-withdrawing group from the EWG4 LIST as defined herein. In some embodiments, L_{C} comprises an electron-withdrawing group from the Pi-EWG LIST as defined herein.

In some embodiments, L_{A} can be selected from L_{A*i*-*m*}, wherein *i* is an integer from 1 to 3136; *m* is an integer from 1 to 154; and L_{B} can be selected from L_{B*k*}, wherein *k* is an integer from 1 to 474, wherein:
when the compound has formula Ir(L_{A*i-m*})₃, the compound is selected from the group consisting of Ir(L*_{A1-1}*)₃ to Ir(L_{A3136-154})₃;
when the compound has formula Ir(L_{A*i-m*})(L_{B*k*})₂, the compound is selected from the group consisting of Ir(L*_{A1-1}*)(L_{B*1*})₂ to Ir(L_{A3136-*154*})(L_{B*474*})₂;
when the compound has formula Ir(L_{A*i-m*})₂(L_{B*k*}), the compound is selected from the group consisting of Ir(L_{A*1-1*})₂(L_{B*1*}) to Ir(L_{A3136*-154*})₂(L_{B*474*});
when the compound has formula Ir(L_{A*i-m*})₂(L_{C*j*-I}), the compound is selected from the group consisting of Ir(L_{A*1-1*})₂(L_{C*1*-I}) to Ir(L_{A3136-*154*})₂(L_{C*1416*-I}); and
when the compound has formula Ir(L_{A*i-m*})₂(L_{C*j*-II}), the compound is selected from the group consisting of Ir(L_{A*1-1*})₂(L_{C*1*-II}) to Ir(L_{A3136-*154*})₂(L_{C*1416*-II});
wherein each L_{B*k*} has the structure defined in the following LIST 8: 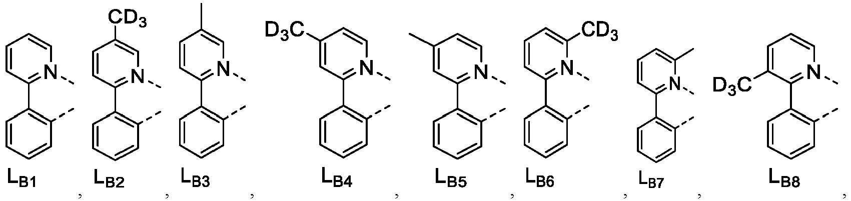 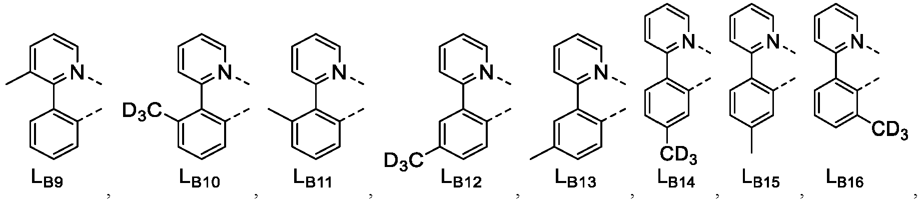 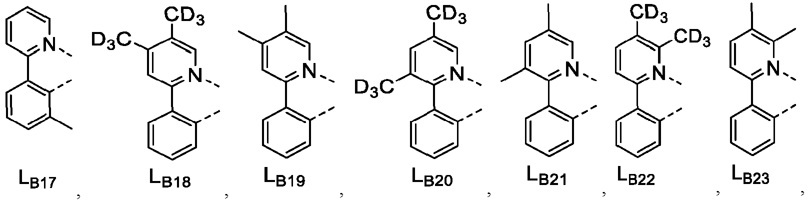 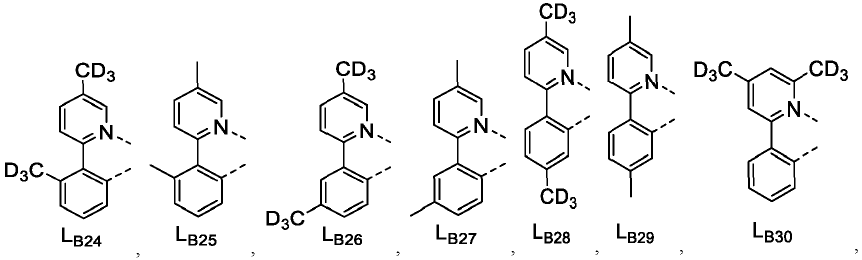 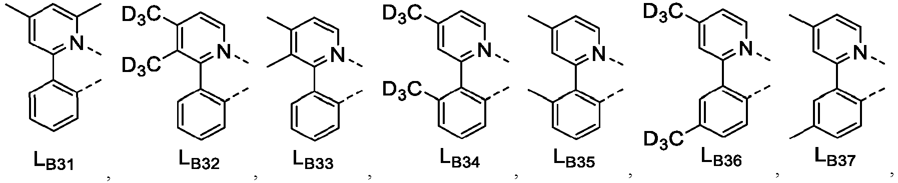 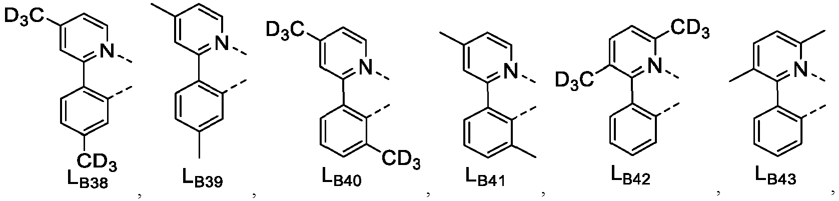 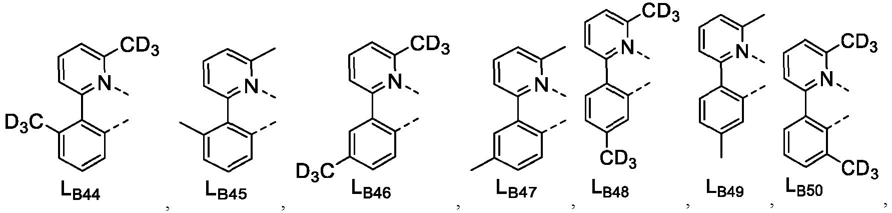 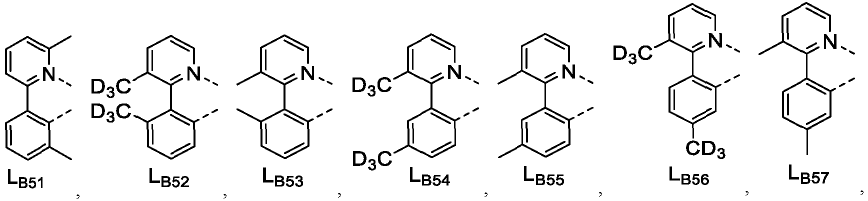 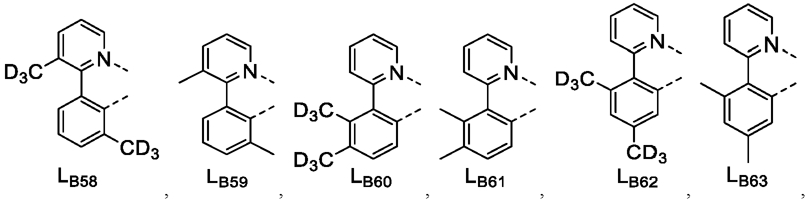 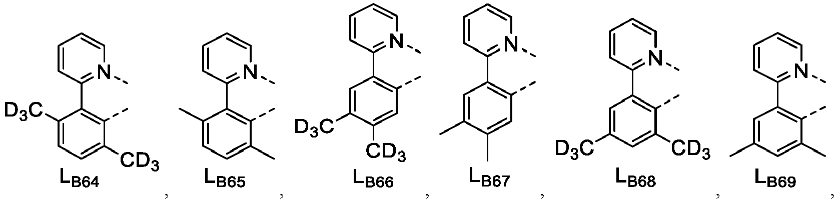 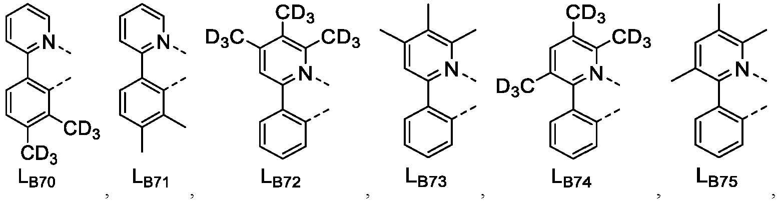 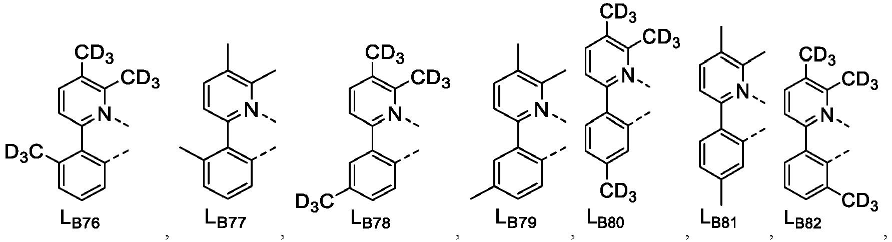 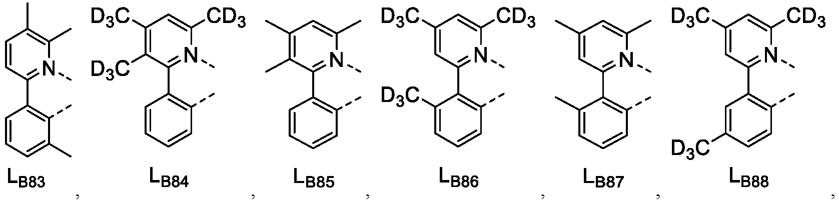 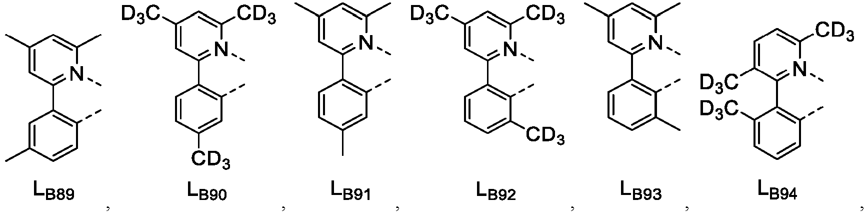 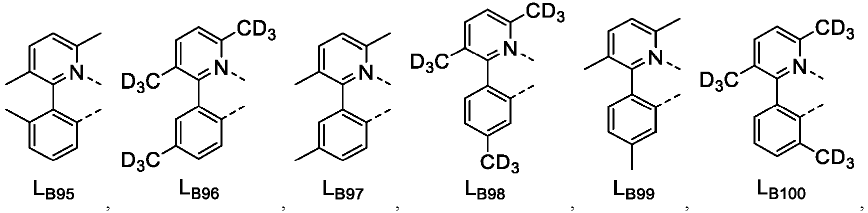 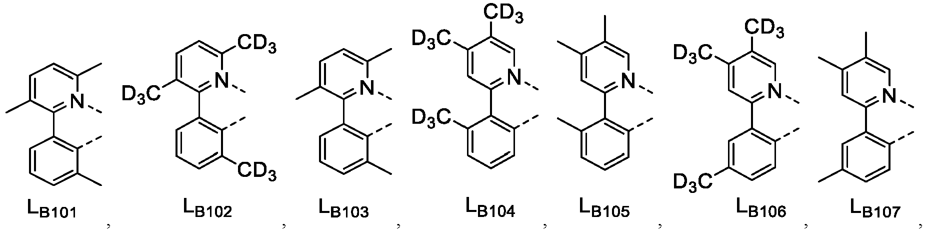 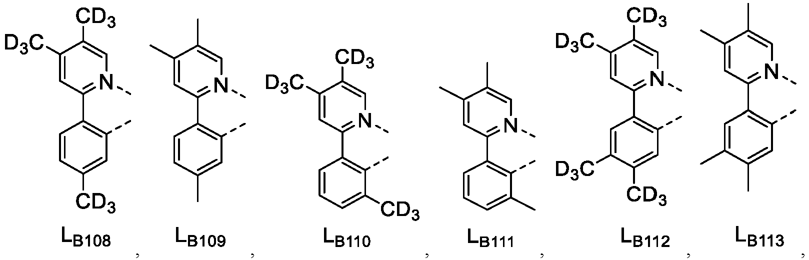 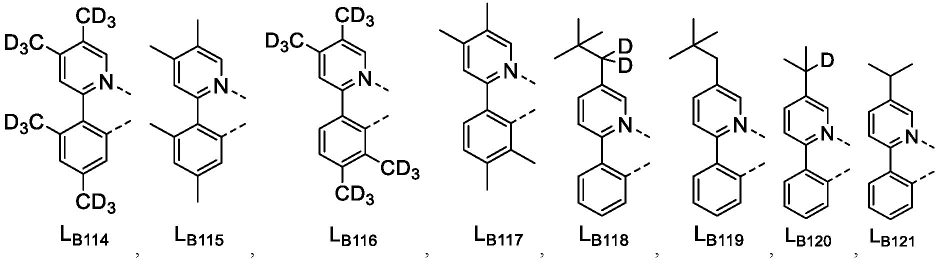 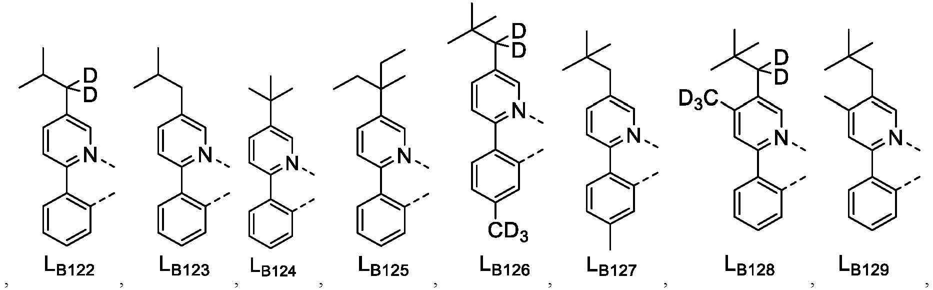 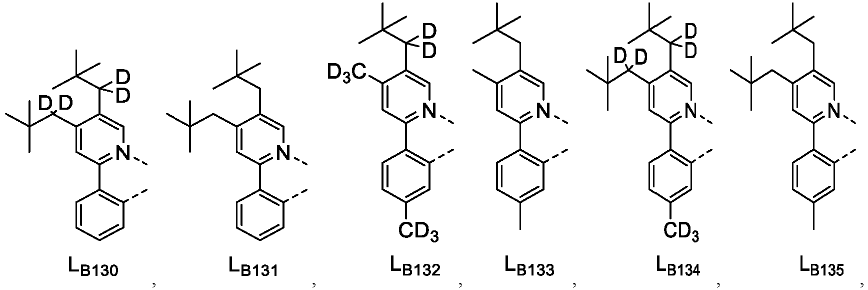 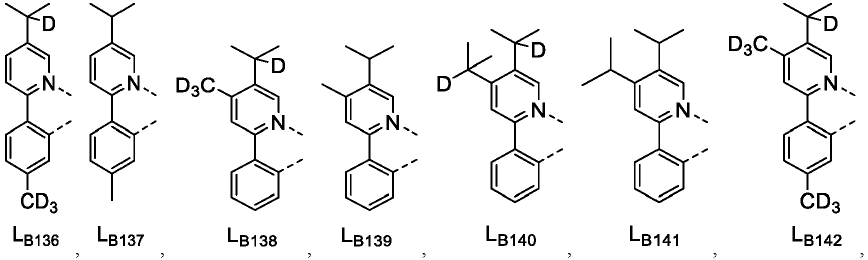 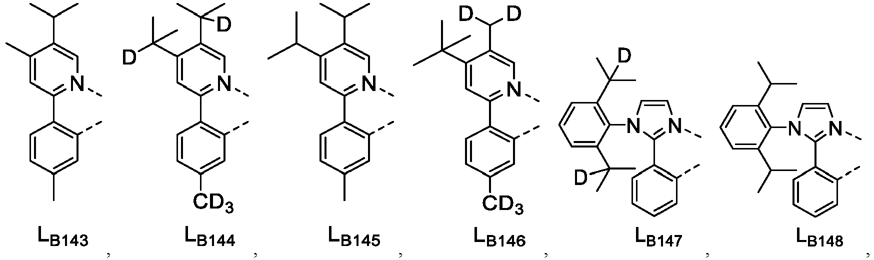 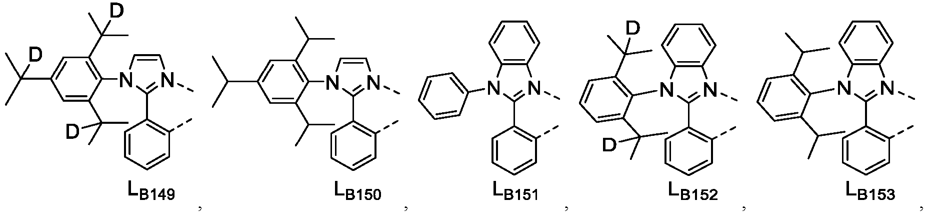 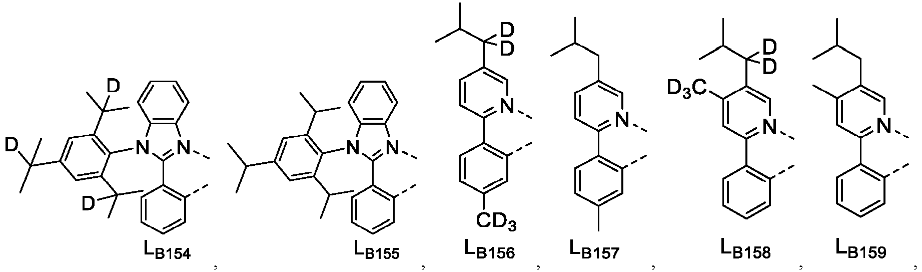 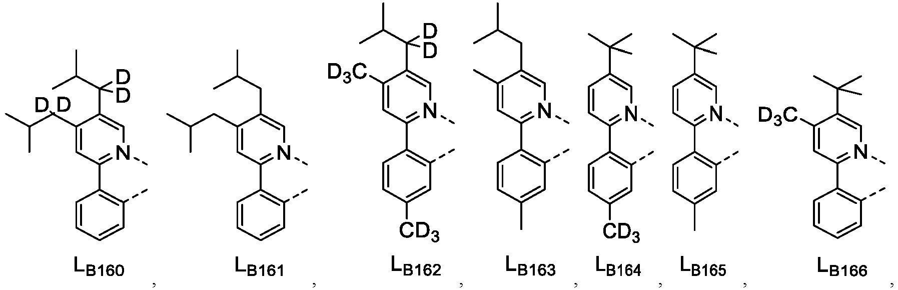 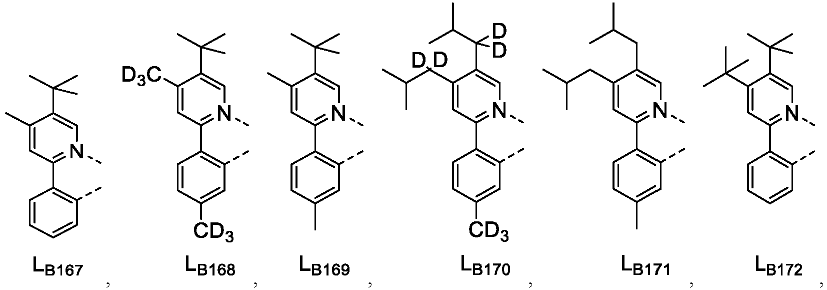 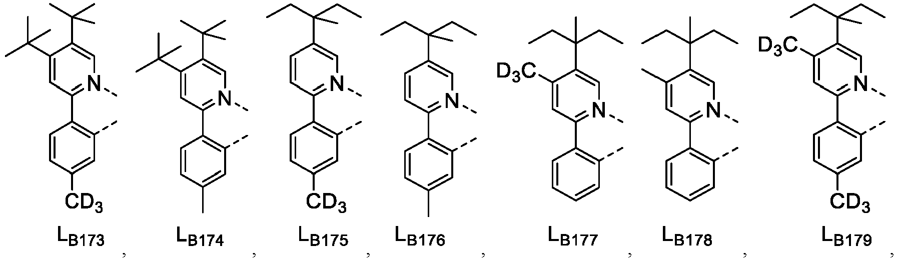 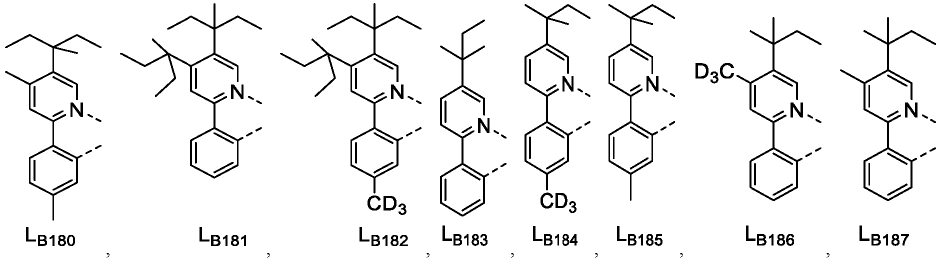 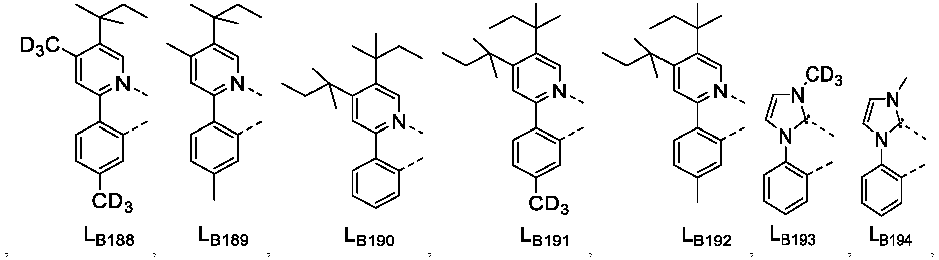 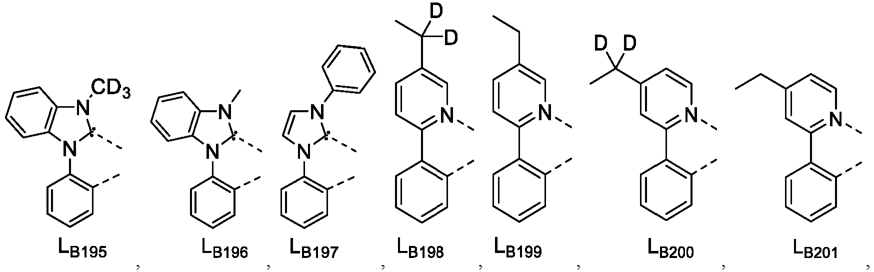 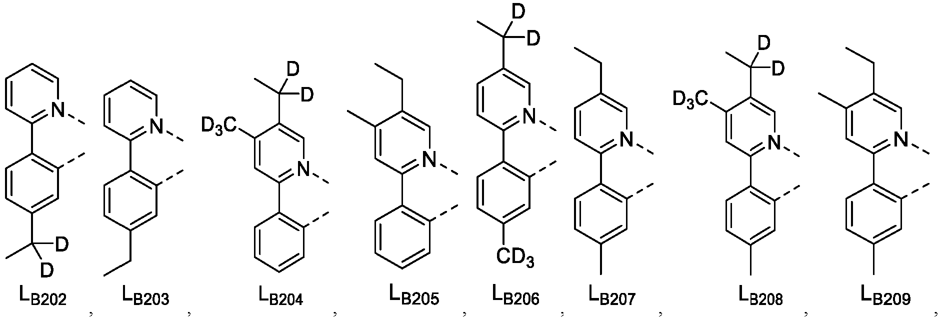 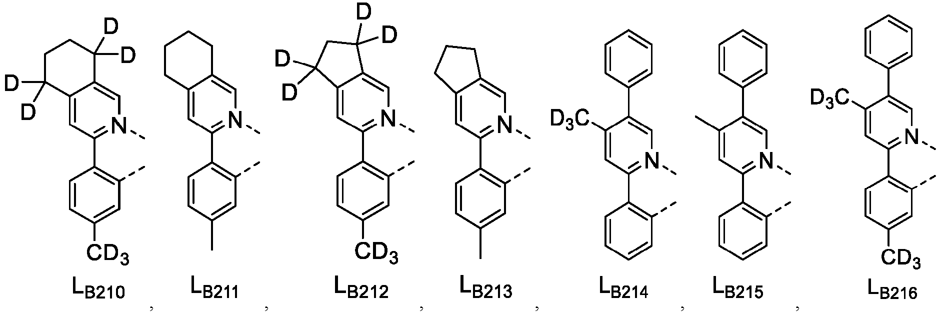 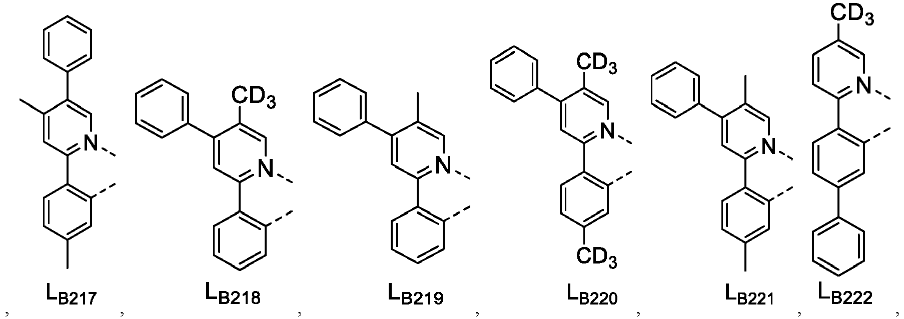 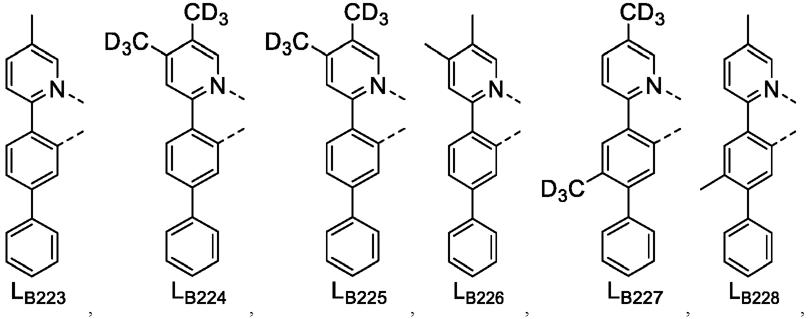 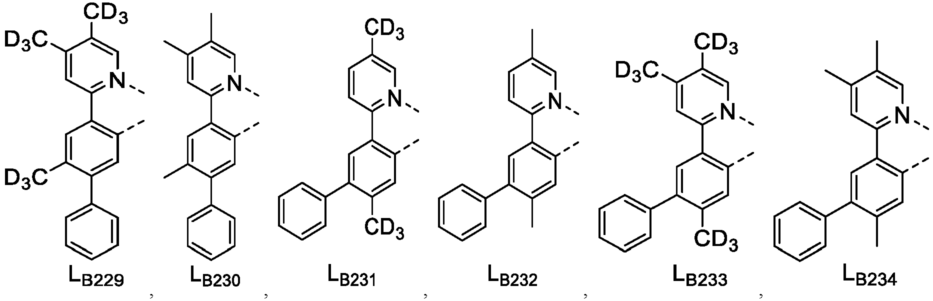 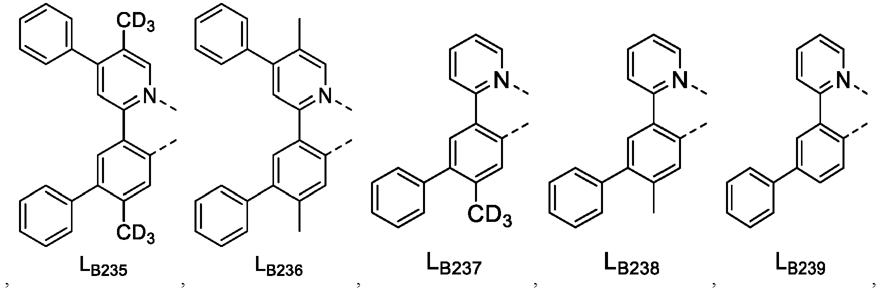 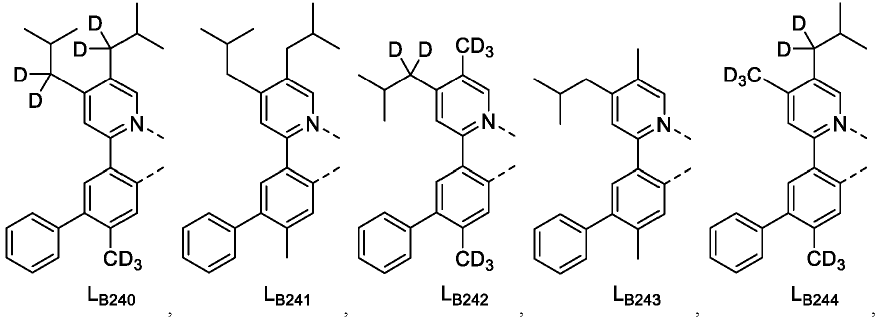 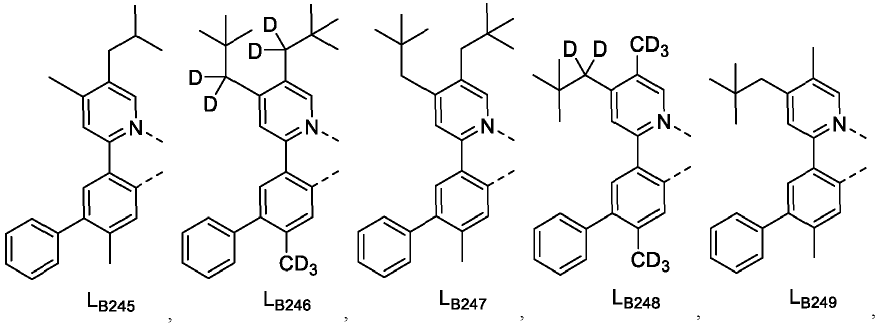 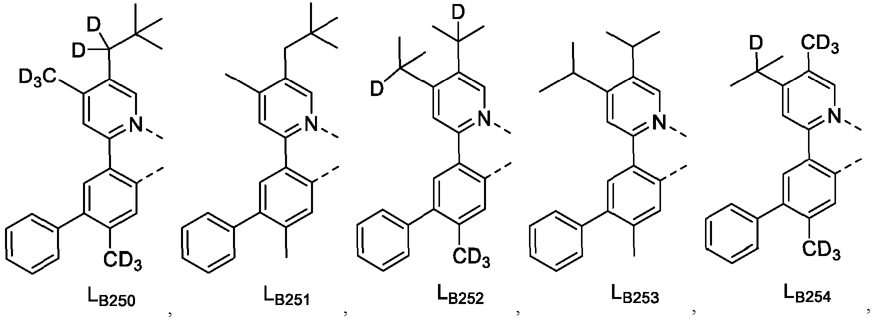 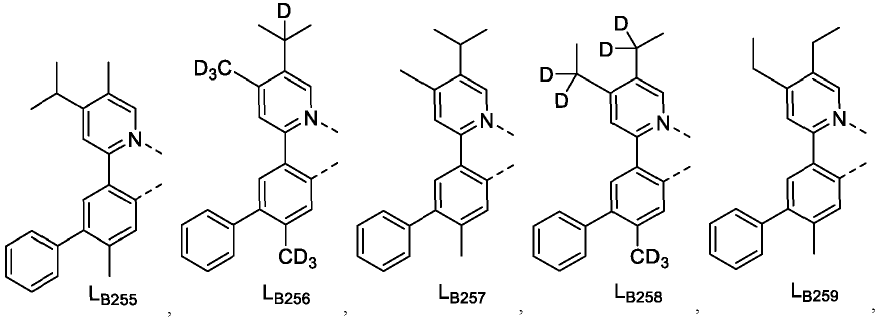 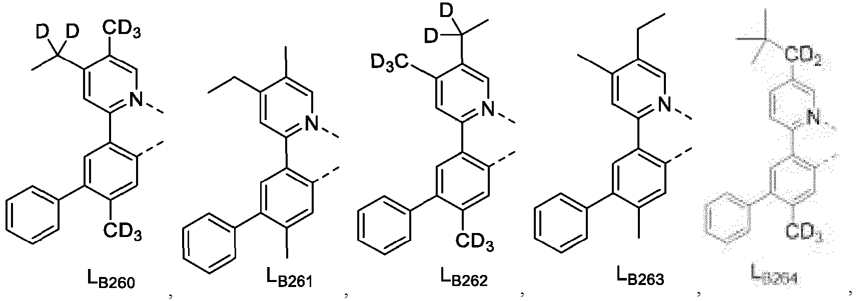 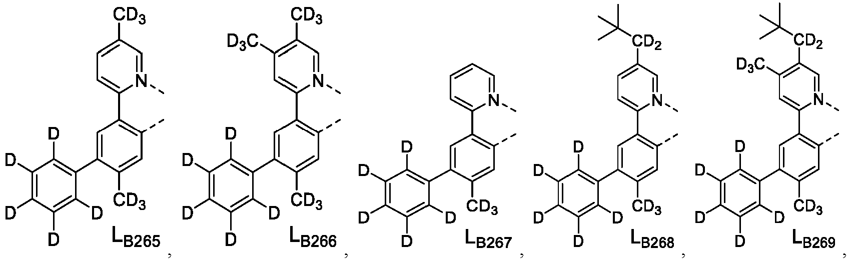 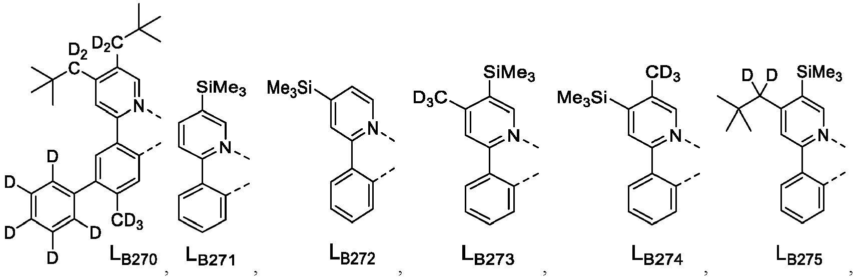 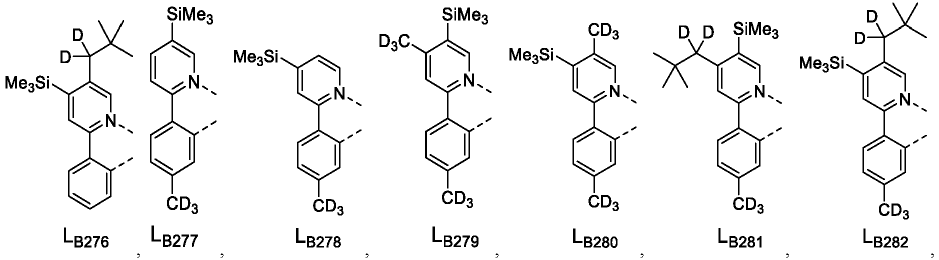 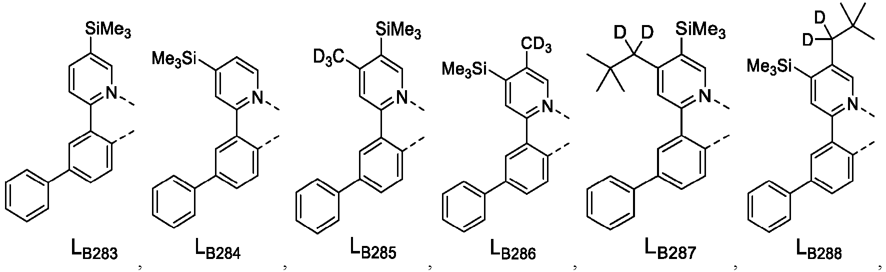 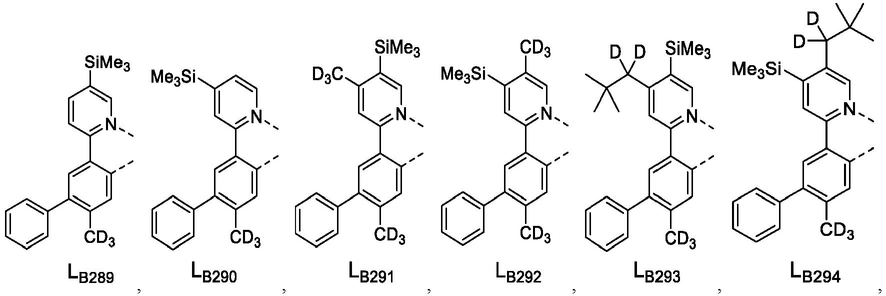 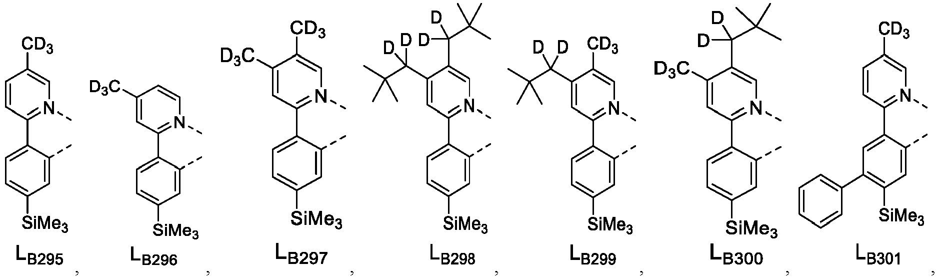 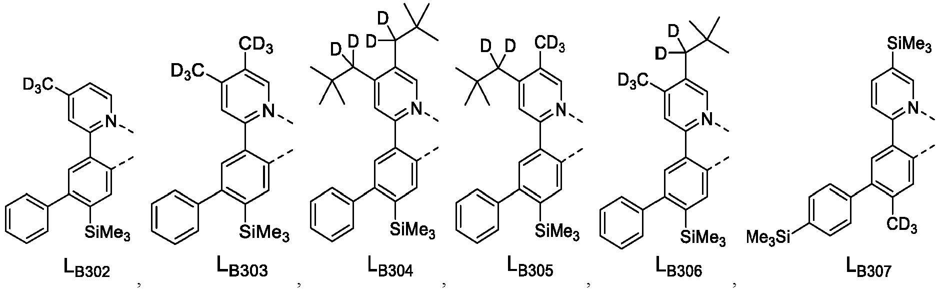 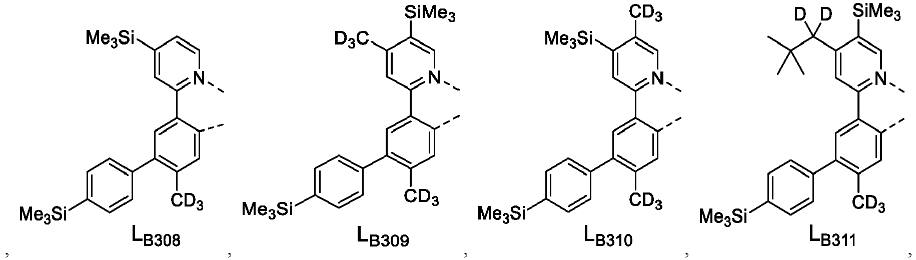 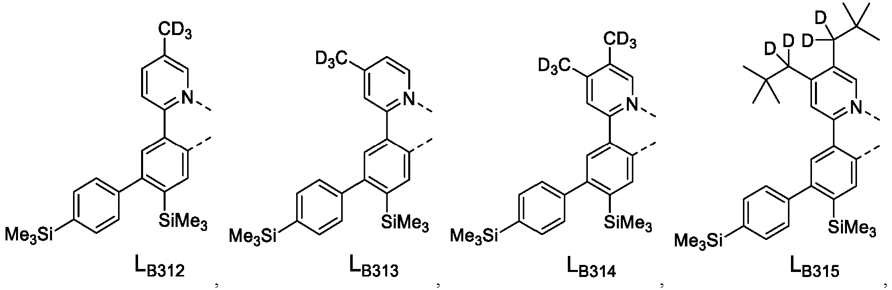 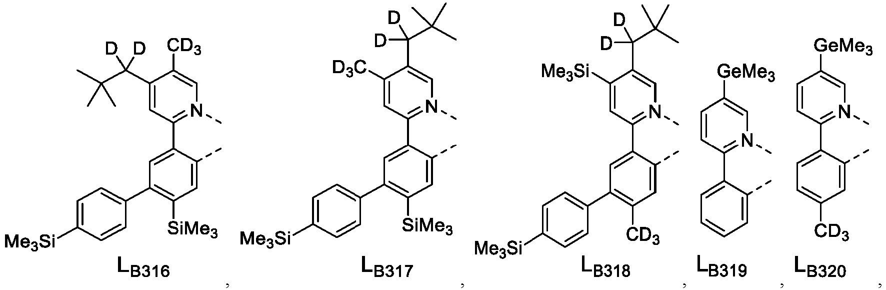 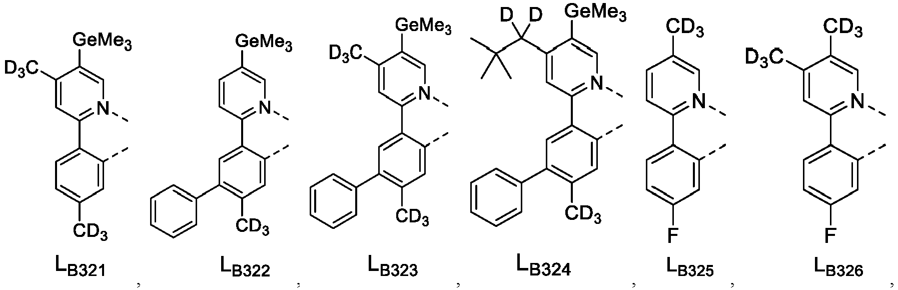 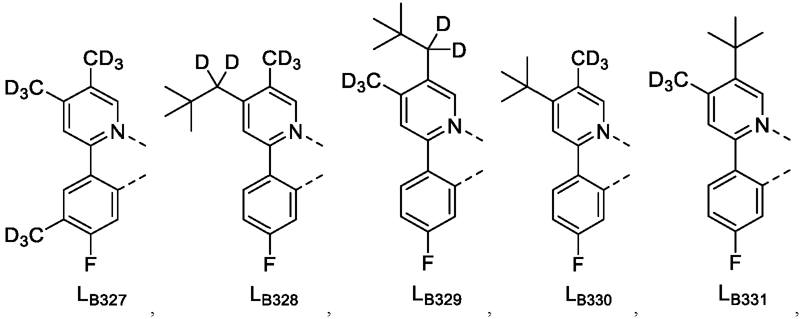 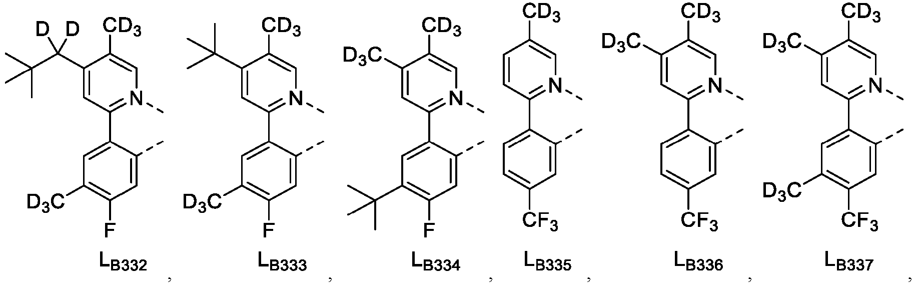 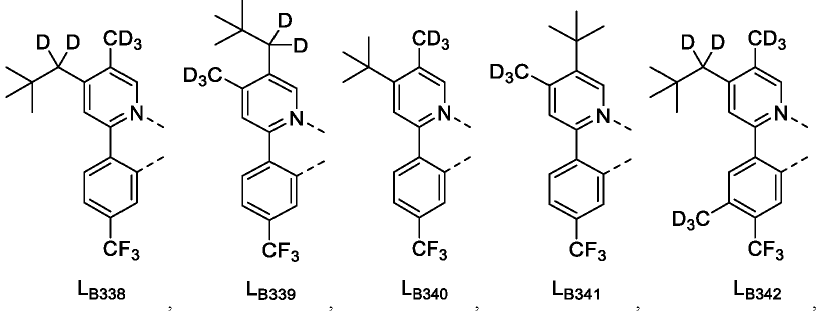 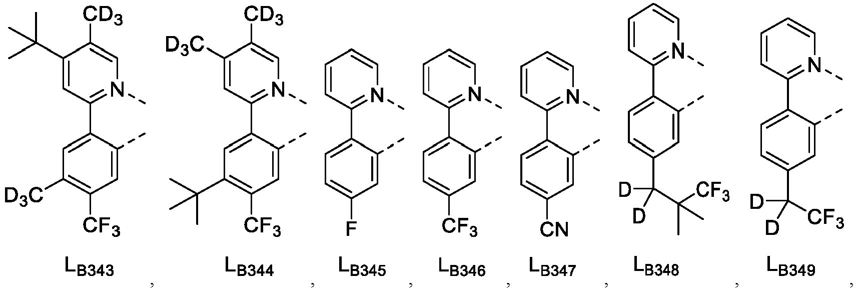 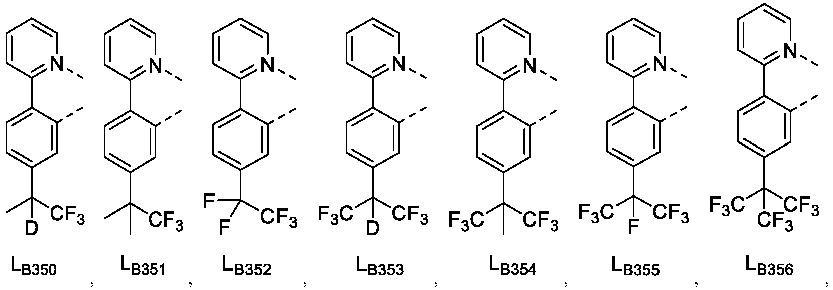 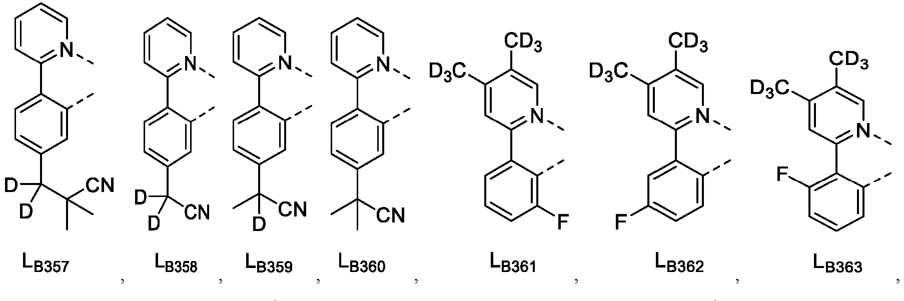 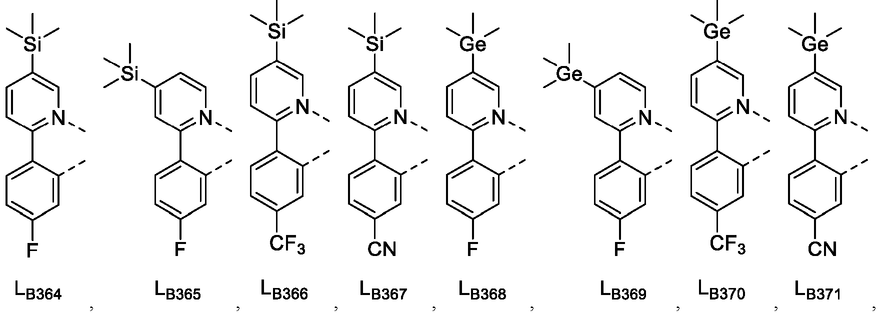 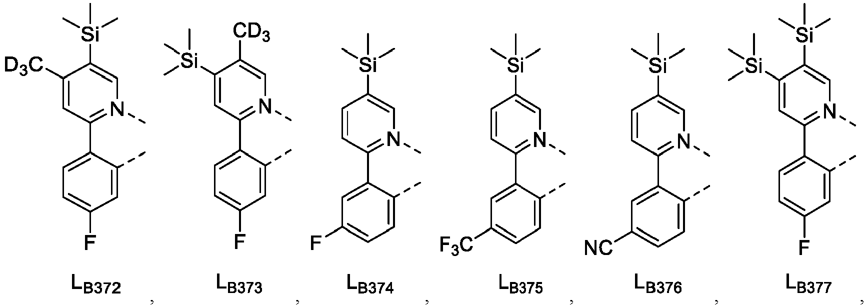 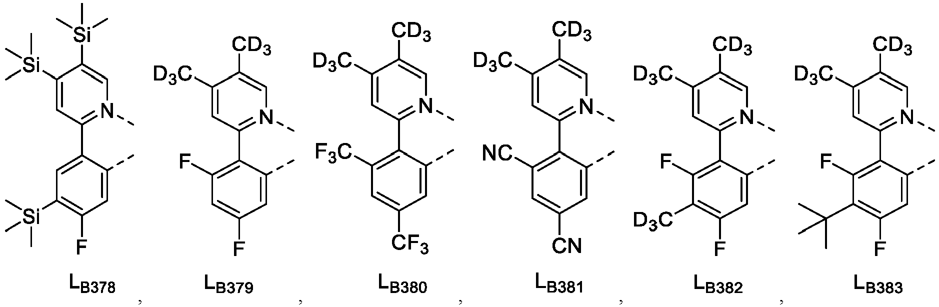 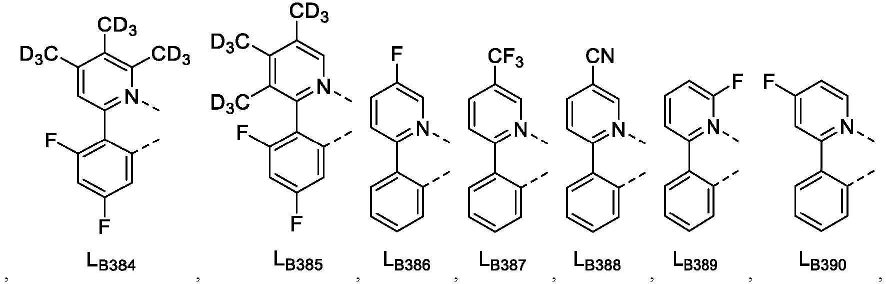 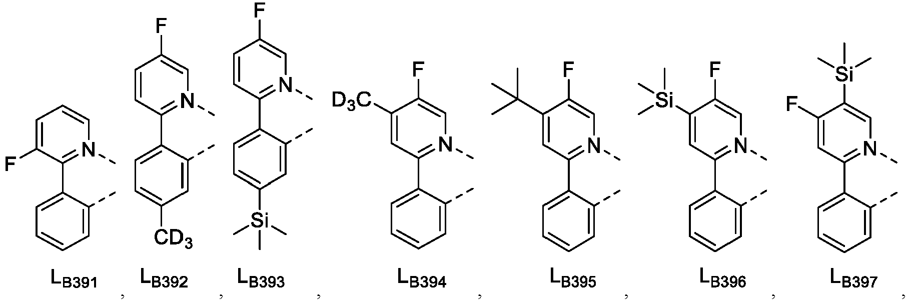 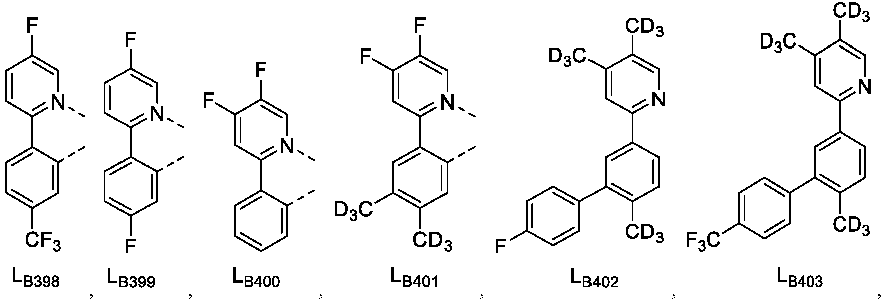 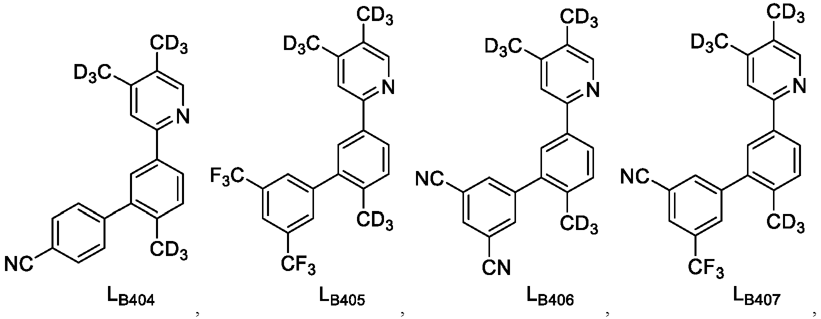 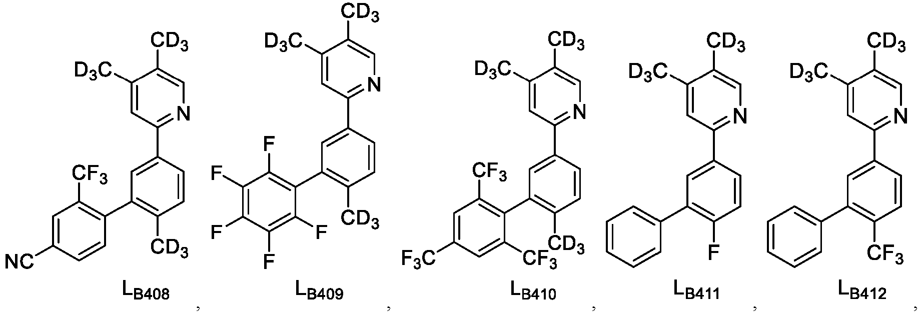 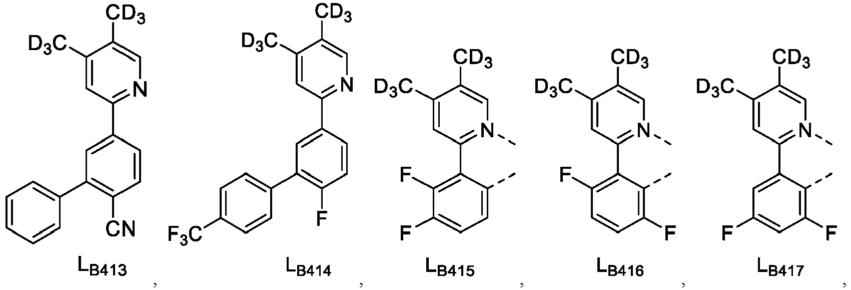 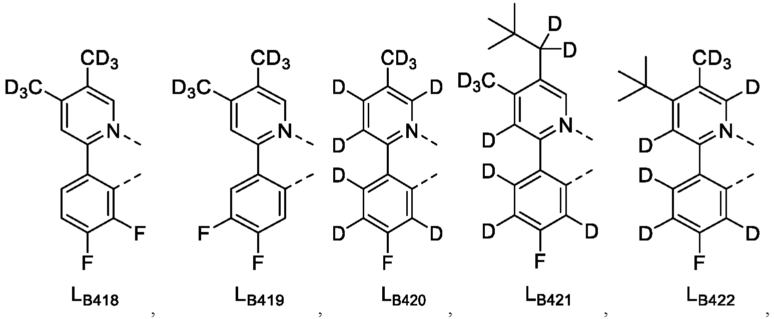 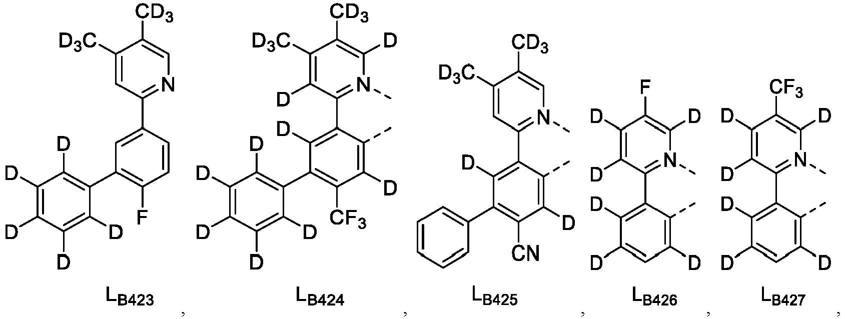 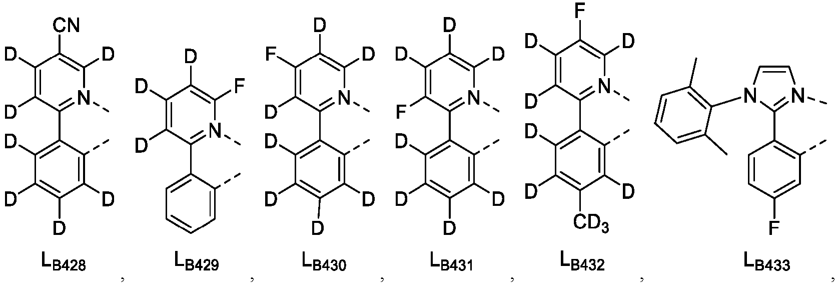 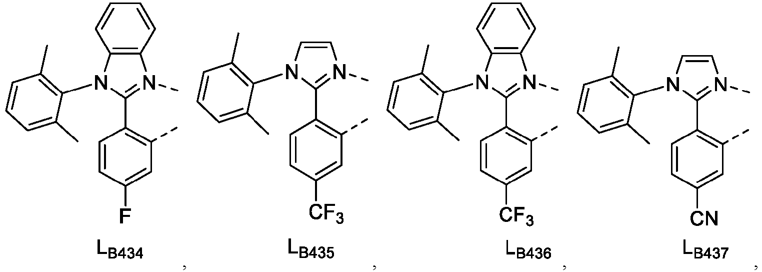 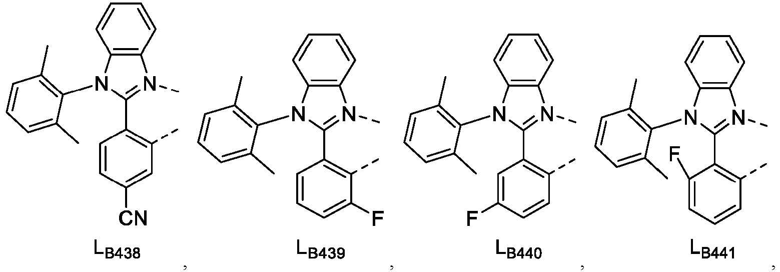 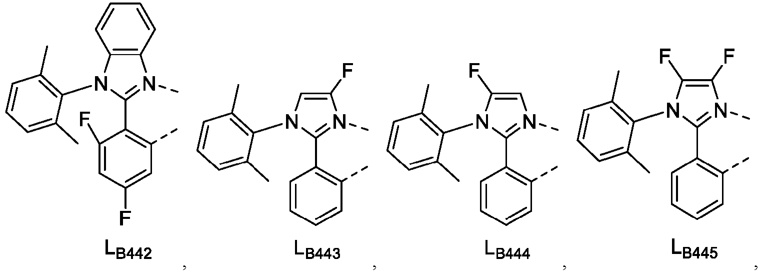 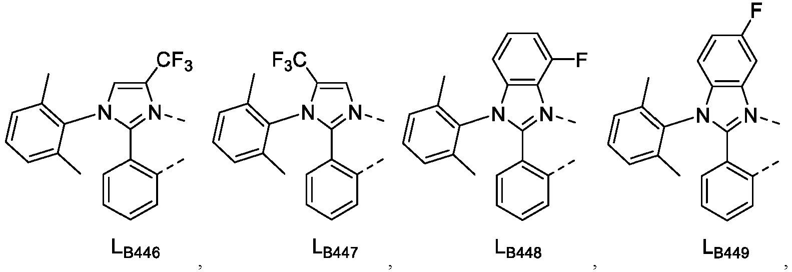 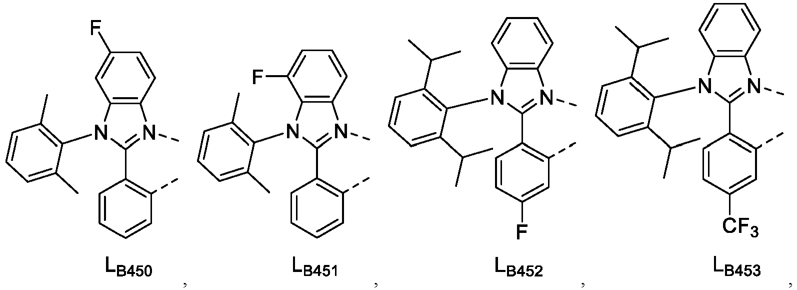 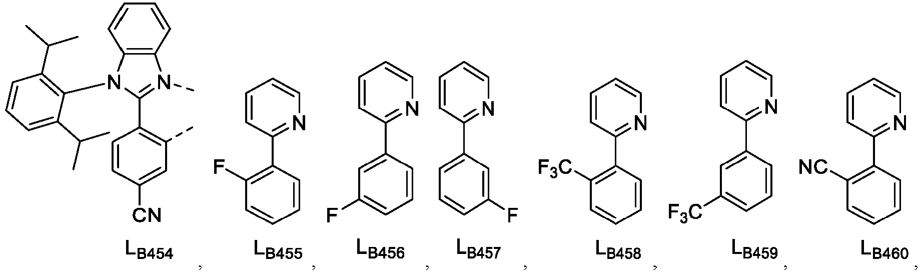 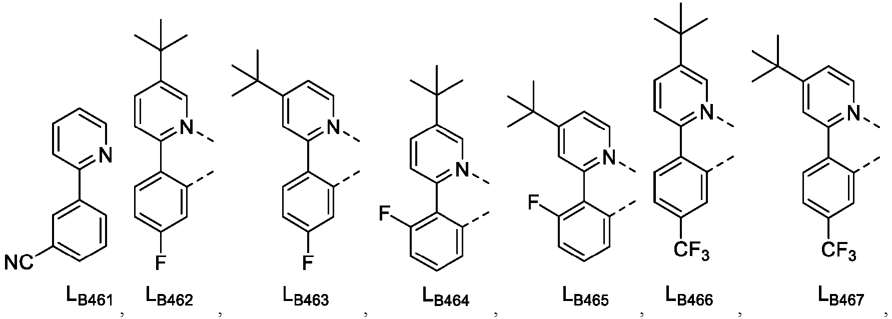 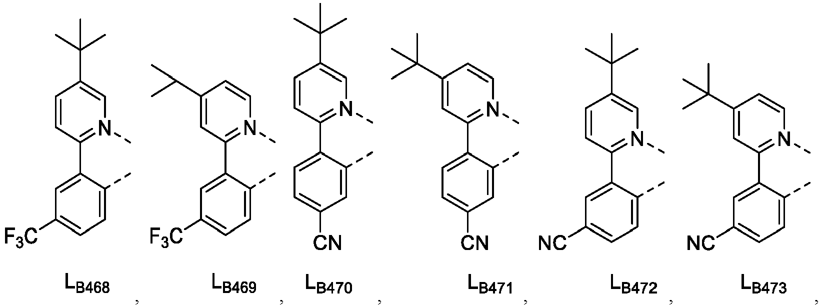 and 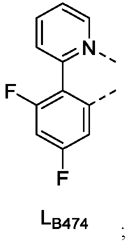
wherein each L_{C*j*-I} has a structure based on formula 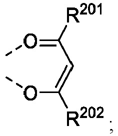 and
each L_{C*j*-II} has a structure based on formula 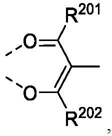 wherein for each L_{C*j*} in L_{C*j*-I} and L_{C*j*-II}, R²⁰¹ and R²⁰² are each independently defined in the following LIST 9: 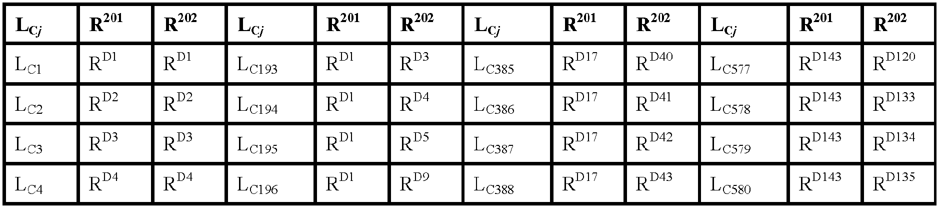 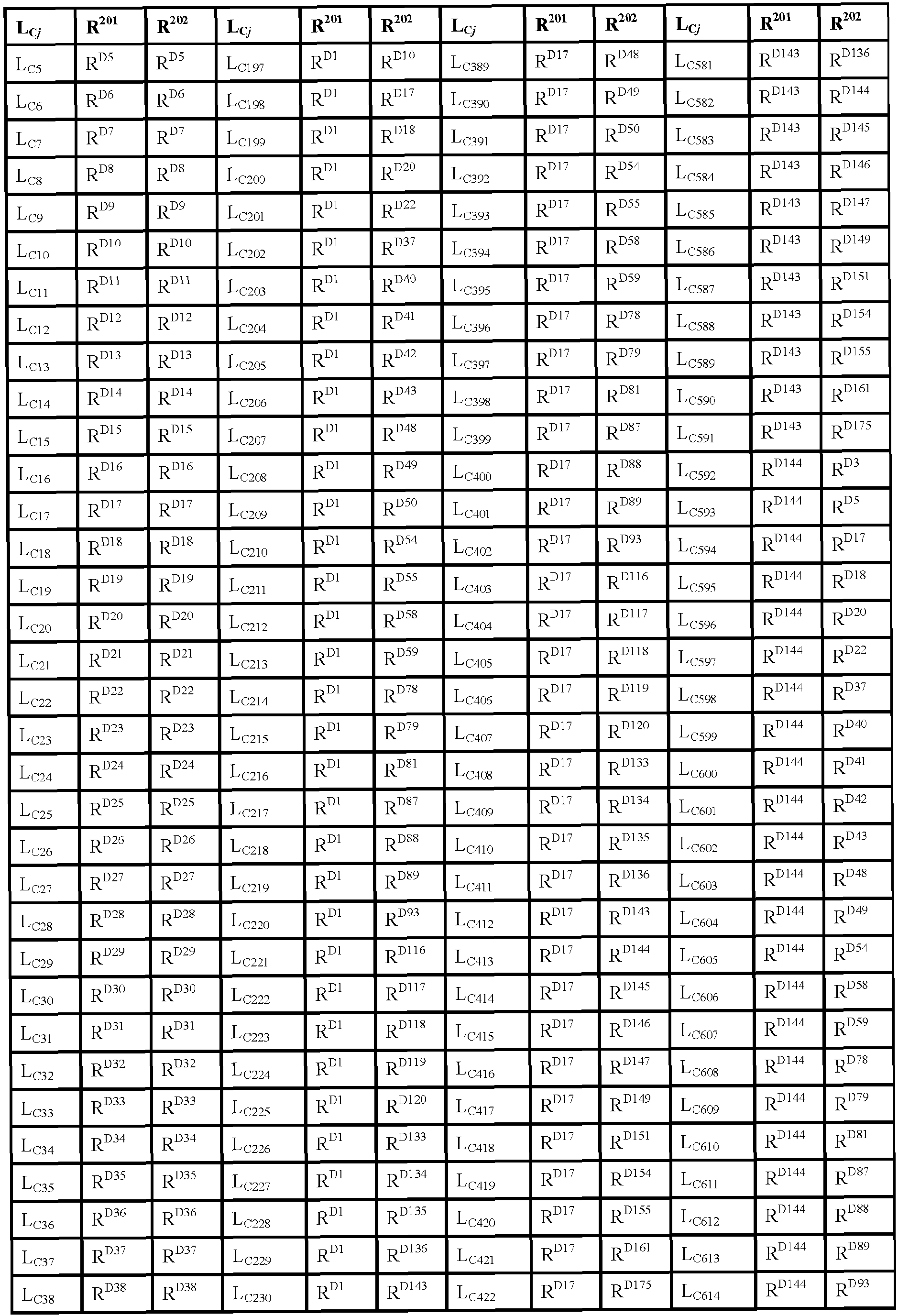 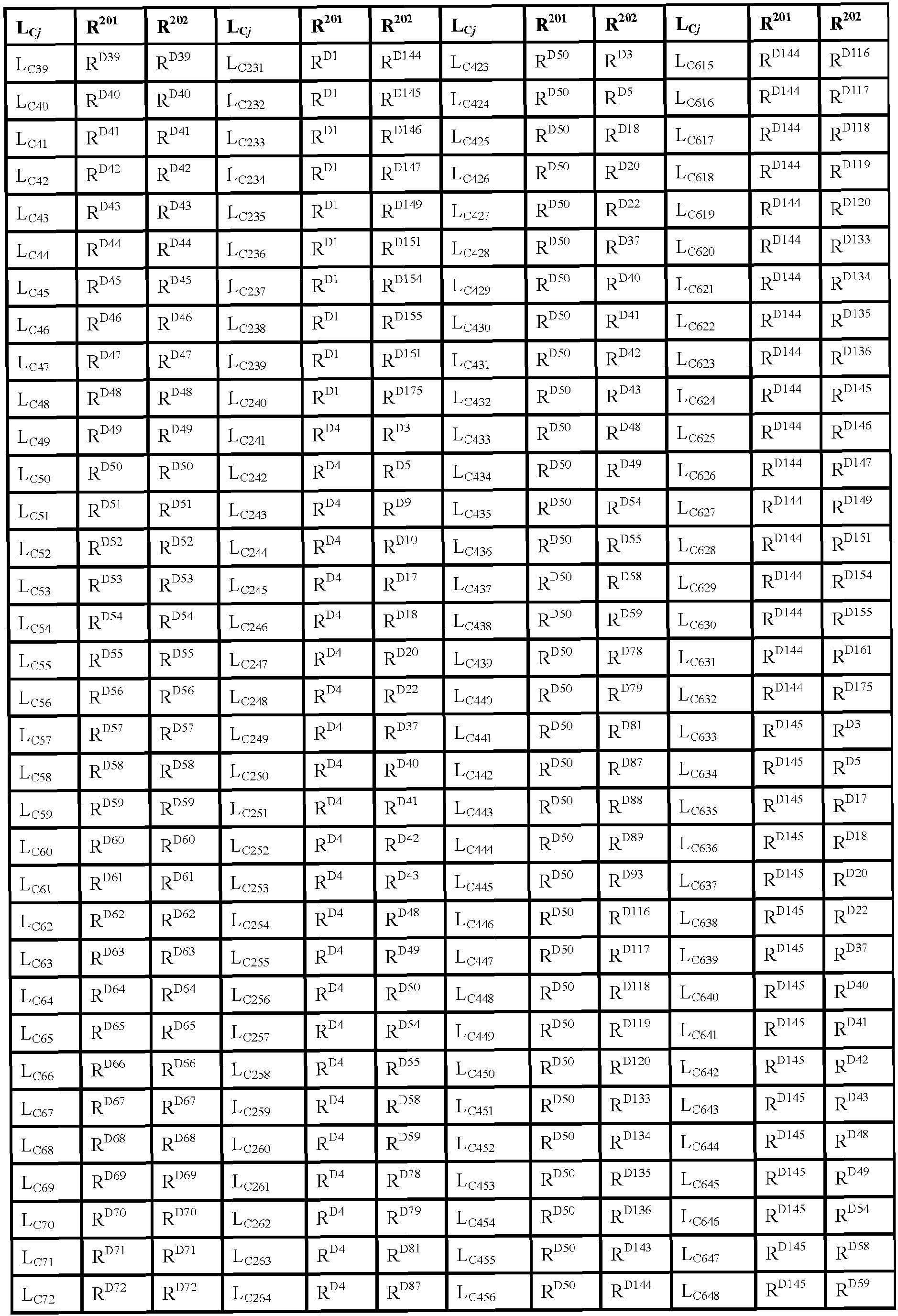 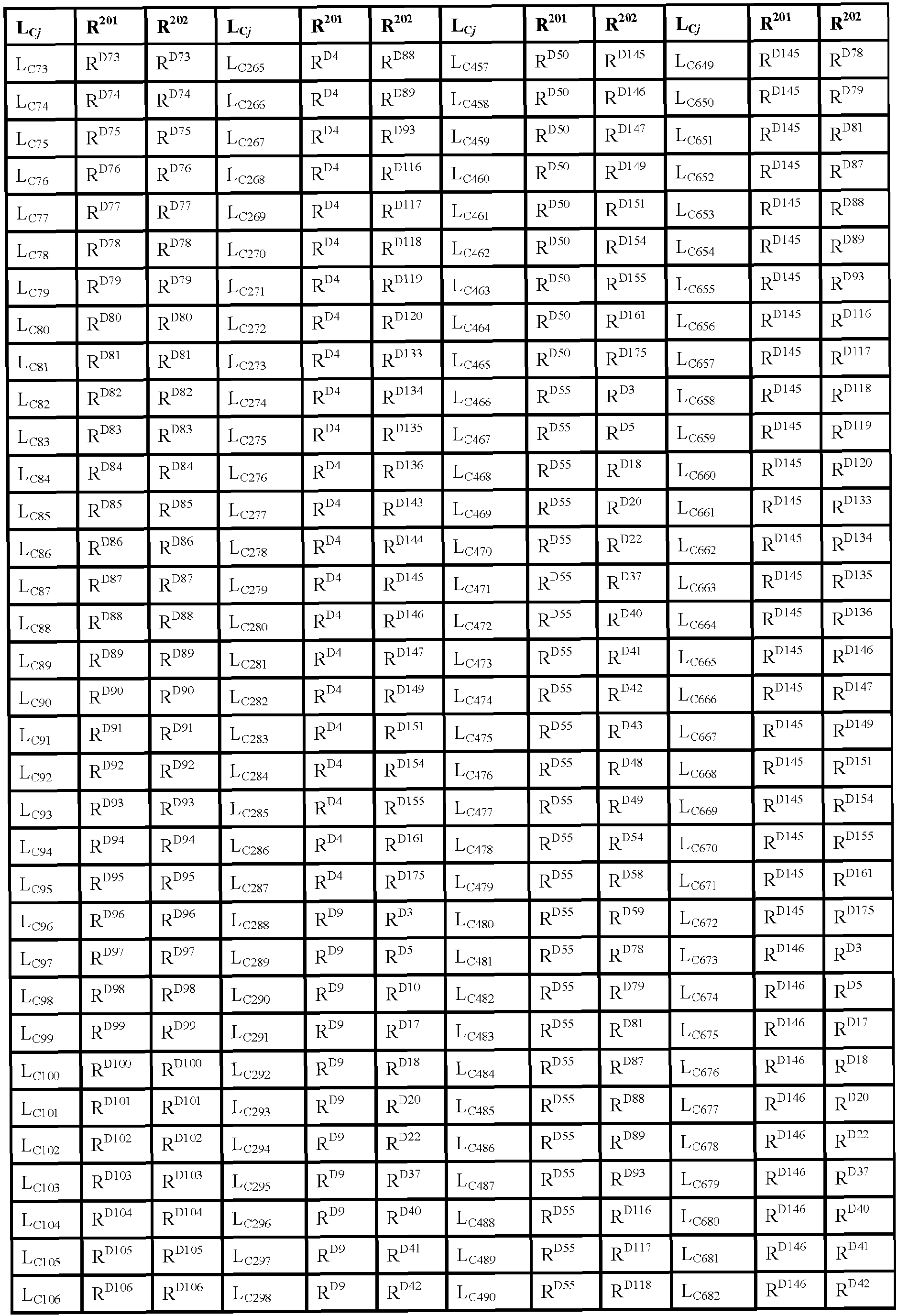 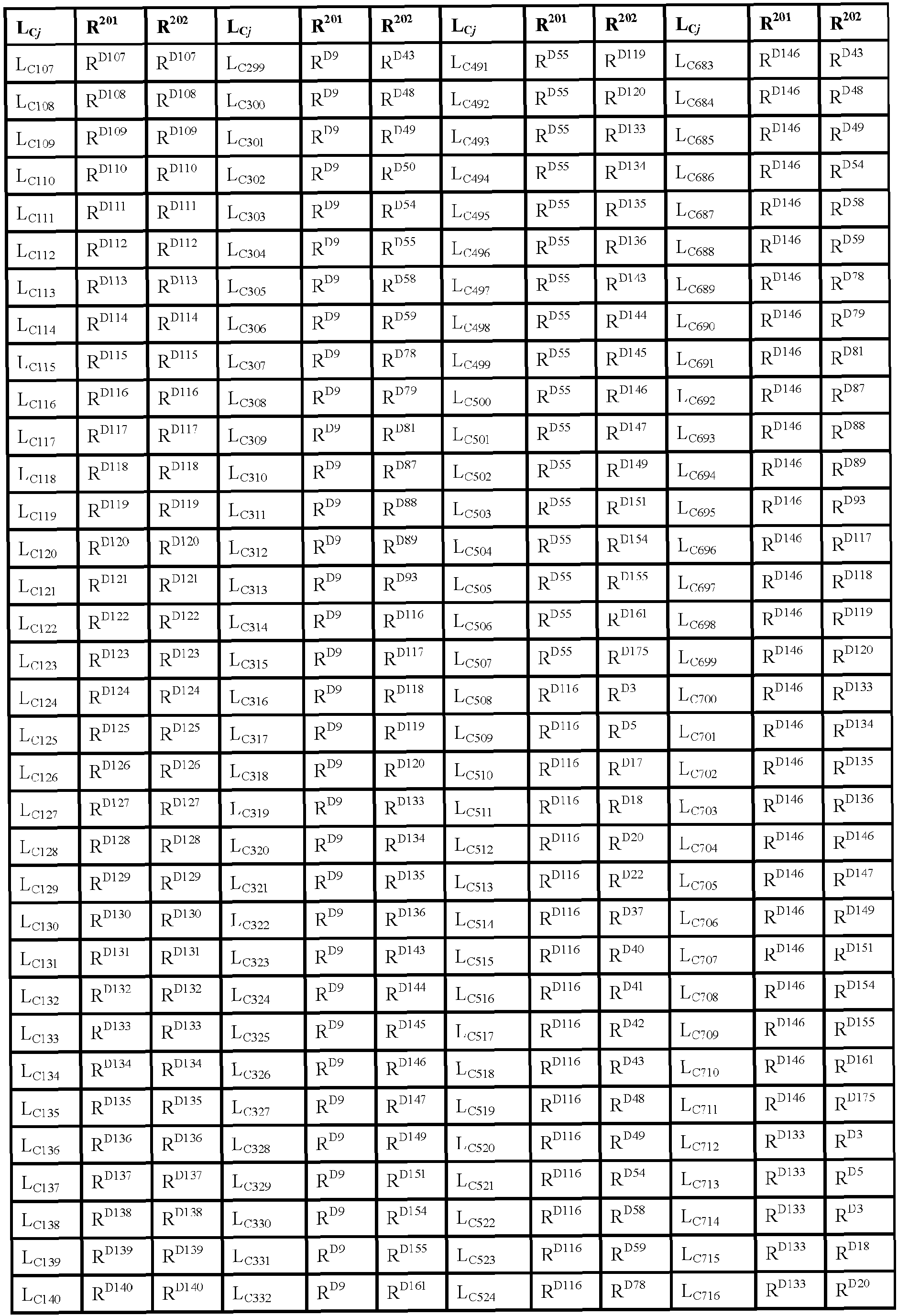 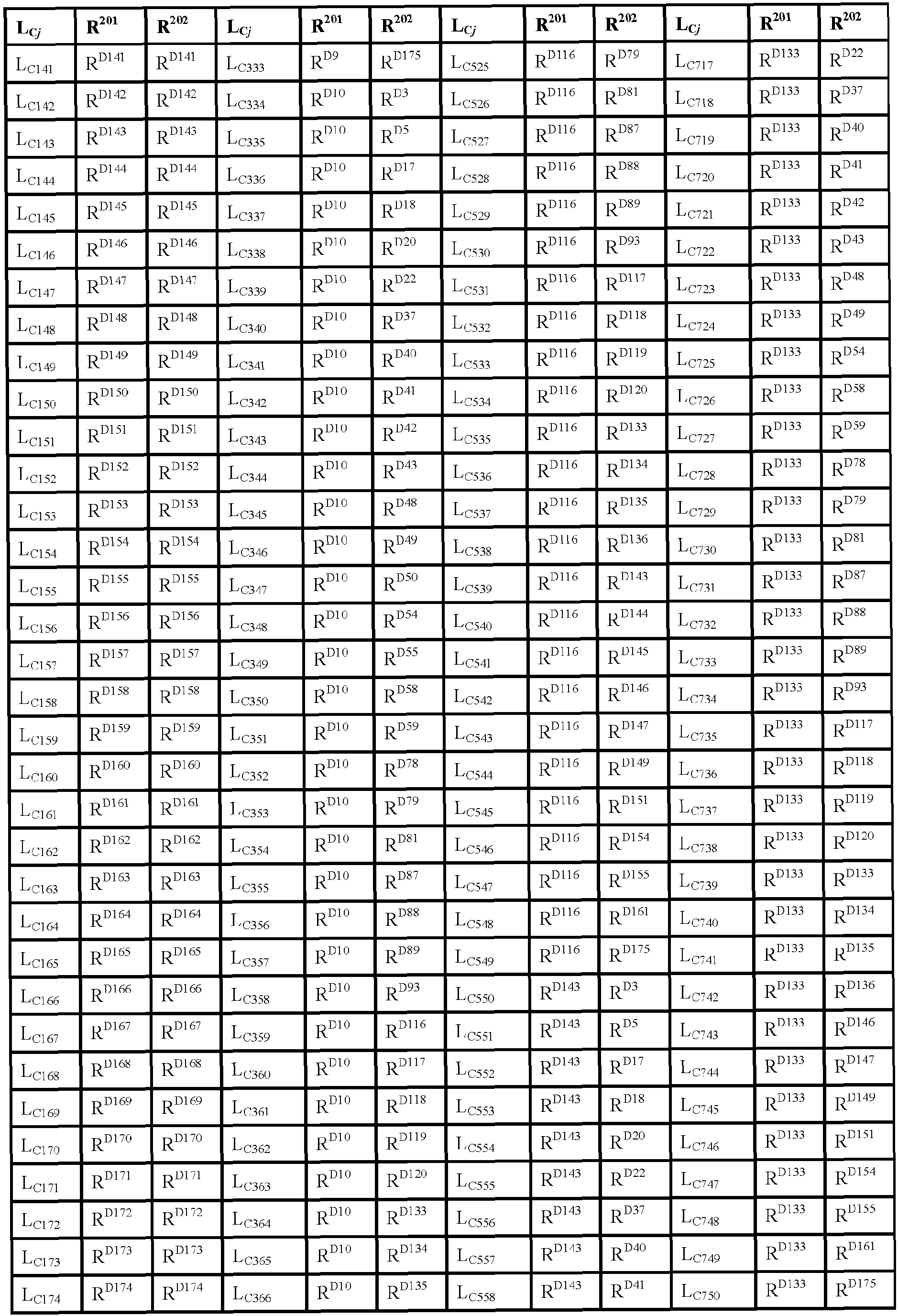 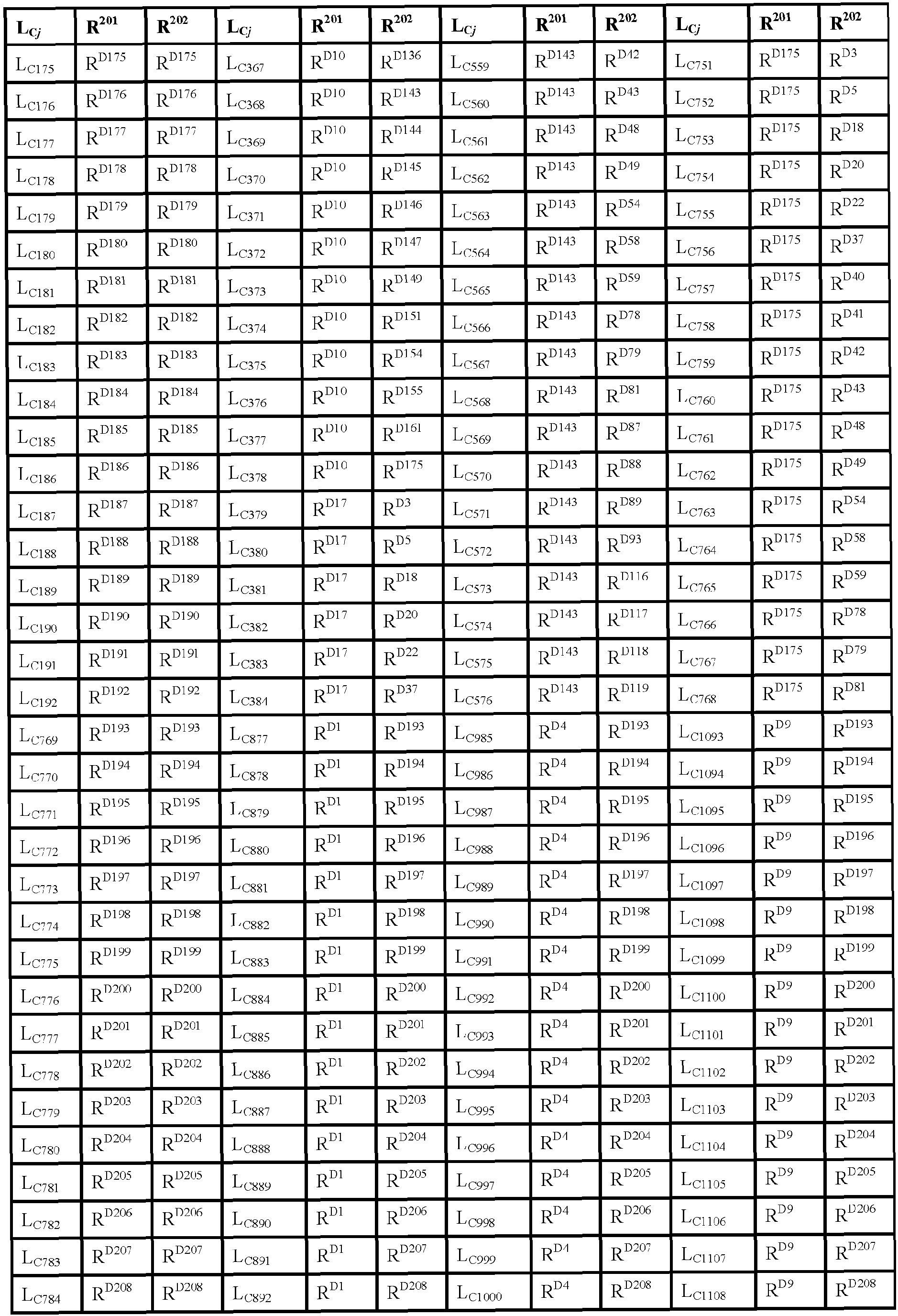 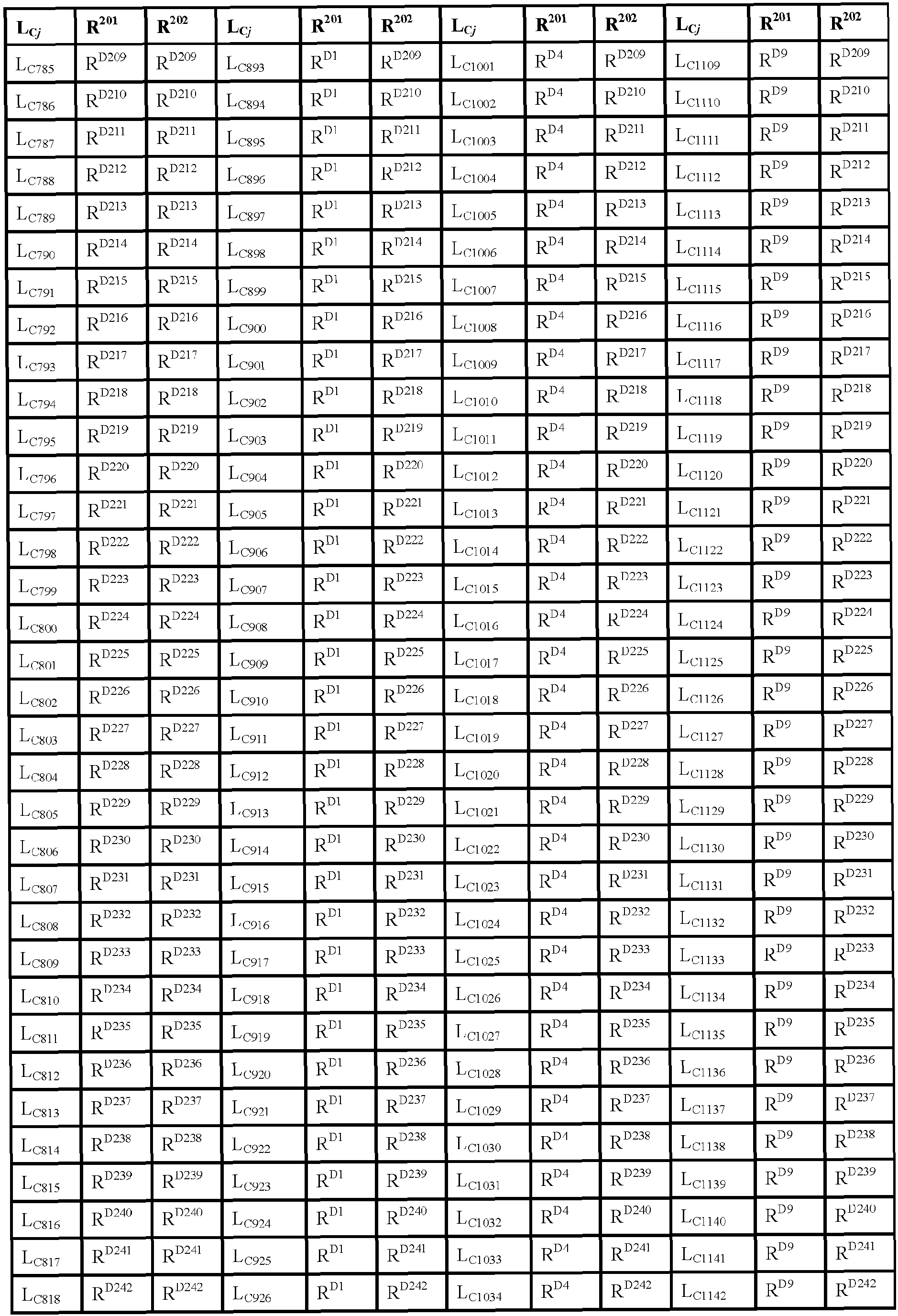 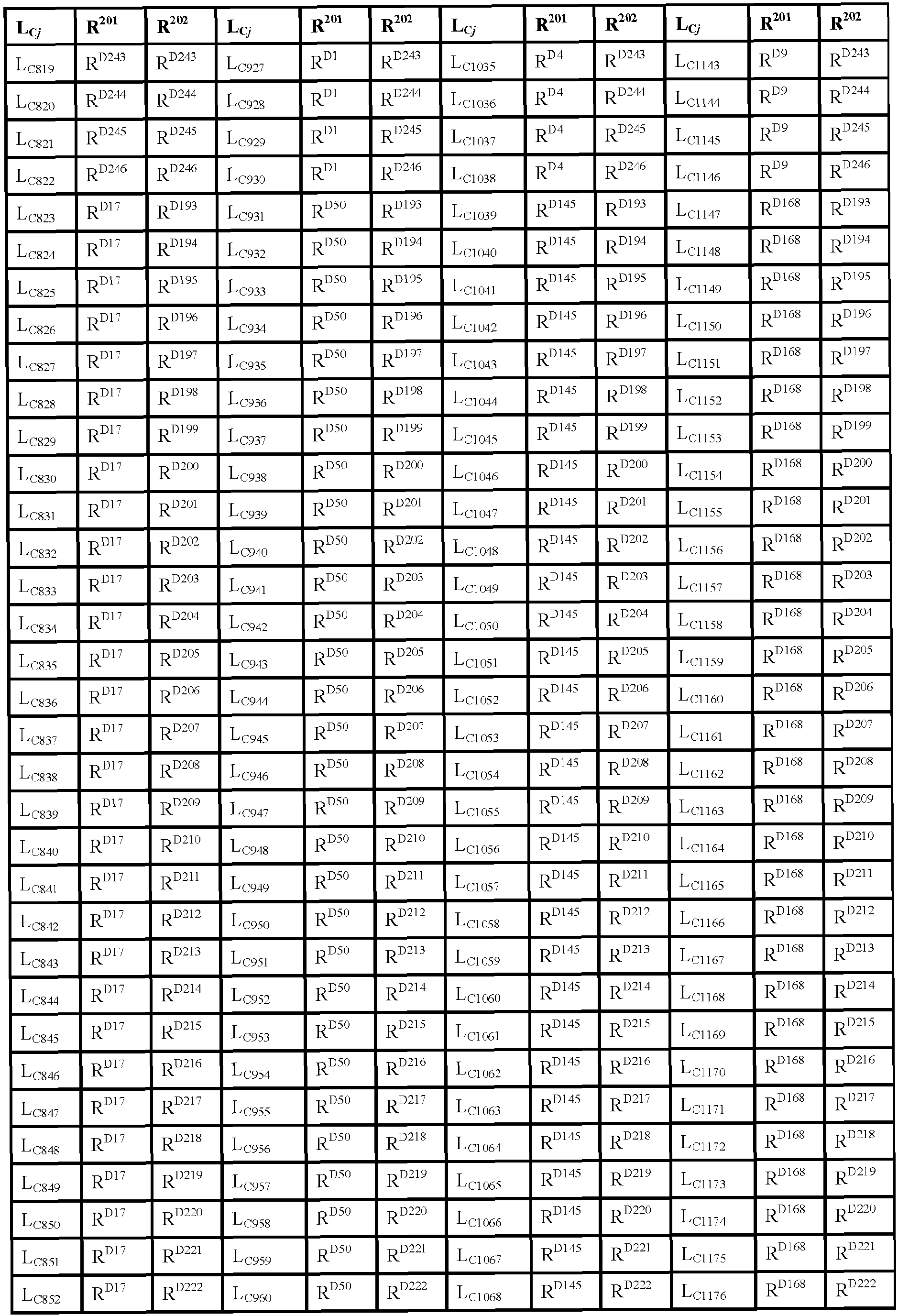 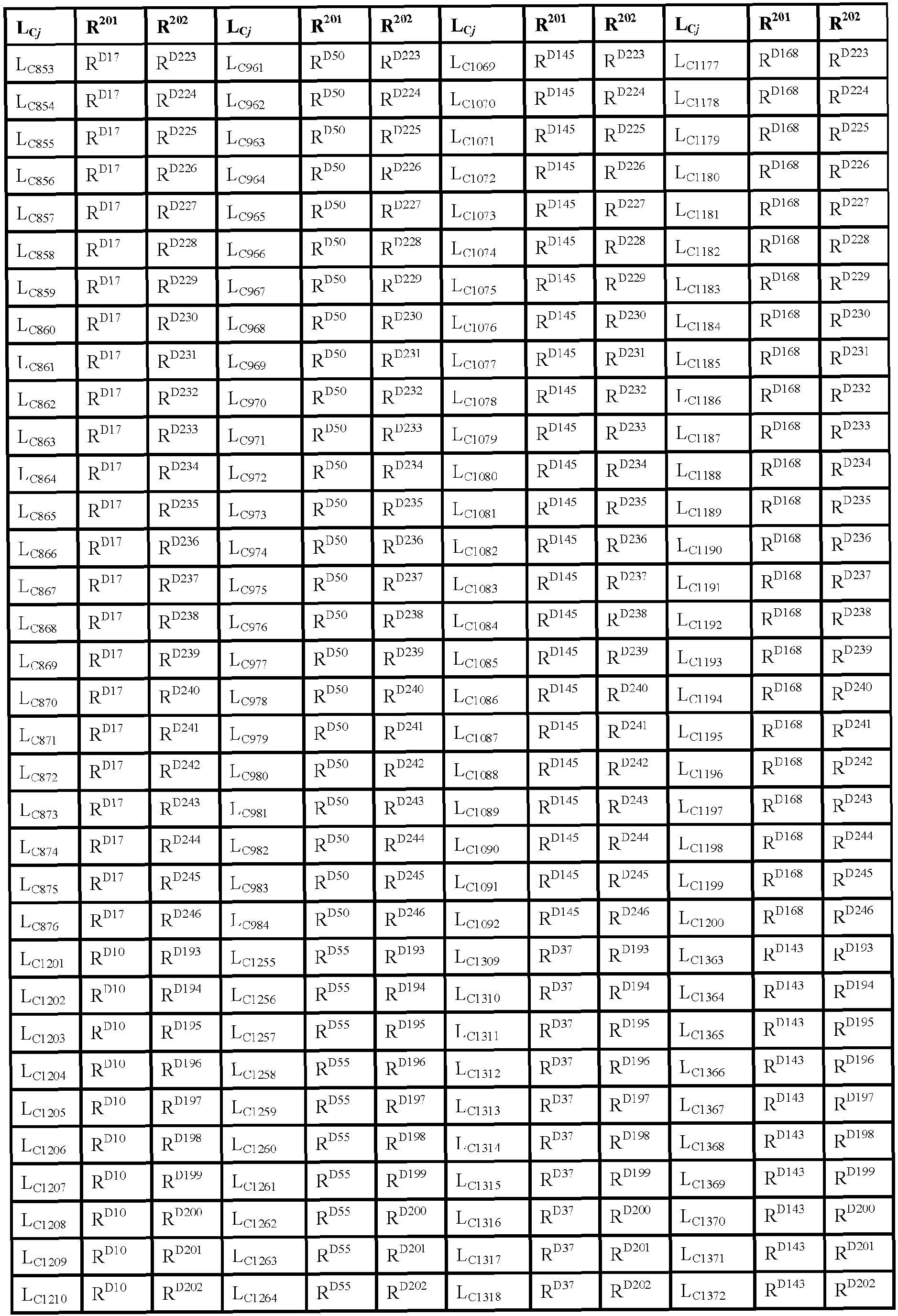 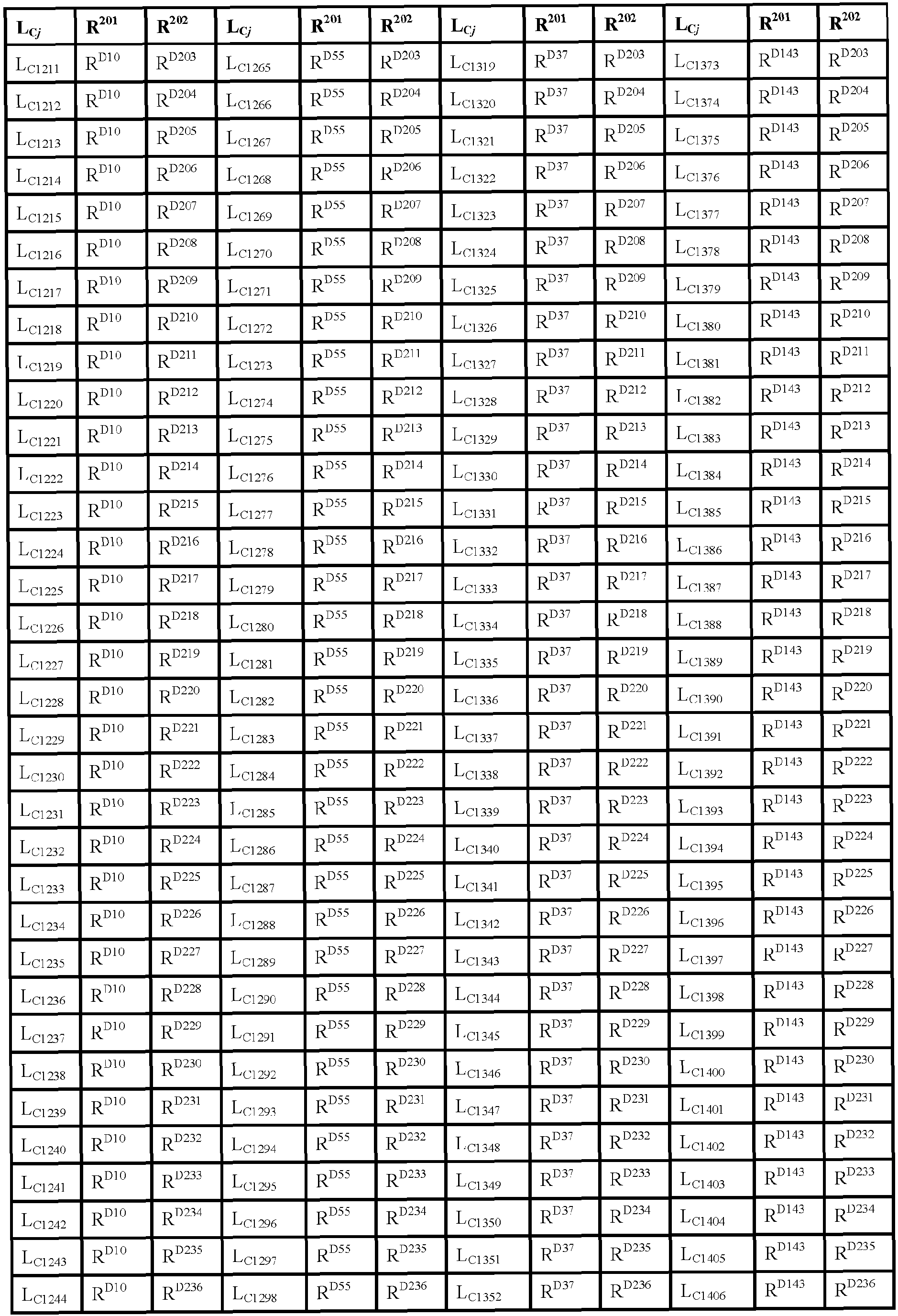 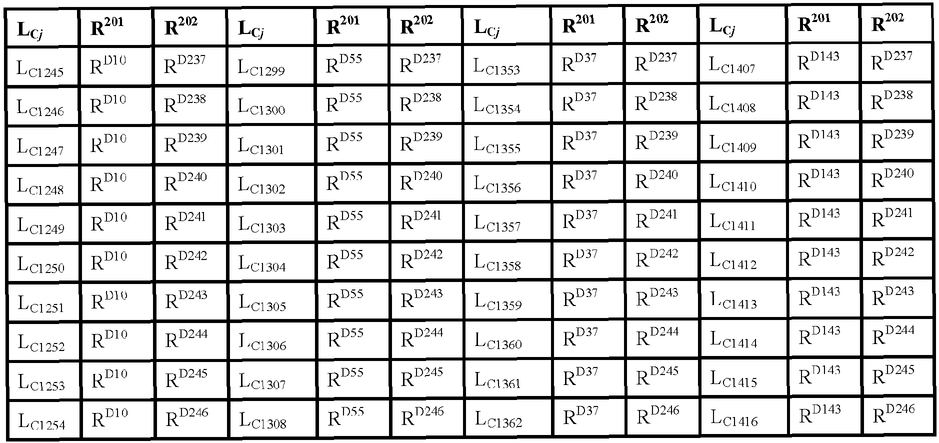
wherein R^{D1} to R^{D246} have the structures defined in the following LIST 10:

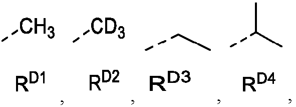

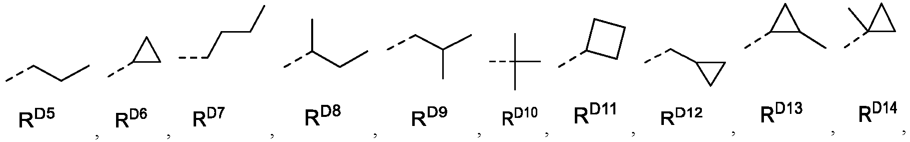

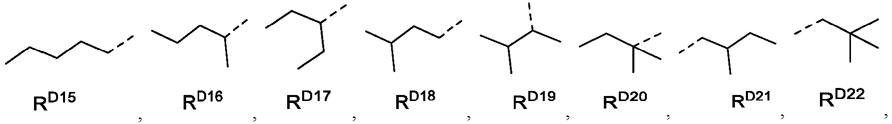

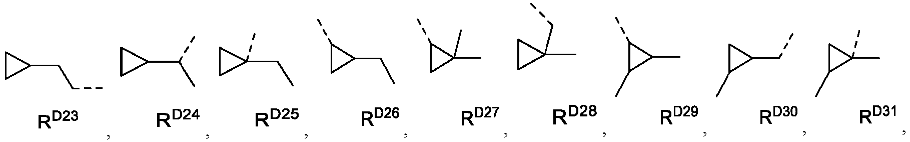

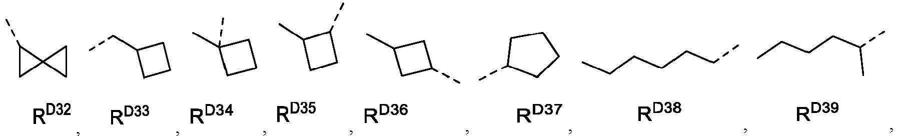

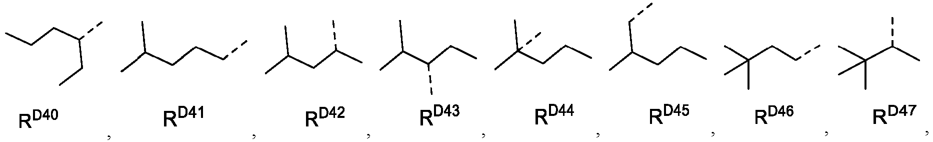

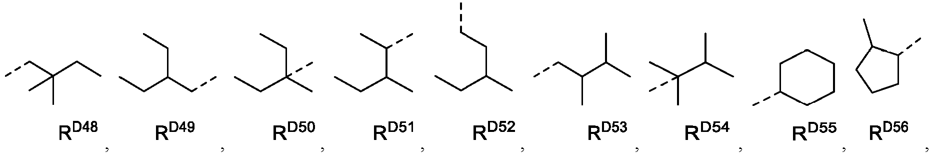

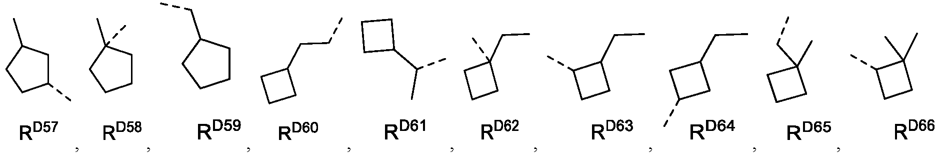

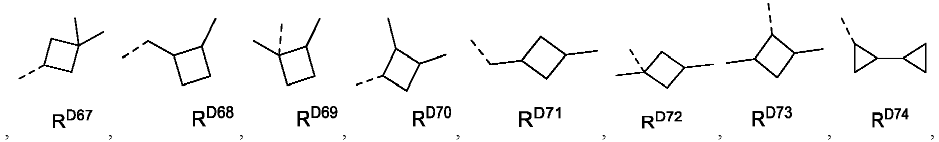

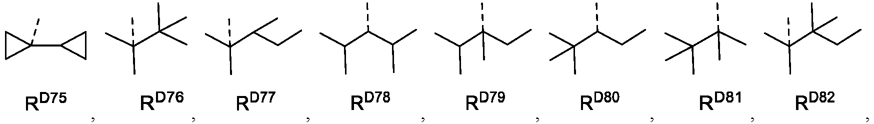

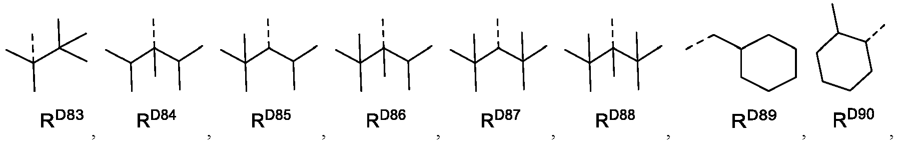

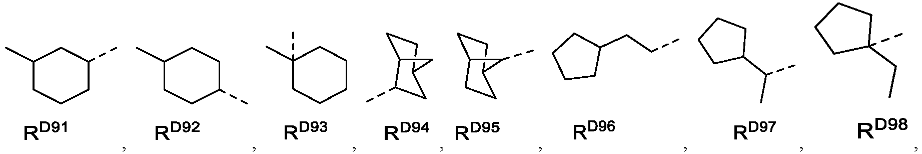

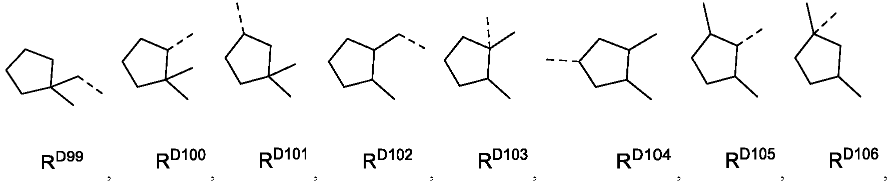

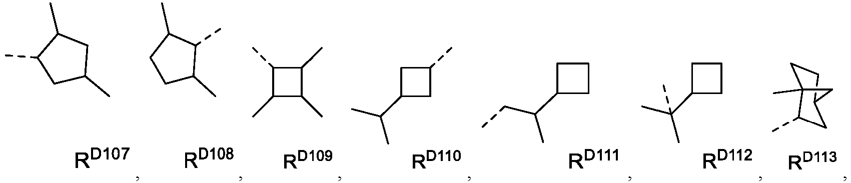

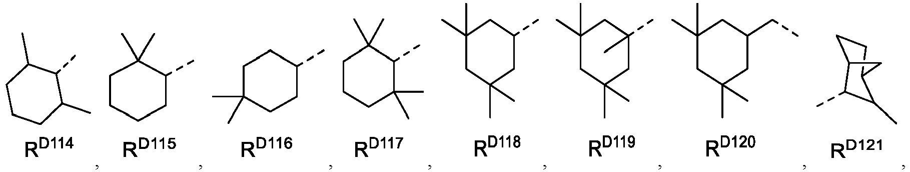

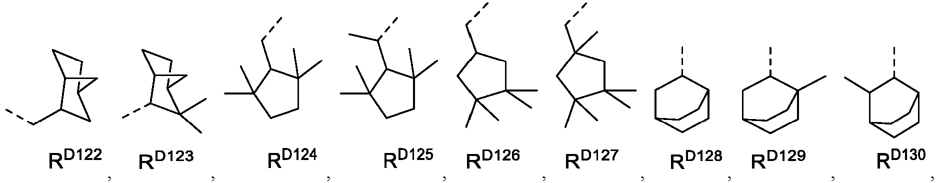

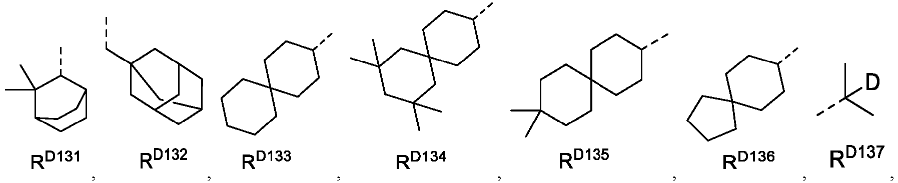

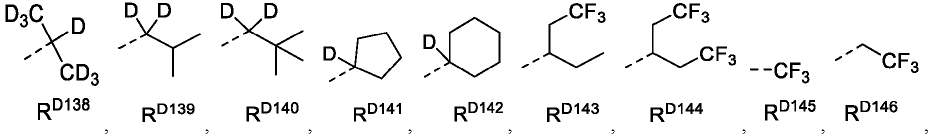

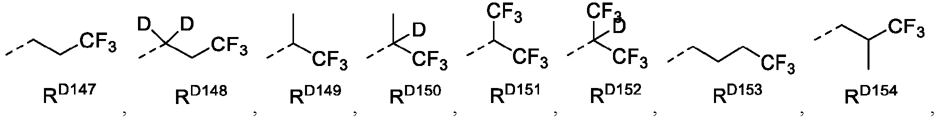

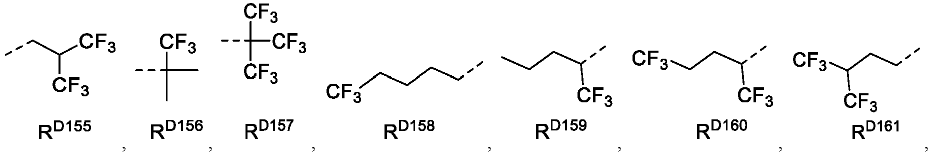

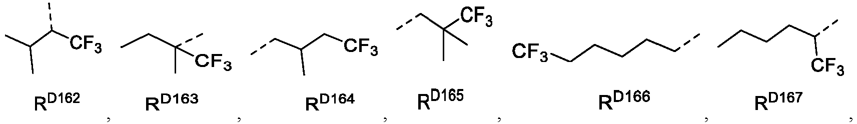

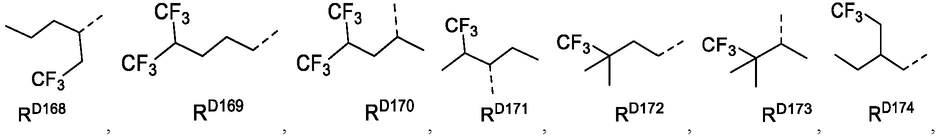

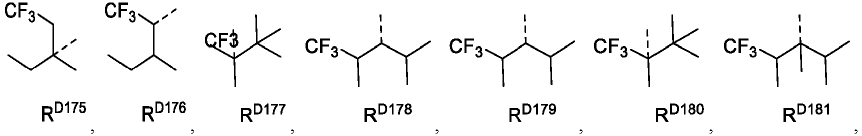

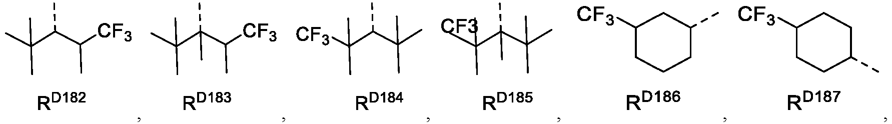

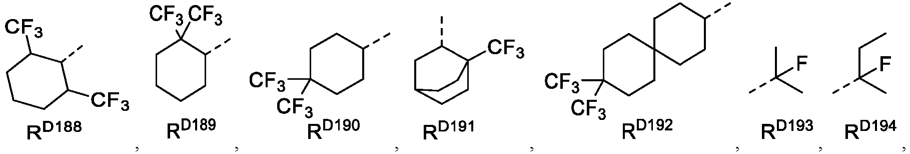

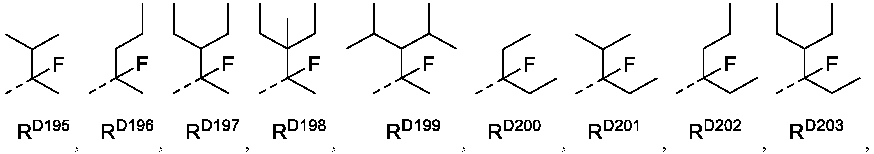

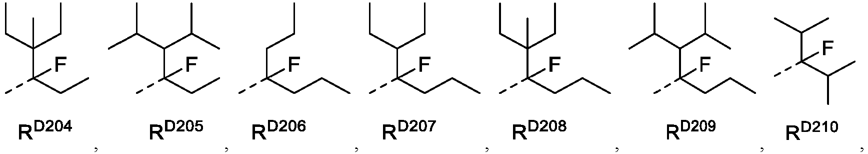

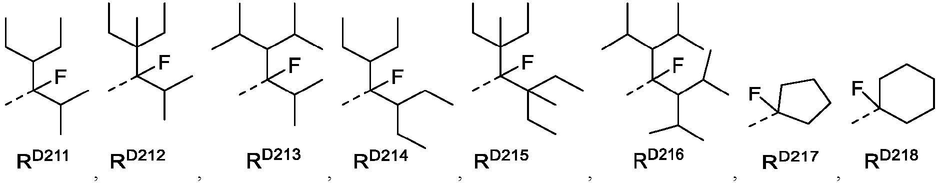

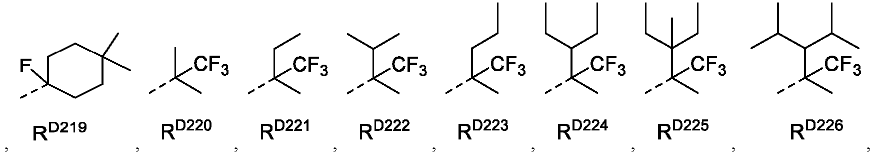

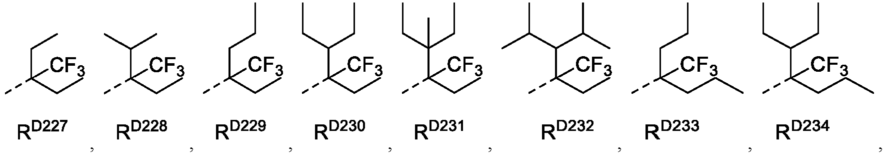

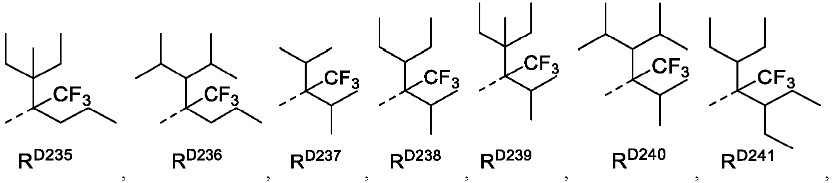

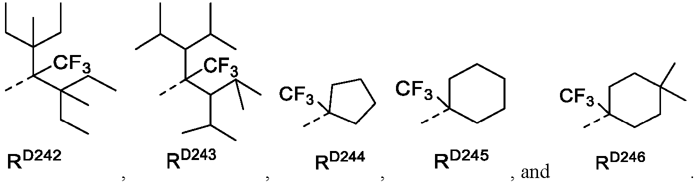

In some embodiments, the compound is selected from the group consisting of only those compounds whose L_{B*k*} corresponds to one of the following: L_{B1}, L_{B2}, L_{B18}, L_{B28}, L_{B38}, L_{B108}, L_{B118}, L_{B122}, L_{B124}, L_{B126}, L_{B128}, L_{B130}, L_{B132}, L_{B134}, L_{B136}, L_{B138}, L_{B140}, L_{B142}, L_{B144}, L_{B156}, L_{B158}, L_{B160}, L_{B162}, L_{B164}, L_{B168}, L_{B172}, L_{B175}, L_{B204}, L_{B206}, L_{B214}, L_{B216}, L_{B218}, L_{B220}, L_{B222}, L_{B231}, L_{B233}, L_{B235}, L_{B237}, L_{B240}, L_{B242}, L_{B244}, L_{B246}, L_{B248}, L_{B250}, L_{B252}, L_{B254}, L_{B256}, L_{B258}, L_{B260}, L_{B262}, L_{B264}, L_{B265}, L_{B266}, L_{B267}, L_{B268}, L_{B269}, and L_{B270}.

In some embodiments, the compound is selected from the group consisting of only those compounds whose L_{B*k*} corresponds to one of the following: L_{B1}, L_{B2}, L_{B18}, L_{B28}, L_{B38}, L_{B108}, L_{B118}, L_{B122}, L_{B126}, L_{B128}, L_{B132}, L_{B136}, L_{B138}, L_{B142}, L_{B156}, L_{B162}, L_{B204}, L_{B206}, L_{B214}, L_{B216}, L_{B218}, L_{B220}, L_{B231}, L_{B233}, L_{B} 237, L_{B} 264, L_{B265}, L_{B266}, L_{B267}, L_{B268}, L_{B269}, and L_{B270}.

In some embodiments, the compound is selected from the group consisting of only those compounds having L_{C*j*-I} or L_{C*j*-II} ligand whose corresponding R²⁰¹ and R²⁰² are defined to be one of the following structures: R^{D1}, R^{D3}, R^{D4}, R^{D5}, R^{D9}, R^{D10}, R^{D17}, R^{D18}, R^{D20}, R^{D22}, R^{D37}, R^{D40}, R^{D41}, R^{D42}, R^{D43}, R^{D48}, R^{D49}, R^{D50}, R^{D54}, R^{D55}, R^{D58}, R^{D59}, R^{D78}, R^{D79}, R^{D81}, R^{D87}, R^{D88}, R^{D89}, R^{D93}, R^{D116}, R^{D117}, R^{D118}, R^{D119}, R^{D120}, R^{D133}, R^{D134}, R^{D135}, R^{D136}, R^{D143}, R^{D144}, R^{D145}, R^{D146}, R^{D147}, R^{D149}, R^{D151}, R^{D154}, R^{D155}, R^{D161}, R^{D175} R^{D190}, R^{D193}, R^{D200}, R^{D201}, R^{D206}, R^{D210}, R^{D214}, R^{D215}, R^{D216}, R^{D218}, R^{D219}, R^{D220}, R^{D227}, R^{D237}, R^{D241}, R^{D242}, R^{D245}, and R^{D246}.

In some embodiments, the compound is selected from the group consisting of only those compounds having L_{C*j*-I} or L_{C*j*-II} ligand whose corresponding R²⁰¹ and R²⁰² are defined to be one of selected from the following structures: R^{D1}, R^{D3}, R^{D4}, R^{D5}, R^{D9}, R^{D10}, R^{D17}, R^{D22}, R^{D43}, R^{D50}, R^{D78}, R^{D116}, R^{D118}, R^{D133}, R^{D134}, R^{D135}, R^{D136}, R^{D143}, R^{D144}, R^{D145}, R^{D146}, R^{D149}, R^{D151}, R^{D154}, R^{D155} R^{D190}, R^{D193}, R^{D200}, R^{D201}, R^{D206}, R^{D210}, R^{D214}, R^{D215}, R^{D216}, R^{D218}, R^{D219}, R^{D220}, R^{D227}, R^{D237}, R^{D241}, R^{D242}, R^{D245}, and R^{D246}.

In some embodiments, the compound is selected from the group consisting of only those compounds having one of the following structures for the L_{C*j*-I} ligand:

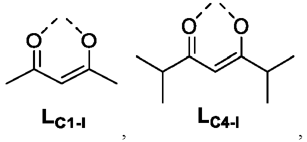

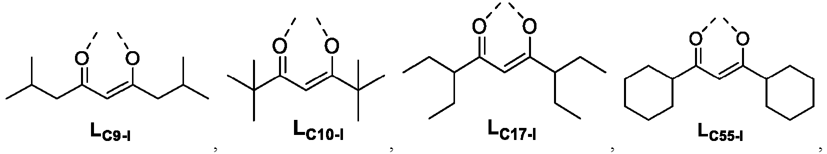

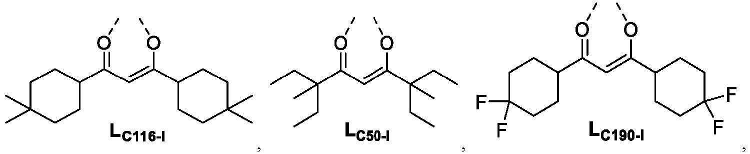

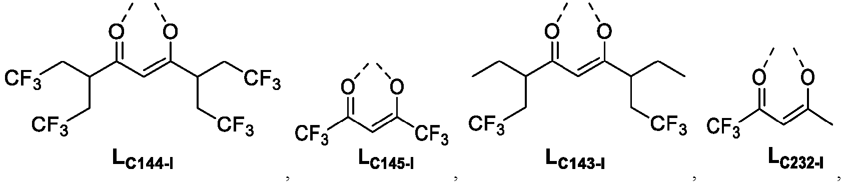

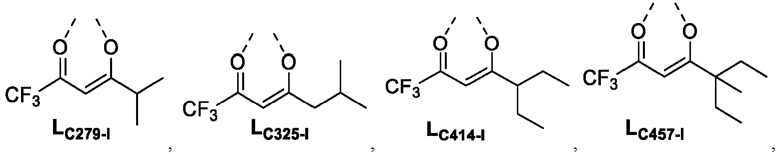

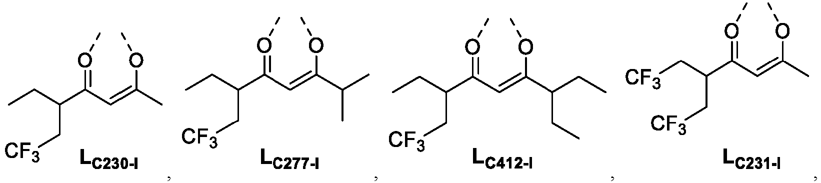

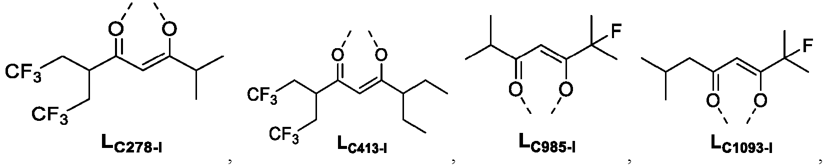

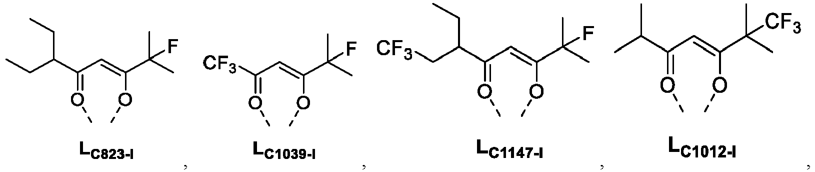

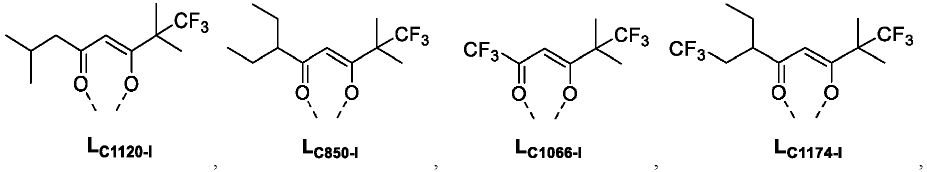

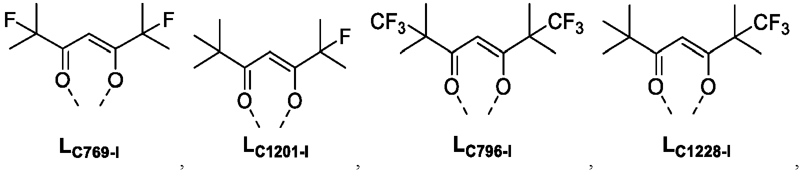

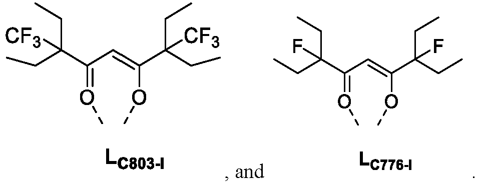

In some embodiments, the compound has a formula selected from the group consisting of Ir(L_{A})₂(L_{B}), Ir(L_{A})(L_{B})₂, Ir(L_{A})₂(L_{C}), and Ir(L_{A})(L_{B})(L_{C}). In some embodiments, L_{A} is selected from the group consisting of the structures of LIST 1, LIST 2, and LIST 3, L_{B} is selected from the group consisting of the structures of LIST 6, LIST 7, and LIST 8 (L_{Bk}), and L_{C} is selected from the group consisting of the structures of L_{C*j*-I} and L_{C*j*-II} in LIST 9.

In some embodiments, L_{A} is selected from the group consisting of the structures of LIST 1 and L_{B} is selected from the group consisting of the structures of L_{Bk}. In some embodiments, L_{A} is selected from the group consisting of the structures of LIST 2 and L_{B} is selected from the group consisting of the structures of L_{Bk}. In some embodiments, L_{A} is selected from LIST 3 defined herein, and L_{B} is selected from the group consisting of the structures of L_{Bk} wherein k is an integer from 1 to 474. In some embodiments, L_{A} is selected from LIST 3 defined herein, and L_{C} is selected from the group consisting of the structures of L_{C*j*-I} and L_{C*j*-II} wherein j is an integer from 1 to 1416.

In some embodiments, the compound can have the formula Ir(L_{Ai-m})₃, the formula Ir(L_{Ai-m})₂(L_{B}), the formula Ir(L_{Ai-m})(L_{B})₂, the formula Ir(L_{A})₂(L_{Bk}), the formula Ir(L_{A})(L_{Bk})₂, the formula Ir(L_{Ai-m})(L_{B*k*})₂, the formula Ir(L_{Ai-m})₂(L_{Bk}), the formula Ir(L_{Ai-m})₂(L_{C*j-I*}), the formula Ir(L_{Ai-m})₂(L_{C*j-II*}), the formula Ir(L_{Ai-m})(L_{B*k*})(L_{C*j*-*I*}), or the formula Ir(L_{Ai-m})(L_{B*k*})(L_{C*j-II*}), wherein L_{Ai-m}, L_{B*k*}, and L_{C*j-I*} and L_{C*j-II*} are all defined herein.

In some embodiments of the compound comprising the ligand L_{A} that includes at least one of the following substituents R^{A}, R^{B}, R^{C} R^{D}, R^{AA}, R^{BB}, R^{CC}, R^{DD}, R^{E}, and R^{F}, at least one of the R^{A}, R^{B}, R^{C}, R^{D}, R^{AA}, R^{BB}, R^{CC}, R^{DD}, R^{E}, and R^{F} in the ligand L_{A} is partially or fully deuterated. In some embodiments, at least one of R^{A} is partially or fully deuterated. In some embodiments, at least one of R^{B} is partially or fully deuterated. In some embodiments, at least one of R^{C} is partially or fully deuterated. In some embodiments, at least one of R^{D} is partially or fully deuterated. In some embodiments, at least one of R^{AA} is partially or fully deuterated. In some embodiments, at least one of R^{BB} is partially or fully deuterated. In some embodiments, at least one of R^{CC} is partially or fully deuterated. In some embodiments, at least one of R^{DD} is partially or fully deuterated. In some embodiments, at least one of R^{E} and R^{F} is partially or fully deuterated.

In some embodiments, the compound is selected from the group consisting of the structures of the following LIST 11

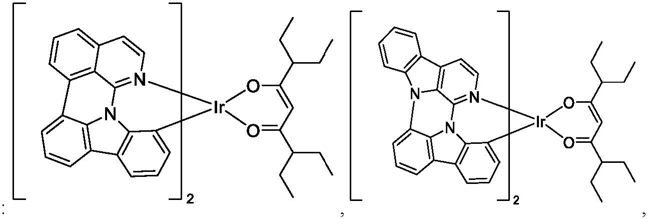

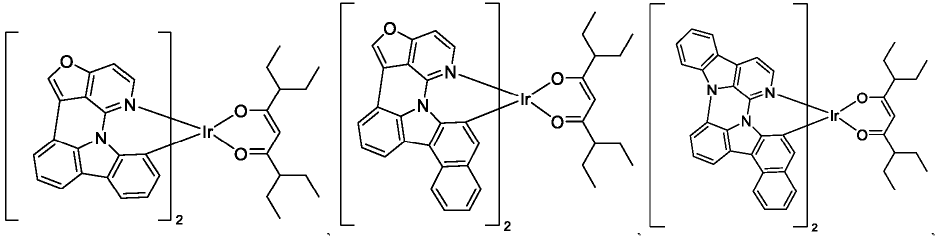

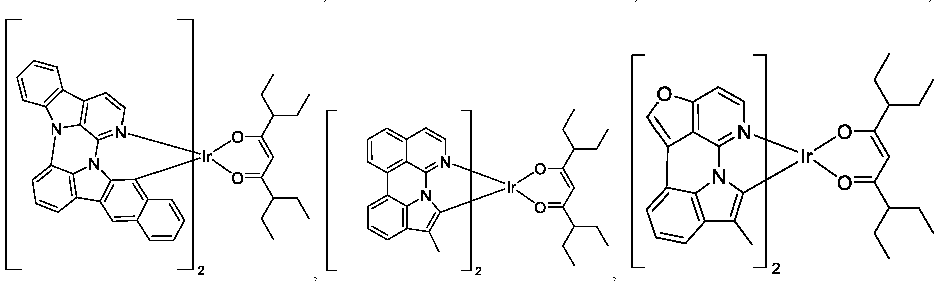

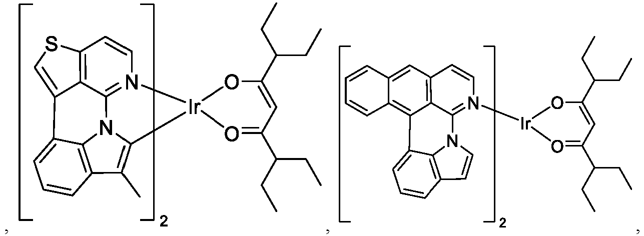

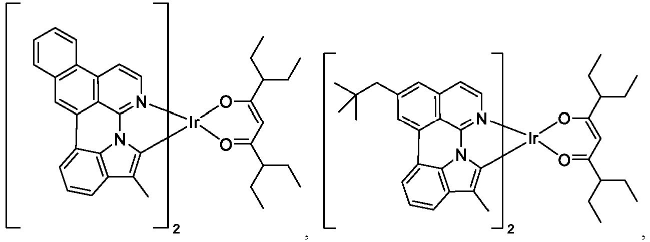

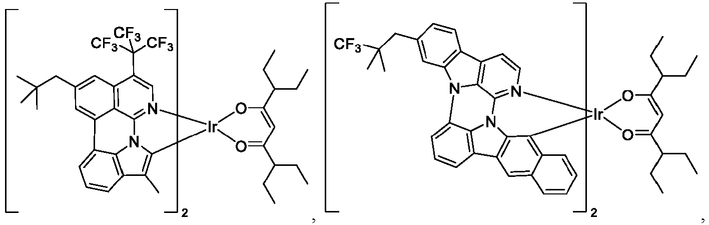

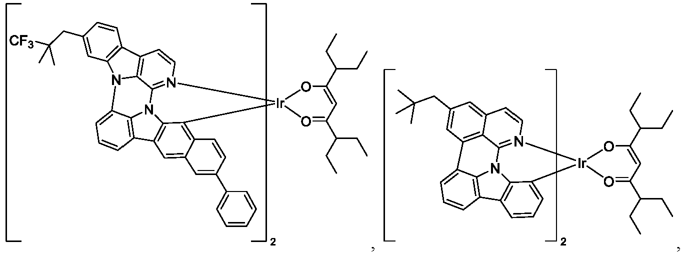

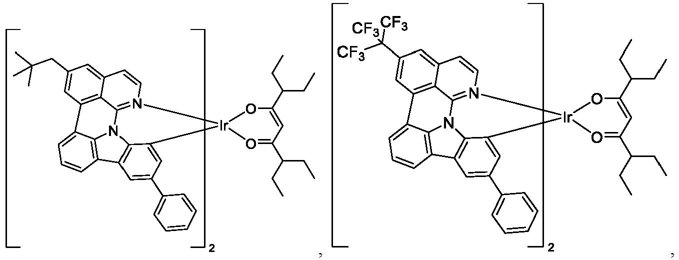

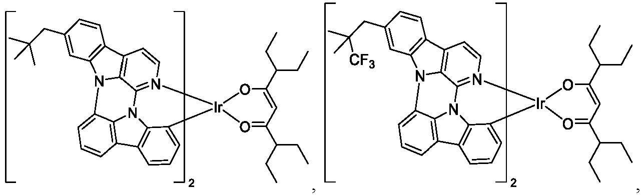

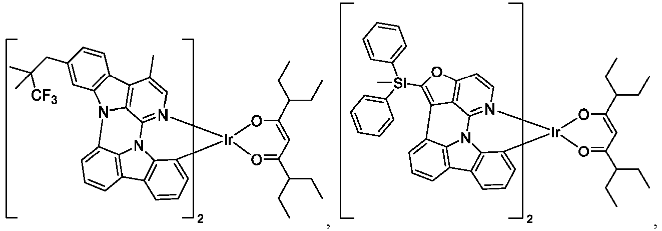

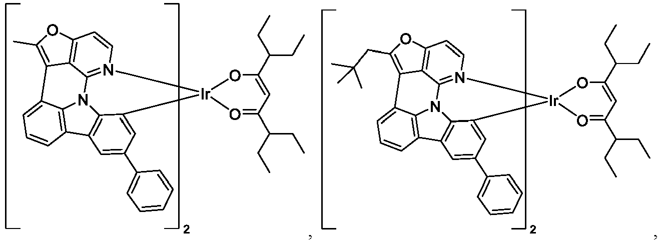

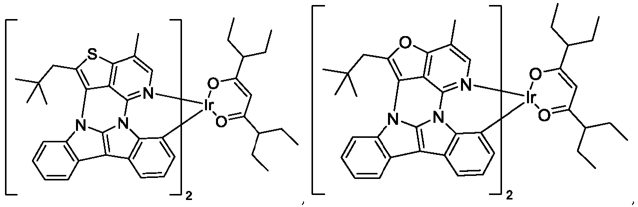

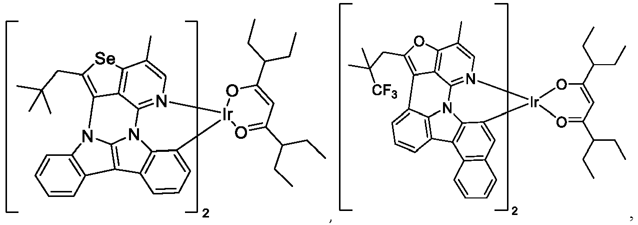

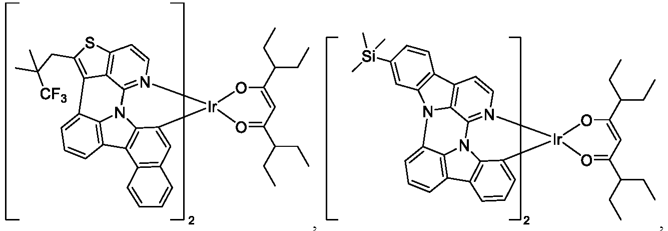

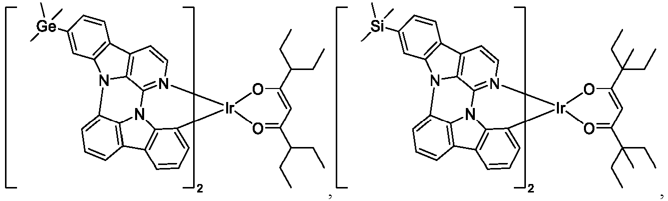

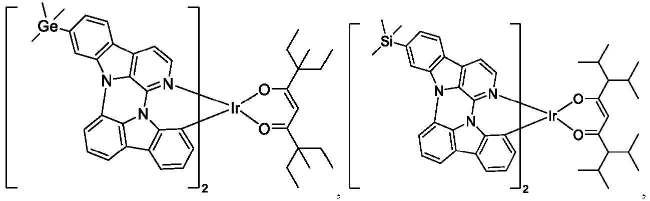

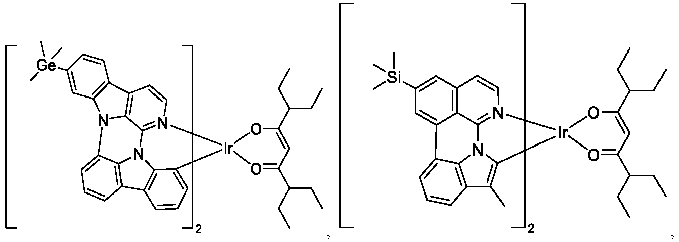

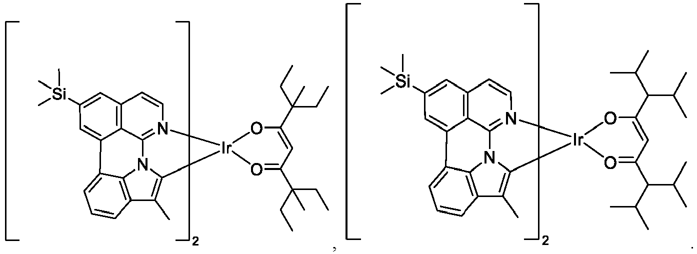

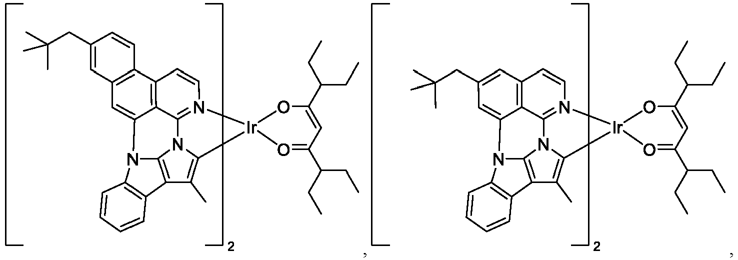

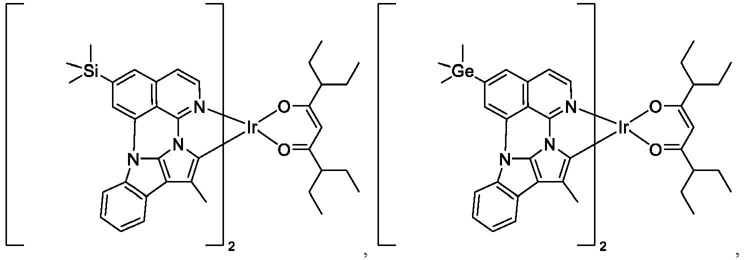

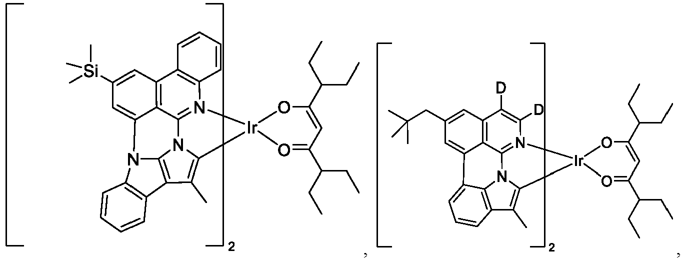

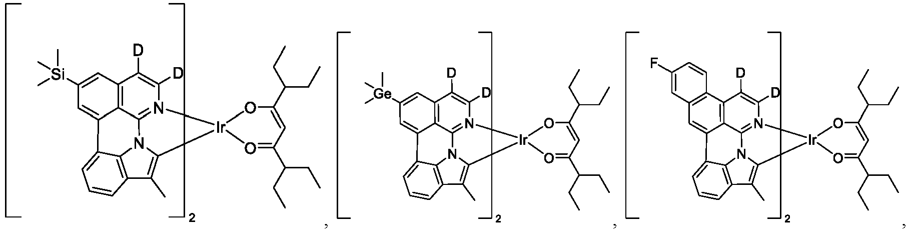

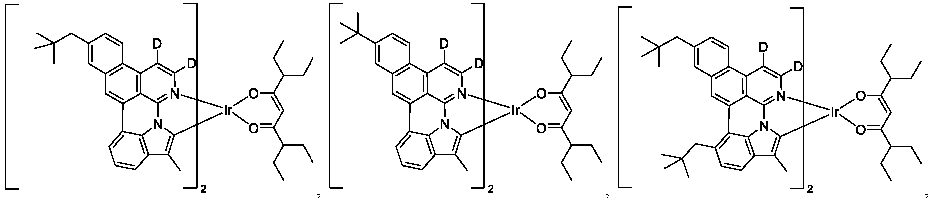

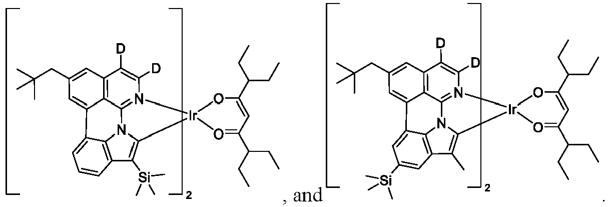

In some embodiments, the compound has the Formula II, 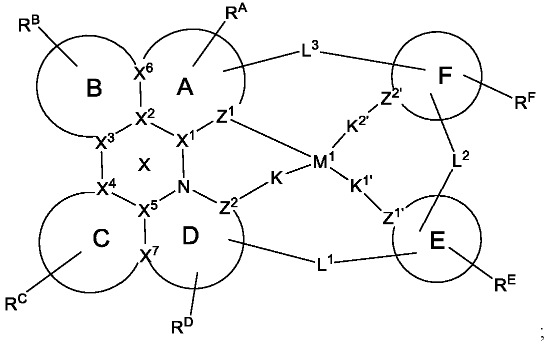 wherein:
M¹ is Pd or Pt;
moieties E and F are each independently monocyclic or polycyclic ring structure comprising 5-membered and/or 6-membered carbocyclic or heterocyclic rings;
Z^{1'} and Z^{2'} are each independently C or N;
K^{1'}, and K^{2'} are each independently selected from the group consisting of a direct bond, O, and S, wherein at least two of K, K^{1'}, and K^{2'} are direct bonds;
L¹, L², and L³ are each independently absent or selected from the group consisting of a direct bond, BR, BRR', NR, PR, P(O)R, O, S, Se, C=O, C=S, C=Se, C=NR, C= CRR', S=O, SO₂, CR, CRR', SiRR', GeRR', alkylene, cycloalkyl, aryl, cycloalkylene, arylene, heteroarylene, and combinations thereof, wherein at least one of L¹ and L² is present;
R^{E} and R^{F} each independently represents zero, mono, or up to a maximum allowed number of substitutions to its associated ring;
each of R, R', R^{E}, and R^{F} is independently a hydrogen or a substituent selected from the group consisting of the General Substituents; and
two adjacent R^{A}, R^{B}, R^{C}, R^{E}, and R^{F} can be joined or fused together to form a ring.

In some embodiments, each of R, R', R^{E}, and R^{F} is independently a hydrogen or a substituent selected from the group consisting of the Preferred General Substituents.

In some embodiments of Formula II, at least one R, R', R^{A}, R^{B}, R^{C}, R^{D}, R^{E}, or R^{F} is partially or fully deuterated. In some embodiments, at least one R^{A} is partially or fully deuterated. In some embodiments, at least one R^{B} is partially or fully deuterated. In some embodiments, at least one R^{C} is partially or fully deuterated. In some embodiments, at least one R^{D} is partially or fully deuterated. In some embodiments, at least one R^{E} is partially or fully deuterated. In some embodiments, at least one R^{F} is partially or fully deuterated. In some embodiments of Formula II, at least R or R' is present and is partially or fully deuterated.

In some embodiments of Formula II, at least one R, R', R^{A}, R^{B}, R^{C}, R^{D}, R^{E}, or R^{F} is or comprises an electron-withdrawing group from the EWG1 LIST as defined herein. In some embodiments, at least one R, R', R^{A}, R^{B}, R^{C}, R^{D}, R^{E}, or R^{F} is or comprises an electron-withdrawing group from the EWG2 LIST as defined herein. In some embodiments, at least one R, R', R^{A}, R^{B}, R^{C}, R^{D}, R^{E}, or R^{F} is or comprises an electron-withdrawing group from the EWG3 LIST as defined herein. In some embodiments, at least one R, R', R^{A}, R^{B}, R^{C}, R^{D}, R^{E}, or R^{F} is or comprises an electron-withdrawing group from the EWG4 LIST as defined herein. In some embodiments, at least one R, R', R^{A}, R^{B}, R^{C}, R^{D}, R^{E}, or R^{F} is or comprises an electron-withdrawing group from the Pi-EWG LIST as defined herein.

In some embodiments of Formula II, at least one R^{A} is or comprises an electron-withdrawing group from the EWG1 LIST as defined herein. In some embodiments, at least one R^{A} is or comprises an electron-withdrawing group from the EWG2 LIST as defined herein. In some embodiments, at least one R^{A} is or comprises an electron-withdrawing group from the EWG3 LIST as defined herein. In some embodiments, at least one R^{A} is or comprises an electron-withdrawing group from the EWG4 LIST as defined herein. In some embodiments, at least one R^{A} is or comprises an electron-withdrawing group from the Pi-EWG LIST as defined herein.

In some embodiments of Formula II, at least one R^{B} is or comprises an electron-withdrawing group from the EWG1 LIST as defined herein. In some embodiments, at least one R^{B} is or comprises an electron-withdrawing group from the EWG2 LIST as defined herein. In some embodiments, at least one R^{B} is or comprises an electron-withdrawing group from the EWG3 LIST as defined herein. In some embodiments, at least one R^{B} is or comprises an electron-withdrawing group from the EWG4 LIST as defined herein. In some embodiments, at least one R^{B} is or comprises an electron-withdrawing group from the Pi-EWG LIST as defined herein.

In some embodiments of Formula II, at least one R^{C} is or comprises an electron-withdrawing group from the EWG1 LIST as defined herein. In some embodiments, at least one R^{C} is or comprises an electron-withdrawing group from the EWG2 LIST as defined herein. In some embodiments, at least one R ^{C} is or comprises an electron-withdrawing group from the EWG3 LIST as defined herein. In some embodiments, at least one R^{C} is or comprises an electron-withdrawing group from the EWG4 LIST as defined herein. In some embodiments, at least one R^{C} is or comprises an electron-withdrawing group from the Pi-EWG LIST as defined herein.

In some embodiments of Formula II, at least one R^{D} is or comprises an electron-withdrawing group from the EWG1 LIST as defined herein. In some embodiments, at least one R^{D} is or comprises an electron-withdrawing group from the EWG2 LIST as defined herein. In some embodiments, at least one R^{D} is or comprises an electron-withdrawing group from the EWG3 LIST as defined herein. In some embodiments, at least one R^{D} is or comprises an electron-withdrawing group from the EWG4 LIST as defined herein. In some embodiments, at least one R^{D} is or comprises an electron-withdrawing group from the Pi-EWG LIST as defined herein.

In some embodiments of Formula II, at least one R^{E} is or comprises an electron-withdrawing group from the EWG1 LIST as defined herein. In some embodiments, at least one R^{E} is or comprises an electron-withdrawing group from the EWG2 LIST as defined herein. In some embodiments, at least one R^{E} is or comprises an electron-withdrawing group from the EWG3 LIST as defined herein. In some embodiments, at least one R^{E} is or comprises an electron-withdrawing group from the EWG4 LIST as defined herein. In some embodiments, at least one R^{E} is or comprises an electron-withdrawing group from the Pi-EWG LIST as defined herein.

In some embodiments of Formula II, at least one R^{F} is or comprises an electron-withdrawing group from the EWG1 LIST as defined herein. In some embodiments, at least one R^{F} is or comprises an electron-withdrawing group from the EWG2 LIST as defined herein. In some embodiments, at least one R^{F} is or comprises an electron-withdrawing group from the EWG3 LIST as defined herein. In some embodiments, at least one R^{F} is or comprises an electron-withdrawing group from the EWG4 LIST as defined herein. In some embodiments, at least one R^{F} is or comprises an electron-withdrawing group from the Pi-EWG LIST as defined herein.

In some embodiments, Formula II comprises an electron-withdrawing group from the EWG1 LIST as defined herein. In some embodiments, Formula II comprises an electron-withdrawing group from the EWG2 LIST as defined herein. In some embodiments, Formula II comprises an electron-withdrawing group from the EWG3 LIST as defined herein. In some embodiments, Formula II comprises an electron-withdrawing group from the EWG4 LIST as defined herein. In some embodiments, Formula II comprises an electron-withdrawing group from the Pi-EWG LIST as defined herein.]

In some embodiments of Formula II, L¹ is bonded to moiety D. In some embodiments, L¹ is bonded to a ring formed by R^{D} and K.

In some embodiments of Formula II, ring E and ring F are both 6-membered aromatic rings.

In some embodiments of Formula II, ring F is a 5-membered or 6-membered heteroaromatic ring.

In some embodiments of Formula II, L¹ is O or CRR'.

In some embodiments of Formula II, Z^{2'} is N and Z^{1'} is C. In some embodiments of Formula II, Z^{2'} is C and Z^{1'} is N.

In some embodiments of Formula II, L² is a direct bond. In some embodiments of Formula II, L² is NR.

In some embodiments of Formula II, K, K^{1'}, and K^{2'} are all direct bonds. In some embodiments of Formula II, one of K, K^{1'}, or K^{2'} is O.

In some embodiments, the compound is selected from the group consisting of compounds having the formula of Pt(L_{A'})(L*y*): 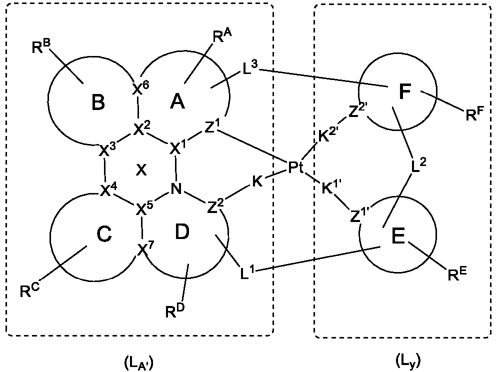 wherein L_{A'} is selected from the group consisting of the structures in the following LIST 12: 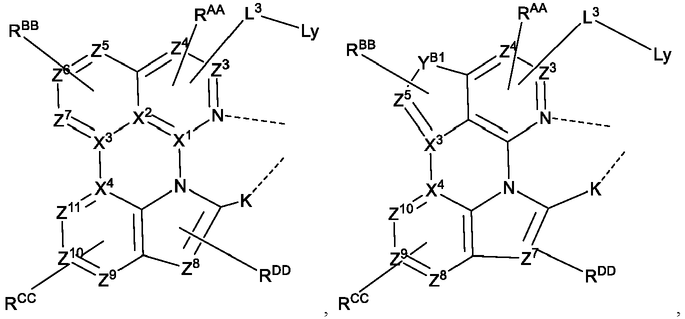 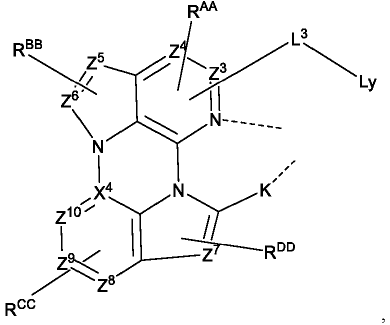 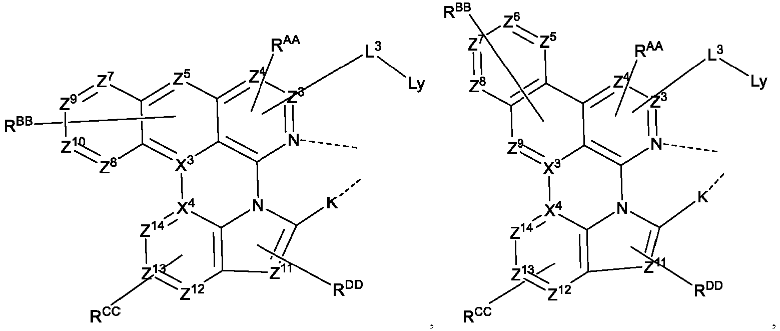 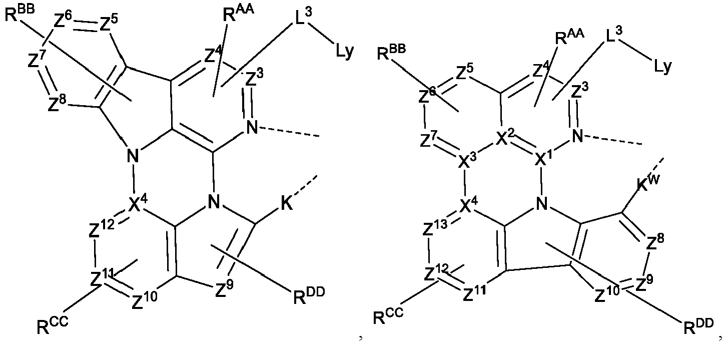 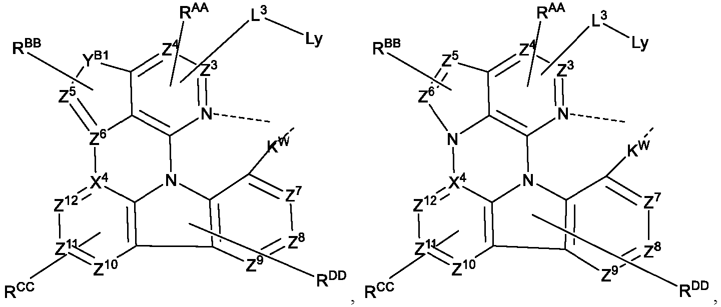 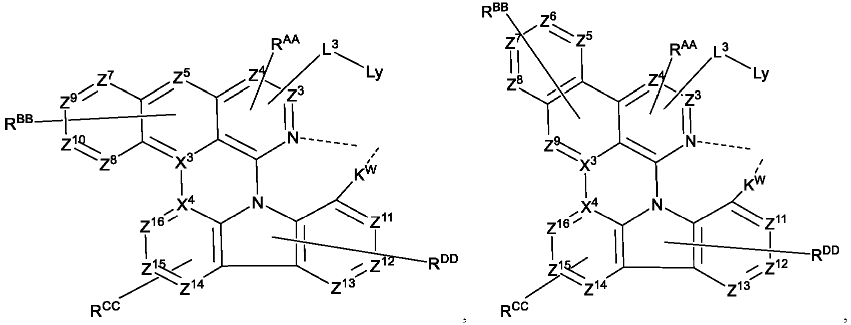 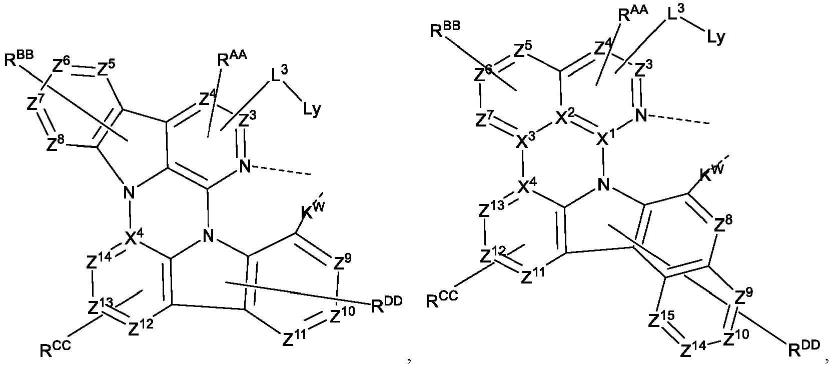 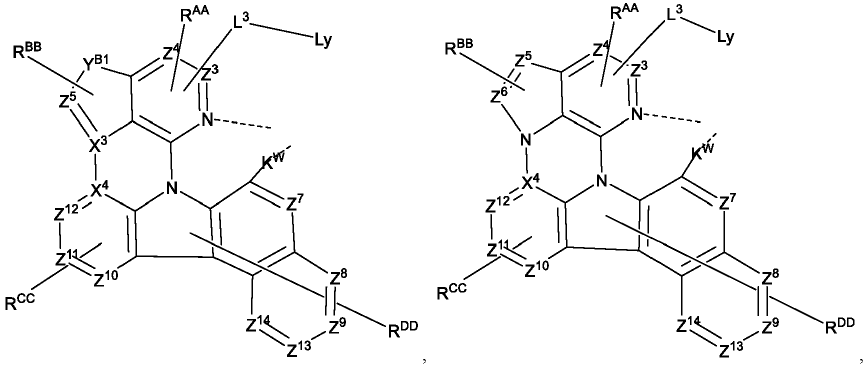 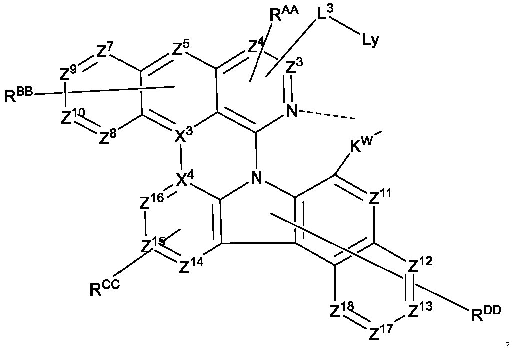 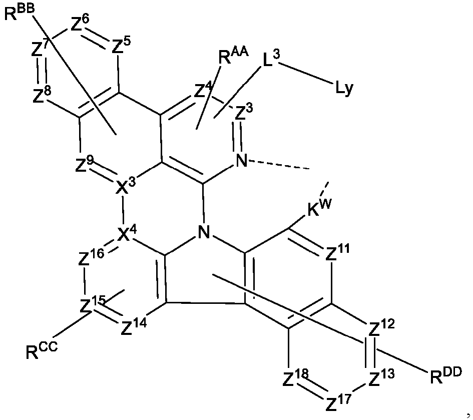 and 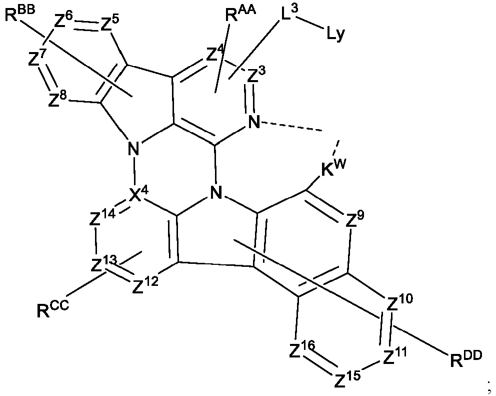 wherein L*_{y}* is selected from the group consisting of the following structures: 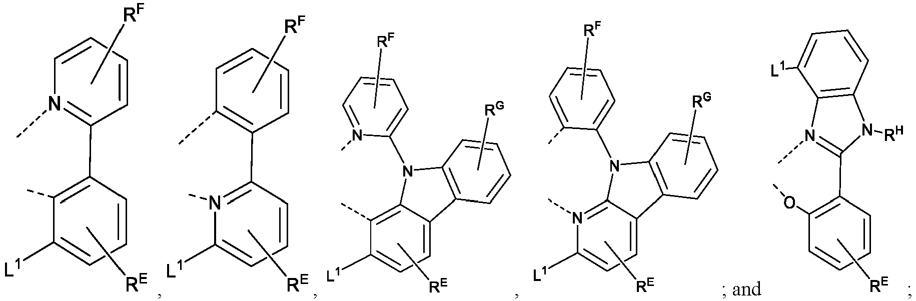 wherein:
each of Z³ to Z¹⁸ is independently C or N;
each Y^{B1} is independently selected from the group consisting of BR, BRR', NR, PR, P(O)R, O, S, Se, C=O, C=S, C=Se, C=NR, C= CRR', S=O, SO₂, CR, CRR', SiRR', and GeRR';
each of R^{AA}, R^{BB}, R^{CC}, R^{DD}, R^{E}, R^{F}, and R^{G} independently represent mono to the maximum allowable substitution, or no substitution,
each R, R', R^{AA}, R^{BB}, R^{CC}, R^{DD}, R^{E}, R^{F}, and R^{G} is independently a hydrogen or a substituent selected from the group consisting of the General Substituents defined herein, and
any two substituents may be joined or fused to form a ring.

In some embodiments, the compound is selected from the group consisting of the compounds having the formula of Pt(L_{A'})(L*y*): 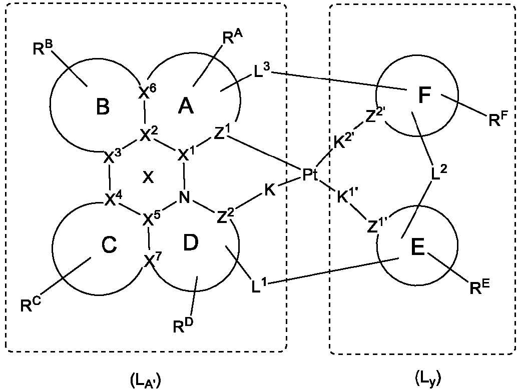 wherein L_{A'} is selected from the group consisting of the structures shown below in the following LIST 13: 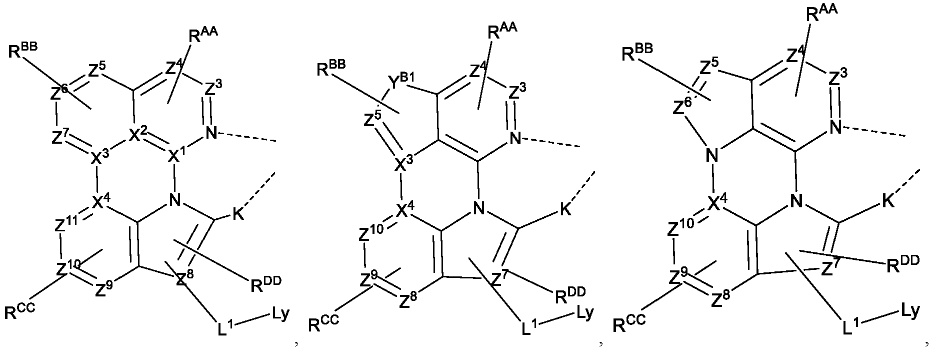 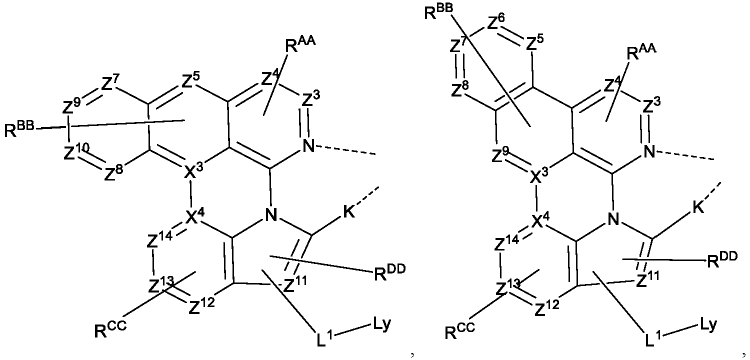 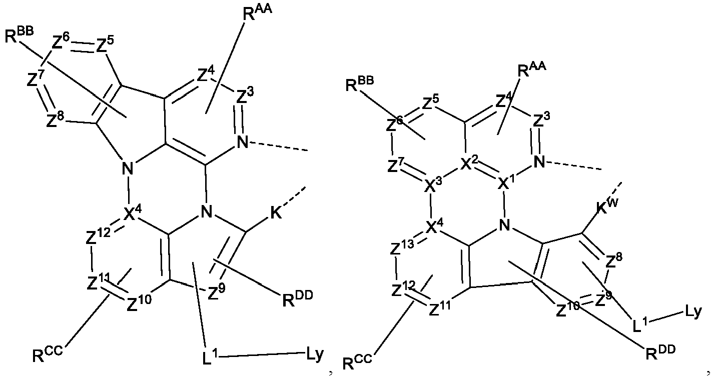 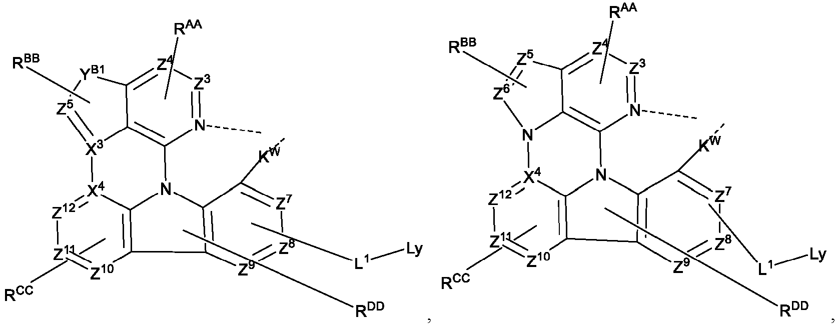 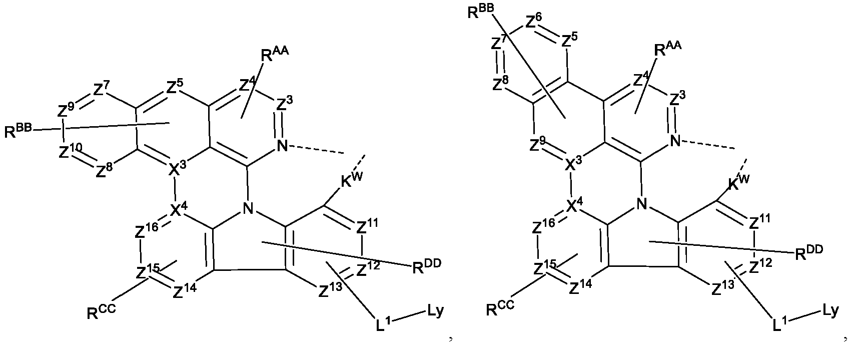 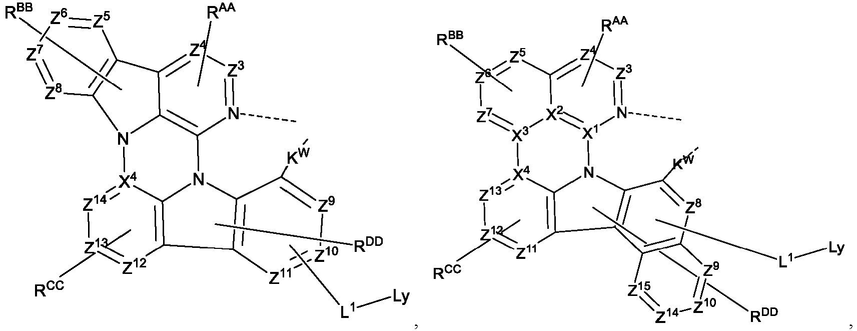 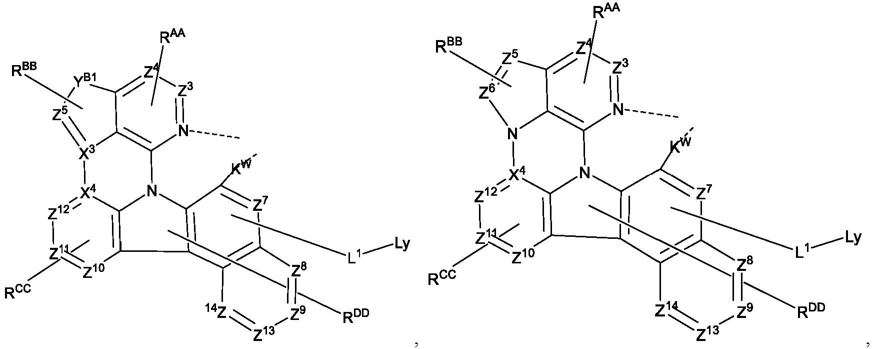 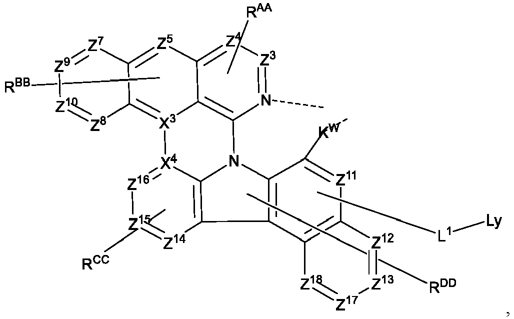 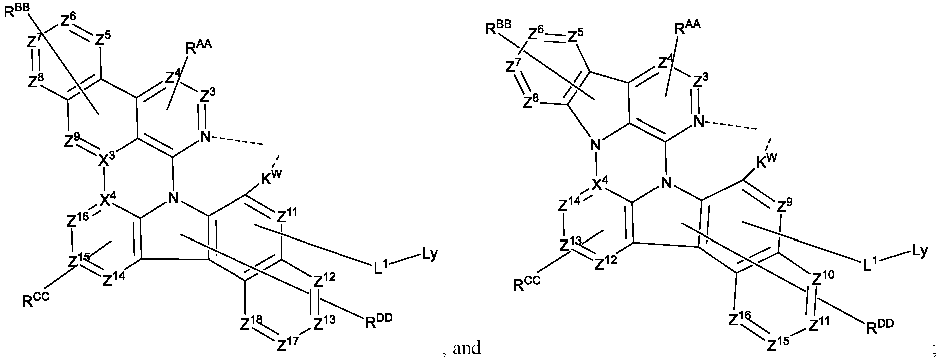 wherein L*_{y}* is selected from the group consisting of the following structures: 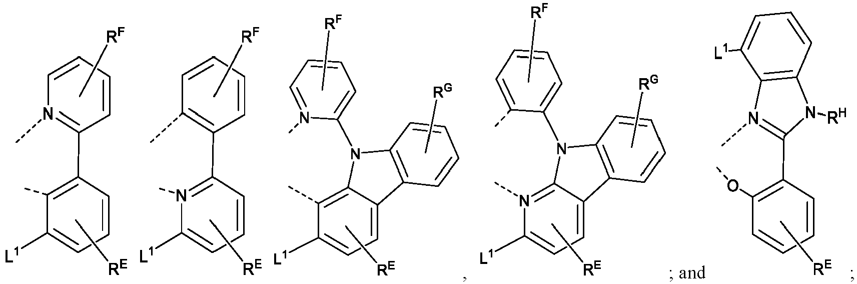 wherein:
each of Z³ to Z¹⁸ is independently C or N;
each K^{W} is a direct bond, O, or S;
each Y^{B1} is independently selected from the group consisting of BR, BRR', NR, PR, P(O)R, O, S, Se, C=O, C=S, C=Se, C=NR, C= CRR', S=O, SO₂, CR, CRR', SiRR', and GeRR';
each of R^{AA}, R^{BB}, R^{CC}, R^{DD}, R^{E}, R^{F}, and R^{G} independently represent mono to the maximum allowable substitution, or no substitution;
each R, R', R^{AA}, R^{BB}, R^{CC}, R^{DD}, R^{E}, R^{F}, R^{G}, and R^{H} is independently a hydrogen or a substituent selected from the group consisting of the General Substituents defined herein; and
any two substituents may be joined or fused to form a ring.

In some embodiments of Formula II, the compound is selected from the group consisting of the structures of the following LIST 14:

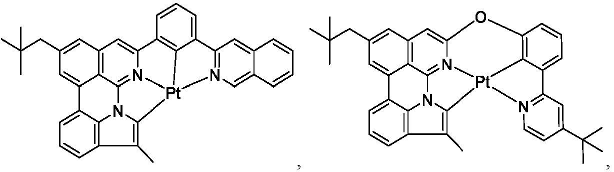

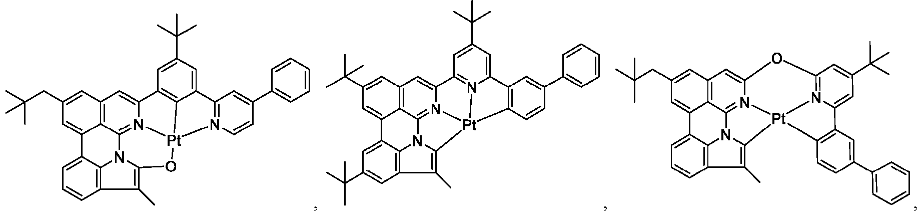

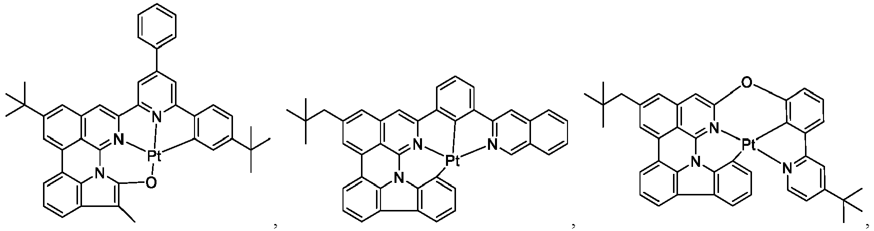

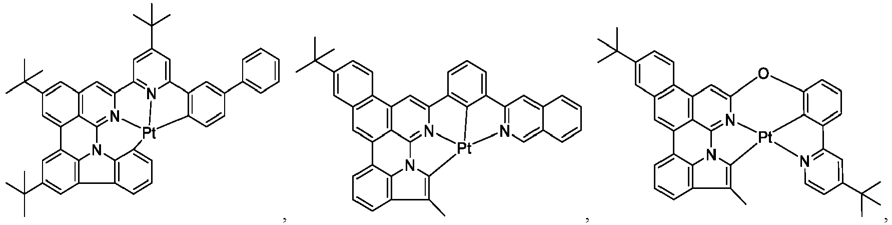

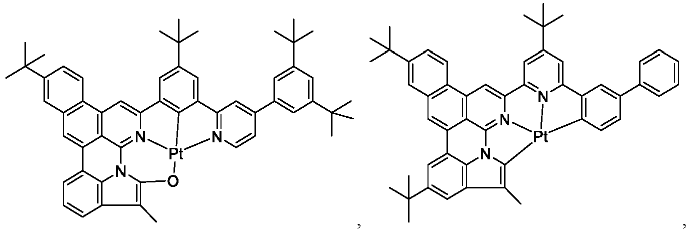

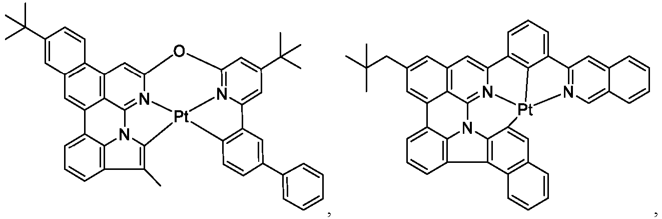

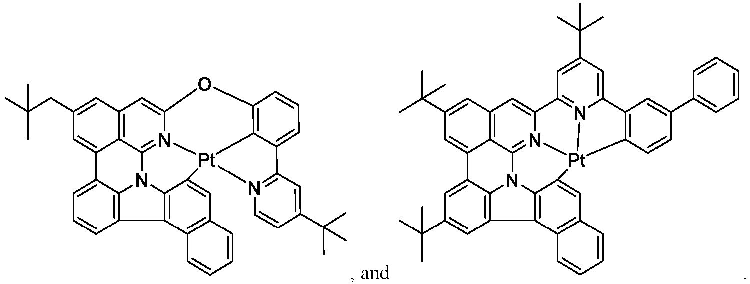

In some embodiments, the compound having a first ligand L_{A} of Formula I described herein can be at least 30% deuterated, at least 40% deuterated, at least 50% deuterated, at least 60% deuterated, at least 70% deuterated, at least 80% deuterated, at least 90% deuterated, at least 95% deuterated, at least 99% deuterated, or 100% deuterated. As used herein, percent deuteration has its ordinary meaning and includes the percent of possible hydrogen atoms (e.g., positions that are hydrogen or deuterium) that are replaced by deuterium atoms.

In some embodiments of heteroleptic compound having the formula of M(L_{A})ₚ(L_{B})_{q}(L_{C})ᵣ as defined above, the ligand L_{A} has a first substituent R^{I}, where the first substituent R^{I} has a first atom a-I that is the farthest away from the metal M among all atoms in the ligand L_{A}. Additionally, the ligand L_{B}, if present, has a second substituent R^{II}, where the second substituent R^{II} has a first atom a-II that is the farthest away from the metal M among all atoms in the ligand L_{B}. Furthermore, the ligand L_{C}, if present, has a third substituent R^{III}, where the third substituent R^{III} has a first atom a-III that is the farthest away from the metal M among all atoms in the ligand L_{C}.

In such heteroleptic compounds, vectors V_{D1}, V_{D2}, and V_{D3} can be defined that are defined as follows. V_{D1} represents the direction from the metal M to the first atom a-I and the vector V_{D1} has a value D¹ that represents the straight line distance between the metal M and the first atom a-I in the first substituent R¹. V_{D2} represents the direction from the metal M to the first atom a-II and the vector V_{D2} has a value D² that represents the straight line distance between the metal M and the first atom a-II in the second substituent R^{II}. V_{D3} represents the direction from the metal M to the first atom a-III and the vector V_{D3} has a value D³ that represents the straight line distance between the metal M and the first atom a-III in the third substituent R^{III}.

In such heteroleptic compounds, a sphere having a radius ***r*** is defined whose center is the metal M and the radius ***r*** is the smallest radius that will allow the sphere to enclose all atoms in the compound that are not part of the substituents R^{I}, R^{II} and R^{III}; and where at least one of D¹, D², and D³ is greater than the radius ***r*** by at least 1.5 Å. In some embodiments, at least one of D¹, D², and D³ is greater than the radius ***r*** by at least 2.9, 3.0, 4.3, 4.4, 5.2, 5.9, 7.3, 8.8, 10.3, 13.1, 17.6, or 19.1 Å.

In some embodiments of such heteroleptic compound, the compound has a transition dipole moment axis and angles are defined between the transition dipole moment axis and the vectors V_{D1}, V_{D2}, and V_{D3}, where at least one of the angles between the transition dipole moment axis and the vectors V_{D1}, V_{D2}, and V_{D3} is less than 40°. In some embodiments, at least one of the angles between the transition dipole moment axis and the vectors V_{D1}, V_{D2}, and V_{D3} is less than 30°. In some embodiments, at least one of the angles between the transition dipole moment axis and the vectors V_{D1}, V_{D2}, and V_{D3} is less than 20°. In some embodiments, at least one of the angles between the transition dipole moment axis and the vectors V_{D1}, V_{D2}, and V_{D3} is less than 15°. In some embodiments, at least one of the angles between the transition dipole moment axis and the vectors V_{D1}, V_{D2}, and V_{D3} is less than 10°. In some embodiments, at least two of the angles between the transition dipole moment axis and the vectors V_{D1}, V_{D2}, and V_{D3} are less than 20°. In some embodiments, at least two of the angles between the transition dipole moment axis and the vectors V_{D1}, V_{D2}, and V_{D3} are less than 15°. In some embodiments, at least two of the angles between the transition dipole moment axis and the vectors V_{D1}, V_{D2}, and V_{D3} are less than 10°.

In some embodiments, all three angles between the transition dipole moment axis and the vectors V_{D1}, V_{D2}, and V_{D3} are less than 20°. In some embodiments, all three angles between the transition dipole moment axis and the vectors V_{D1}, V_{D2}, and V_{D3} are less than 15°. In some embodiments, all three angles between the transition dipole moment axis and the vectors V_{D1}, V_{D2}, and V_{D3} are less than 10°.

In some embodiments of such heteroleptic compounds, the compound has a vertical dipole ratio (VDR) of 0.33 or less. In some embodiments of such heteroleptic compounds, the compound has a VDR of 0.30 or less. In some embodiments of such heteroleptic compounds, the compound has a VDR of 0.25 or less. In some embodiments of such heteroleptic compounds, the compound has a VDR of 0.20 or less. In some embodiments of such heteroleptic compounds, the compound has a VDR of 0.15 or less.

One of ordinarly skill in the art would readily understand the meaning of the terms transition dipole moment axis of a compound and vertical dipole ratio of a compound. Nevertheless, the meaning of these terms can be found in U.S. pat. No. 10,672,997. In U.S. pat. No. 10,672,997, horizontal dipole ratio (HDR) of a compound, rather than VDR, is discussed. However, one skilled in the art readily understands that VDR = 1 - HDR.

### C. The OLEDs and the Devices of the Present Disclosure

In another aspect, the present disclosure also provides an OLED device comprising a first organic layer that contains a compound as disclosed in the above compounds section of the present disclosure.

In some embodiments, the OLED comprises: an anode; a cathode; and an organic layer disposed between the anode and the cathode, where the organic layer comprises a compound having a first ligand L_{A} of Formula I as described herein.

In some embodiments, the organic layer may be an emissive layer and the compound as described herein may be an emissive dopant or a non-emissive dopant.

In some embodiments, the emissive layer comprises one or more quantum dots.

In some embodiments, the organic layer may further comprise a host, wherein the host comprises a triphenylene containing benzo-fused thiophene or benzo-fused furan, wherein any substituent in the host is an unfused substituent independently selected from the group consisting of CₙH₂ₙ₊₁, OCₙH₂ₙ₊₁, OAr₁, N(CₙH₂ₙ₊₁)₂, N(Ar₁)(Ar₂), CH=CH-CₙH₂ₙ₊₁, C≡CCₙH₂ₙ₊₁, Ar₁, Ar₁-Ar₂, CₙH₂ₙ-Ar₁, or no substitution, wherein n is an integer from 1 to 10; and wherein Ar₁ and Ar₂ are independently selected from the group consisting of benzene, biphenyl, naphthalene, triphenylene, carbazole, and heteroaromatic analogs thereof.

In some embodiments, the organic layer may further comprise a host, wherein host comprises at least one chemical group selected from the group consisting of triphenylene, carbazole, indolocarbazole, dibenzothiophene, dibenzofuran, dibenzoselenophene, 5λ2-benzo[d]benzo[4,5]imidazo[3,2-a]imidazole, 5,9-dioxa-13b-boranaphtho[3,2,1-de]anthracene, triazine, boryl, silyl, aza-triphenylene, aza-carbazole, aza-indolocarbazole, aza-dibenzothiophene, aza-dibenzofuran, aza-dibenzoselenophene, aza-5λ2-benzo[d]benzo[4,5]imidazo[3,2-a]imidazole, and aza-(5,9-dioxa-13b-boranaphtho[3,2,1-de]anthracene).

In some embodiments, the host can be selected from the group consisting of the structures of the following HOST Group 1: 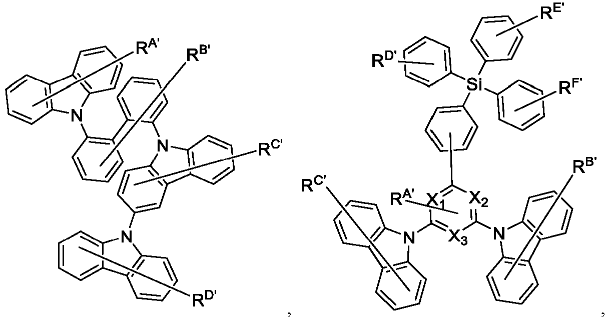 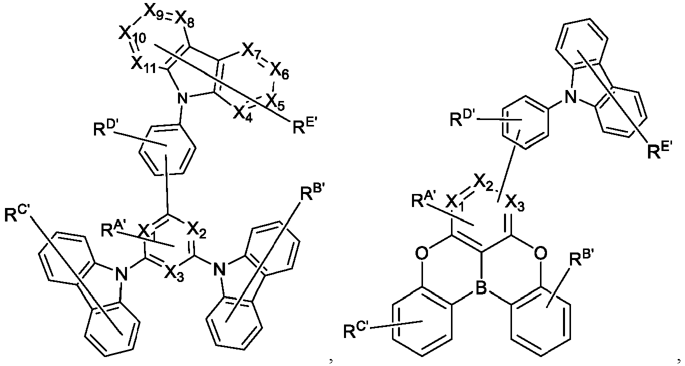 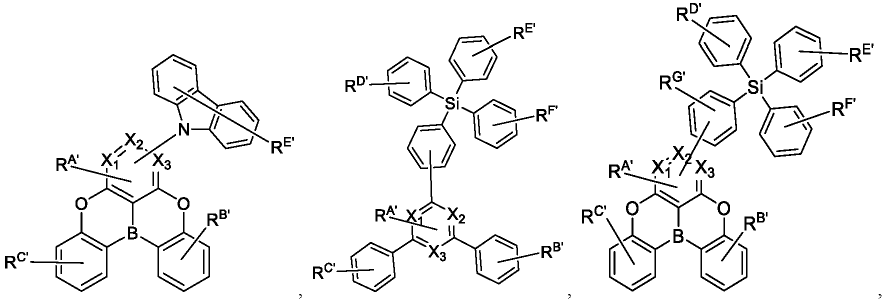 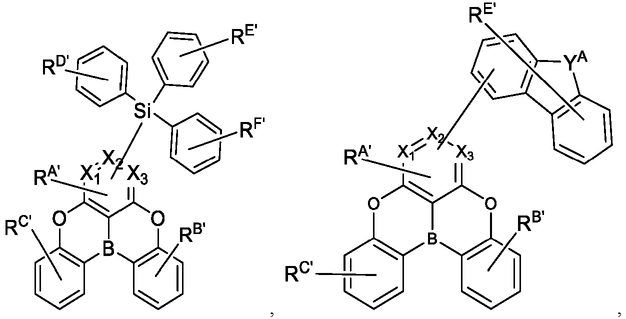 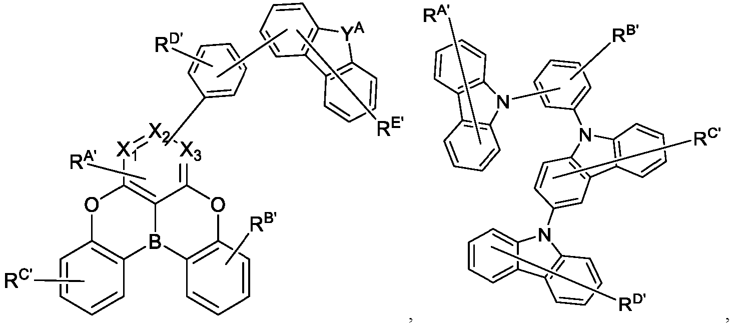 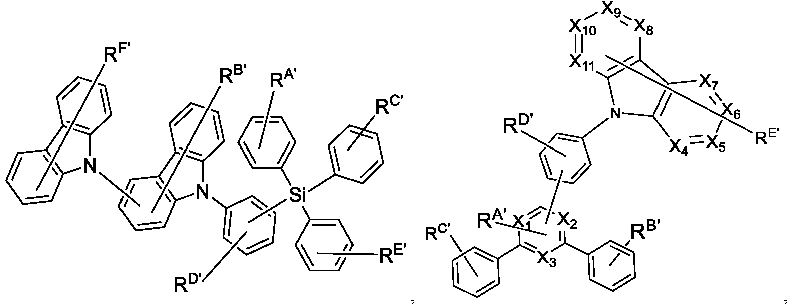 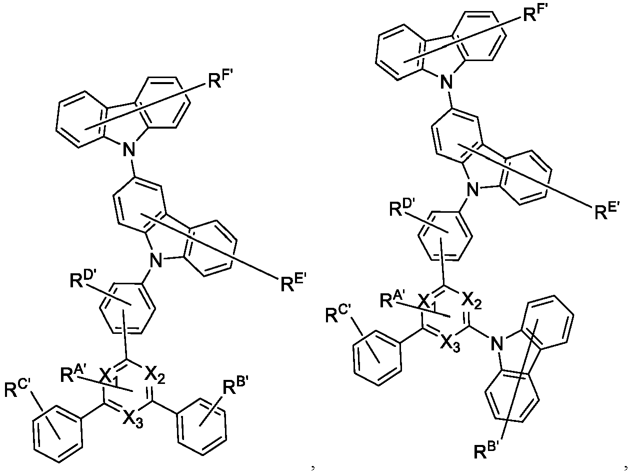 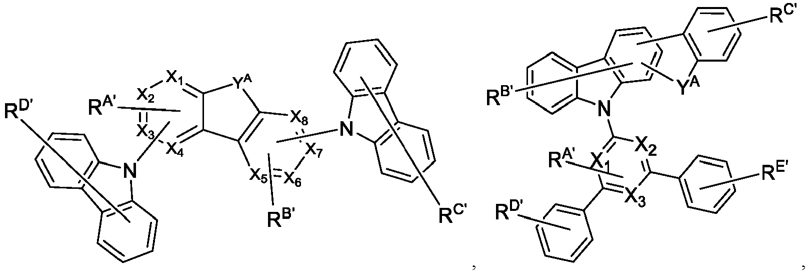 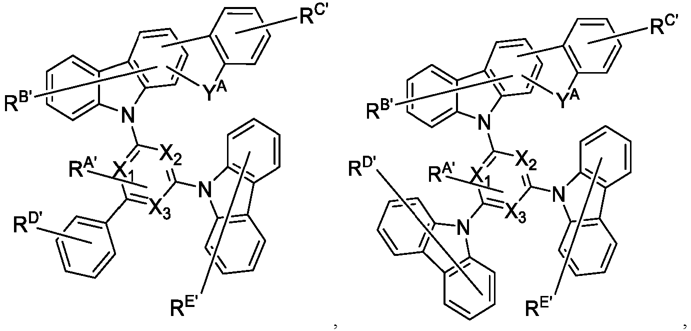 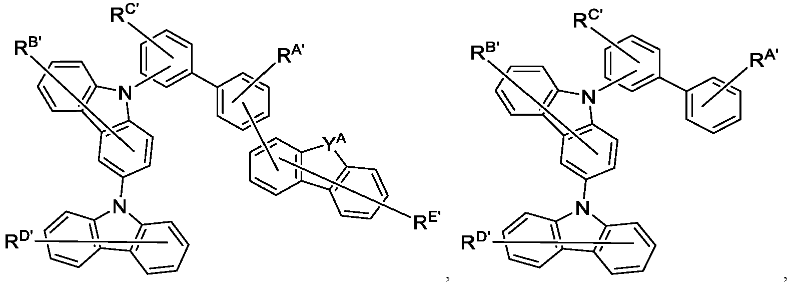 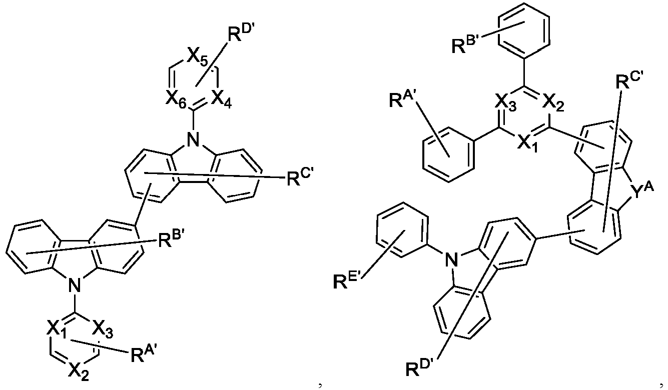 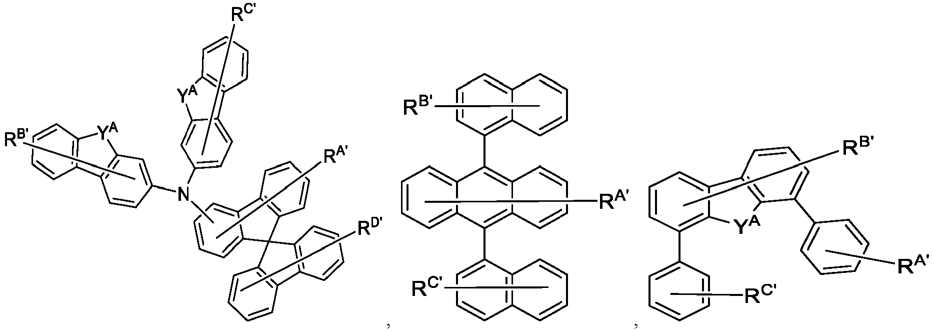 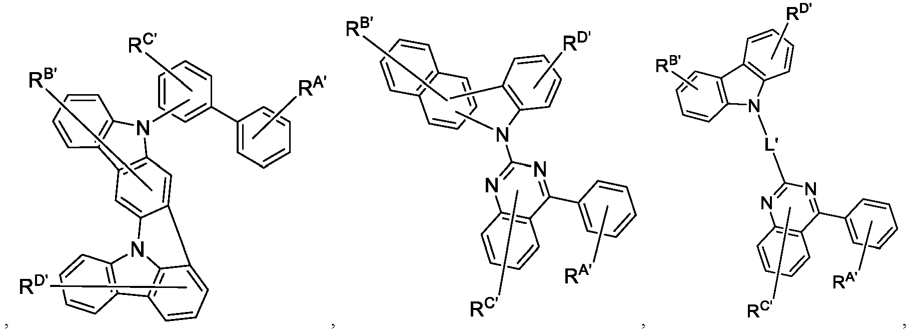 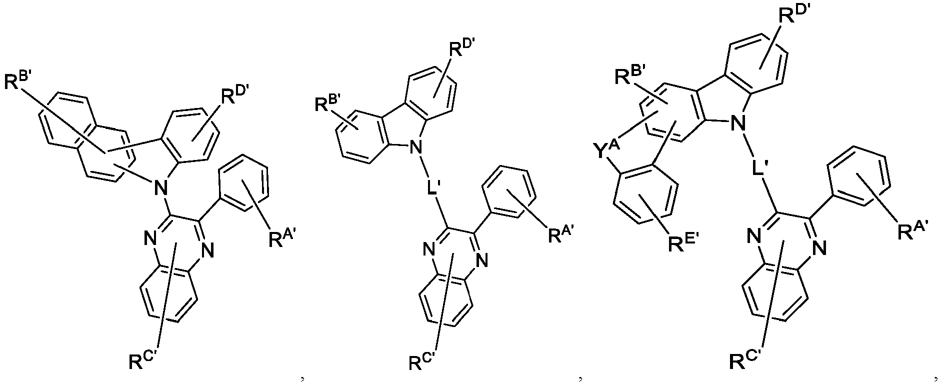 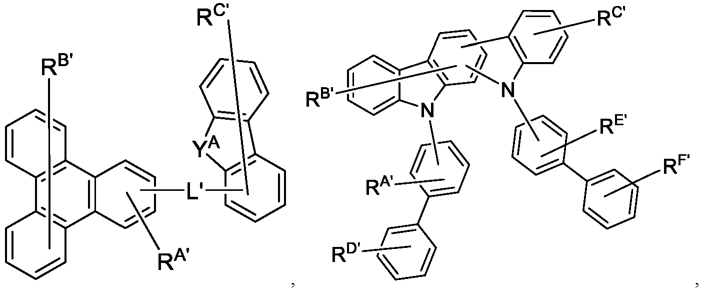 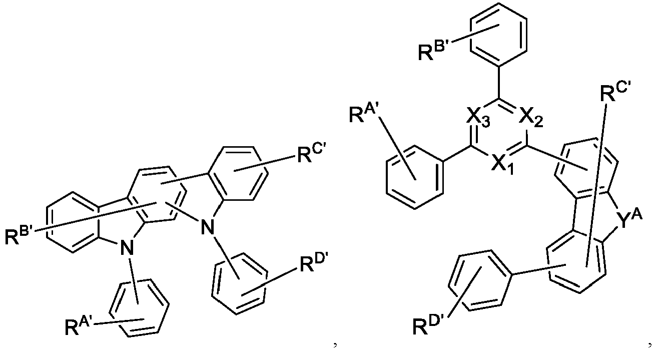 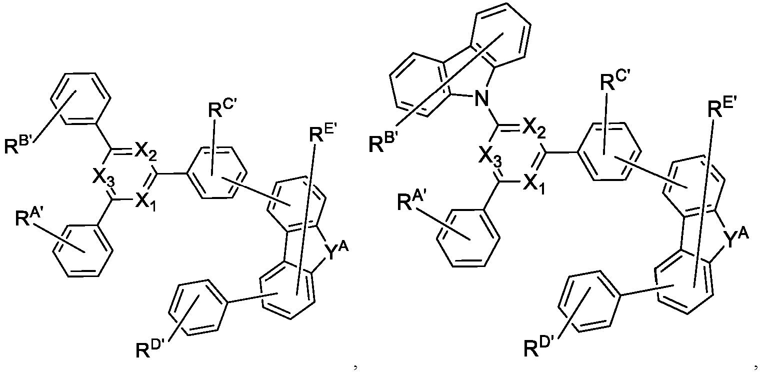 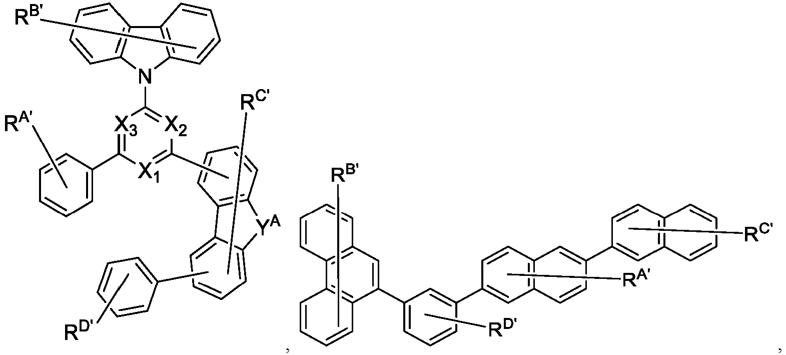 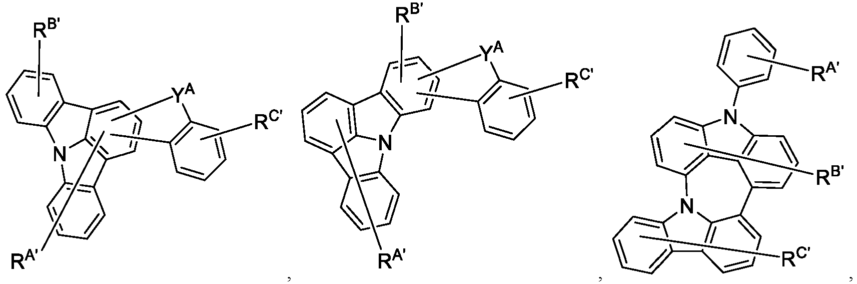 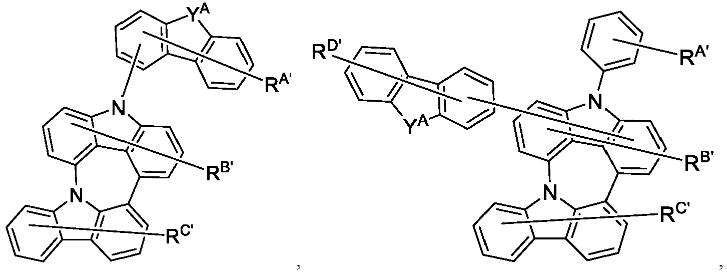 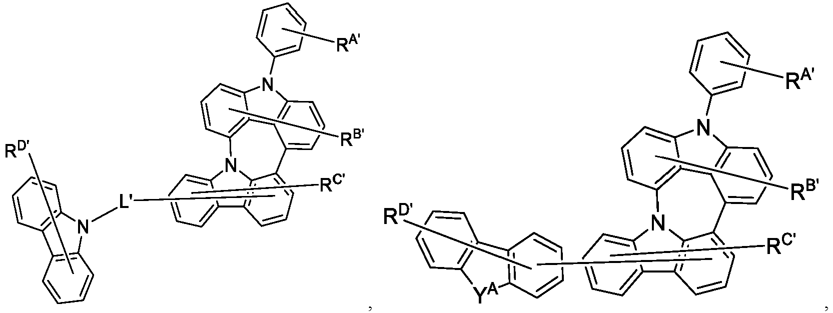 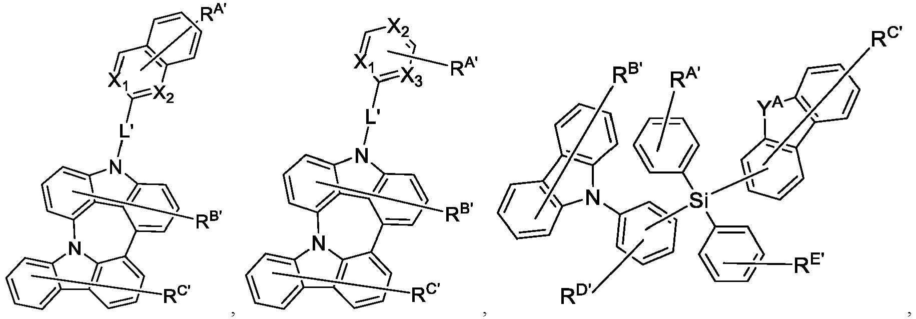 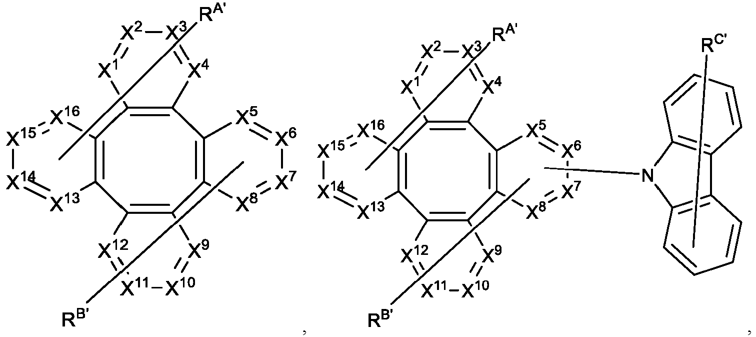 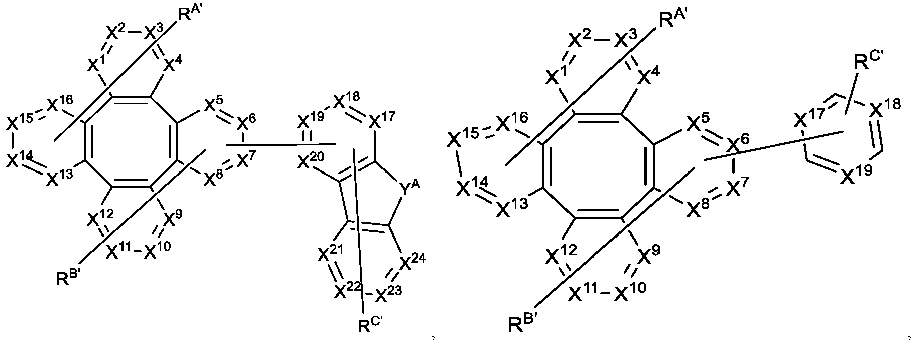 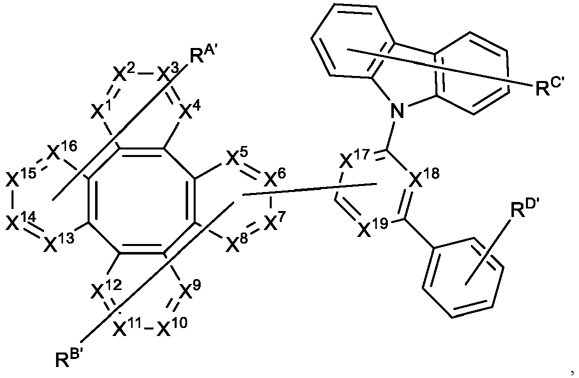 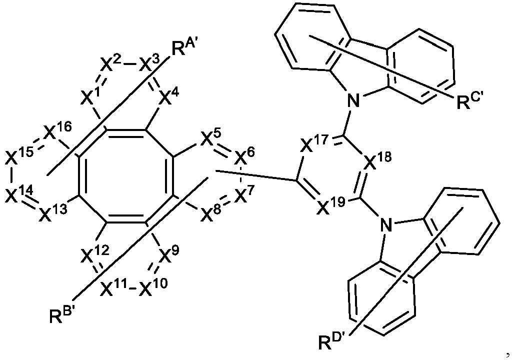 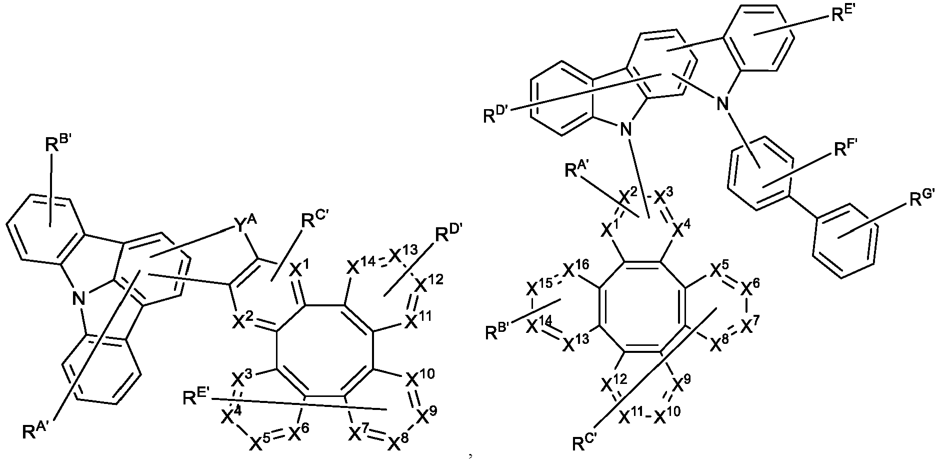 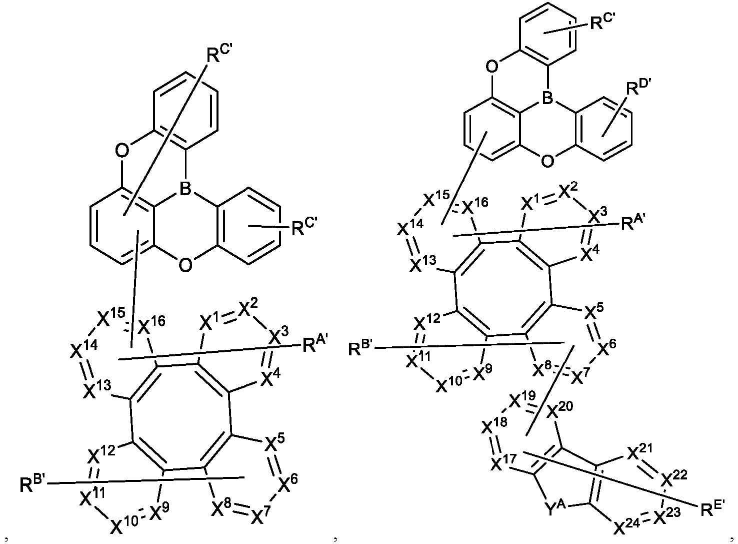 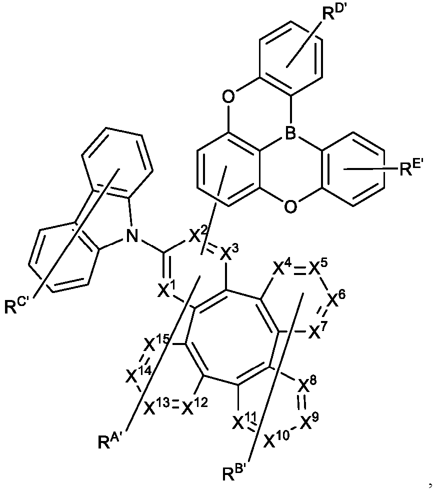 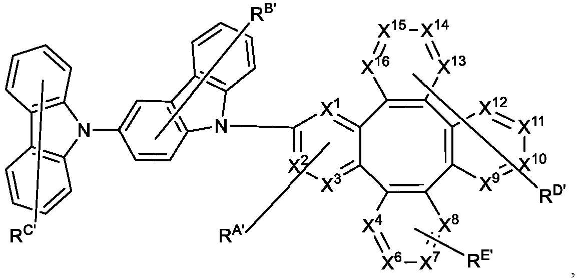 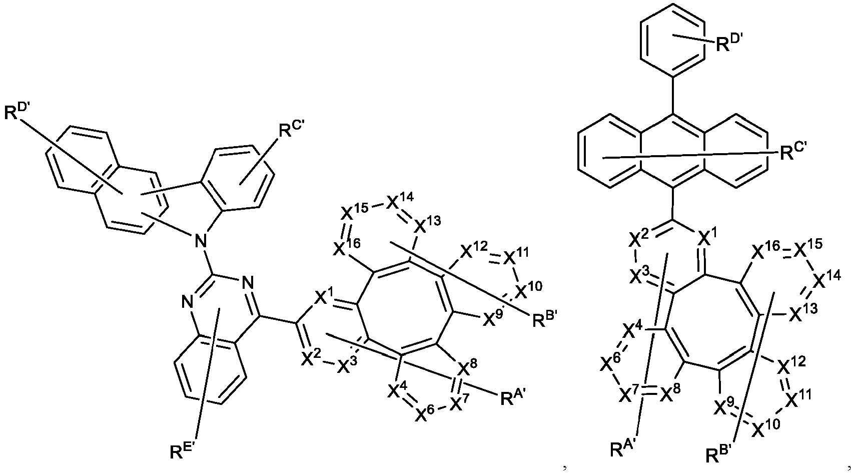 and 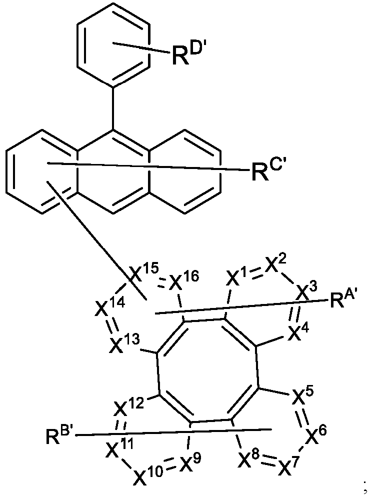 wherein:
each of X¹ to X²⁴ is independently C or N;
L' is a direct bond or an organic linker;
each Y^{A} is independently selected from the group consisting of absent a bond, O, S, Se, CRR', SiRR', GeRR', NR, BR, BRR';
each of R^{A'}, R^{B'}, R^{C'}, R^{D'}, R^{E'}, R^{F'}, and R^{G'} independently represents mono, up to the maximum substitutions, or no substitutions;
each R, R', R^{A'}, R^{B'}, R^{C'}, R^{D'}, R^{E'}, R^{F'}, and R^{G'} is independently a hydrogen or a substituent selected from the group consisting of deuterium, halogen, alkyl, cycloalkyl, heteroalkyl, heterocycloalkyl, arylalkyl, alkoxy, aryloxy, amino, silyl, germyl, selenyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, boryl, and combinations thereof; and
two adjacent of R^{A'}, R^{B'}, R^{C'}, R^{D'}, R^{E'}, R^{F'}, and R^{G'} are optionally joined or fused to form a ring.

In some embodiments, L' is an organic linker selected from the group consisting of BR, BRR', NR, PR, P(O)R, O, S, Se, C=O, C=S, C=Se, C=NR, C= CRR', S=O, SO₂, CR, CRR', SiRR', GeRR', alkylene, cycloalkyl, aryl, cycloalkylene, arylene, heteroarylene, and combinations thereof.

In some embodiments, the host may be selected from the HOST Group 2 consisting of: 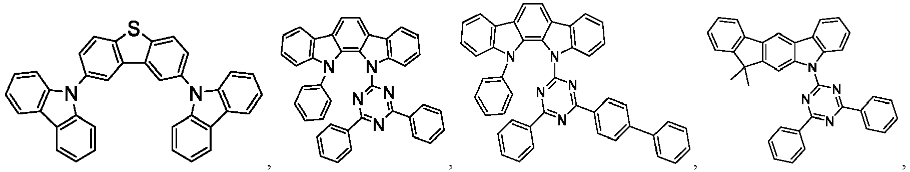 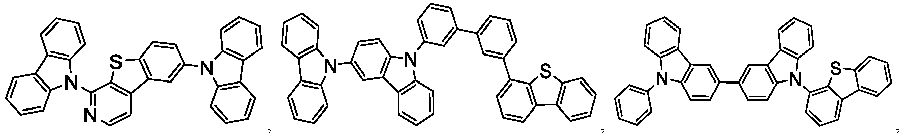 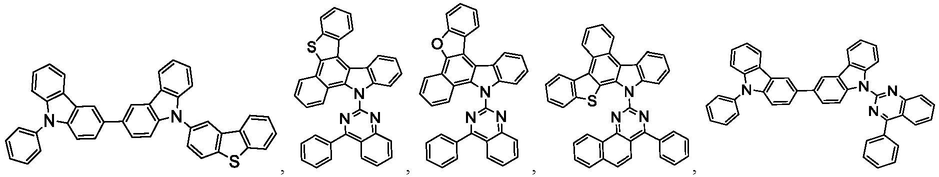 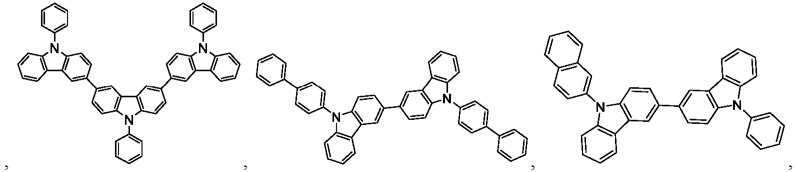 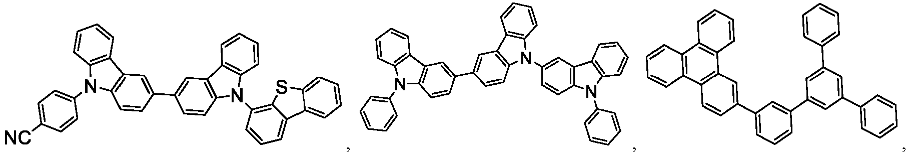 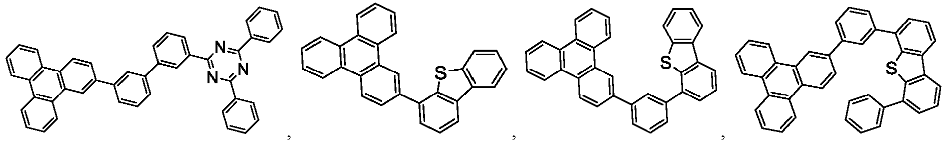 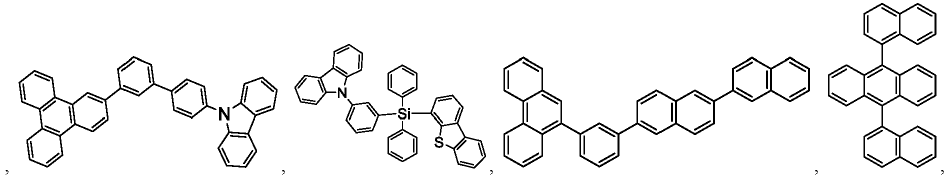 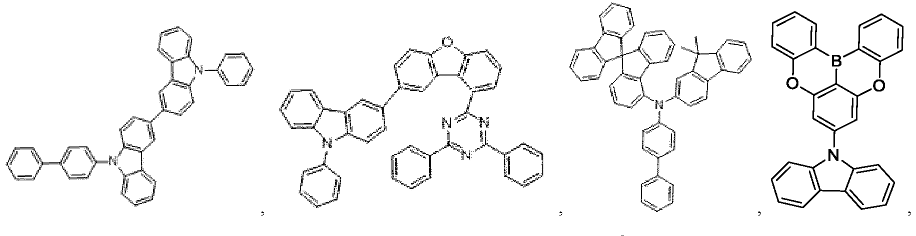 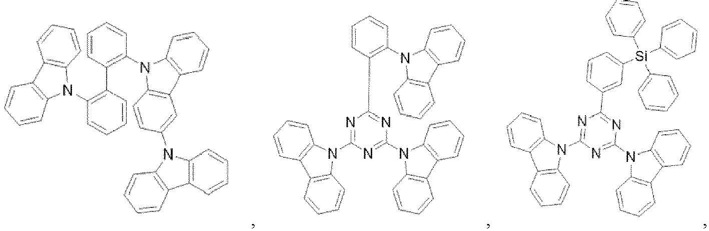 and combinations thereof.

In some embodiments, the organic layer may further comprise a host, wherein the host comprises a metal complex.

In some embodiments, the emissive layer can comprise two hosts, a first host and a second host. In some embodiments, the first host is a hole transporting host, and the second host is an electron transporting host. In some embodiments, the first host and the second host can form an exciplex.

In some embodiments, the compound as described herein may be a sensitizer; wherein the device may further comprise an acceptor; and wherein the acceptor may be selected from the group consisting of fluorescent emitter, delayed fluorescence emitter, and combination thereof.

In yet another aspect, the OLED of the present disclosure may also comprise an emissive region containing a compound as disclosed in the above compounds section of the present disclosure.

In some embodiments, the emissive region can comprise a compound having a first ligand L_{A} of Formula I as described herein.

In some embodiments, at least one of the anode, the cathode, or a new layer disposed over the organic emissive layer functions as an enhancement layer. The enhancement layer comprises a plasmonic material exhibiting surface plasmon resonance that non-radiatively couples to the emitter material and transfers excited state energy from the emitter material to non-radiative mode of surface plasmon polariton. The enhancement layer is provided no more than a threshold distance away from the organic emissive layer, wherein the emitter material has a total non-radiative decay rate constant and a total radiative decay rate constant due to the presence of the enhancement layer and the threshold distance is where the total non-radiative decay rate constant is equal to the total radiative decay rate constant. In some embodiments, the OLED further comprises an outcoupling layer. In some embodiments, the outcoupling layer is disposed over the enhancement layer on the opposite side of the organic emissive layer. In some embodiments, the outcoupling layer is disposed on opposite side of the emissive layer from the enhancement layer but still outcouples energy from the surface plasmon mode of the enhancement layer. The outcoupling layer scatters the energy from the surface plasmon polaritons. In some embodiments this energy is scattered as photons to free space. In other embodiments, the energy is scattered from the surface plasmon mode into other modes of the device such as but not limited to the organic waveguide mode, the substrate mode, or another waveguiding mode. If energy is scattered to the non-free space mode of the OLED other outcoupling schemes could be incorporated to extract that energy to free space. In some embodiments, one or more intervening layer can be disposed between the enhancement layer and the outcoupling layer. The examples for interventing layer(s) can be dielectric materials, including organic, inorganic, perovskites, oxides, and may include stacks and/or mixtures of these materials.

The enhancement layer modifies the effective properties of the medium in which the emitter material resides resulting in any or all of the following: a decreased rate of emission, a modification of emission line - shape, a change in emission intensity with angle, a change in the stability of the emitter material, a change in the efficiency of the OLED, and reduced efficiency roll-off of the OLED device. Placement of the enhancement layer on the cathode side, anode side, or on both sides results in OLED devices which take advantage of any of the above-mentioned effects. In addition to the specific functional layers mentioned herein and illustrated in the various OLED examples shown in the figures, the OLEDs according to the present disclosure may include any of the other functional layers often found in OLEDs.

The enhancement layer can be comprised of plasmonic materials, optically active metamaterials, or hyperbolic metamaterials. As used herein, a plasmonic material is a material in which the real part of the dielectric constant crosses zero in the visible or ultraviolet region of the electromagnetic spectrum. In some embodiments, the plasmonic material includes at least one metal. In such embodiments the metal may include at least one of Ag, Al, Au, Ir, Pt, Ni, Cu, W, Ta, Fe, Cr, Mg, Ga, Rh, Ti, Ru, Pd, In, Bi, Ca alloys or mixtures of these materials, and stacks of these materials. In general, a metamaterial is a medium composed of different materials where the medium as a whole acts differently than the sum of its material parts. In particular, we define optically active metamaterials as materials which have both negative permittivity and negative permeability. Hyperbolic metamaterials, on the other hand, are anisotropic media in which the permittivity or permeability are of different sign for different spatial directions. Optically active metamaterials and hyperbolic metamaterials are strictly distinguished from many other photonic structures such as Distributed Bragg Reflectors ("DBRs") in that the medium should appear uniform in the direction of propagation on the length scale of the wavelength of light. Using terminology that one skilled in the art can understand: the dielectric constant of the metamaterials in the direction of propagation can be described with the effective medium approximation. Plasmonic materials and metamaterials provide methods for controlling the propagation of light that can enhance OLED performance in a number of ways.

In some embodiments, the enhancement layer is provided as a planar layer. In other embodiments, the enhancement layer has wavelength-sized features that are arranged periodically, quasi-periodically, or randomly, or sub-wavelength-sized features that are arranged periodically, quasi-periodically, or randomly. In some embodiments, the wavelength-sized features and the sub-wavelength-sized features have sharp edges.

In some embodiments, the outcoupling layer has wavelength-sized features that are arranged periodically, quasi-periodically, or randomly, or sub-wavelength-sized features that are arranged periodically, quasi-periodically, or randomly. In some embodiments, the outcoupling layer may be composed of a plurality of nanoparticles and in other embodiments the outcoupling layer is composed of a pluraility of nanoparticles disposed over a material. In these embodiments the outcoupling may be tunable by at least one of varying a size of the plurality of nanoparticles, varying a shape of the plurality of nanoparticles, changing a material of the plurality of nanoparticles, adjusting a thickness of the material, changing the refractive index of the material or an additional layer disposed on the plurality of nanoparticles, varying a thickness of the enhancement layer, and/or varying the material of the enhancement layer. The plurality of nanoparticles of the device may be formed from at least one of metal, dielectric material, semiconductor materials, an alloy of metal, a mixture of dielectric materials, a stack or layering of one or more materials, and/or a core of one type of material and that is coated with a shell of a different type of material. In some embodiments, the outcoupling layer is composed of at least metal nanoparticles wherein the metal is selected from the group consisting of Ag, Al, Au, Ir, Pt, Ni, Cu, W, Ta, Fe, Cr, Mg, Ga, Rh, Ti, Ru, Pd, In, Bi, Ca, alloys or mixtures of these materials, and stacks of these materials. The plurality of nanoparticles may have additional layer disposed over them. In some embodiments, the polarization of the emission can be tuned using the outcoupling layer. Varying the dimensionality and periodicity of the outcoupling layer can select a type of polarization that is preferentially outcoupled to air. In some embodiments the outcoupling layer also acts as an electrode of the device.

In yet another aspect, the present disclosure also provides a consumer product comprising an organic light-emitting device (OLED) having an anode; a cathode; and an organic layer disposed between the anode and the cathode, wherein the organic layer may comprise a compound as disclosed in the above compounds section of the present disclosure.

In some embodiments, the consumer product comprises an OLED having an anode; a cathode; and an organic layer disposed between the anode and the cathode, wherein the organic layer may comprise a compound having a first ligand L_{A} of Formula I as described herein.

In some embodiments, the consumer product can be one of a flat panel display, a computer monitor, a medical monitor, a television, a billboard, a light for interior or exterior illumination and/or signaling, a heads-up display, a fully or partially transparent display, a flexible display, a laser printer, a telephone, a cell phone, tablet, a phablet, a personal digital assistant (PDA), a wearable device, a laptop computer, a digital camera, a camcorder, a viewfinder, a micro-display that is less than 2 inches diagonal, a 3-D display, a virtual reality or augmented reality display, a vehicle, a video wall comprising multiple displays tiled together, a theater or stadium screen, a light therapy device, and a sign.

Generally, an OLED comprises at least one organic layer disposed between and electrically connected to an anode and a cathode. When a current is applied, the anode injects holes and the cathode injects electrons into the organic layer(s). The injected holes and electrons each migrate toward the oppositely charged electrode. When an electron and hole localize on the same molecule, an "exciton," which is a localized electron-hole pair having an excited energy state, is formed. Light is emitted when the exciton relaxes via a photoemissive mechanism. In some cases, the exciton may be localized on an excimer or an exciplex. Non-radiative mechanisms, such as thermal relaxation, may also occur, but are generally considered undesirable.

Several OLED materials and configurations are described in U.S. Pat. Nos. 5,844,363, 6,303,238, and 5,707,745

The initial OLEDs used emissive molecules that emitted light from their singlet states ("fluorescence") as disclosed, for example, in U.S. Pat. No. 4,769,292. Fluorescent emission generally occurs in a time frame of less than 10 nanoseconds.

More recently, OLEDs having emissive materials that emit light from triplet states ("phosphorescence") have been demonstrated. Baldo et al., "Highly Efficient Phosphorescent Emission from Organic Electroluminescent Devices," Nature, vol. 395, 151-154, 1998; ("Baldo-I") and Baldo et al., "Very high-efficiency green organic light-emitting devices based on electrophosphorescence," Appl. Phys. Lett., vol. 75, No. 3, 4-6 (1999) ("Baldo-II). Phosphorescence is described in more detail in U.S. Pat. No. 7,279,704 at cols. 5-6.

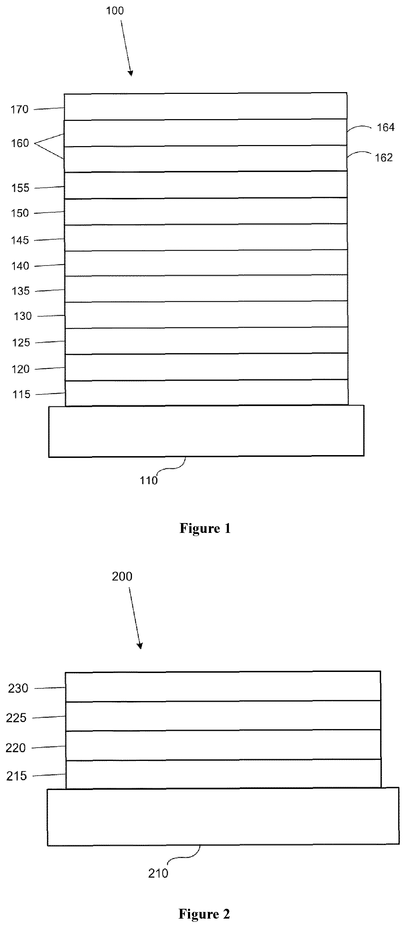

FIG. 1 shows an organic light emitting device 100. The figures are not necessarily drawn to scale. Device 100 may include a substrate 110, an anode 115, a hole injection layer 120, a hole transport layer 125, an electron blocking layer 130, an emissive layer 135, a hole blocking layer 140, an electron transport layer 145, an electron injection layer 150, a protective layer 155, a cathode 160, and a barrier layer 170. Cathode 160 is a compound cathode having a first conductive layer 162 and a second conductive layer 164. Device 100 may be fabricated by depositing the layers described, in order. The properties and functions of these various layers, as well as example materials, are described in more detail in US 7,279,704 at cols. 6-10.

More examples for each of these layers are available. For example, a flexible and transparent substrate-anode combination is disclosed in U.S. Pat. No. 5,844,363, which is incorporated by reference in its entirety. An example of a p-doped hole transport layer is m-MTDATA doped with F₄-TCNQ at a molar ratio of 50:1, as disclosed in U.S. Patent Application Publication No. 2003/0230980. Examples of emissive and host materials are disclosed in U.S. Pat. No. 6,303,238 to Thompson et al. An example of an n-doped electron transport layer is BPhen doped with Li at a molar ratio of 1:1, as disclosed in U.S. Patent Application Publication No. 2003/0230980. U.S. Pat. Nos. 5,703,436 and 5,707,745 disclose examples of cathodes including compound cathodes having a thin layer of metal such as Mg:Ag with an overlying transparent, electrically -conductive, sputter-deposited ITO layer. The theory and use of blocking layers is described in more detail in U.S. Pat. No. 6,097,147 and U.S. Patent Application Publication No. 2003/0230980. of injection layers are provided in U.S. Patent Application Publication No 2004/017416. A description of protective layers may be found in U.S. Patent Application Publication No. 2004/017416.

FIG. 2 shows an inverted OLED 200. The device includes a substrate 210, a cathode 215, an emissive layer 220, a hole transport layer 225, and an anode 230. Device 200 may be fabricated by depositing the layers described, in order. Because the most common OLED configuration has a cathode disposed over the anode, and device 200 has cathode 215 disposed under anode 230, device 200 may be referred to as an "inverted" OLED. Materials similar to those described with respect to device 100 may be used in the corresponding layers of device 200. FIG. 2 provides one example of how some layers may be omitted from the structure of device 100.

The simple layered structure illustrated in FIGS. 1 and 2 is provided by way of non-limiting example, and it is understood that embodiments of the present disclosure may be used in connection with a wide variety of other structures. The specific materials and structures described are exemplary in nature, and other materials and structures may be used. Functional OLEDs may be achieved by combining the various layers described in different ways, or layers may be omitted entirely, based on design, performance, and cost factors. Other layers not specifically described may also be included. Materials other than those specifically described may be used. Although many of the examples provided herein describe various layers as comprising a single material, it is understood that combinations of materials, such as a mixture of host and dopant, or more generally a mixture, may be used. Also, the layers may have various sublayers. The names given to the various layers herein are not intended to be strictly limiting. For example, in device 200, hole transport layer 225 transports holes and injects holes into emissive layer 220, and may be described as a hole transport layer or a hole injection layer. In one embodiment, an OLED may be described as having an "organic layer" disposed between a cathode and an anode. This organic layer may comprise a single layer, or may further comprise multiple layers of different organic materials as described, for example, with respect to FIGS. 1 and 2.

Structures and materials not specifically described may also be used, such as OLEDs comprised of polymeric materials (PLEDs) such as disclosed in U.S. Pat. No. 5,247,190 to Friend et al. By way of further example, OLEDs having a single organic layer may be used OLEDs may be stacked, for example as described in U.S. Pat. No. 5,707,745 to Forrest et al. OLED structure may deviate from the simple layered structure illustrated in FIGS. 1 and 2. For example, the substrate may include an angled reflective surface to improve outcoupling, such as a mesa structure as described in U.S. Pat. No. 6,091,195 to Forrest et al., and/or a pit structure as described in U.S. Pat. No. 5,834,893 to Bulovic et al.

Unless otherwise specified, any of the layers of the various embodiments may be deposited by any suitable method. For the organic layers, preferred methods include thermal evaporation, ink-jet, such as described in U.S. Pat. Nos. 6,013,982 and 6,087,196, organic vapor phase deposition (OVPD), such as described in U.S. Pat. No. 6,337,102 to Forrest et al., and deposition by organic vapor jet printing (OVJP, also referred to as organic vapor jet deposition (OVJD)), such as described in U.S. Pat. No. 7,431,968. Other suitable deposition methods include spin coating and other solution based processes. Solution based processes are preferably carried out in nitrogen or an inert atmosphere. For the other layers, preferred methods include thermal evaporation. Preferred patterning methods include deposition through a mask, cold welding such as described in U.S. Pat. Nos. 6,294,398 and 6,468,819, and patterning associated with some of the deposition methods such as ink-jet and organic vapor jet printing (OVJP). Other methods may also be used. The materials to be deposited may be modified to make them compatible with a particular deposition method. For example, substituents such as alkyl and aryl groups, branched or unbranched, and preferably containing at least 3 carbons, may be used in small molecules to enhance their ability to undergo solution processing. Substituents having 20 carbons or more may be used, and 3-20 carbons are a preferred range. Materials with asymmetric structures may have better solution processability than those having symmetric structures, because asymmetric materials may have a lower tendency to recrystallize. Dendrimer substituents may be used to enhance the ability of small molecules to undergo solution processing.

Devices fabricated in accordance with embodiments of the present disclosure may further optionally comprise a barrier layer. One purpose of the barrier layer is to protect the electrodes and organic layers from damaging exposure to harmful species in the environment including moisture, vapor and/or gases, etc. The barrier layer may be deposited over, under or next to a substrate, an electrode, or over any other parts of a device including an edge. The barrier layer may comprise a single layer, or multiple layers. The barrier layer may be formed by various known chemical vapor deposition techniques and may include compositions having a single phase as well as compositions having multiple phases. Any suitable material or combination of materials may be used for the barrier layer. The barrier layer may incorporate an inorganic or an organic compound or both. The preferred barrier layer comprises a mixture of a polymeric material and a non-polymeric material as described in U.S. Pat. No. 7,968,146, PCT Pat. Application Nos. PCT/US2007/023098 and PCT/US2009/04829. To be considered a "mixture", the aforesaid polymeric and non-polymeric materials comprising the barrier layer should be deposited under the same reaction conditions and/or at the same time. The weight ratio of polymeric to non-polymeric material may be in the range of 95:5 to 5:95. The polymeric material and the non-polymeric material may be created from the same precursor material. In one example, the mixture of a polymeric material and a non-polymeric material consists essentially of polymeric silicon and inorganic silicon.

Devices fabricated in accordance with embodiments of the present disclosure can be incorporated into a wide variety of electronic component modules (or units) that can be incorporated into a variety of electronic products or intermediate components. Examples of such electronic products or intermediate components include display screens, lighting devices such as discrete light source devices or lighting panels, etc. that can be utilized by the end-user product manufacturers. Such electronic component modules can optionally include the driving electronics and/or power source(s). Devices fabricated in accordance with embodiments of the present disclosure can be incorporated into a wide variety of consumer products that have one or more of the electronic component modules (or units) incorporated therein. A consumer product comprising an OLED that includes the compound of the present disclosure in the organic layer in the OLED is disclosed. Such consumer products would include any kind of products that include one or more light source(s) and/or one or more of some type of visual displays. Some examples of such consumer products include flat panel displays, curved displays, computer monitors, medical monitors, televisions, billboards, lights for interior or exterior illumination and/or signaling, heads-up displays, fully or partially transparent displays, flexible displays, rollable displays, foldable displays, stretchable displays, laser printers, telephones, mobile phones, tablets, phablets, personal digital assistants (PDAs), wearable devices, laptop computers, digital cameras, camcorders, viewfinders, micro-displays (displays that are less than 2 inches diagonal), 3-D displays, virtual reality or augmented reality displays, vehicles, video walls comprising multiple displays tiled together, theater or stadium screen, a light therapy device, and a sign. Various control mechanisms may be used to control devices fabricated in accordance with the present disclosure, including passive matrix and active matrix. Many of the devices are intended for use in a temperature range comfortable to humans, such as 18 degrees C. to 30 degrees C., and more preferably at room temperature (20-25 °C), but could be used outside this temperature range, for example, from -40 degree C to + 80 °C.

More details on OLEDs, and the definitions described above, can be found in U.S. Pat. No 7,279,704.

The materials and structures described herein may have applications in devices other than OLEDs. For example, other optoelectronic devices such as organic solar cells and organic photodetectors may employ the materials and structures. More generally, organic devices, such as organic transistors, may employ the materials and structures.

In some embodiments, the OLED has one or more characteristics selected from the group consisting of being flexible, being rollable, being foldable, being stretchable, and being curved. In some embodiments, the OLED is transparent or semi-transparent. In some embodiments, the OLED further comprises a layer comprising carbon nanotubes.

In some embodiments, the OLED further comprises a layer comprising a delayed fluorescent emitter. In some embodiments, the OLED comprises a RGB pixel arrangement or white plus color filter pixel arrangement. In some embodiments, the OLED is a mobile device, a hand held device, or a wearable device. In some embodiments, the OLED is a display panel having less than 10 inch diagonal or 50 square inch area. In some embodiments, the OLED is a display panel having at least 10 inch diagonal or 50 square inch area. In some embodiments, the OLED is a lighting panel.

In some embodiments, the compound can be an emissive dopant. In some embodiments, the compound can produce emissions via phosphorescence, fluorescence, thermally activated delayed fluorescence, i.e., TADF (also referred to as E-type delayed fluorescence; *see, e.g.*, U.S. Application No. 15/700,352), triplet-triplet annihilation, or combinations of these processes In some embodiments, the emissive dopant can be a racemic mixture, or can be enriched in one enantiomer. In some embodiments, the compound can be homoleptic (each ligand is the same). In some embodiments, the compound can be heteroleptic (at least one ligand is different from others). When there are more than one ligand coordinated to a metal, the ligands can all be the same in some embodiments. In some other embodiments, at least one ligand is different from the other ligands. In some embodiments, every ligand can be different from each other. This is also true in embodiments where a ligand being coordinated to a metal can be linked with other ligands being coordinated to that metal to form a tridentate, tetradentate, pentadentate, or hexadentate ligands. Thus, where the coordinating ligands are being linked together, all of the ligands can be the same in some embodiments, and at least one of the ligands being linked can be different from the other ligand(s) in some other embodiments.

In some embodiments, the compound can be used as a phosphorescent sensitizer in an OLED where one or multiple layers in the OLED contains an acceptor in the form of one or more fluorescent and/or delayed fluorescence emitters. In some embodiments, the compound can be used as one component of an exciplex to be used as a sensitizer. As a phosphorescent sensitizer, the compound must be capable of energy transfer to the acceptor and the acceptor will emit the energy or further transfer energy to a final emitter. The acceptor concentrations can range from 0.001% to 100%. The acceptor could be in either the same layer as the phosphorescent sensitizer or in one or more different layers. In some embodiments, the acceptor is a TADF emitter. In some embodiments, the acceptor is a fluorescent emitter. In some embodiments, the emission can arise from any or all of the sensitizer, acceptor, and final emitter.

According to another aspect, a formulation comprising the compound described herein is also disclosed.

The OLED disclosed herein can be incorporated into one or more of a consumer product, an electronic component module, and a lighting panel. The organic layer can be an emissive layer and the compound can be an emissive dopant in some embodiments, while the compound can be a non-emissive dopant in other embodiments.

In yet another aspect of the present disclosure, a formulation that comprises the novel compound disclosed herein is described. The formulation can include one or more components selected from the group consisting of a solvent, a host, a hole injection material, hole transport material, electron blocking material, hole blocking material, and an electron transport material, disclosed herein.

The present disclosure encompasses any chemical structure comprising the novel compound of the present disclosure, or a monovalent or polyvalent variant thereof. In other words, the inventive compound, or a monovalent or polyvalent variant thereof, can be a part of a larger chemical structure. Such chemical structure can be selected from the group consisting of a monomer, a polymer, a macromolecule, and a supramolecule (also known as supermolecule). As used herein, a "monovalent variant of a compound" refers to a moiety that is identical to the compound except that one hydrogen has been removed and replaced with a bond to the rest of the chemical structure. As used herein, a "polyvalent variant of a compound" refers to a moiety that is identical to the compound except that more than one hydrogen has been removed and replaced with a bond or bonds to the rest of the chemical structure. In the instance of a supramolecule, the inventive compound can also be incorporated into the supramolecule complex without covalent bonds.

### D. Combination of the Compounds of the Present Disclosure with Other Materials

The materials described herein as useful for a particular layer in an organic light emitting device may be used in combination with a wide variety of other materials present in the device. For example, emissive dopants disclosed herein may be used in conjunction with a wide variety of hosts, transport layers, blocking layers, injection layers, electrodes and other layers that may be present. The materials described or referred to below are non-limiting examples of materials that may be useful in combination with the compounds disclosed herein, and one of skill in the art can readily consult the literature to identify other materials that may be useful in combination.

### a) Conductivity Dopants:

A charge transport layer can be doped with conductivity dopants to substantially alter its density of charge carriers, which will in turn alter its conductivity. The conductivity is increased by generating charge carriers in the matrix material, and depending on the type of dopant, a change in the Fermi level of the semiconductor may also be achieved. Hole-transporting layer can be doped by p-type conductivity dopants and n-type conductivity dopants are used in the electron-transporting layer.

Non-limiting examples of the conductivity dopants that may be used in an OLED in combination with materials disclosed herein are exemplified below together with references that disclose those materials: EP01617493, EP01968131, EP2020694, EP2684932, US20050139810, US20070160905, US20090167167, US2010288362, WO06081780, WO2009003455, WO2009008277, WO2009011327, WO2014009310, US2007252140, US2015060804, US20150123047, and US2012146012.

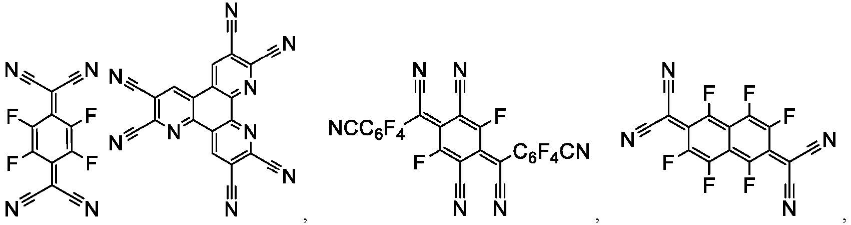

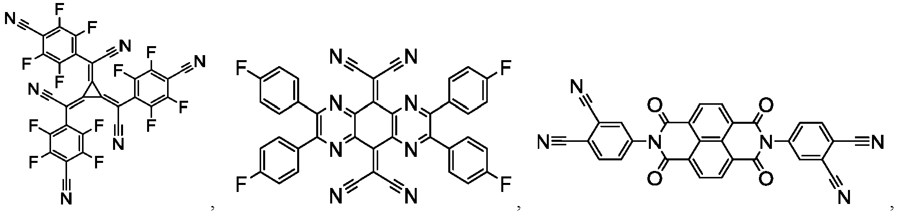

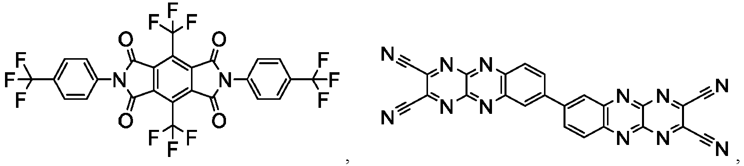

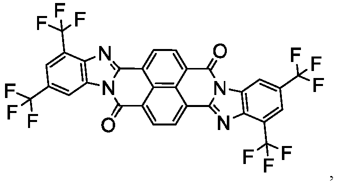

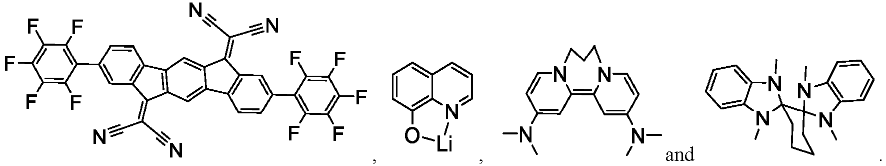

### b) HIL/HTL:

A hole injecting/transporting material to be used in the present disclosure is not particularly limited, and any compound may be used as long as the compound is typically used as a hole injecting/transporting material. Examples of the material include, but are not limited to: a phthalocyanine or porphyrin derivative; an aromatic amine derivative; an indolocarbazole derivative; a polymer containing fluorohydrocarbon; a polymer with conductivity dopants; a conducting polymer, such as PEDOT/PSS; a self-assembly monomer derived from compounds such as phosphonic acid and silane derivatives; a metal oxide derivative, such as MoOₓ; a p-type semiconducting organic compound, such as 1,4,5,8,9,12-Hexaazatriphenylenehexacarbonitrile; a metal complex, and a cross-linkable compounds.

Examples of aromatic amine derivatives used in HIL or HTL include, but not limit to the following general structures:

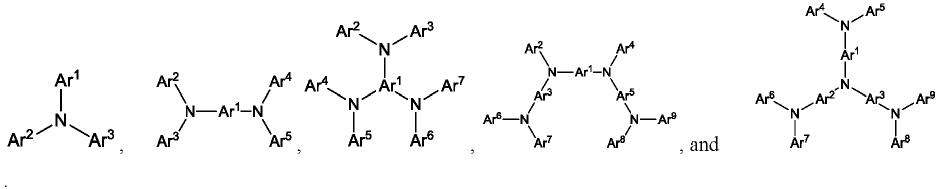

Each of Ar¹ to Ar⁹ is selected from the group consisting of aromatic hydrocarbon cyclic compounds such as benzene, biphenyl, triphenyl, triphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each Ar may be unsubstituted or may be substituted by a substituent selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof.

In one aspect, Ar¹ to Ar⁹ is independently selected from the group consisting of: 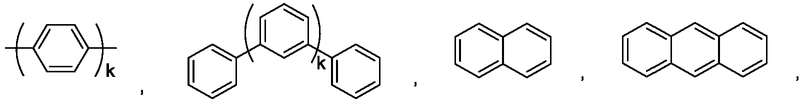 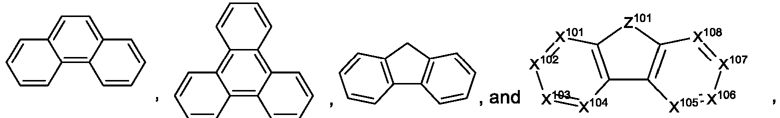 wherein k is an integer from 1 to 20; X¹⁰¹ to X¹⁰⁸ is C (including CH) or N; Z¹⁰¹ is NAr¹, O, or S; Ar¹ has the same group defined above.

Examples of metal complexes used in HIL or HTL include, but are not limited to the following general formula: 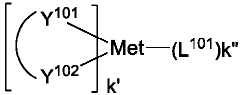 wherein Met is a metal, which can have an atomic weight greater than 40; (Y¹⁰¹-Y¹⁰²) is a bidentate ligand, Y¹⁰¹ and Y¹⁰² are independently selected from C, N, O, P, and S; L¹⁰¹ is an ancillary ligand; k' is an integer value from 1 to the maximum number of ligands that may be attached to the metal; and k'+k" is the maximum number of ligands that may be attached to the metal.

In one aspect, (Y¹⁰¹-Y¹⁰²) is a 2-phenylpyridine derivative. In another aspect, (Y¹⁰¹-Y¹⁰²) is a carbene ligand. In another aspect, Met is selected from Ir, Pt, Os, and Zn. In a further aspect, the metal complex has a smallest oxidation potential in solution vs. Fc⁺/Fe couple less than about 0.6 V.

Non-limiting examples of the HIL and HTL materials that may be used in an OLED in combination with materials disclosed herein are exemplified below together with references that disclose those materials: CN102702075, DE102012005215, EP01624500, EP01698613, EP01806334, EP01930964, EP01972613, EP01997799, EP02011790, EP02055700, EP02055701, EP1725079, EP2085382, EP2660300, EP650955, JP07-073529, JP2005112765, JP2007091719, JP2008021687, JP2014-009196, KR20110088898, KR20130077473, TW201139402, US06517957, US20020158242, US20030162053, US20050123751, US20060182993, US20060240279, US20070145888, US20070181874, US20070278938, US20080014464, US20080091025, US20080106190, US20080124572, US20080145707, US20080220265, US20080233434, US20080303417, US2008107919, US20090115320, US20090167161, US2009066235, US2011007385, US20110163302, US2011240968, US2011278551, US2012205642, US2013241401, US20140117329, US2014183517, US5061569, US5639914, WO05075451, WO07125714, WO08023550, WO08023759, WO2009145016, WO2010061824, WO2011075644, WO2012177006, WO2013018530, WO2013039073, WO2013087142, WO2013118812, WO2013120577, WO2013157367, WO2013175747, WO2014002873, WO2014015935, WO2014015937, WO2014030872, WO2014030921, WO2014034791, WO2014104514, WO2014157018. 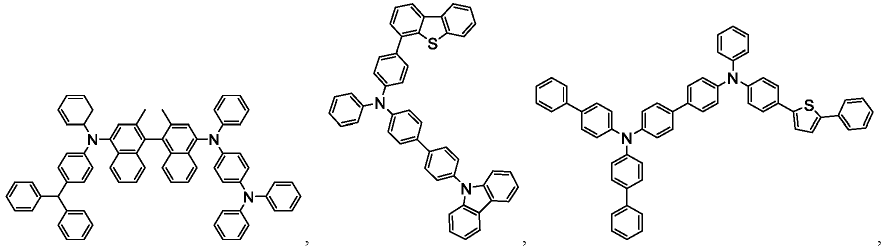 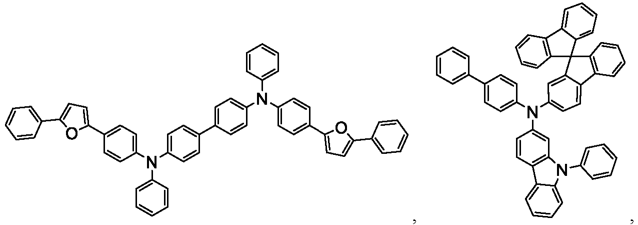 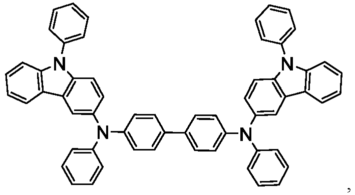 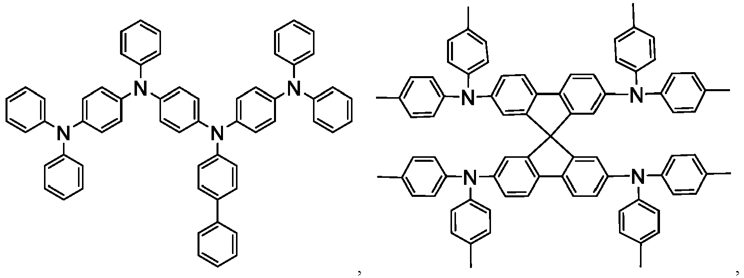 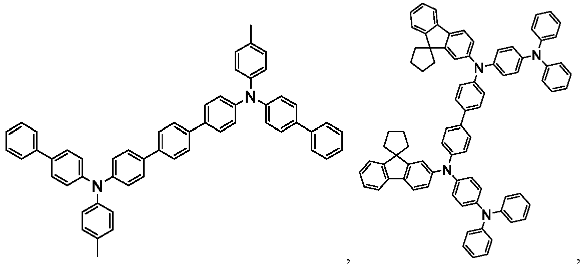 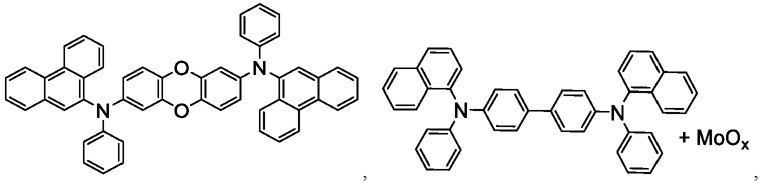 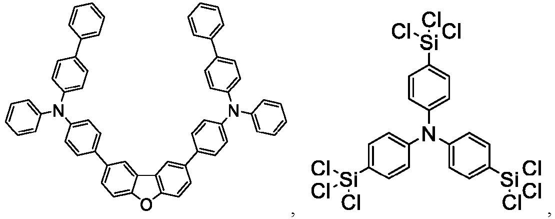 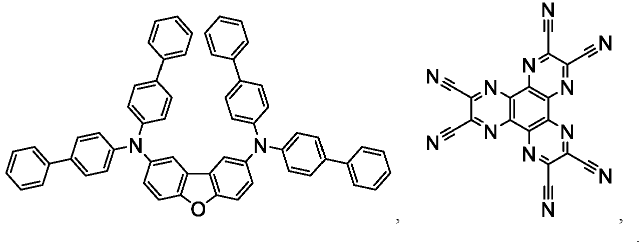 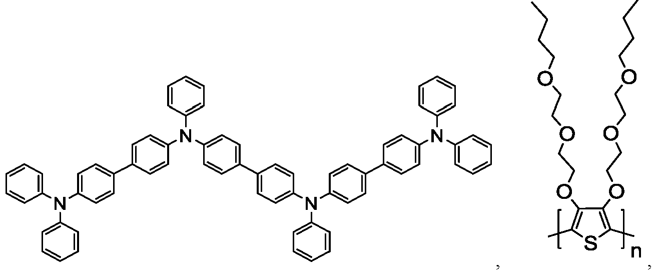 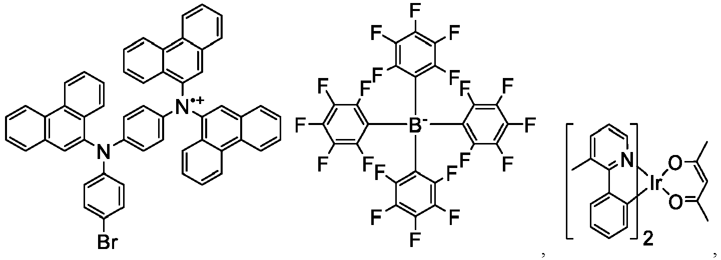 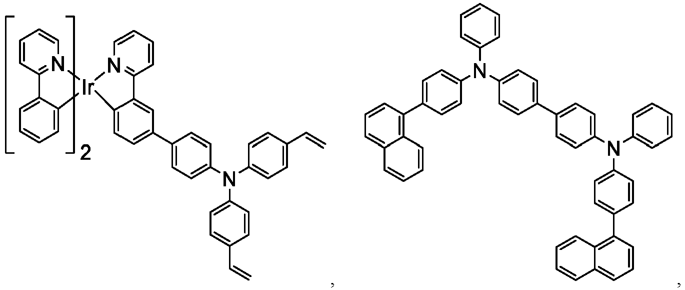 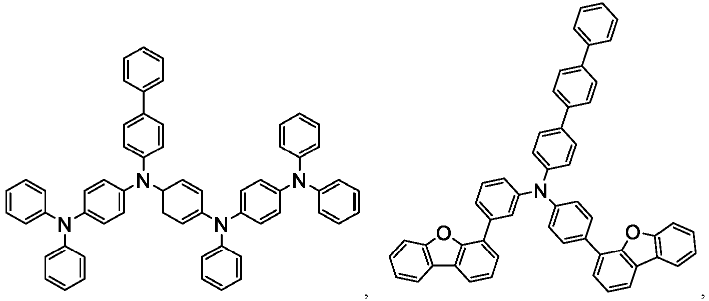 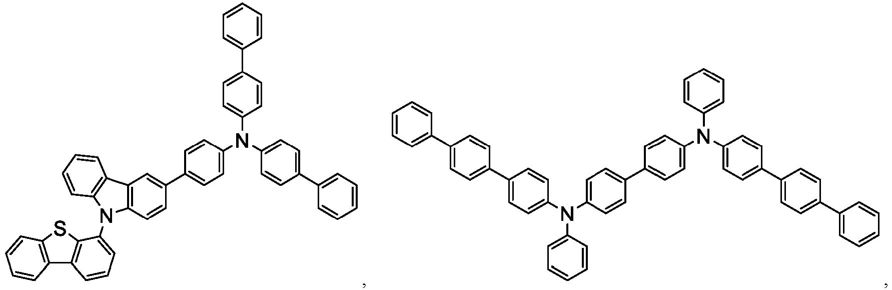 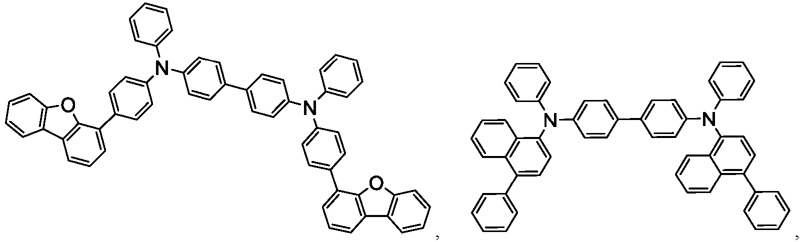 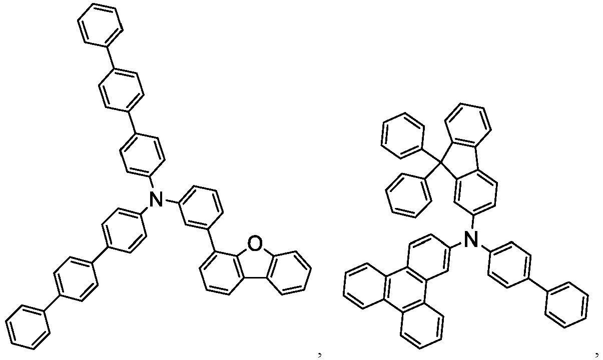 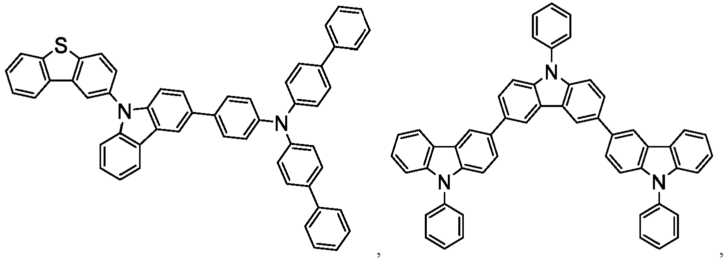 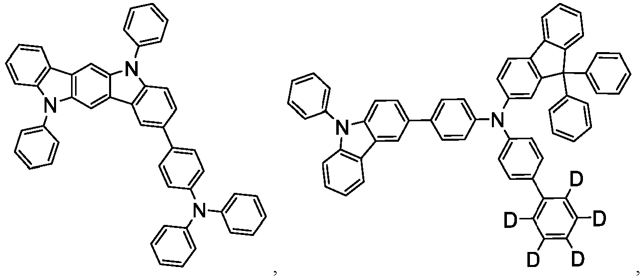 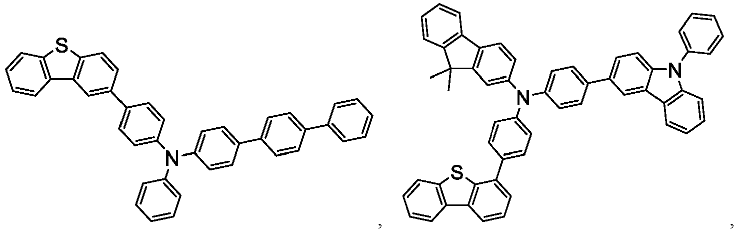 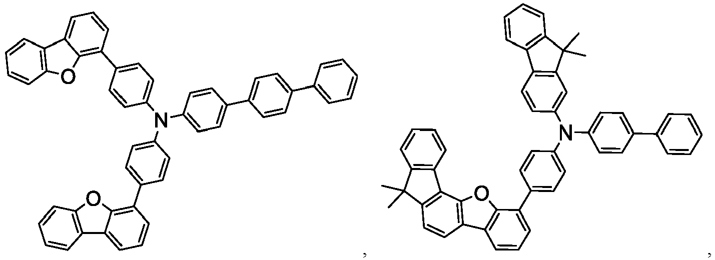 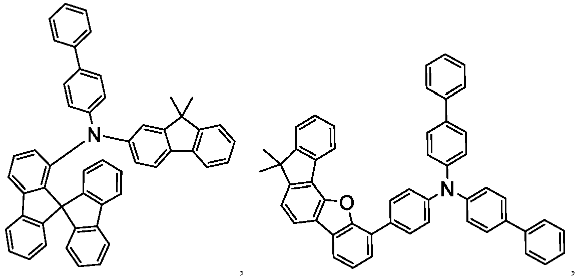 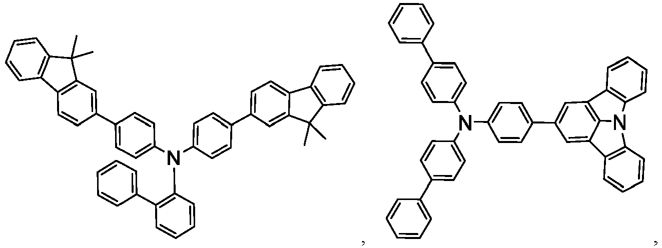 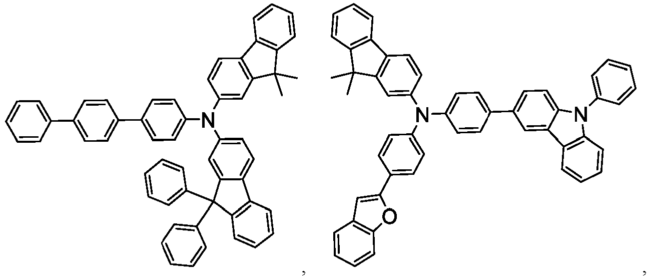 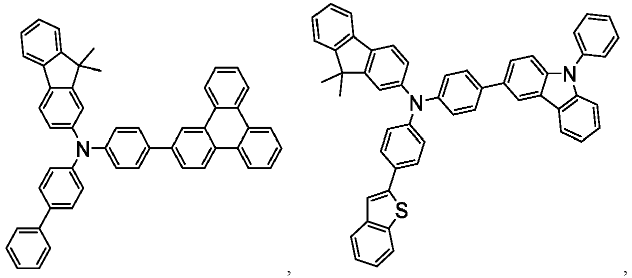 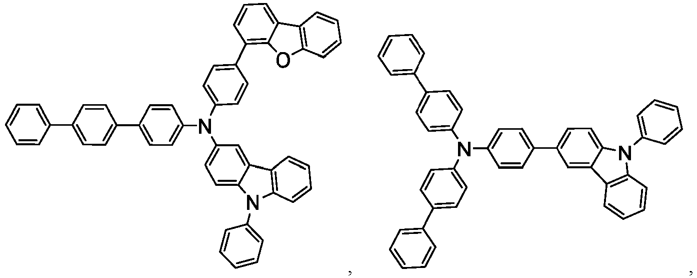 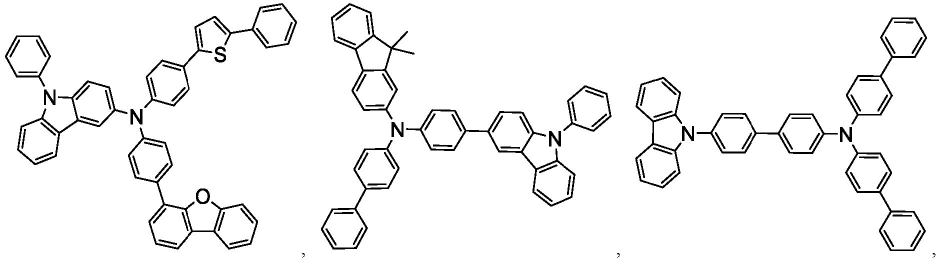 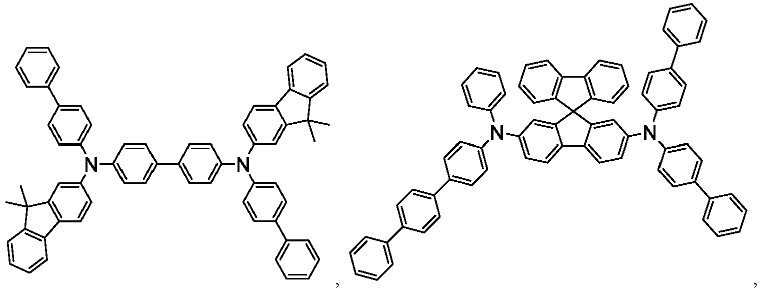 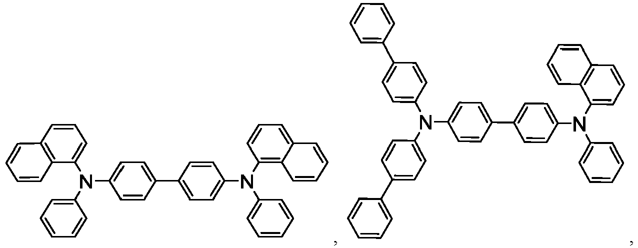 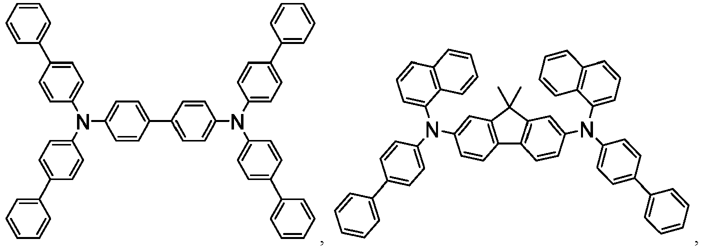 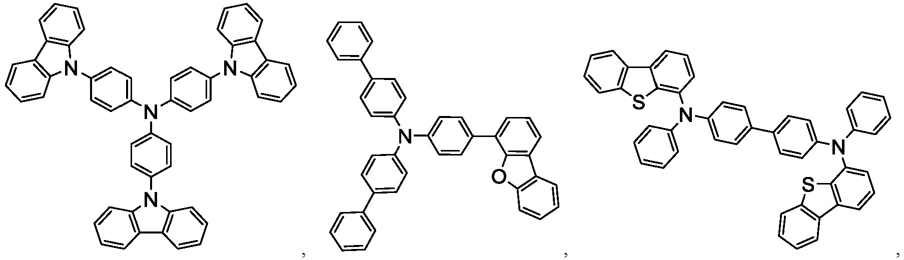 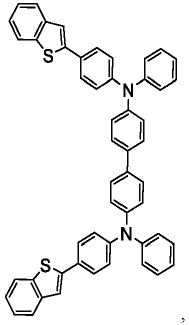 and

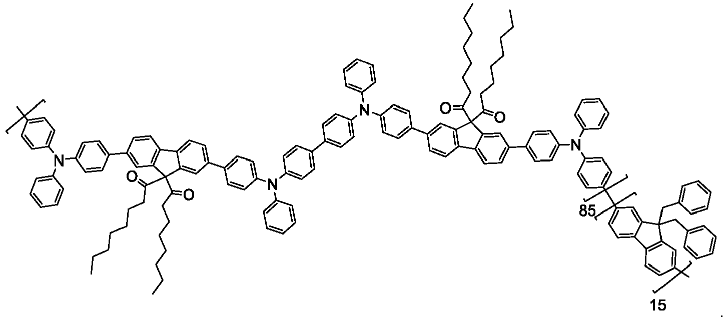

### c) EBL:

An electron blocking layer (EBL) may be used to reduce the number of electrons and/or excitons that leave the emissive layer. The presence of such a blocking layer in a device may result in substantially higher efficiencies, and/or longer lifetime, as compared to a similar device lacking a blocking layer. Also, a blocking layer may be used to confine emission to a desired region of an OLED. In some embodiments, the EBL material has a higher LUMO (closer to the vacuum level) and/or higher triplet energy than the emitter closest to the EBL interface. In some embodiments, the EBL material has a higher LUMO (closer to the vacuum level) and/or higher triplet energy than one or more of the hosts closest to the EBL interface. In one aspect, the compound used in EBL contains the same molecule or the same functional groups used as one of the hosts described below.

### d) Hosts:

The light emitting layer of the organic EL device of the present disclosure preferably contains at least a metal complex as light emitting material, and may contain a host material using the metal complex as a dopant material. Examples of the host material are not particularly limited, and any metal complexes or organic compounds may be used as long as the triplet energy of the host is larger than that of the dopant. Any host material may be used with any dopant so long as the triplet criteria is satisfied.

Examples of metal complexes used as host are preferred to have the following general formula: 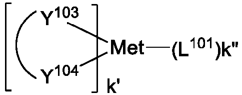 wherein Met is a metal; (Y¹⁰³-Y¹⁰⁴) is a bidentate ligand, Y¹⁰³ and Y¹⁰⁴ are independently selected from C, N, O, P, and S; L¹⁰¹ is an another ligand; k' is an integer value from 1 to the maximum number of ligands that may be attached to the metal; and k'+k" is the maximum number of ligands that may be attached to the metal.

In one aspect, the metal complexes are: 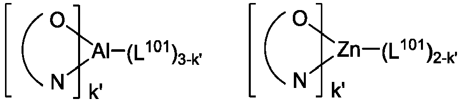 wherein (O-N) is a bidentate ligand, having metal coordinated to atoms O and N.

In another aspect, Met is selected from Ir and Pt. In a further aspect, (Y¹⁰³ -Y¹⁰⁴) is a carbene ligand.

In one aspect, the host compound contains at least one of the following groups selected from the group consisting of aromatic hydrocarbon cyclic compounds such as benzene, biphenyl, triphenyl, triphenylene, tetraphenylene, naphthalene, anthracene, phenalene, phenanthrene, fluorene, pyrene, chrysene, perylene, and azulene; the group consisting of aromatic heterocyclic compounds such as dibenzothiophene, dibenzofuran, dibenzoselenophene, furan, thiophene, benzofuran, benzothiophene, benzoselenophene, carbazole, indolocarbazole, pyridylindole, pyrrolodipyridine, pyrazole, imidazole, triazole, oxazole, thiazole, oxadiazole, oxatriazole, dioxazole, thiadiazole, pyridine, pyridazine, pyrimidine, pyrazine, triazine, oxazine, oxathiazine, oxadiazine, indole, benzimidazole, indazole, indoxazine, benzoxazole, benzisoxazole, benzothiazole, quinoline, isoquinoline, cinnoline, quinazoline, quinoxaline, naphthyridine, phthalazine, pteridine, xanthene, acridine, phenazine, phenothiazine, phenoxazine, benzofuropyridine, furodipyridine, benzothienopyridine, thienodipyridine, benzoselenophenopyridine, and selenophenodipyridine; and the group consisting of 2 to 10 cyclic structural units which are groups of the same type or different types selected from the aromatic hydrocarbon cyclic group and the aromatic heterocyclic group and are bonded to each other directly or via at least one of oxygen atom, nitrogen atom, sulfur atom, silicon atom, phosphorus atom, boron atom, chain structural unit and the aliphatic cyclic group. Each option within each group may be unsubstituted or may be substituted by a substituent selected from the group consisting of deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof.

In one aspect, the host compound contains at least one of the following groups in the molecule: 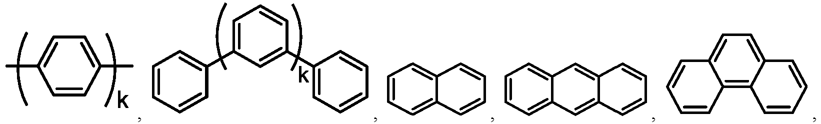 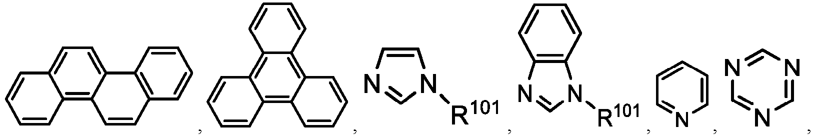 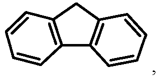 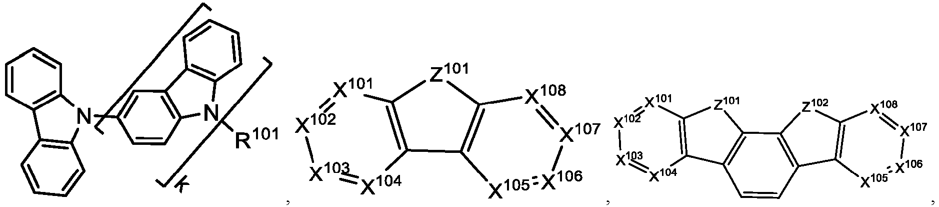 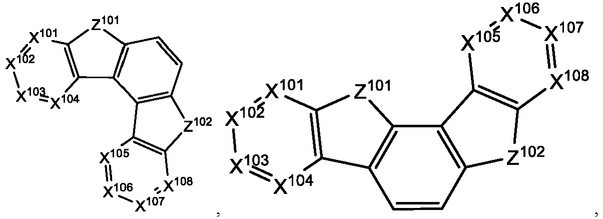 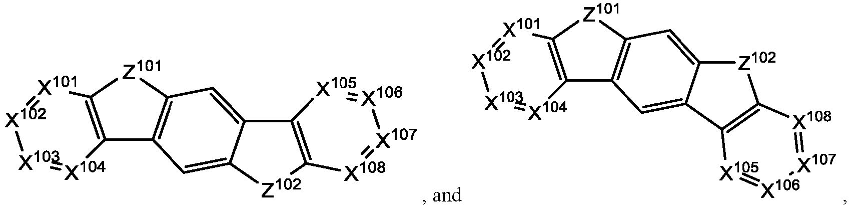 wherein R¹⁰¹ is selected from the group consisting of hydrogen, deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof, and when it is aryl or heteroaryl, it has the similar definition as Ar's mentioned above. k is an integer from 0 to 20 or 1 to 20. X¹⁰¹ to X¹⁰⁸ are independently selected from C (including CH) or N. Z¹⁰¹ and Z¹⁰² are independently selected from NR¹⁰¹, O, or S.

Non-limiting examples of the host materials that may be used in an OLED in combination with materials disclosed herein are exemplified below together with references that disclose those materials: EP2034538, EP2034538A, EP2757608, JP2007254297, KR20100079458, KR20120088644, KR20120129733, KR20130115564, TW201329200, US20030175553, US20050238919, US20060280965, US20090017330, US20090030202, US20090167162, US20090302743, US20090309488, US20100012931, US20100084966, US20100187984, US2010187984, US2012075273, US2012126221, US2013009543, US2013105787, US2013175519, US2014001446, US20140183503, US20140225088, US2014034914, US7154114, WO2001039234, WO2004093207, WO2005014551, WO2005089025, WO2006072002, WO2006114966, WO2007063754, WO2008056746, WO2009003898, WO2009021126, WO2009063833, WO2009066778, WO2009066779, WO2009086028, WO2010056066, WO2010107244, WO2011081423, WO2011081431, WO2011086863, WO2012128298, WO2012133644, WO2012133649, WO2013024872, WO2013035275, WO2013081315, WO2013191404, WO2014142472, US20170263869, US20160163995, US9466803,

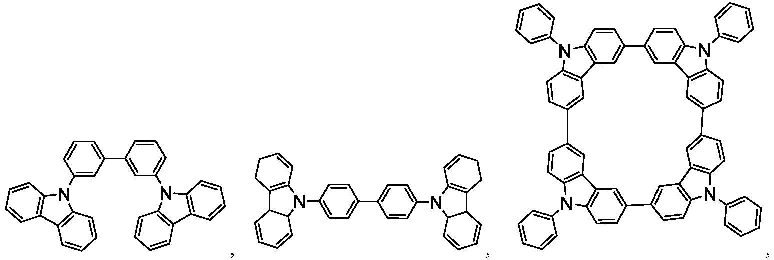

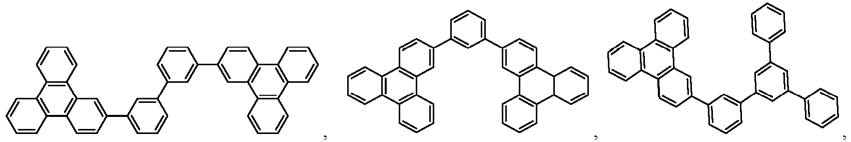

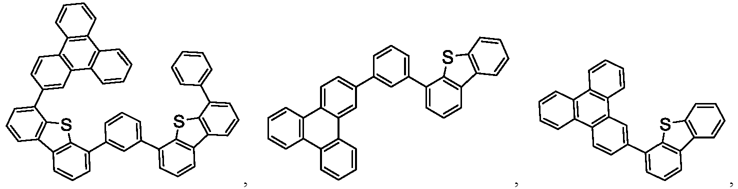

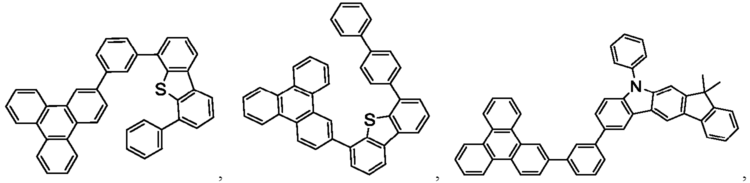

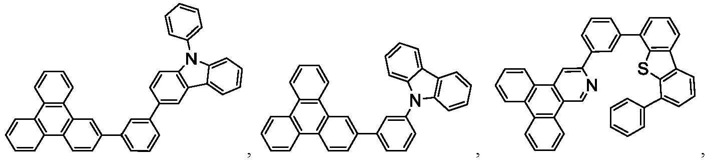

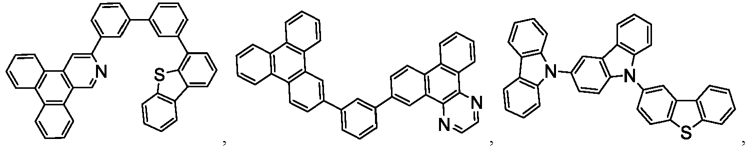

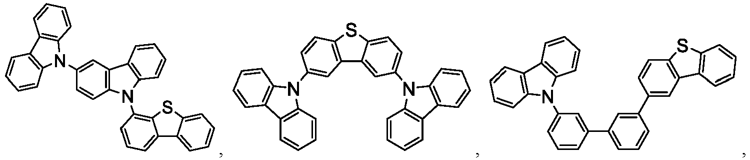

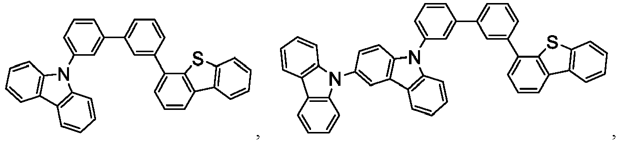

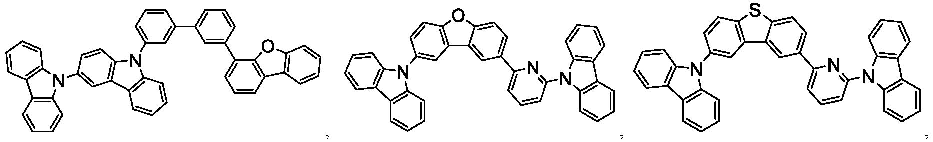

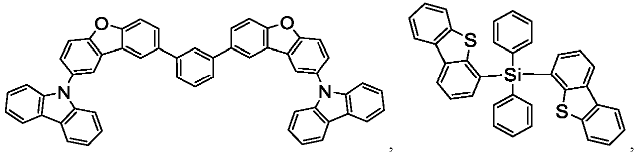

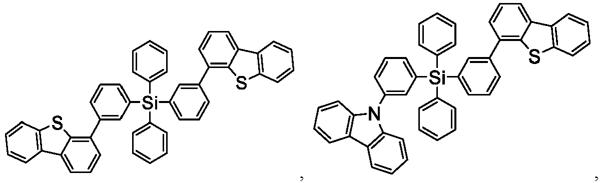

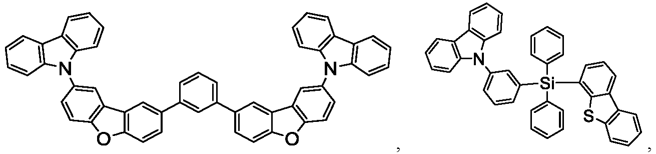

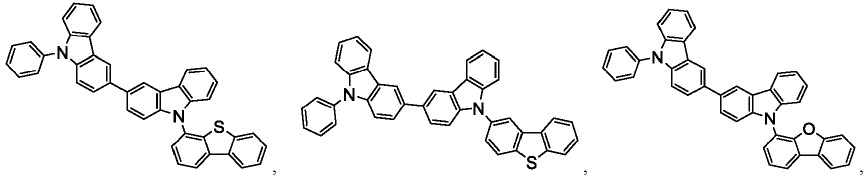

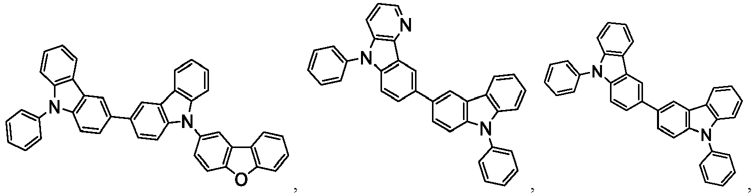

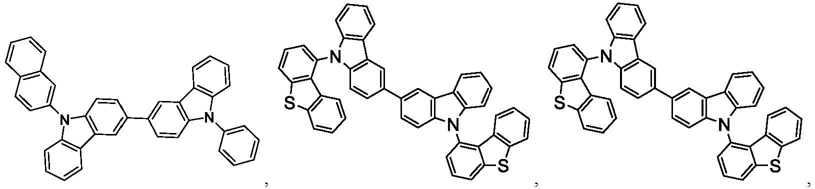

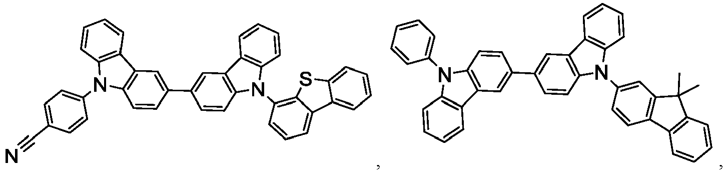

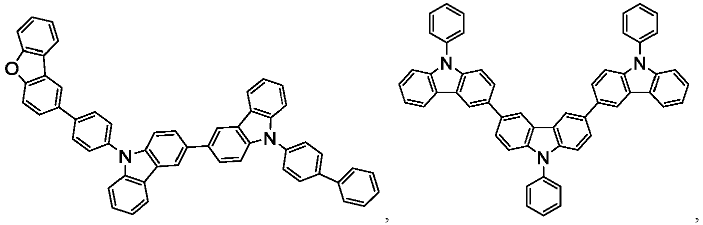

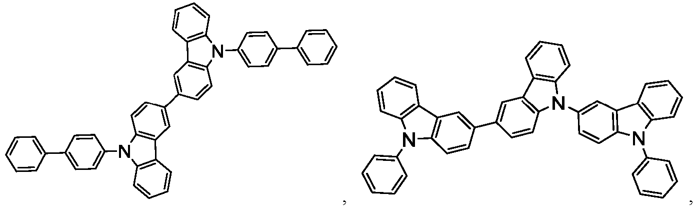

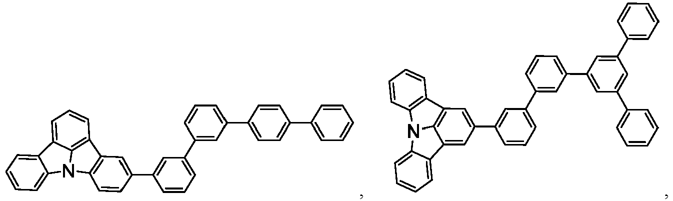

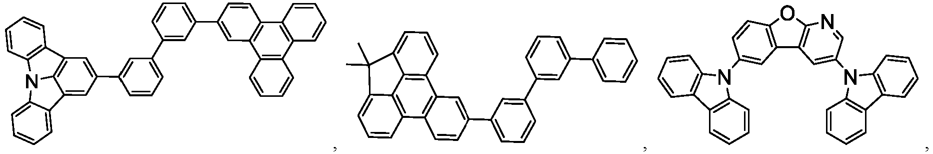

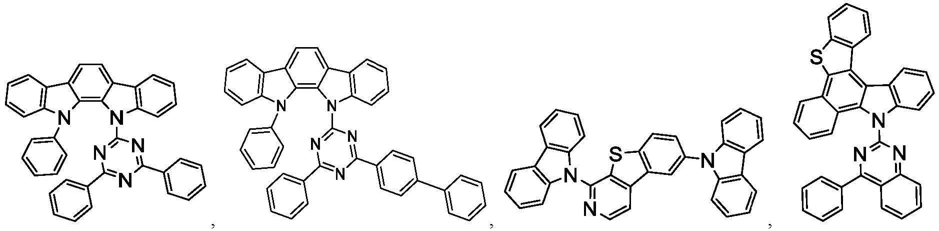

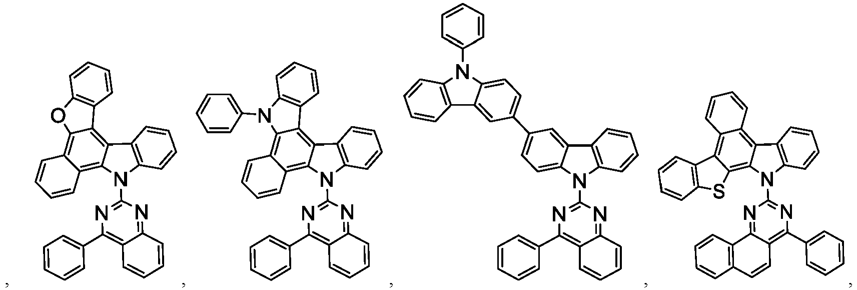

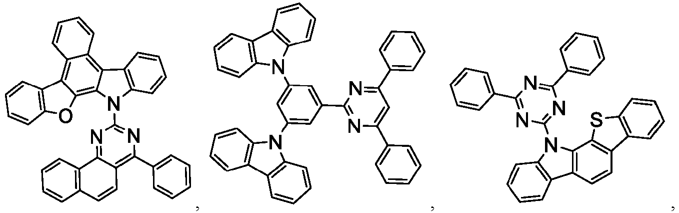

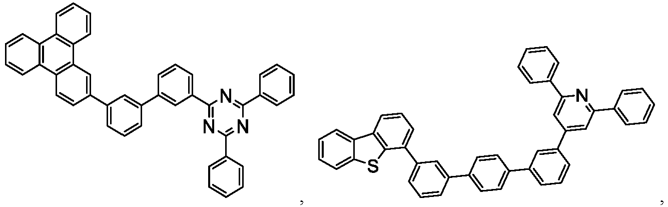

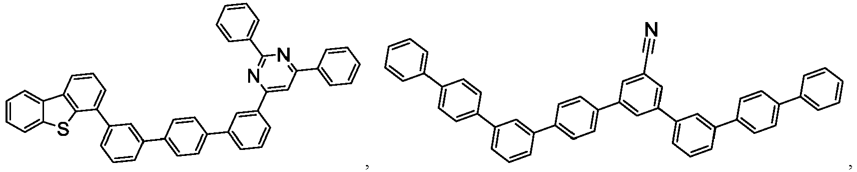

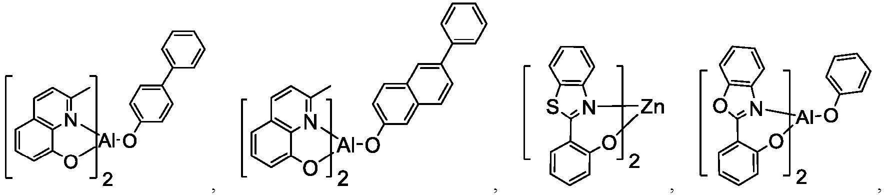

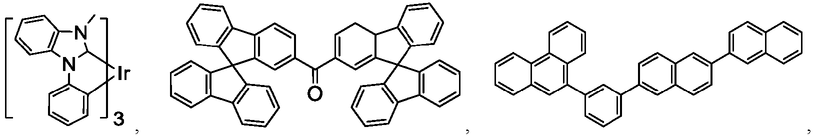

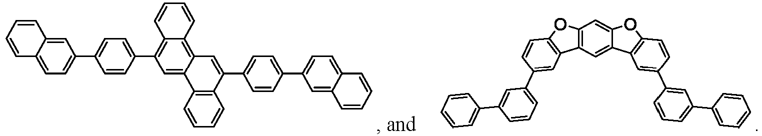

### e) Additional Emitters:

One or more additional emitter dopants may be used in conjunction with the compound of the present disclosure. Examples of the additional emitter dopants are not particularly limited, and any compounds may be used as long as the compounds are typically used as emitter materials. Examples of suitable emitter materials include, but are not limited to, compounds which can produce emissions via phosphorescence, fluorescence, thermally activated delayed fluorescence, i.e., TADF (also referred to as E-type delayed fluorescence), triplet-triplet annihilation, or combinations of these processes.

Non-limiting examples of the emitter materials that may be used in an OLED in combination with materials disclosed herein are exemplified below together with references that disclose those materials: CN103694277, CN1696137, EB01238981, EP01239526, EP01961743, EP1239526, EP1244155, EP1642951, EP1647554, EP1841834, EP1841834B, EP2062907, EP2730583, JP2012074444, JP2013110263, JP4478555, KR1020090133652, KR20120032054, KR20130043460, TW201332980, US06699599, US06916554, US20010019782, US20020034656, US20030068526, US20030072964, US20030138657, US20050123788, US20050244673, US2005123791, US2005260449, US20060008670, US20060065890, US20060127696, US20060134459, US20060134462, US20060202194, US20060251923, US20070034863, US20070087321, US20070103060, US20070111026, US20070190359, US20070231600, US2007034863, US2007104979, US2007104980, US2007138437, US2007224450, US2007278936, US20080020237, US20080233410, US20080261076, US20080297033, US200805851, US2008161567, US2008210930, US20090039776, US20090108737, US20090115322, US20090179555, US2009085476, US2009104472, US20100090591, US20100148663, US20100244004, US20100295032, US2010102716, US2010105902, US2010244004, US2010270916, US20110057559, US20110108822, US20110204333, US2011215710, US2011227049, US2011285275, US2012292601, US20130146848, US2013033172, US2013165653, US2013181190, US2013334521, US20140246656, US2014103305, US6303238, US6413656, US6653654, US6670645, US6687266, US6835469, US6921915, US7279704, US7332232, US7378162, US7534505, US7675228, US7728137, US7740957, US7759489, US7951947, US8067099, US8592586, US8871361, WO06081973, WO006121811, WO07018067, WO07108362, WO07115970, WO07115981, WO08035571, WO2002015645, WO2003040257, WO2005019373, WO2006056418, WO2008054584, WO2008078800, WO2008096609, WO2008101842, WO2009000673, WO2009050281, WO2009100991, WO2010028151, WO2010054731, WO2010086089, WO2010118029, WO2011044988, WO2011051404, WO2011107491, WO2012020327, WO2012163471, WO2013094620, WO2013107487, WO2013174471, WO2014007565, WO2014008982, WO2014023377, WO2014024131, WO2014031977, WO2014038456, WO2014112450.

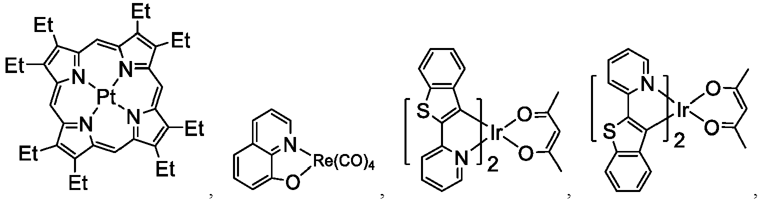

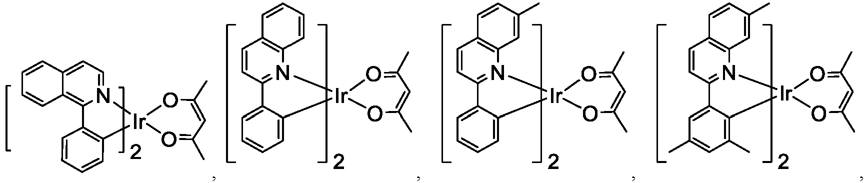

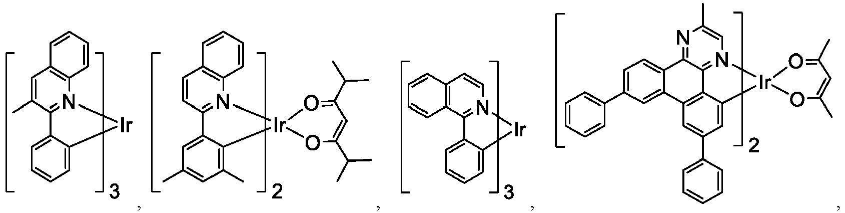

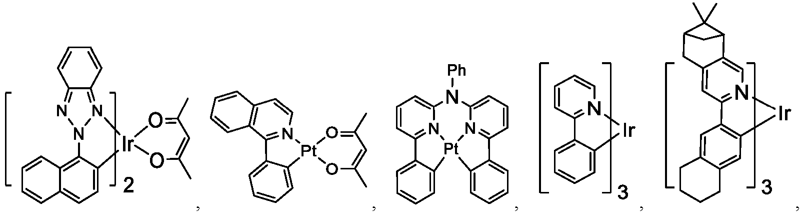

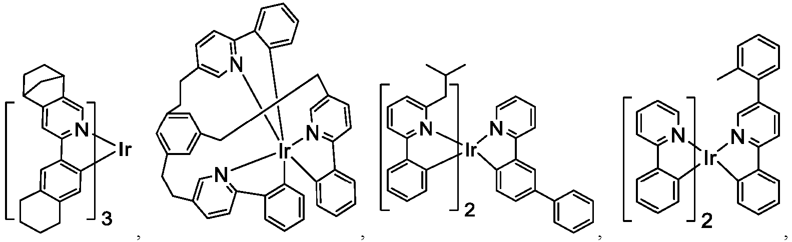

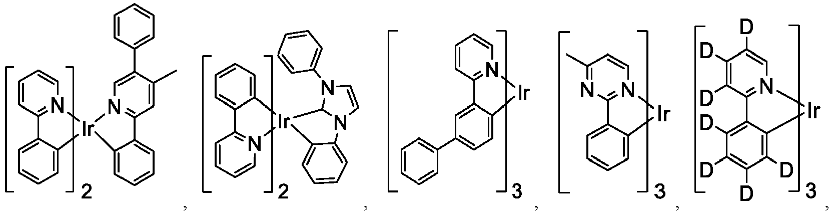

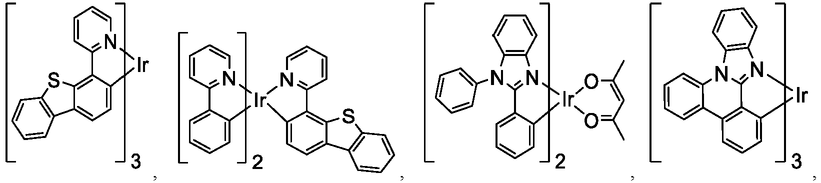

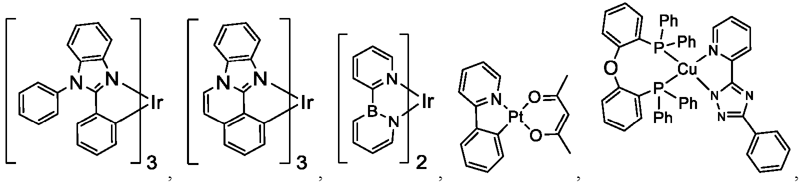

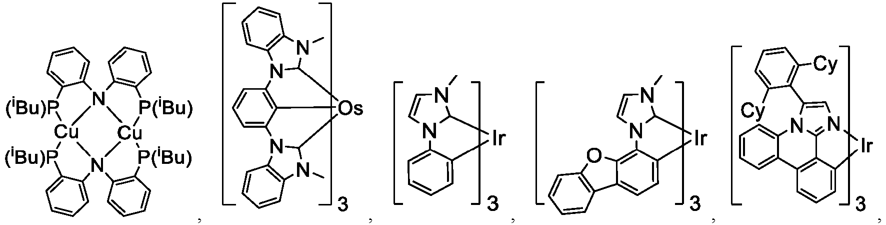

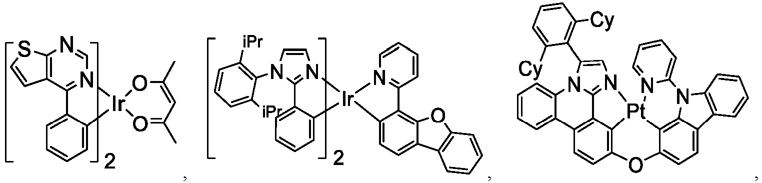

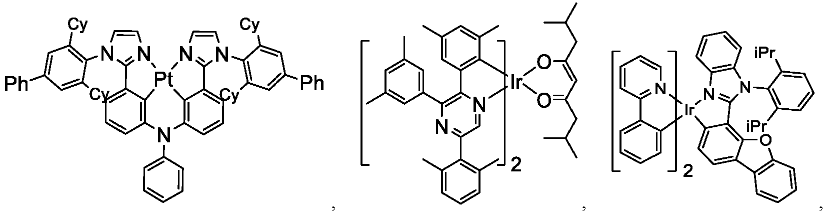

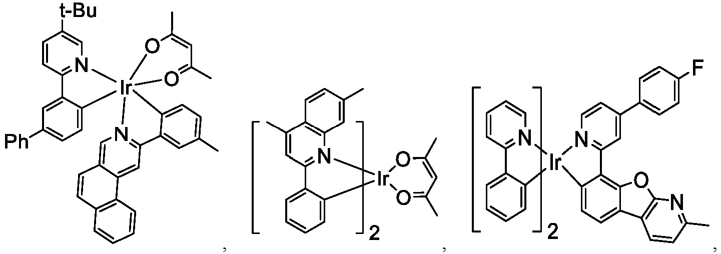

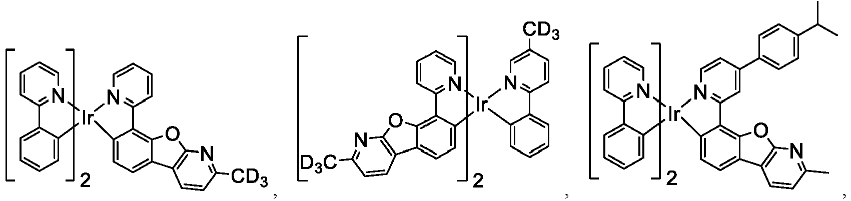

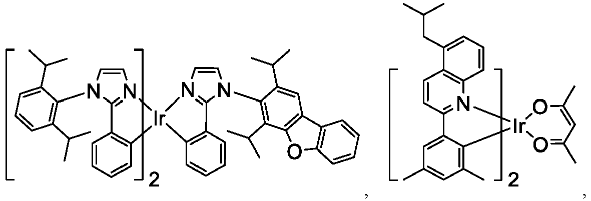

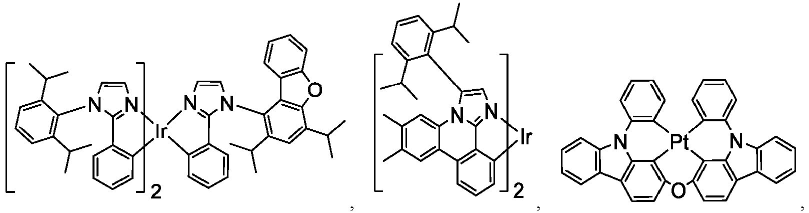

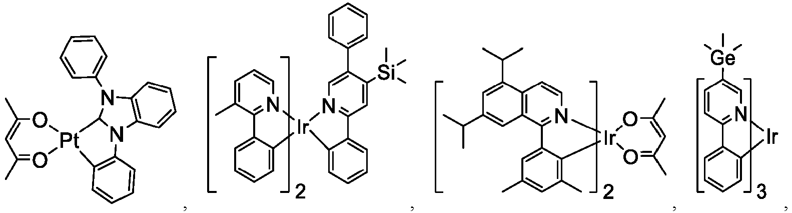

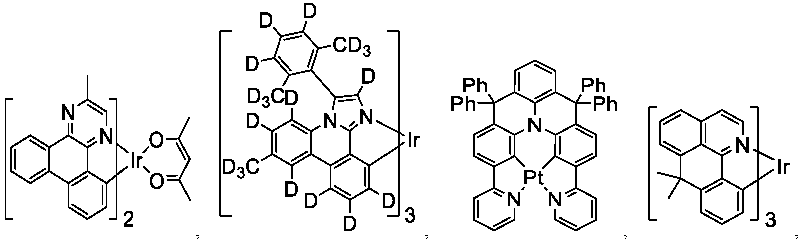

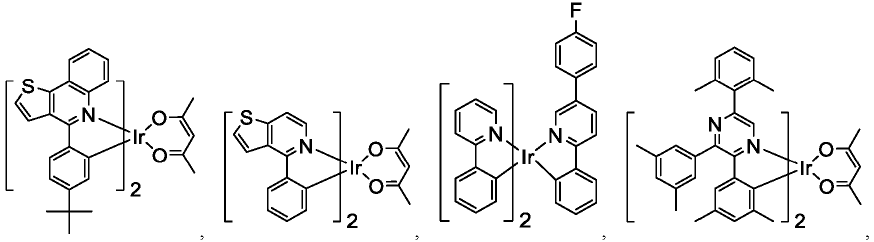

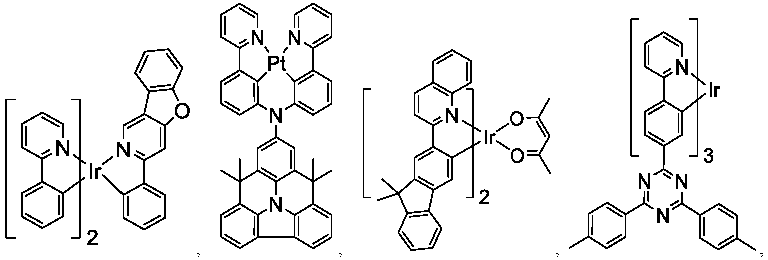

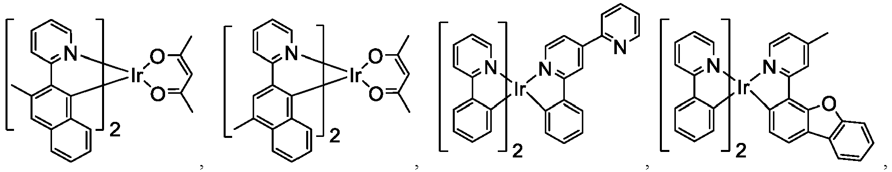

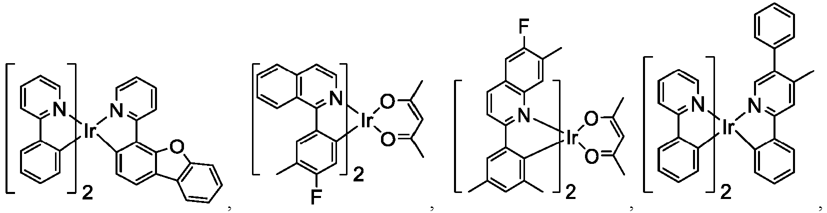

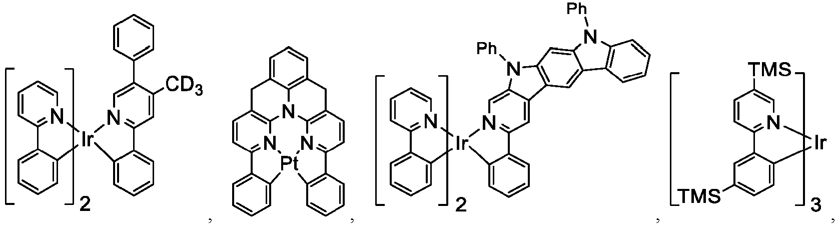

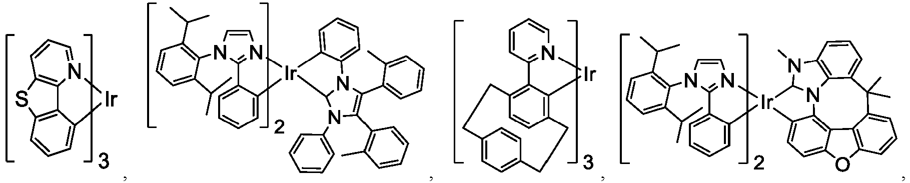

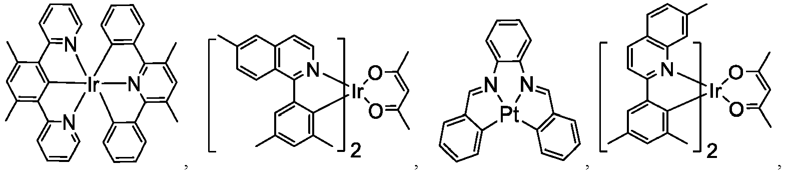

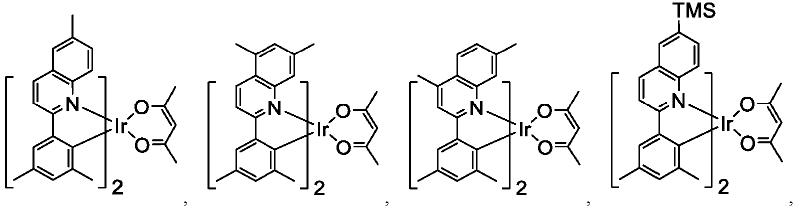

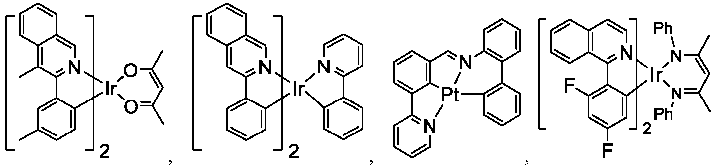

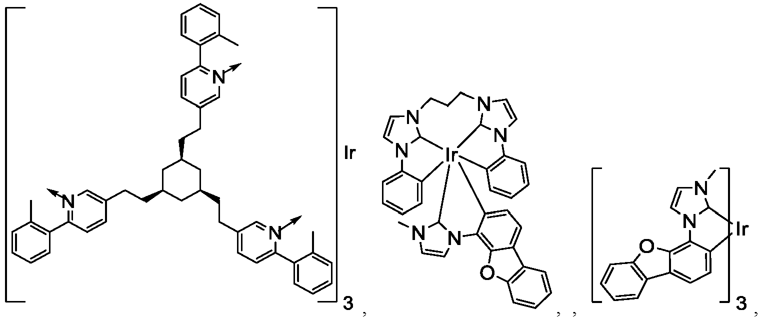

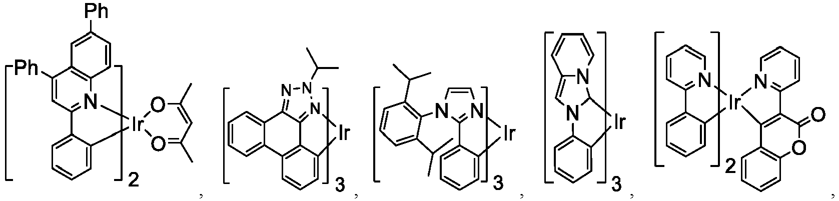

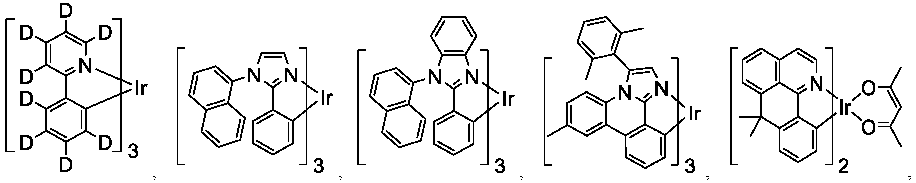

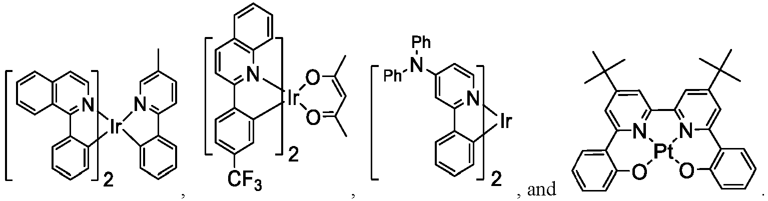

### f) HBL:

A hole blocking layer (HBL) may be used to reduce the number of holes and/or excitons that leave the emissive layer. The presence of such a blocking layer in a device may result in substantially higher efficiencies and/or longer lifetime as compared to a similar device lacking a blocking layer. Also, a blocking layer may be used to confine emission to a desired region of an OLED. In some embodiments, the HBL material has a lower HOMO (further from the vacuum level) and/or higher triplet energy than the emitter closest to the HBL interface. In some embodiments, the HBL material has a lower HOMO (further from the vacuum level) and/or higher triplet energy than one or more of the hosts closest to the HBL interface.

In one aspect, compound used in HBL contains the same molecule or the same functional groups used as host described above.

In another aspect, compound used in HBL contains at least one of the following groups in the molecule: 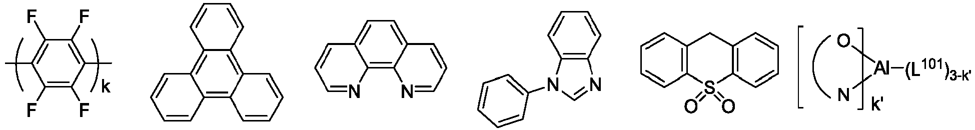 wherein k is an integer from 1 to 20; L¹⁰¹ is another ligand, k' is an integer from 1 to 3.

### g) ETL:

Electron transport layer (ETL) may include a material capable of transporting electrons. Electron transport layer may be intrinsic (undoped), or doped. Doping may be used to enhance conductivity. Examples of the ETL material are not particularly limited, and any metal complexes or organic compounds may be used as long as they are typically used to transport electrons.

In one aspect, compound used in ETL contains at least one of the following groups in the molecule: 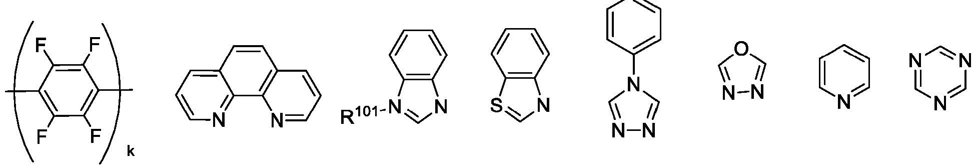 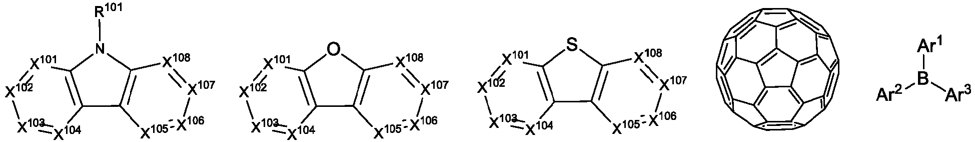 wherein R¹⁰¹ is selected from the group consisting of hydrogen, deuterium, halogen, alkyl, cycloalkyl, heteroalkyl, heterocycloalkyl, arylalkyl, alkoxy, aryloxy, amino, silyl, alkenyl, cycloalkenyl, heteroalkenyl, alkynyl, aryl, heteroaryl, acyl, carboxylic acids, ether, ester, nitrile, isonitrile, sulfanyl, sulfinyl, sulfonyl, phosphino, and combinations thereof, when it is aryl or heteroaryl, it has the similar definition as Ar's mentioned above. Ar¹ to Ar³ has the similar definition as Ar's mentioned above. k is an integer from 1 to 20. X¹⁰¹ to X¹⁰⁸ is selected from C (including CH) or N.

In another aspect, the metal complexes used in ETL contains, but not limit to the following general formula: 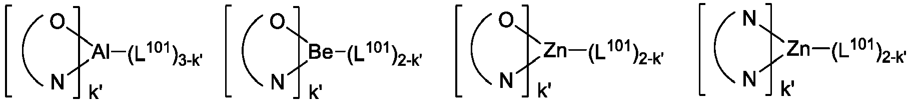 wherein (O-N) or (N-N) is a bidentate ligand, having metal coordinated to atoms O, N or N, N; L¹⁰¹ is another ligand; k' is an integer value from 1 to the maximum number of ligands that may be attached to the metal.

Non-limiting examples of the ETL materials that may be used in an OLED in combination with materials disclosed herein are exemplified below together with references that disclose those materials: CN103508940, EP01602648, EP01734038, EP01956007, JP2004-022334, JP2005149918, JP2005-268199, KR0117693, KR20130108183, US20040036077, US20070104977, US2007018155, US20090101870, US20090115316, US20090140637, US20090179554, US2009218940, US2010108990, US2011156017, US2011210320, US2012193612, US2012214993, US2014014925, US2014014927, US20140284580, US6656612, US8415031, WO2003060956, WO2007111263, WO2009148269, WO2010067894, WO2010072300, WO2011074770, WO2011105373, WO2013079217, WO2013145667, WO2013180376, WO2014104499, WO2014104535,

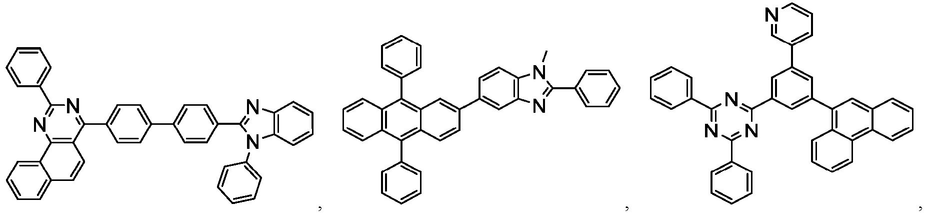

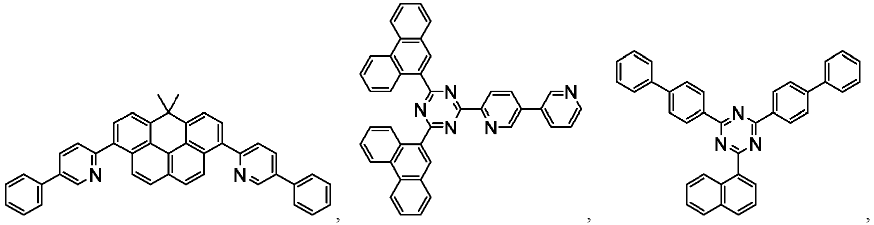

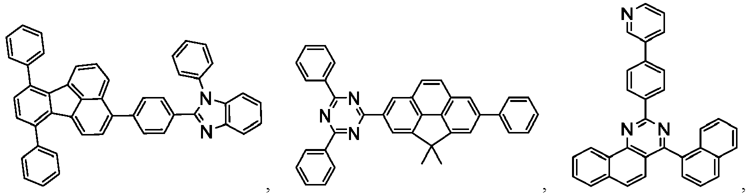

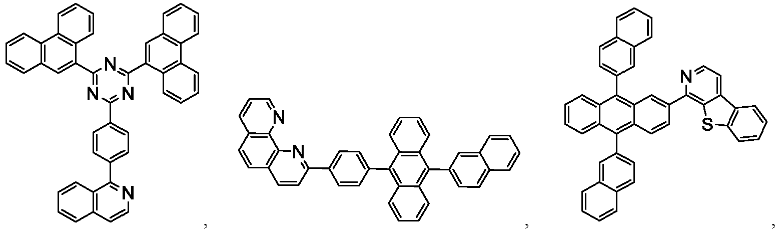

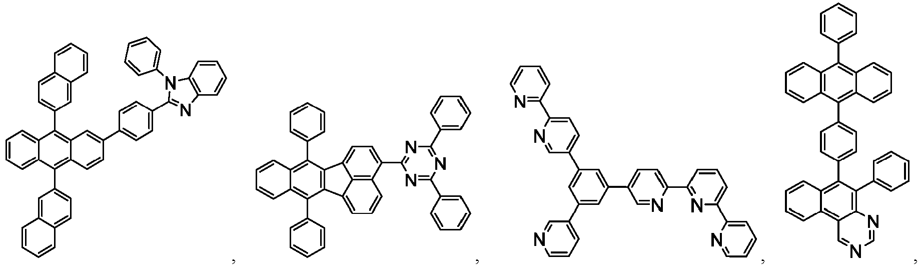

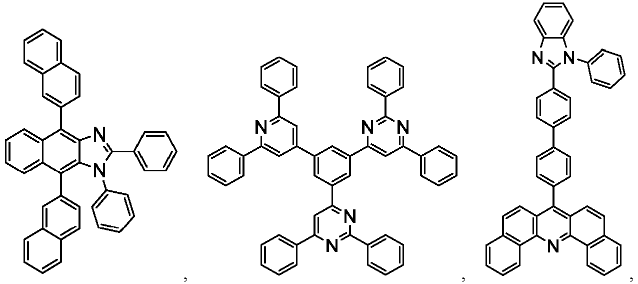

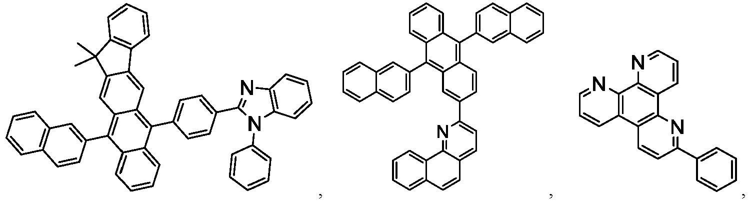

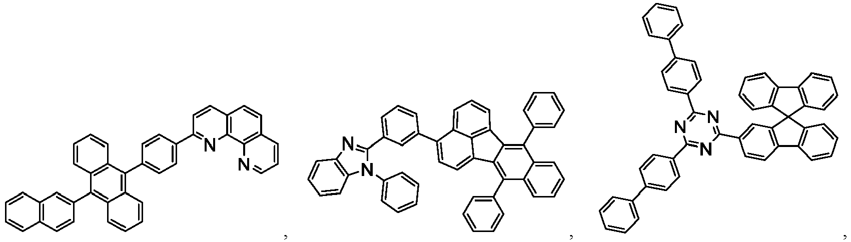

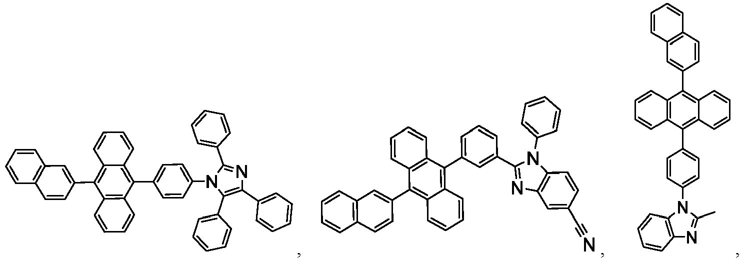

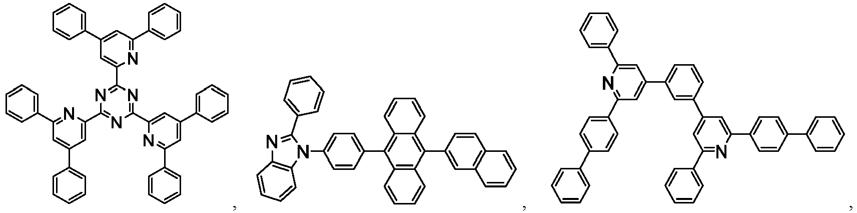

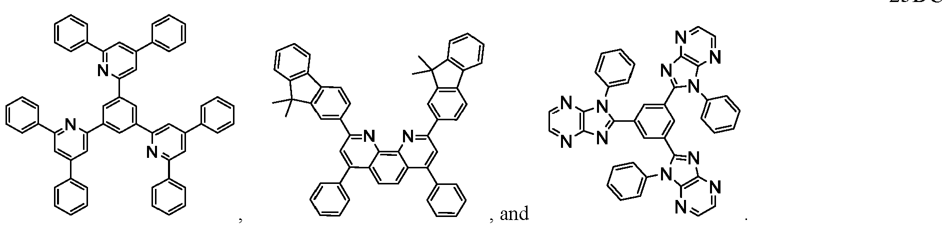

### h) Charge generation layer (CGL)

In tandem or stacked OLEDs, the CGL plays an essential role in the performance, which is composed of an n-doped layer and a p-doped layer for injection of electrons and holes, respectively. Electrons and holes are supplied from the CGL and electrodes. The consumed electrons and holes in the CGL are refilled by the electrons and holes injected from the cathode and anode, respectively; then, the bipolar currents reach a steady state gradually. Typical CGL materials include n and p conductivity dopants used in the transport layers.

In any above-mentioned compounds used in each layer of the OLED device, the hydrogen atoms can be partially or fully deuterated. The minimum amount of hydrogen of the compound being deuterated is selected from the group consisting of 30%, 40%, 50%, 60%, 70%, 80%, 90%, 95%, 99%, and 100%. Thus, any specifically listed substituent, such as, without limitation, methyl, phenyl, pyridyl, etc. may be undeuterated, partially deuterated, and fully deuterated versions thereof. Similarly, classes of substituents such as, without limitation, alkyl, aryl, cycloalkyl, heteroaryl, etc. also may be undeuterated, partially deuterated, and fully deuterated versions thereof.

### E. Experimental Data

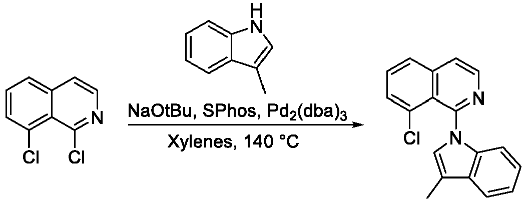

A 100 mL Schlenk flask was charged with 3-methyl-1H-indole (993.5 mg, 1.5 Eq, 7.574 mmol), 1,8-dichloroisoquinoline (1.000 g, 1 Eq, 5.049 mmol), sodium 2-methylpropan-2-olate (1.019 g, 2.1 Eq, 10.60 mmol), dicyclohexyl(2',6'-dimethoxy-[1,1'-biphenyl]-2-yl)phosphane (248.7 mg, 0.12 Eq, 605.9 µmol), Pd₂(dba)₃ (184.9 mg, 0.04 Eq, 202.0 µmol), and Xylene (25.25 mL). The mixture was sparged with N₂ for 10 minutes and heated to 140 °C for 18 hours, at which time gas chromatography mass spectrometry (GCMS) analaysis showed full conversion. The reaction was cooled to room temperature and filtered through a pad of Celite, washing the solids with 100 mL of ethyl acetate, and the resulting filtrate was concentrated on a rotary evaporator. The crude mixture was adsorbed onto Celite and eluted through one 330 g silica gel column with 10-160 30% ethyl acetate in heptanes. The product fractions were concentrated on a rotary evaporator, resulting in 0.79g (53% yield) of a viscous brown/orange oil.

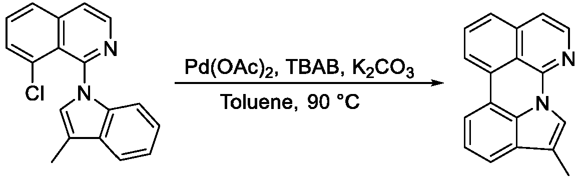

100 mL Schlenk flask was charged with 8-chloro-1-(3-methyl-1H-indol-1-yl)isoquinoline (1.244 g, 1 Eq, 4.249 mmol), potassium carbonate (1.174 g, 2 Eq, 8.498 mmol), tetrabutylammonium bromide (410.9 mg, 0.3 Eq, 1.275 mmol), diacetoxypalladium (286.2 mg, 0.3 Eq, 1.275 mmol), and Toluene (33.99 mL). The mixture was sparged with N₂ for 10 minutes and heated to 90°C for 36 hours, at which time GCMS analysis showed 70% conversion. The reaction was cooled to room temperature and charged with an additional 300 mg (1.34 mmol) palladium (II) acetate and heated back to 90 °C. After heating for an additional 18 h, the reaction was complete. The reaction was cooled to room temperature and concentrated on a rotary evaporator. The crude material was adsorbed onto Celite and eluted through four 120 g silica gel columns with 10-25% ethyl acetate in heptanes. The fractions containing pure product were concentrated on a rotary evaporator, resulting in 0.424g (39% yield) of a bright yellow solid.

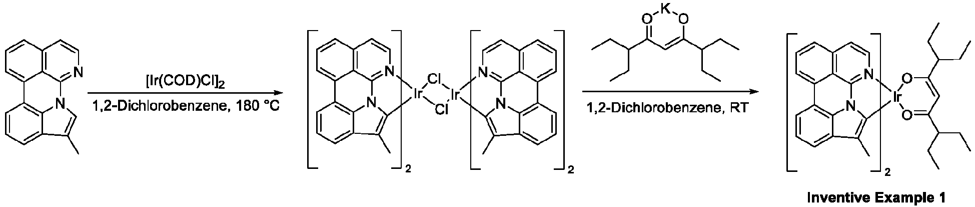

A 25 mL Schlenk tube was charged with 10-methylpyrido[2,3,4-gh]pyrrolo[3,2,1-de]phenanthridine (0.100 g, 1 Eq, 390 µmol), Bis(1,5-cyclooctadiene)diiridium(I) dichloride (65.5mg, 0.25 Eq, 97.5 µmol), and 1,2-dichlorobenzene (3 mL). The mixture was sparged with N₂ for 10 minutes and heated to 180 °C for five days, at which point high-performance liquid chromatography (HPLC) analysis showed full consumption of starting ligand. The reaction was cooled to room temperature, and potassium acac salt (121 mg, 0.487 mmol, 5 eq.) was added under N2. The reaction was stirred overnight at room temperature, at which point liquid chromatography mass spectrometry (LCMS) analysis showed full conversion to desired product. The reaction was filtered through a pad of Celite and the solids were washed with 50 mL of dichloromethane. The filtrate was concentrated on a rotary evaporator and the resulting crude material was adsorbed onto Celite and eluted through six 120g silica gel columns with 30-60% DCM in heptanes. The product fractions were concentrated and the resulting residue was triturated with DCM/MeOH, and the red solid was filtered and dried in vacuuo. The reaction yielded 33 mg (17%) of desired product as a red solid.

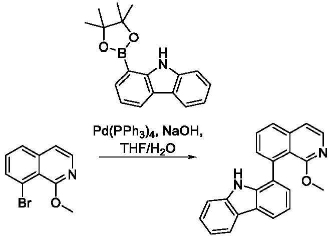

A 2-neck RBF, equipped with septum and condenser was charged with 8-bromo-1-methoxyisoquinoline (2.33 g, 9.787 mmol), 1-(4,4,5,5-tetramethyl-1,3,2-dioxaborolan-2-yl)-9H-carbazole (2.87 g, 9.79 mmol), NaOH (1.17 g, 29.36 mmol) and tetrakistriphenylphosphine palladium (0) (565 mg, 0.49 mmol). The flask was evacuated and backfilled with N₂. THF (60 mL) and water (30 mL) were added, the reaction mixture was stirred at 80 °C for 1h. The reaction mixture was cooled to the room temperature and the aqueous layer was separated. The residue was purified a silica gel column eluted with 0-20% EtOAc in iso-hexane to give 2.66 g product (84%).

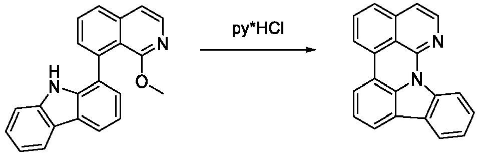

A 2-neck RBF, equipped with septum and condenser was charged 1-(1-methoxyisoquinolin-8-yl)-9H-carbazole (2.37 g, 7.31 mmol) and pyridine hydrochloride (5.91 g, 51.14 mmol). The reaction mixture was stirred for 2.5 h at 190 °C. The reaction mixture was cooled down and quenched with sat. NaHCO₃, small amount of DCM was added to partially dissolve the product and facilitate the quench. Majority of the aqueous layer was decanted and the organic layer was passed through phase separator. The solid present in the mixture was recovered. The organic solution was evaporated and combined with the solid to give crude product. The crude product was dry-loaded and purified by a silica gel column eluted with 0-10% EtOAc in toluene to give a yellow solid (1.22 g, 55% yield).

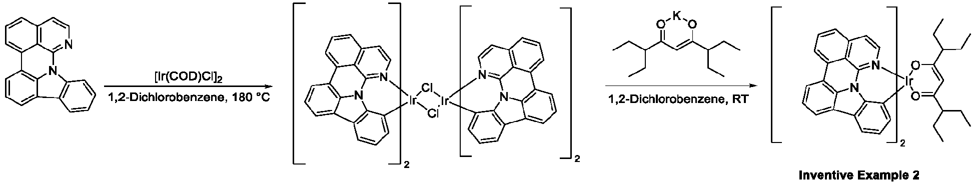

Inventive example 2 can be made following the similar procedures as described for the synthesis of the inventive example 1.

The photoluminescence spectrum of the inventive example 1 was measured in solution at room temperature, which exhibits deep red phosphorescence with peak wavelength at 721 nm.

DFT calculations were performed to determine the energy of the lowest singlet (S1) and the lowest triplet (T1) excited state, and the percentage of metal-to-ligand charge transfer (³MLCT) and ligand centered (³LC) excited state involved in T1 of the compounds. The data was gathered using the program Gaussian16. Geometries were optimized using B3L YP functional and CEP-31G basis set. Excited state energies were computed by TDDFT at the optimized ground state geometries. THF solvent was simulated using a self-consistent reaction field to further improve agreement with experiment. The DFT calculations support that these inventive types of compounds can be used as red, green and yellow emitters in OLED devices with various energy properties needed.

**TABLE A: DFT calculated energy levels:**

| Inventive Compound | Structure | T₁ (nm) | S₁ (nm) | HOMO (eV) | LUMO (eV) |
|---|---|---|---|---|---|
| Inventive Compound 2 | 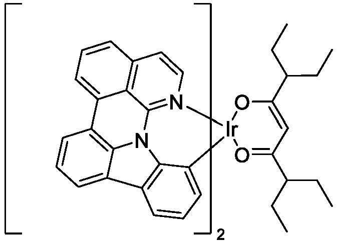 | 618 | 492 | -5.10 | -2.07 |
| Inventive Compound 3 | 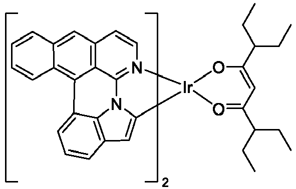 | 874 | 550 | -5.20 | -2.45 |
| Inventive Compound 4 | 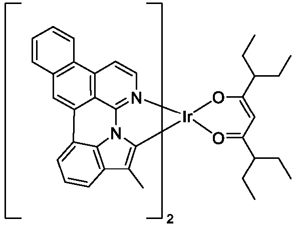 | 637 | 472 | -5.01 | -1.85 |
| Inventive Compound 5 | 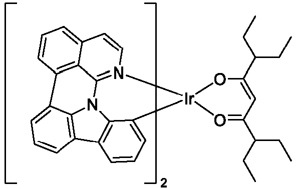 | 618 | 492 | -5.10 | -2.07 |
| Inventive Compound 6 | 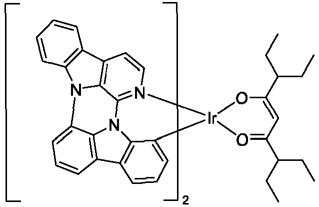 | 558 | 473 | -5.00 | -1.88 |
| Inventive Compound 7 | 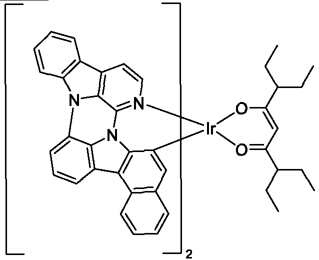 | 562 | 483 | -5.11 | -2.01 |
| Inventive Compound 8 | 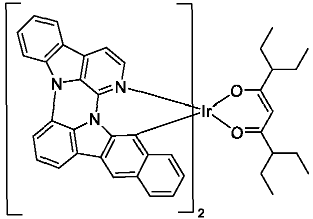 | 636 | 557 | -4.63 | -1.88 |
| Inventive Compound 9 | 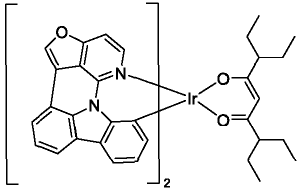 | 546 | 425 | -5.16 | -1.73 |
| Inventive Compound 10 | 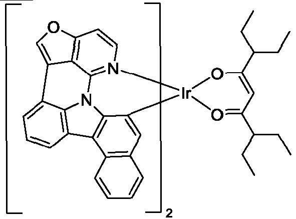 | 586 | 449 | -5.18 | -1.90 |
| Inventive Compound 11 | 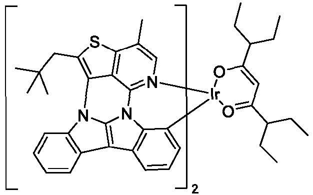 | 504 | 422 | -5.05 | -1.53 |
| Inventive Compound 12 | 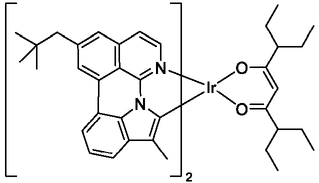 | 635 | 486 | -5.00 | -1.90 |

The calculations obtained with the above-identified DFT functional set and basis set are theoretical. Computational composite protocols, such as Gaussian with the CEP-31G basis set used herein, rely on the assumption that electronic effects are additive and, therefore, larger basis sets can be used to extrapolate to the complete basis set (CBS) limit. However, when the goal of a study is to understand variations in HOMO, LUMO, S₁, T₁, bond dissociation energies, etc. over a series of structurally-related compounds, the additive effects are expected to be similar. Accordingly, while absolute errors from using the B3LYP may be significant compared to other computational methods, the relative differences between the HOMO, LUMO, S₁, T₁, and bond dissociation energy values calculated with B3L YP protocol are expected to reproduce experiment quite well. *See, e.g.,* Hong et al., Chem. Mater. 2016, 28, 5791-98, 5792-93 and Supplemental Information (discussing the reliability of DFT calculations in the context of OLED materials). Moreover, with respect to iridium or platinum complexes that are useful in the OLED art, the data obtained from DFT calculations correlates very well to actual experimental data. *See* Tavasli et al., J. Mater. Chem. 2012, 22, 6419-29, 6422 (Table 3) (showing DFT calculations closely correlating with actual data for a variety of emissive complexes); Morello, G.R., J. Mol. Model. 2017, 23:174 (studying of a variety of DFT functional sets and basis sets and concluding the combination of B3LYP and CEP-31G is particularly accurate for emissive complexes).

## Claims

1. A compound comprising a first ligand L_{A} of Formula I, 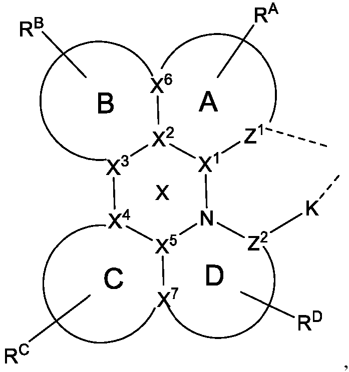 wherein:
moieties A, B, C, and D are each independently a monocyclic ring or polycyclic fused ring system, wherein the monocyclic ring and each ring of the polycyclic fused ring system is independently a 5 -membered or 6-membered carbocyclic or heterocyclic ring;
Z¹ and Z² are each independently C or N;
each of X¹ to X⁷ is each independently C or N;
K is selected from the group consisting of a direct bond, O, S, N(R^{α}), P(R^{α}), B(R^{α}), C(R^{α}), C(R^{α})(R^{β}), and Si(R^{α})(R^{β});
R^{A}, R^{B}, R^{C}, and R^{D} each independently represent mono to the maximum allowable substitution, or no substitution;
each R^{α}, R^{β}, R^{A}, R^{B}, R^{C}, and R^{D} is independently a hydrogen or a substituent selected from the group consisting of deuterium, halogen, alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof;
any two substituents may be joined or fused to form a ring;
L_{A} is joined to a metal M that has an atomic mass of at least 40;
M may be coordinated to other ligands; and
L_{A} may be joined with other ligands to comprise a tridentate, tetradentate, pentadentate, or hexadentate ligand.

2. The compound of claim 1, wherein metal M is selected from the group consisting of Ir, Rh, Re, Ru, Os, Pt, Pd, Ag, Au, and Cu.

3. The compound of claim 1, wherein K is selected from the group consisting of N(R^{α}), P(R^{α}), B(R^{α}), C(R^{α}), C(R^{α})(R^{β}), and Si(R^{α})(R^{β}); and/or
wherein at least one of R^{α} or R^{β} is joined with R^{D} to form a ring fused to moiety D; and/or
wherein K is a direct bond, O or S; and/or wherein Z¹ is N and Z² is C or wherein Z¹ is carbene carbon and Z² is C; and/or
wherein each of X¹ to X⁷ is C or at least one of X¹ to X⁷ is N; and/or
wherein one R^{A} is joined to one R^{B} to form a ring; and/or wherein one R^{B} is joined to one R^{C} to form a ring; and/or wherein one R^{C} is joined to one R^{D} to form a ring.

4. The compound of claim 1, wherein each of moieties A, B, C, and D is independently selected from the group consisting of benzene, pyridine, pyrimidine, pyridazine, pyrazine, triazine, imidazole, pyrazole, pyrrole, oxazole, furan, thiophene, thiazole, triazole, naphthalene, quinoline, isoquinoline, quinazoline, benzofuran, aza-benzofuran, benzoxazole, aza-benzoxazole, benzothiophene, aza-benzothiophene, benzothiazole, aza-benzothiazole, benzoselenophene, aza-benzoselenophene, indene, aza-indene, indole, aza-indole, benzimidazole, aza-benzimidazole, carbazole, aza-carbazole, dibenzofuran, aza-dibenzofuran, dibenzothiophene, aza-dibenzothiophene, quinoxaline, phthalazine, phenanthrene, aza-phenanthrene, anthracene, aza-antracene, phenanthridine, fluorene, and aza-fluorene.

5. The compound of claim 1, wherein the ligand L_{A} is selected from the group consisting of: 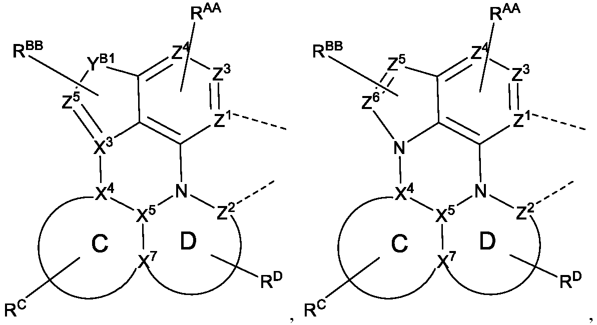 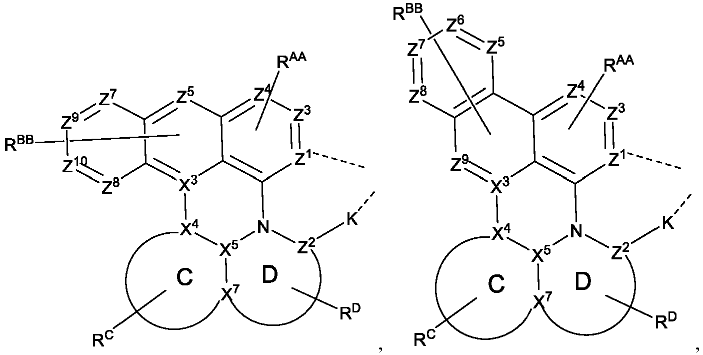 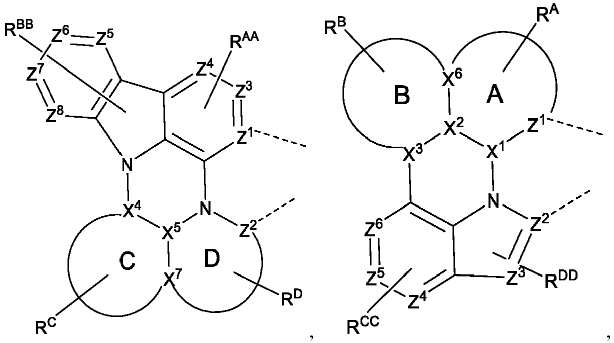 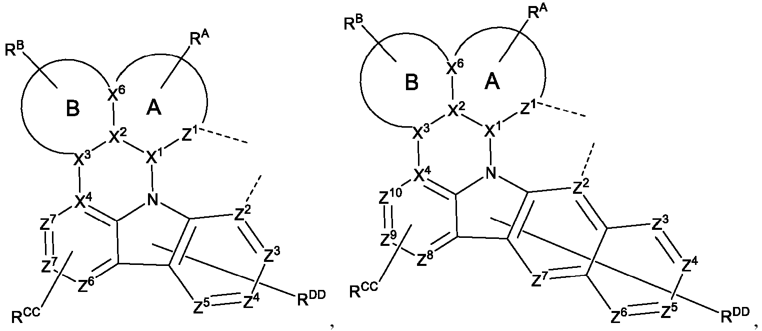 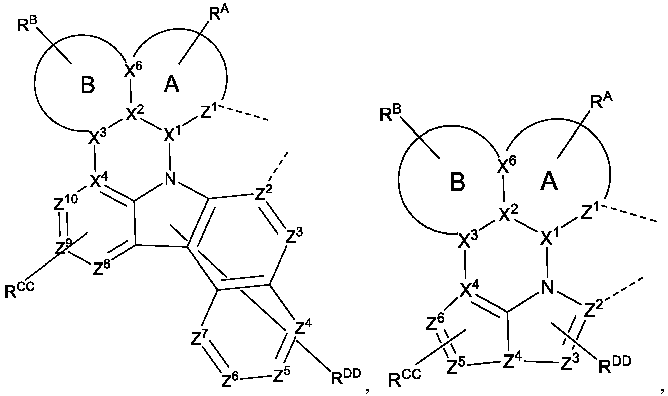 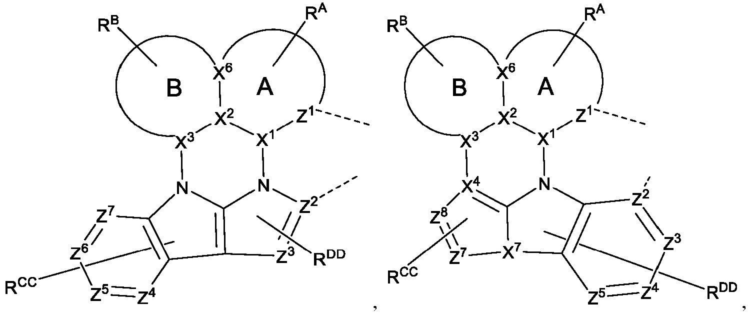 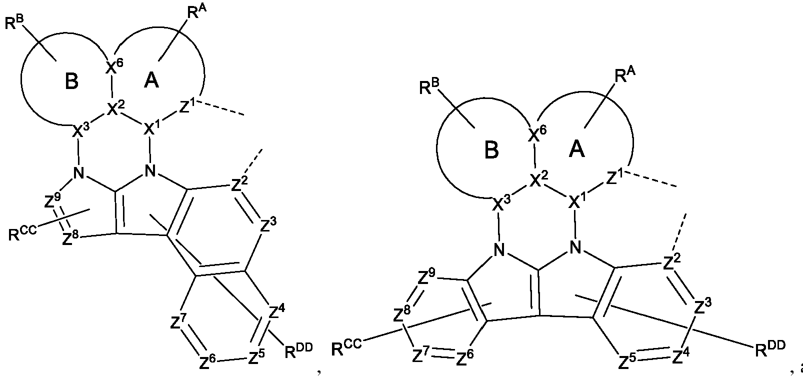 and 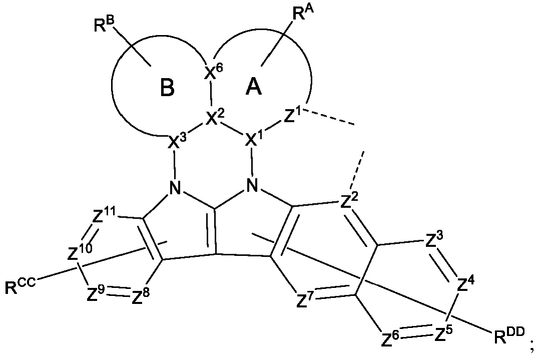 wherein:
each of Z³ to Z¹¹ is independently C or N;
each Y^{B1} is independently selected from the group consisting of BR, BRR', NR, PR, P(O)R, O, S, Se, C=O, C=S, C=Se, C=NR, C= CRR', S=O, SO₂, CR, CRR', SiRR', and GeRR';
each of R^{AA}, R^{BB}, R^{CC}, and R^{DD} independently represent mono to the maximum allowable substitution, or no substitution;
each R, R', R^{AA}, R^{BB}, R^{CC}, and R^{DD} is independently a hydrogen or a substituent selected from the group consisting of deuterium, halogen, alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof; and
any two substituents may be joined or fused to form a ring.

6. The compound of claim 1, wherein the ligand L_{A} is selected from the group consisting of: 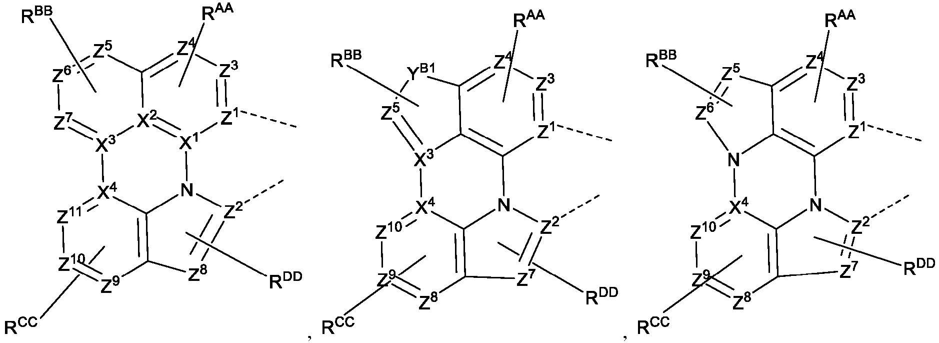 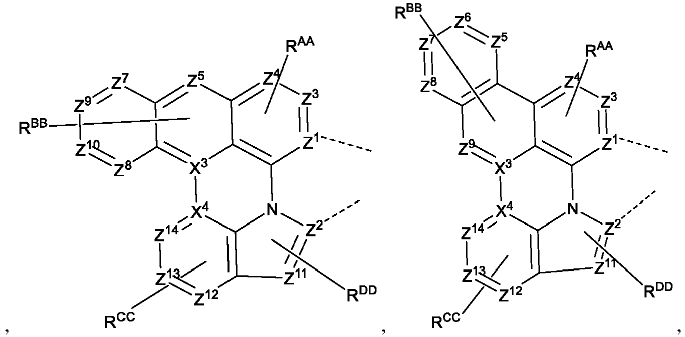 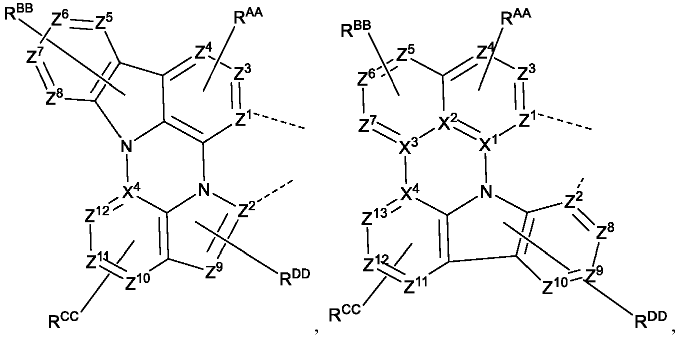 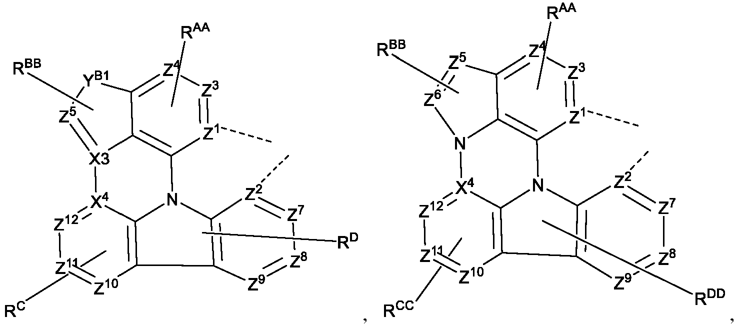 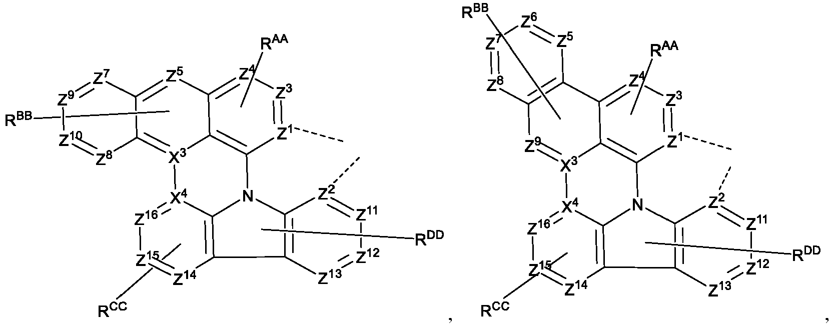 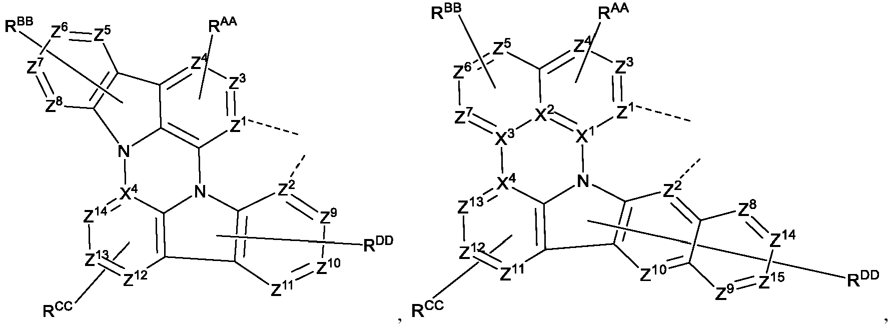 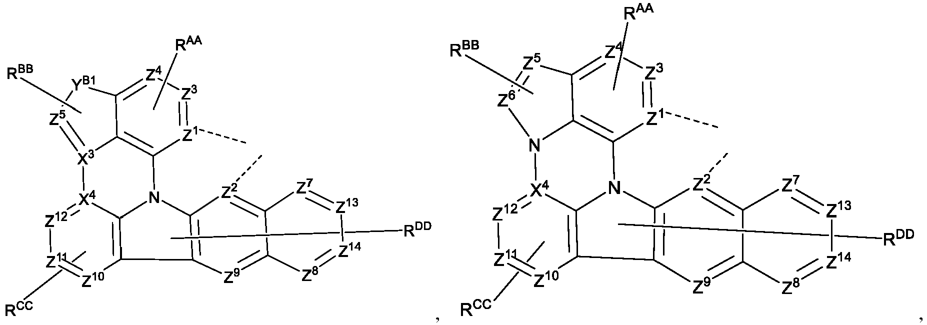 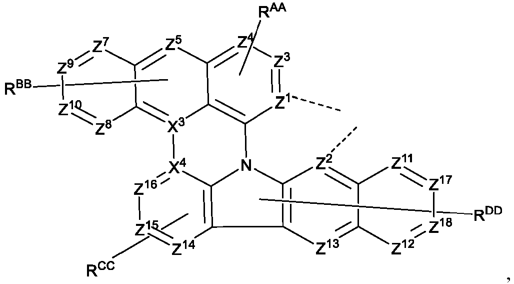 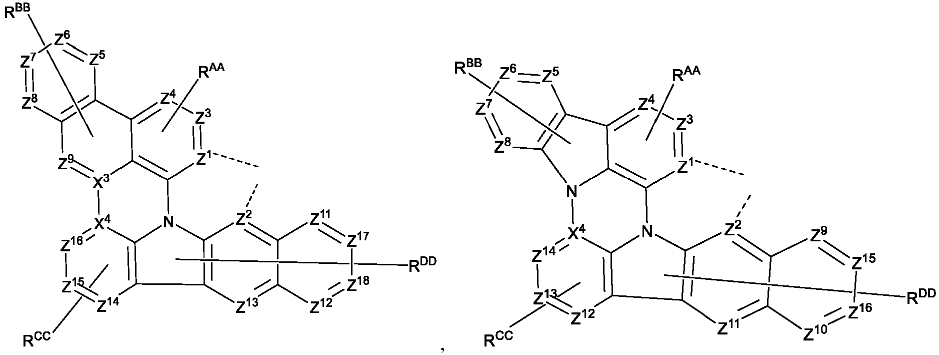 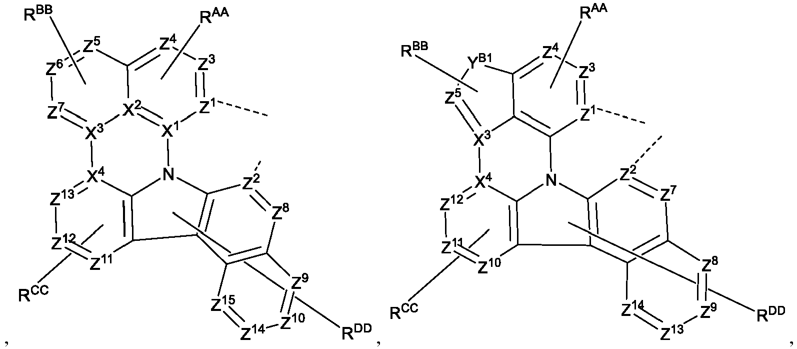 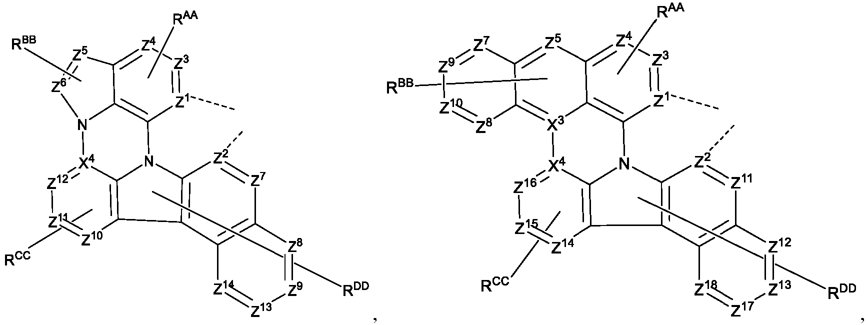 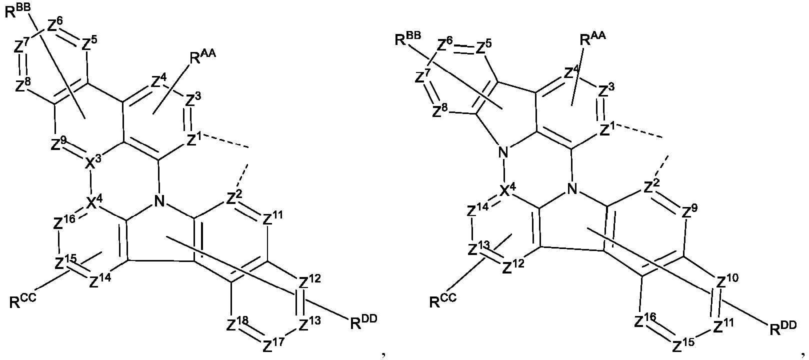 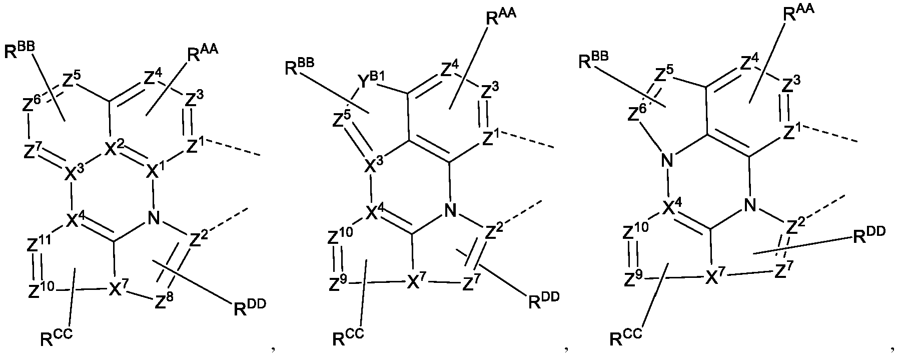 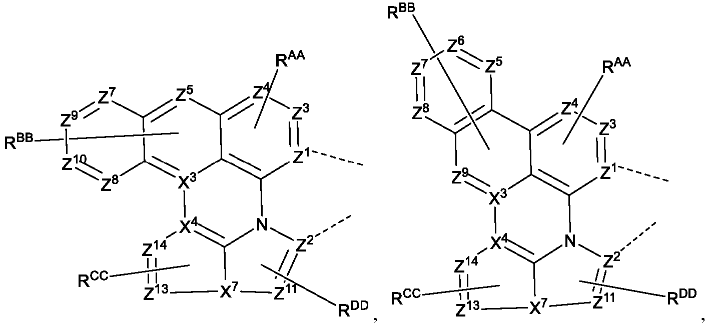 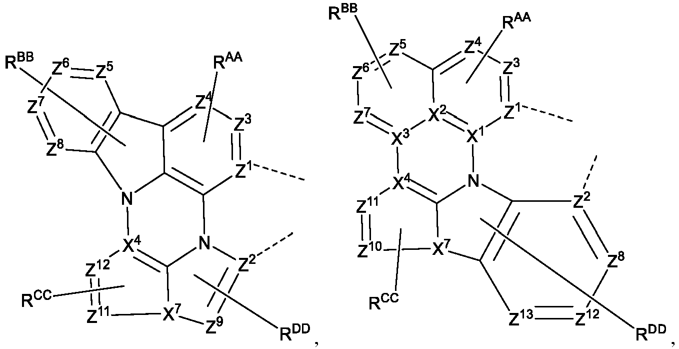 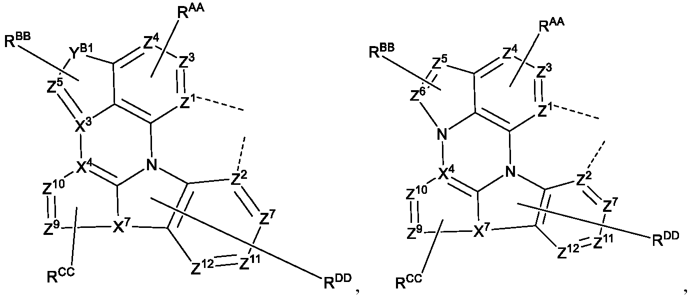 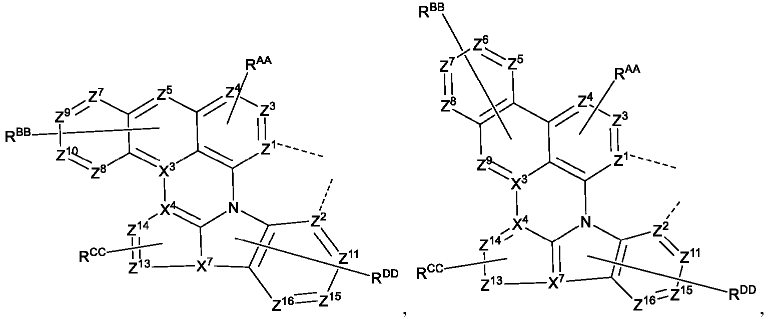 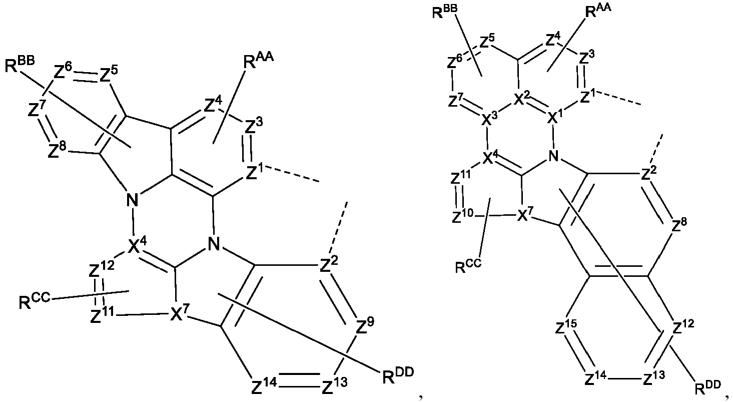 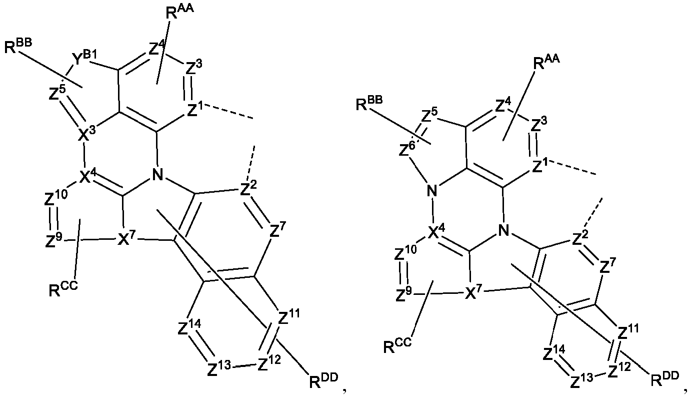 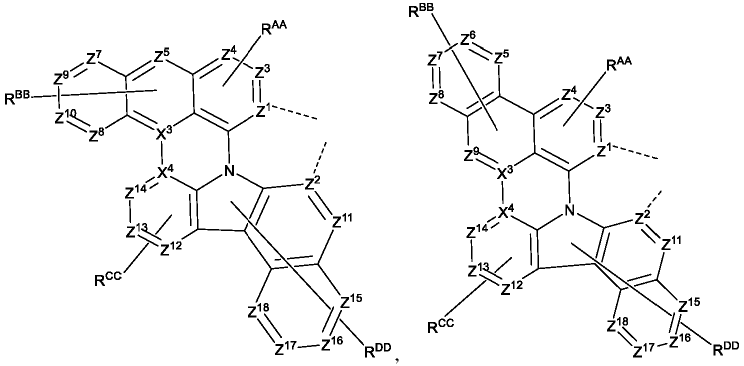 , and 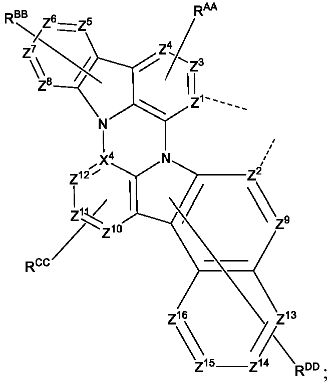 wherein:
each of Z³ to Z¹⁸ is independently C or N;
each Y^{B1} is independently selected from the group consisting of BR, BRR', NR, PR, P(O)R, O, S, Se, C=O, C=S, C=Se, C=NR, C= CRR', S=O, SO₂, CR, CRR', SiRR', and GeRR';
each of R^{AA}, R^{BB}, R^{CC}, and R^{DD} independently represent mono to the maximum allowable substitution, or no substitution;
each R, R', R^{AA}, R^{BB}, R^{CC}, and R^{DD} is independently a hydrogen or a substituent selected from the group consisting of deuterium, halogen, alkyl, cycloalkyl, heteroalkyl, heterocycloalkyl, boryl, arylalkyl, alkoxy, aryloxy, amino, silyl, germyl, alkenyl, cycloalkenyl, heteroalkenyl, alkynyl, aryl, heteroaryl, acyl, carboxylic acid, ether, ester, nitrile, isonitrile, sulfanyl, sulfinyl, sulfonyl, phosphino, selenyl, and combinations thereof; and
any two substituents may be joined or fused to form a ring.

7. The compound of claim 1, wherein the ligand L_{A} is selected from the group consisting of L_{Ai-m}, wherein i is an integer from 1 to 3136 and m is an integer from 1 to 154, and wherein L_{Ai-1} to L_{Ai-149} are defined as follows: 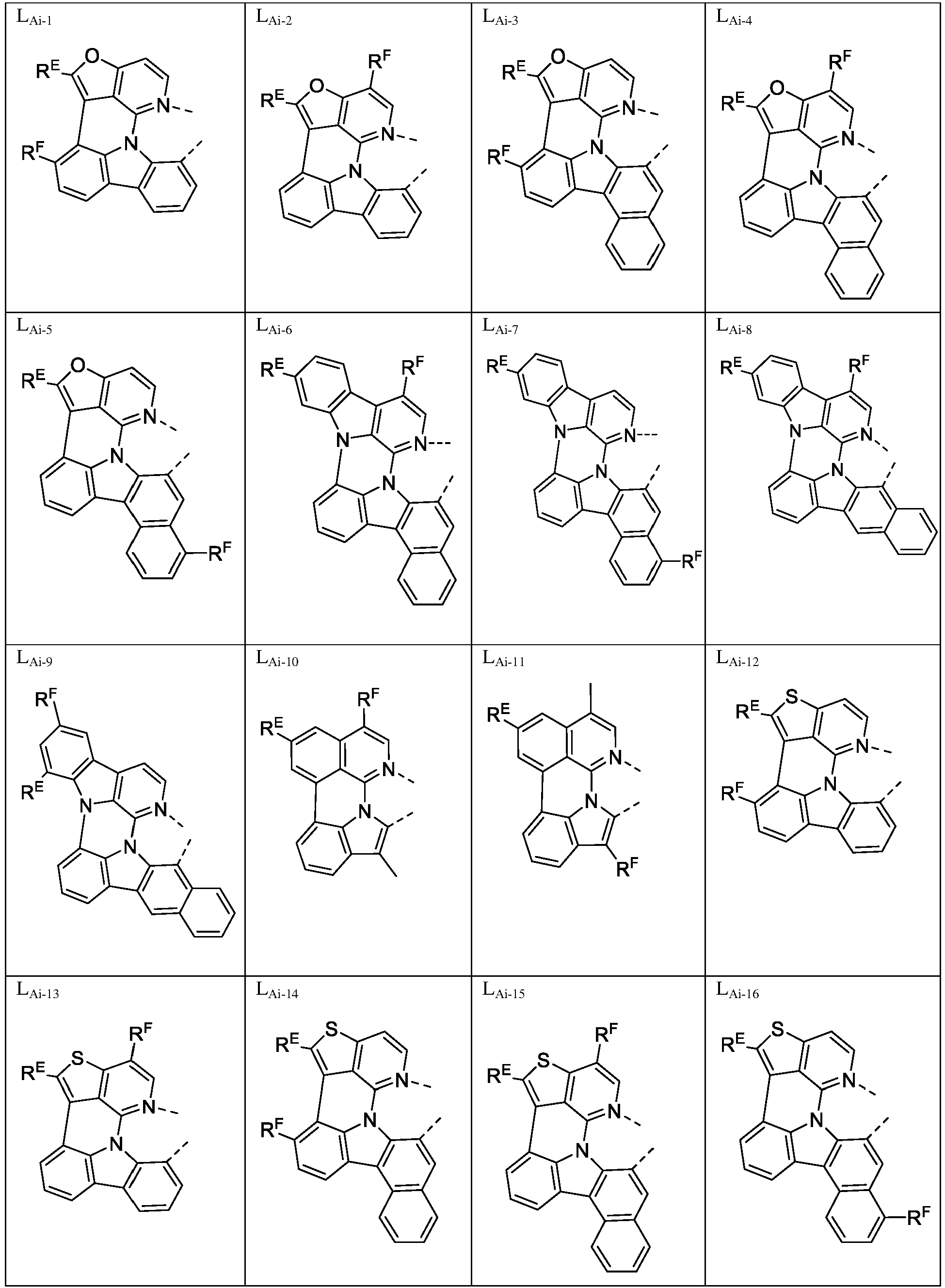 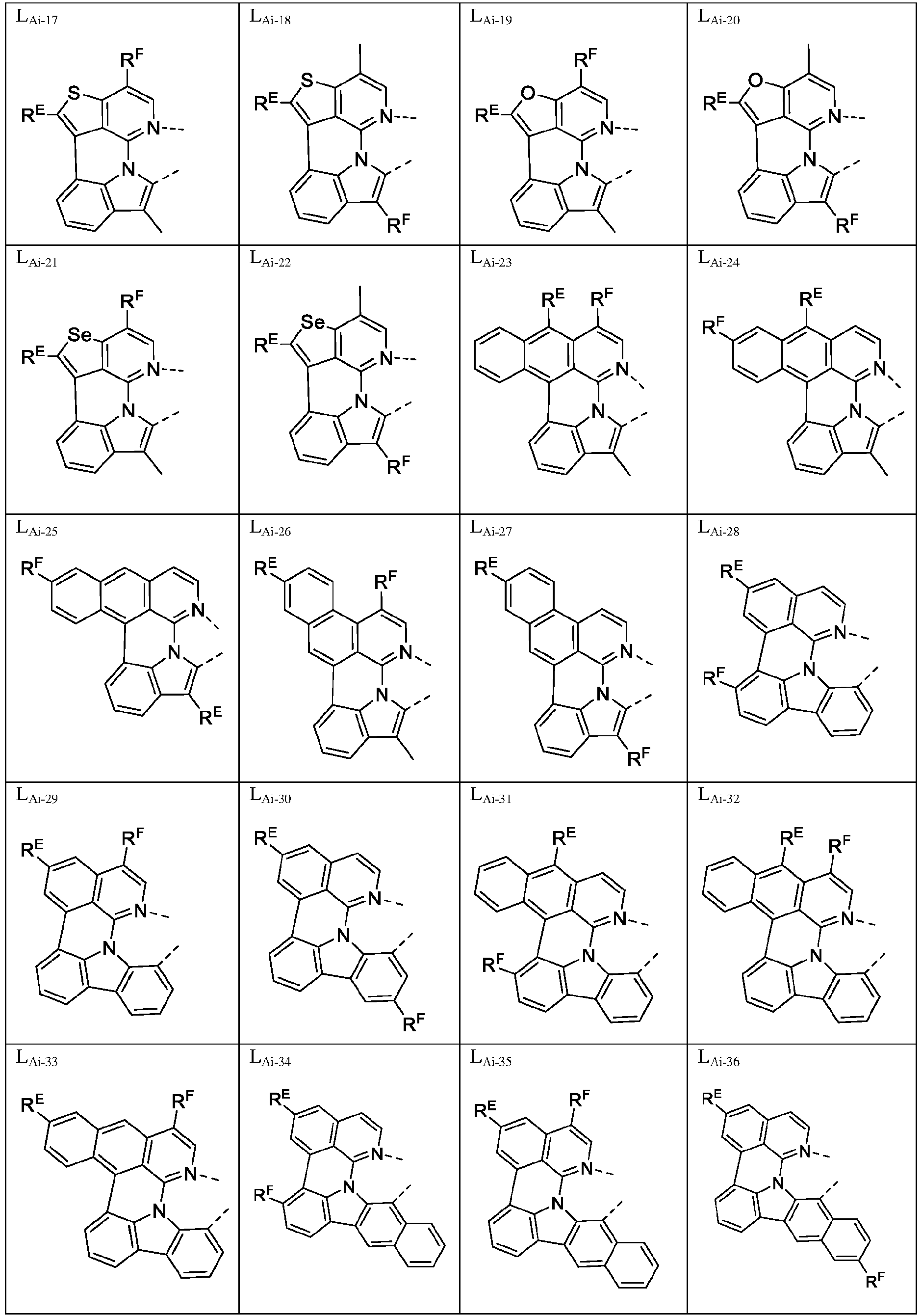 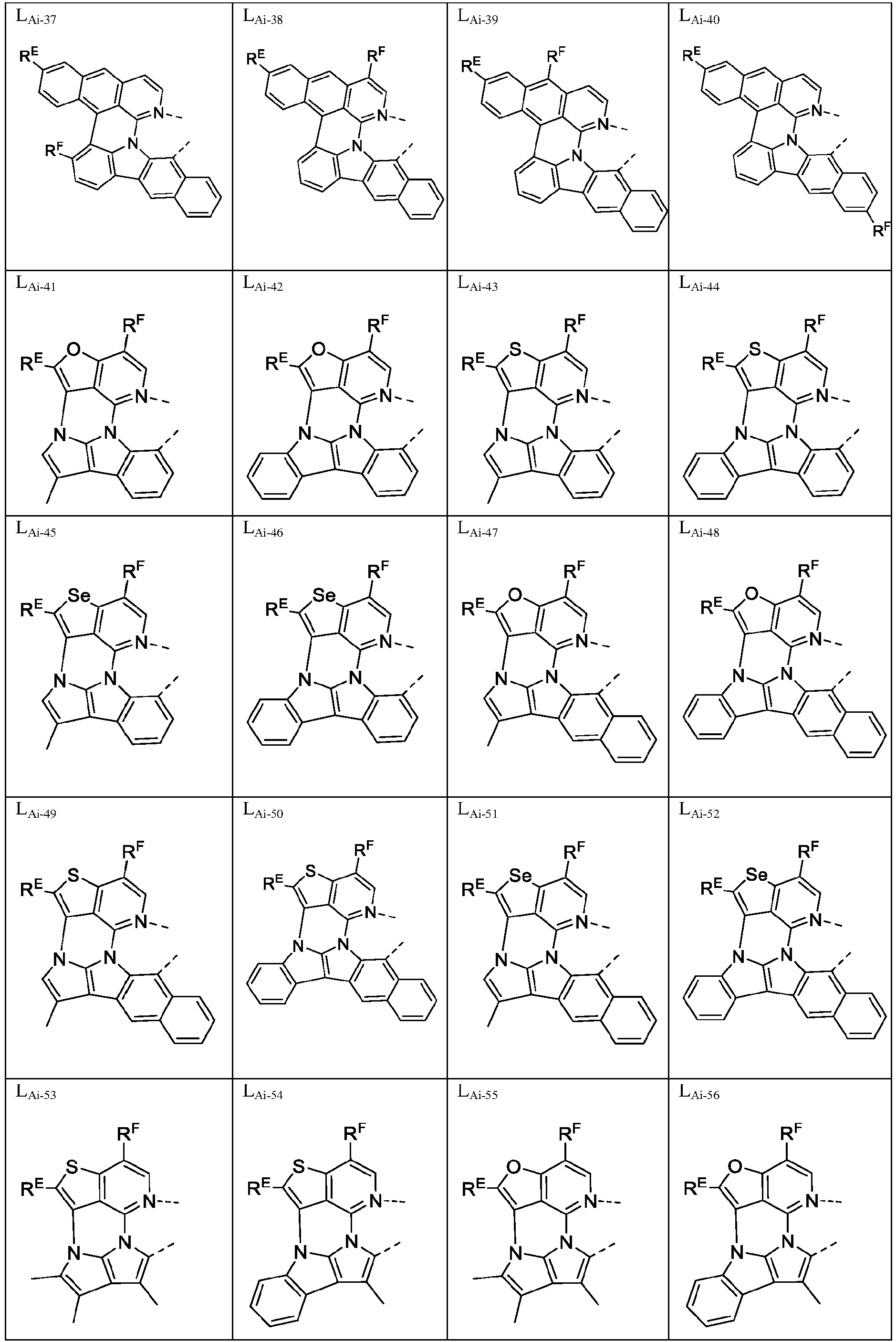 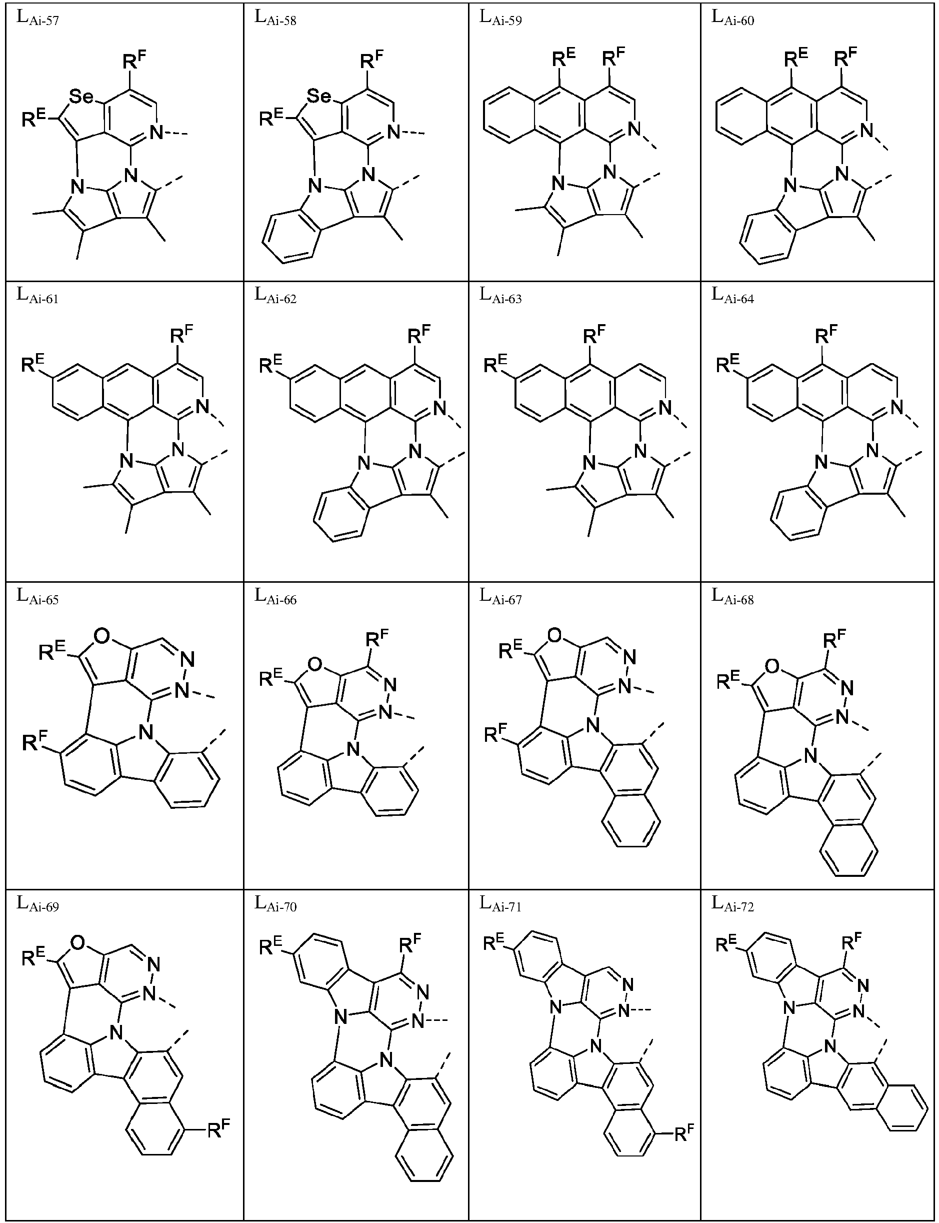 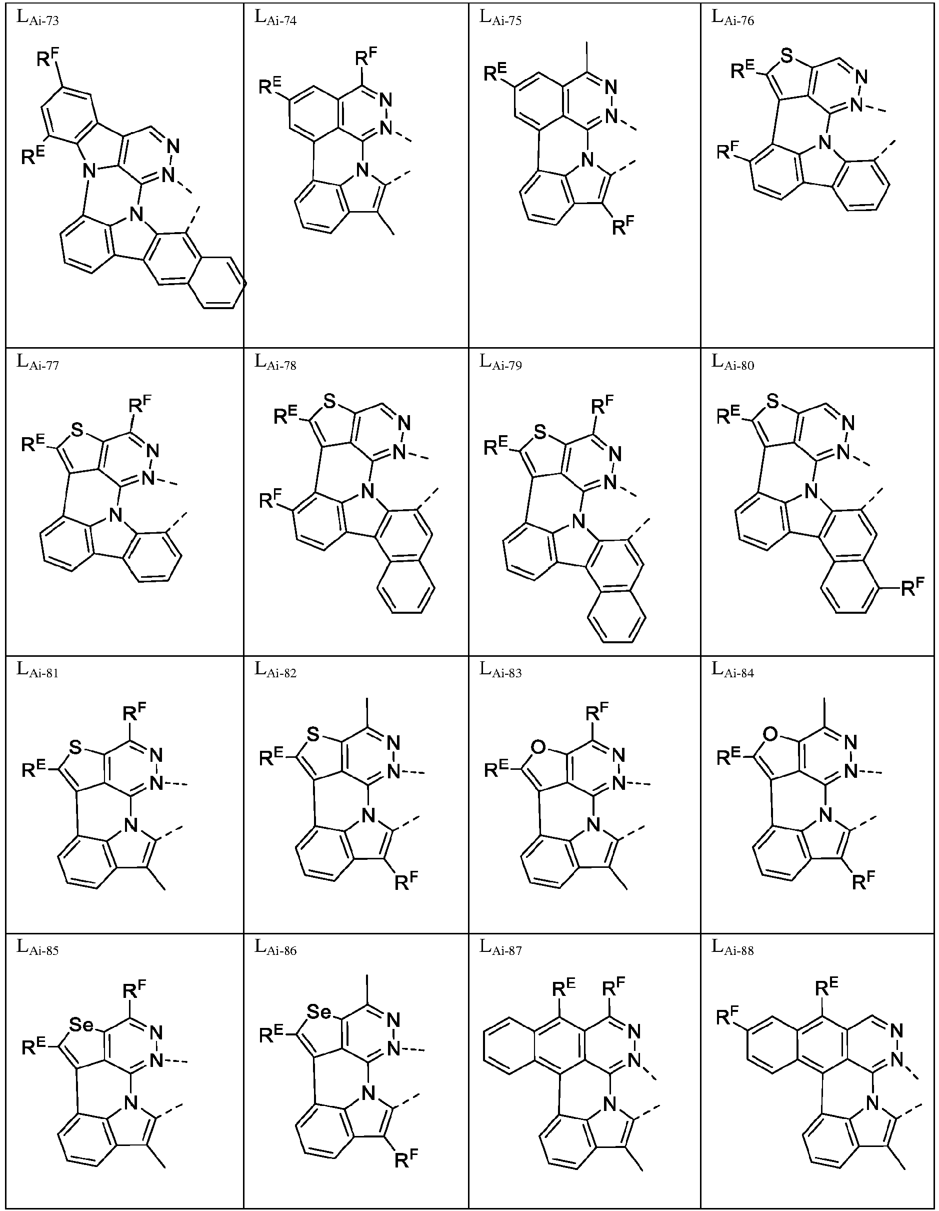 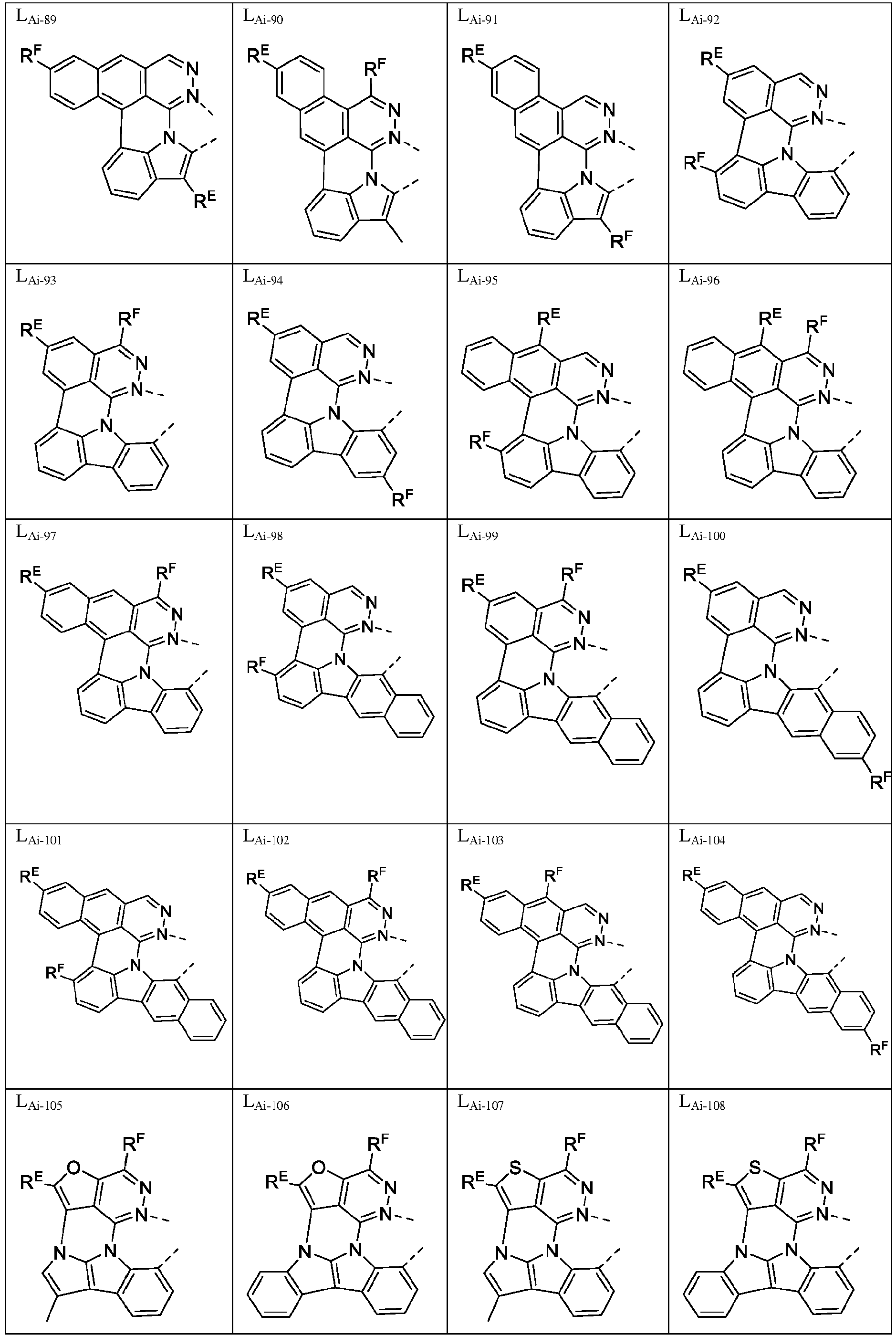 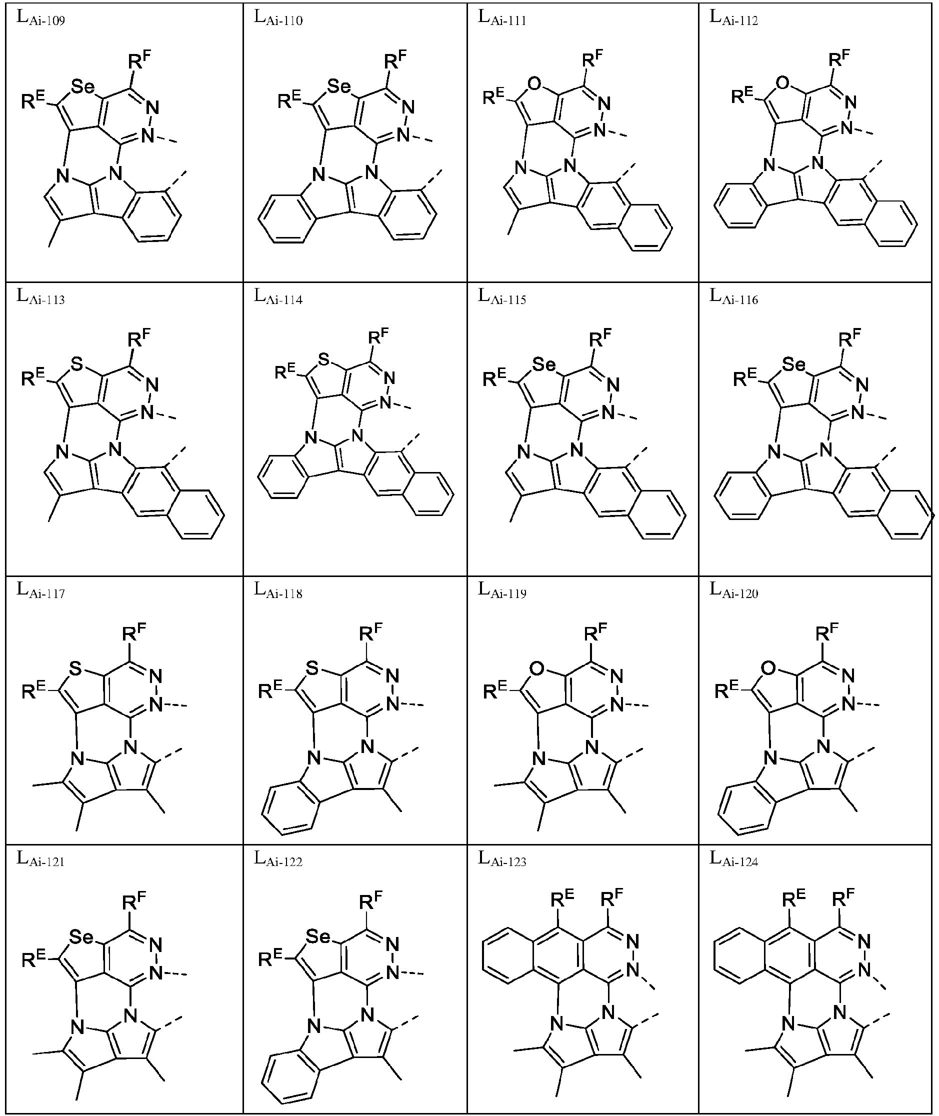 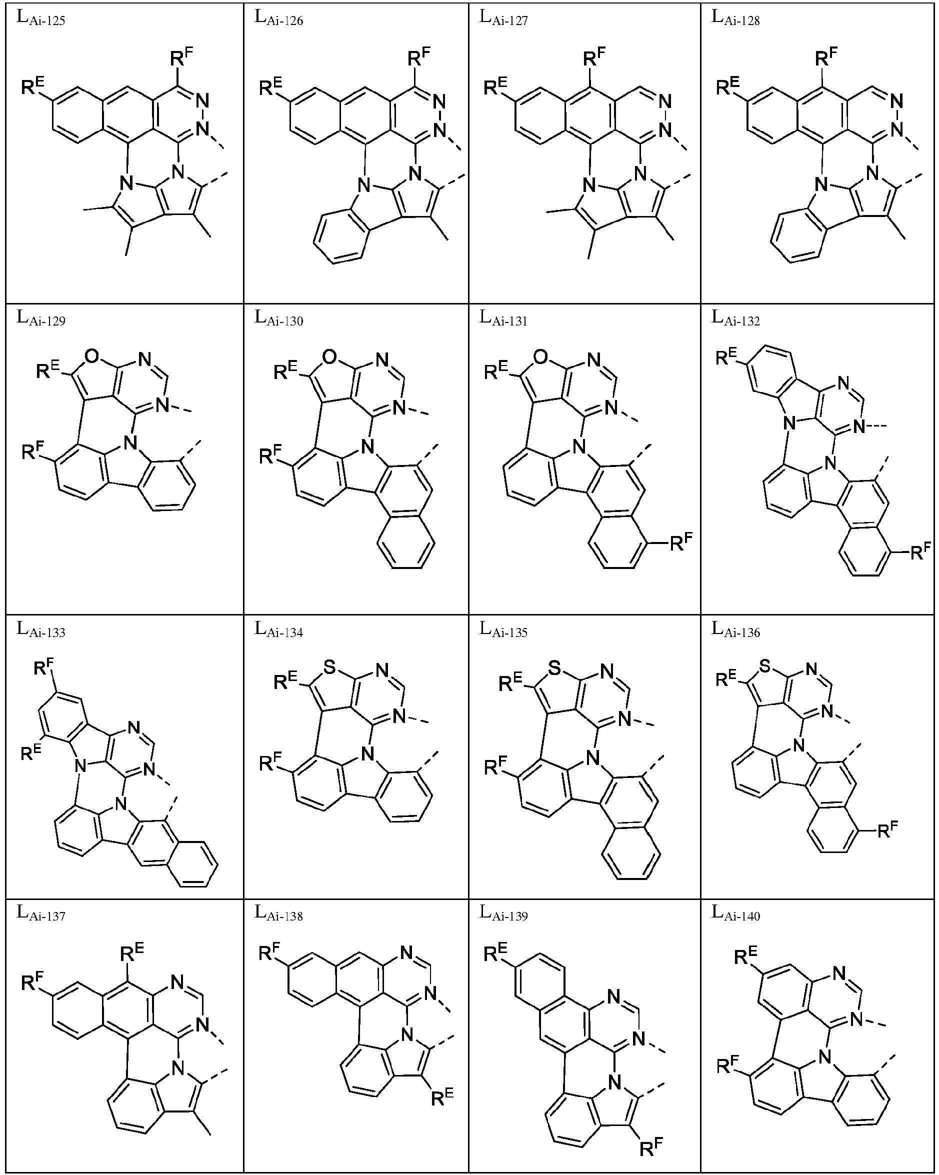 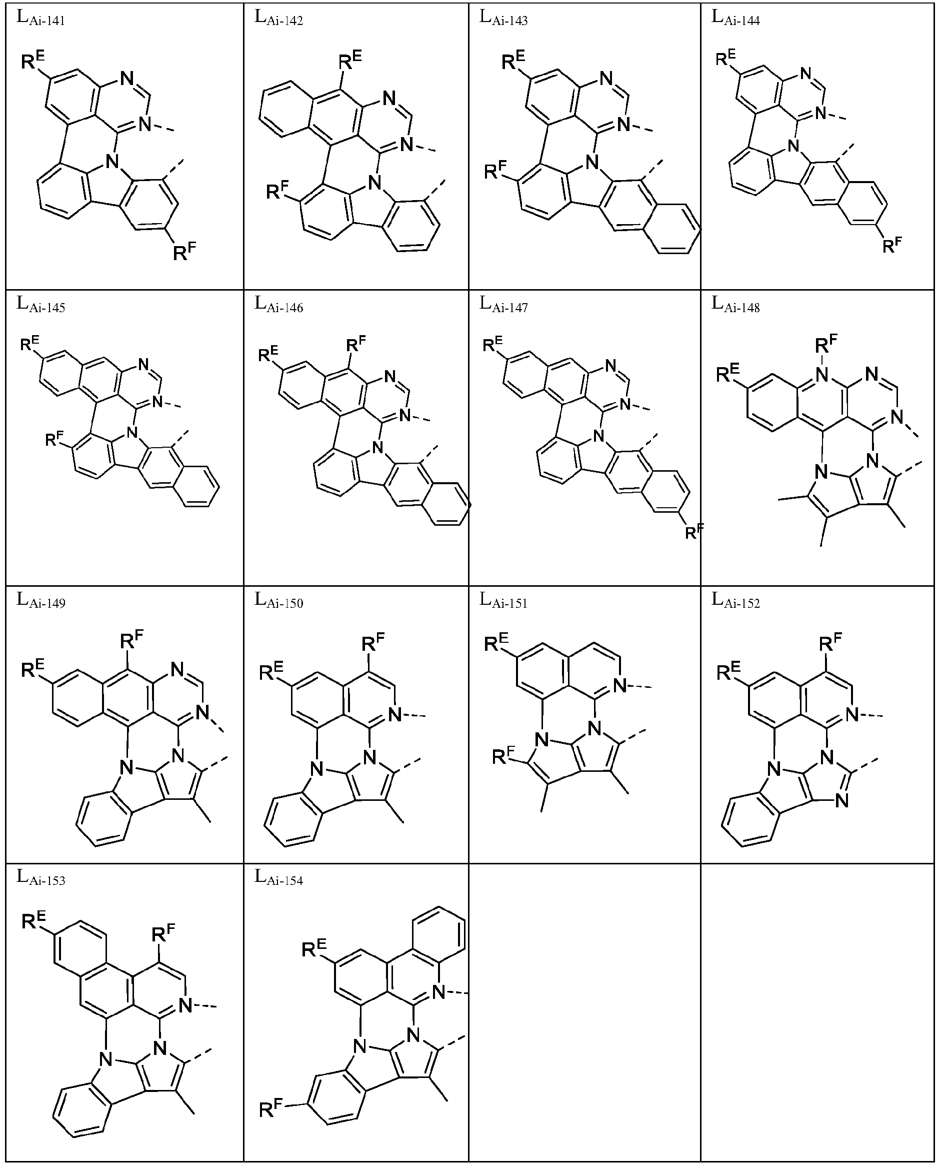 wherein, for each i, R^{E} and R^{F} are defined as follows: 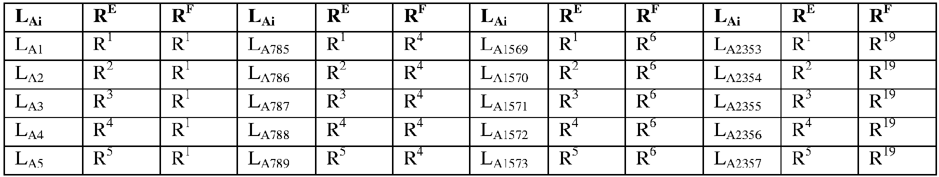 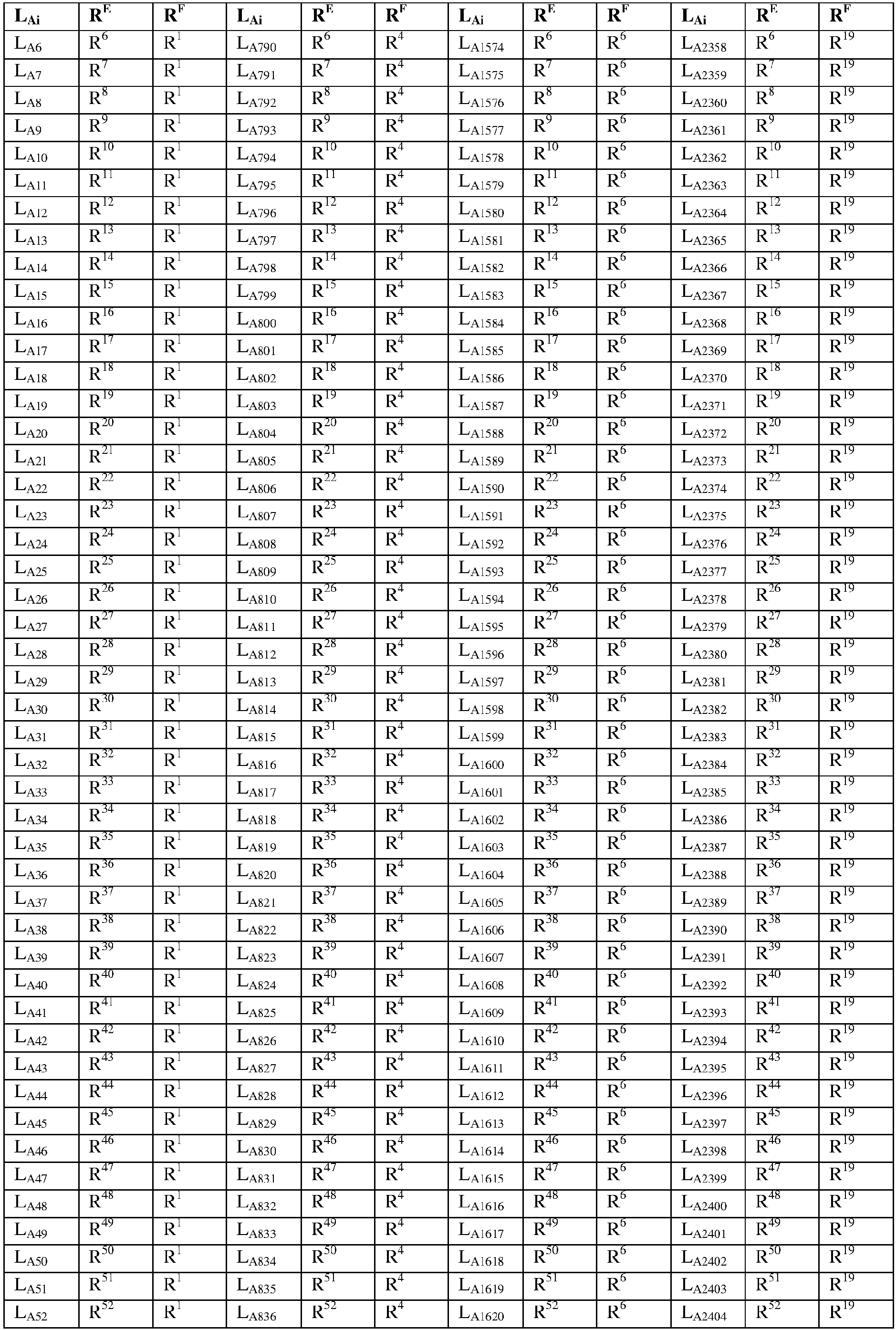 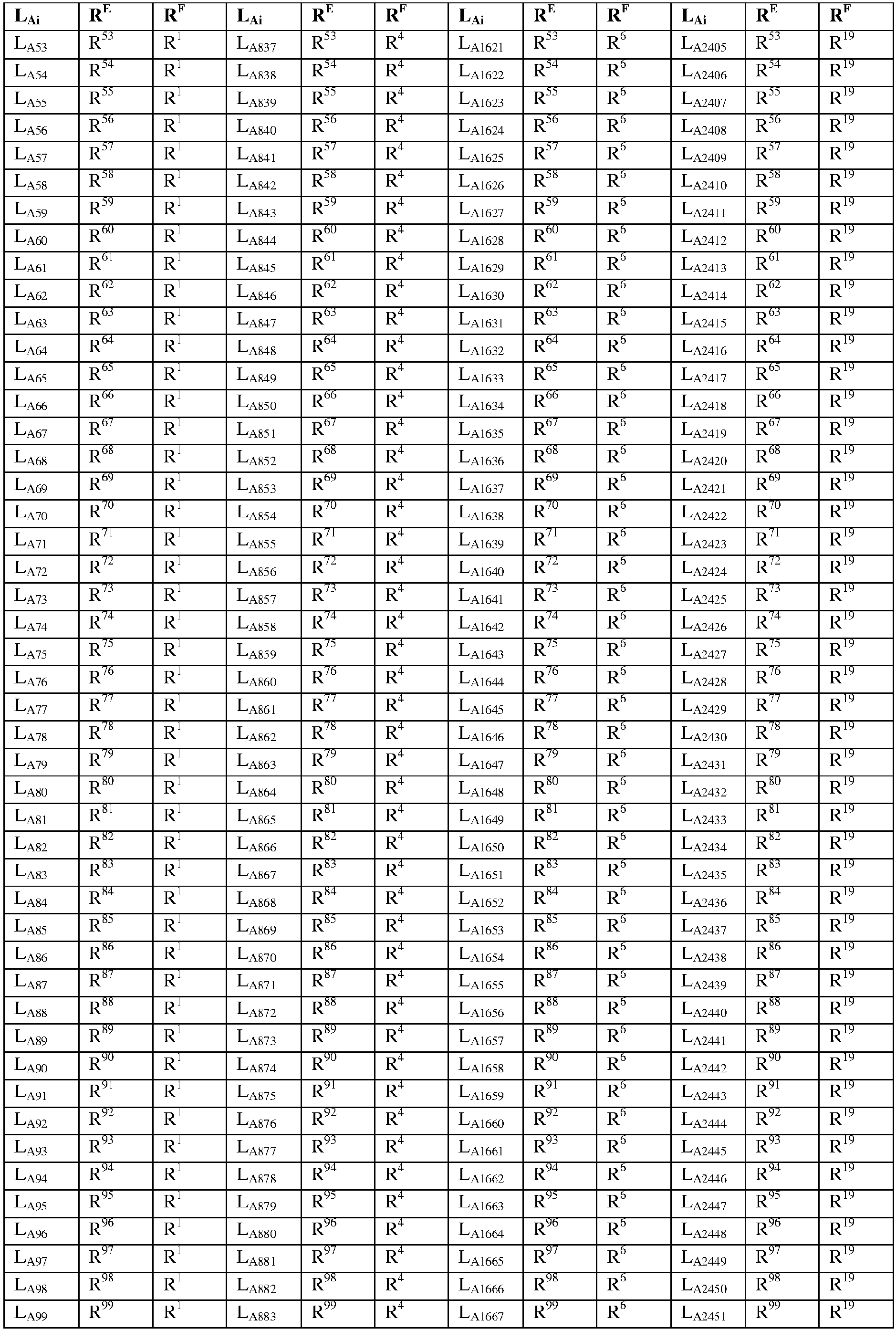 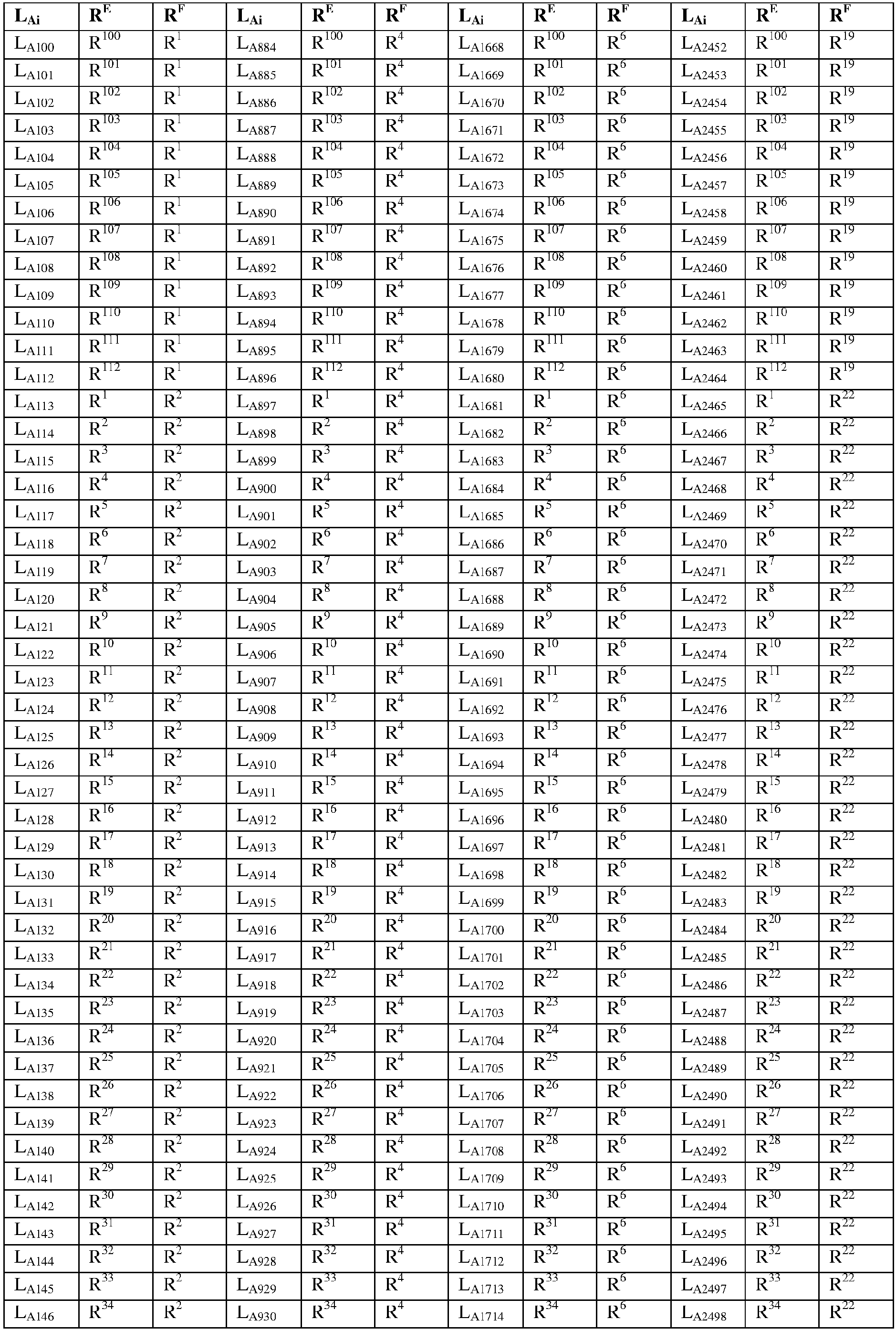 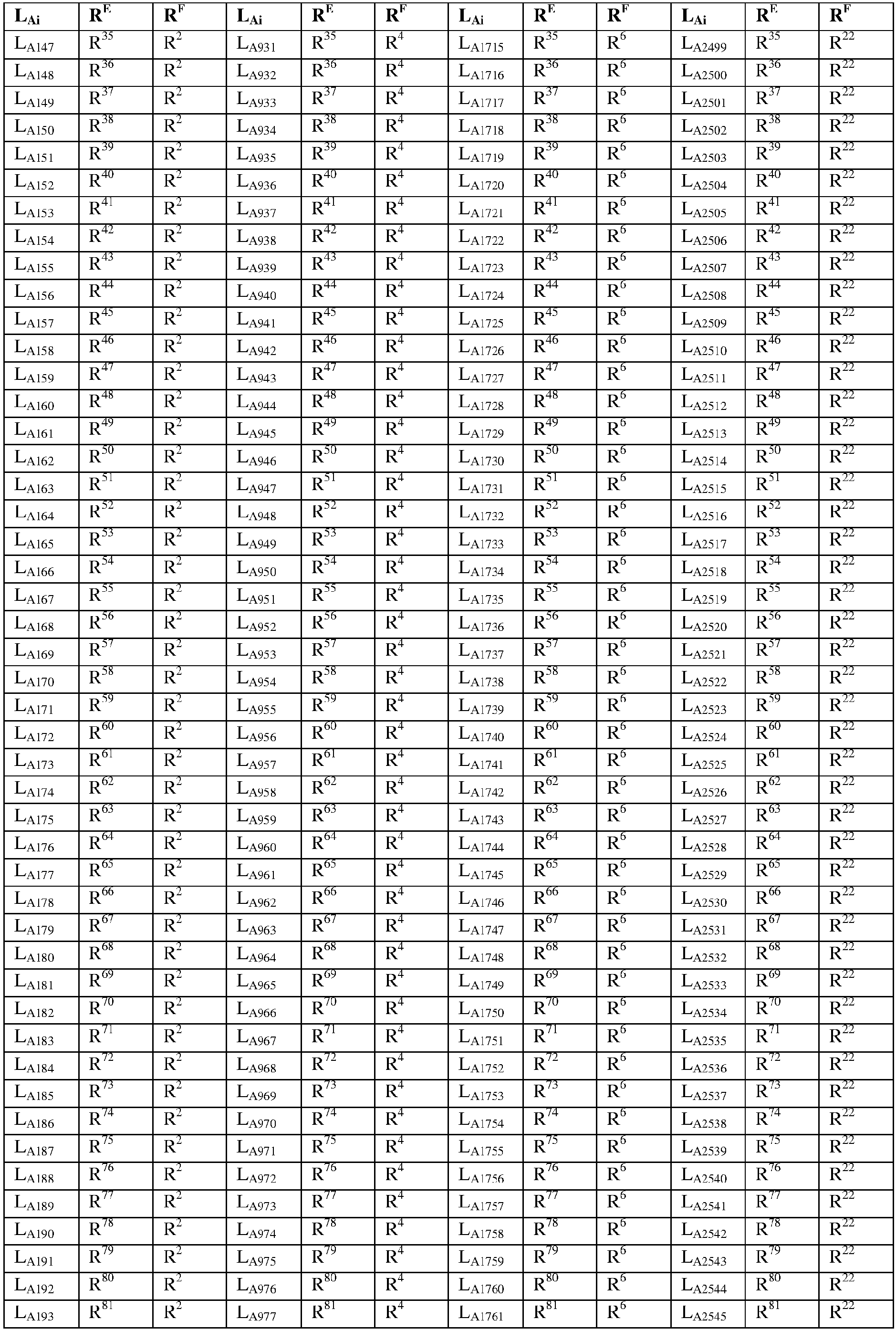 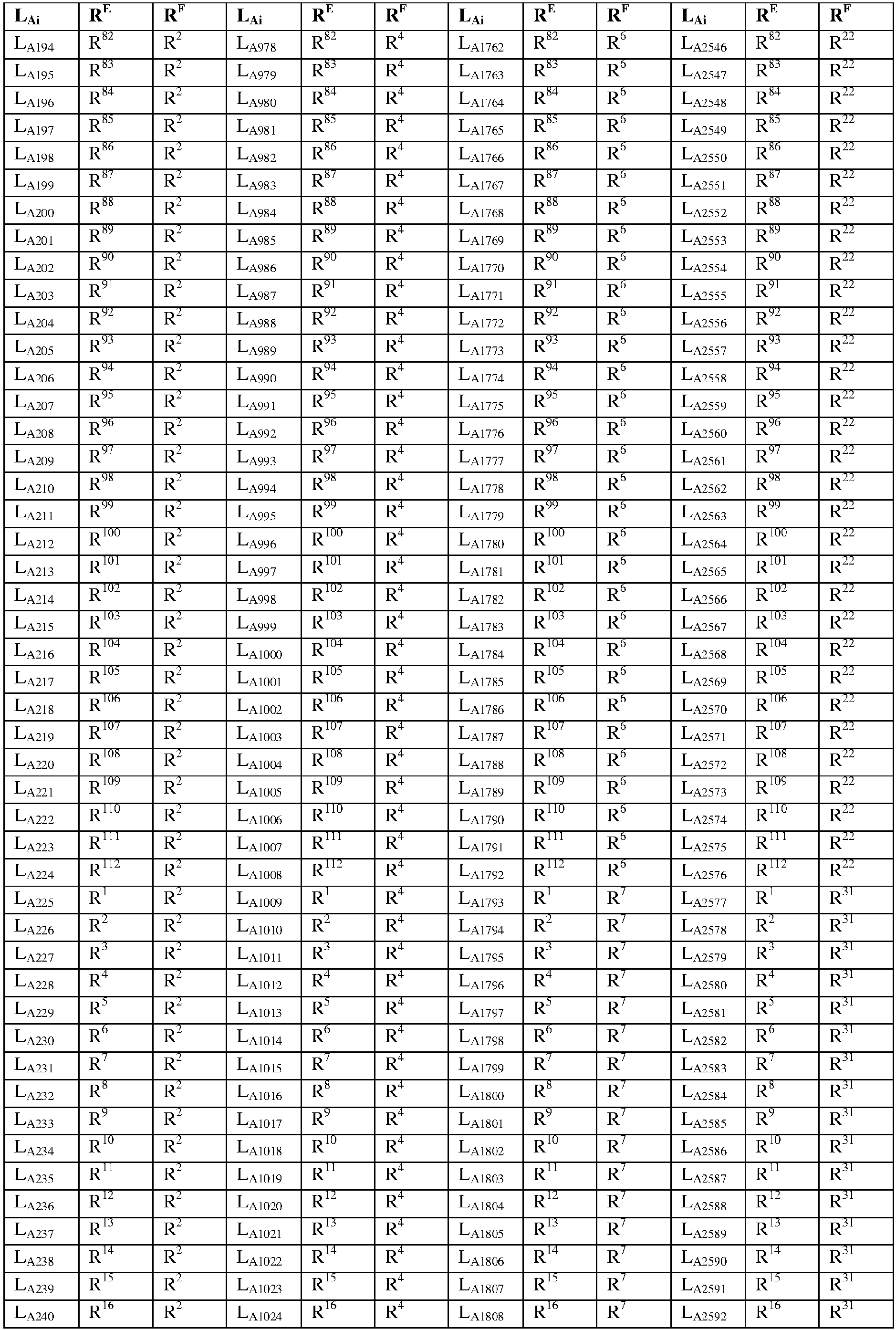 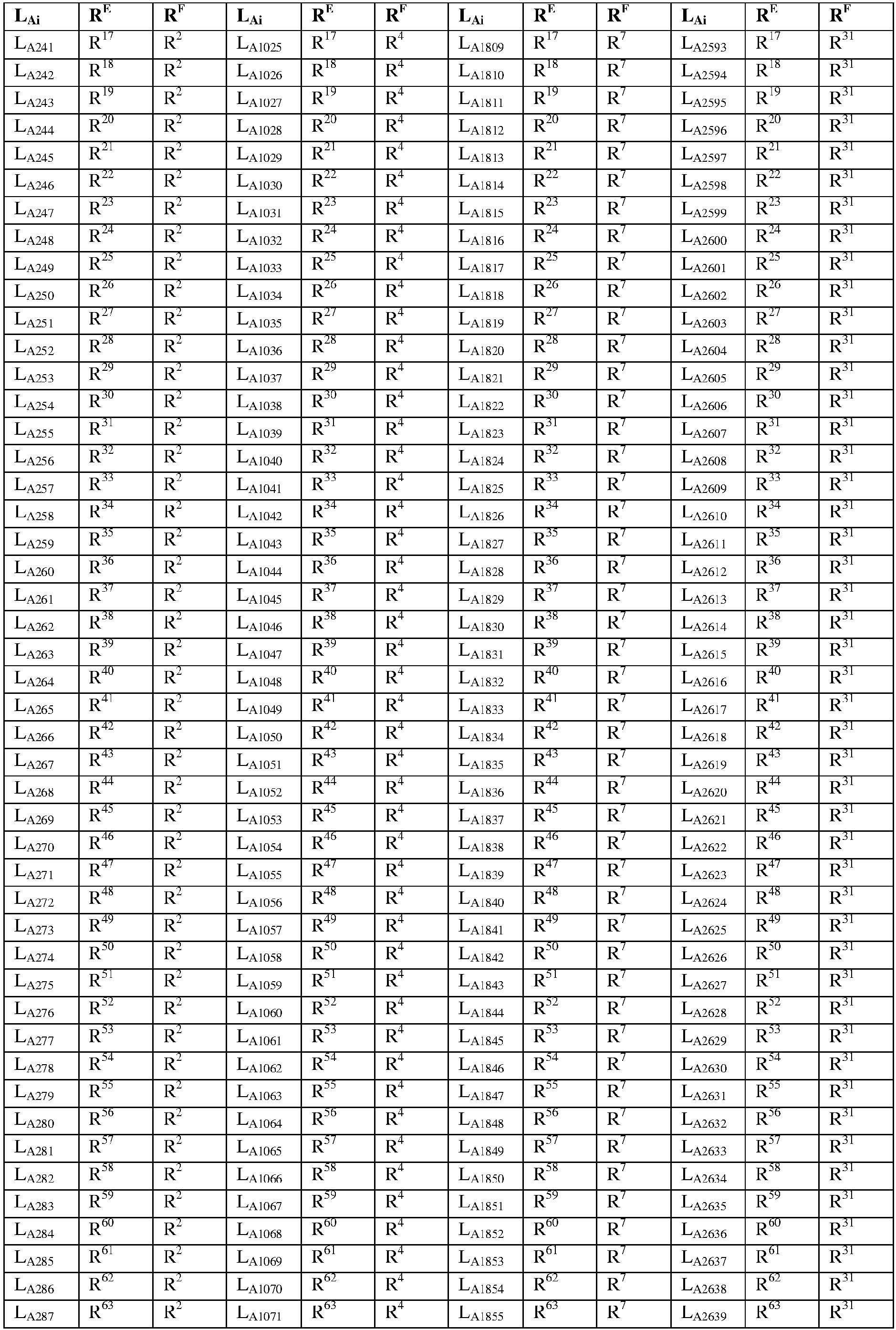 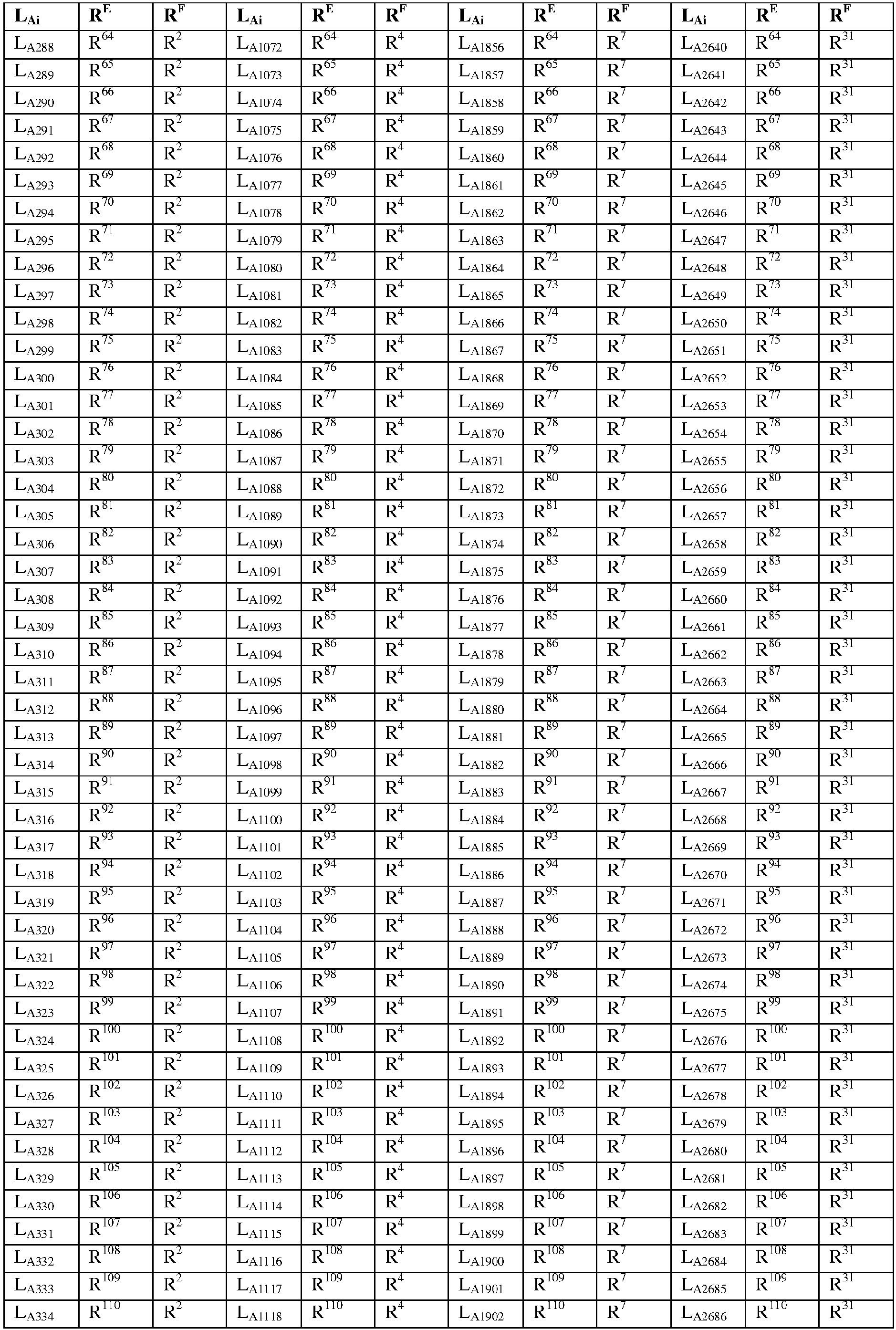 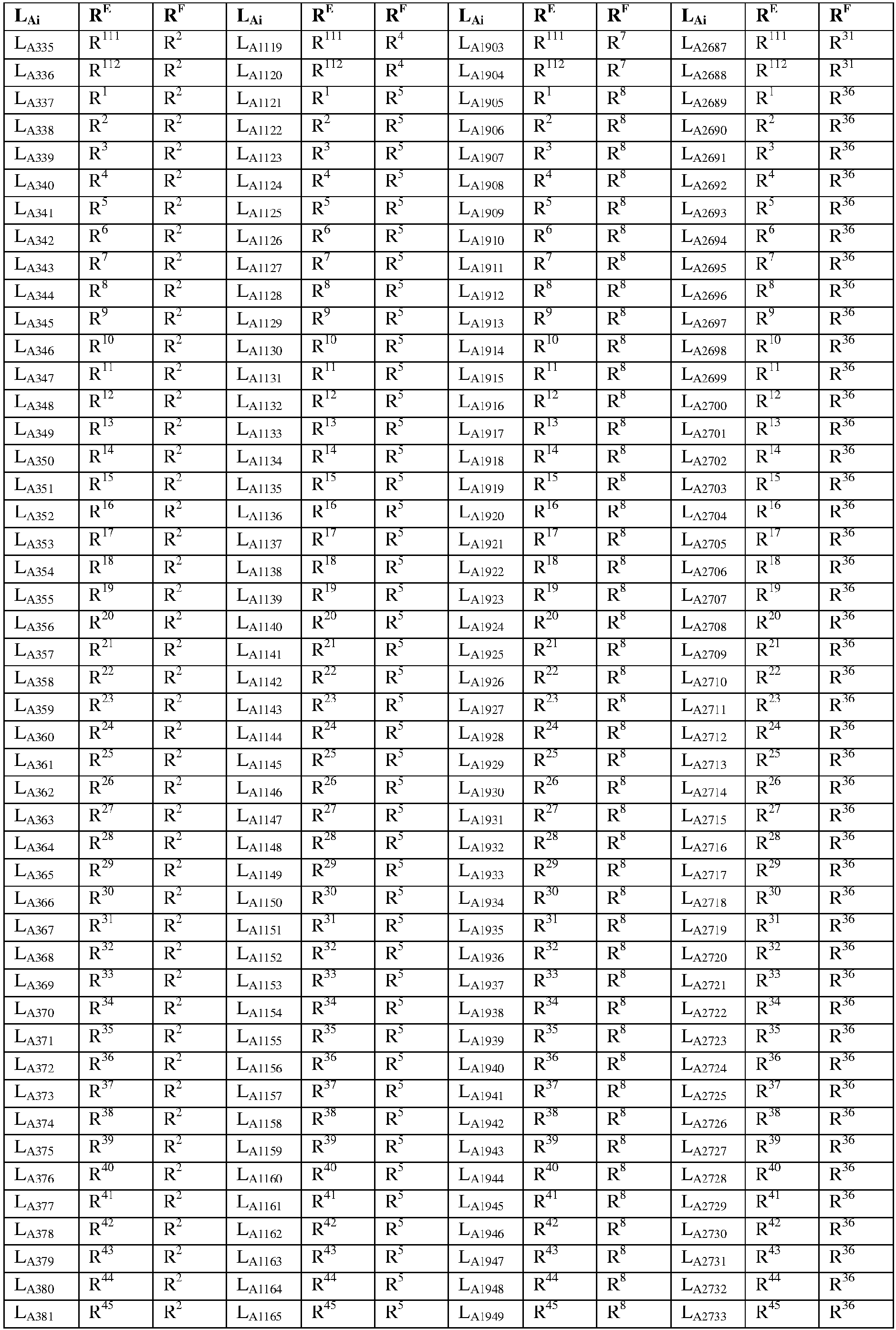 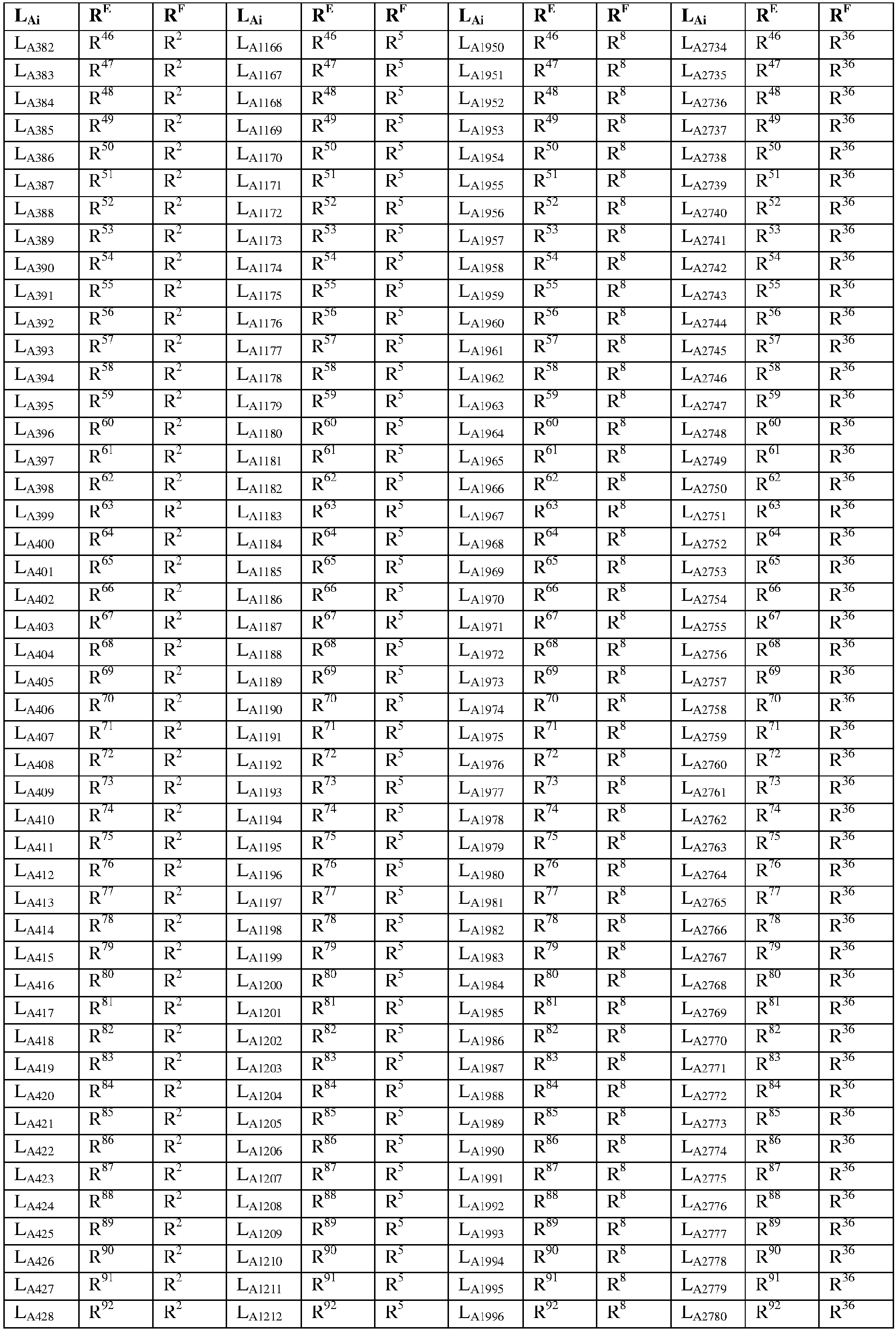 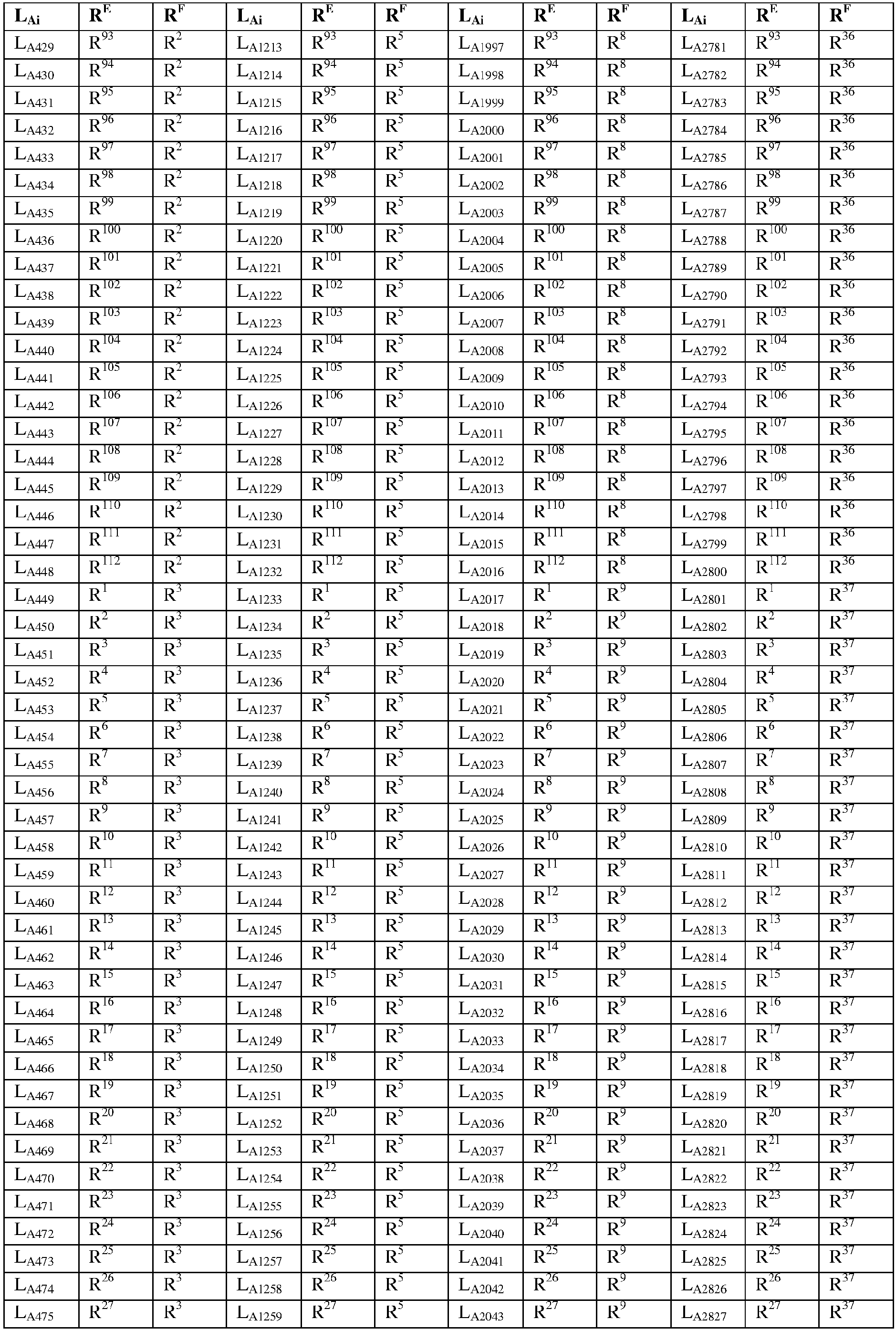 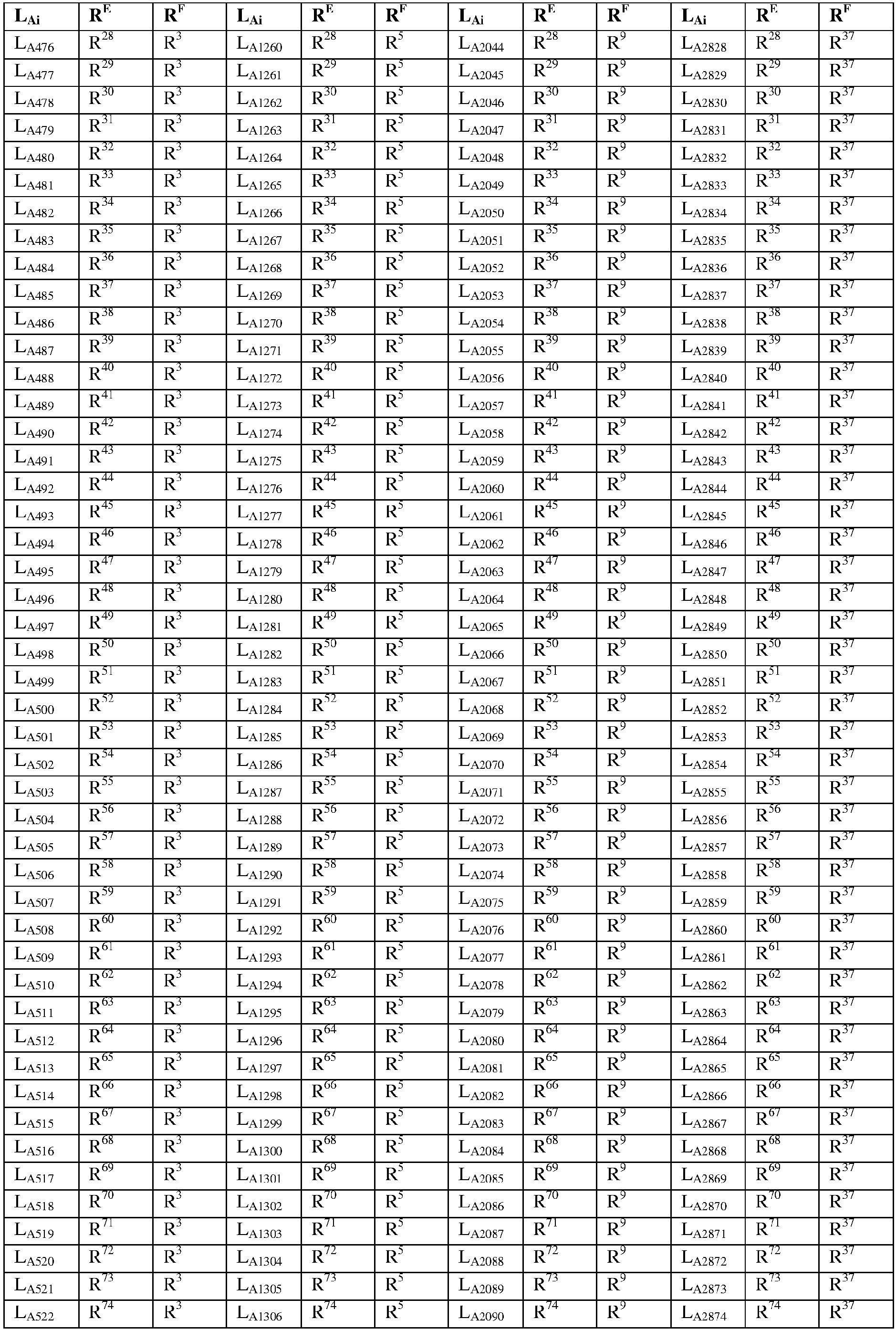 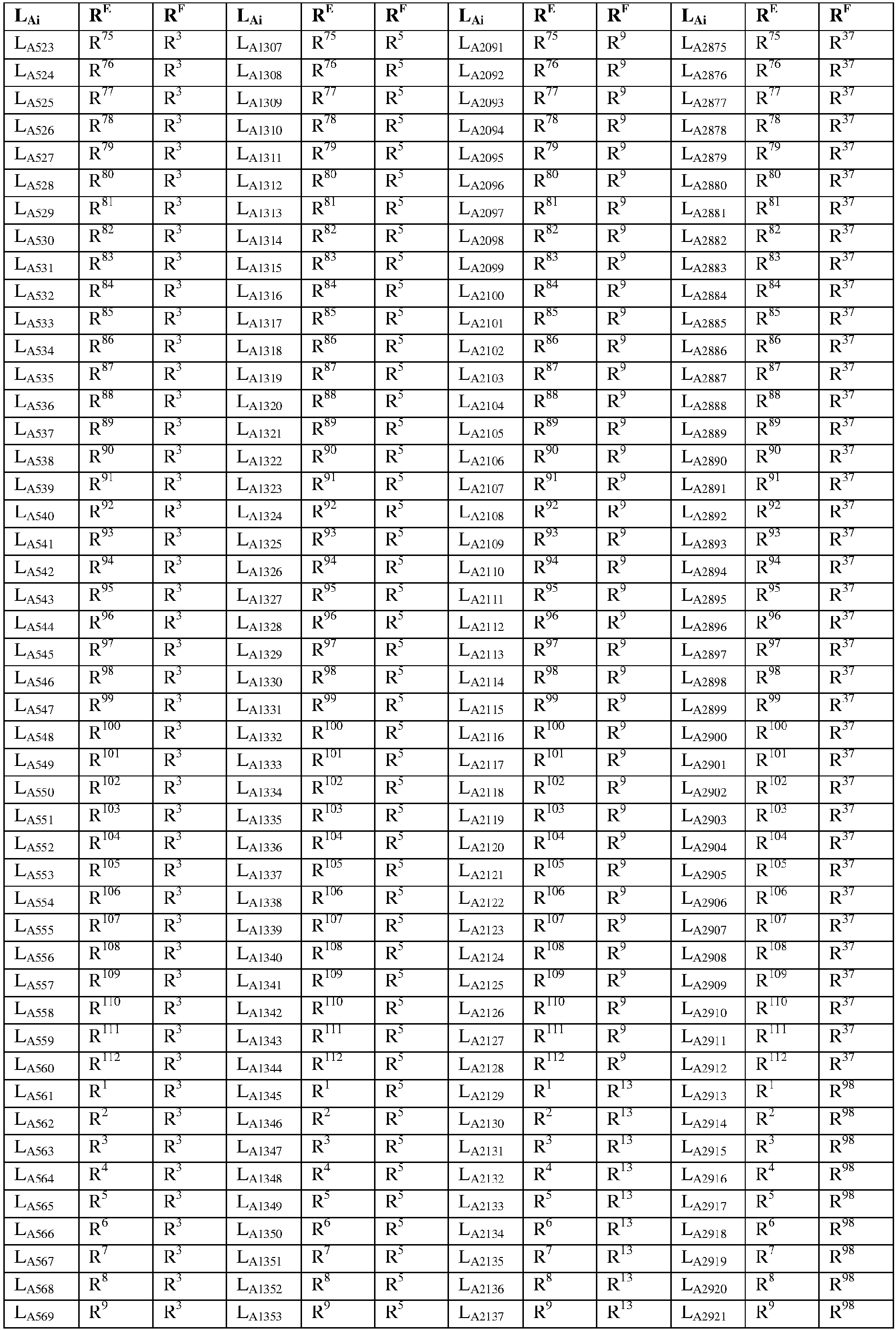 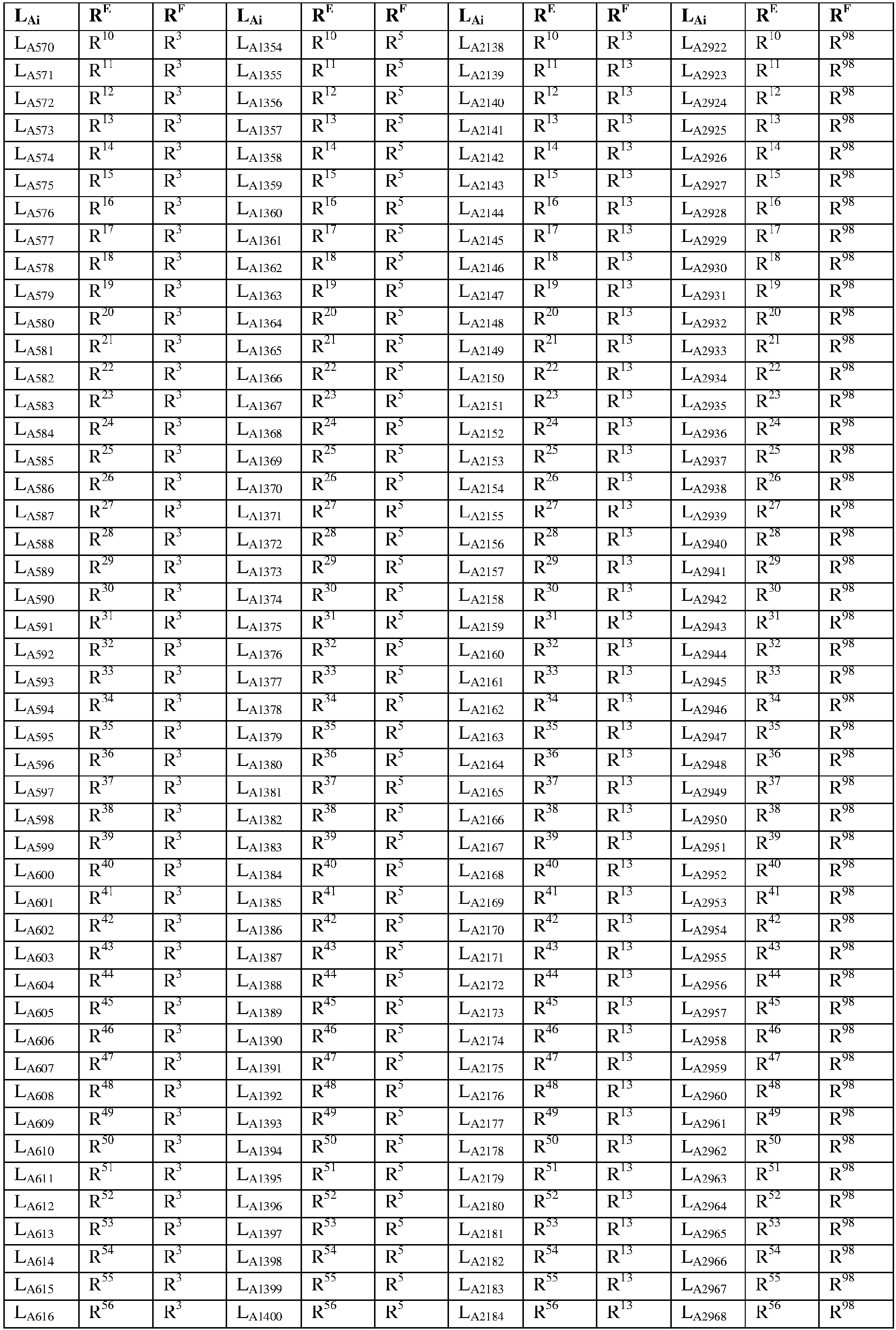 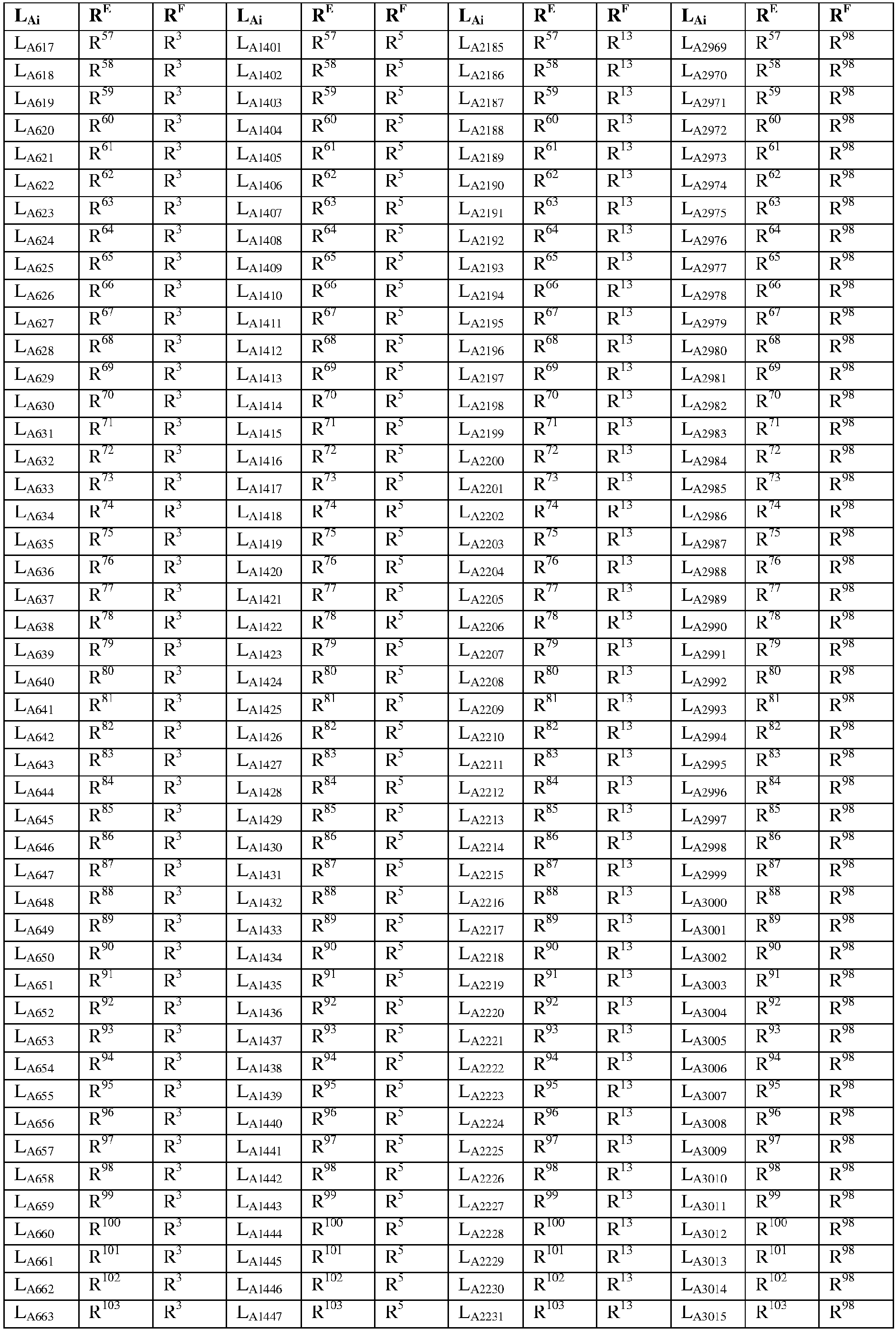 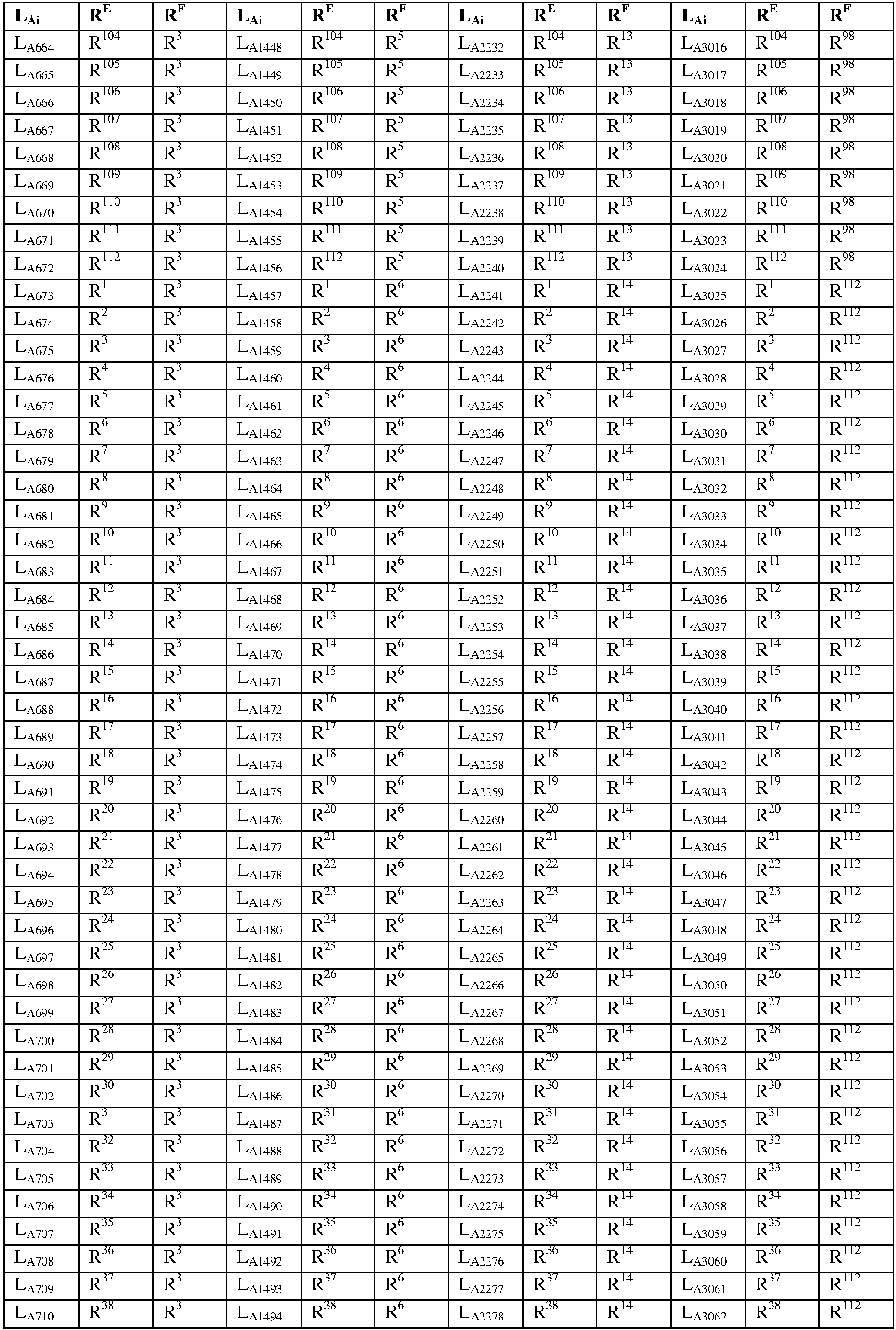 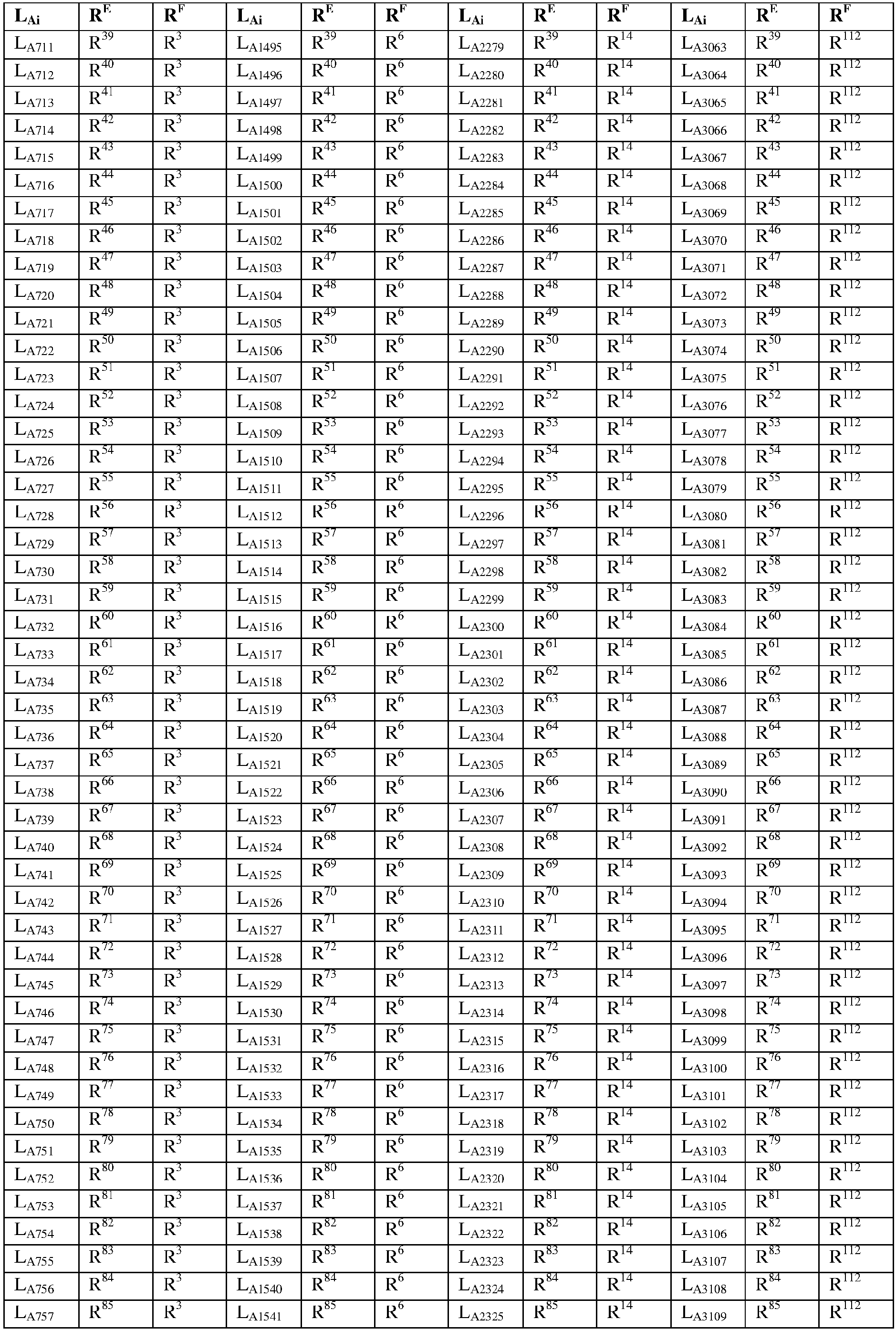 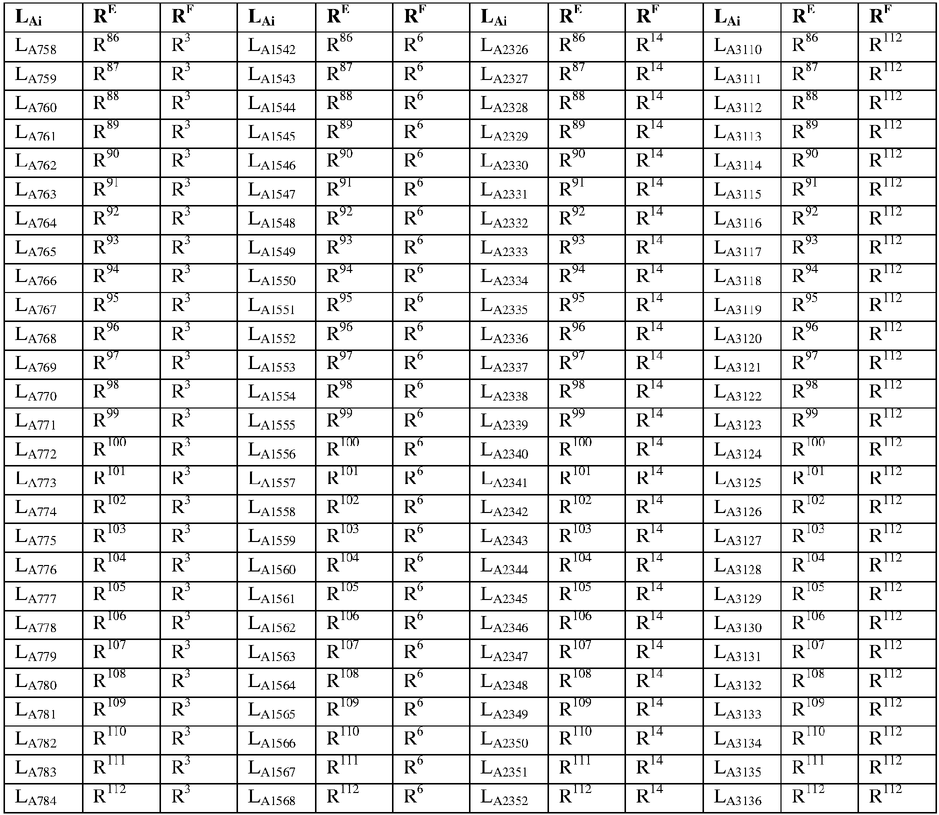 wherein R¹ to R¹¹² have the following structures:

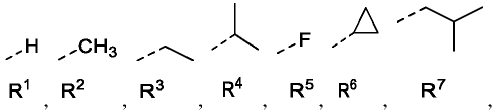

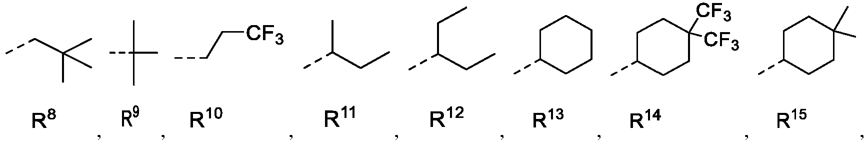

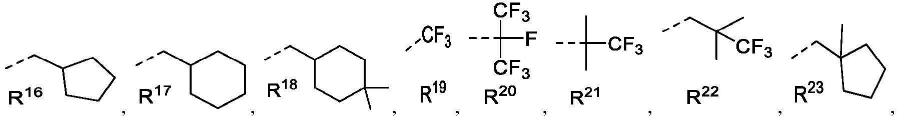

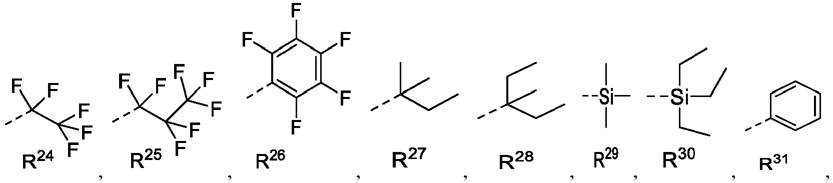

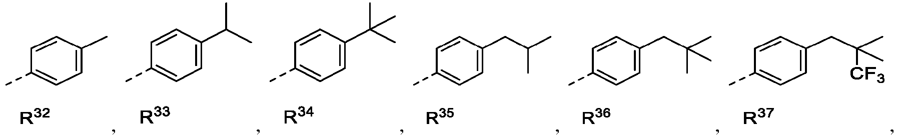

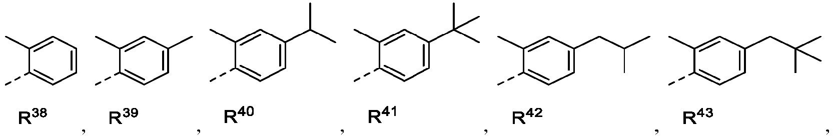

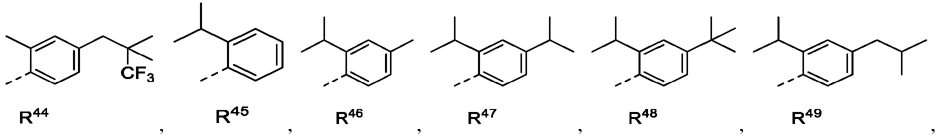

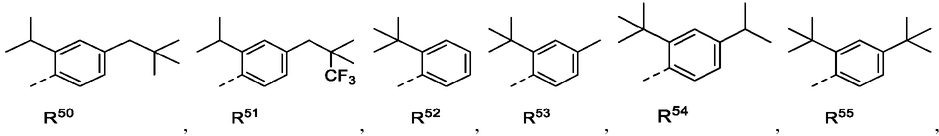

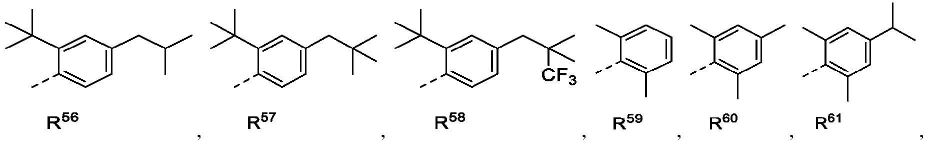

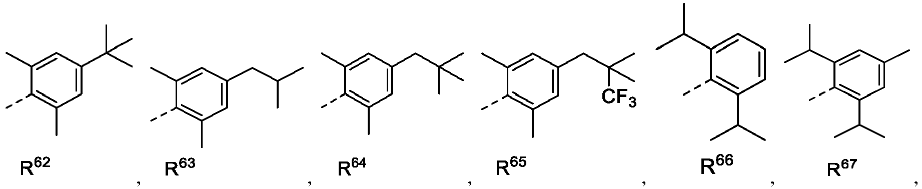

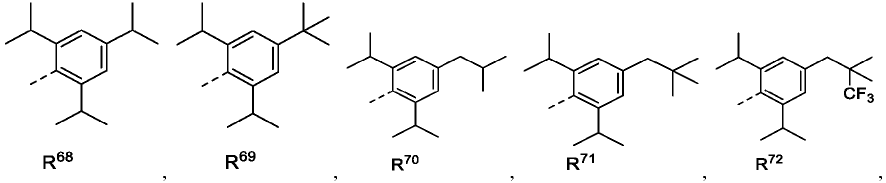

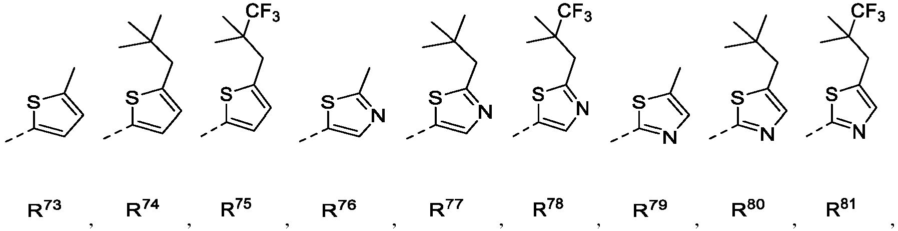

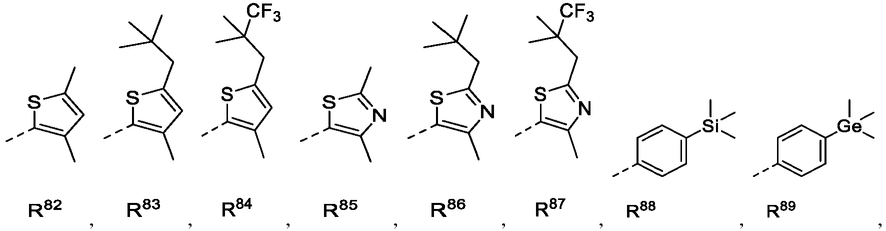

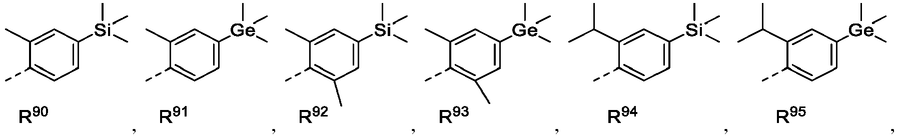

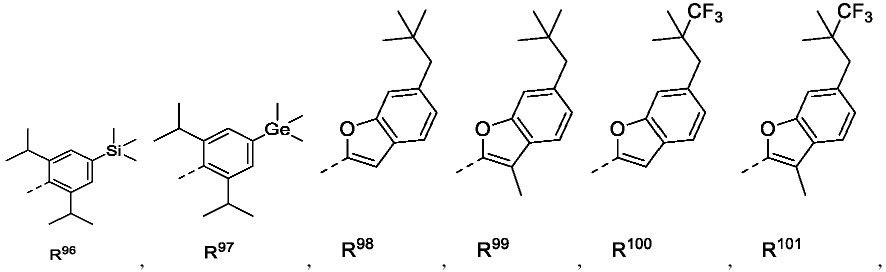

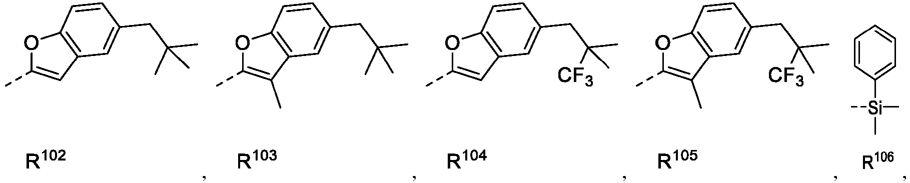

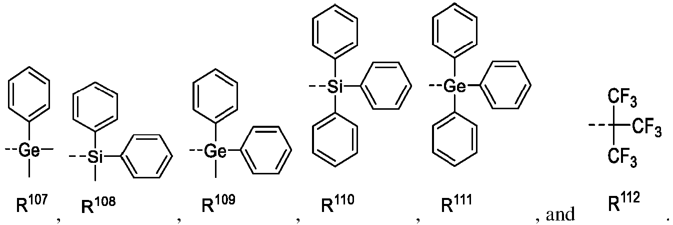

8. The compound of claim 1, wherein the compound has a formula of M(L_{A})ₚ(L_{B})_{q}(L_{C})ᵣ wherein L_{B} and L_{C} are each a bidentate ligand; and wherein p is 1, 2, or 3; q is 0, 1, or 2; r is 0, 1, or 2; and p+q+r is the oxidation state of the metal M.

9. The compound of claim 8, wherein the compound has a formula selected from the group consisting of Ir(L_{A})₃, Ir(L_{A})(L₃)₂, Ir(L_{A})₂(L₃), Ir(L_{A})₂(L_{C}), and Ir(L_{A})(L_{B})(L_{C}); and wherein L_{A}, L_{B}, and L_{C} are different from each other; or a formula of Pt(L_{A})(L_{B}); and wherein L_{A} and L_{B} can be same or different.

10. The compound of claim 8, wherein L_{B} and L_{C} are each independently selected from the group consisting of: 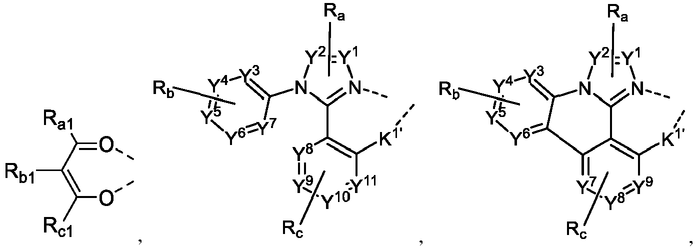 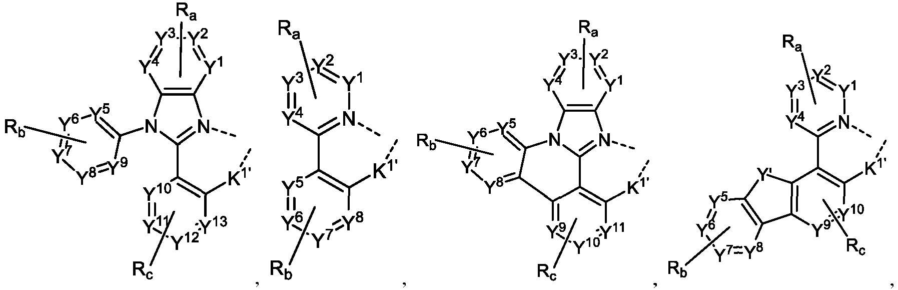 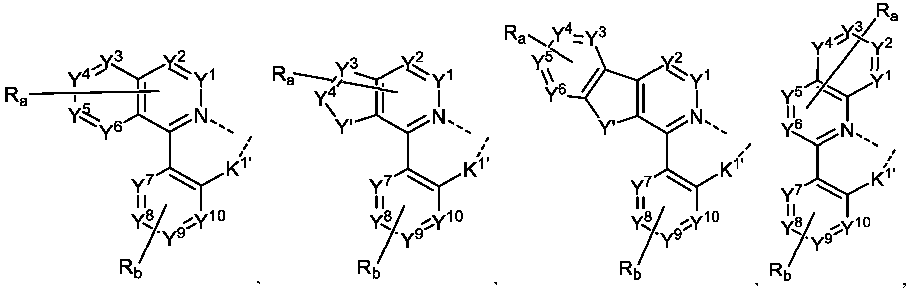 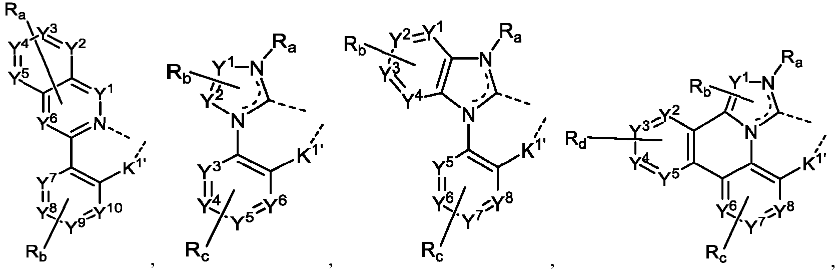 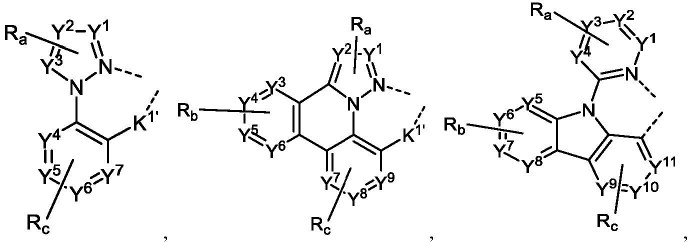 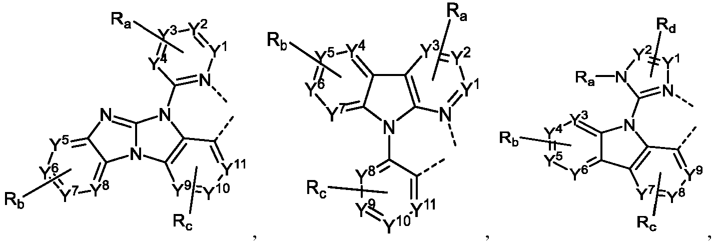 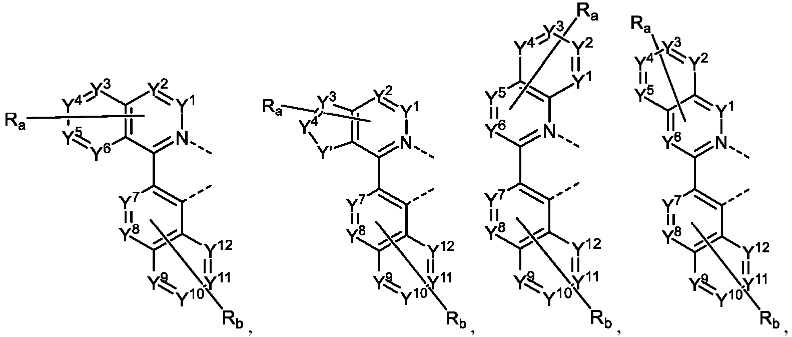 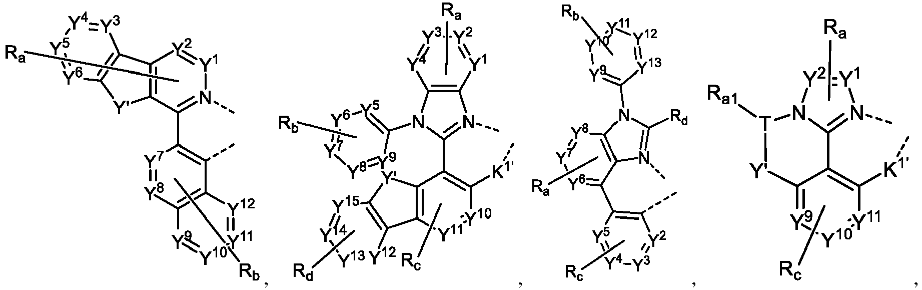 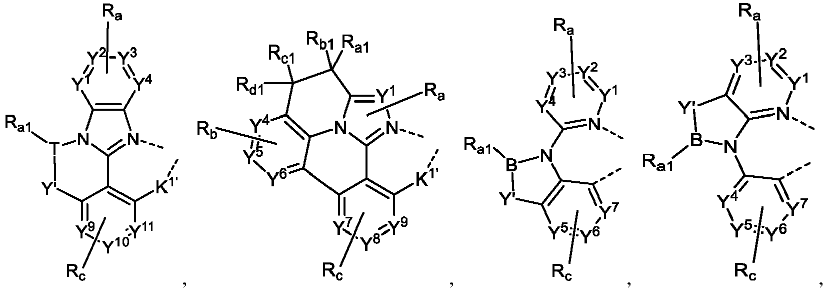 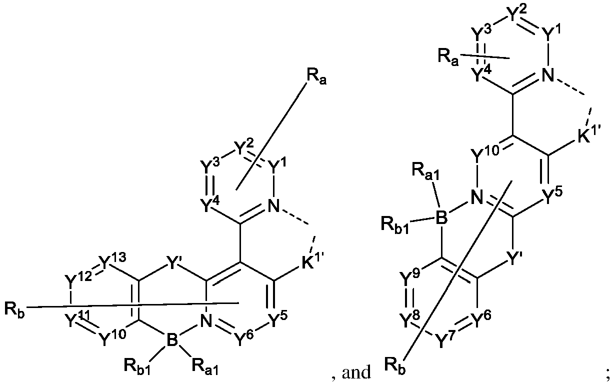 wherein:
T is selected from the group consisting of B, Al, Ga, and In;
K^{1'} is selected from the group consisting of a single bond, O, S, NRₑ, PRₑ, BRₑ, CRₑR_{f}, and SiRₑR_{f};
each of Y¹ to Y¹³ is independently selected from the group consisting of C and N;
Y' is selected from the group consisting of BRₑ, BRₑR_{f}, NRₑ, PRₑ, P(O)Rₑ, O, S, Se, C=O, C=S, C=Se, C=NRₑ, C=CRₑR_{f}, S=O, SO₂, CRₑR_{f}, SiRₑR_{f}, and GeRₑR_{f};
Rₑ and R_{f} can be fused or joined to form a ring;
each Rₐ, R_{b}, R_{c}, and R_{d} independently represents from mono to the maximum allowed number of substitutions, or no substitution;
each of Rₐ₁, R_{b1}, R_{c1}, R_{d1}, Rₐ, R_{b}, R_{c}, R_{d}, Rₑ, and R_{f} is independently a hydrogen or a subsituent selected from the group consisting of deuterium, halide, alkyl, cycloalkyl, heteroalkyl, arylalkyl, alkoxy, aryloxy, amino, silyl, germyl, boryl, alkenyl, cycloalkenyl, heteroalkenyl, alkynyl, aryl, heteroaryl, acyl, carbonyl, carboxylic acid, ester, nitrile, isonitrile, sulfanyl, selenyl, sulfinyl, sulfonyl, phosphino, and combinations thereof; and
any two substituents of Rₐ₁, R_{b1}, R_{c1}, R_{d1}, Rₐ, R_{b}, R_{c}, and R_{d} can be fused or joined to form a ring or form a multidentate ligand.

11. The compound of claim 9, wherein L_{A} can be selected from L_{Ai-m}, wherein i is an integer from 1 to 3136; *m* is an integer from 1 to 154; and L_{B} can be selected from L_{Bk}, wherein *k* is an integer from 1 to 474, wherein:
when the compound has formula Ir(L_{A*i-m*})₃, the compound is selected from the group consisting of Ir(L_{A*1-1*})₃ to Ir(L_{A3136-154})₃;
when the compound has formula Ir(L_{A*i-m*})(L_{B*k*})₂, the compound is selected from the group consisting of Ir(L_{A*1-1*})(L_{B*1*})₂ to Ir(L_{A3136-*154*})(L_{B474})₂;
when the compound has formula Ir(L_{A*i-m*})₂(L_{B*k*}), the compound is selected from the group consisting of Ir(L_{A*1-1*})₂(L_{B*1*}) to Ir(L_{A3136-*154*})₂(L_{B474});
when the compound has formula Ir(L_{A*i-m*})₂(L_{C*j-*I}), the compound is selected from the group consisting of Ir(L_{A*1-1*})₂(L_{C*1-*I}) to Ir(L_{A3136-*154*})₂(L_{C*1416*-I}); and
when the compound has formula Ir(L_{A*i-m*})₂(L_{C*j*-II}), the compound is selected from the group consisting of Ir(L*_{A1-1}*)₂(L_{*C1*-II}) to Ir(L_{A3136-*154*})₂(L_{C*1416*-II});
wherein each L_{B*k*} has the structure defined as follows: 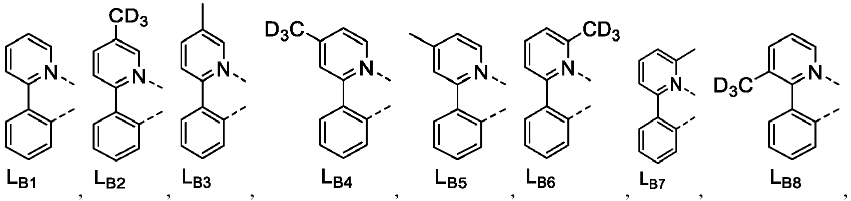 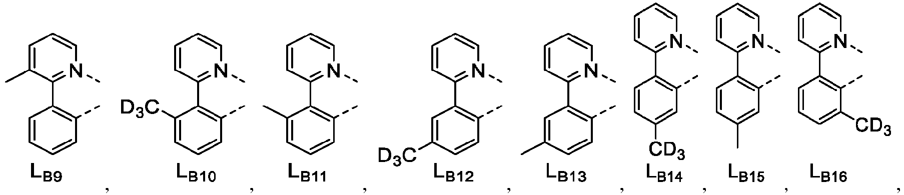 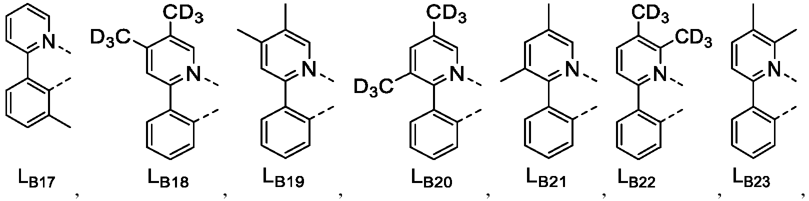 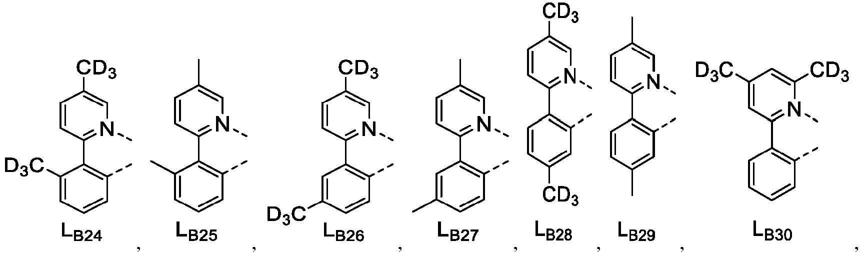 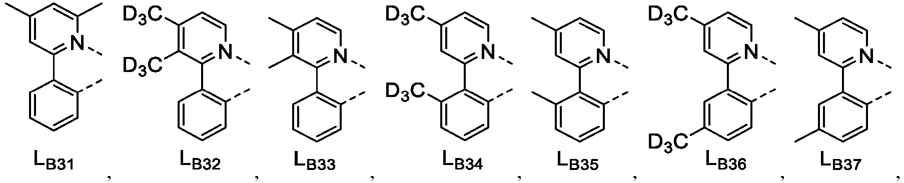 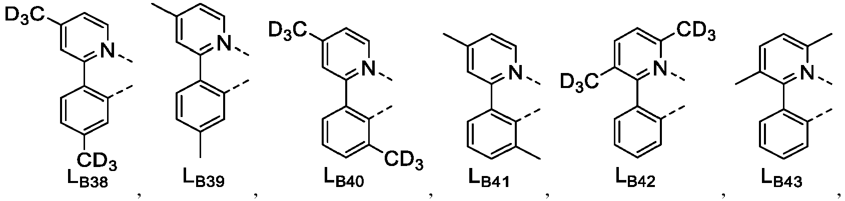 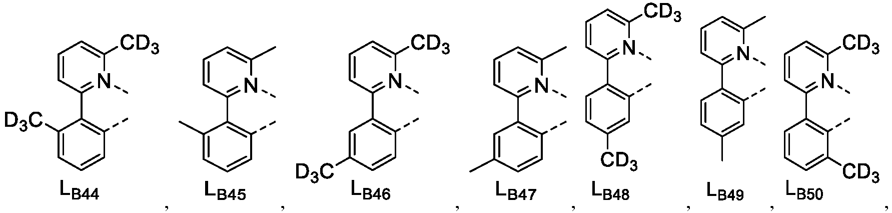 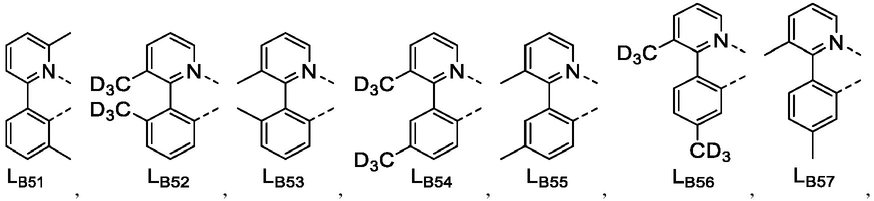 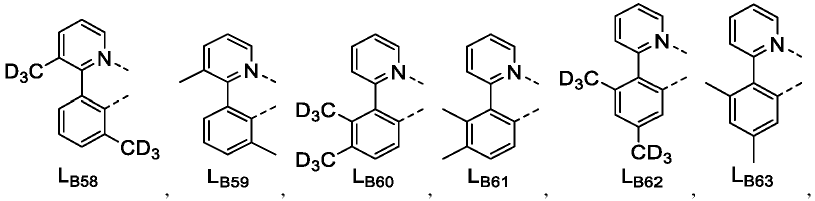 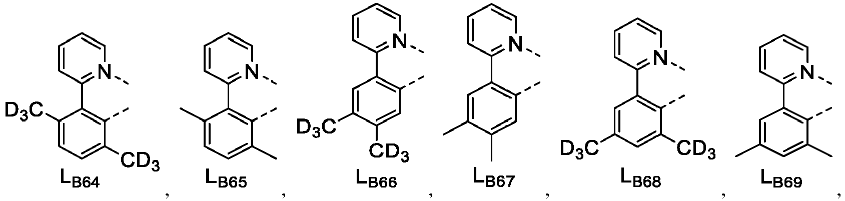 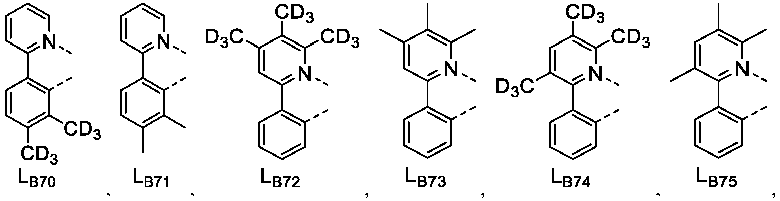 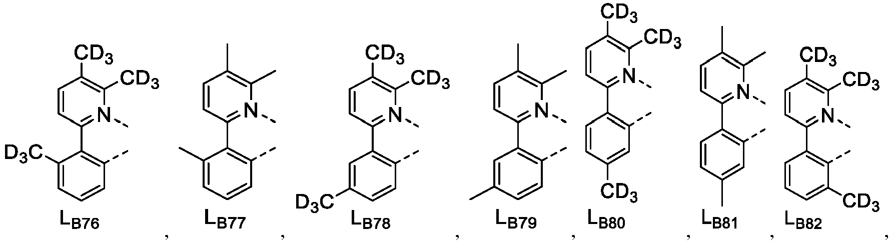 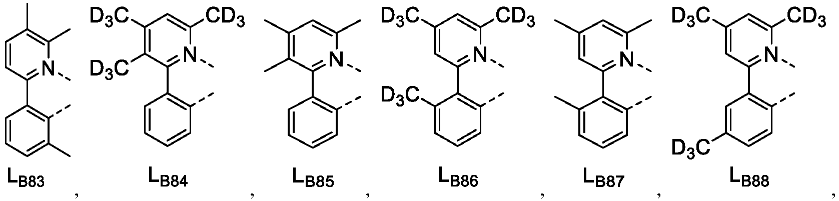 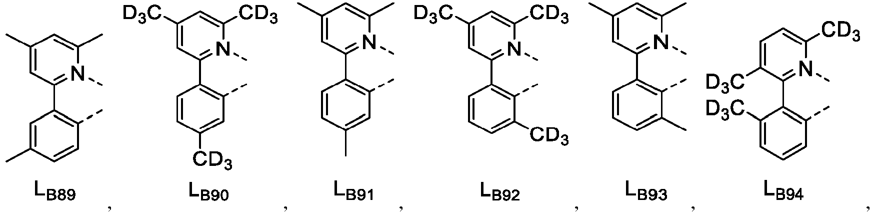 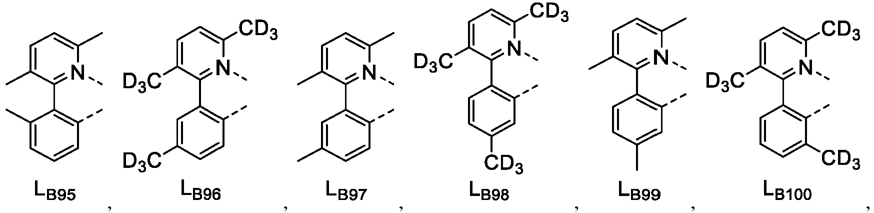 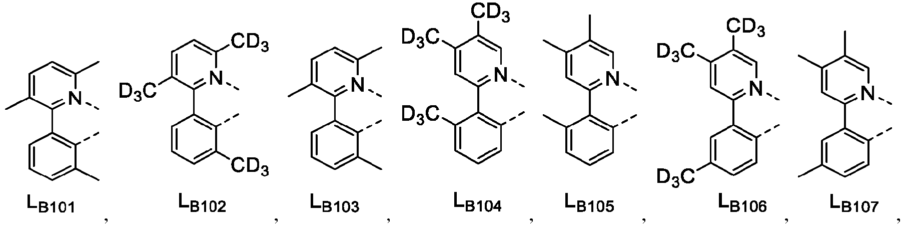 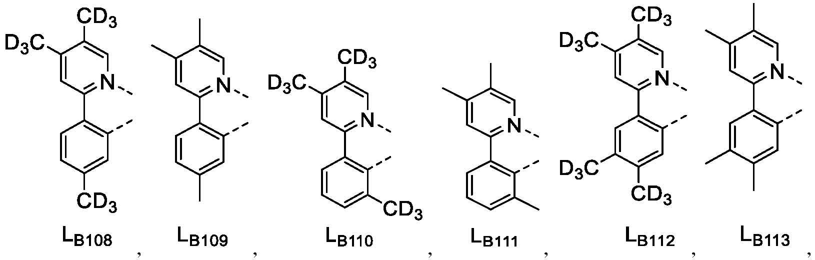 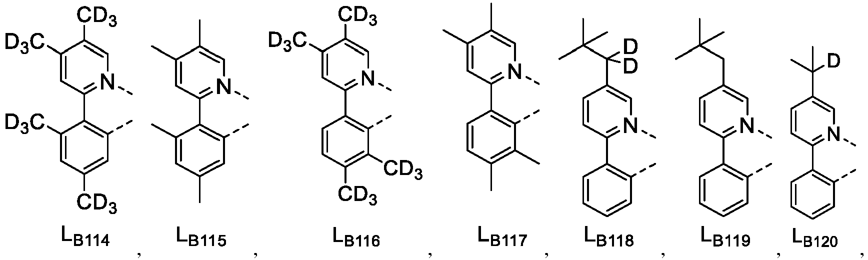 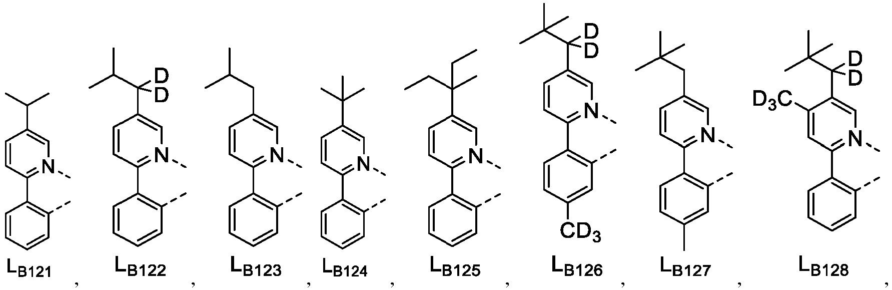 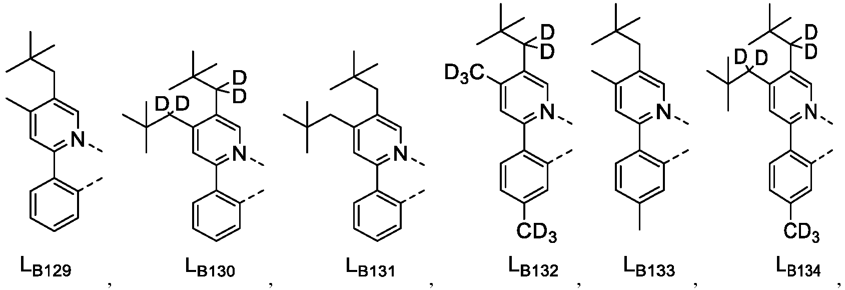 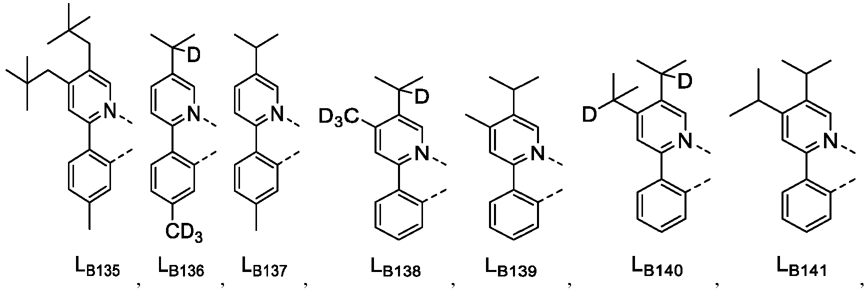 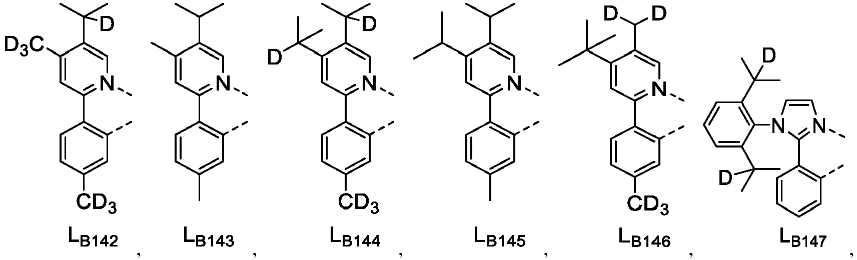 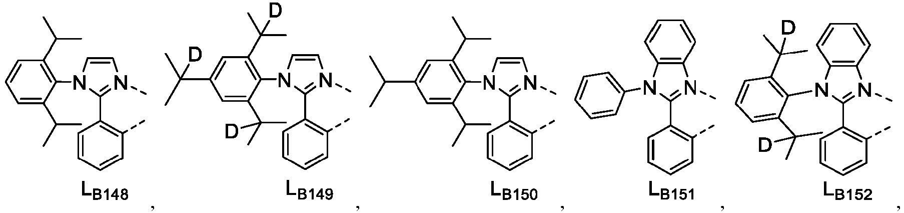 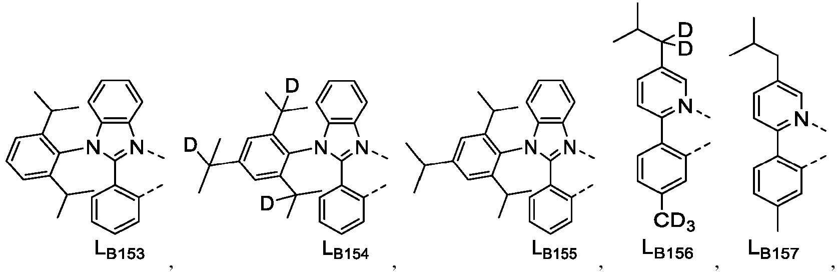 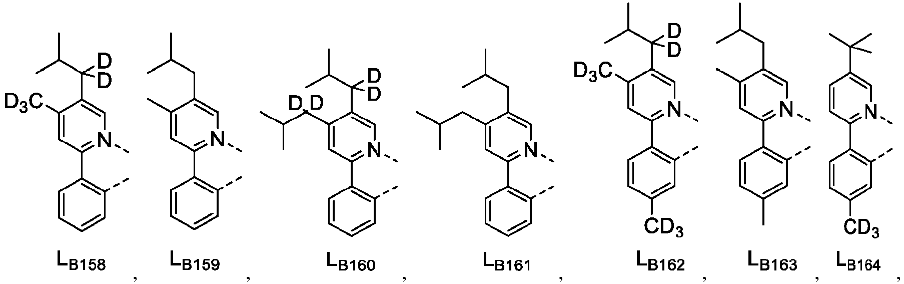 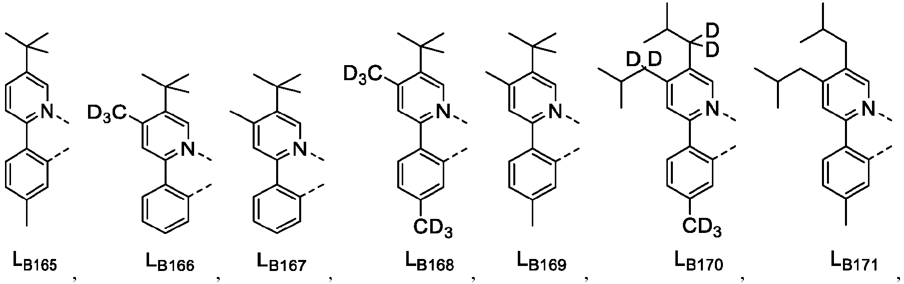 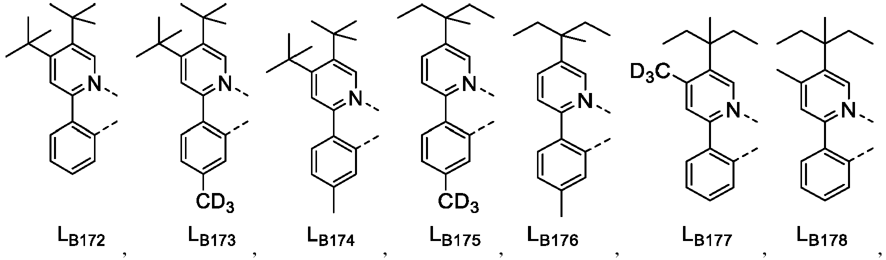 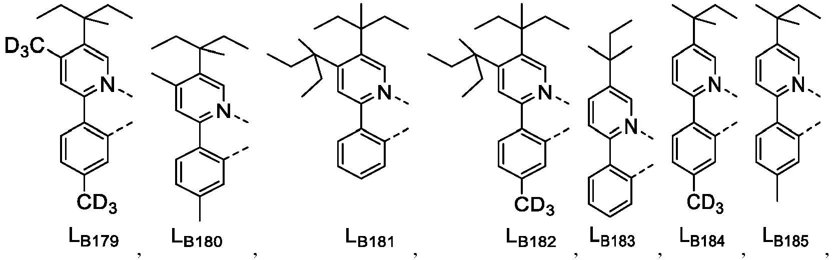 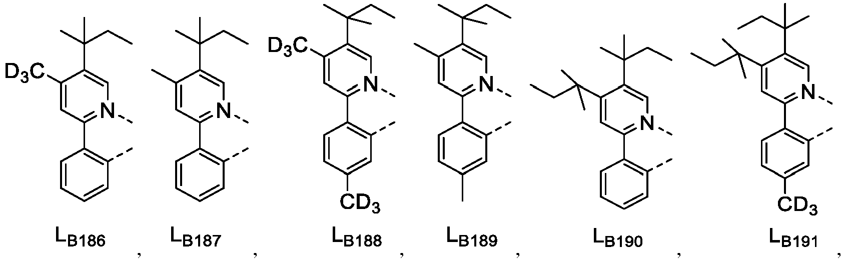 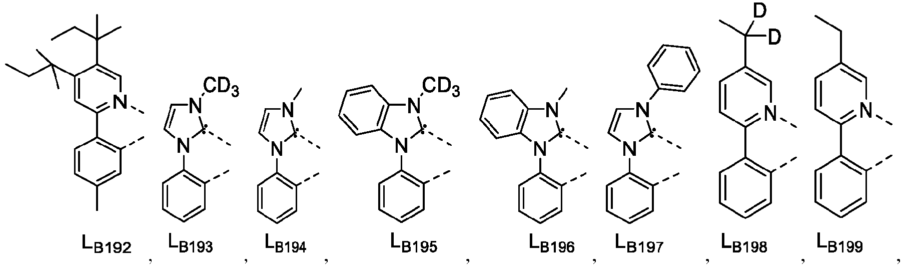 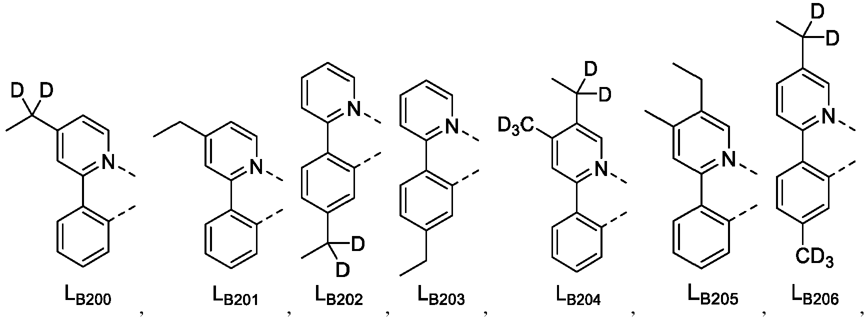 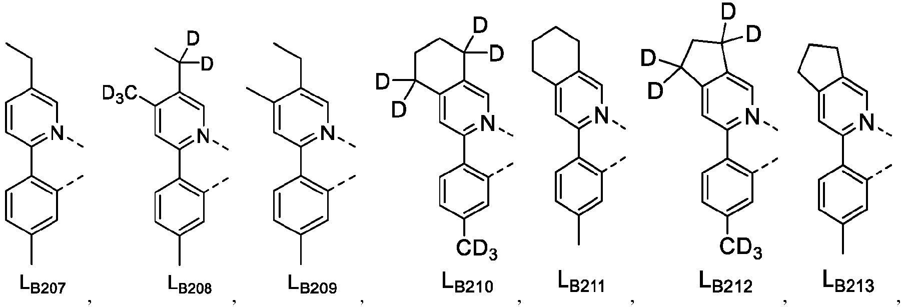 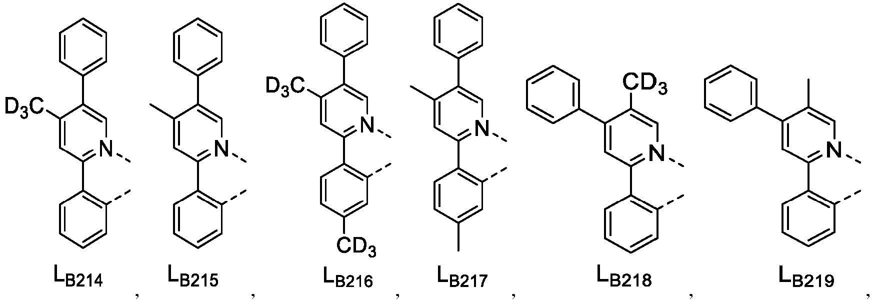 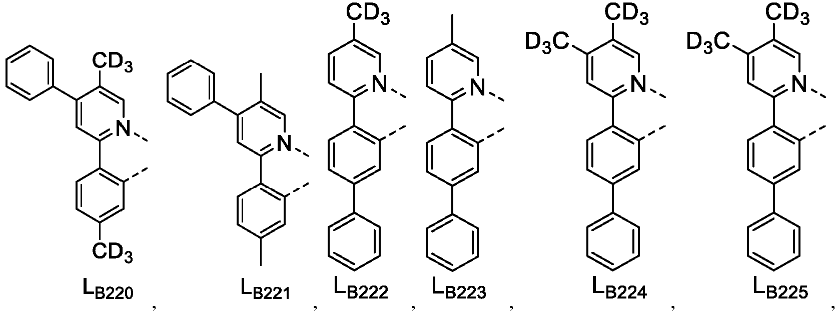 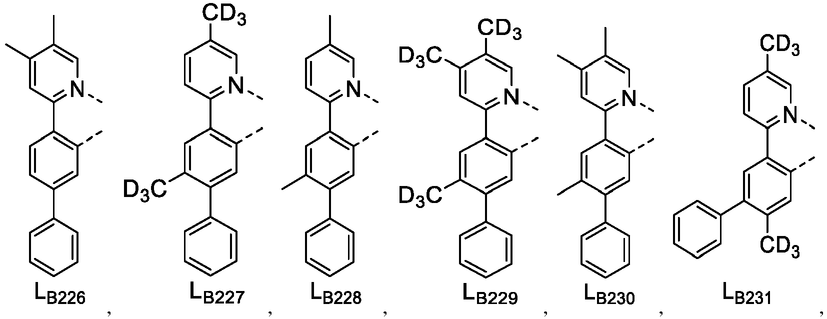 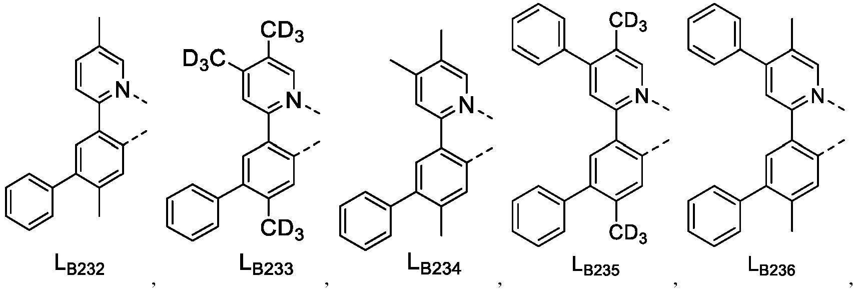 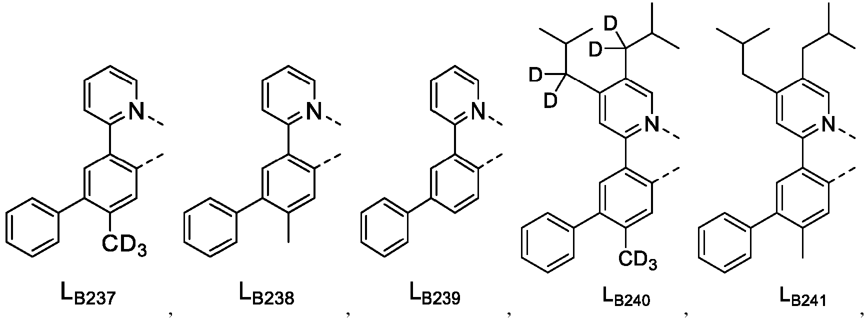 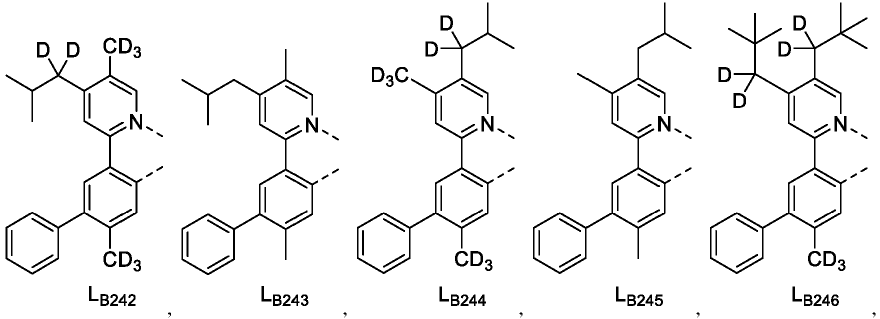 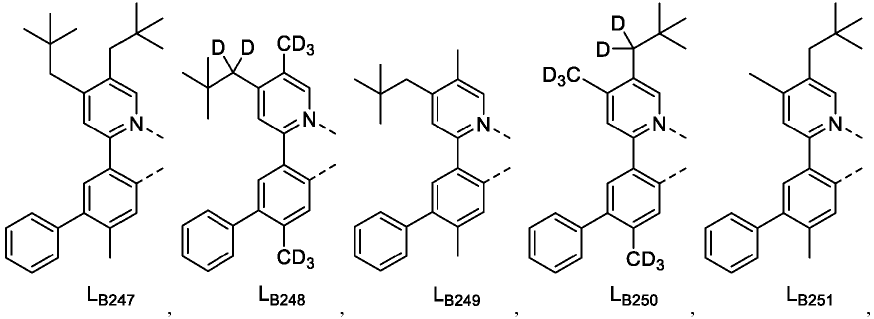 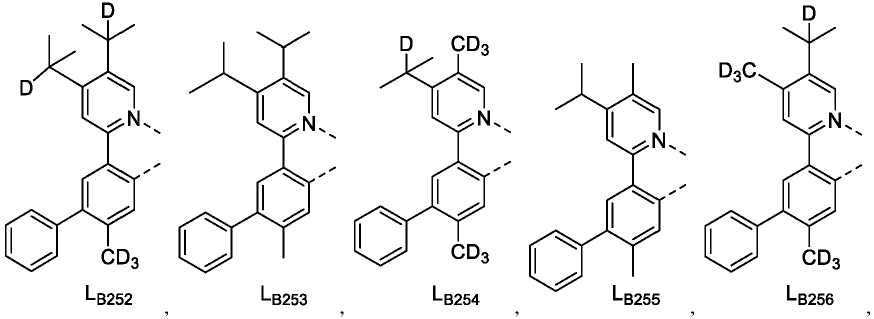 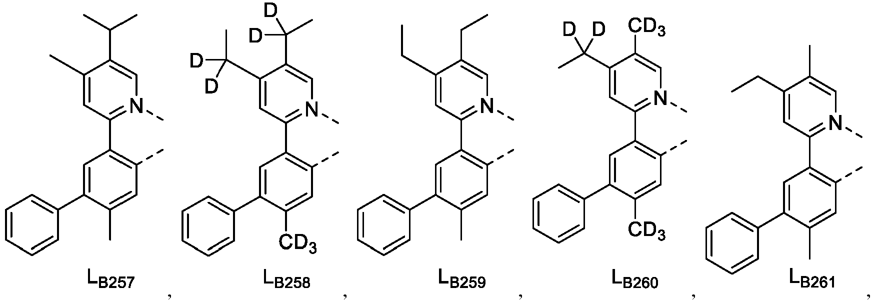 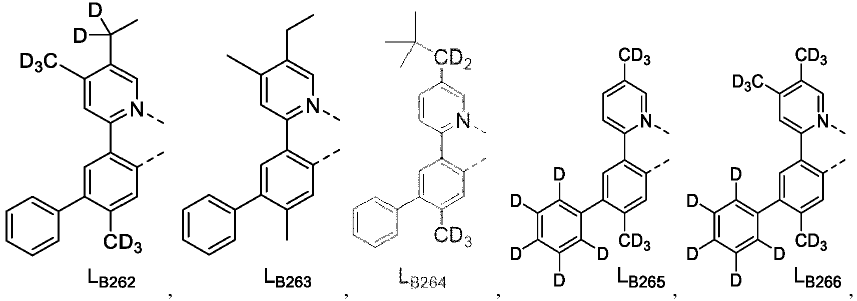 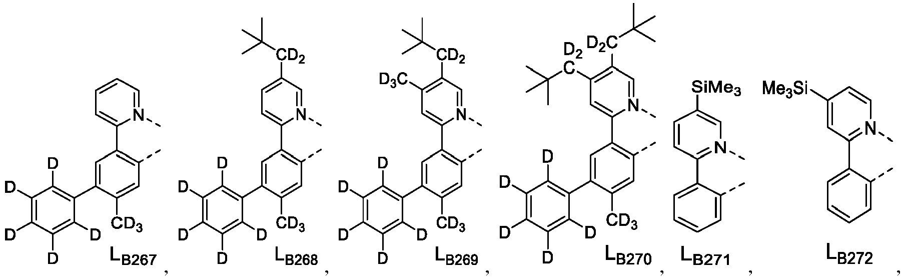 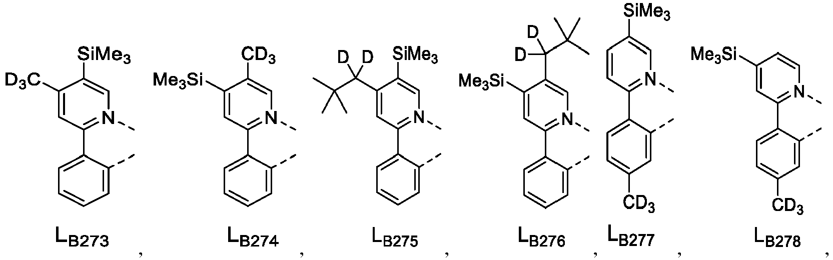 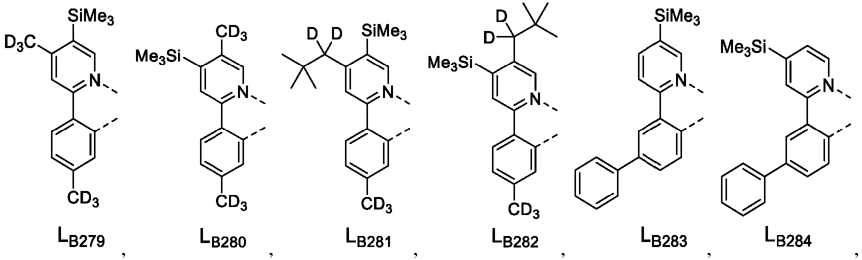 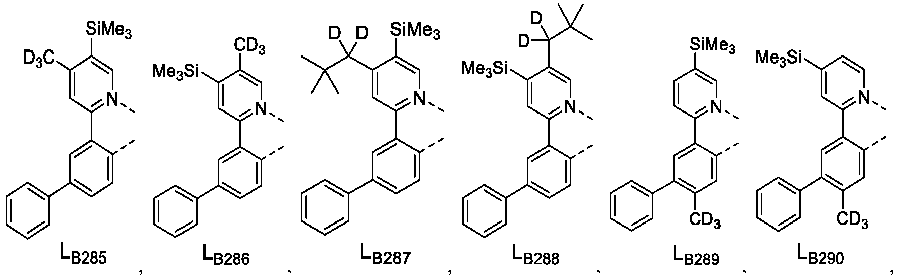 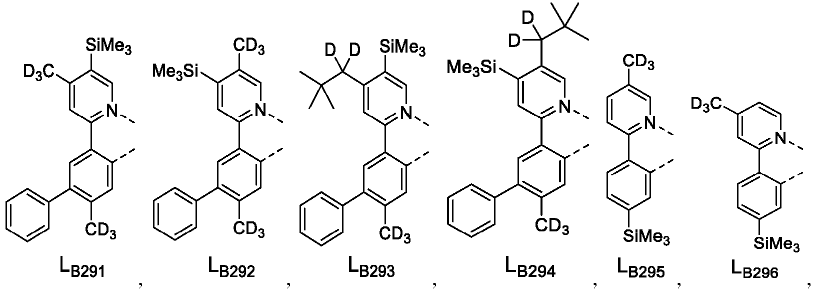 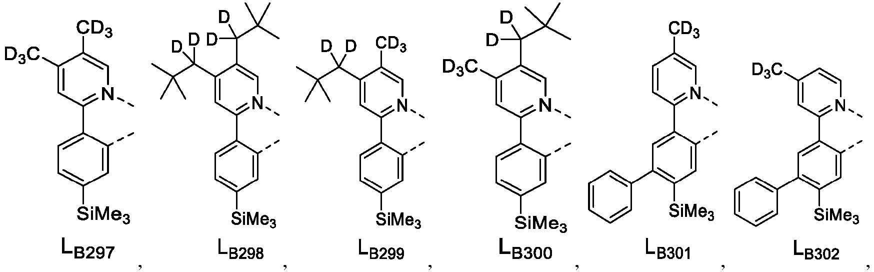 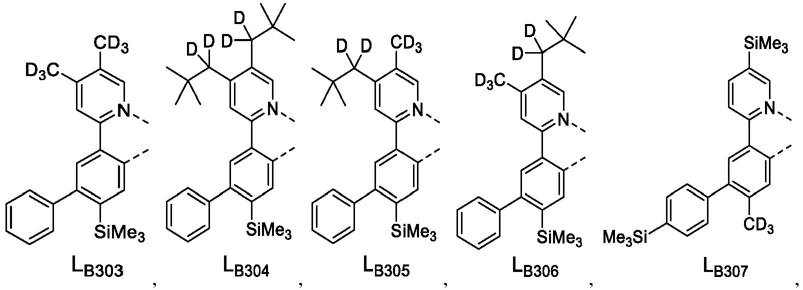 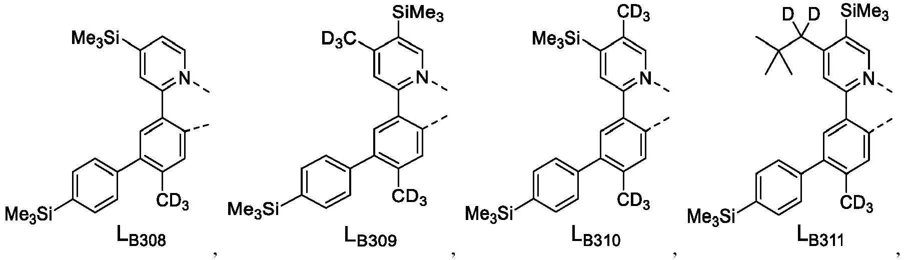 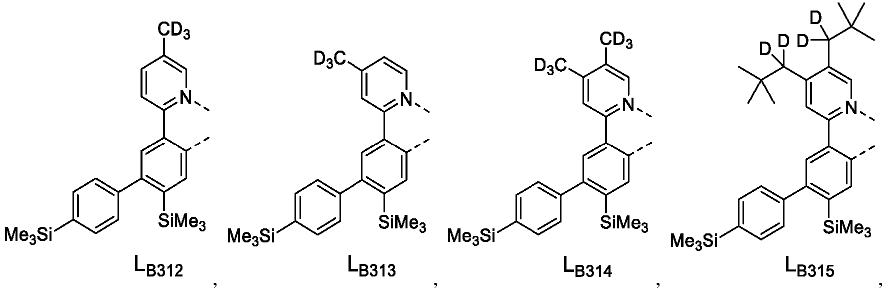 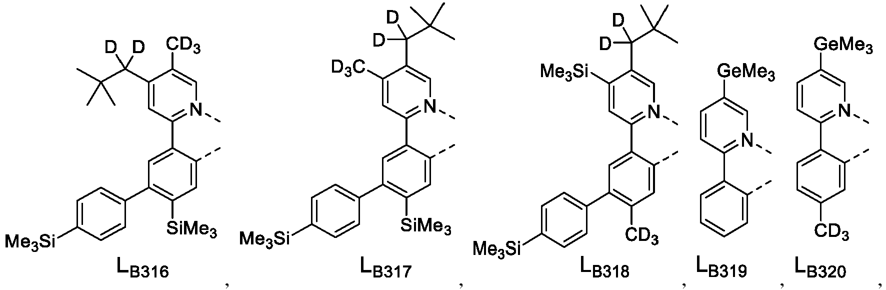 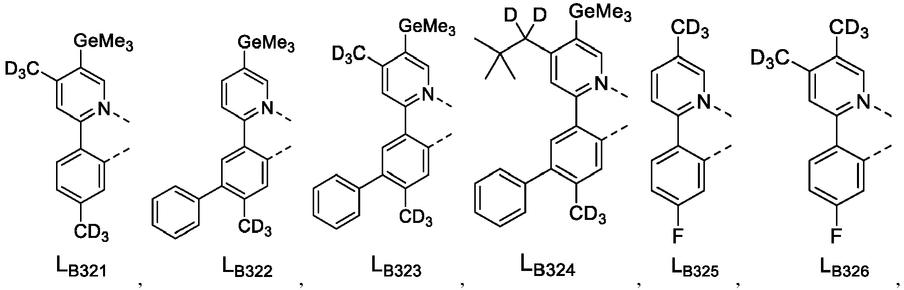 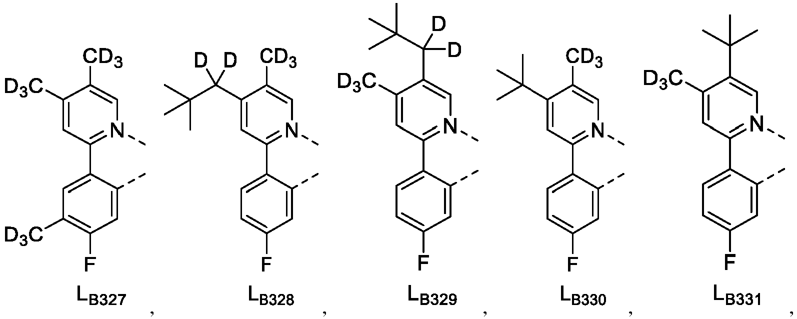 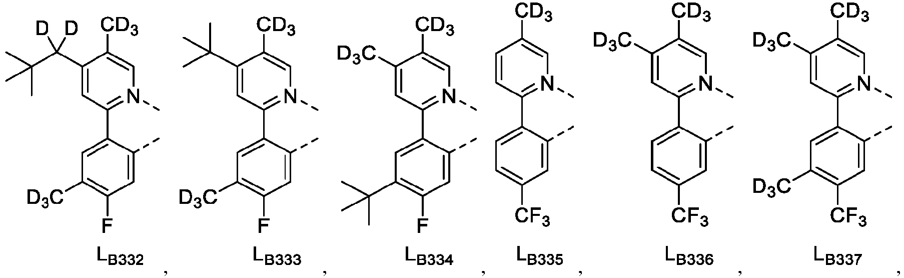 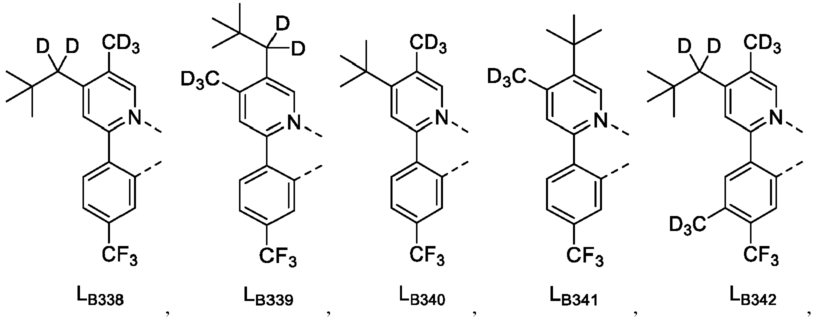 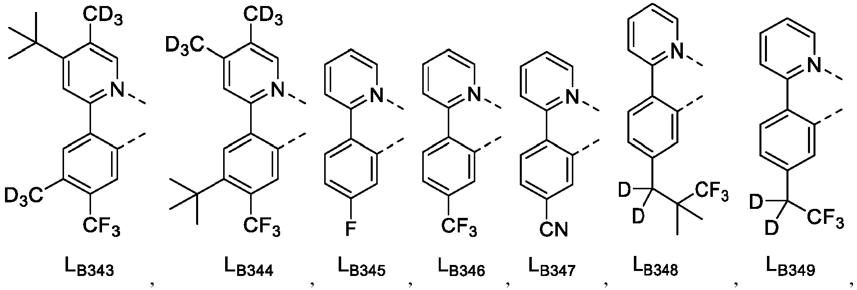 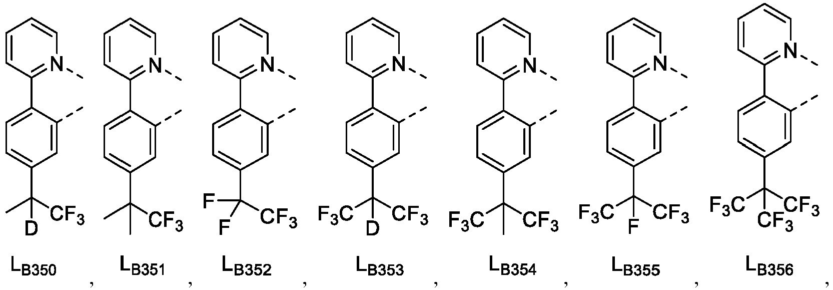 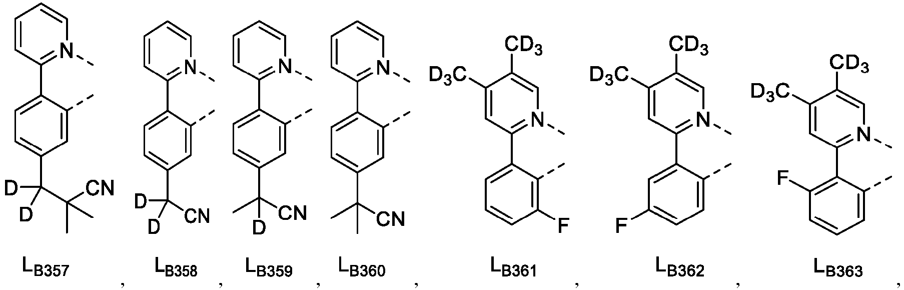 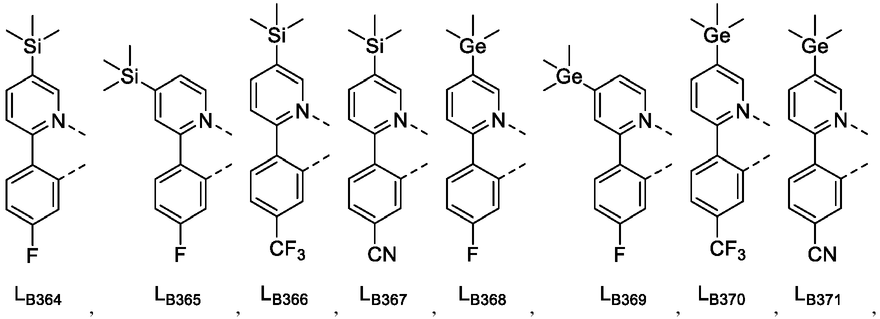 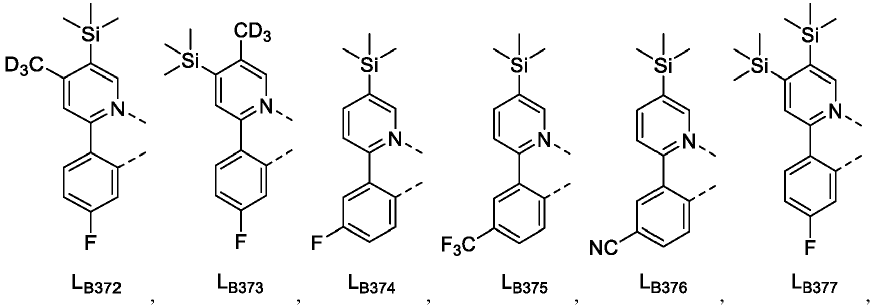 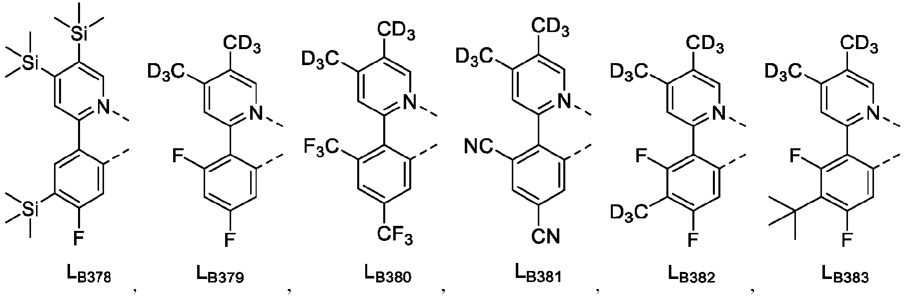 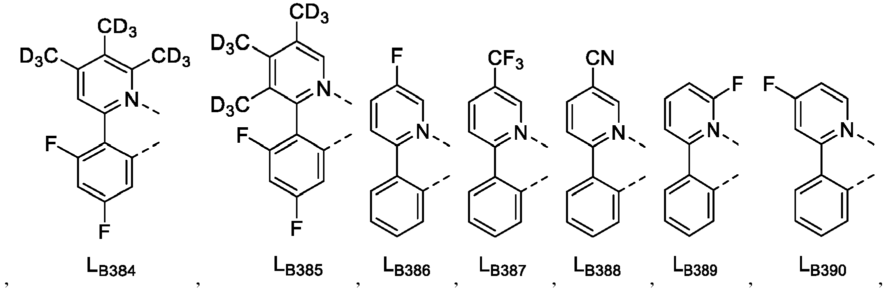 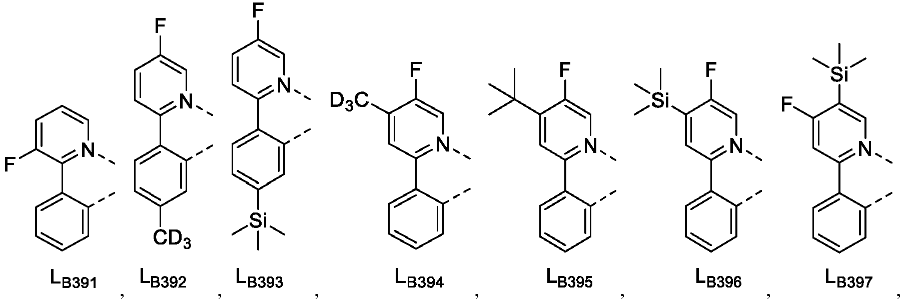 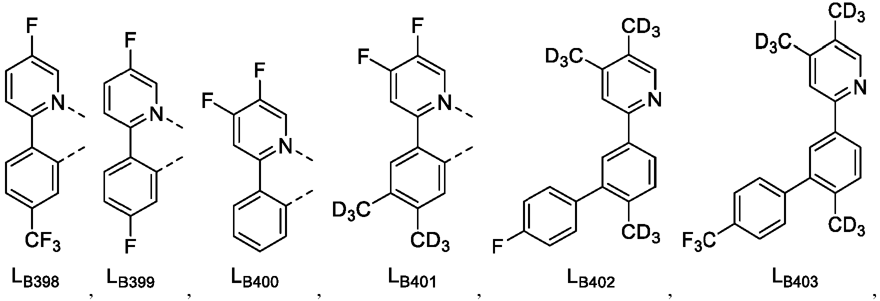 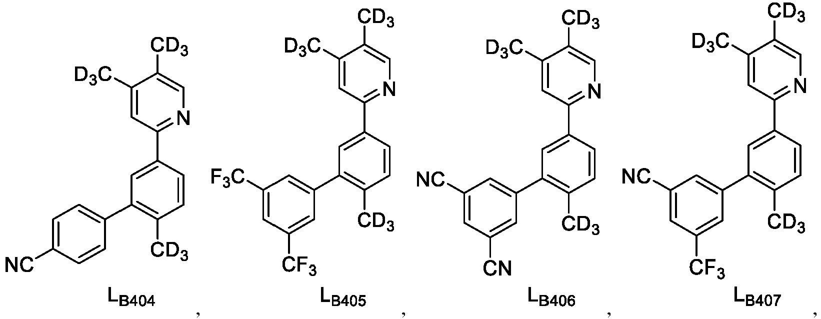 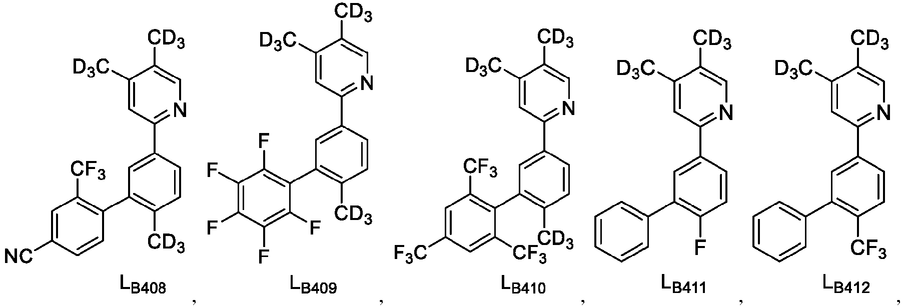 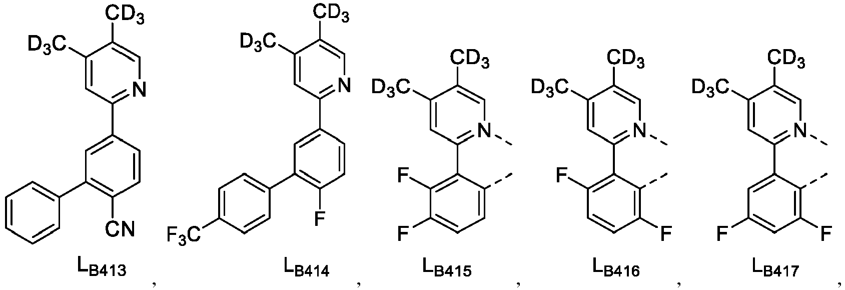 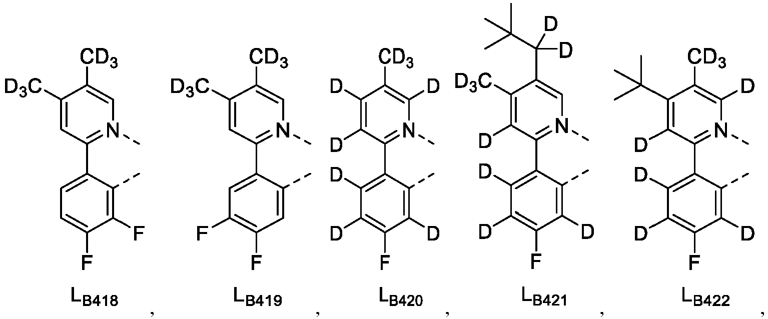 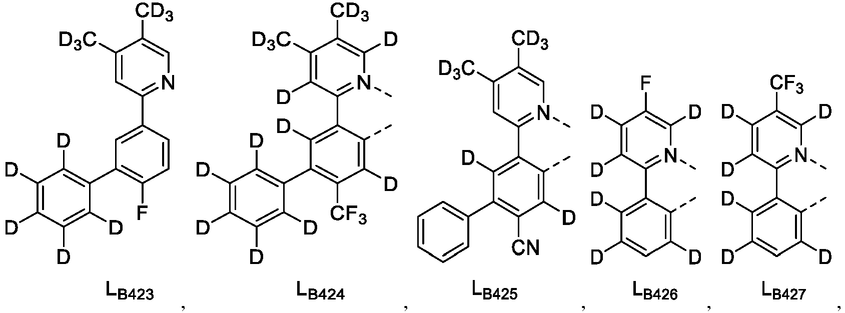 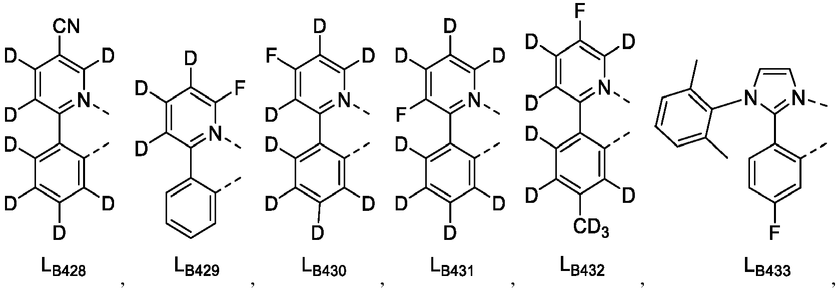 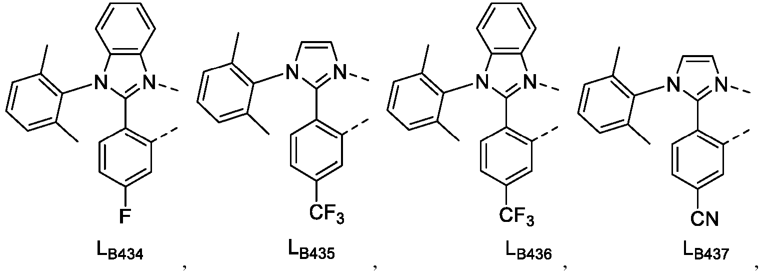 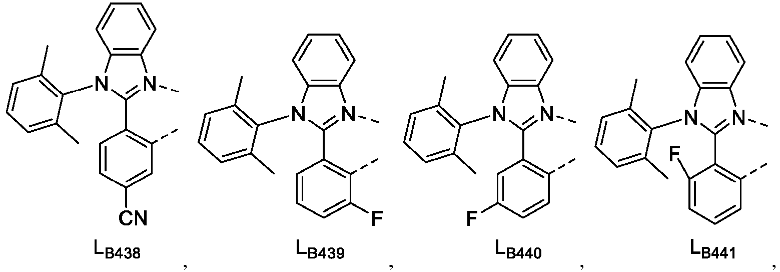 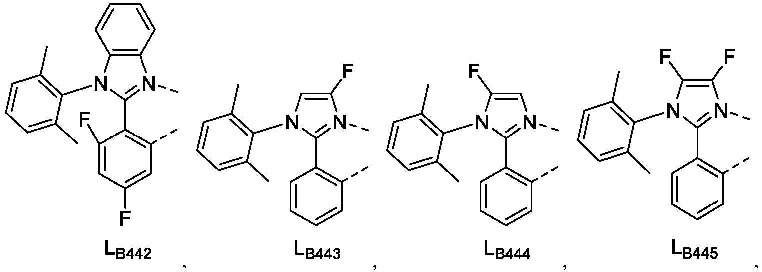 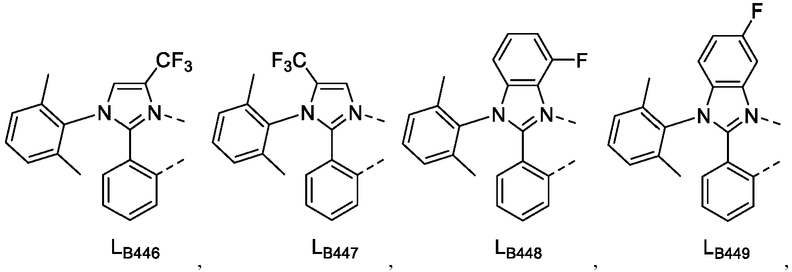 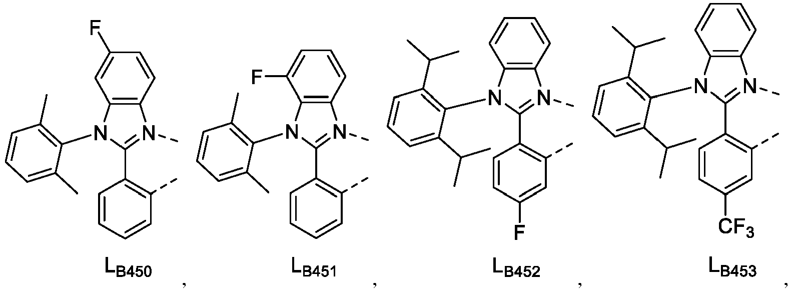 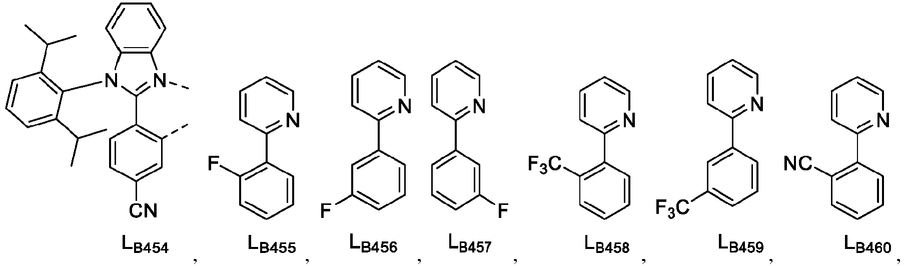 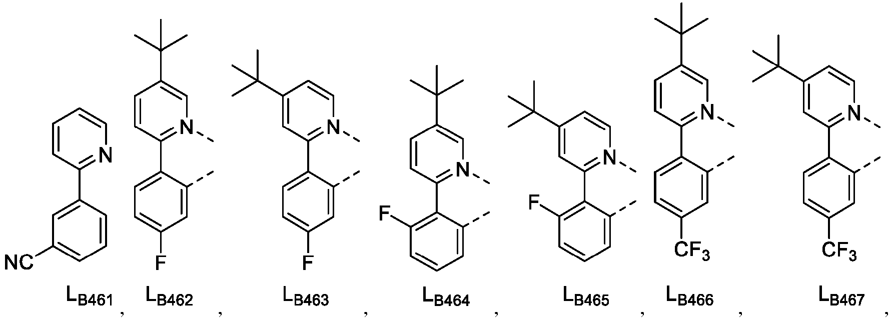 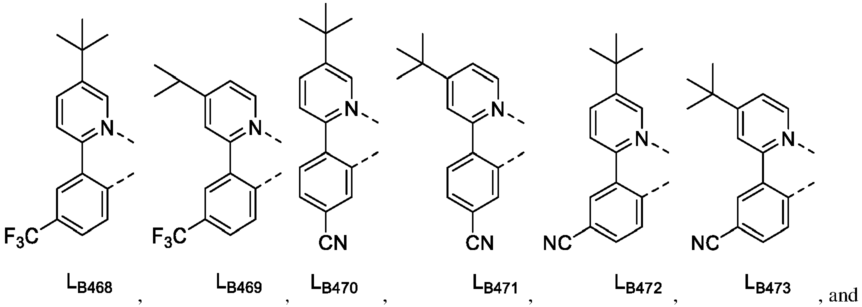 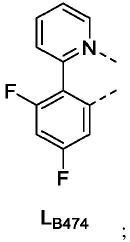
wherein each L_{C*j*-I} has a structure based on formula 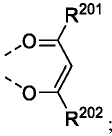 and
each L_{C*j*-II} has a structure based on formula 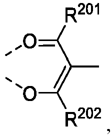
wherein for each L_{C*j*} in L_{C*j*-I} and L_{C*j*-I}, R²⁰¹ and R²⁰² are each independently defined as follows: 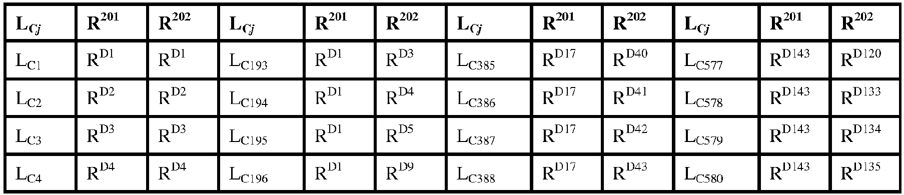 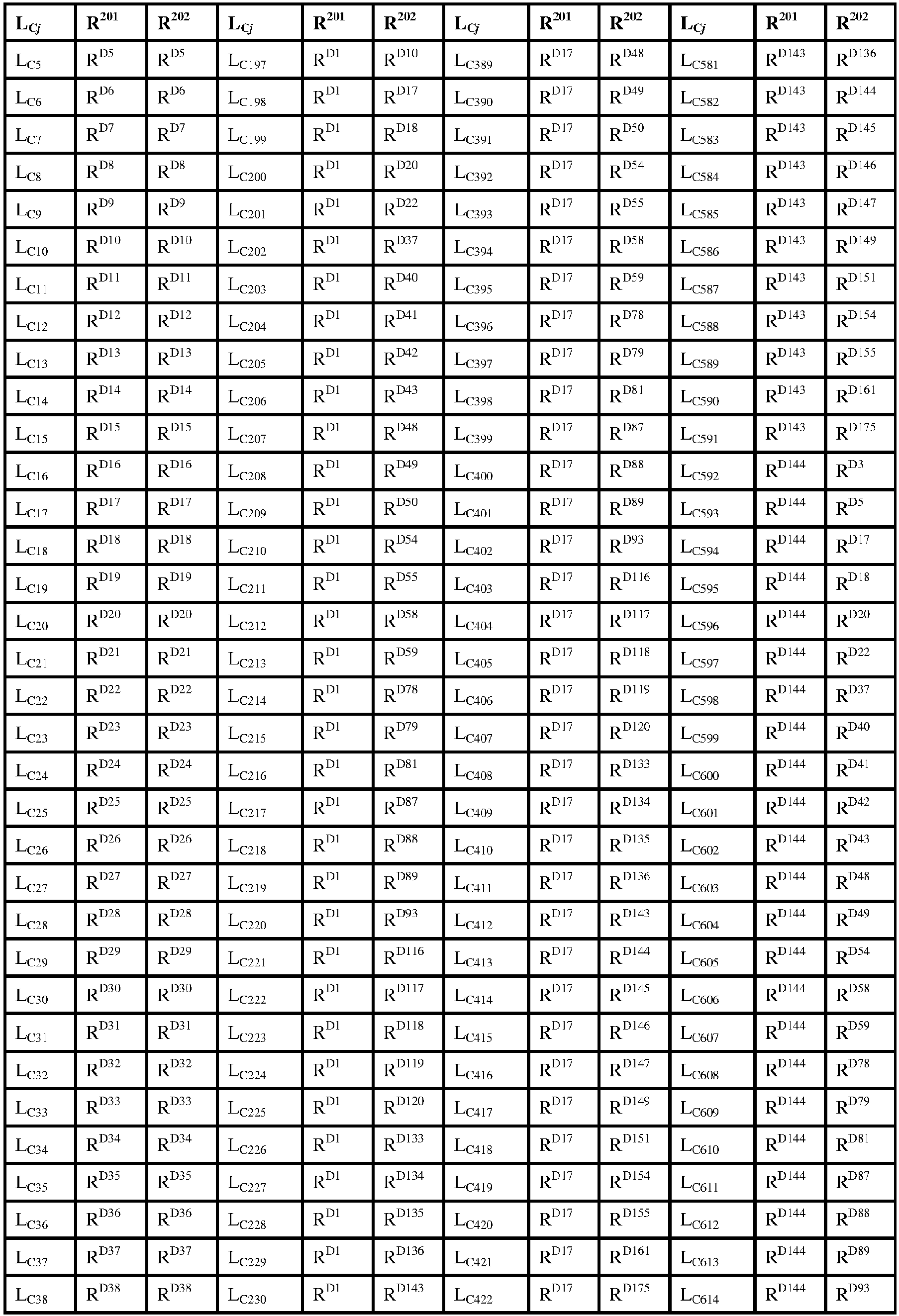 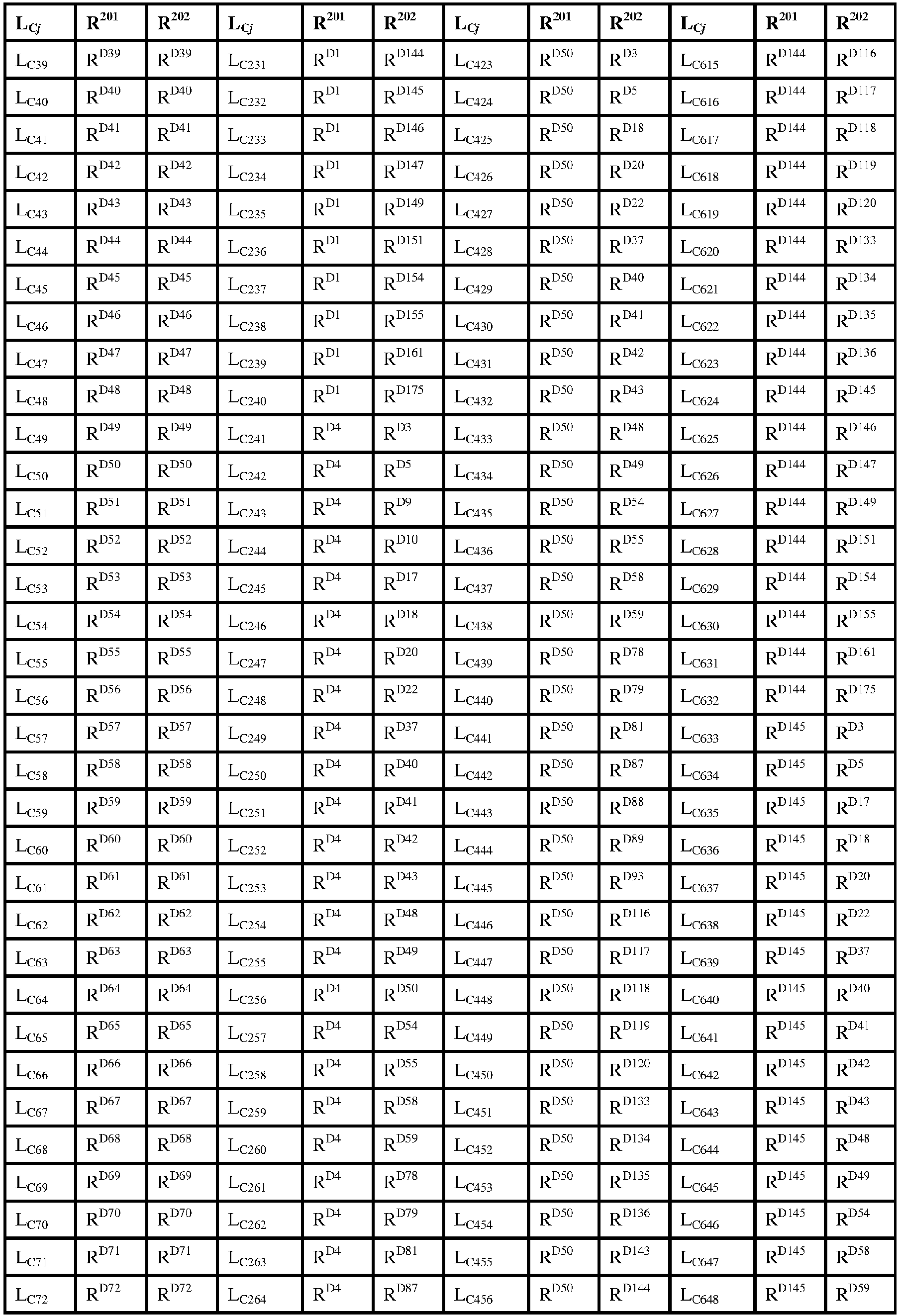 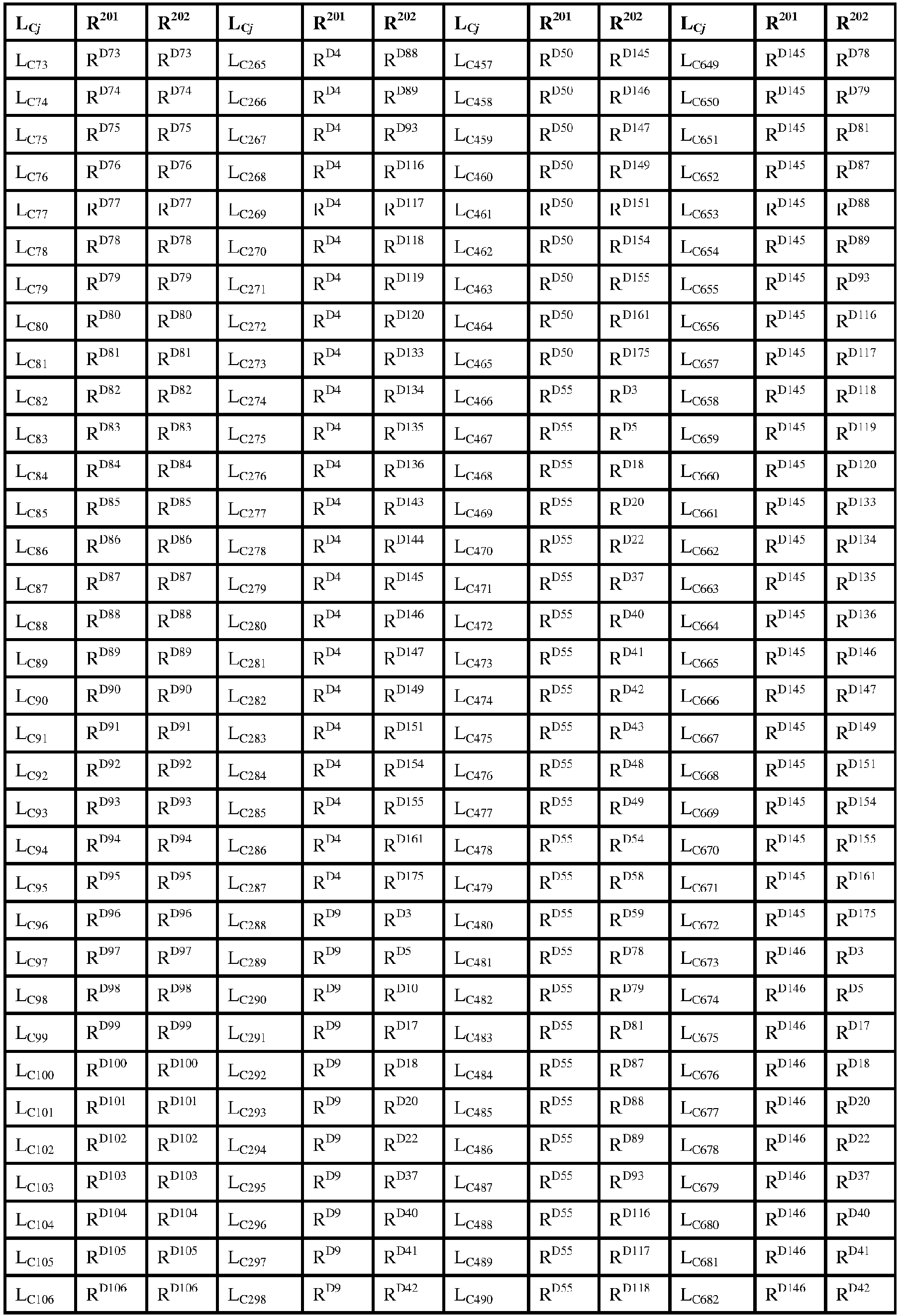 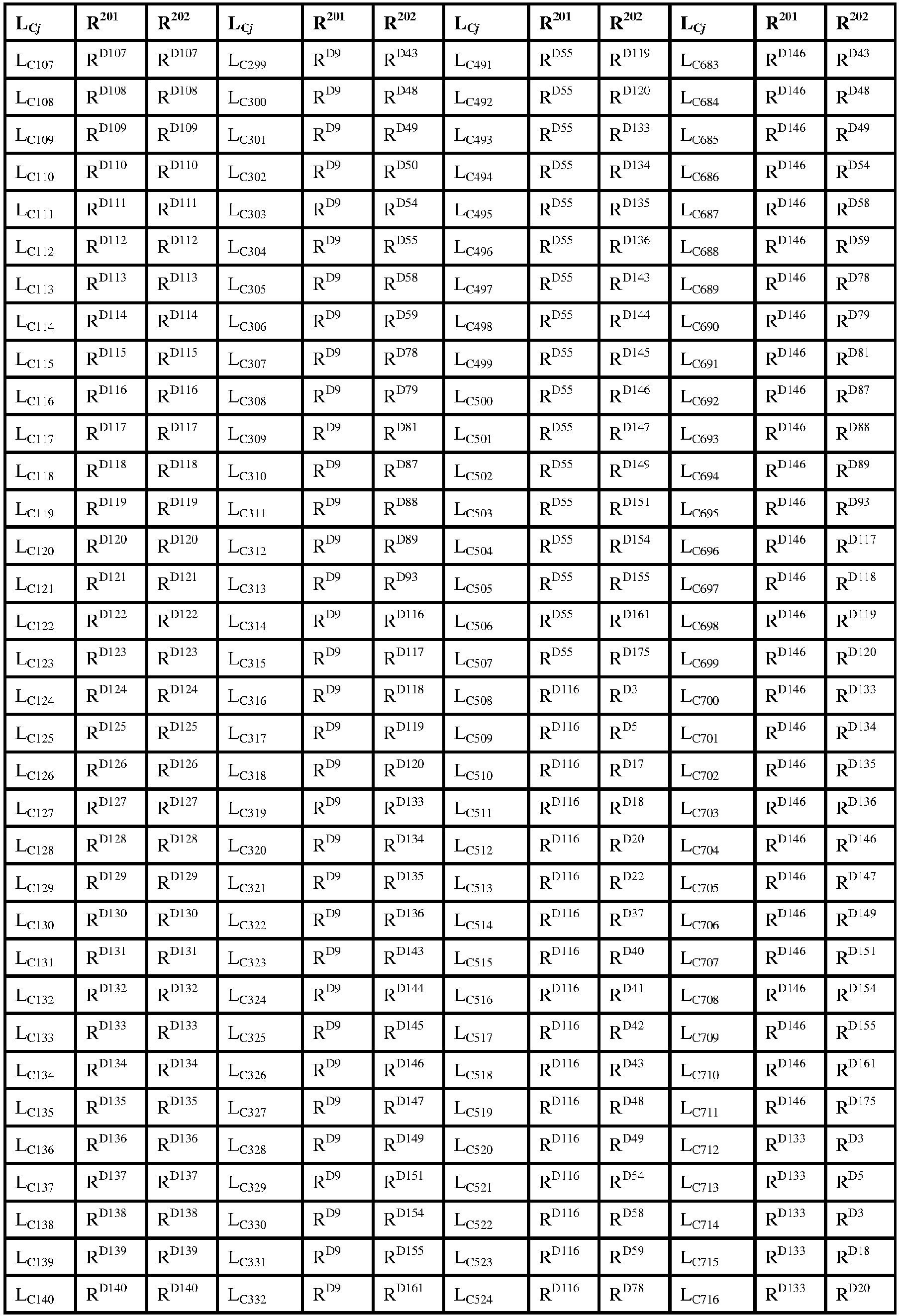 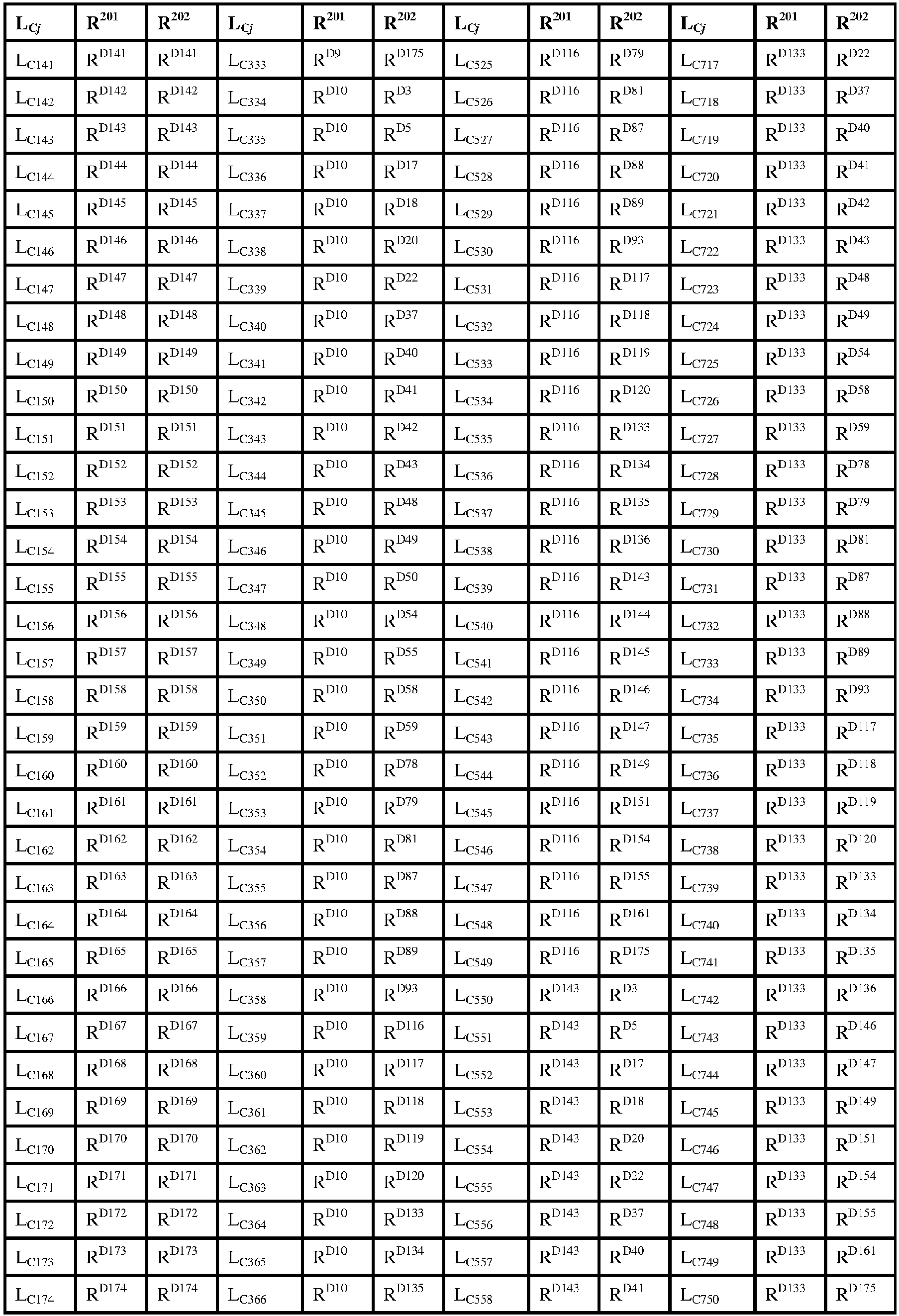 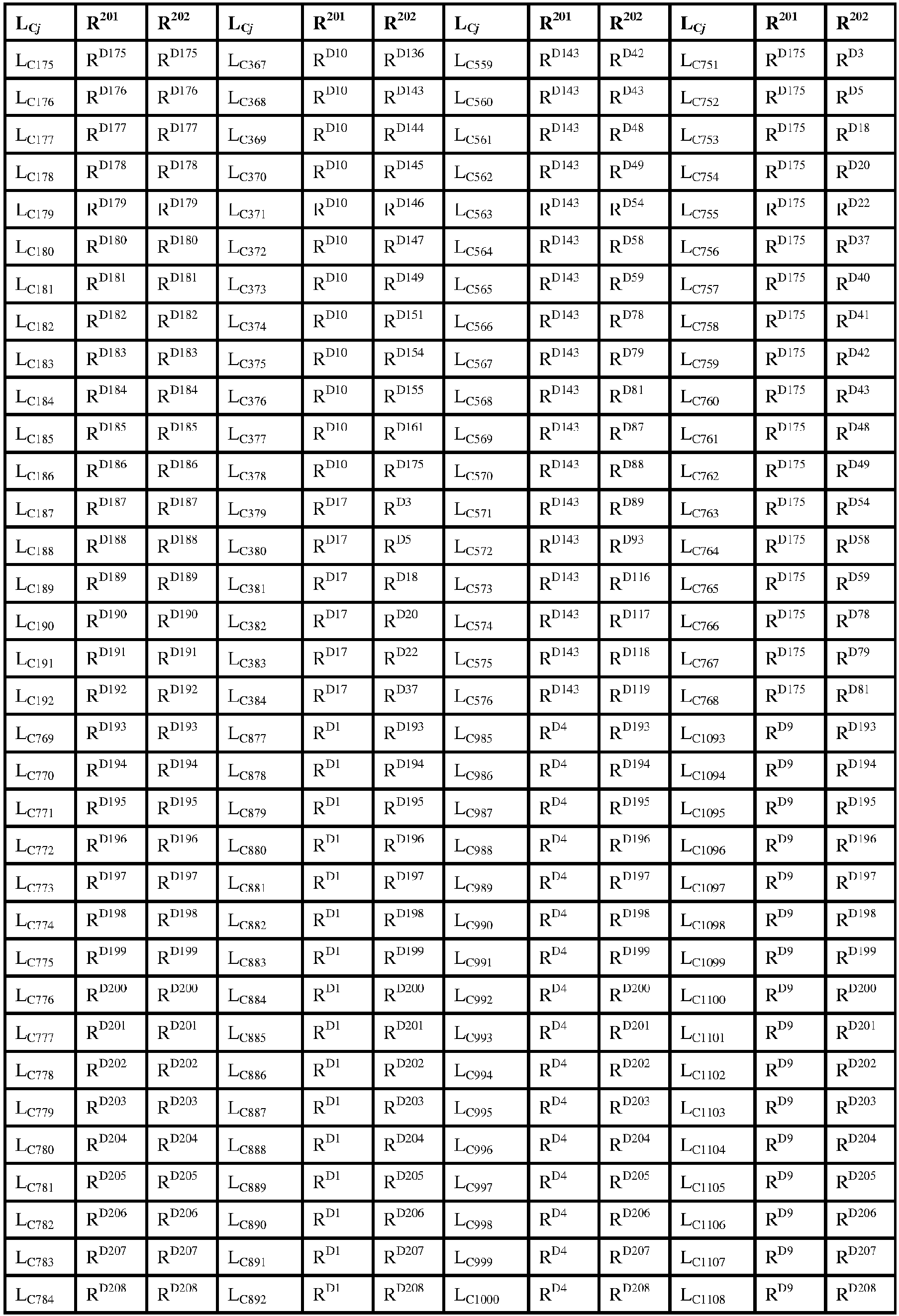 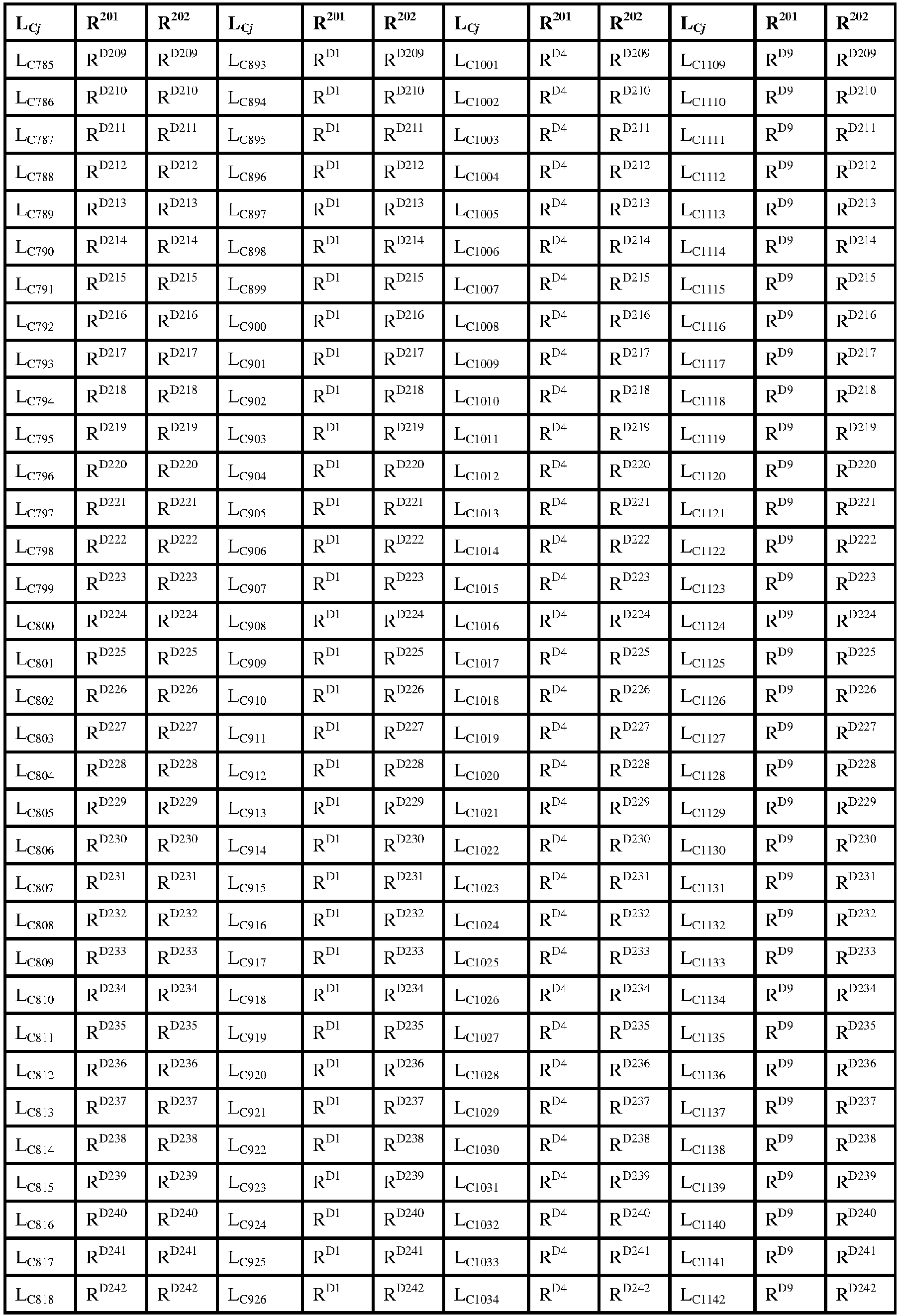 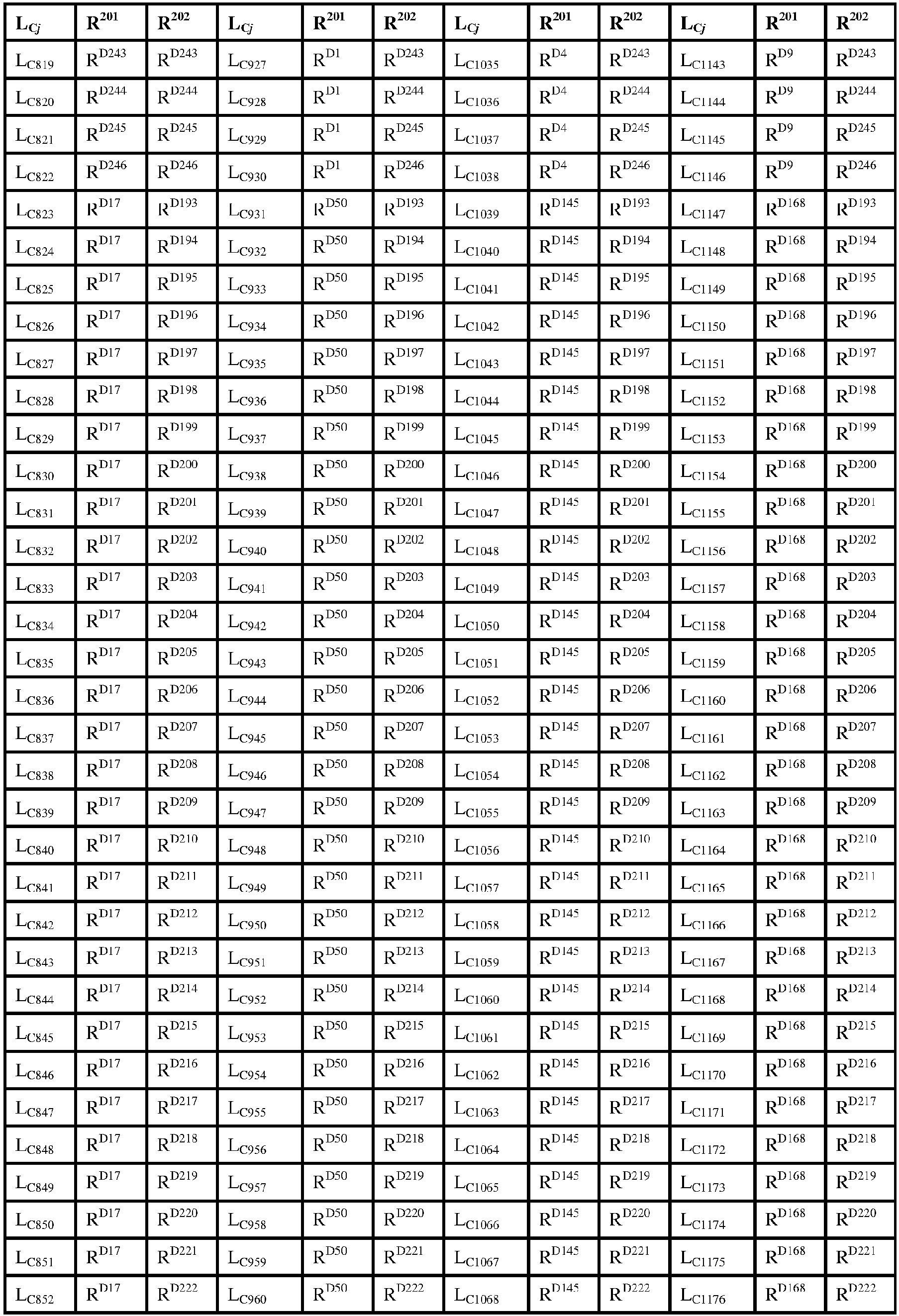 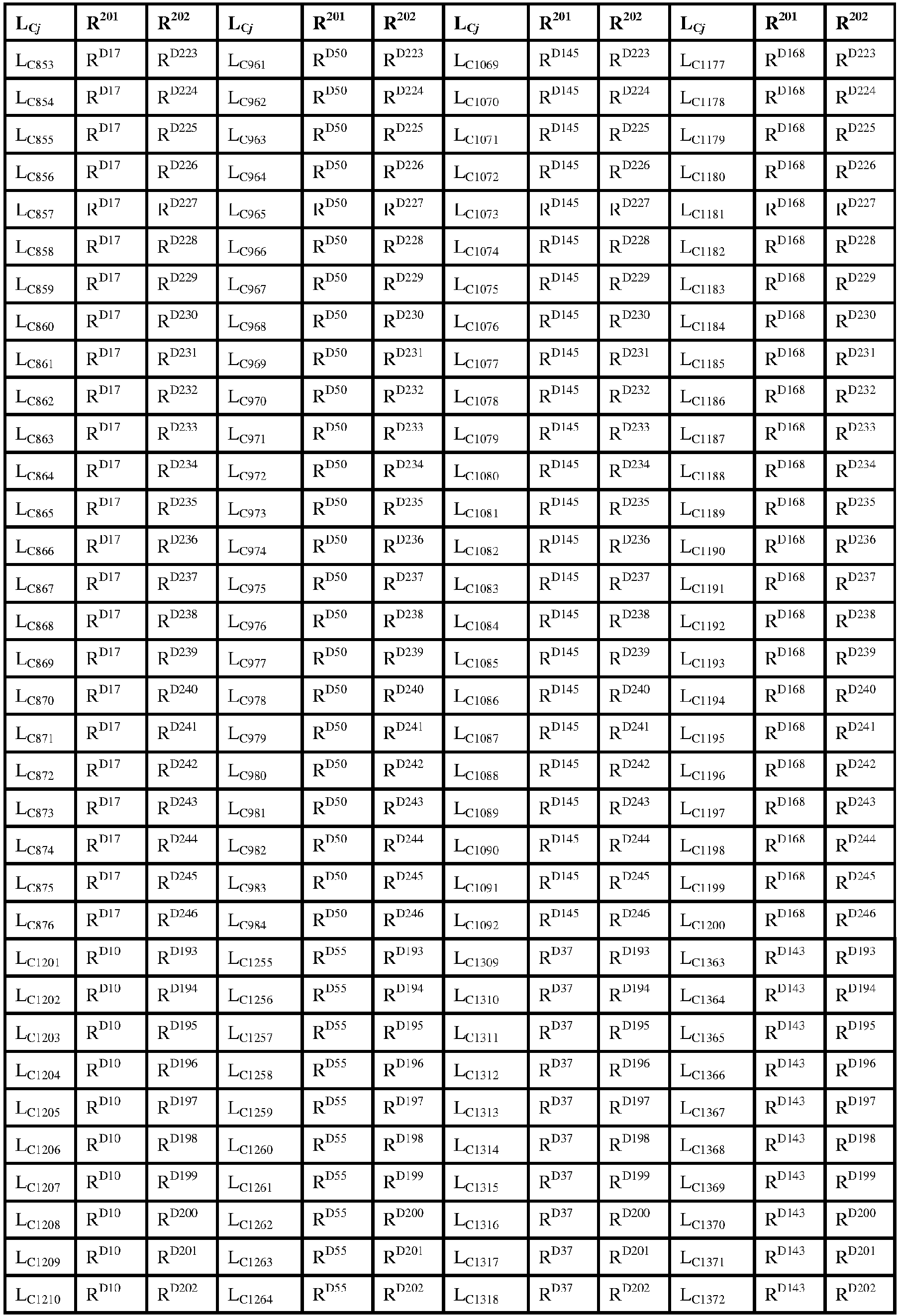 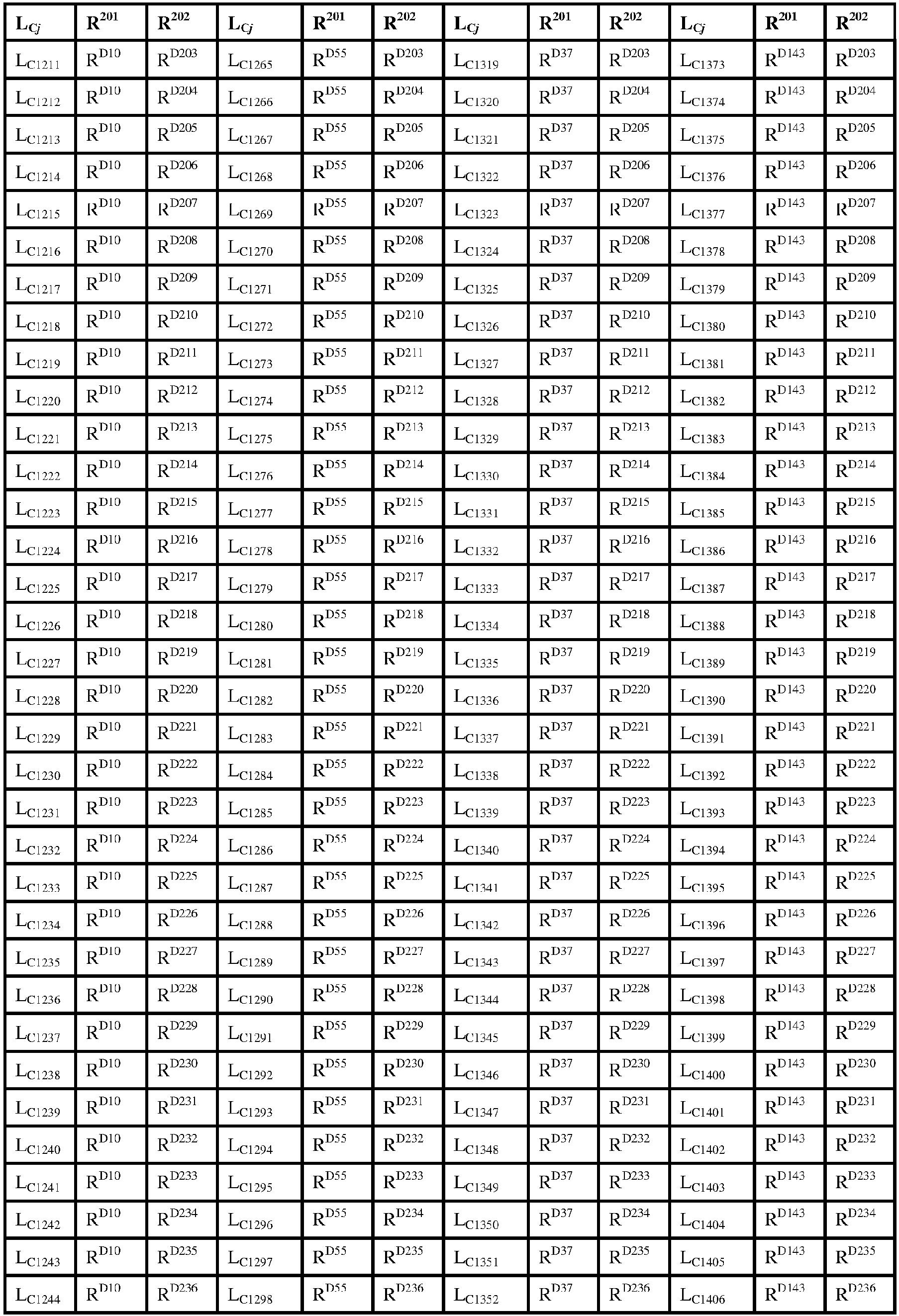 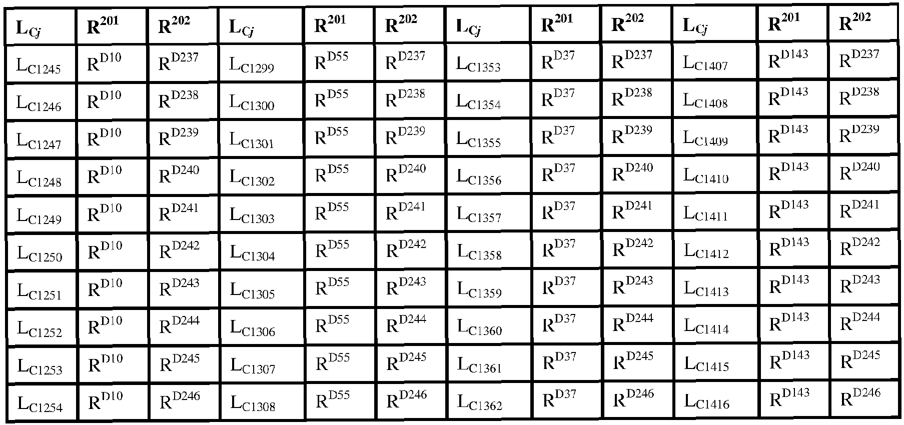
wherein R^{D1} to R^{D246} have the structures defined as follows:

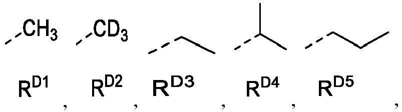

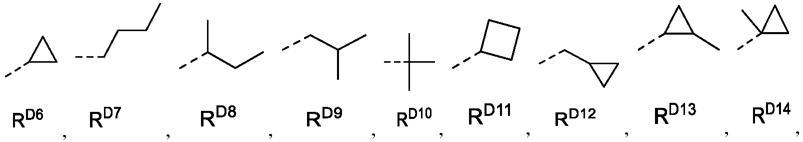

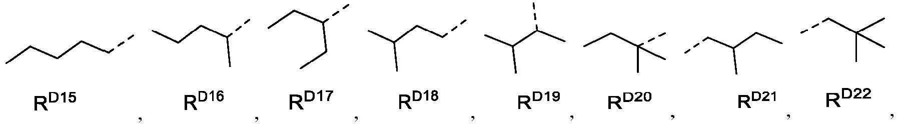

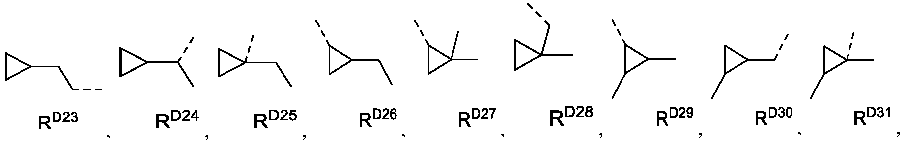

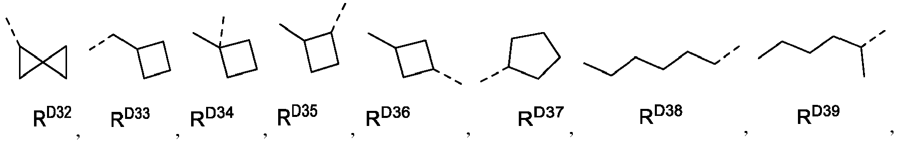

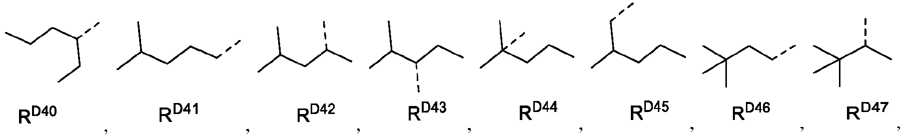

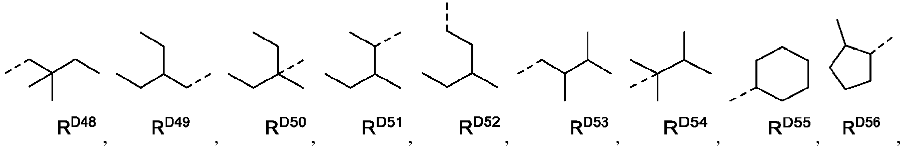

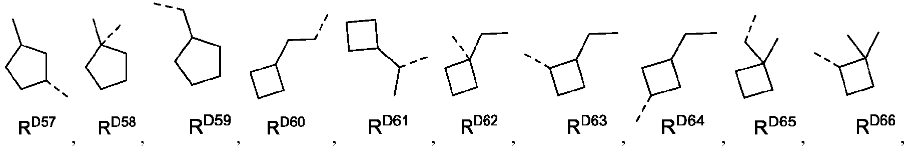

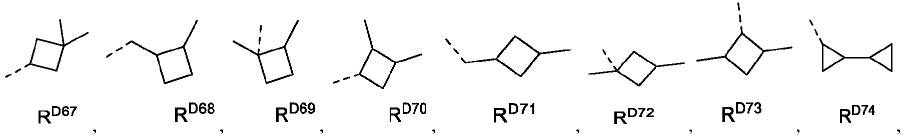

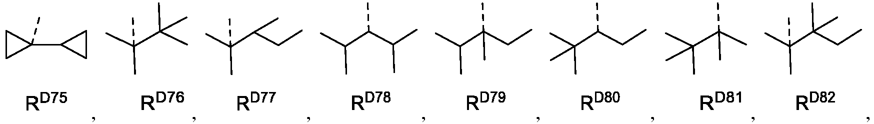

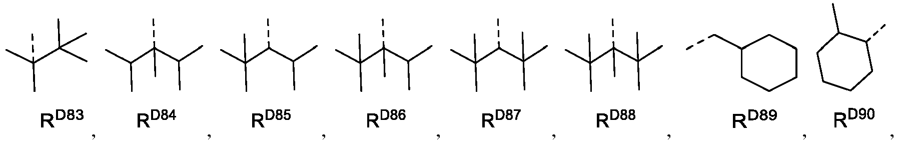

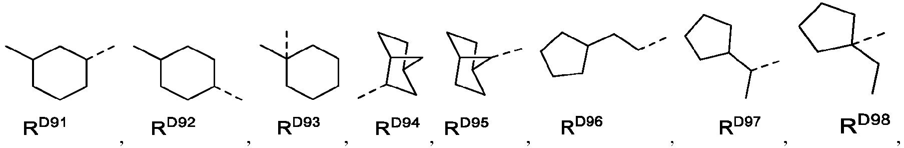

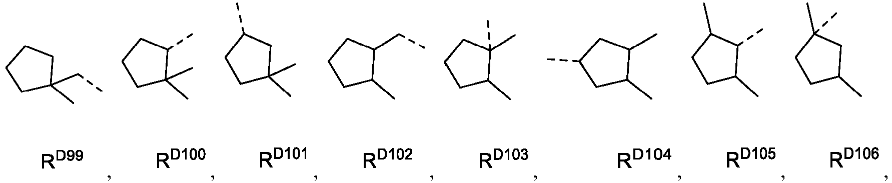

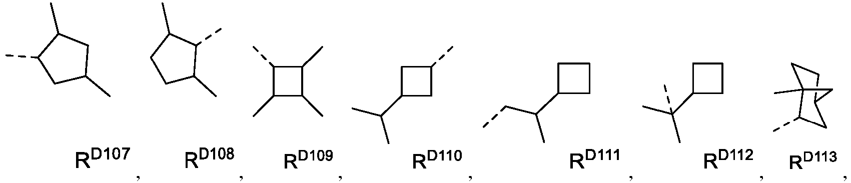

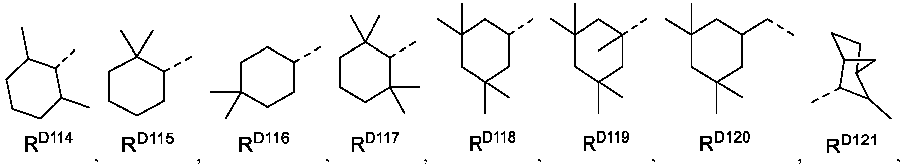

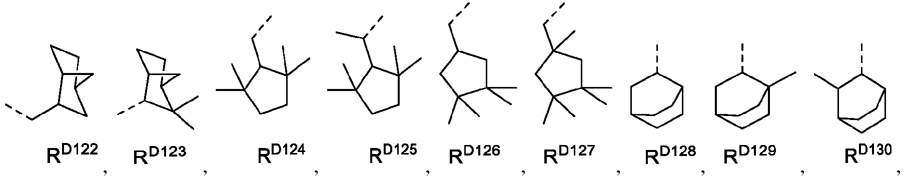

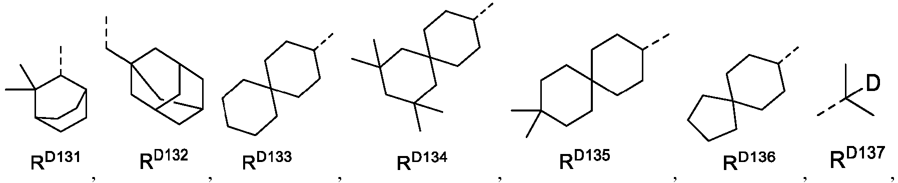

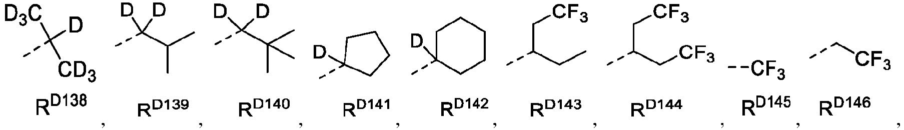

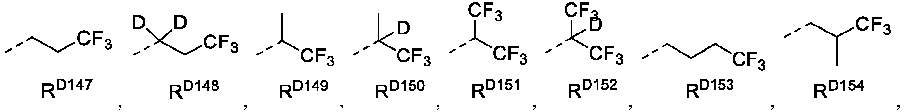

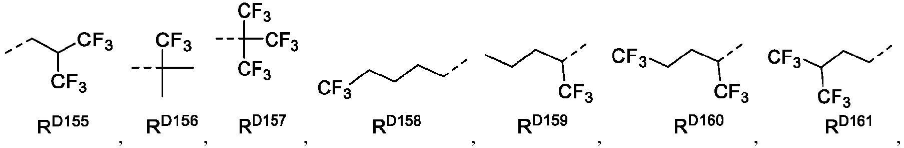

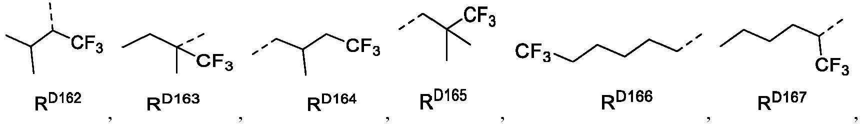

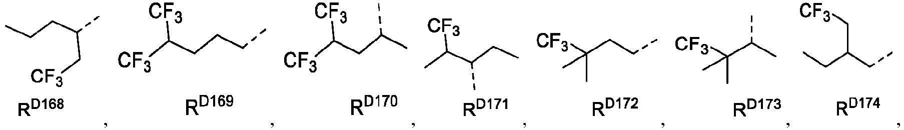

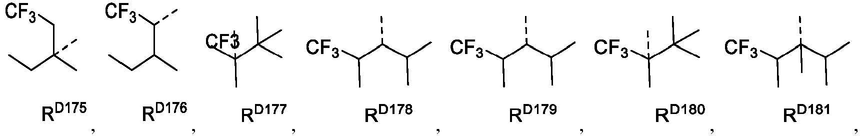

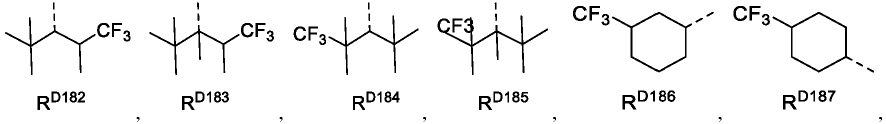

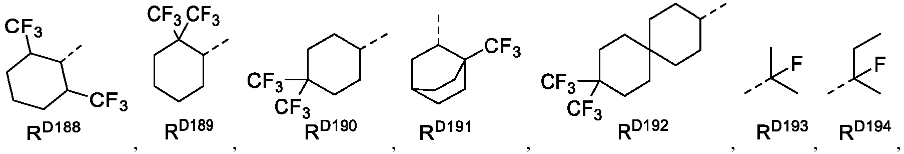

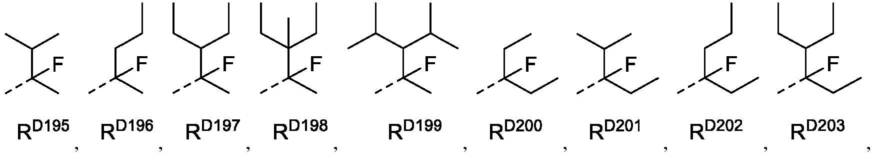

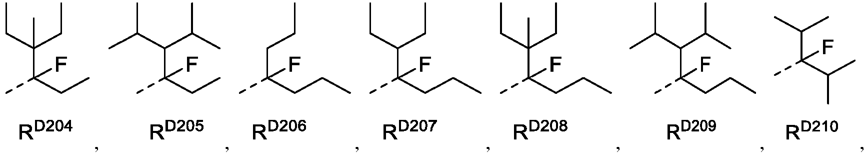

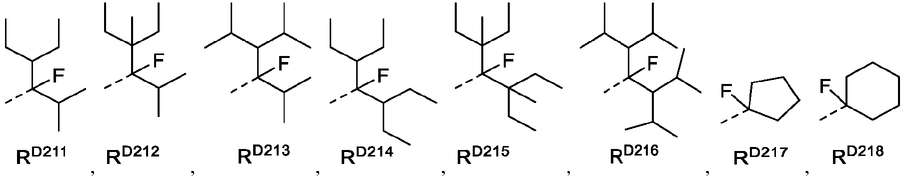

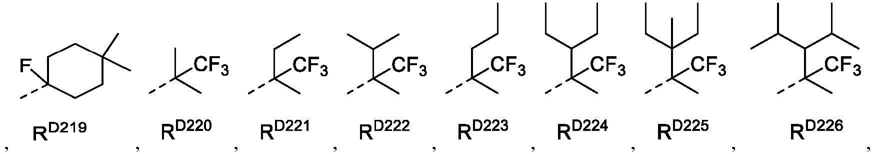

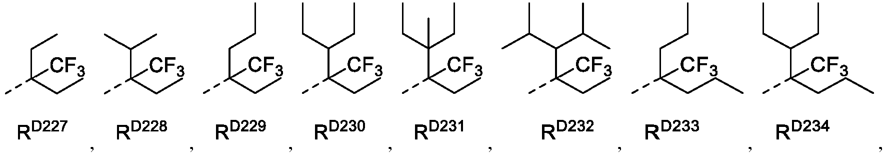

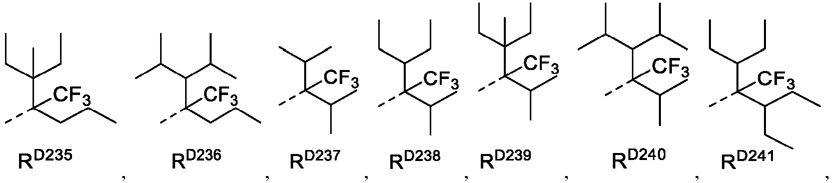

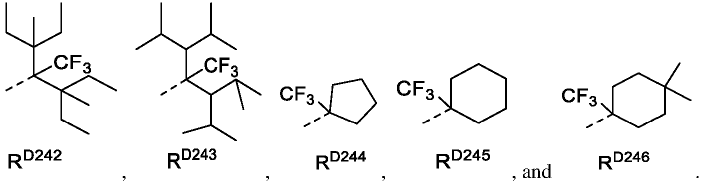

12. The compound of claim 1, wherein the compound is selected from the group consisting of the structures of LIST 11 defined herein.

13. The compound of claim 8, wherein the compound has the Formula II, 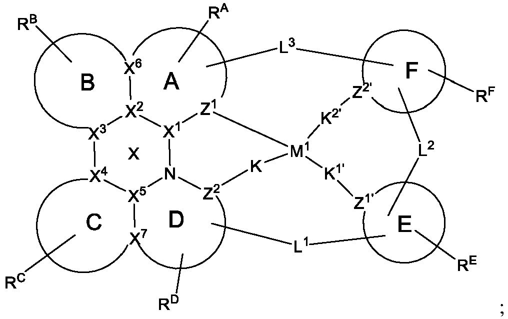 wherein:
M¹ is Pd or Pt;
moieties E and F are each independently monocyclic or polycyclic ring structure comprising 5-membered and/or 6-membered carbocyclic or heterocyclic rings;
Z^{1'} and Z^{2'} are each independently C or N;
K^{1'}, and K^{2'} are each independently selected from the group consisting of a direct bond, O, and S, wherein at least two of K, K^{1'}, and K^{2'} are direct bonds;
L¹, L², and L³ are each independently absent or selected from the group consisting of a direct bond, BR, BRR', NR, PR, P(O)R, O, S, Se, C=O, C=S, C=Se, C=NR, C= CRR', S=O, SO₂, CR, CRR', SiRR', GeRR', alkylene, cycloalkyl, aryl, cycloalkylene, arylene, heteroarylene, and combinations thereof, wherein at least one of L¹ and L² is present;
R^{E} and R^{F} each independently represents zero, mono, or up to a maximum allowed number of substitutions to its associated ring;
each of R, R', R^{E}, and R^{F} is independently a hydrogen or a substituent selected from the group consisting of deuterium, fluorine, alkyl, cycloalkyl, heteroalkyl, alkoxy, aryloxy, amino, silyl, boryl, alkenyl, cycloalkenyl, heteroalkenyl, aryl, heteroaryl, nitrile, isonitrile, sulfanyl, and combinations thereof; and
two adjacent R^{A}, R^{B}, R^{C}, R^{E}, and R^{F} can be joined or fused together to form a ring.

14. An organic light emitting device comprising:
an anode;
a cathode; and
an organic layer disposed between the anode and the cathode, wherein the organic layer comprises a compound according to claim 1.

15. A consumer product comprising an organic light-emitting device comprising:
an anode;
a cathode; and
an organic layer disposed between the anode and the cathode, wherein the organic layer comprises a compound according to claim 1.

## Patentansprüche

1. Verbindung, umfassend einen ersten Liganden L_{A} von Formel I, 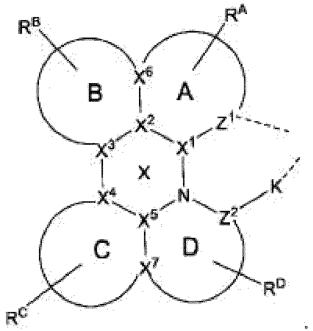 wobei:
Gruppen A, B, C und D jeweils unabhängig voneinander ein monocyclischer Ring oder ein polycyclisches kondensiertes Ringsystem sind, wobei der monocyclische Ring und jeder Ring des polycyclischen kondensierten Ringsystems unabhängig voneinander ein 5-gliedriger oder 6-gliedriger carbocyclischer oder heterocyclischer Ring ist;
Z¹ und Z² jeweils unabhängig C oder N sind;
jedes von X¹ bis X⁷ jeweils unabhängig C oder N ist;
K ausgewählt ist aus der Gruppe bestehend aus einer direkten Bindung, O, S, N(R^{α}), P(R^{α}), B(R^{α}), C(R^{α}), C(R^{α})(R^{β}), und Si(R^{α})(R^{β});
R^{A}, R^{B}, R^{C} und R^{D} jeweils unabhängig voneinander Mono bis zu der maximal zulässigen Substitution oder keine Substitution darstellen;
jedes R^{α}, R^{β}, R^{A}, R^{B}, R^{C}, und R^{D} unabhängig ein Wasserstoff oder ein Substituent ist, ausgewählt aus der Gruppe bestehend aus Deuterium, Halogen, Alkyl, Cycloalkyl, Heteroalkyl, Heterocycloalkyl, Boryl, Arylalkyl, Alkoxy, Aryloxy, Amino, Silyl, Germyl, Alkenyl, Cycloalkenyl, Heteroalkenyl, Alkynyl, Aryl, Heteroaryl, Acyl, Carbonsäure, Ether, Ester, Nitril, Isonitril, Sulfanyl, Sulfinyl, Sulfonyl, Phosphino, Selenyl und Kombinationen davon;
beliebige zwei Substituenten miteinander verbunden oder verschmolzen sein können, um einen Ring zu bilden;
L_{A} mit einem Metall M verbunden ist, das eine Atommasse von mindestens 40 aufweist;
M mit anderen Liganden koordiniert sein kann; und
L_{A} mit anderen Liganden verbunden sein kann, um einen dreizähnigen, vierzähnigen, fünfzähnigen oder sechszähnigen Liganden zu umfassen.

2. Verbindung nach Anspruch 1, wobei das Metall M ausgewählt ist aus der Gruppe bestehend aus Ir, Rh, Re, Ru, Os, Pt, Pd, Ag, Au und Cu.

3. Verbindung nach Anspruch 1, wobei K ausgewählt ist aus der Gruppe bestehend aus N(R^{α}), P(R^{α}), B(R^{α}), C(R^{α}), C(R^{α})(R^{β}), und Si(R^{α})(R^{β}); und/oder
wobei mindestens eines von R^{α} oder R ^{β} mit R^{D} verbunden ist, um einen Ring zu bilden, der mit der Einheit D verschmolzen ist; und/oder
wobei K eine direkte Bindung ist, O oder S; und/oder wobei Z¹ N ist und Z² C ist oder wobei Z¹ Carbenkohlenstoff ist und Z² C ist; und/oder
wobei jedes von X¹ bis X⁷ C ist oder mindestens eines von X¹ bis X⁷ N ist; und/oder
wobei ein R^{A} mit einem R^{B} verbunden ist, um einen Ring zu bilden; und/oder wobei ein R^{B} mit einem R^{C} verbunden ist, um einen Ring zu bilden; und/oder wobei ein R^{C} mit einem R^{D} verbunden ist, um einen Ring zu bilden.

4. Verbindung nach Anspruch 1, wobei jede der Einheiten A, B, C und D unabhängig voneinander ausgewählt ist aus der Gruppe bestehend aus Benzol, Pyridin, Pyrimidin, Pyridazin, Pyrazin, Triazin, Imidazol, Pyrazol, Pyrrol, Oxazol, Furan, Thiophen, Thiazol, Triazol, Naphthalin, Chinolin, Isochinolin, Chinazolin, Benzofuran, Aza-Benzofuran, Benzoxazol, Aza-Benzoxazol, Benzothiophen, Aza-Benzothiophen, Benzothiazol, Aza-Benzothiazol, Benzoselenophen, Aza-Benzoselenophen, Inden, Aza-Inden, Indol, Aza-Indol, Benzimidazol, Aza-Benzimidazol, Carbazol, Aza-Carbazol, Dibenzofuran, Aza-Dibenzofuran, Dibenzothiophen, Aza-Dibenzothiophen, Chinoxalin, Phthalazin, Phenanthren, Aza-Phenanthren, Anthracen, Aza-Antracen, Phenanthridin, Fluoren und Aza-Fluoren.

5. Verbindung nach Anspruch 1, wobei der Ligand L_{A} ausgewählt ist aus der Gruppe bestehend aus: 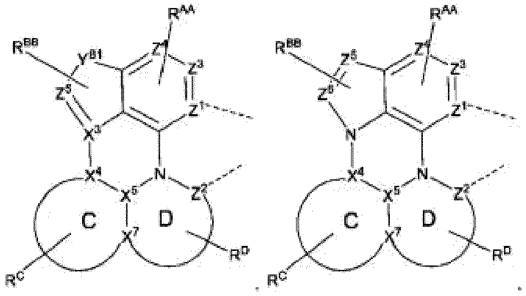 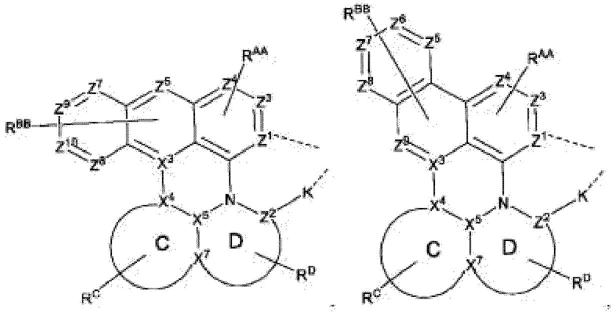 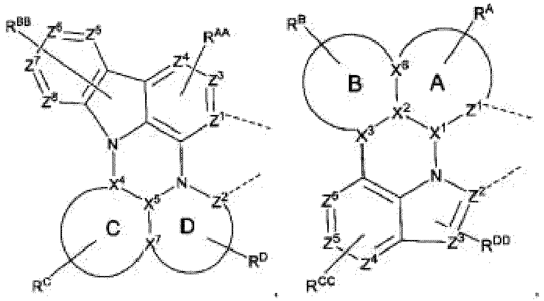 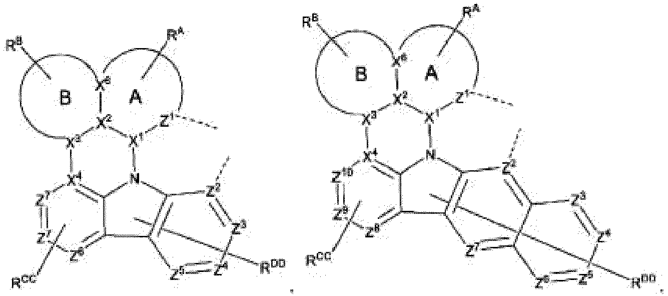 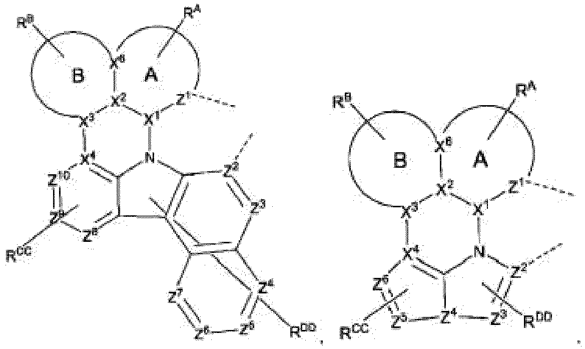 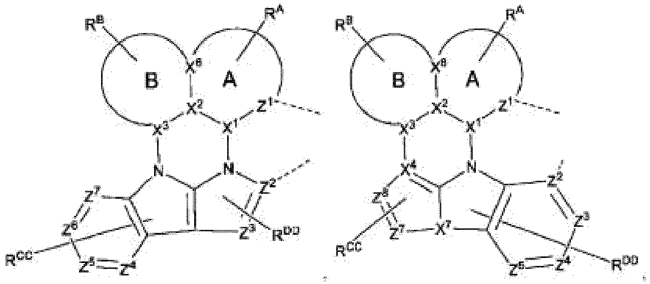 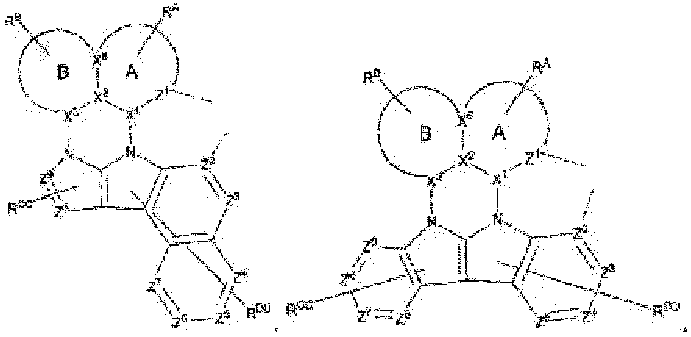 und 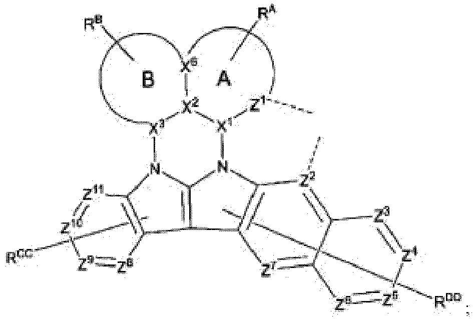 wobei:
jedes von Z³ bis Z¹¹ jeweils unabhängig C oder N ist;
jedes Y^{B1} unabhängig ausgewählt ist aus der Gruppe bestehend aus BR, BRR', NR, PR, P(O)R, O, S, Se, C=O, C=S, C=Se, C=NR, C= CRR', S=O, SO₂, CR, CRR', SiRR', und GeRR' ;
jedes von R^{AA}, R^{BB}, R^{CC} und R^{DD} unabhängig voneinander Mono bis zu der maximal zulässigen Substitution oder keine Substitution darstellt;
jedes R, R', R^{AA}, R^{BB}, R^{CC}, und R^{DD} unabhängig ein Wasserstoff oder ein Substituent ist, ausgewählt aus der Gruppe bestehend aus Deuterium, Halogen, Alkyl, Cycloalkyl, Heteroalkyl, Heterocycloalkyl, Boryl, Arylalkyl, Alkoxy, Aryloxy, Amino, Silyl, Germyl, Alkenyl, Cycloalkenyl, Heteroalkenyl, Alkynyl, Aryl, Heteroaryl, Acyl, Carbonsäure, Ether, Ester, Nitril, Isonitril, Sulfanyl, Sulfinyl, Sulfonyl, Phosphino, Selenyl und Kombinationen davon; und
beliebige zwei Substituenten miteinander verbunden oder verschmolzen sein können, um einen Ring zu bilden.

6. Verbindung nach Anspruch 1, wobei der Ligand L_{A} ausgewählt ist aus der Gruppe bestehend aus: 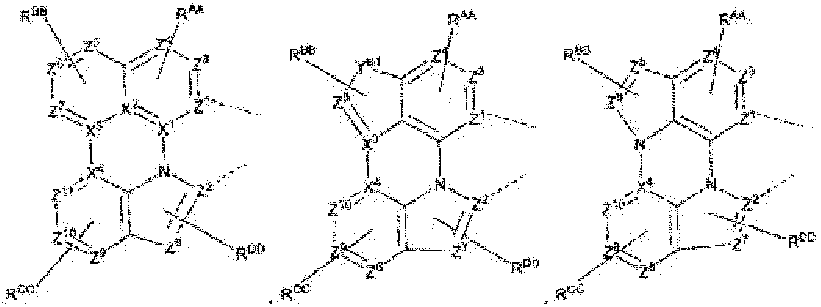 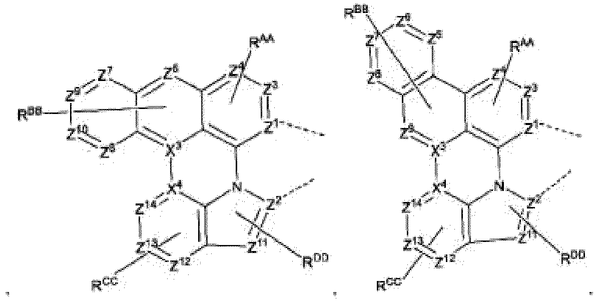 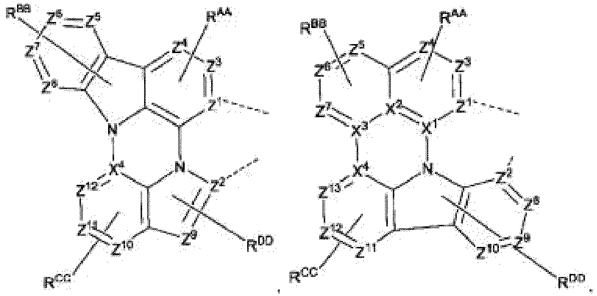 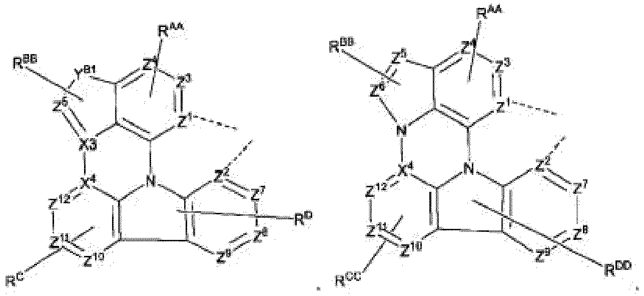 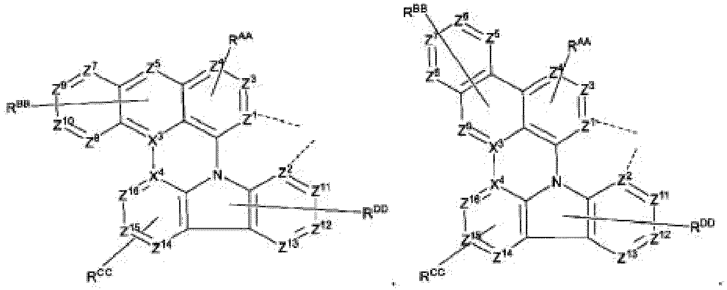 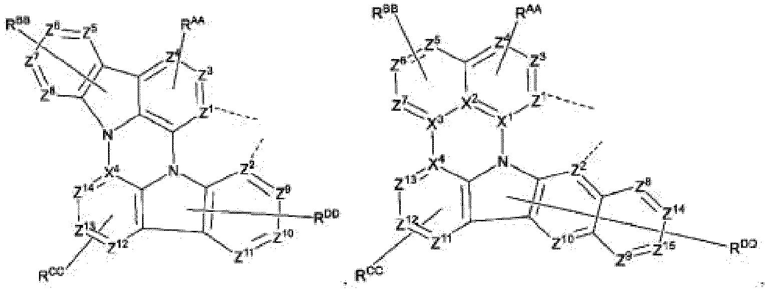 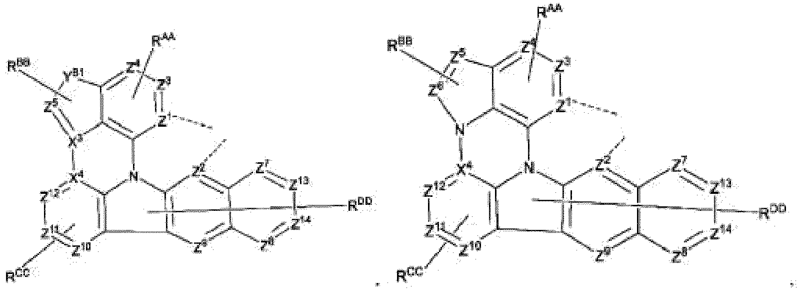 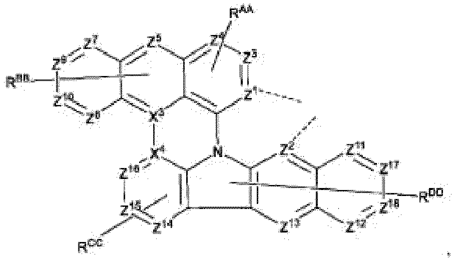 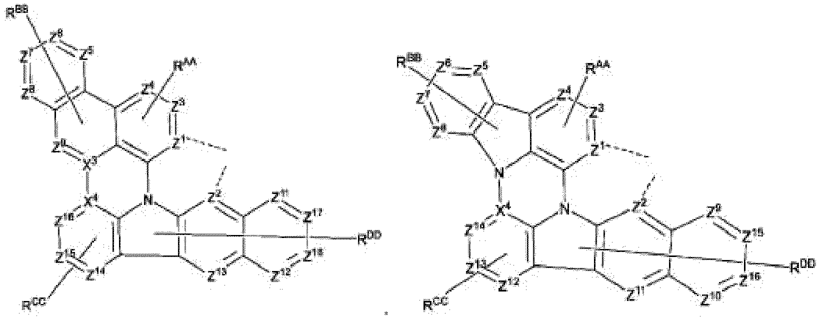 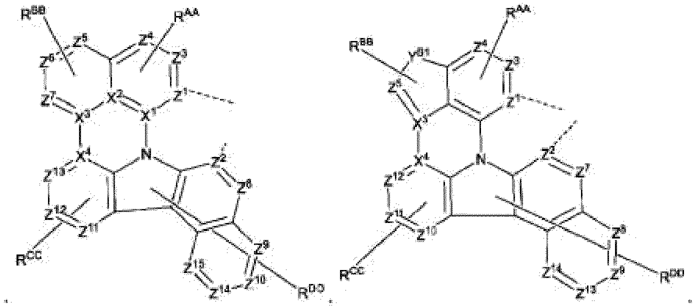 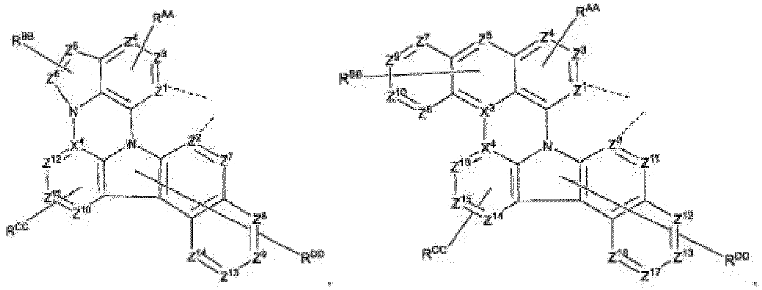 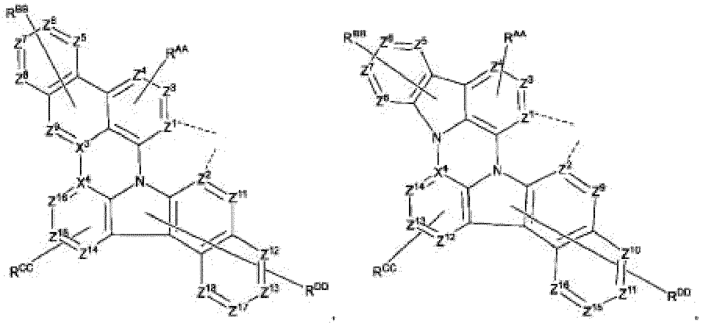 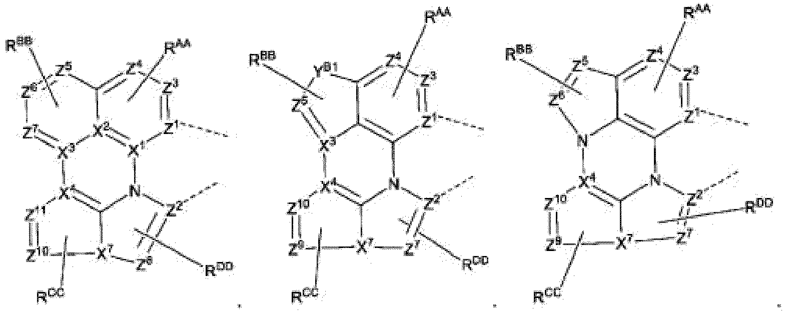 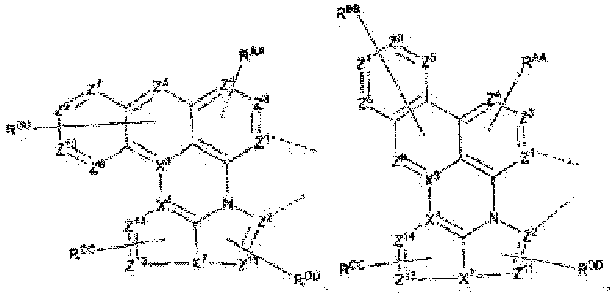 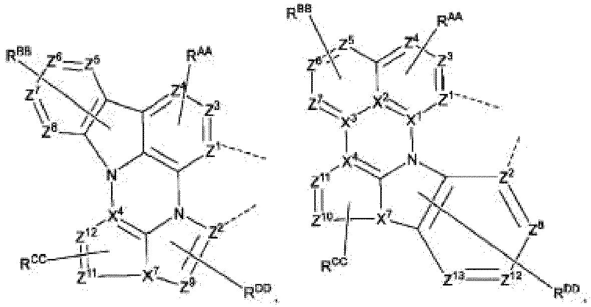 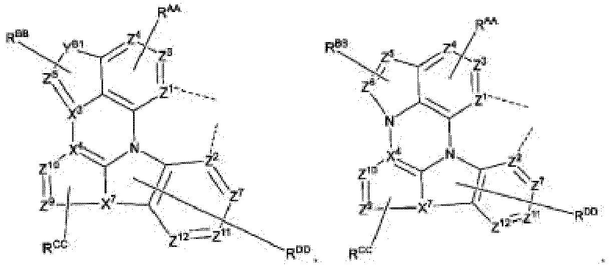 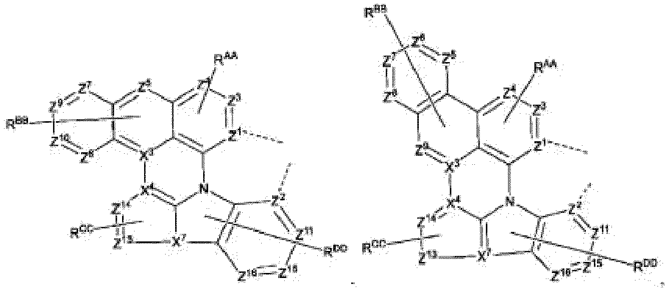 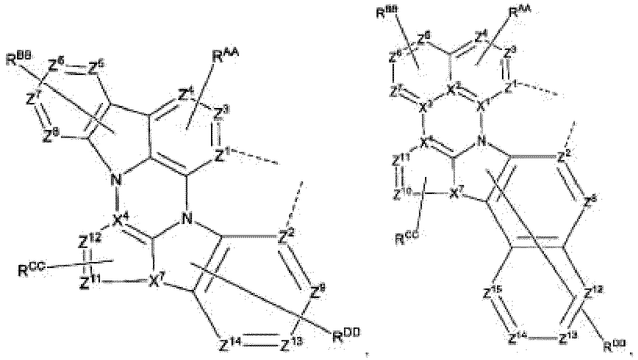 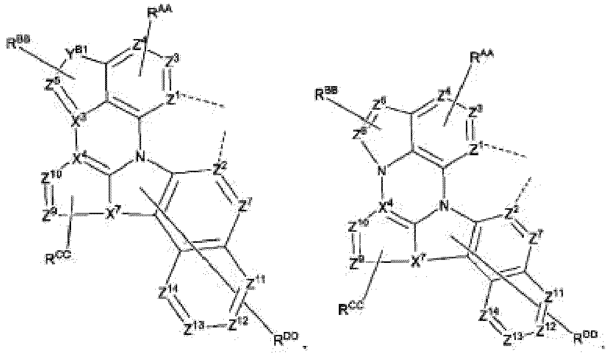 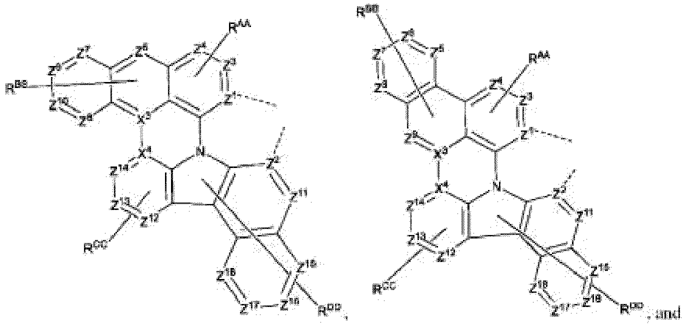 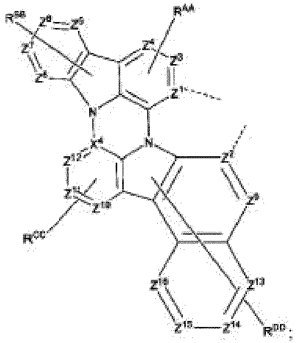 wobei:
jedes von Z³ bis Z¹⁸ jeweils unabhängig C oder N ist;
jedes Y^{B1} unabhängig ausgewählt ist aus der Gruppe bestehend aus BR, BRR', NR, PR, P(O)R, O, S, Se, C=O, C=S, C=Se, C=NR, C= CRR', S=O, SO₂, CR, CRR', SiRR', und GeRR' ;
jedes von R^{AA}, R^{BB}, R^{CC} und R^{DD} unabhängig voneinander Mono bis zu der maximal zulässigen Substitution oder keine Substitution darstellt;
jedes R, R', R^{AA}, R^{BB}, R^{CC}, und R^{DD} unabhängig ein Wasserstoff oder ein Substituent ist, ausgewählt aus der Gruppe bestehend aus Deuterium, Halogen, Alkyl, Cycloalkyl, Heteroalkyl, Heterocycloalkyl, Boryl, Arylalkyl, Alkoxy, Aryloxy, Amino, Silyl, Germyl, Alkenyl, Cycloalkenyl, Heteroalkenyl, Alkynyl, Aryl, Heteroaryl, Acyl, Carbonsäure, Ether, Ester, Nitril, Isonitril, Sulfanyl, Sulfinyl, Sulfonyl, Phosphino, Selenyl und Kombinationen davon; und
beliebige zwei Substituenten miteinander verbunden oder verschmolzen sein können, um einen Ring zu bilden.

7. Verbindung nach Anspruch 1, wobei der Ligand L_{A} ausgewählt ist aus der Gruppe bestehend aus L_{Ai-m,} wobei i eine ganze Zahl von 1 bis 3136 und m eine ganze Zahl von 1 bis 154 ist, und wobei L_{Ai-1} bis L_{Ai-149} wie folgt definiert sind: 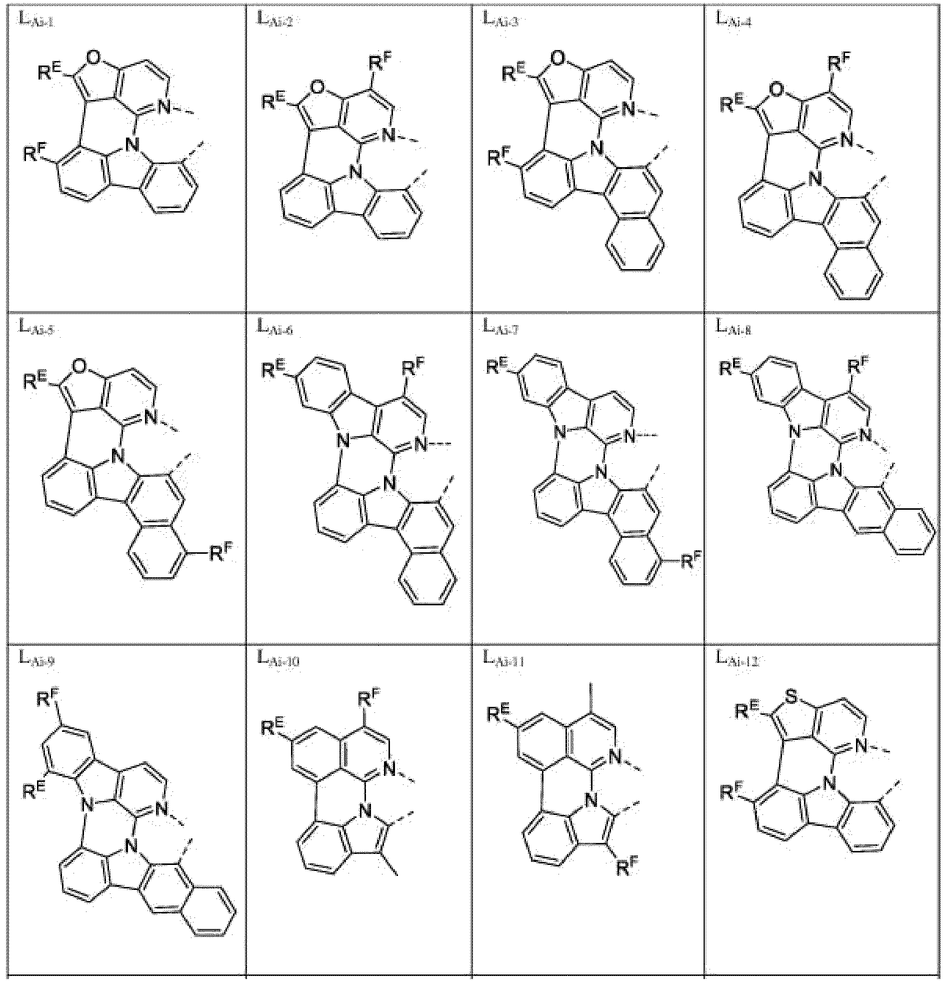 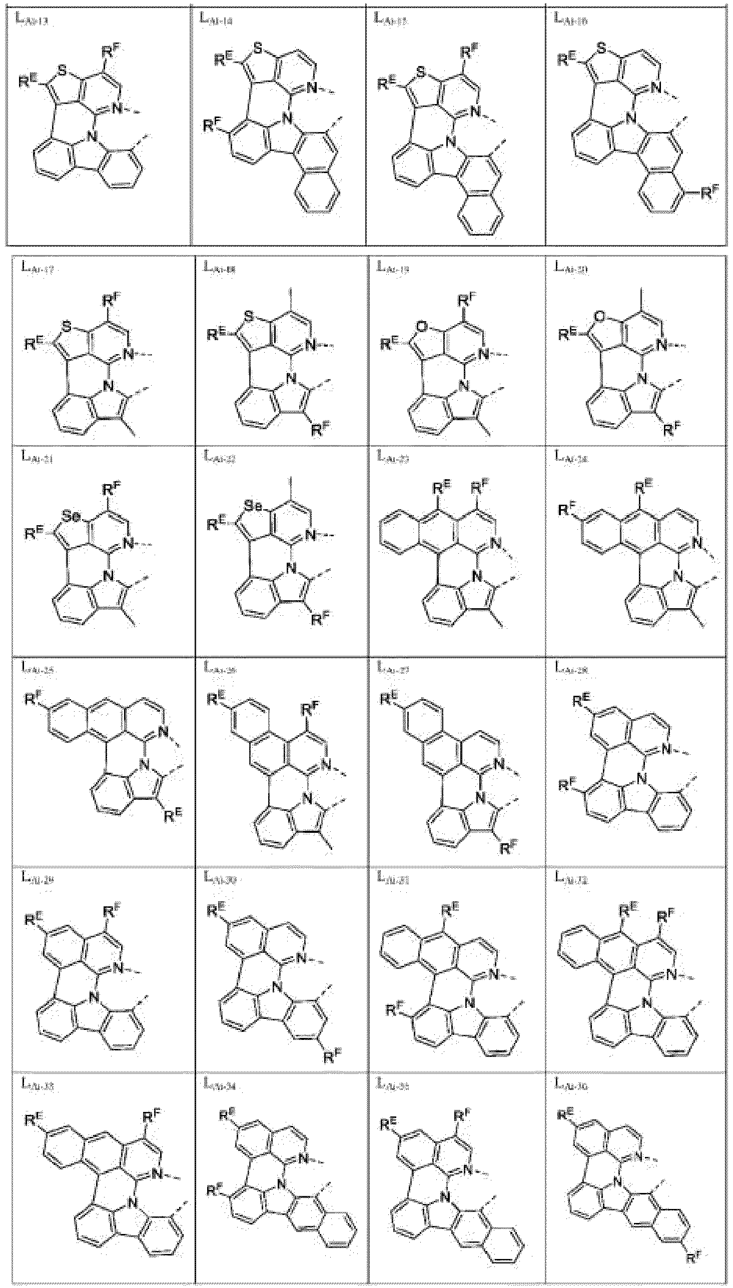 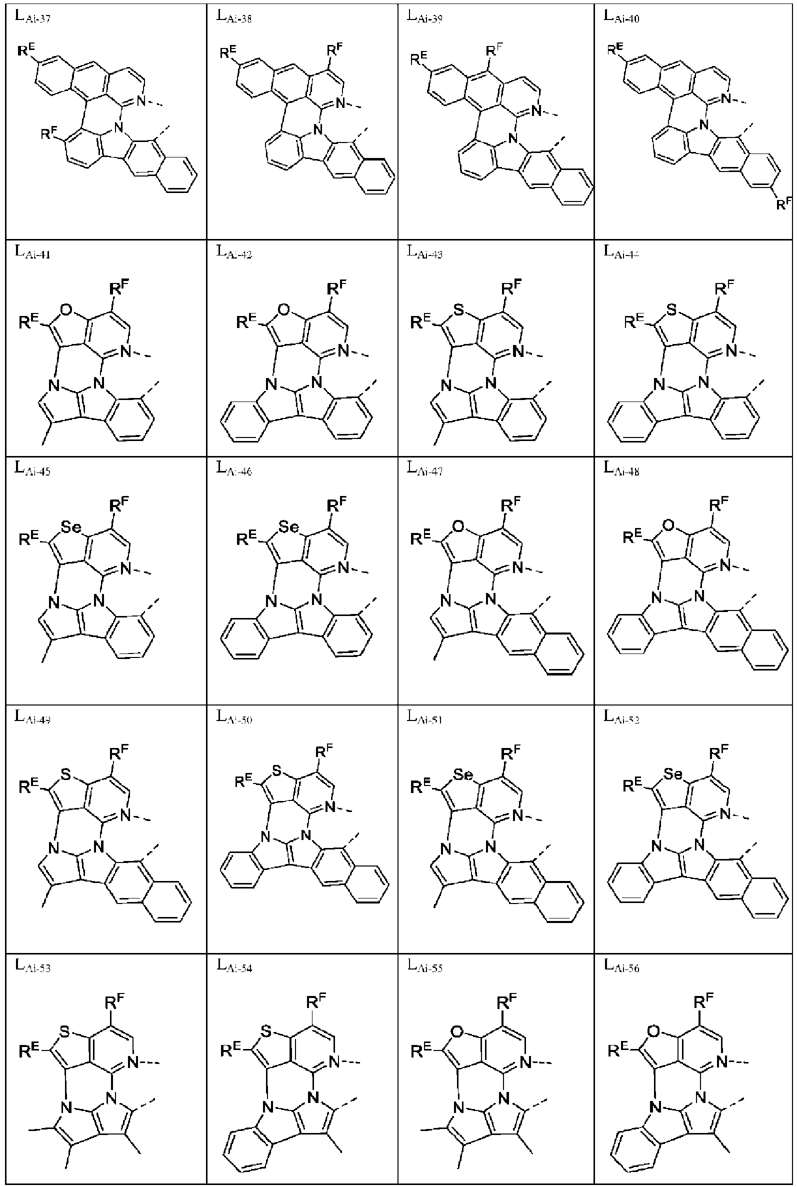 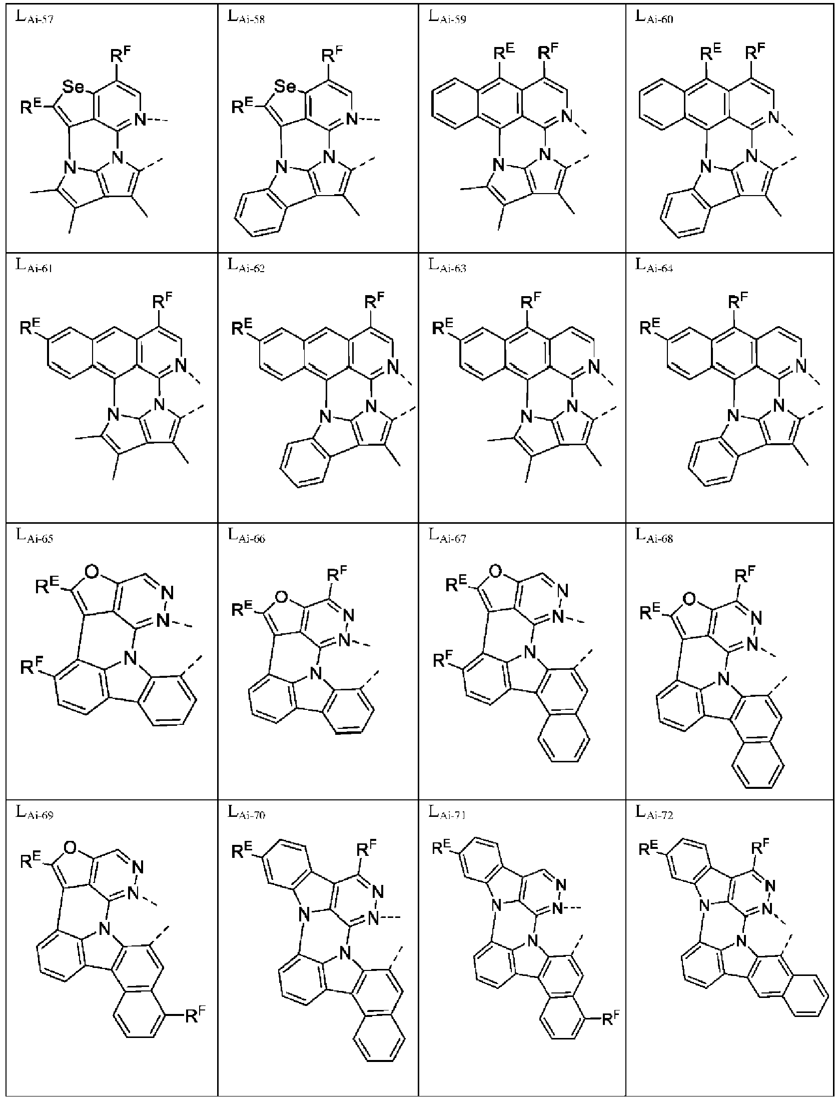 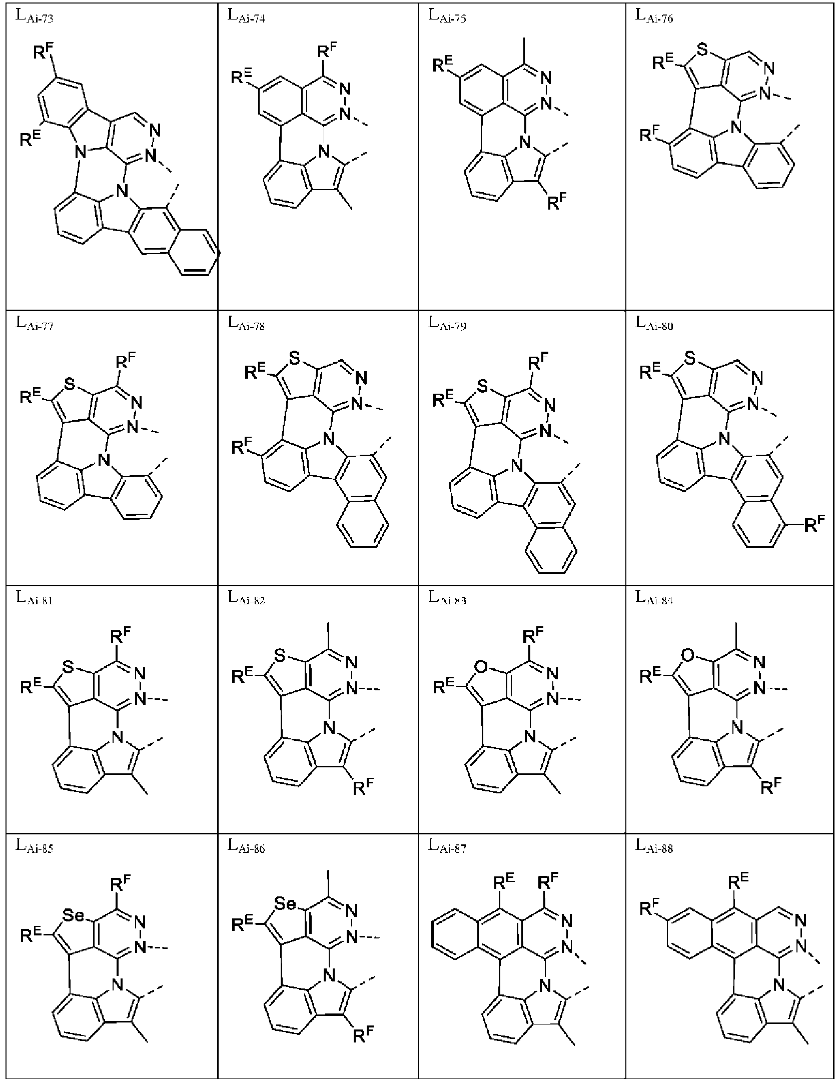 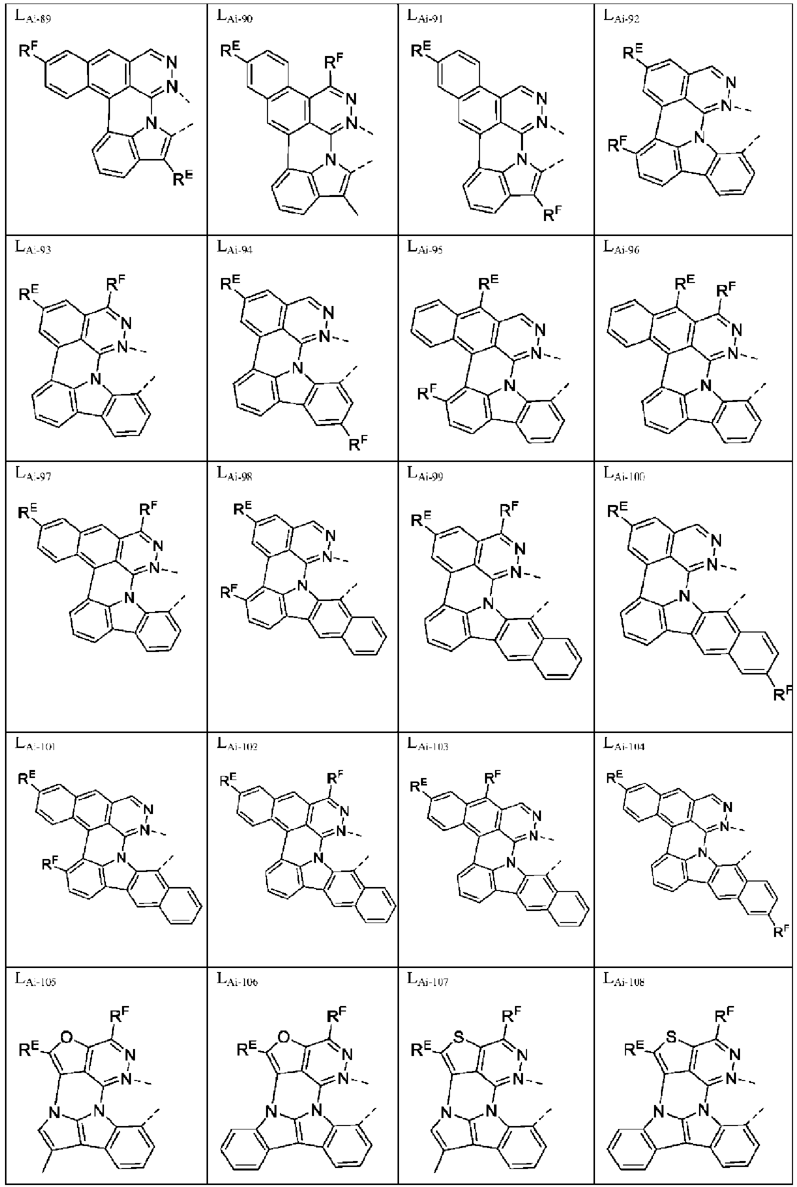 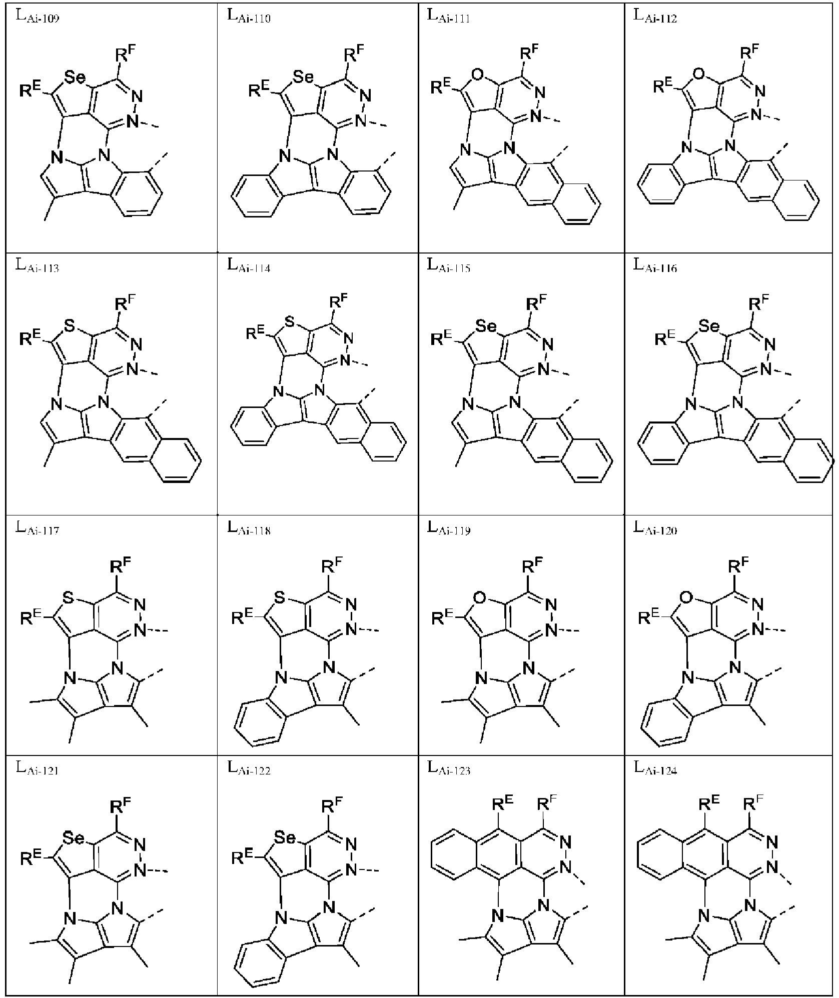 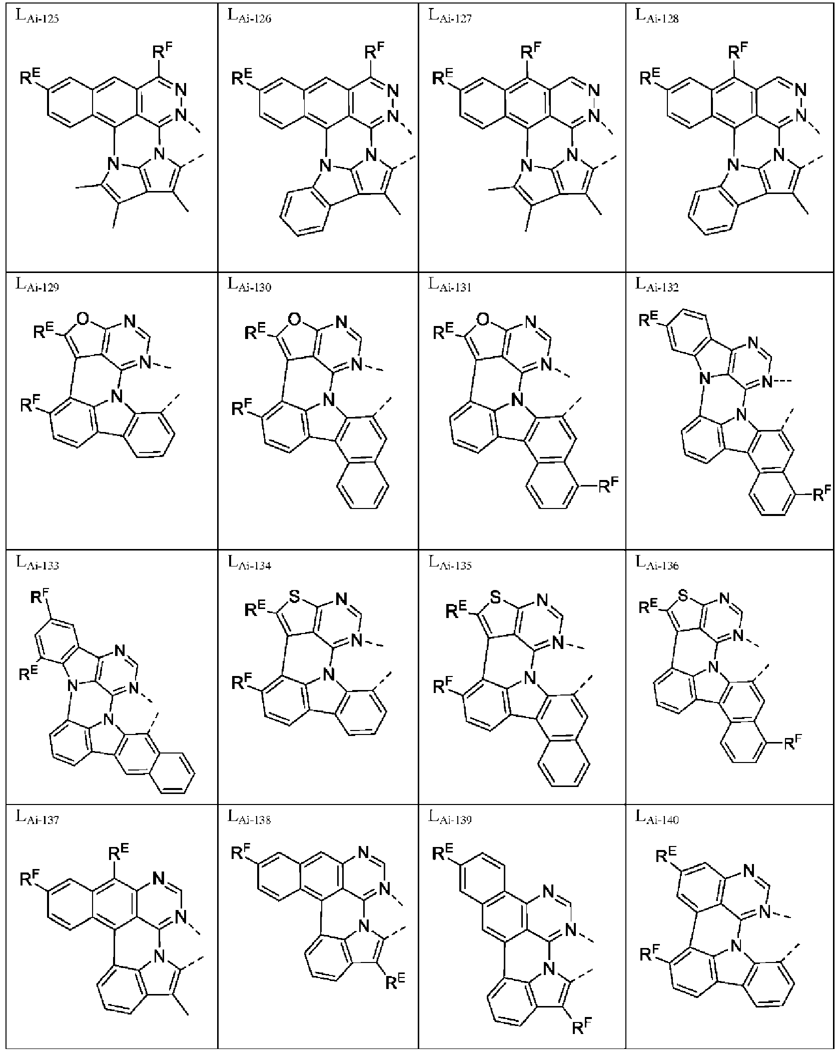 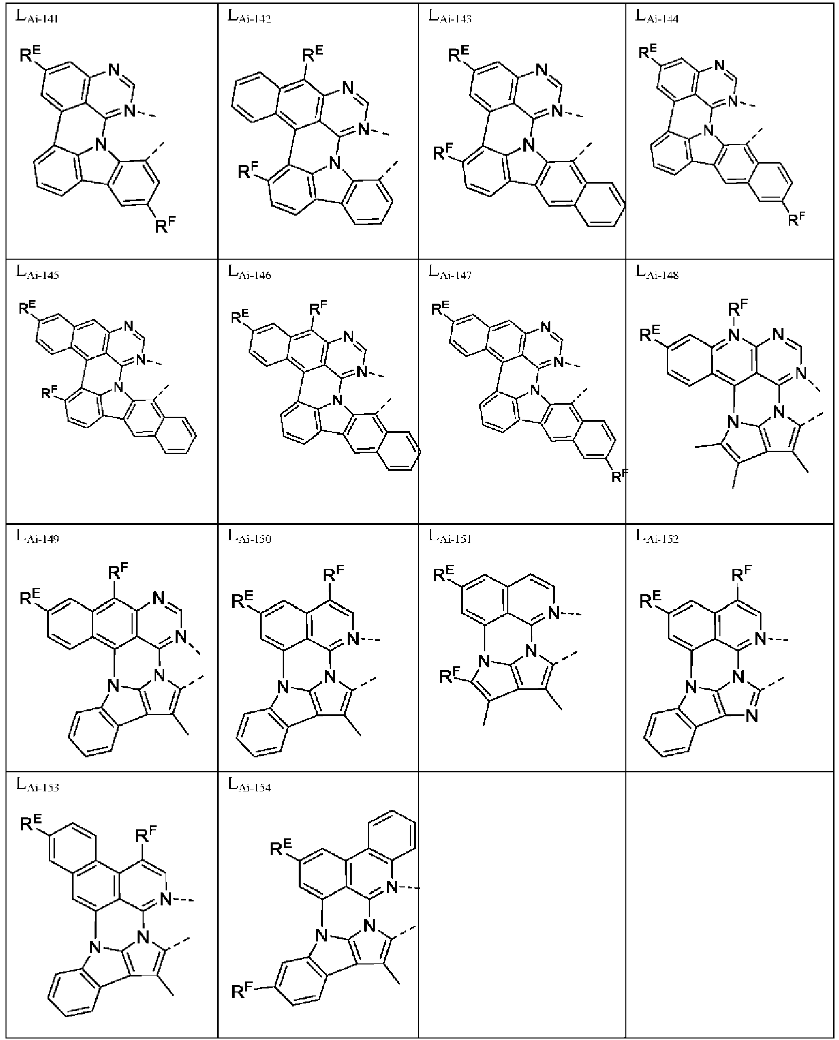 wobei für jedes i R^{E} und R^{F} wie folgt definiert sind: 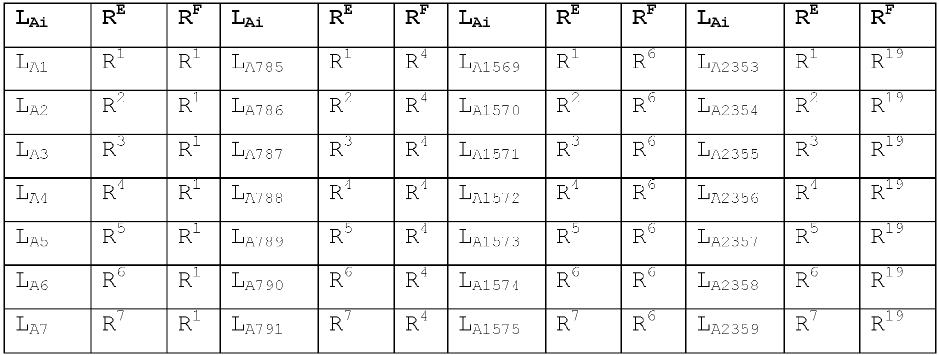 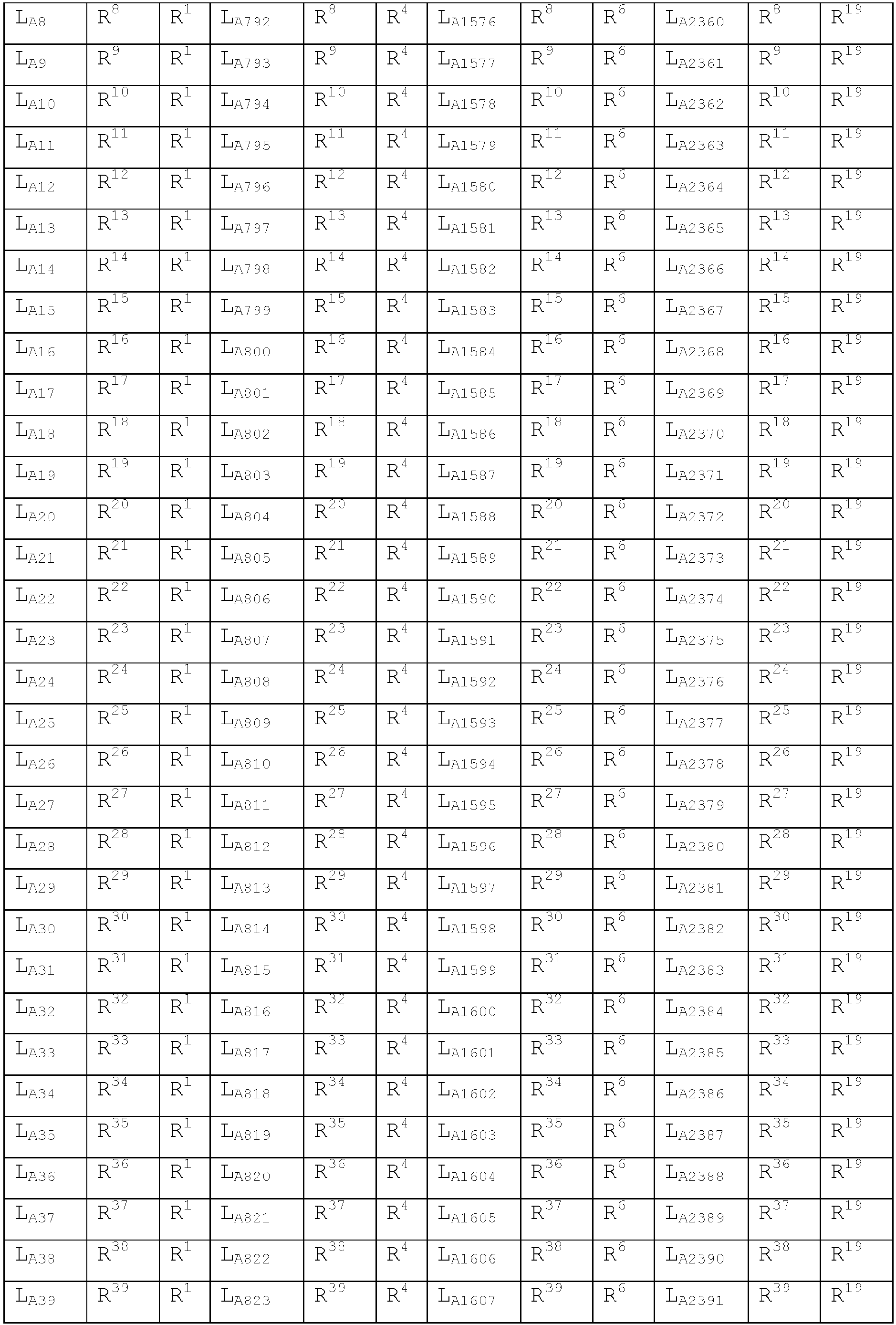 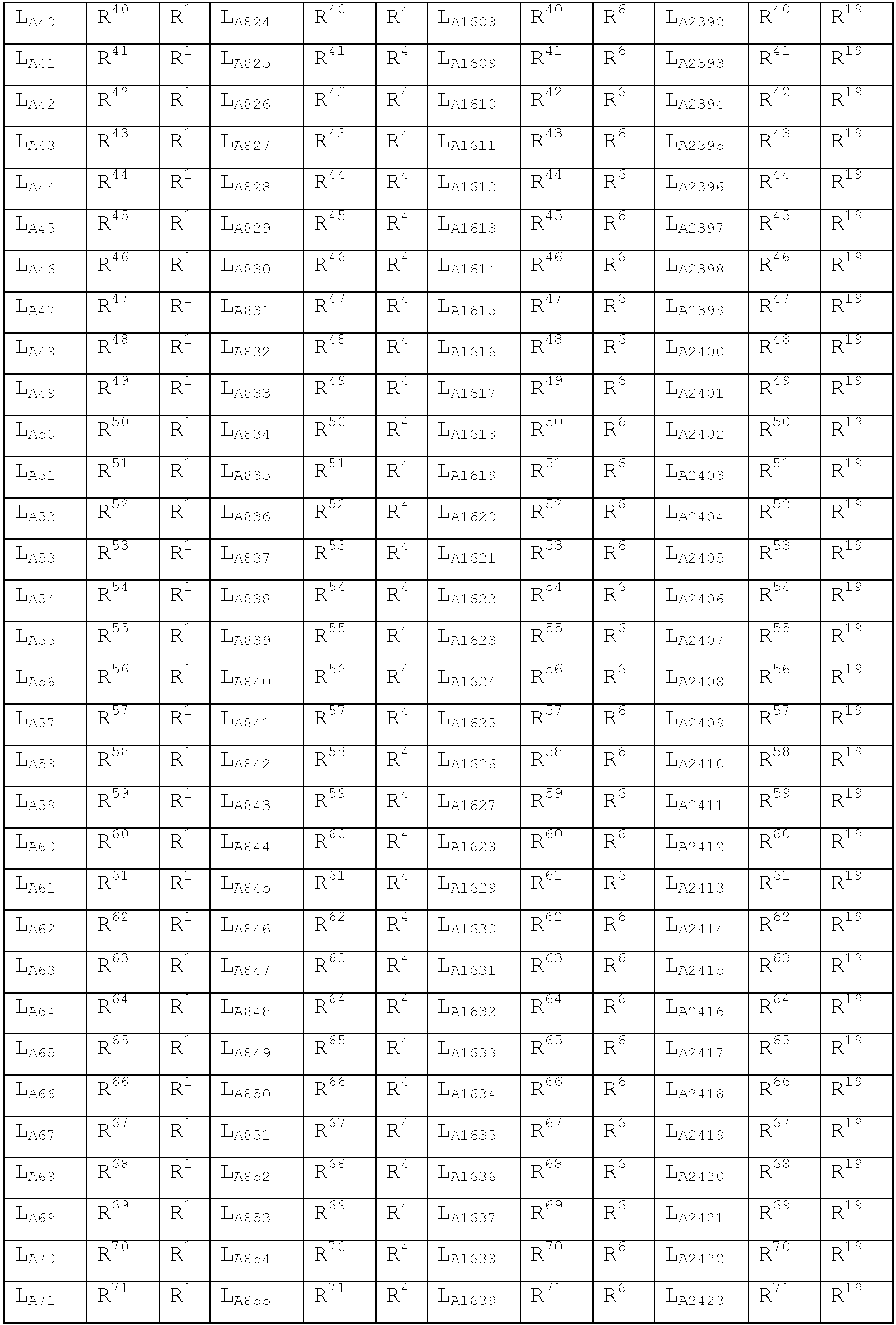 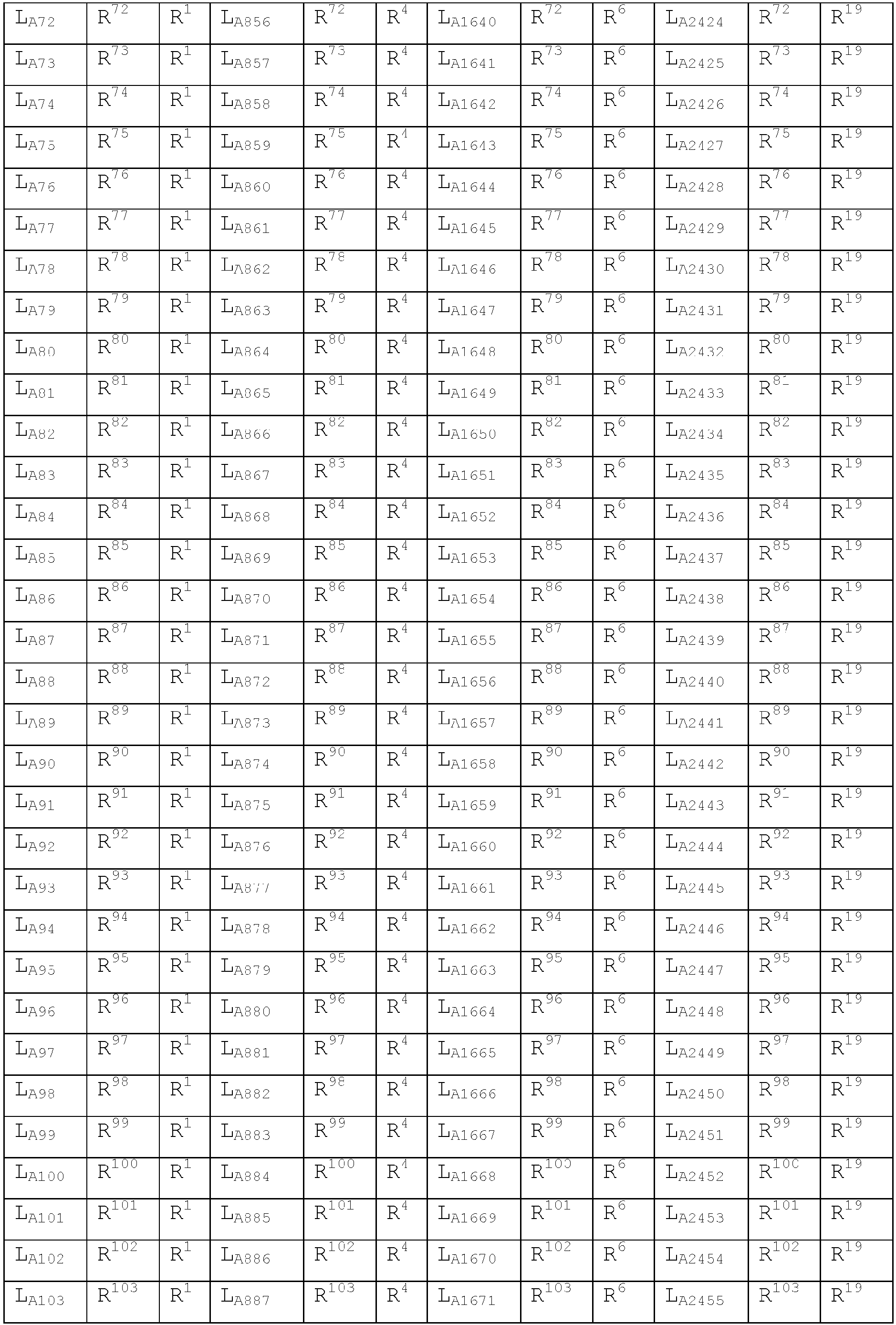 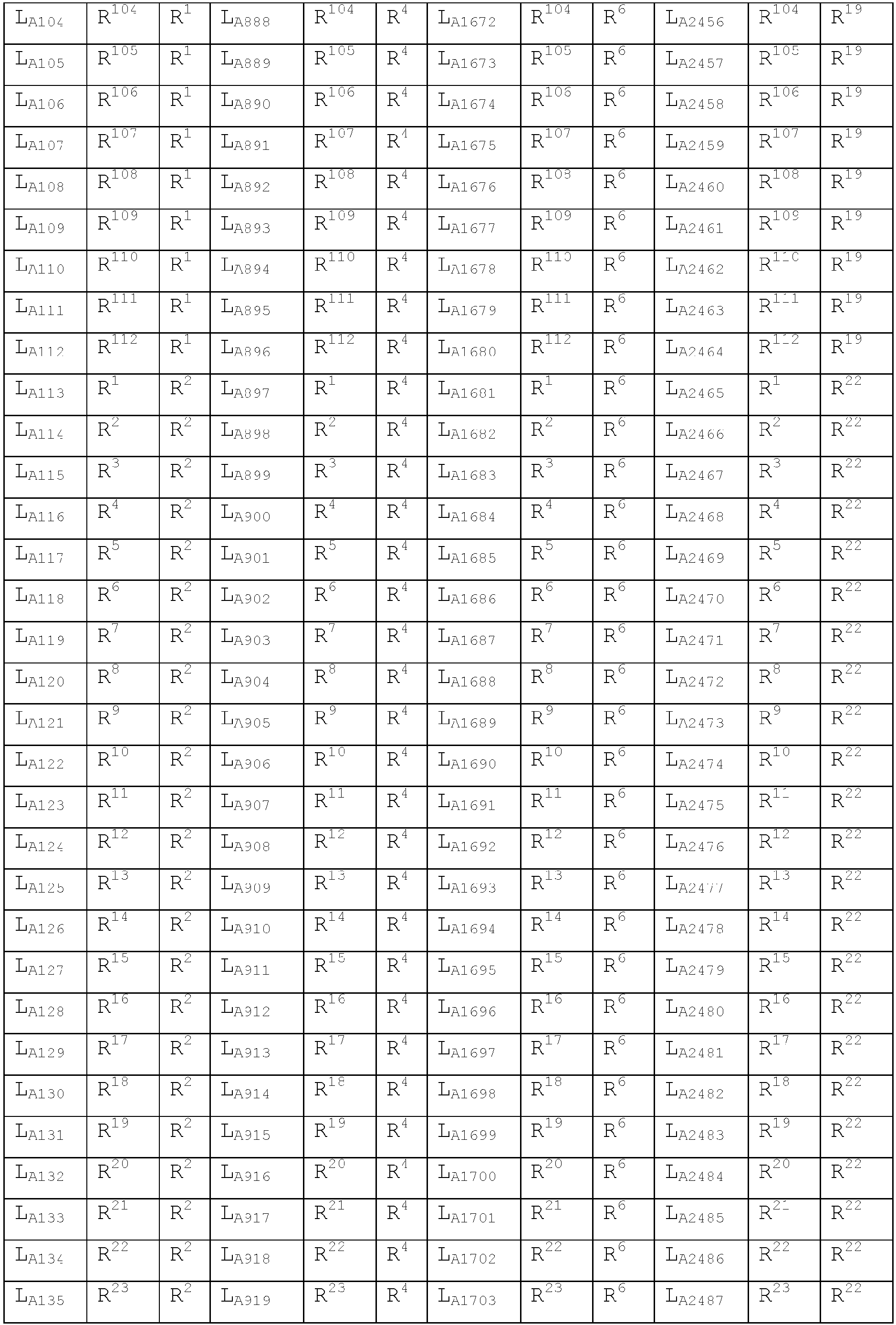 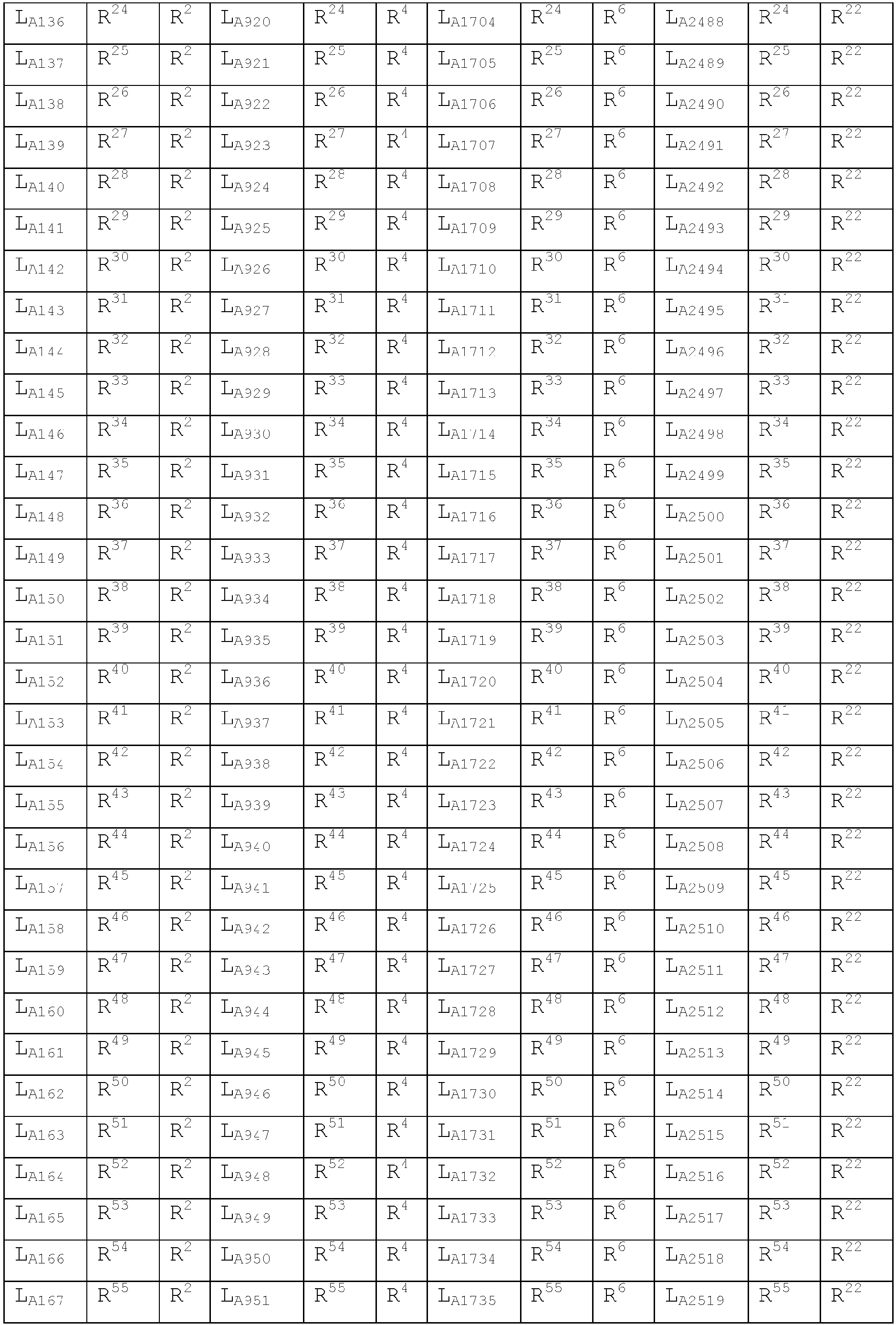 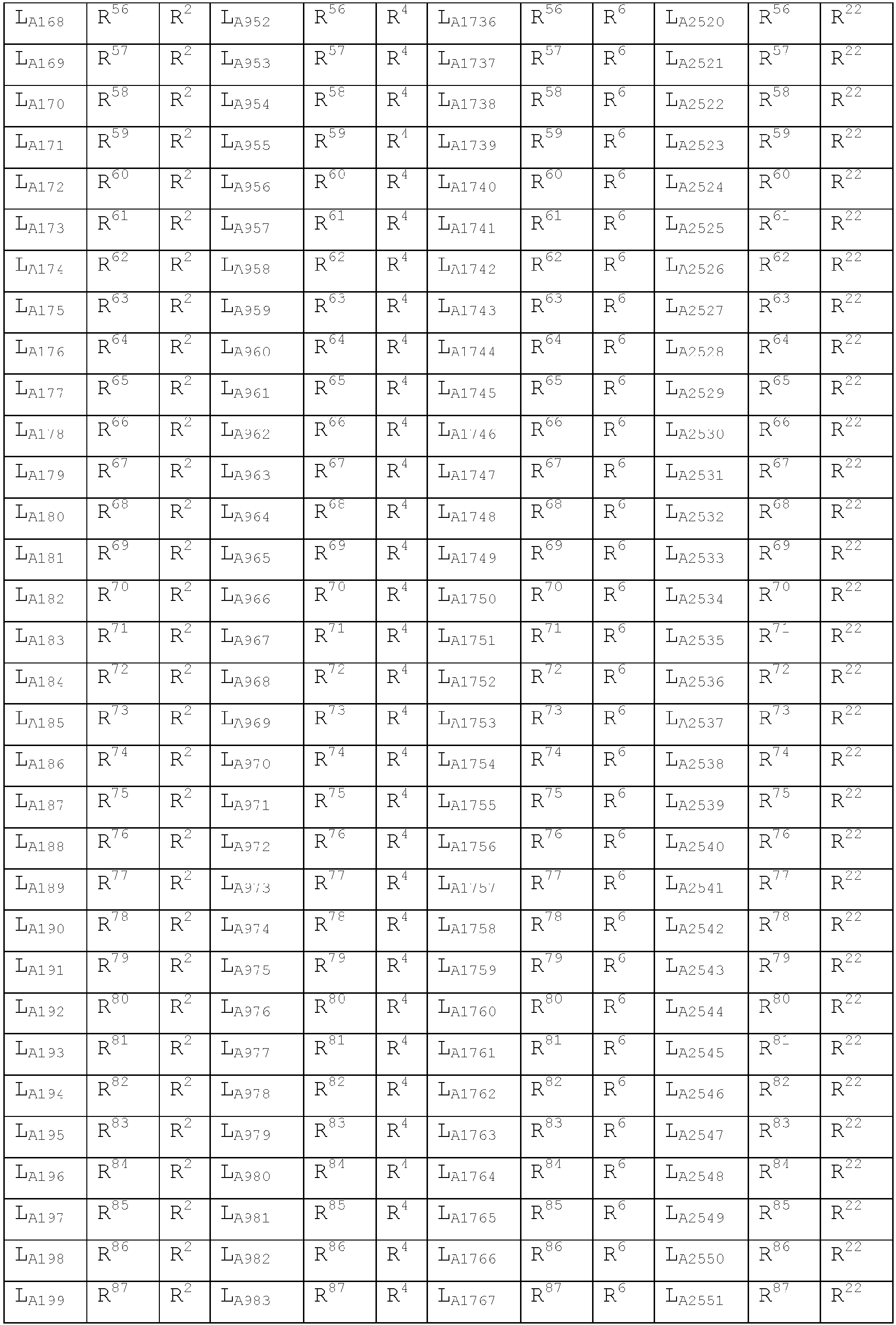 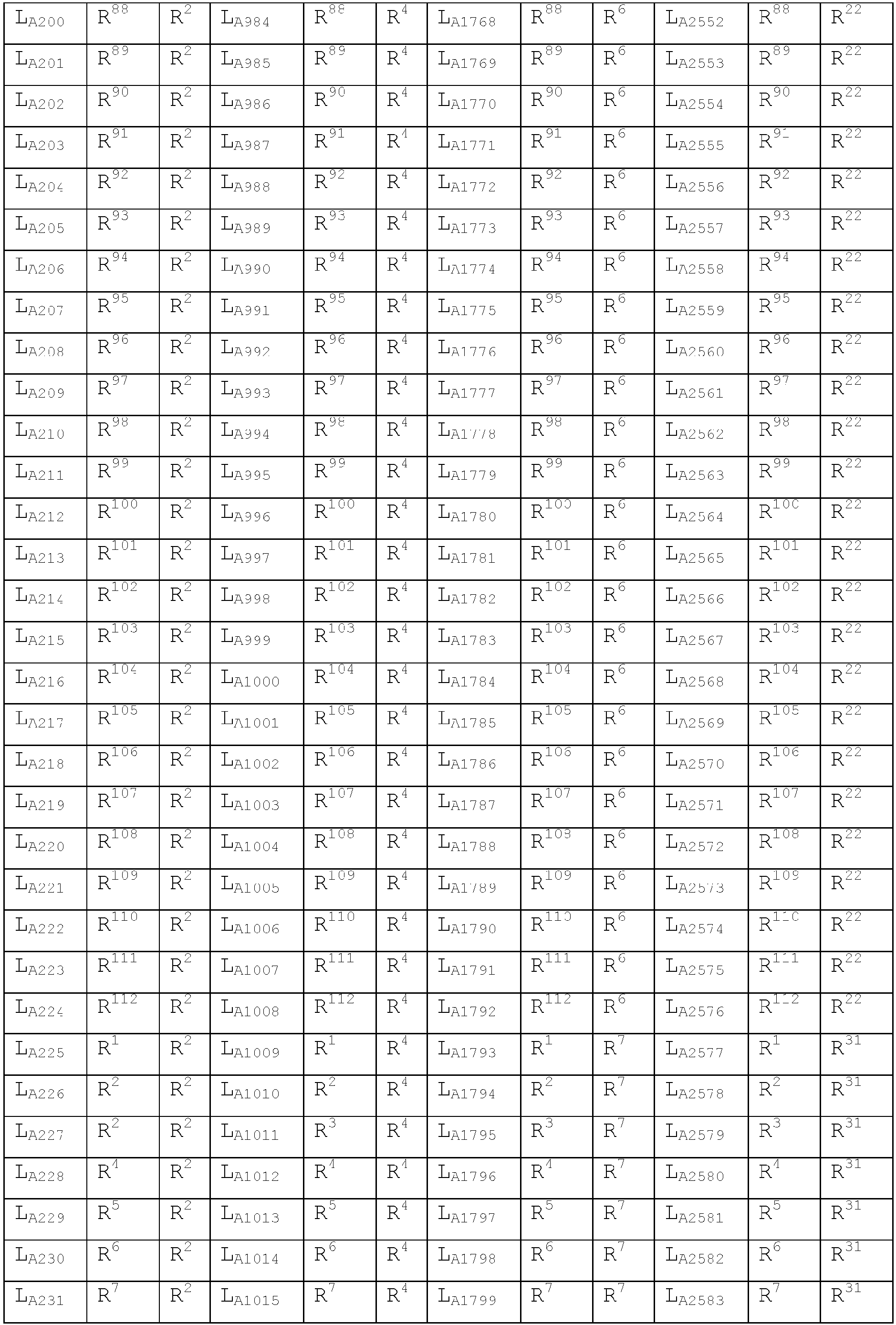 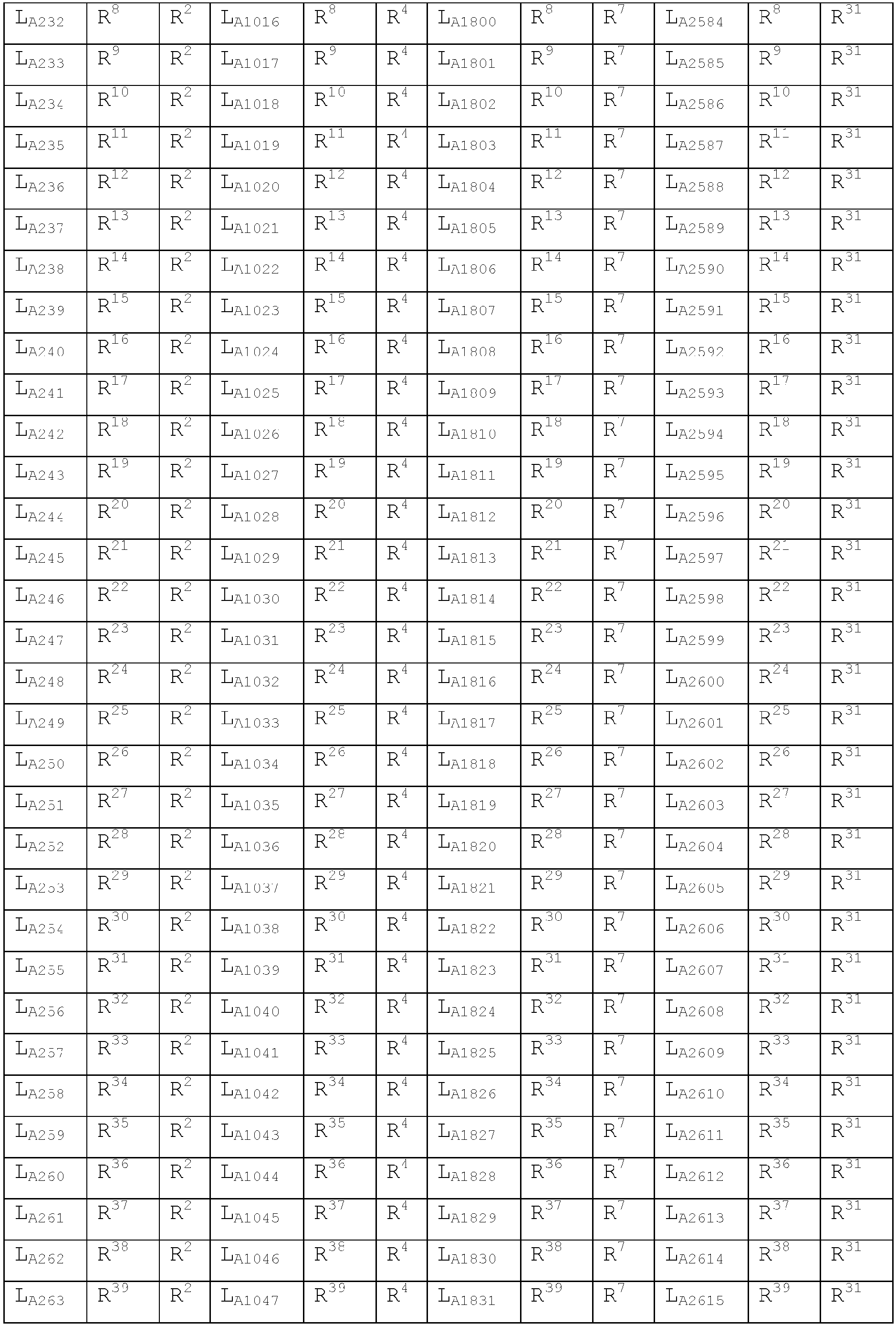 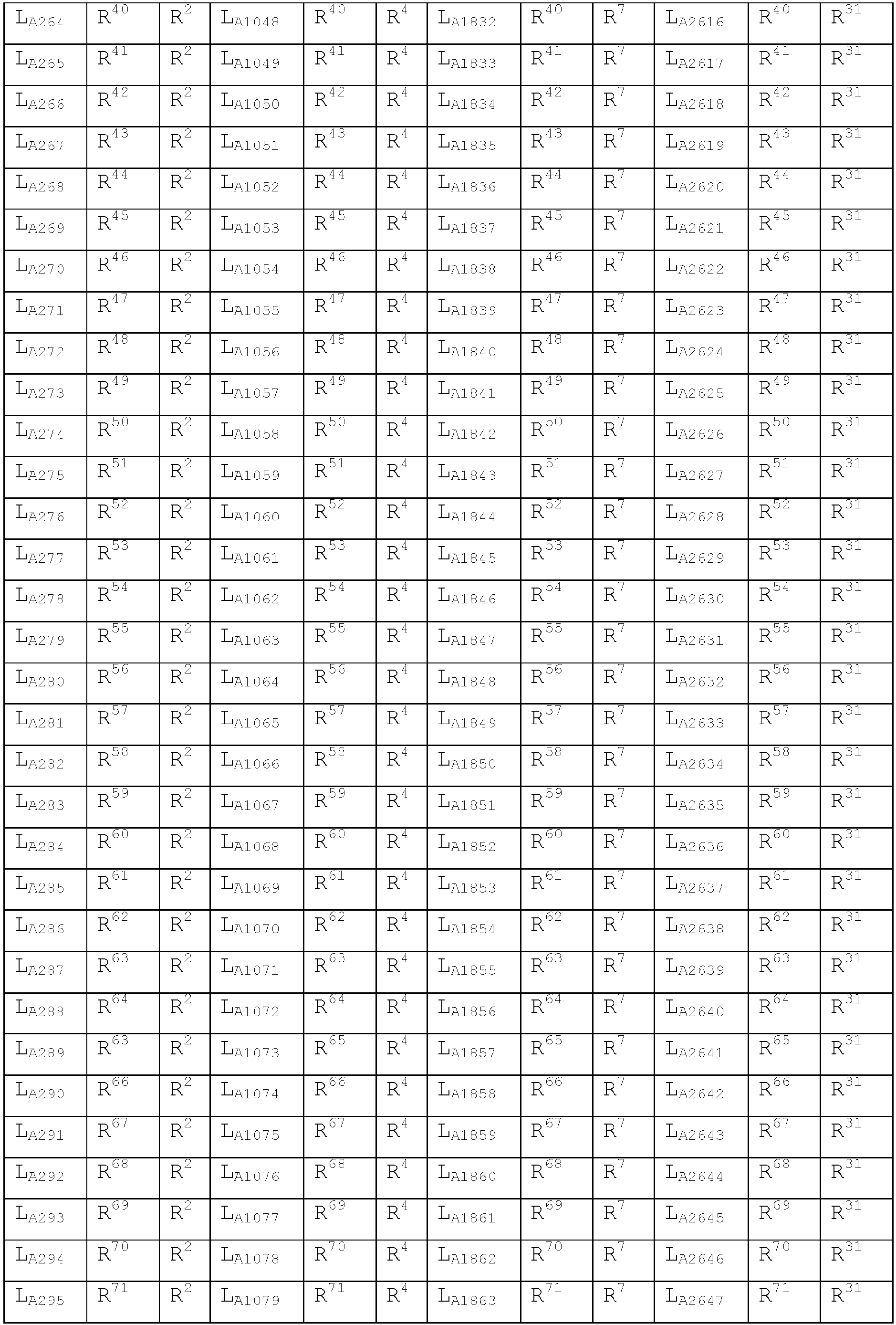 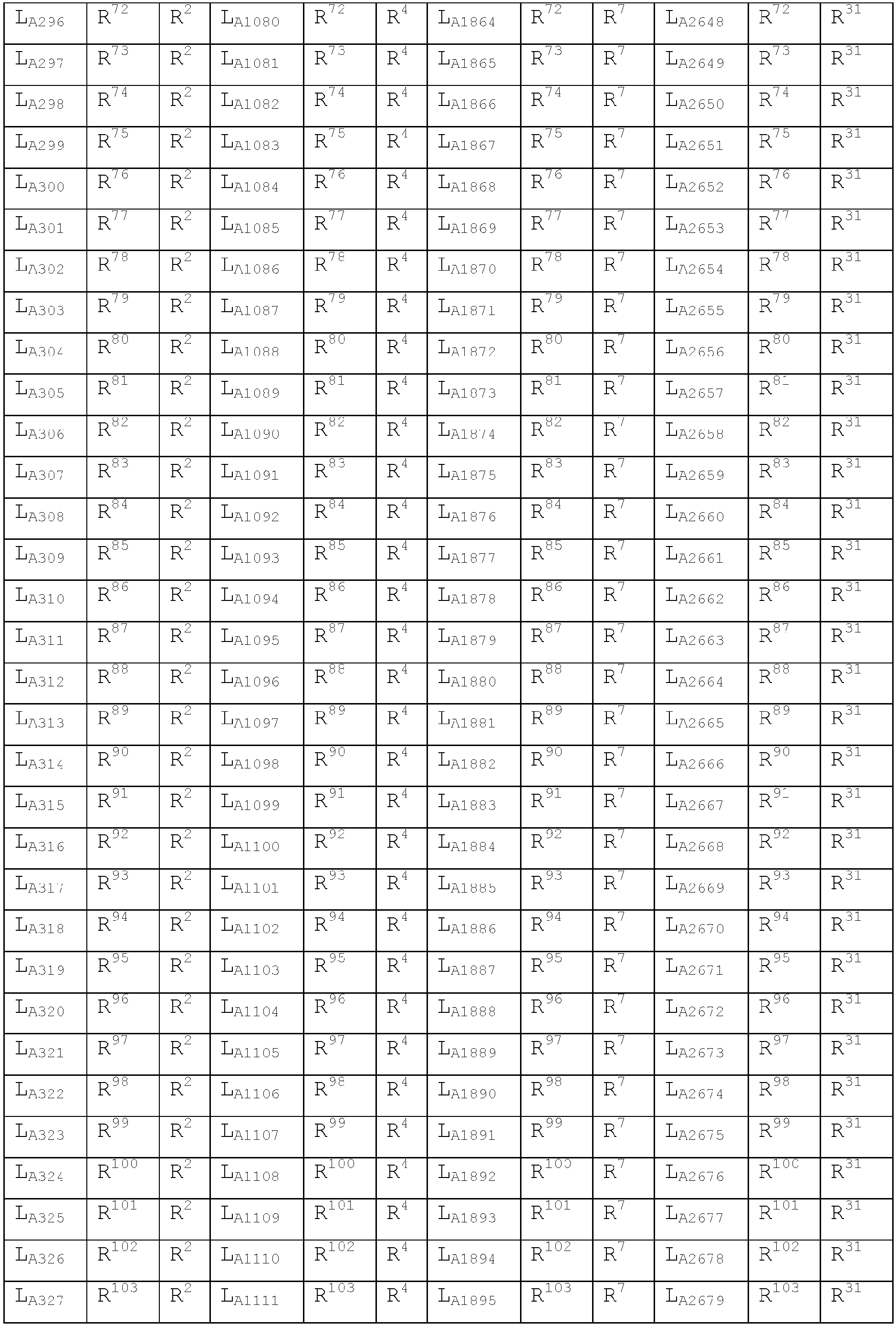 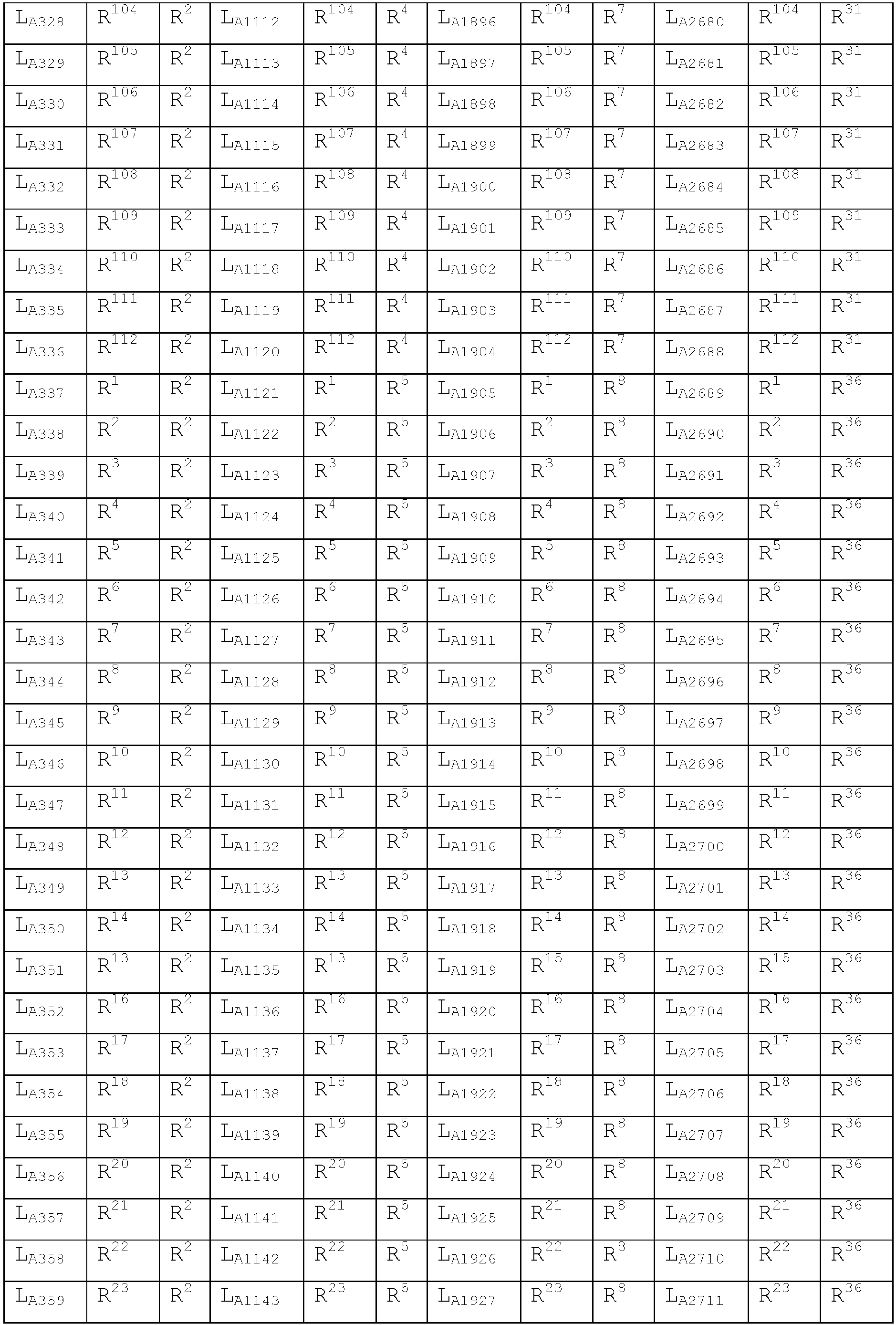 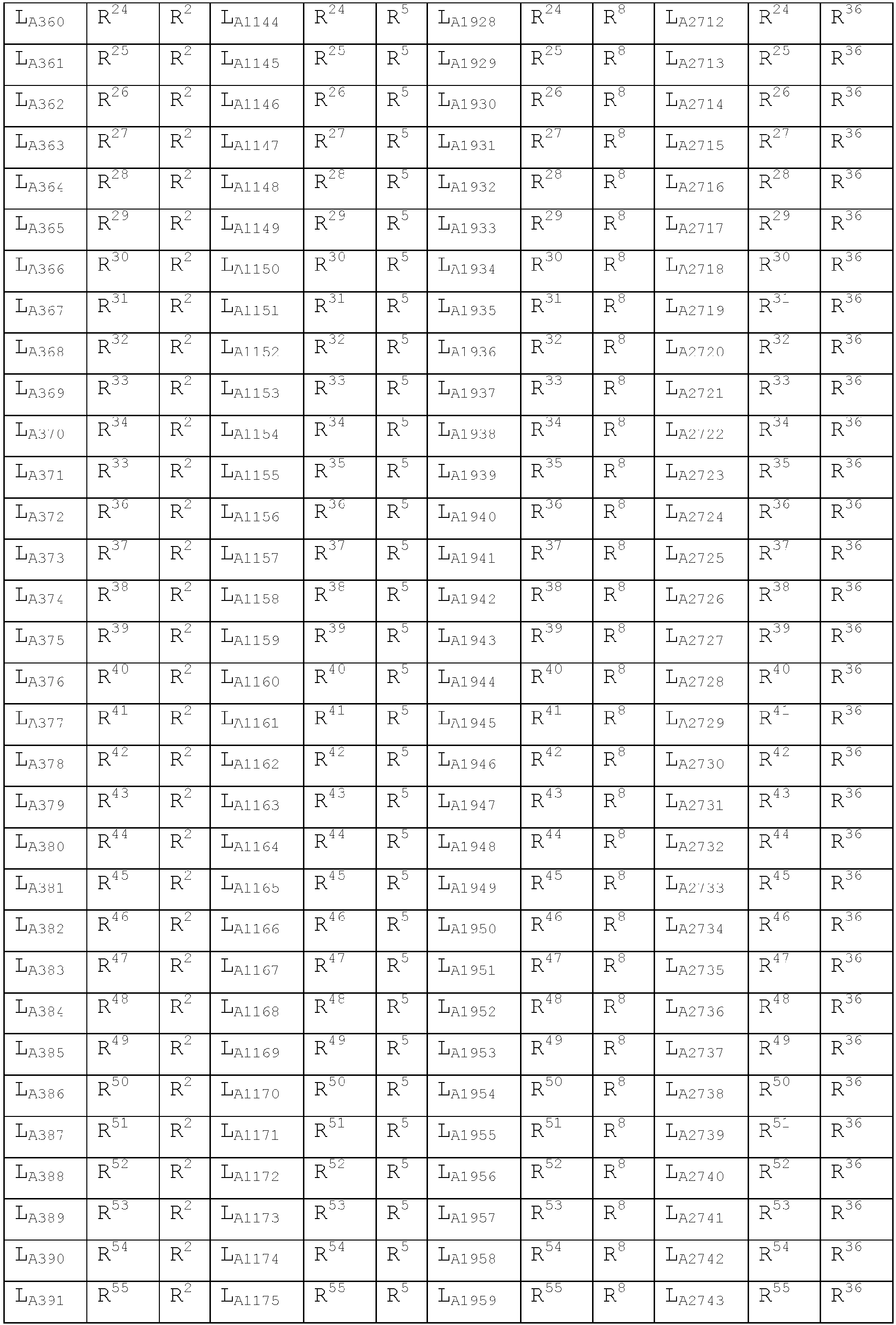 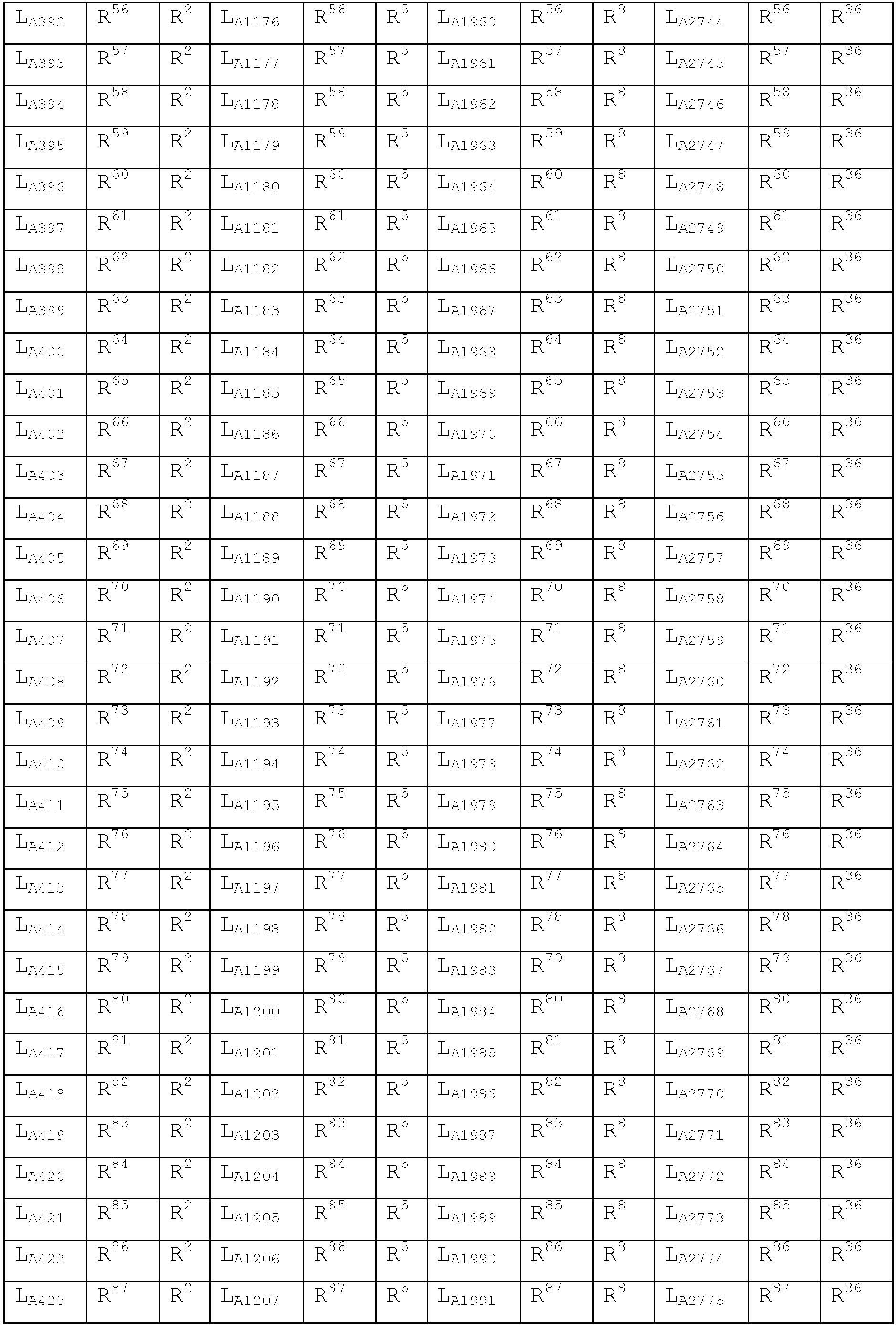 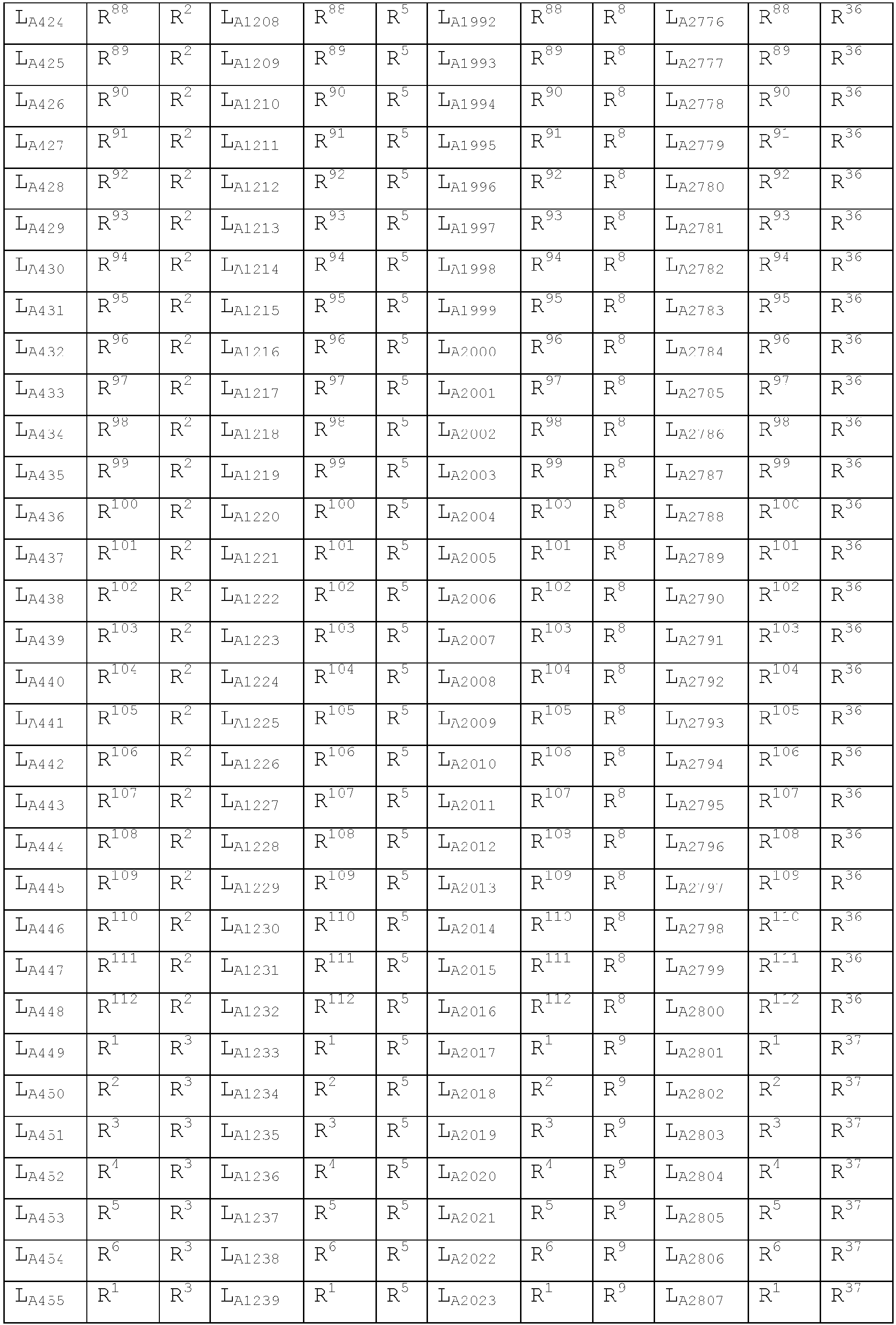 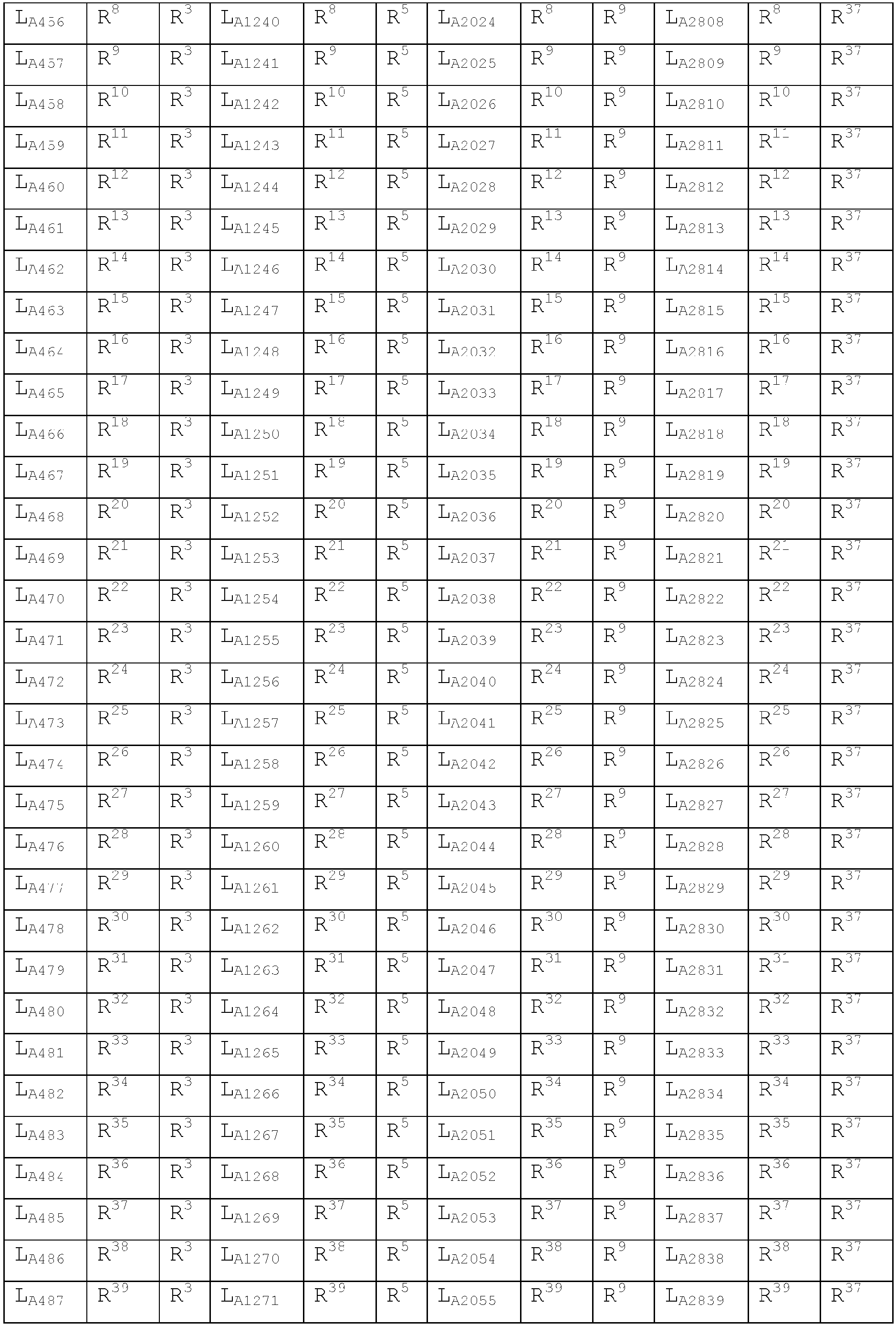 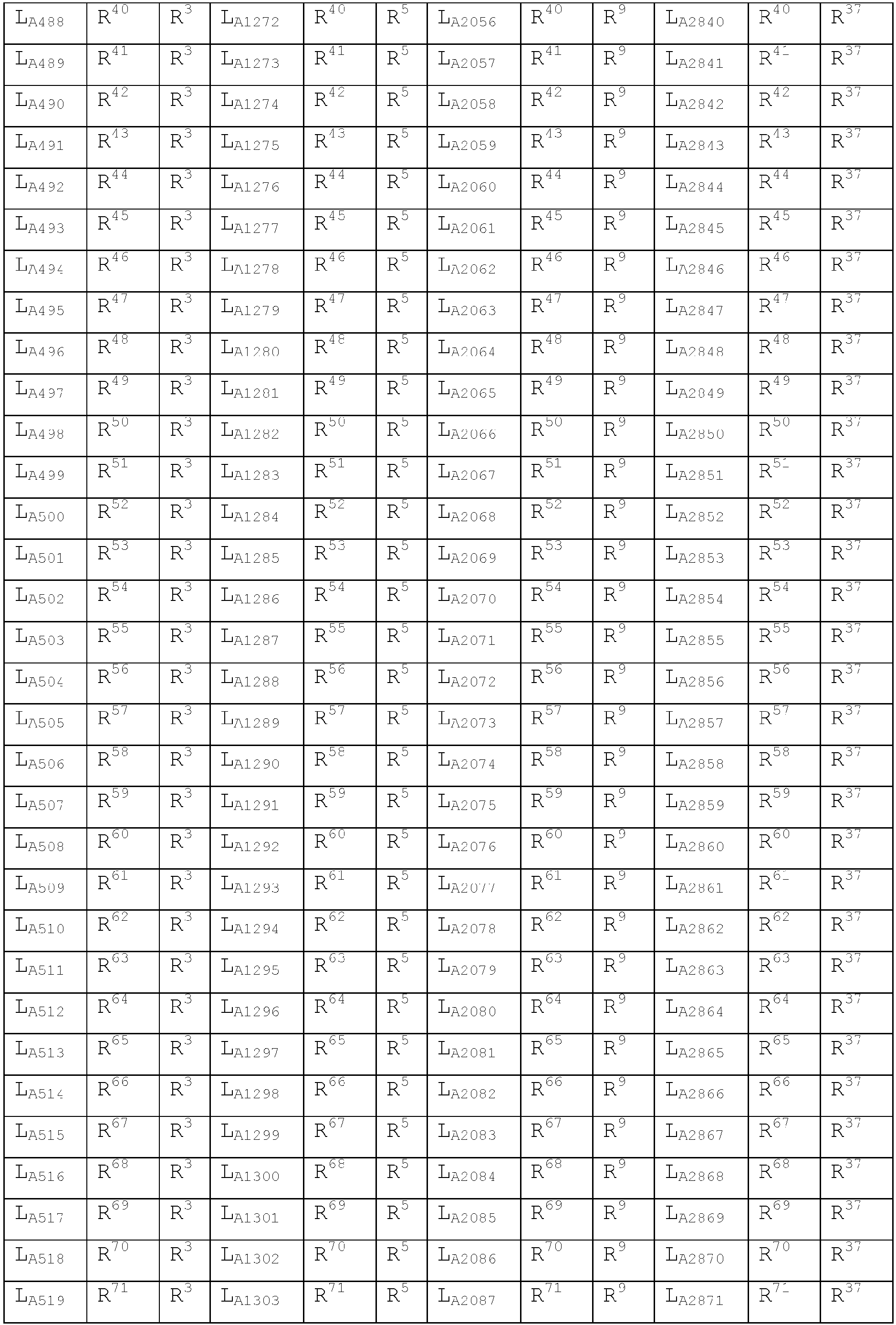 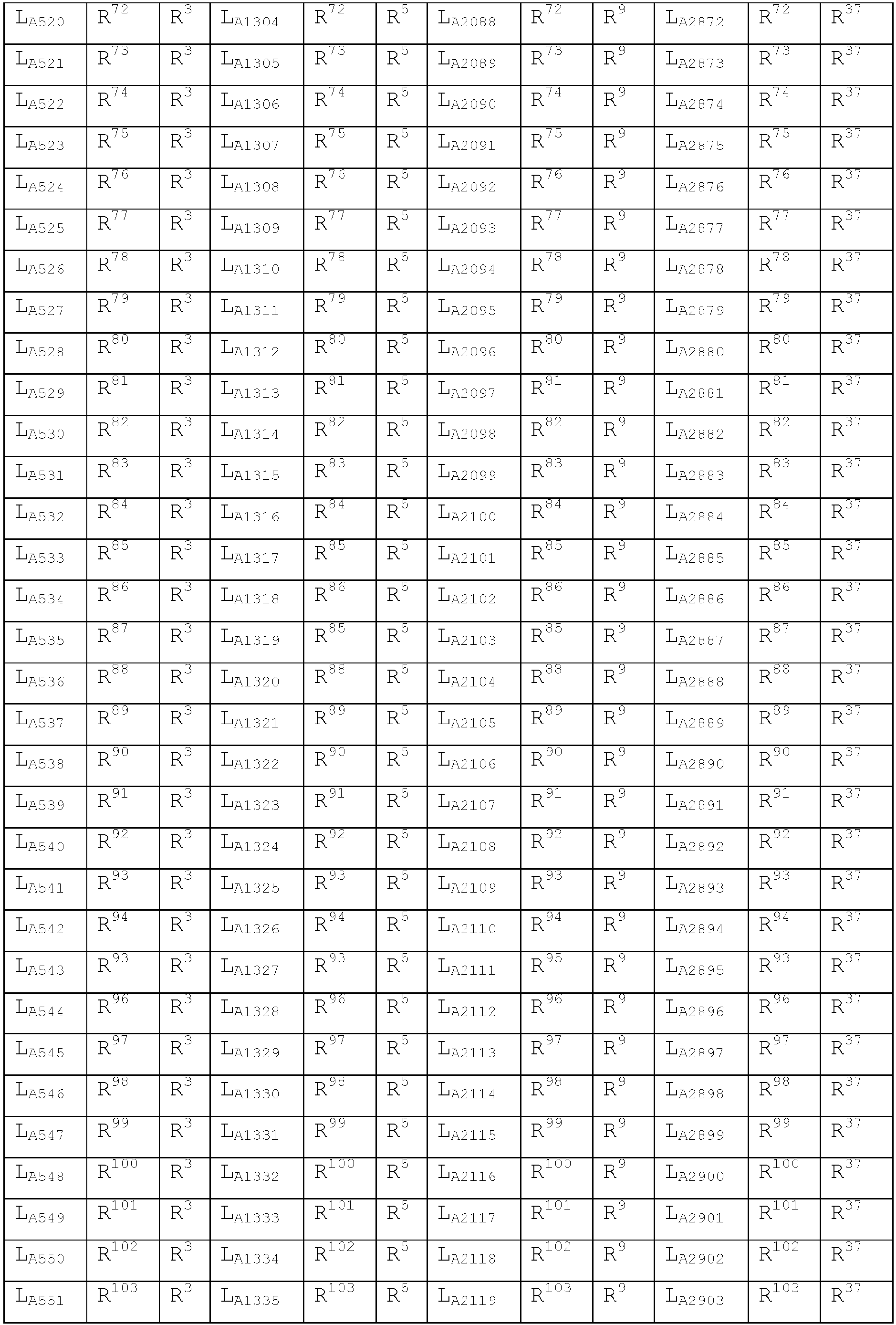 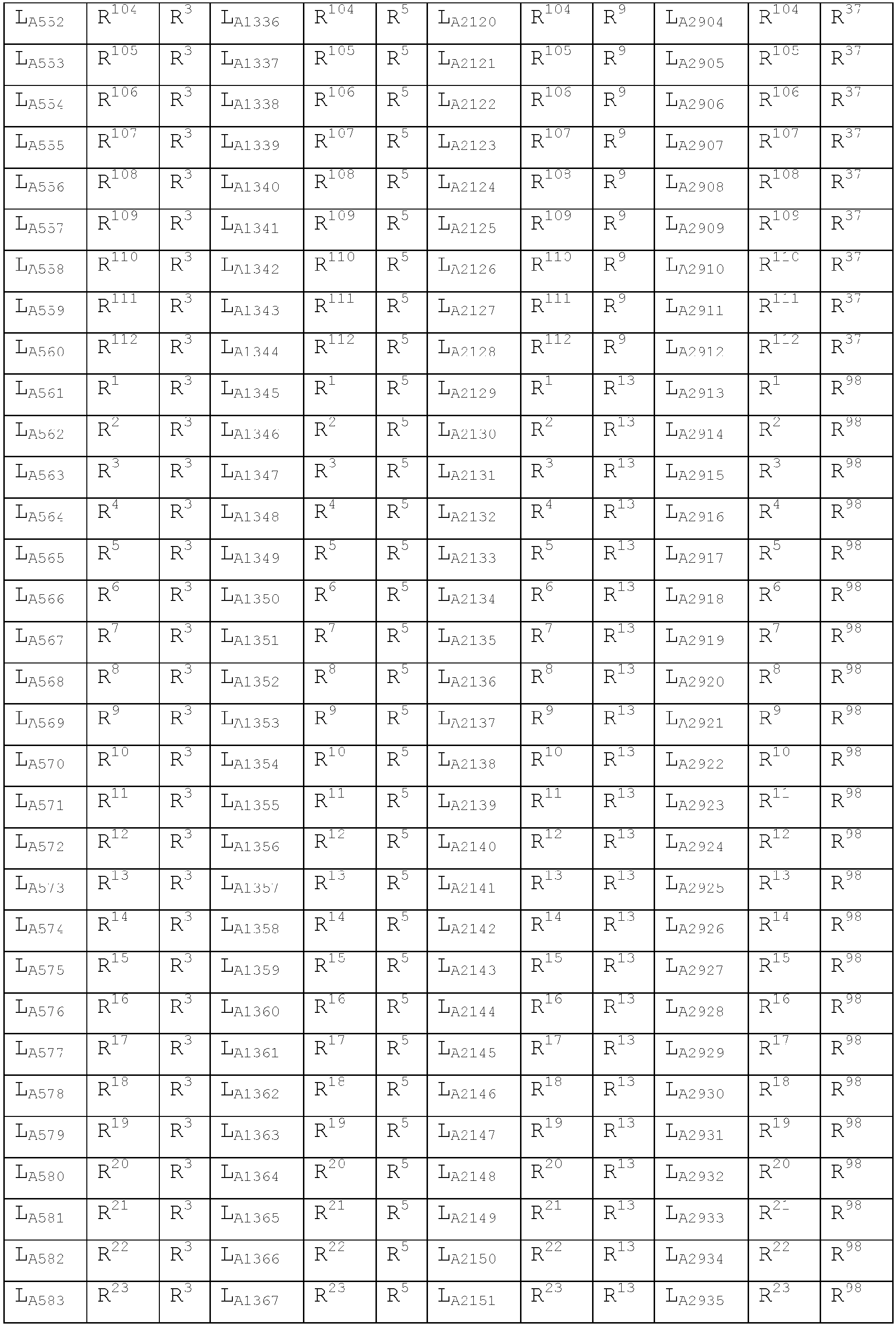 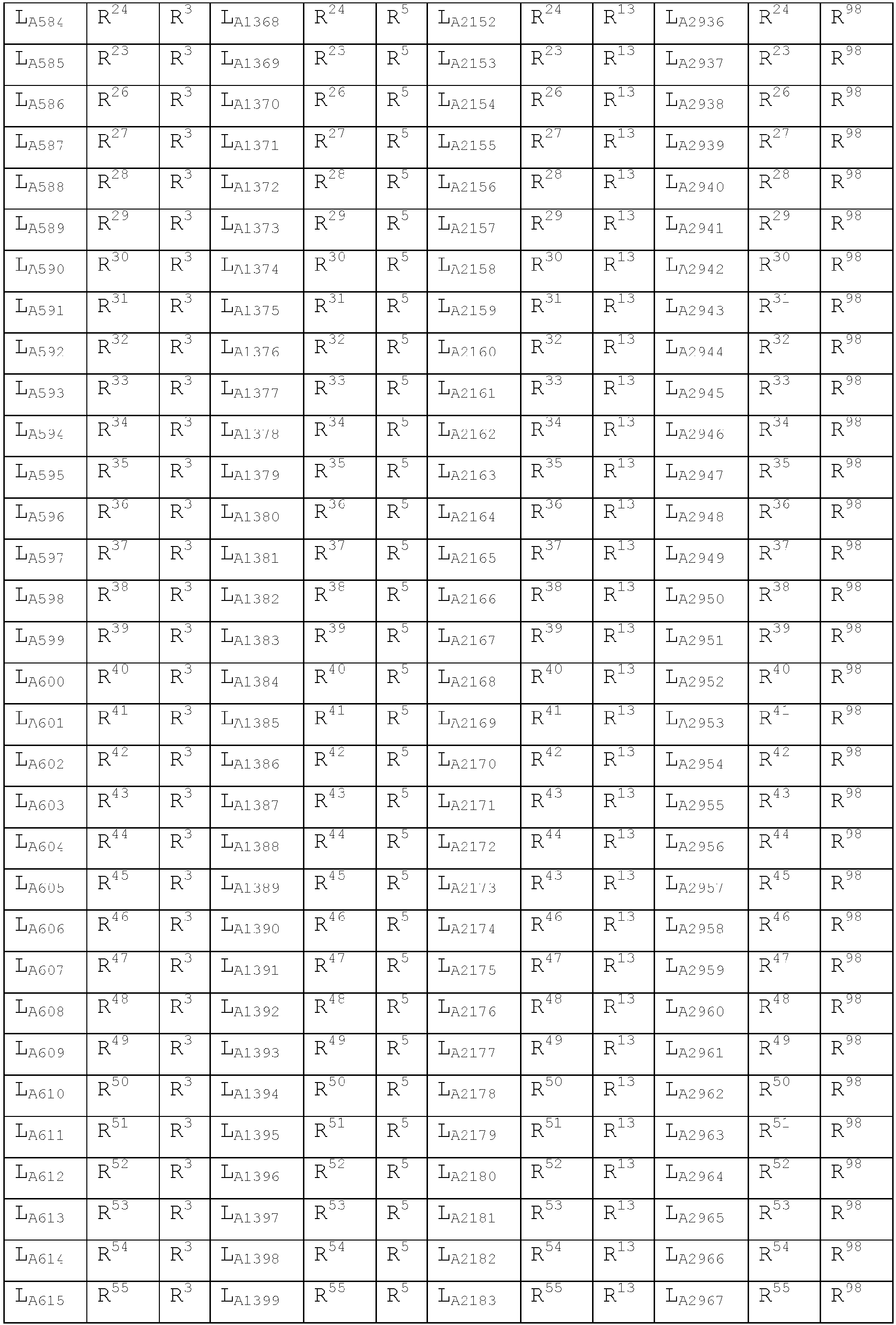 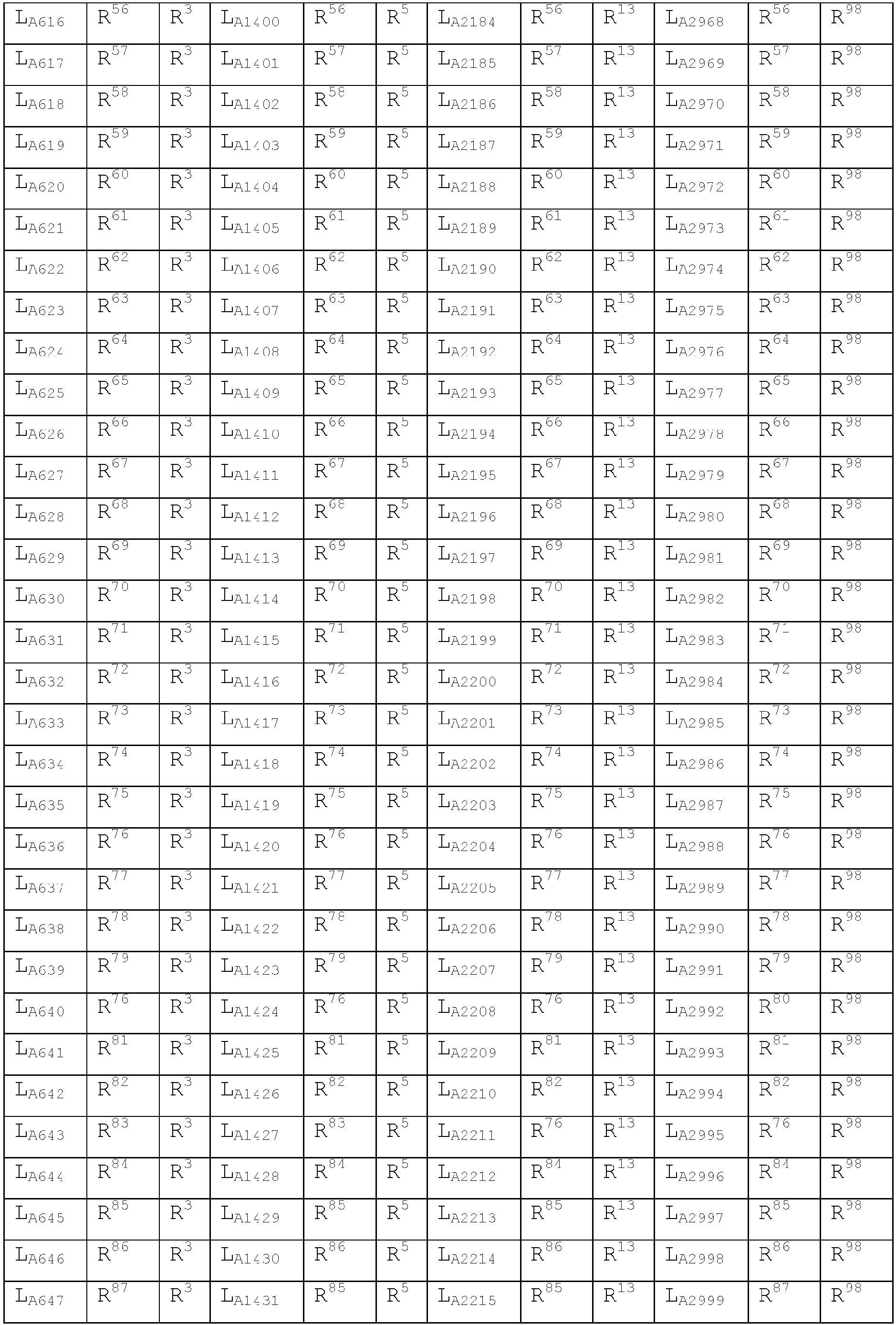 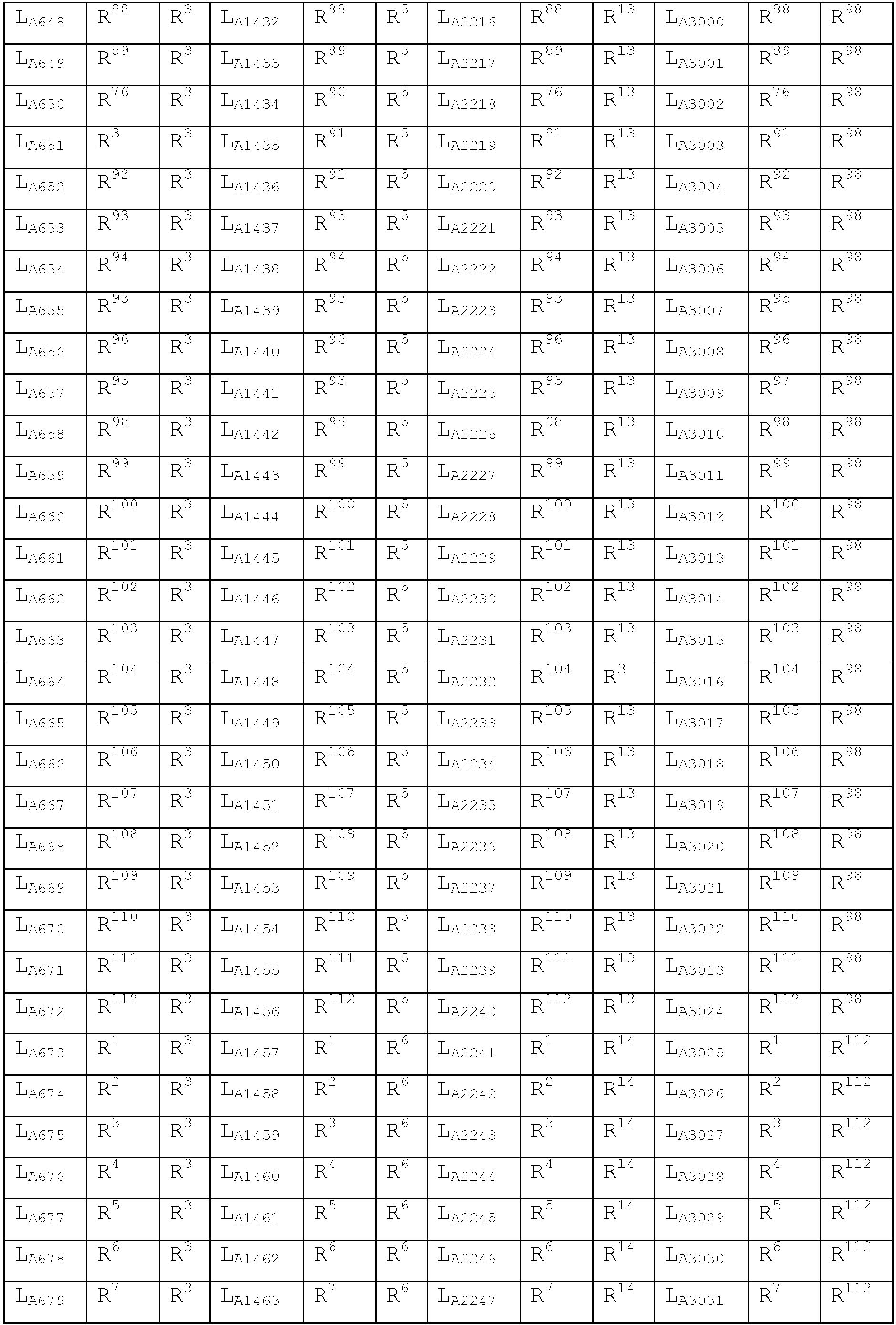 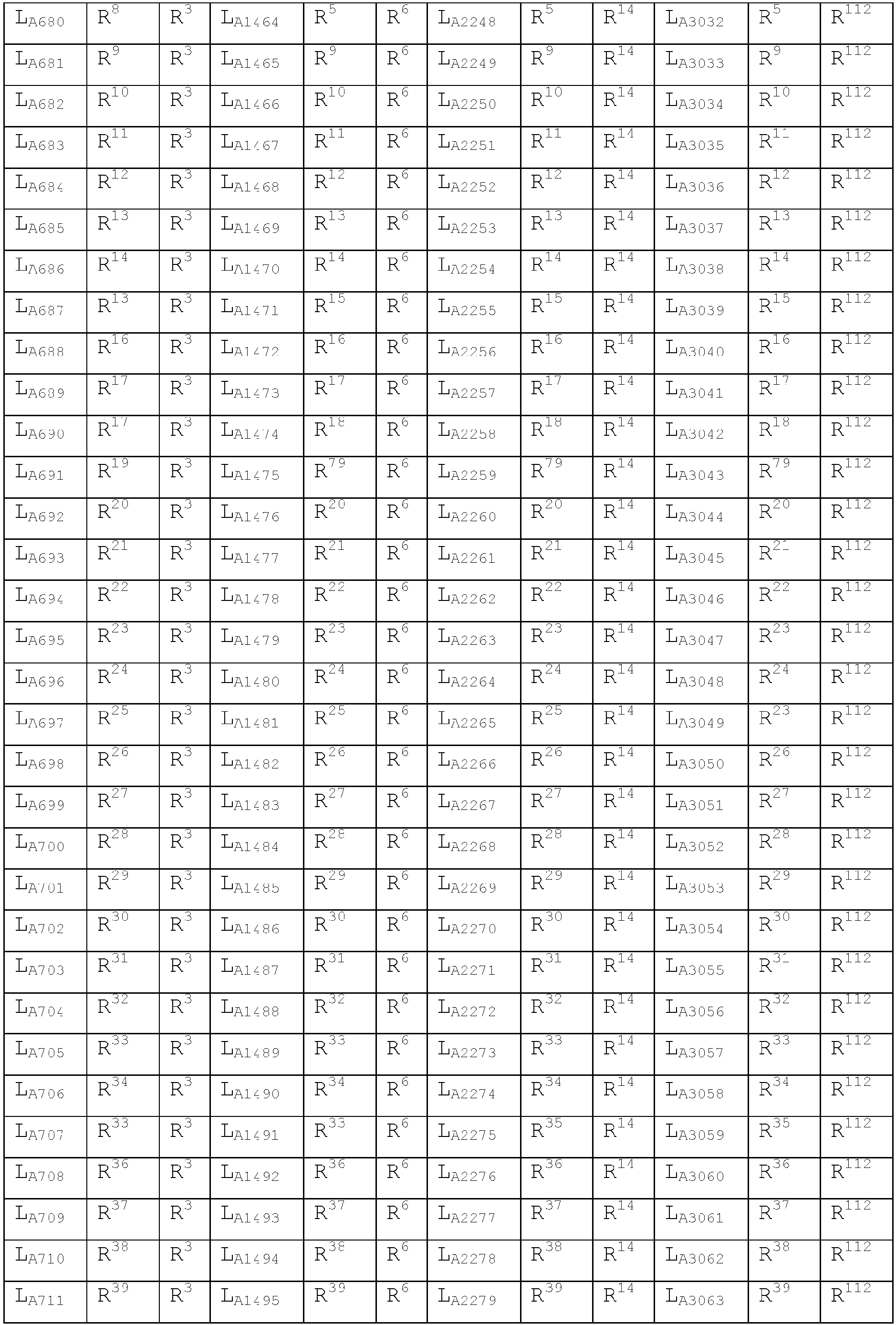 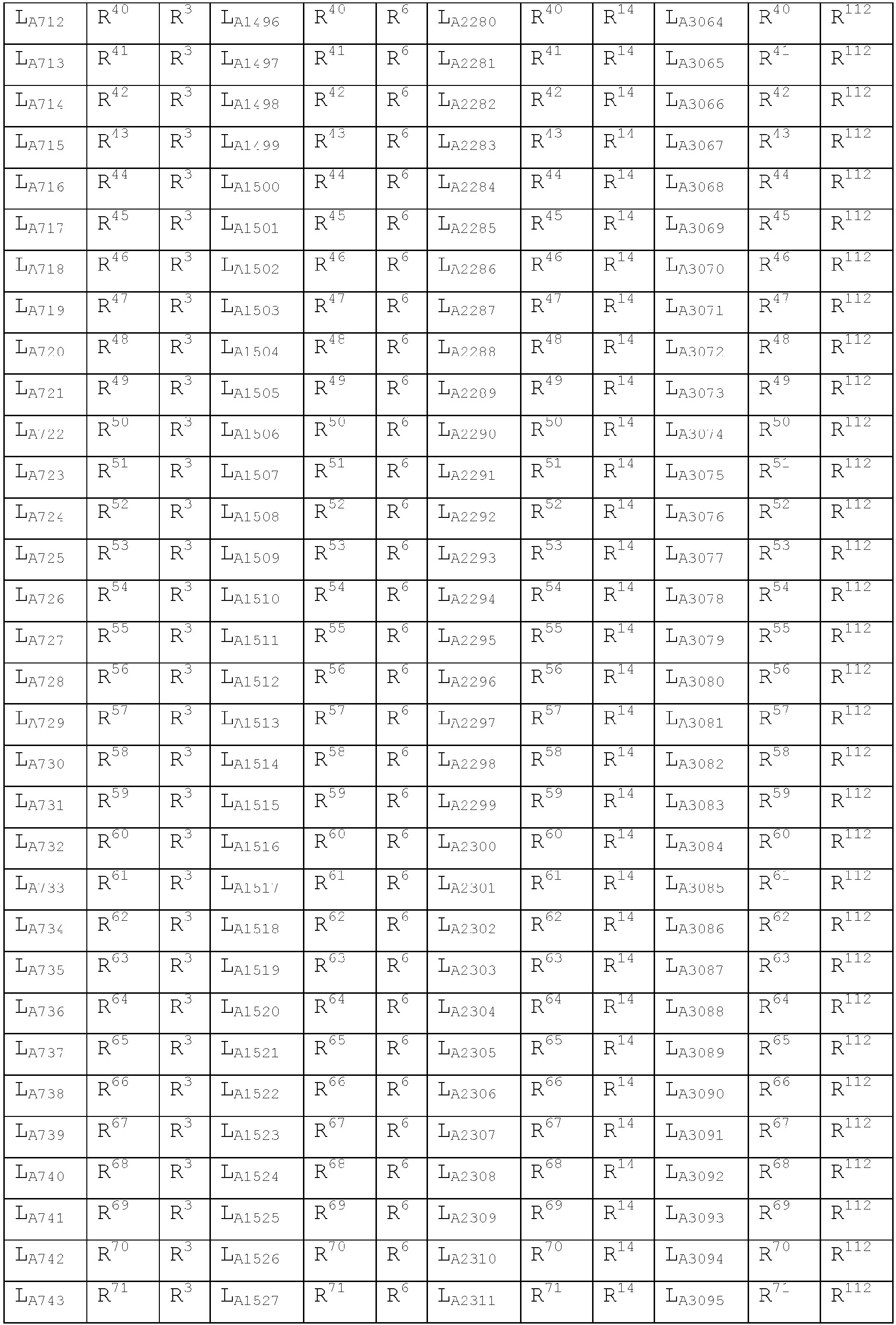 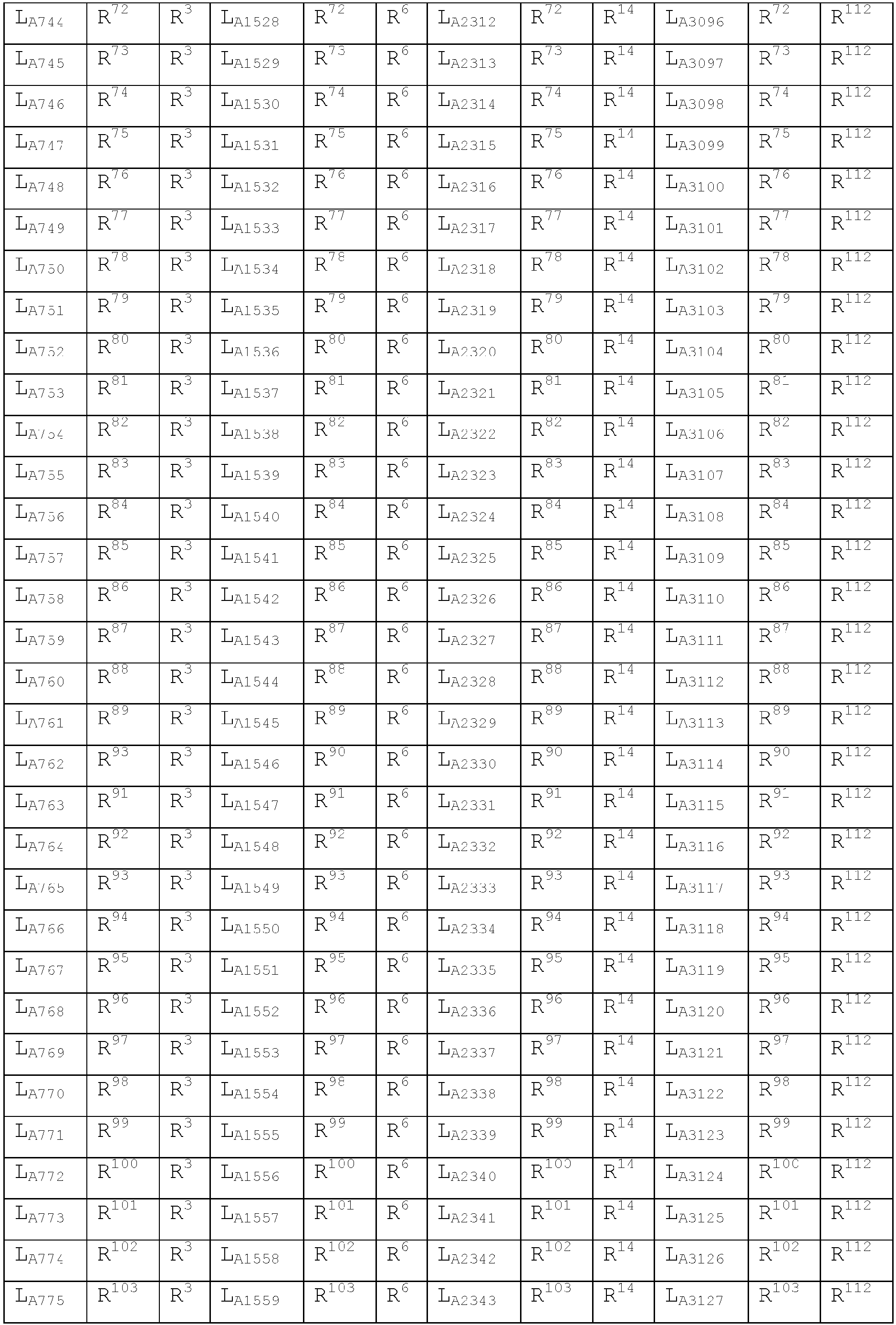 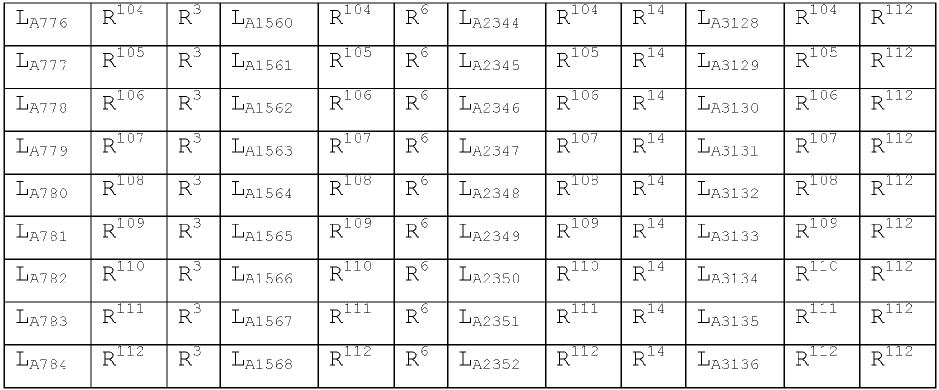 wobei R¹ bis R¹¹² die folgenden Strukturen aufweisen:

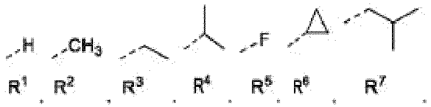

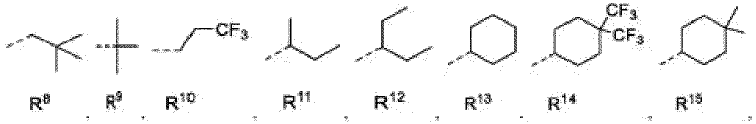

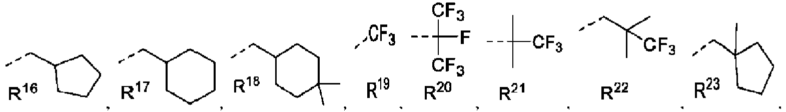

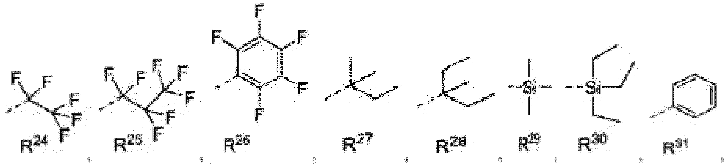

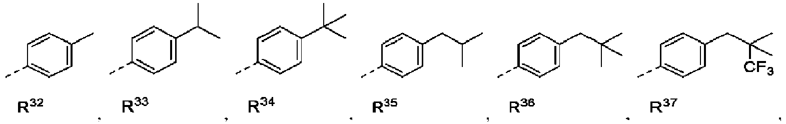

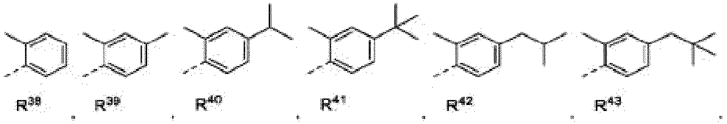

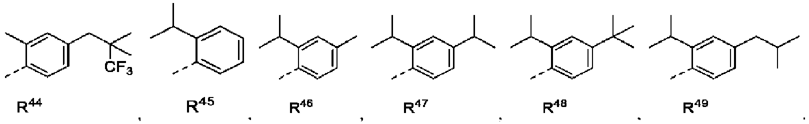

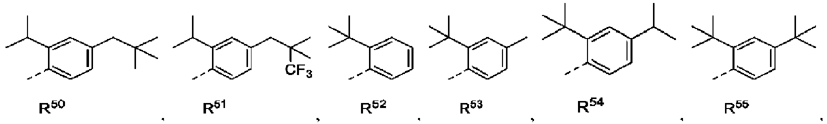

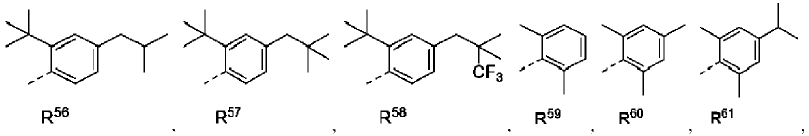

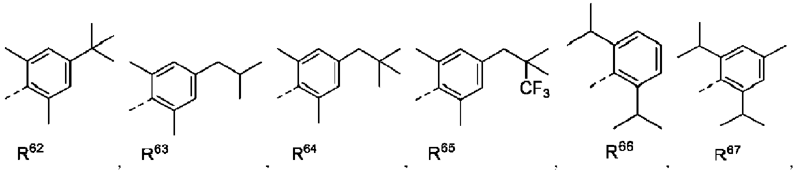

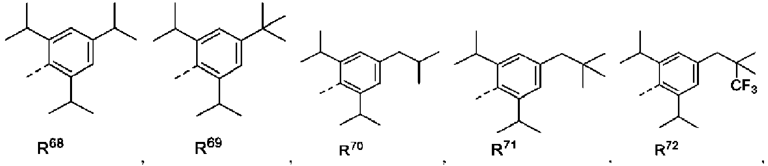

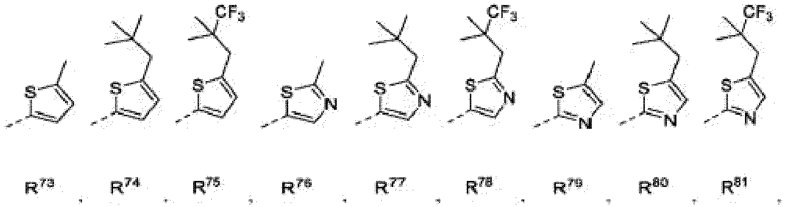

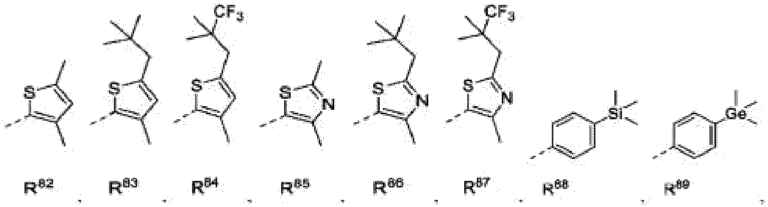

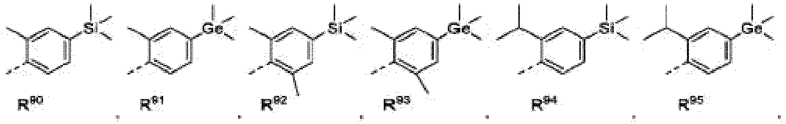

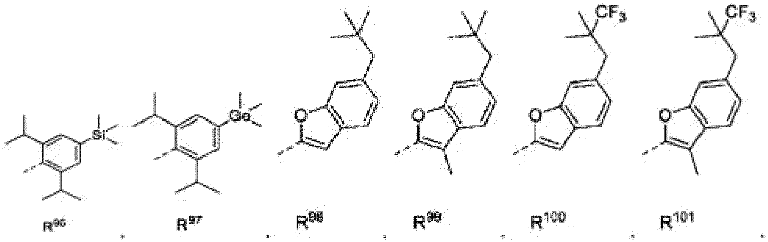

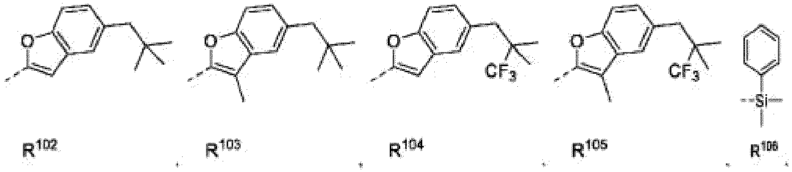

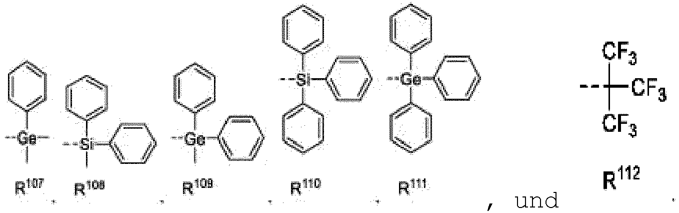

8. Verbindung nach Anspruch 1, wobei die Verbindung die Formel M(L_{A})ₚ(L_{B})_{q}(L_{C})ᵣ hat, wobei L_{B} und L_{C} jeweils ein zweizähniger Ligand sind; und wobei p 1, 2 oder 3 ist; q 0, 1 oder 2 ist; r 0, 1 oder 2 ist; und p+q+r die Oxidationsstufe des Metalls M ist.

9. Verbindung nach Anspruch 8, wobei die Verbindung eine Formel hat, die ausgewählt ist aus der Gruppe bestehend aus Ir(L_{A})₃, Ir(L_{A})(L_{B})₂, Ir(L_{A})₂(L_{B}), Ir(L _{A}) ₂(L_{C}) und Ir(L_{A})(L_{B})(L_{C}), und wobei L_{A}, L _{B} und L_{C} voneinander verschieden sind; oder eine Formel von Pt(L_{A})(L_{B}); und wobei L_{A} und L_{B} gleich oder verschieden sein können.

10. Verbindung nach Anspruch 8, wobei L_{B} und L_{C} jeweils unabhängig voneinander ausgewählt sind aus der Gruppe bestehend aus: 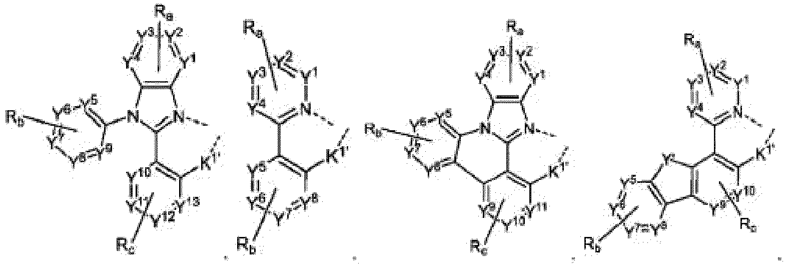 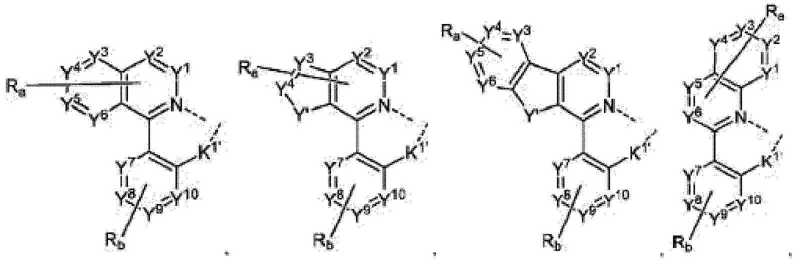 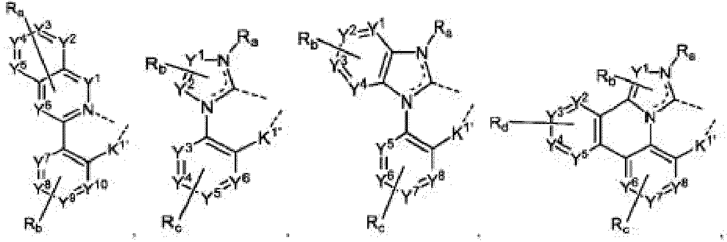 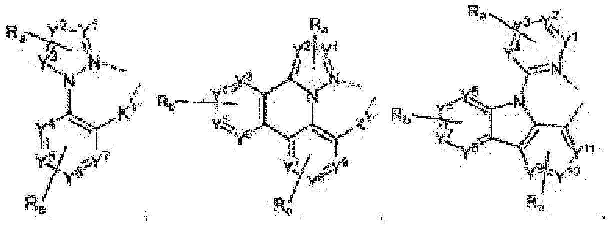 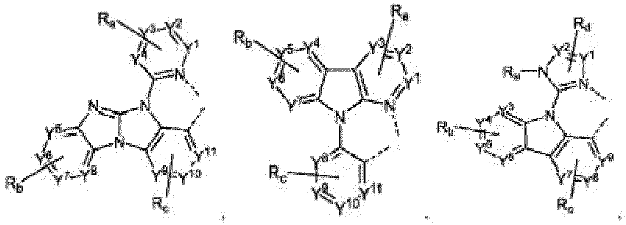 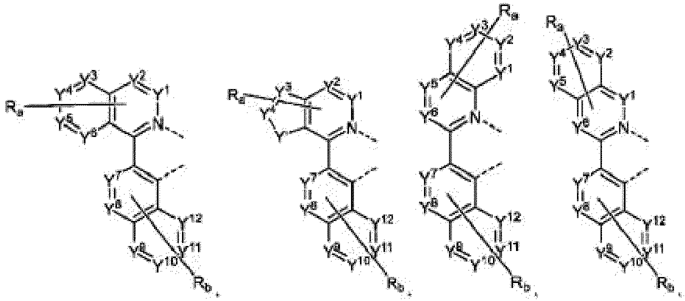 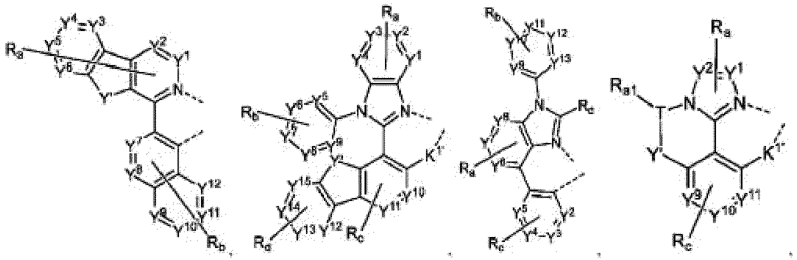 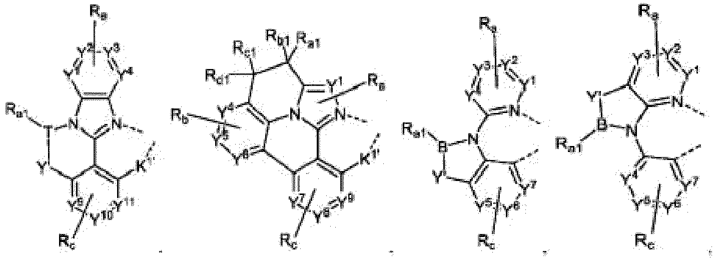 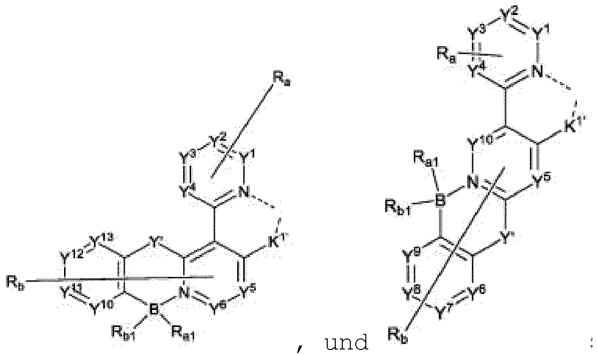 wobei:
T ausgewählt ist aus der Gruppe bestehend aus B, Al, Ga und In;
K^{1'} ausgewählt ist aus der Gruppe bestehend aus einer Einfachbindung, O, S, NRₑ, PRₑ, BRₑ, CRₑR_{f}, und SiRₑR_{f};
jedes von Y¹ bis Y¹³ unabhängig ausgewählt ist aus der Gruppe bestehend aus C und N;
Y' ausgewählt ist aus der Gruppe bestehend aus BRₑ, BRₑR_{f}, NRₑ, PRₑ, P(O)R₂, O, S, Se, C=O, C=S, C=Se, C=NRₑ, C=CRₑR_{f}, S=O, SO₂, CRₑR_{f}, SiRₑR_{f}, und GeRₑR_{f};
Rₑ und R_{f} verbunden oder verschmolzen sein können, um einen Ring zu bilden;
jedes Rₐ, R_{b}, R_{c} und R_{d} unabhängig von Mono bis zu der maximal zulässigen Anzahl von Substitutionen oder keine Substitution darstellt;
jedes von Rₐ₁, R_{b1}, R_{c1}, R_{d1}, Rₐ, R_{b}, R_{c}, R_{d}, Rₑ, und R_{f} unabhängig ein Wasserstoff oder ein Substituent ist, ausgewählt aus der Gruppe bestehend aus Deuterium, Halogenid, Alkyl, Cycloalkyl, Heteroalkyl, Arylalkyl, Alkoxy, Aryloxy, Amino, Silyl, Germyl, Boryl, Alkenyl, Cycloalkenyl, Heteroalkenyl, Alkynyl, Aryl, Heteroaryl, Acyl, Carbonyl, Carbonsäure, Ester, Nitril, Isonitril, Sulfanyl, Selenyl, Sulfinyl, Sulfonyl, Phosphino und Kombinationen davon; und
beliebige zwei Substituenten von Rₐ₁, R_{b1}, R_{c1}, R_{d1}, Rₐ, R_{b}, R_{c}, und R_{d} verschmolzen oder verbunden sein können, um einen Ring oder einen mehrzähnigen Liganden zu bilden.

11. Verbindung nach Anspruch 9, wobei L_{A} ausgewählt sein kann aus L_{A*i*-*m*}, wobei *i* eine ganze Zahl von 1 bis 3136 ist; m eine ganze Zahl von 1 bis 154 ist; und L_{B} ausgewählt sein kann aus L_{B*k*}, wobei k eine ganze Zahl von 1 bis 474 ist, wobei:
wenn die Verbindung die Formel Ir(L_{A*i*-*m*})₃ hat, die Verbindung ausgewählt ist aus der Gruppe bestehend aus Ir(L_{A*1*-*1*})₃ bis Ir(L_{A3136-154})₃;
wenn die Verbindung die Formel Ir(L_{A*i*-*m*})(L_{B*k*})₂ hat, die Verbindung ausgewählt ist aus der Gruppe bestehend aus Ir(L_{A*1*-*1*})(L_{B*1*})₂ bis Ir(L_{A3136-*154*})(L_{B474})₂;
wenn die Verbindung die Formel Ir(L_{A*i*-m})₂(L_{B*k*}) hat, die Verbindung ausgewählt ist aus der Gruppe bestehend aus Ir(L_{*A1*-*1*})₂(L_{B*1*}) bis Ir(L_{A3136-*154*})₂(L_{B474});
wenn die Verbindung die Formel Ir(L_{A*i*-*m*})₂(L_{C*j*-I}) hat, die Verbindung ausgewählt ist aus der Gruppe bestehend aus Ir(L_{A*1*-*1*})₂(L_{C*1*-*1*}) bis Ir(L_{A3136-*154*})₂(L_{C*1416*-I}); und
wenn die Verbindung die Formel Ir(L_{A*i*-*m*})₂(L_{C*j*-II}) hat, die Verbindung ausgewählt ist aus der Gruppe bestehend aus Ir(*L*_{A*1-1*})₂(L_{C*1*-II}) bis Ir(L_{A3136-*154*})₂(L_{C*1416*-II});
wobei jedes L_{B*k*} die wie folgt definierte Struktur aufweist: 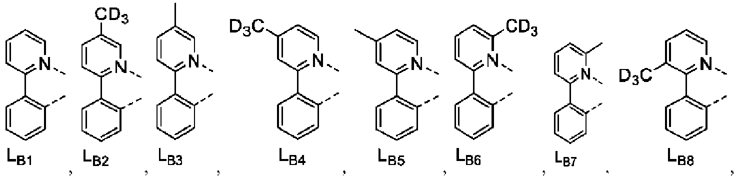 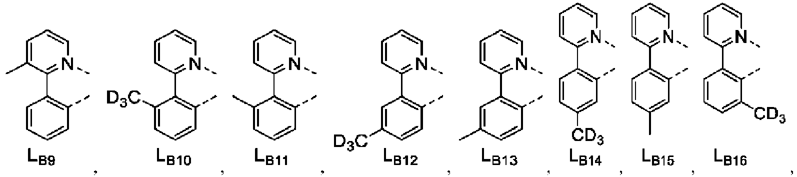 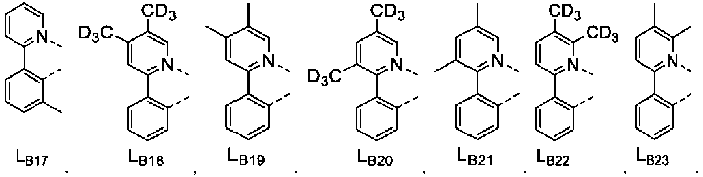 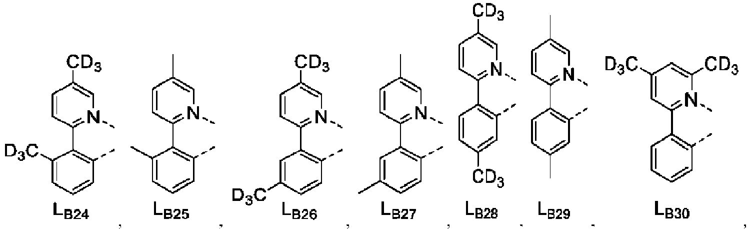 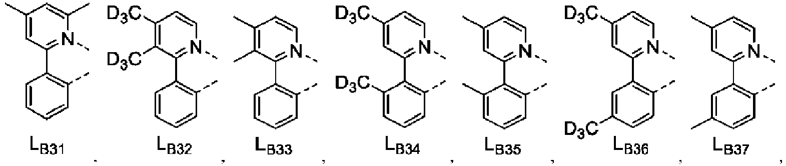 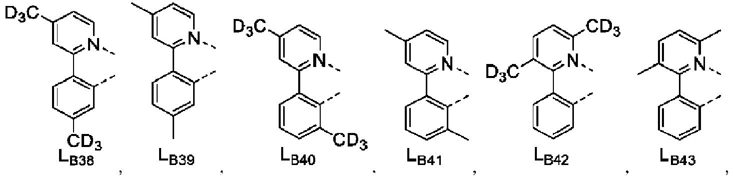 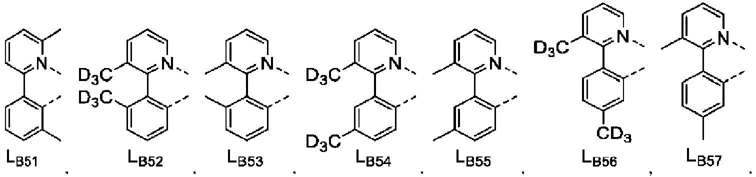 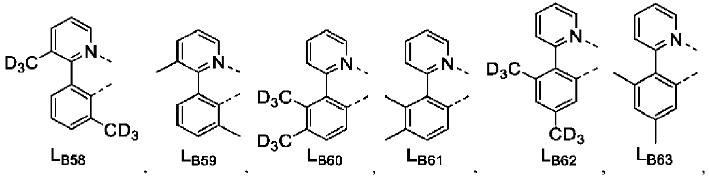 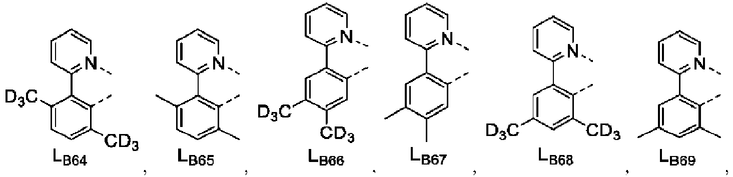 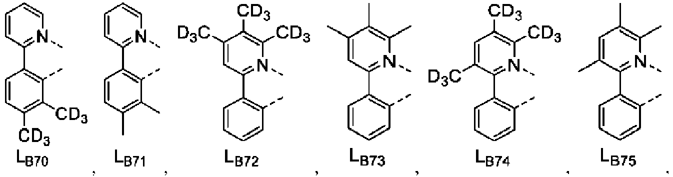 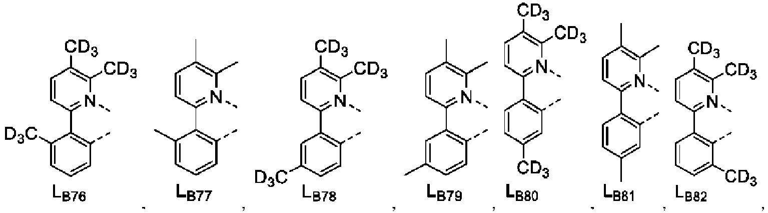 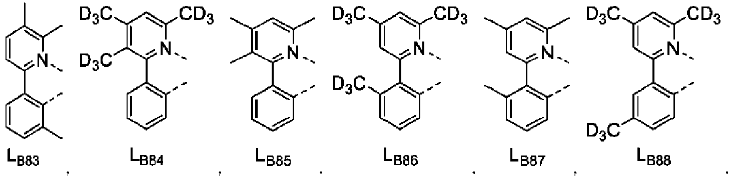 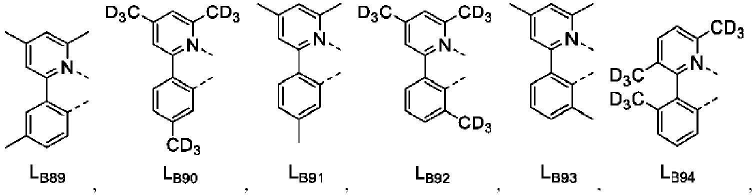 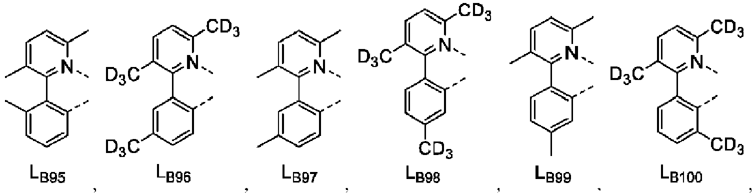 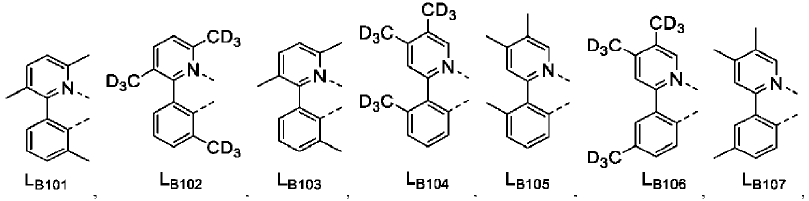 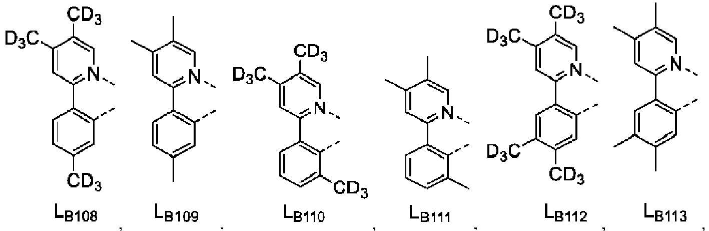 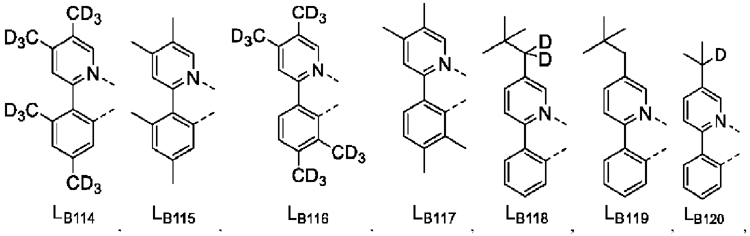 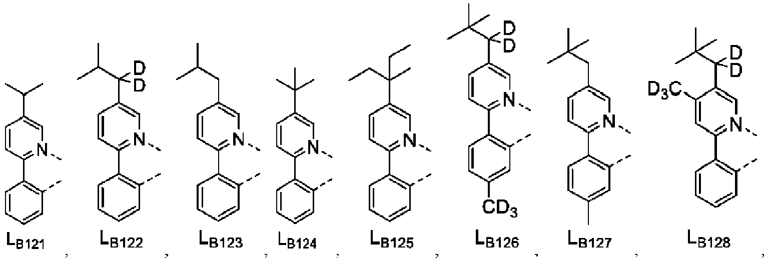 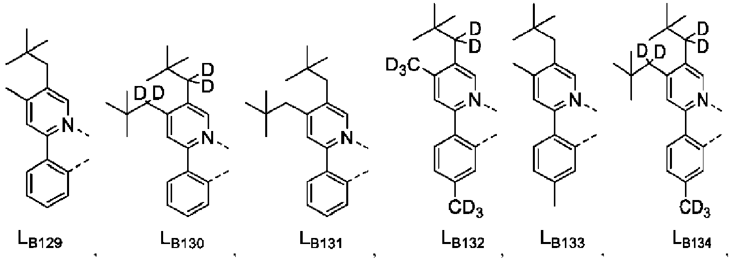 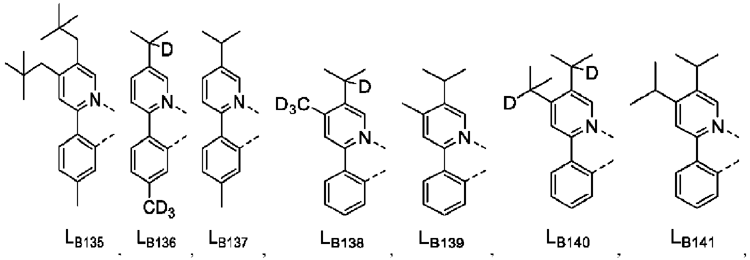 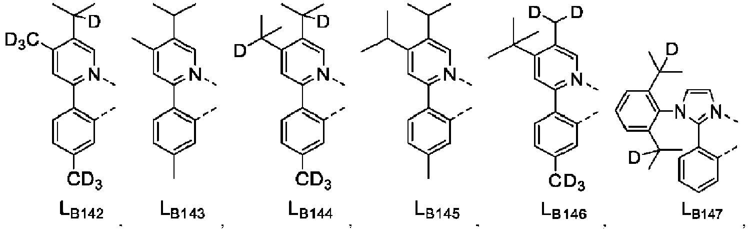 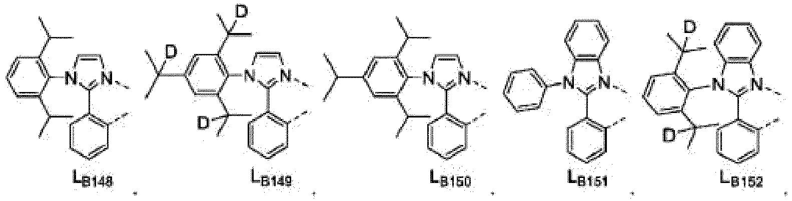 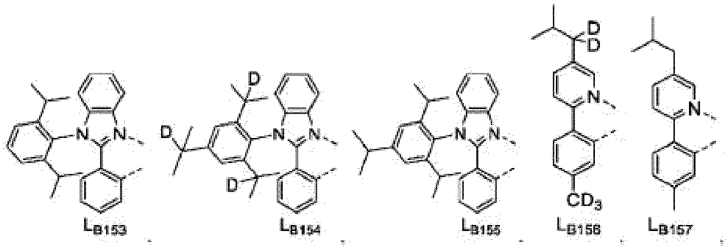 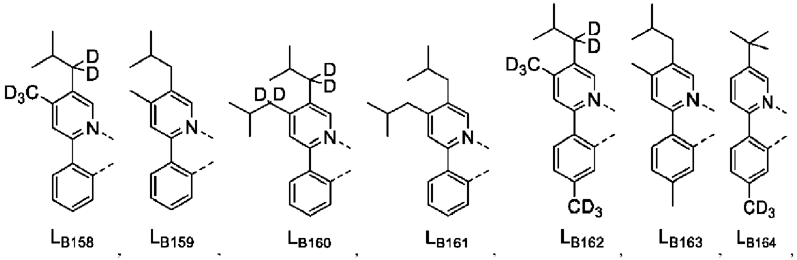 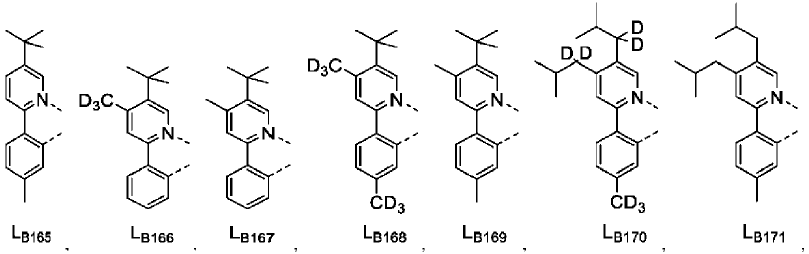 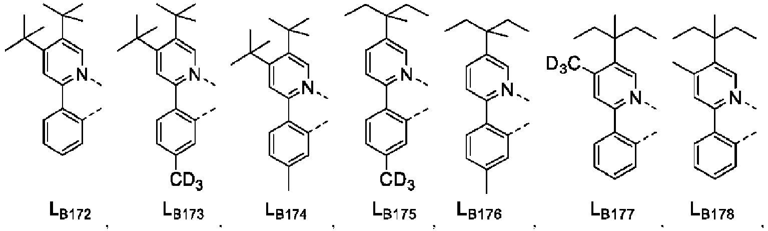 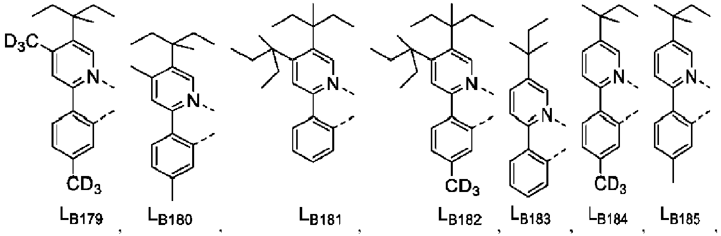 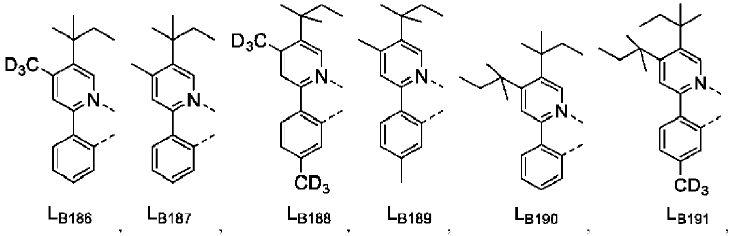 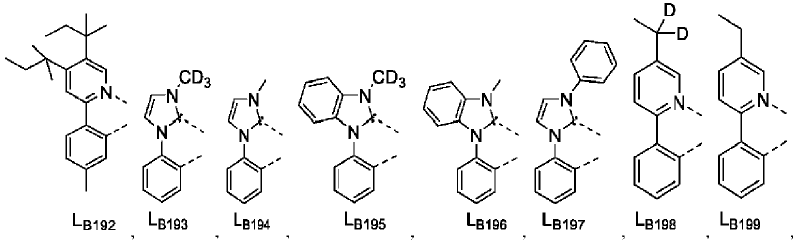 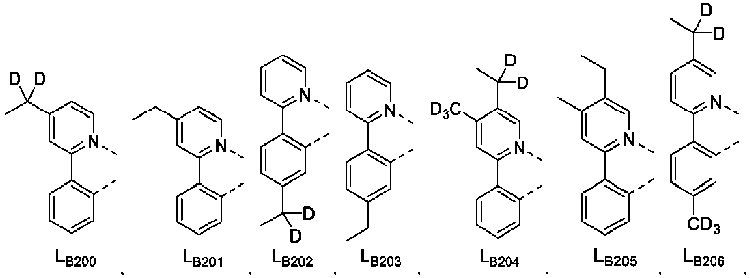 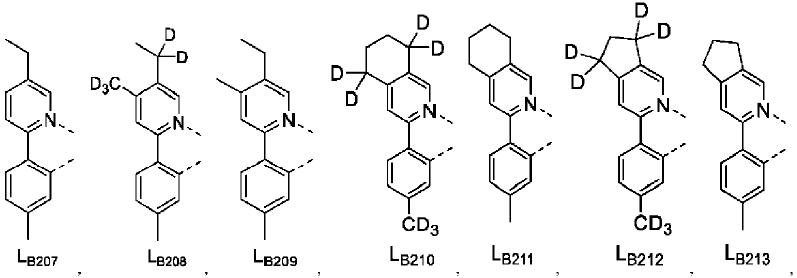 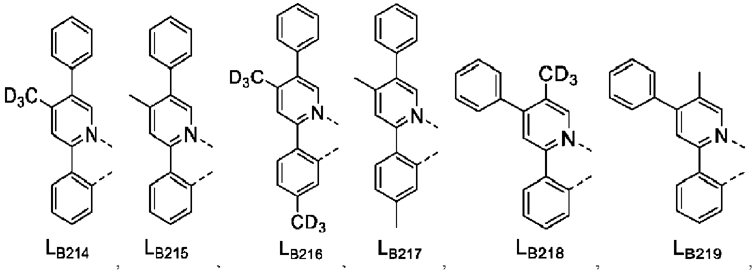 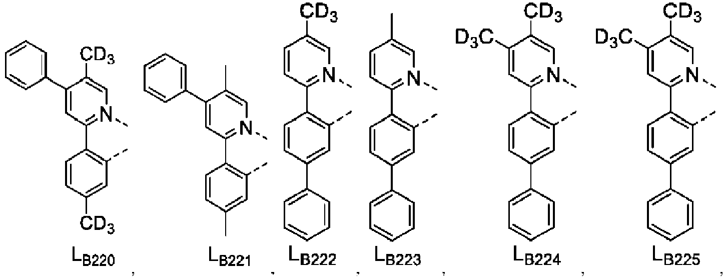 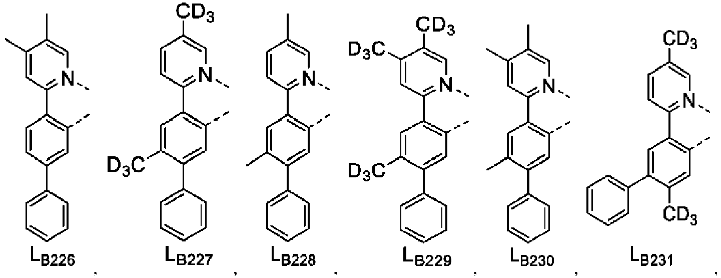 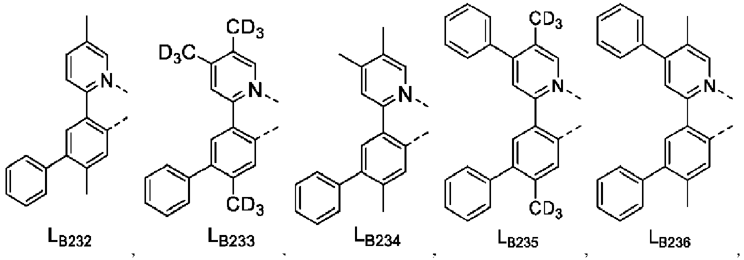 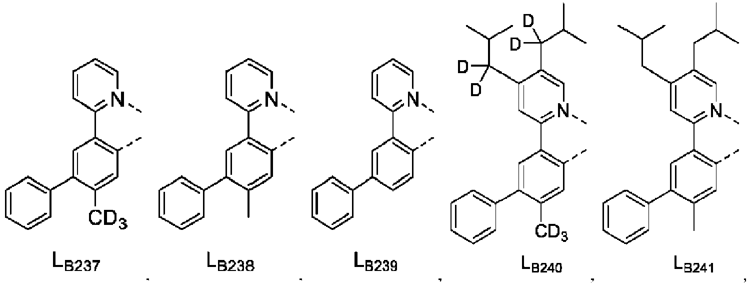 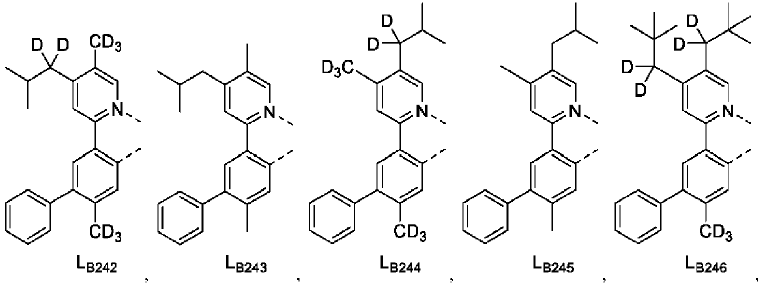 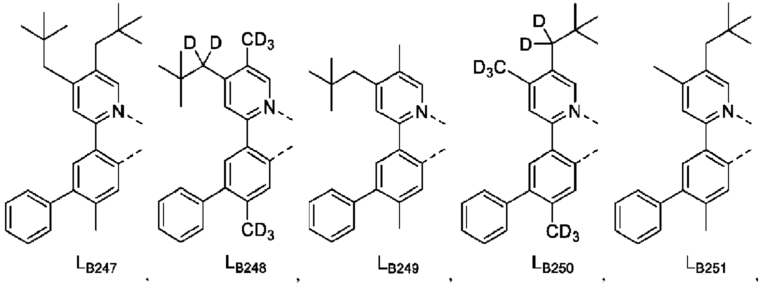 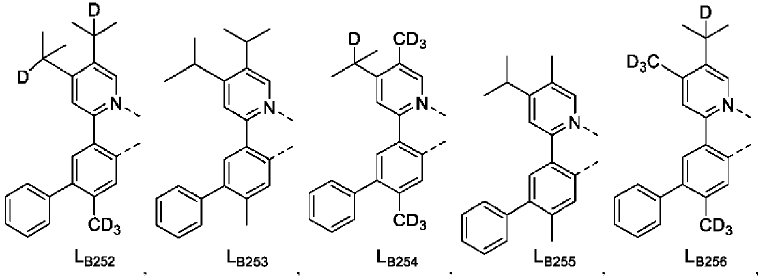 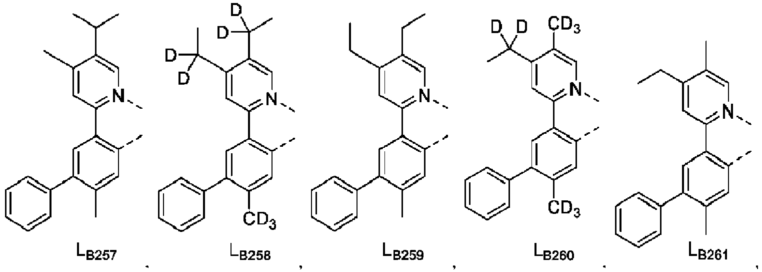 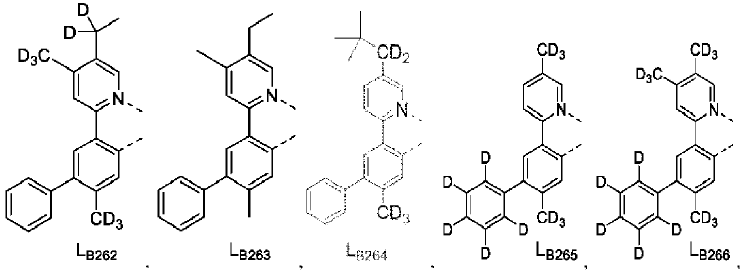 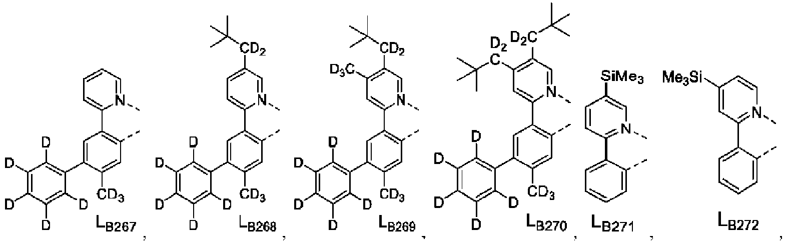 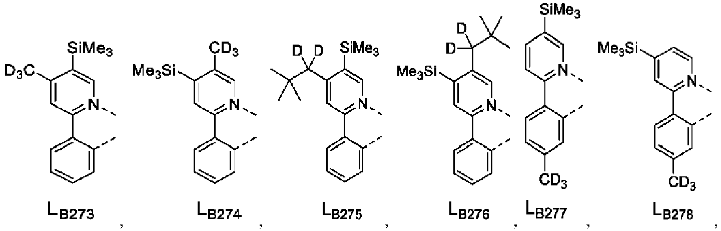 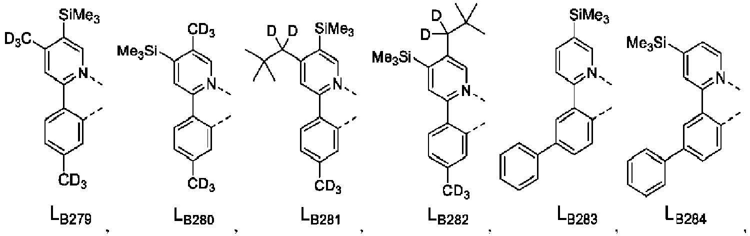 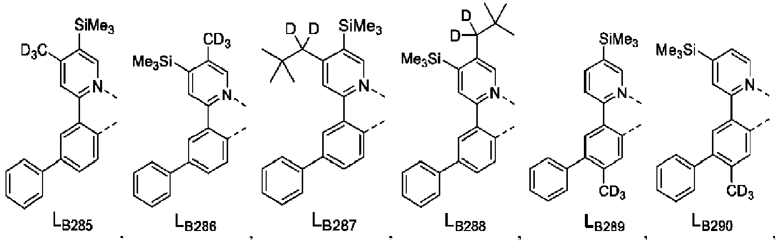 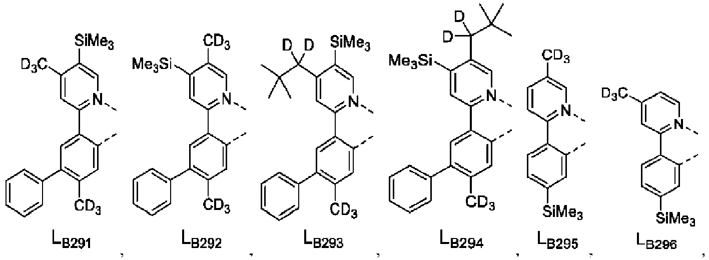 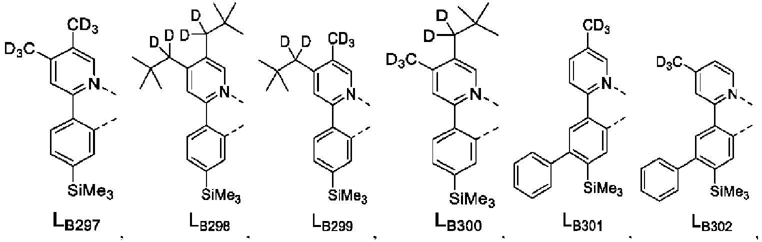 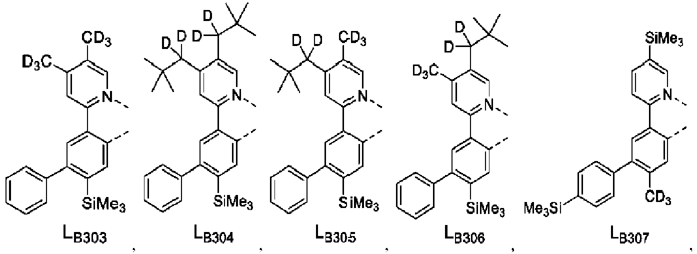 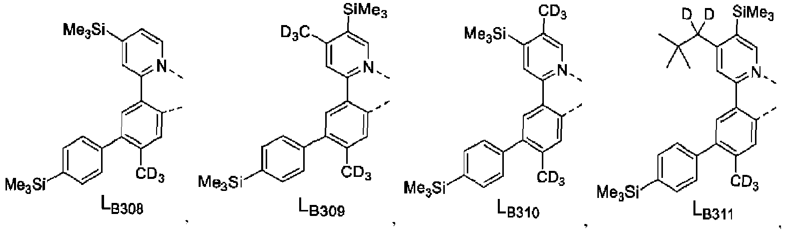 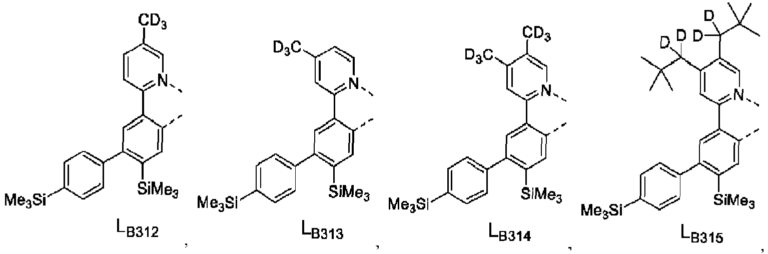 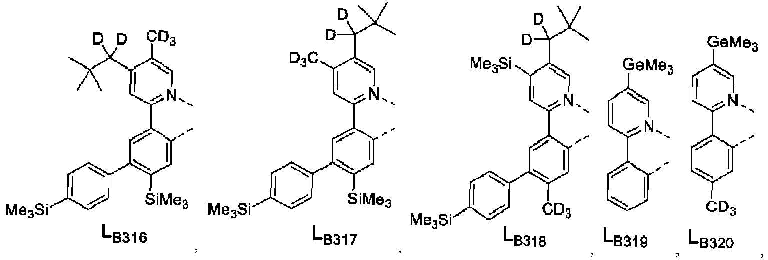 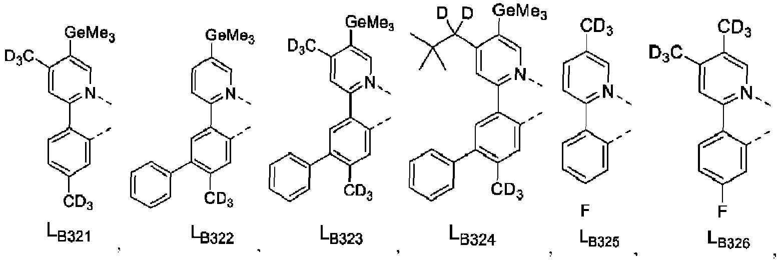 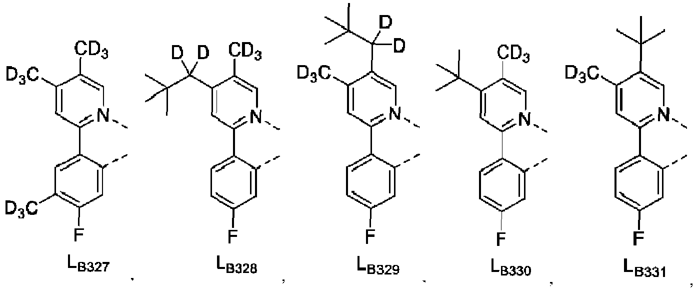 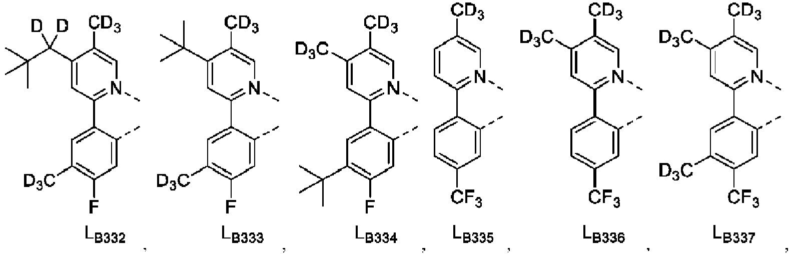 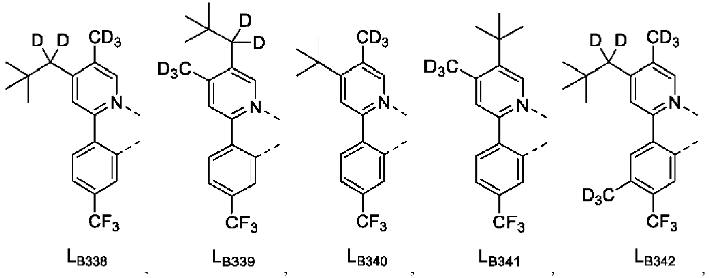 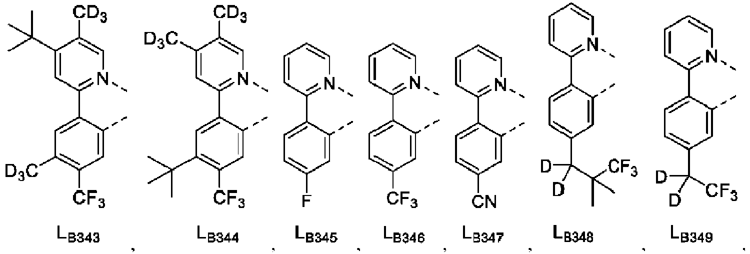 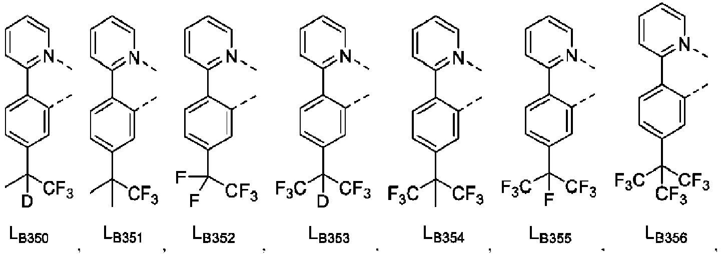 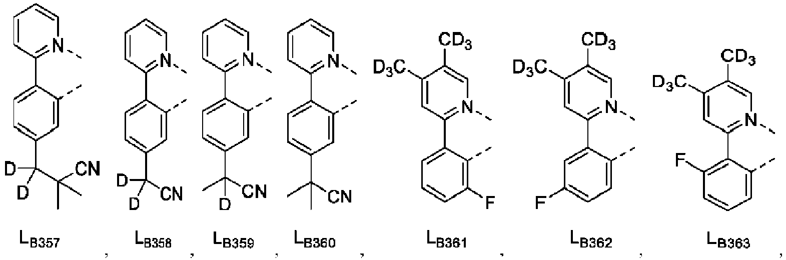 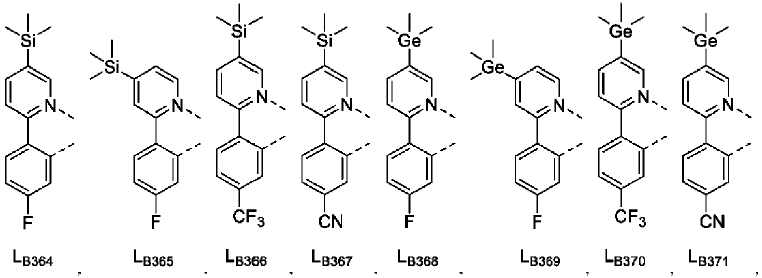 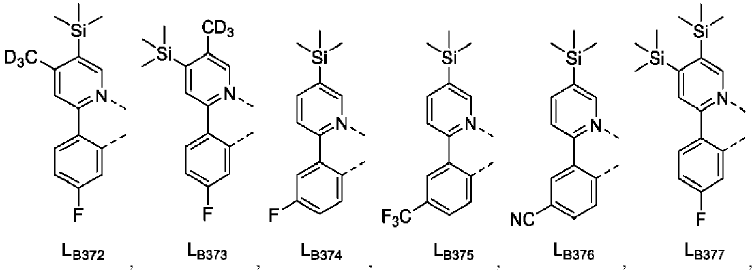 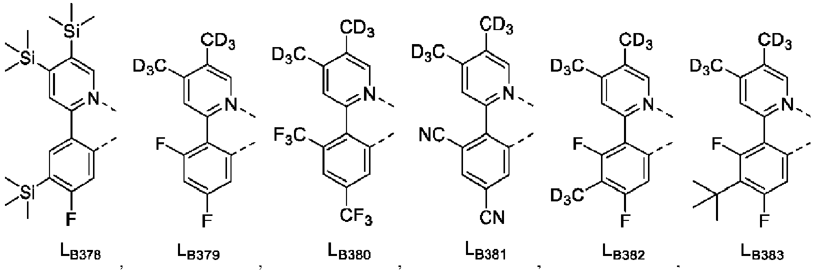 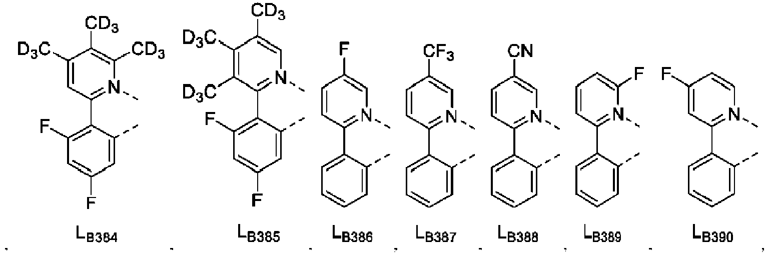 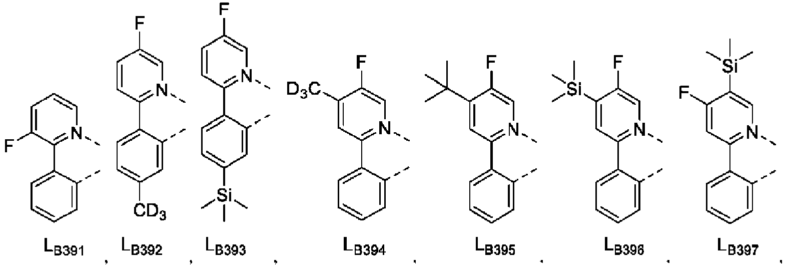 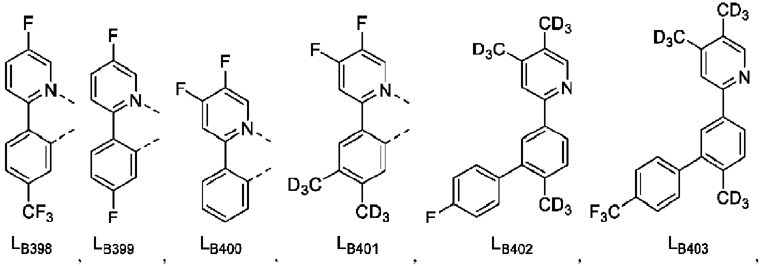 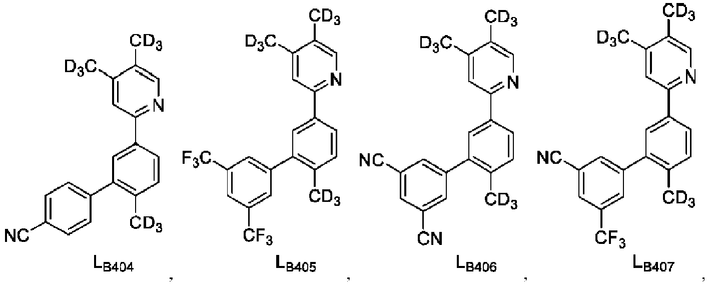 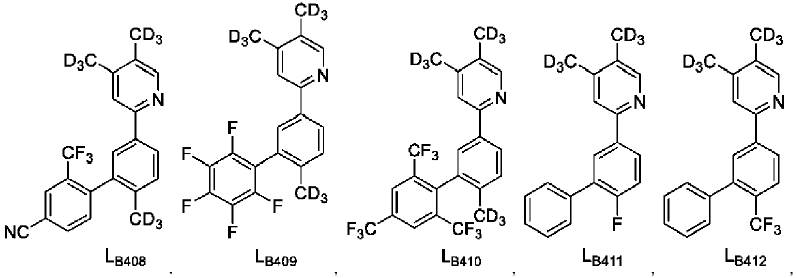 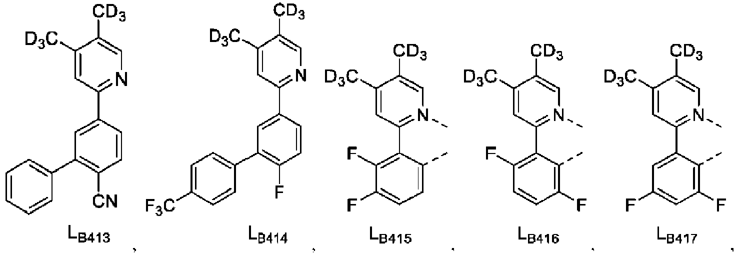 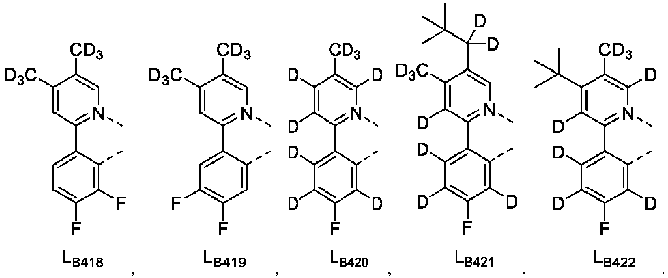 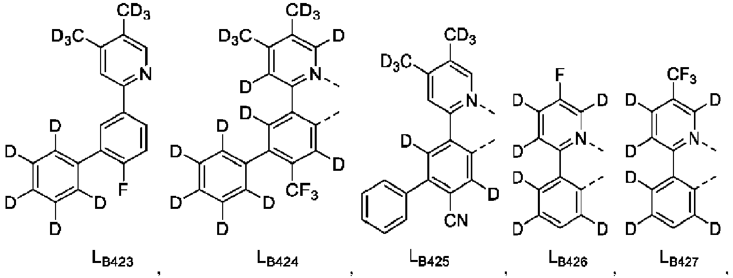 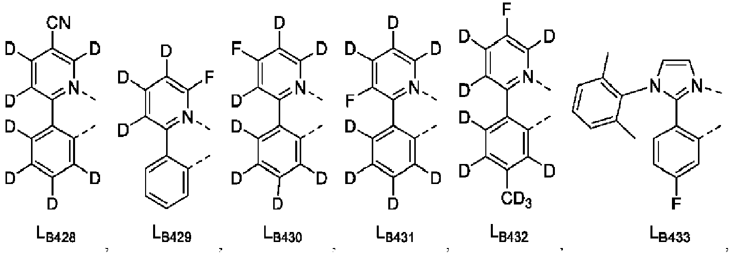 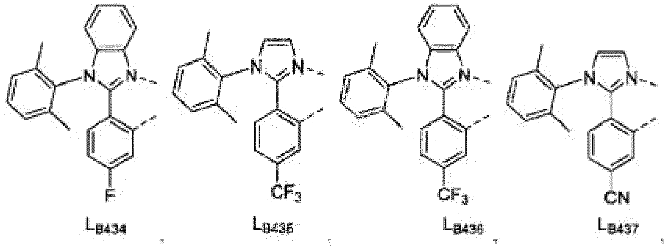 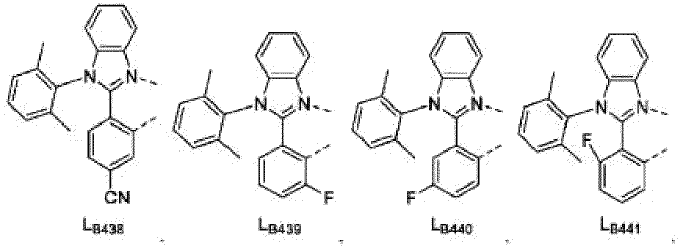 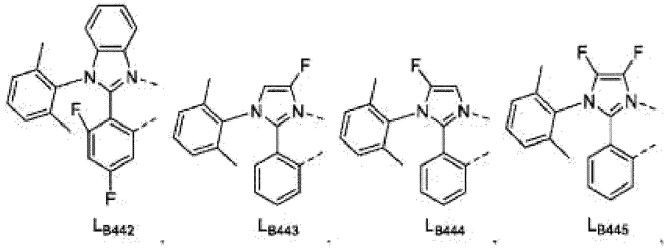 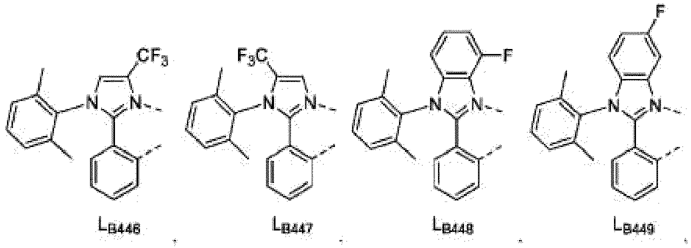 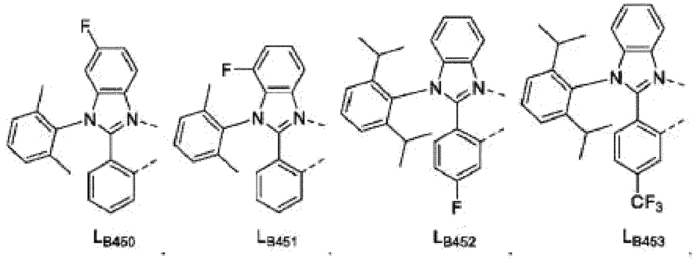 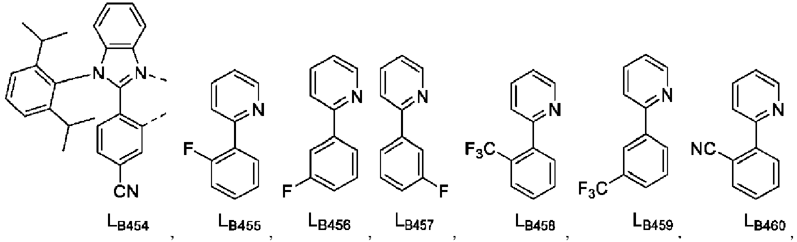 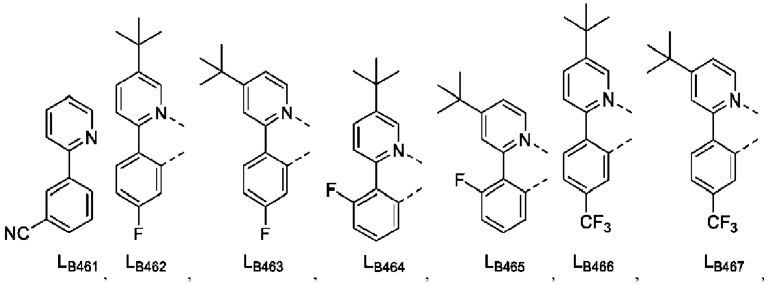 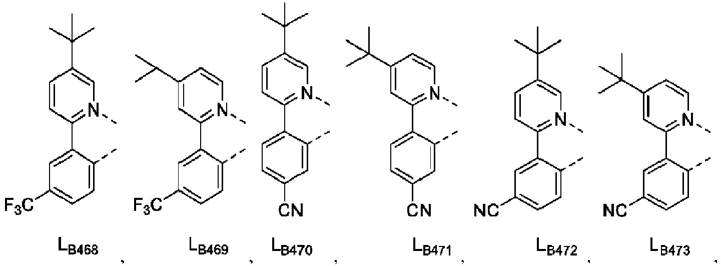 und 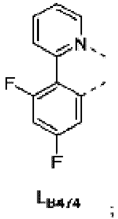
Wobei jedes L_{C*j*-I} eine Struktur basierend auf der Formel 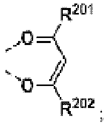 aufweist, und
jedes L_{C*j*-II} eine Struktur basierend auf der Formel 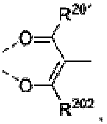 aufweist, wobei für jedes L_{C*j*} in L_{*C j*-I} und L_{C*j*-II} R²⁰¹ und R²⁰² jeweils unabhängig wie folgt definiert sind: 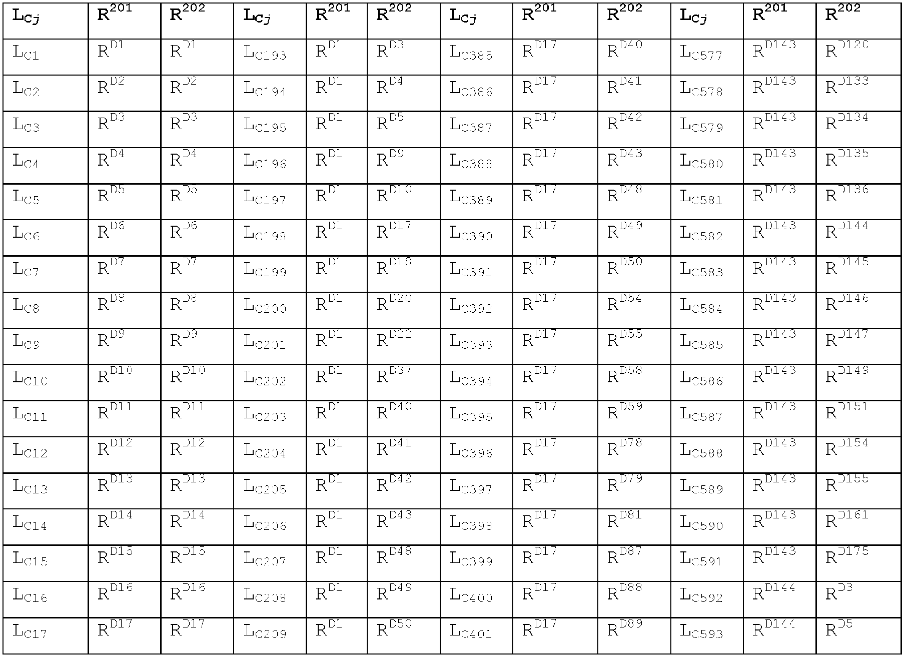 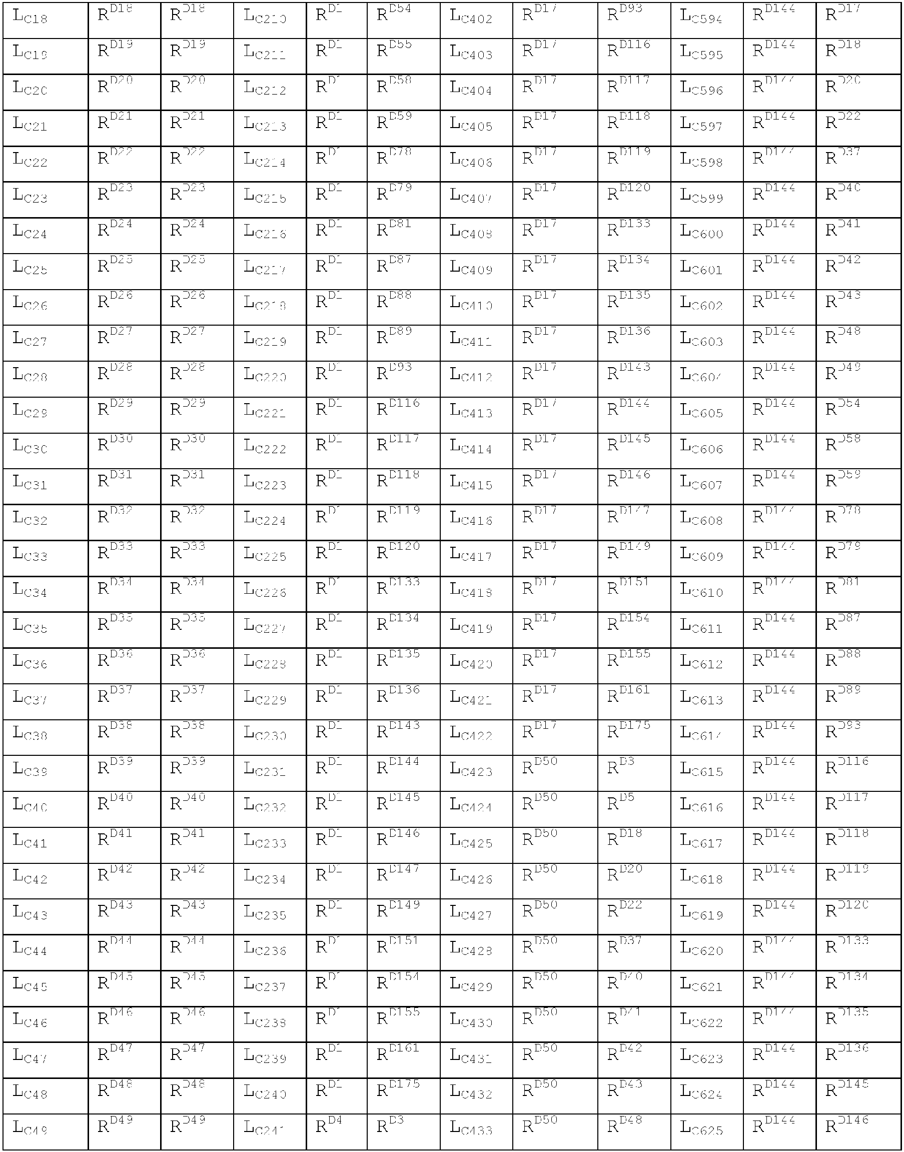 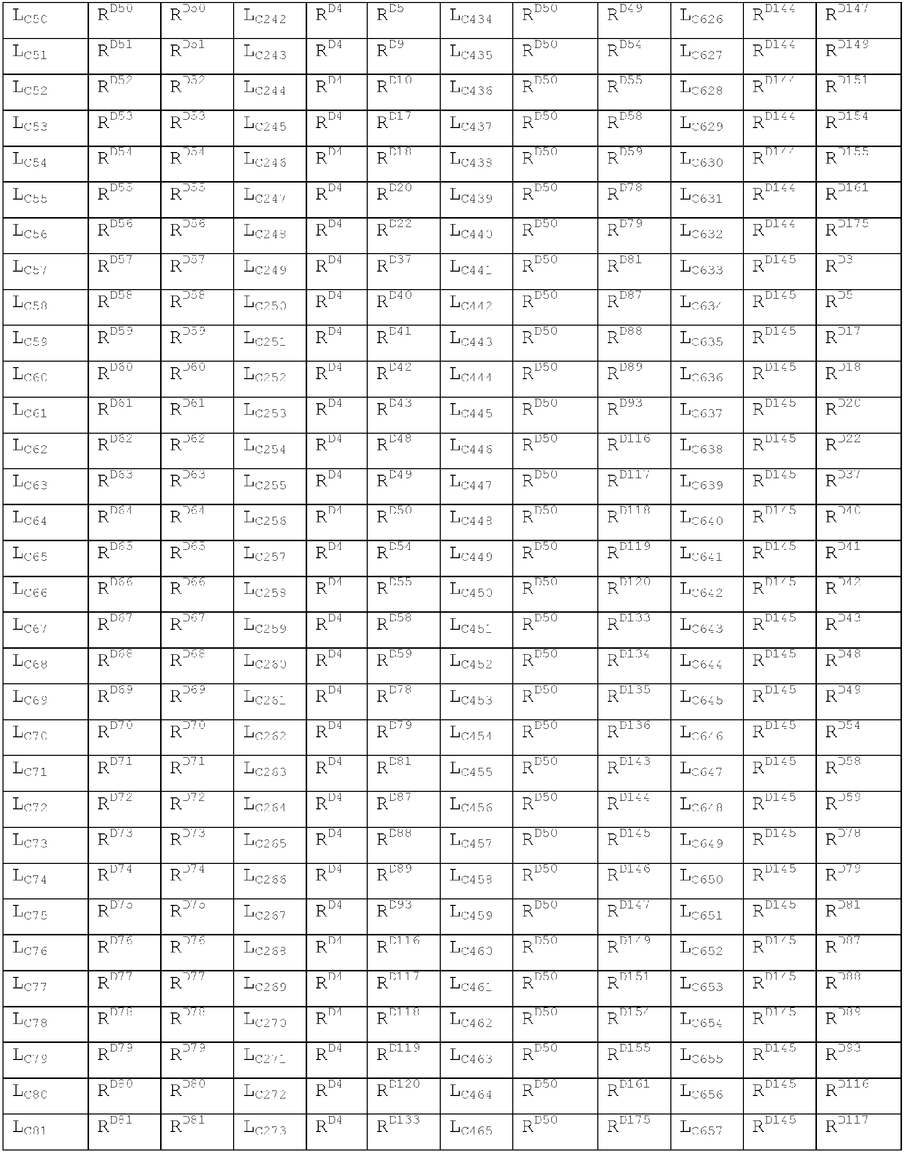 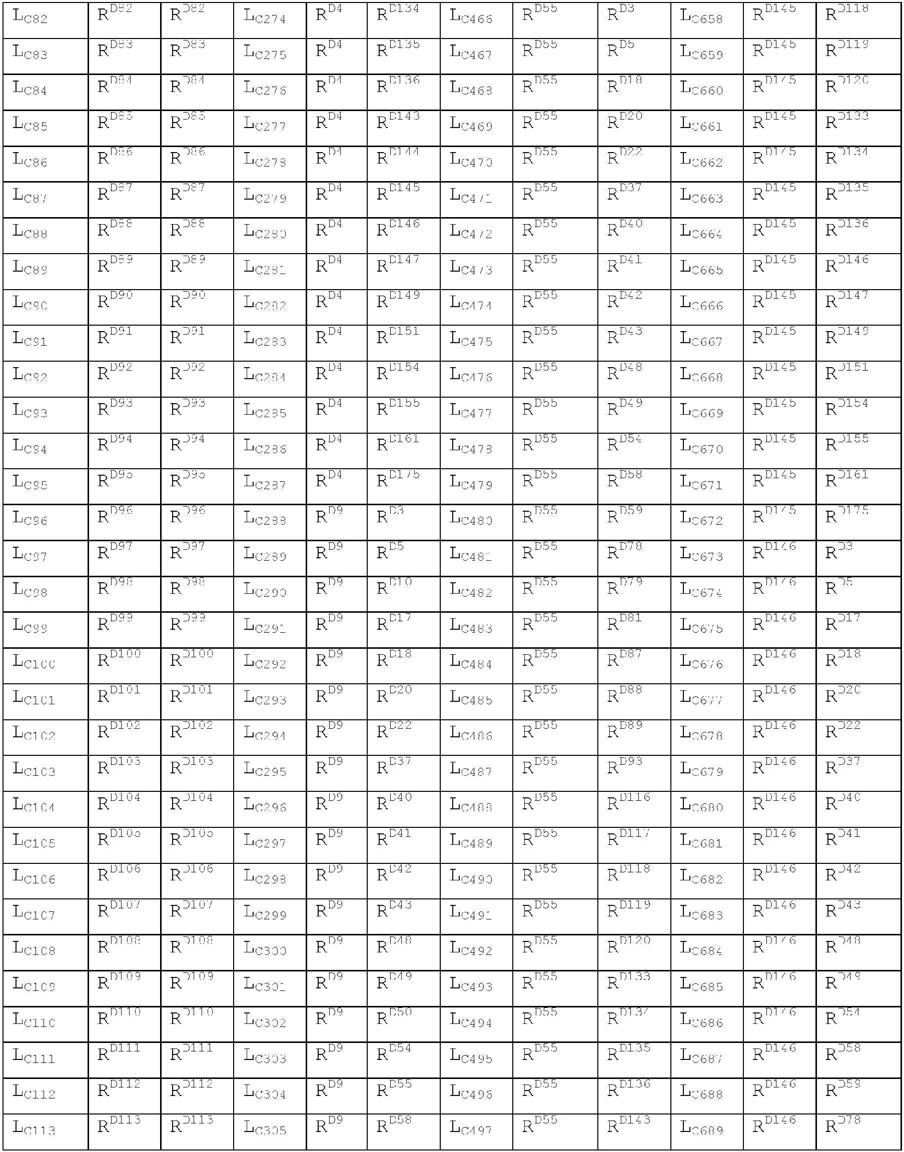 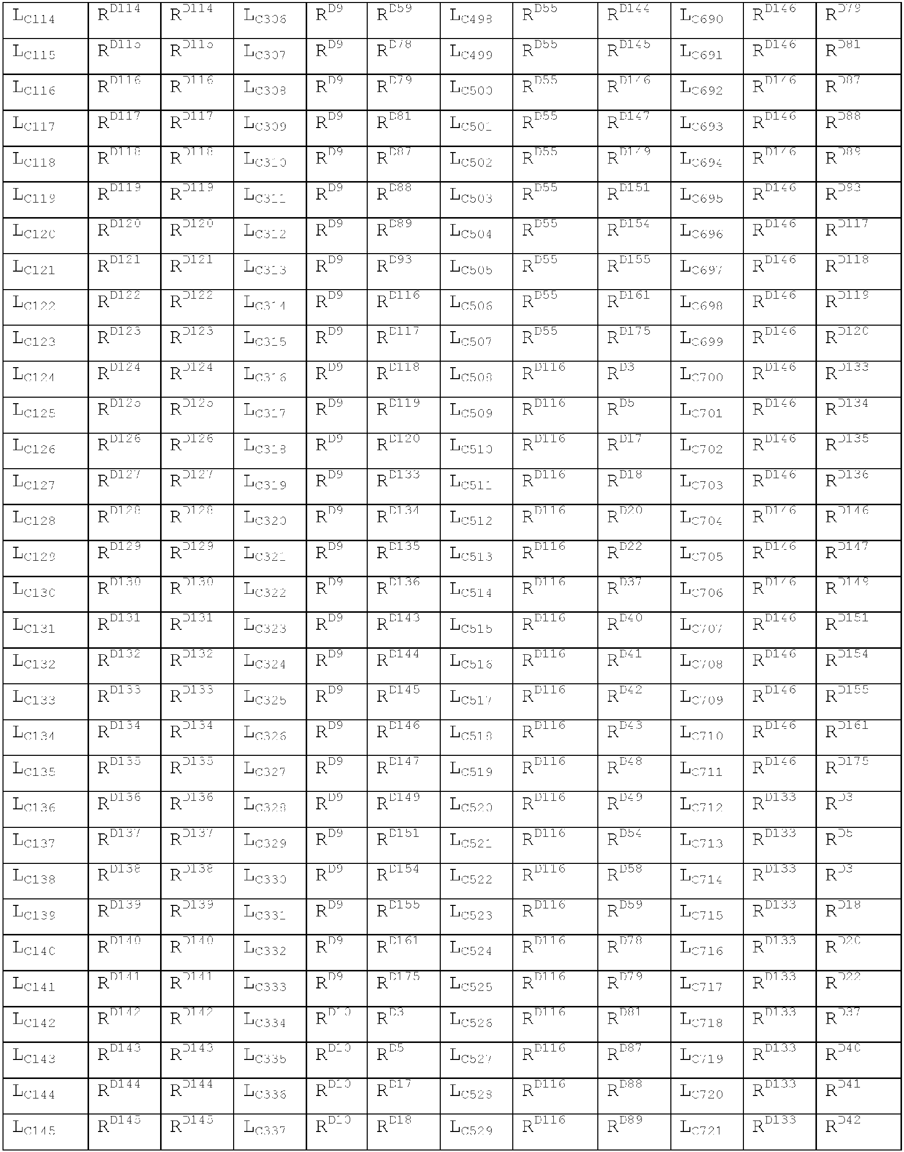 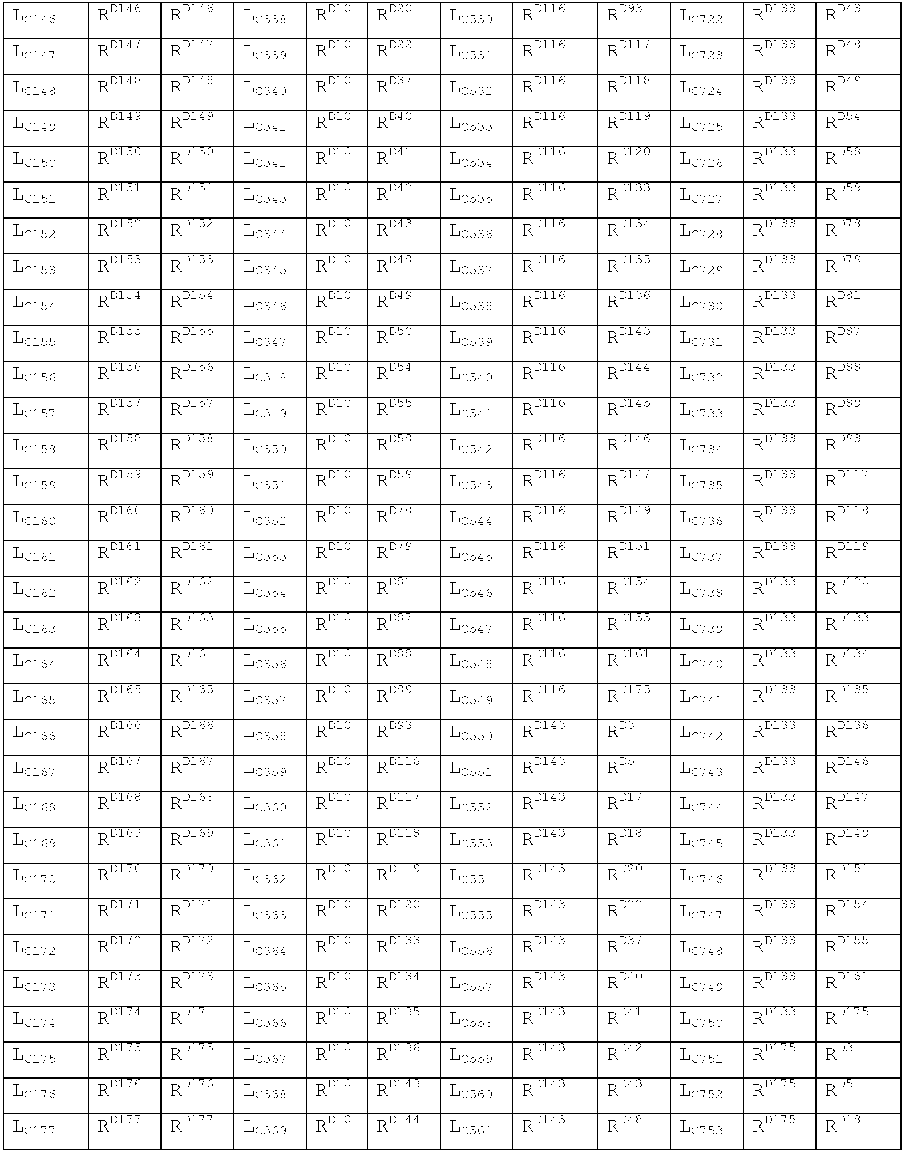 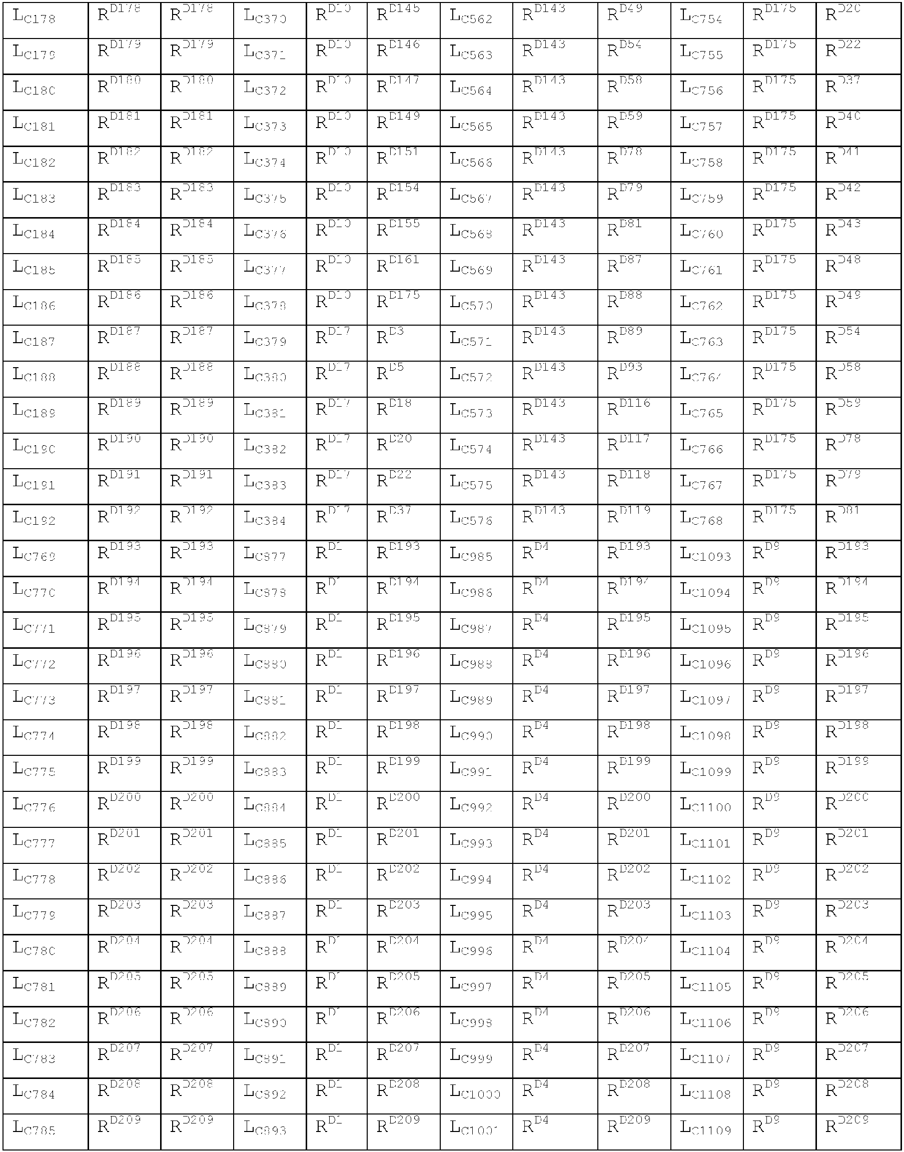 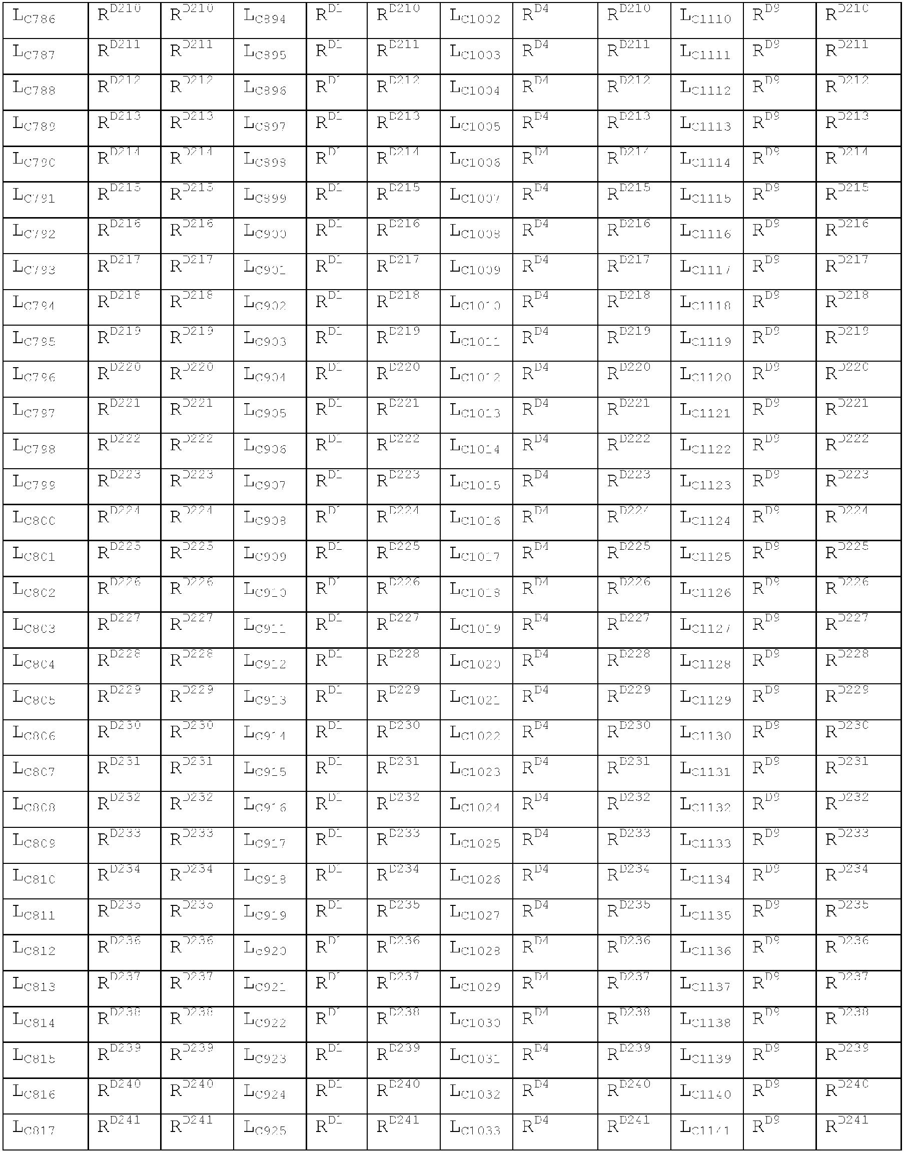 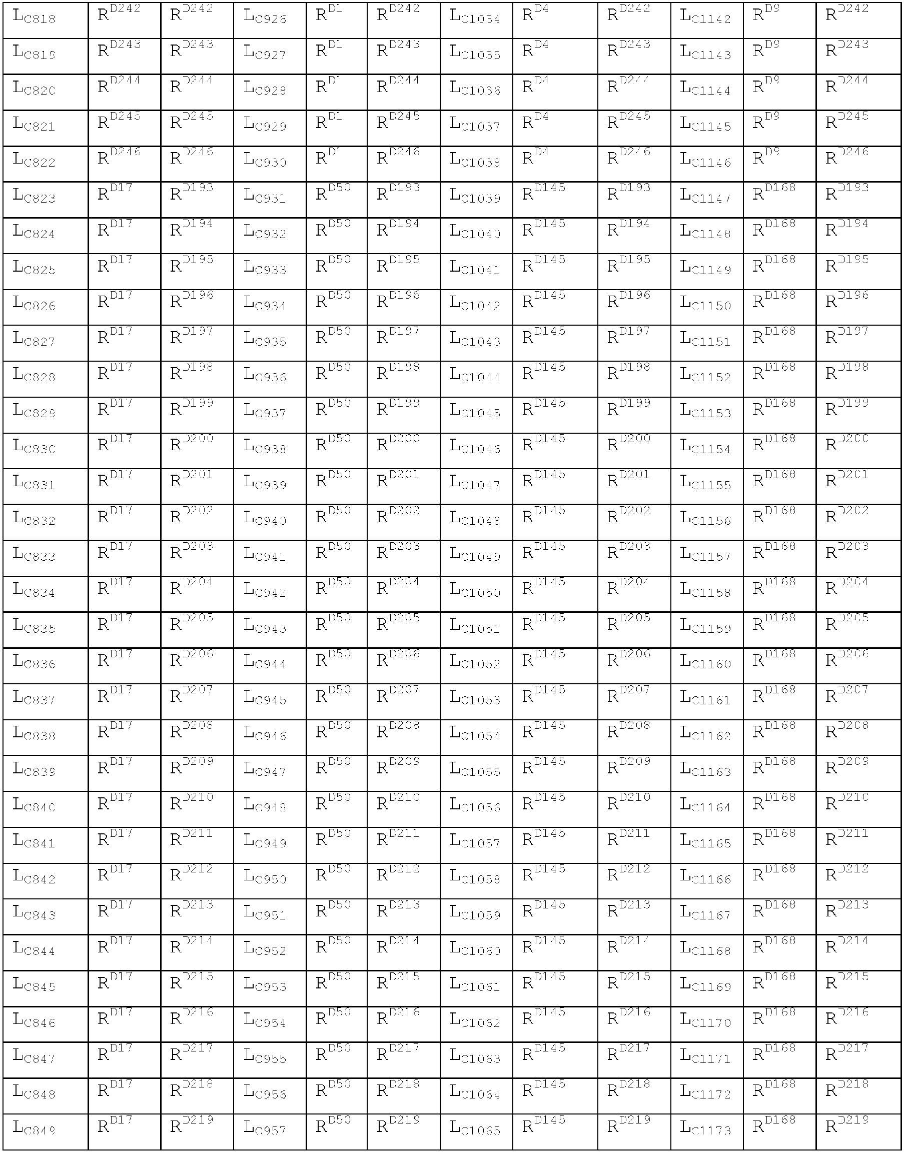 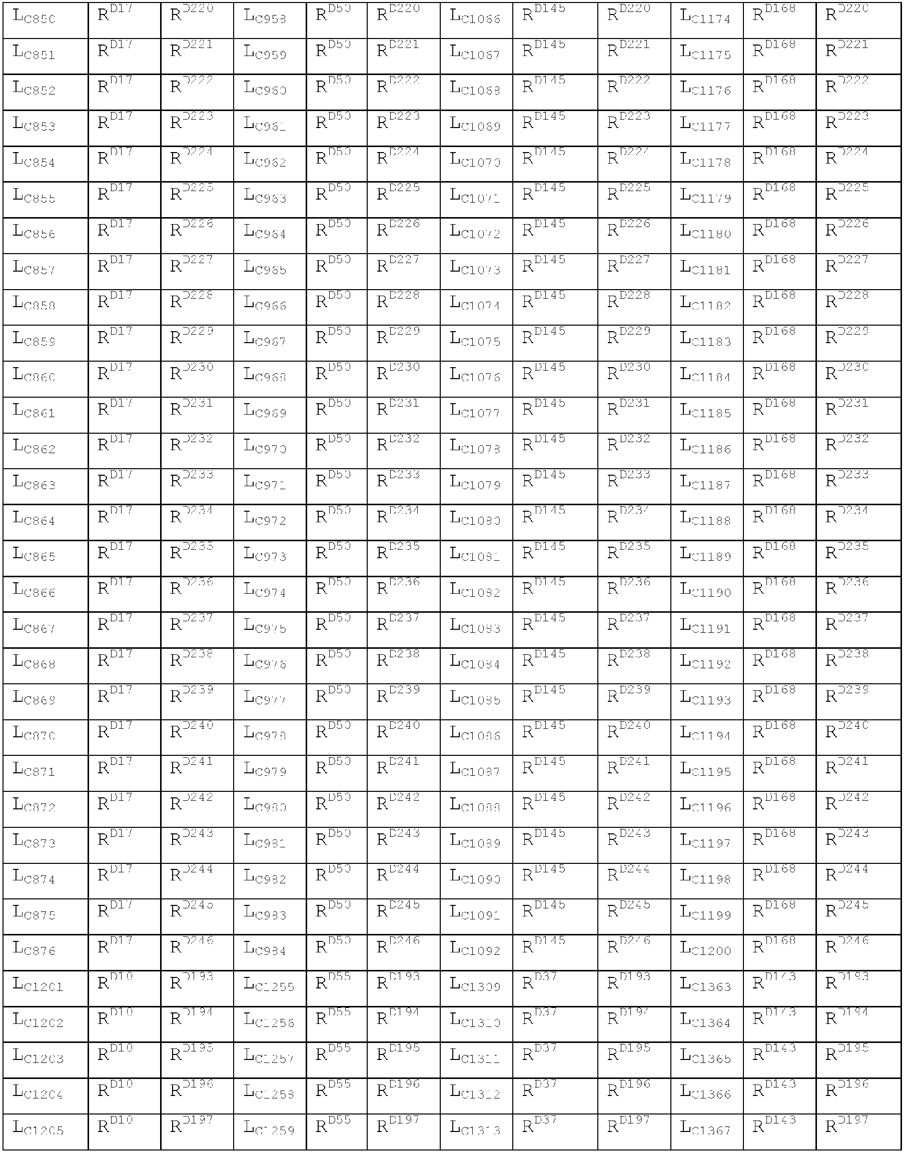 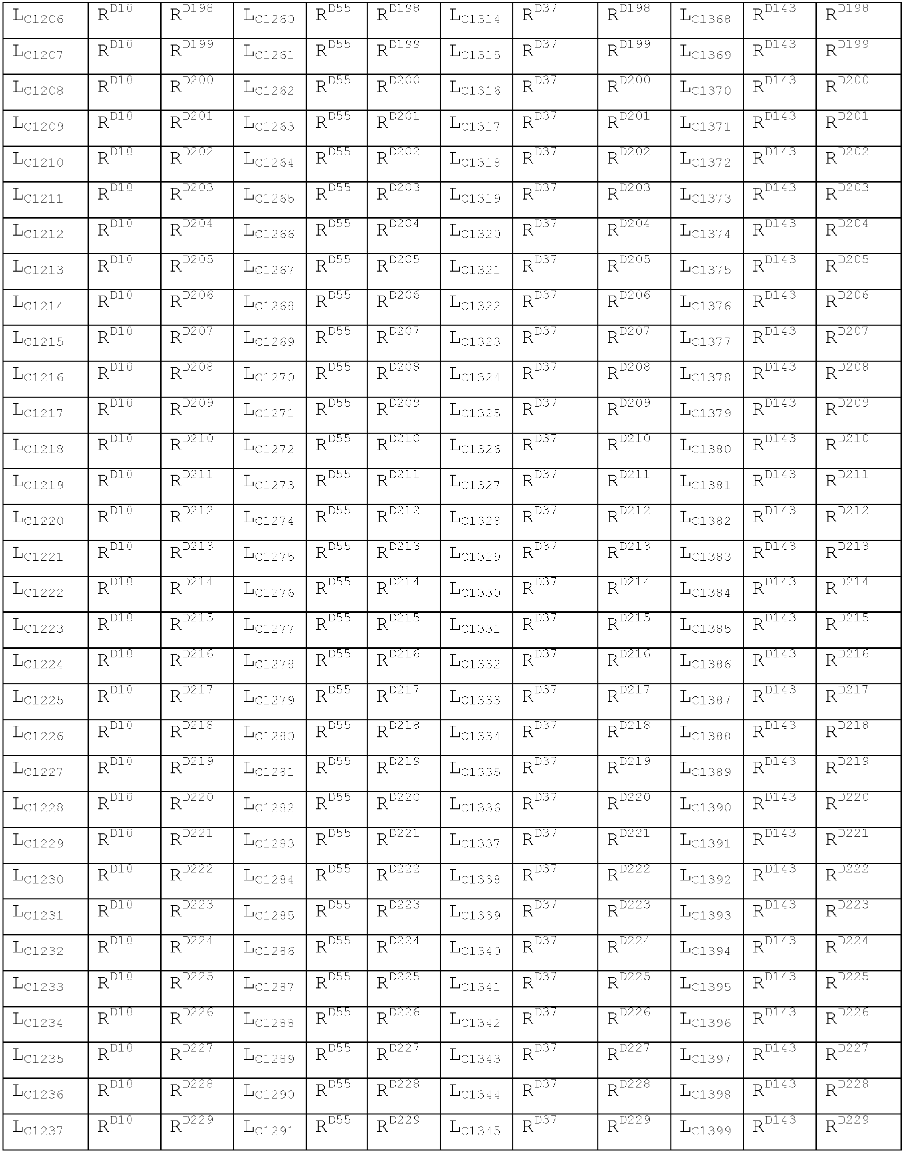 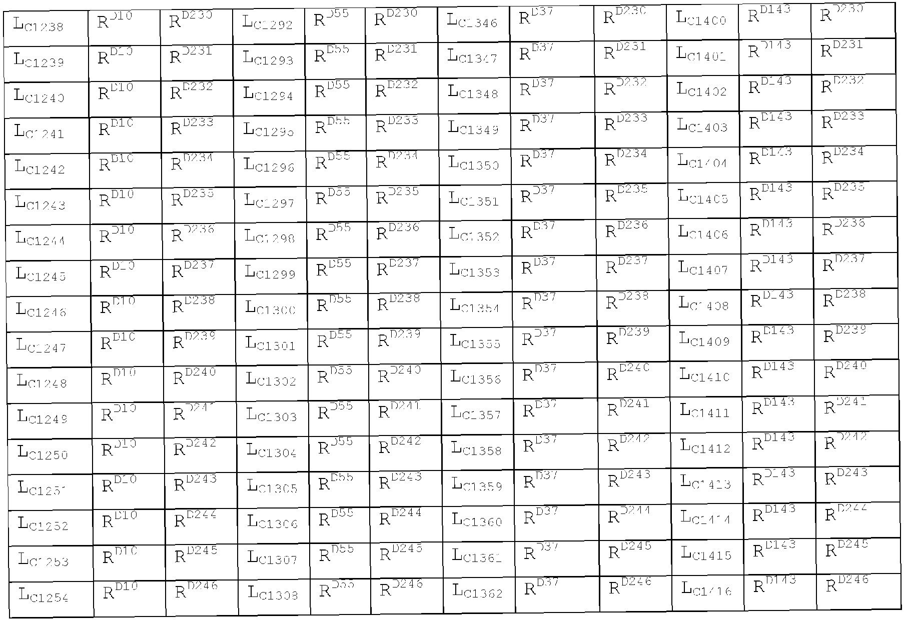
wobei R^{D1} bis R^{D246} die wie folgt definierten Strukturen aufweisen:

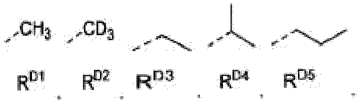

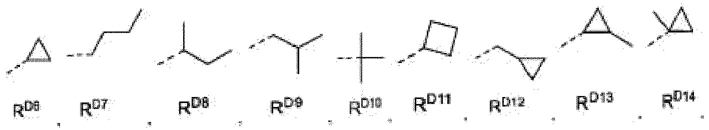

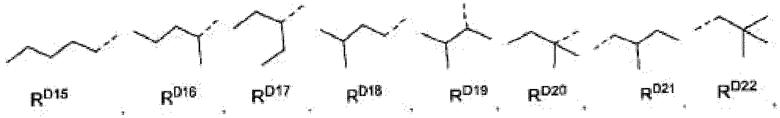

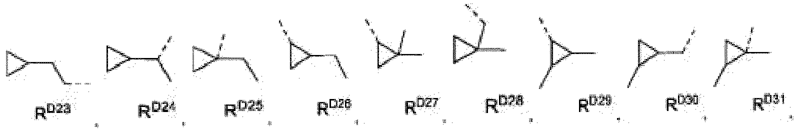

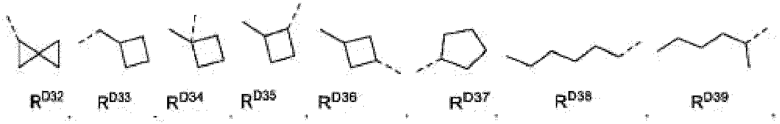

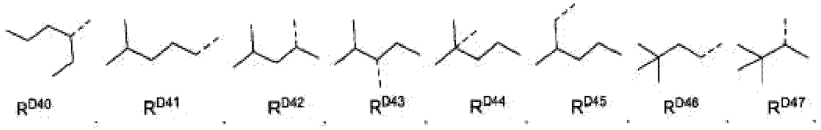

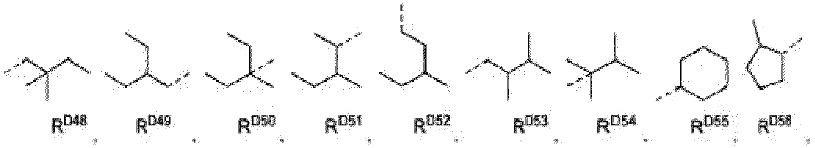

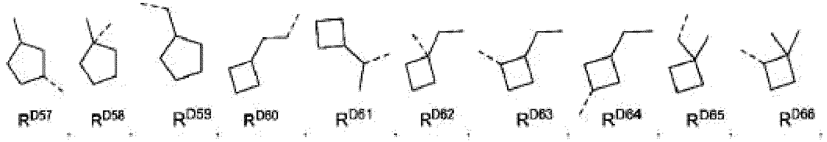

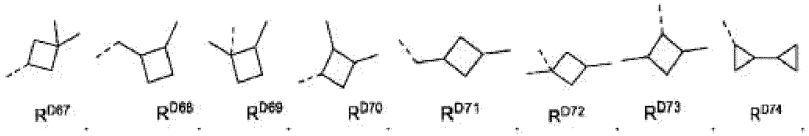

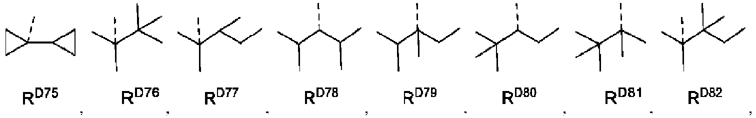

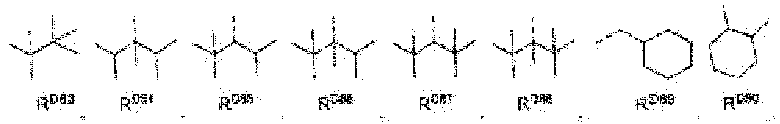

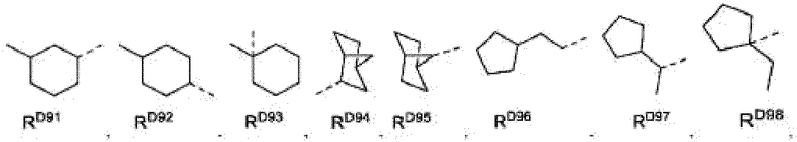

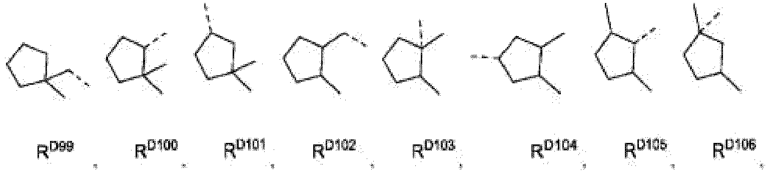

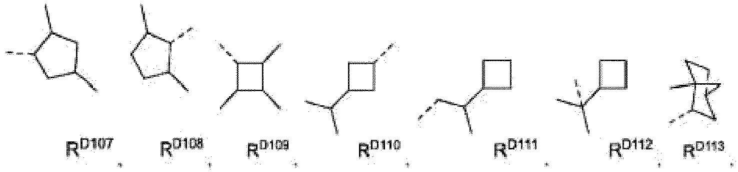

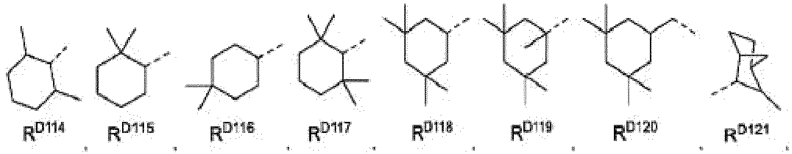

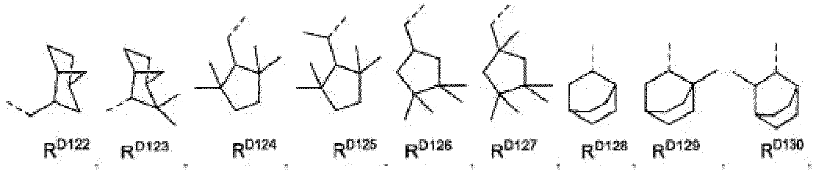

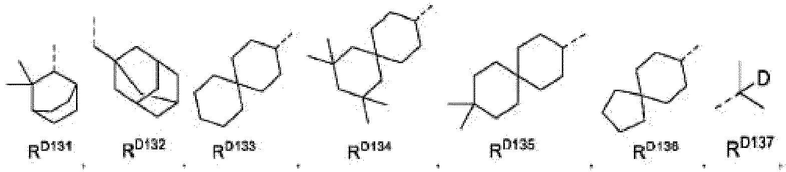

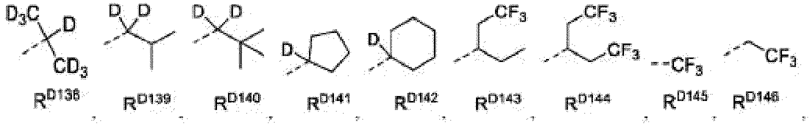

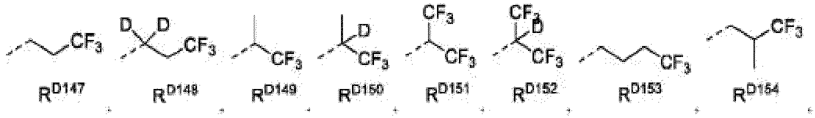

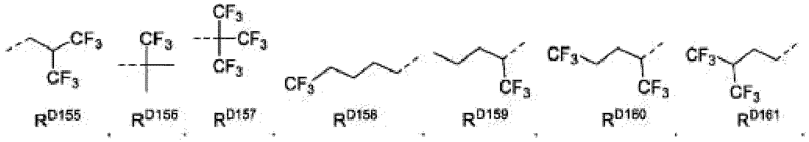

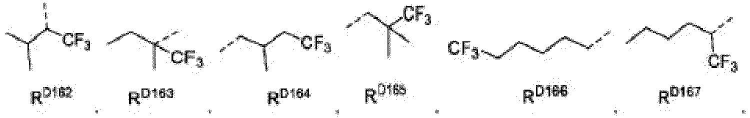

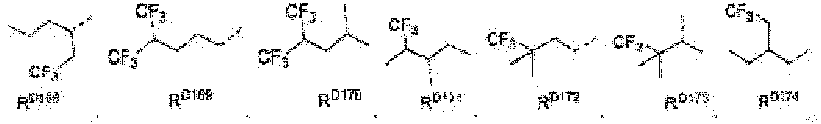

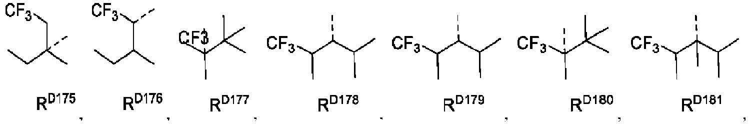

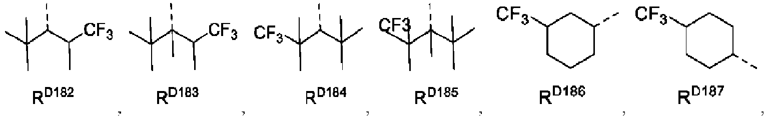

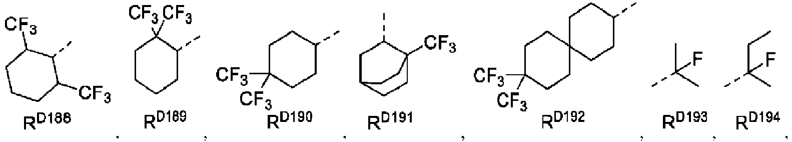

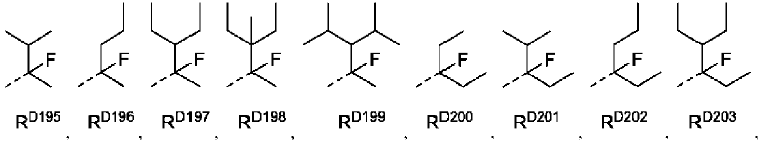

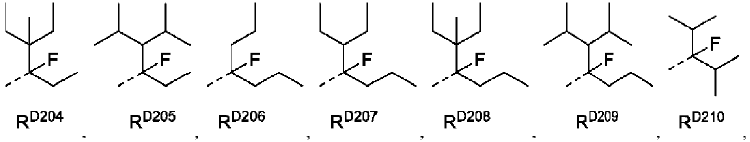

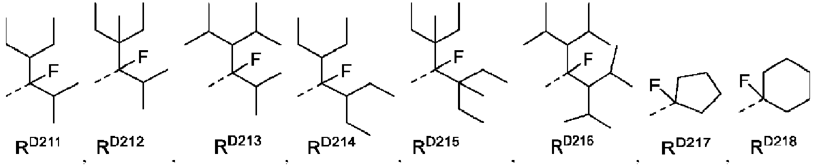

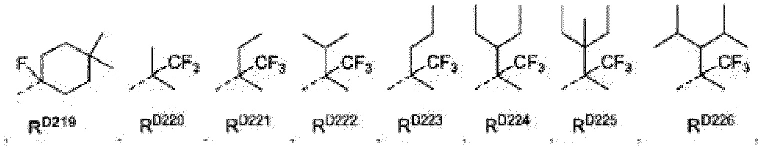

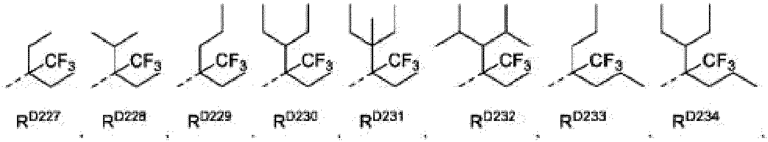

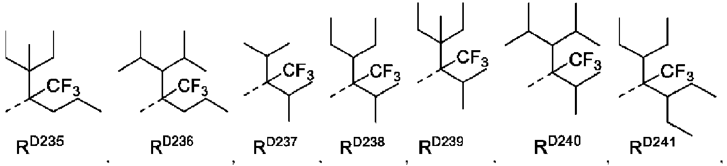

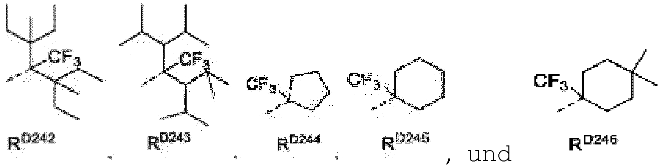

12. Verbindung nach Anspruch 1, wobei die Verbindung ausgewählt ist aus der Gruppe bestehend aus den hierin definierten Strukturen von LIST 11.

13. Verbindung nach Anspruch 8, wobei die Verbindung die Formel II hat, 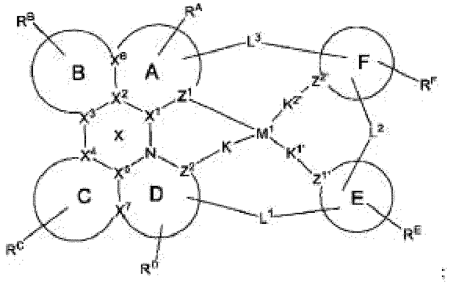 wobei:
M¹ Pd oder Pt ist;
Gruppierungen E und F jeweils unabhängig eine monocyclische oder polycyclische Ringstruktur sind, die 5-gliedrige und/oder 6-gliedrige carbocyclische oder heterocyclische Ringe umfasst;
Z^{1'} und Z^{2'} jeweils unabhängig C oder N sind;
K^{1'}, und K^{2'} jeweils unabhängig ausgewählt sind aus der Gruppe bestehend aus einer direkten Bindung, O und S, wobei mindestens zwei von K, K^{1'}, und K^{2'} direkte Bindungen sind;
L¹, L², und L³ jeweils unabhängig abwesend oder ausgewählt sind aus der Gruppe bestehend aus einer direkten Bindung, BR, BRR', NR, PR, P(O)R, O, S, Se, C=O, C=S, C=Se, C=NR, C= CRR', S=O, SO₂, CR, CRR', SiRR', GeRR', Alkylen, Cycloalkyl, Aryl, Cycloalkylen, Arylen, Heteroarylen und Kombinationen davon, wobei mindestens eines von L¹ und L² vorhanden ist;
R^{E} und R^{F} jeweils unabhängig Null, Mono oder bis zu einer maximal zulässigen Anzahl von Substitutionen an ihrem assoziierten Ring darstellen;
jedes von R, R', R^{E}, und R^{F} unabhängig Wasserstoff oder ein Substituent ist, ausgewählt aus der Gruppe bestehend aus Deuterium, Fluor, Alkyl, Cycloalkyl, Heteroalkyl, Alkoxy, Aryloxy, Amino, Silyl, Boryl, Alkenyl, Cycloalkenyl, Heteroalkenyl, Aryl, Heteroaryl, Nitril, Isonitril, Sulfanyl und Kombinationen davon; und
zwei benachbarte R^{A}, R^{B}, R^{C}, R^{E}, und R^{F} miteinander verbunden oder verschmolzen sein können, um einen Ring zu bilden.

14. Organische lichtemittierende Vorrichtung umfassend:
eine Anode;
eine Kathode; und
eine organische Schicht, die zwischen der Anode und der Kathode angeordnet ist, wobei die organische Schicht eine Verbindung nach Anspruch 1 umfasst.

15. Verbraucherprodukt, umfassend eine organische lichtemittierende Vorrichtung, umfassend:
eine Anode;
eine Kathode; und
eine organische Schicht, die zwischen der Anode und der Kathode angeordnet ist, wobei die organische Schicht eine Verbindung nach Anspruch 1 umfasst.

## Revendications

1. Composé comprenant un premier ligand L_{A} de formule I, 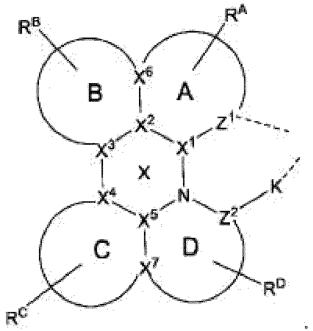 dans lequel :
les fragments A, B, C et D sont chacun indépendamment un cycle monocyclique ou un système de cycles fusionnés polycycliques, dans lequel le cycle monocyclique et chaque cycle du système de cycles fusionnsé polycycliques sont indépendamment un cycle carbocyclique ou hétérocyclique à 5 chaînons ou 6 chaînons ;
Z¹ et Z² sont chacun indépendamment C ou N ;
chacun de X¹ à X⁷ est chacun indépendamment C ou N ;
K est sélectionné dans le groupe consistant en une liaison directe, O, S, N(R^{α}), P(R^{α}), B(R^{α}), C(R^{α}), C(R^{α})(R^{β}) et Si(R^{α})(R^{β}) ;
R^{A}, R^{B}, R^{C} et R^{D} représentent chacun indépendamment une mono-substitution à une substitution maximale admissible, ou aucune substitution ;
chaque R^{α}, R^{β}, R^{A}, R^{B}, R^{C} et R^{D} est indépendamment hydrogène ou un substituant sélectionné dans le groupe consistant en deutérium, halogène, alkyle, cycloalkyle, hétéroalkyle, hétérocycloalkyle, boryle, arylalkyle, alcoxy, aryloxy, amino, silyle, germyle, alcényle, cycloalcényle, hétéroalcényle, alcynyle, aryle, hétéroaryle, acyle, acide carboxylique, éther, ester, nitrile, isonitrile, sulfanyle, sulfinyle, sulfonyle, phosphino, sélényle et des combinaisons de ceux-ci ;
deux substituants quelconques peuvent être liés ou fusionnés pour former un cycle ;
L_{A} est lié à un métal M qui présente une masse atomique d'au moins 40 ;
M peut être coordonné à d'autres ligands ; et
L_{A} peut être lié à d'autres ligands pour comprendre un ligand tridentate, tétradentate, pentadentate ou hexadentate.

2. Composé selon la revendication 1, dans lequel le métal M est sélectionné dans le groupe consistant en Ir, Rh, Re, Ru, Os, Pt, Pd, Ag, Au et Cu.

3. Composé selon la revendication 1, dans lequel K est sélectionné dans le groupe consistant en N(R^{α}), P(R^{α}), B(R^{α}), C(R^{α}), C(R^{α})(R^{β}) et Si(R^{α})(R^{β}) ; et/ou
dans lequel au moins l'un de R^{α} ou R^{β} est lié à R^{D} pour former un cycle fusionné au fragment D ; et/ou dans lequel K est une liaison directe, O ou S ; et/ou dans lequel Z¹ est N et Z² est C, ou dans lequel Z¹ est le carbone de carbène et Z² est C ; et/ou
dans lequel chacun de X¹ à X⁷ est C ou au moins l'un de X¹ à X⁷ est N ; et/ou
dans lequel un R^{A} est lié à un R^{B} pour former un cycle ; et/ou dans lequel un R^{B} est lié à un R^{C} pour former un cycle ; et/ou dans lequel un R^{C} est lié à un R^{D} pour former un cycle.

4. Composé selon la revendication 1, dans lequel chacun des fragments A, B, C et D est sélectionné indépendamment dans le groupe consistant en benzène, pyridine, pyrimidine, pyridazine, pyrazine, triazine, imidazole, pyrazole, pyrrole, oxazole, furane, thiophène, thiazole, triazole, naphtalène, quinoléine, isoquinoléine, quinazoline, benzofurane, aza-benzofurane, benzoxazole, aza-benzoxazole, benzothiophène, aza-benzothiophène, benzothiazole, aza-benzothiazole, benzosélénophène, aza-benzosélénophène, indène, aza-indène, indole, aza-indole, benzimidazole, aza-benzimidazole, carbazole, aza-carbazole, dibenzofurane, aza-dibenzofurane, dibenzothiophène, aza-dibenzothiophène, quinoxaline, phtalazine, phénanthrène, aza-phénanthrène, anthracène, aza-antracène, phénanthridine, fluorène et aza-fluorène.

5. Composé selon la revendication 1, dans lequel le ligand L_{A} est sélectionné dans le groupe consistant en : 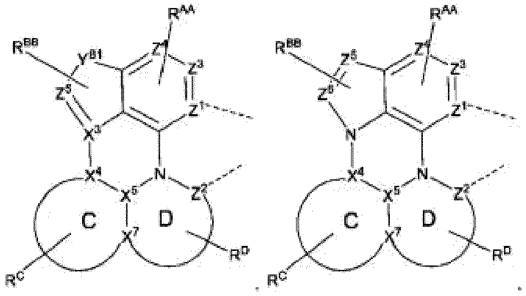 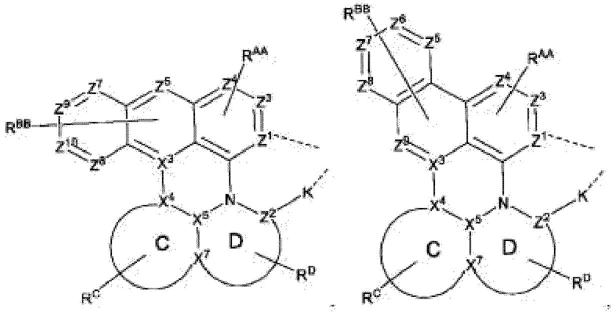 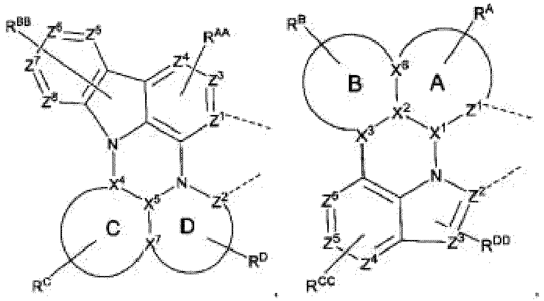 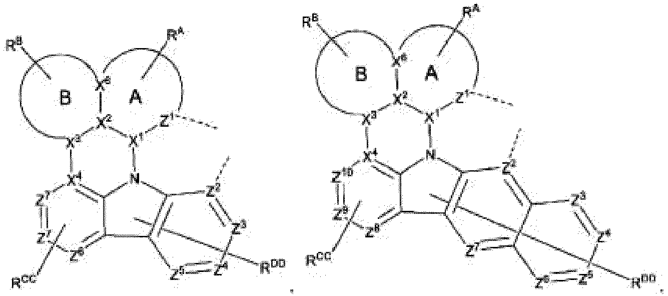 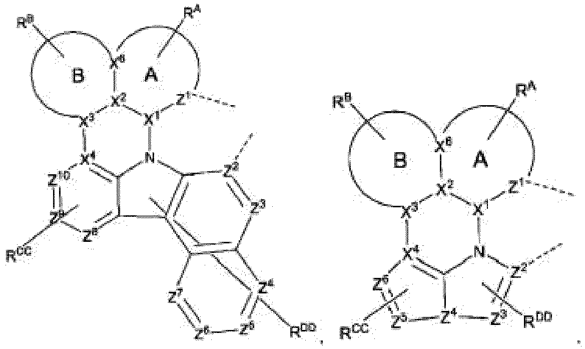 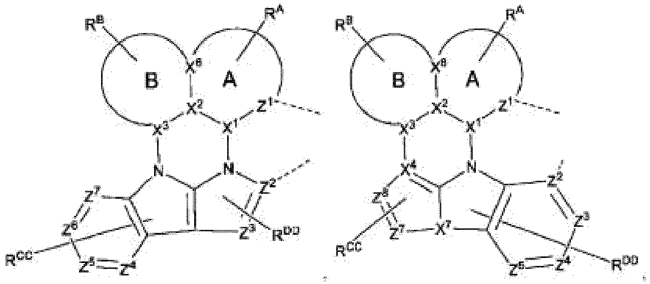 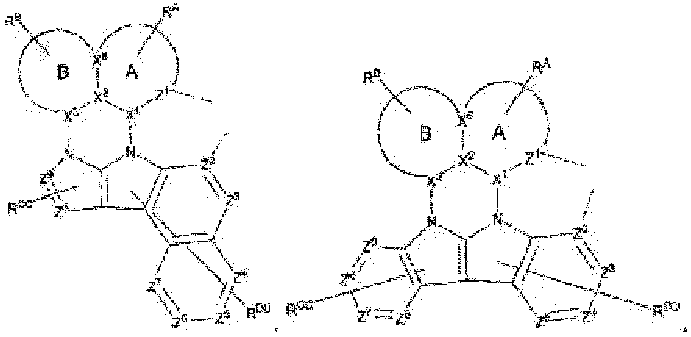 et 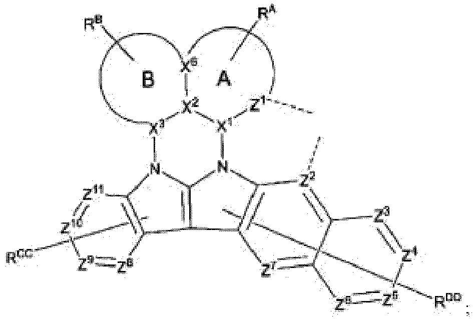 dans lequel :
chacun de Z³ à Z¹¹ est indépendamment C ou N ;
chaque Y^{B1} est indépendamment sélectionné dans le groupe consistant en BR, BRR', NR, PR, P(O)R, O, S, Se, C=O, C=S, C=Se, C=NR, C= CRR', S=O, SO₂, CR, CRR', SiRR' et GeRR' ;
chacun de R^{AA}, R^{BB}, R^{CC} et R^{DD} représente indépendamment une mono-substitution à une substitution maximale admissible, ou aucune substitution ;
chaque R, R', R^{AA}, R^{BB}, R^{CC} et R^{DD} est indépendamment hydrogène ou un substituant sélectionné dans le groupe consistant en deutérium, halogène, alkyle, cycloalkyle, hétéroalkyle, hétérocycloalkyle, boryle, arylalkyle, alcoxy, aryloxy, amino, silyle, germyle, alcényle, cycloalcényle, hétéroalcényle, alcynyle, aryle, hétéroaryle, acyle, acide carboxylique, éther, ester, nitrile, isonitrile, sulfanyle, sulfinyle, sulfonyle, phosphino, sélényle et des combinaisons de ceux-ci ; et
deux substituants quelconques peuvent être liés ou fusionnés pour former un cycle.

6. Composé selon la revendication 1, dans lequel le ligand L_{A} est sélectionné dans le groupe consistant en : 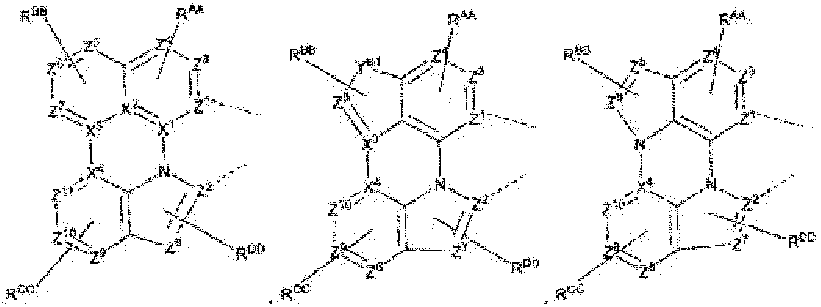 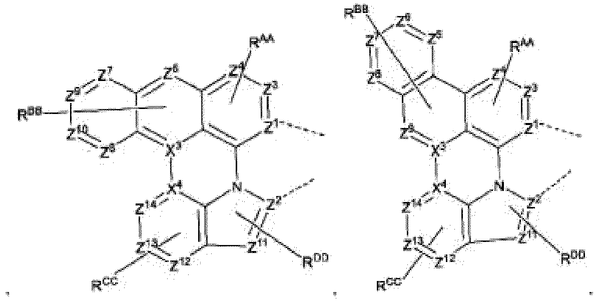 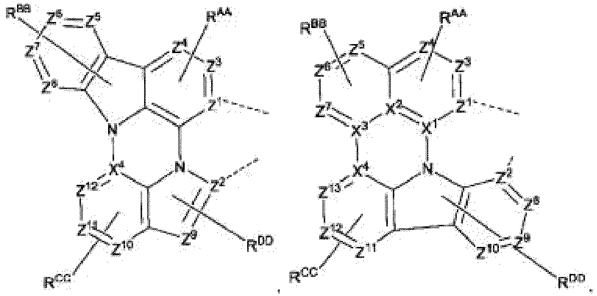 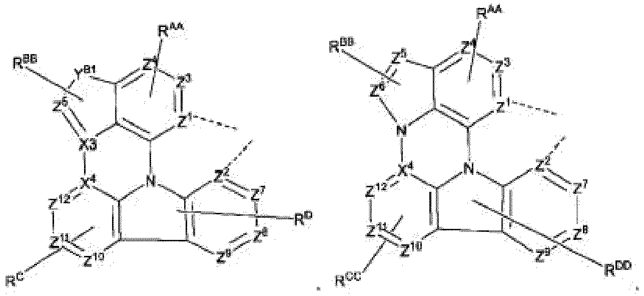 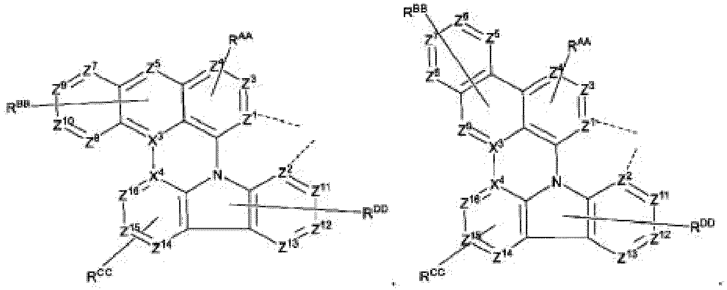 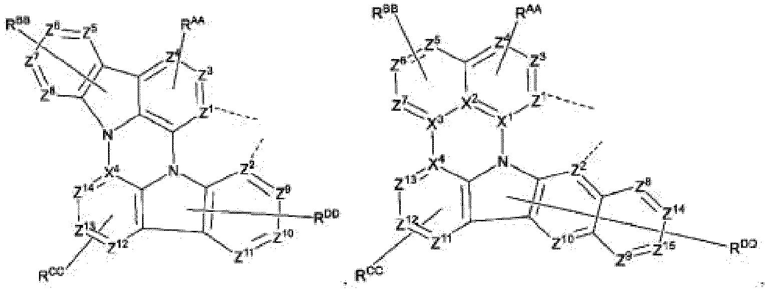 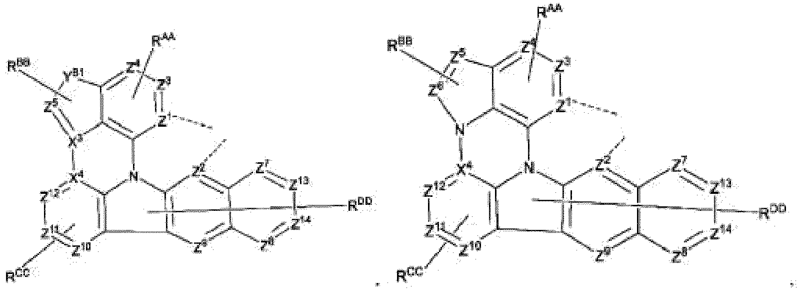 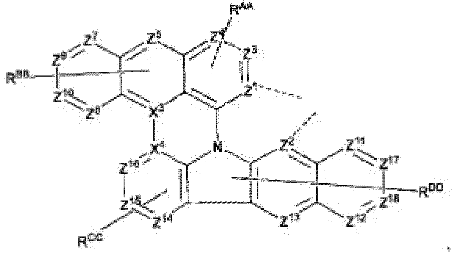 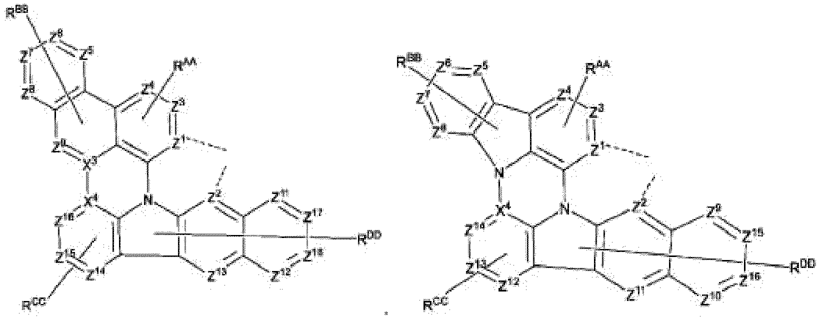 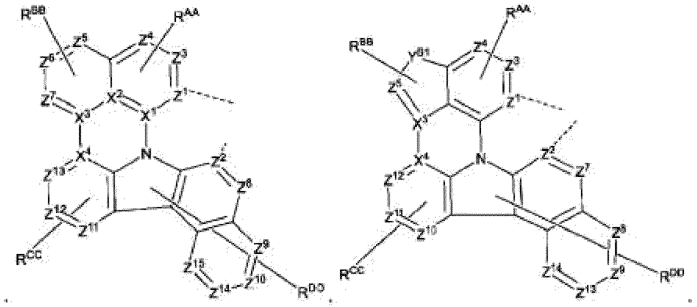 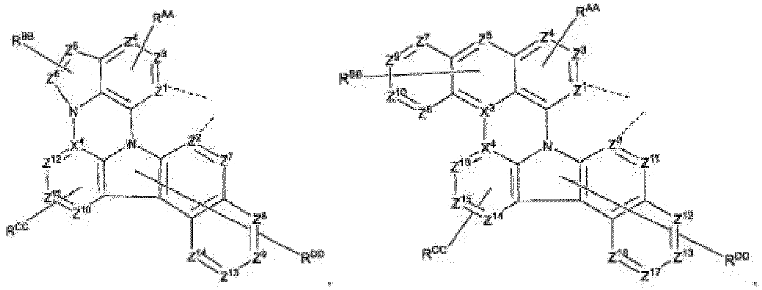 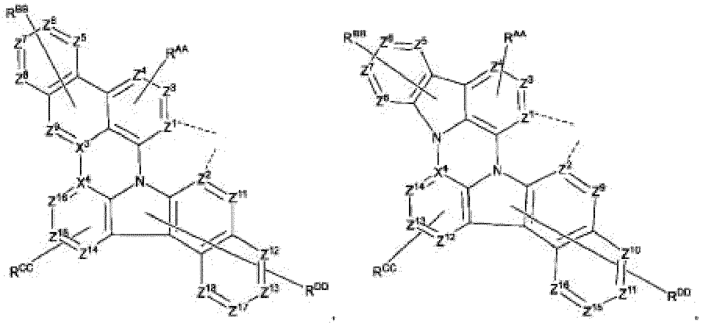 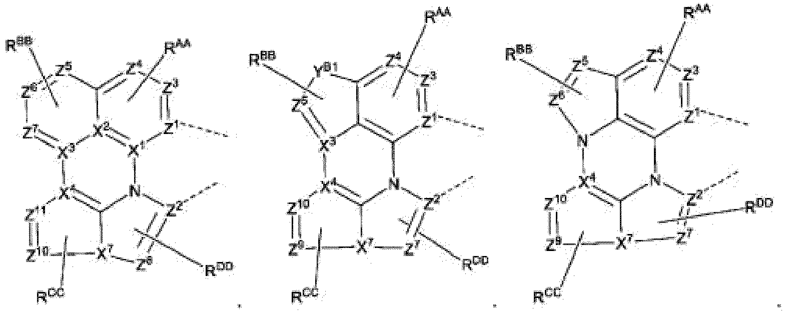 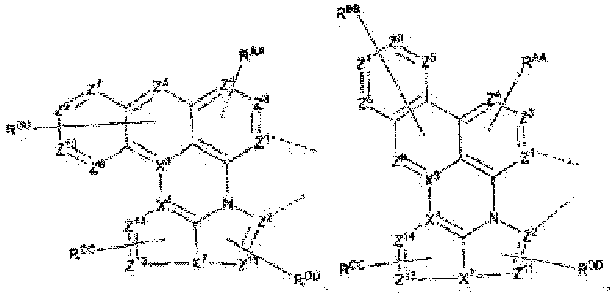 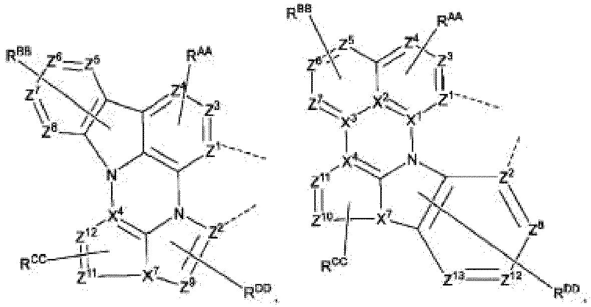 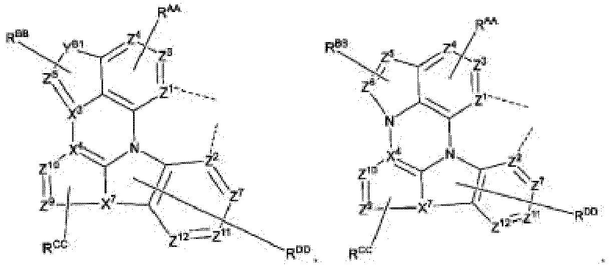 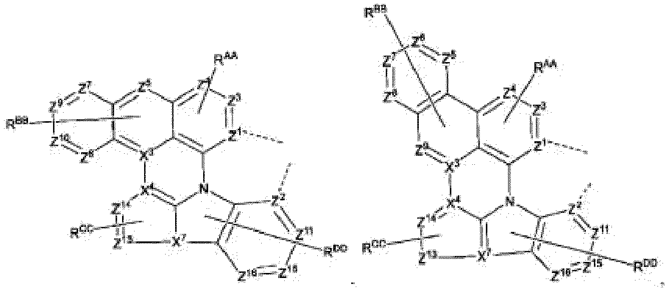 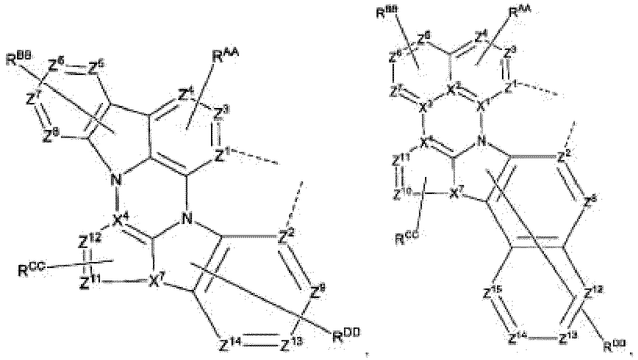 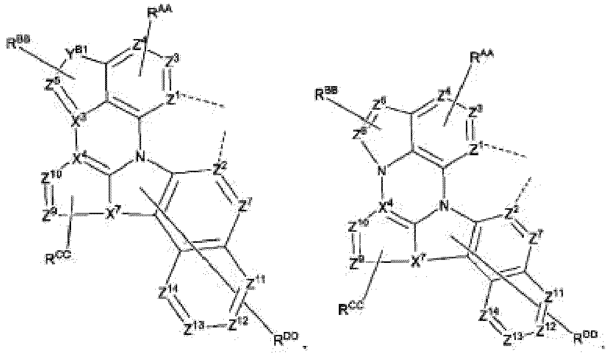 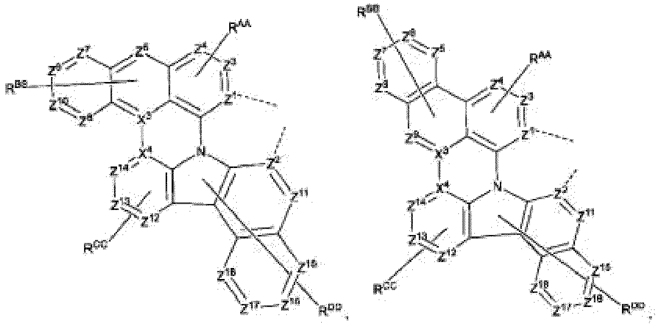 and 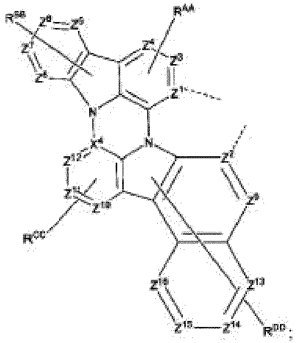 dans lequel :
chacun de Z³ à Z¹⁸ est indépendamment C ou N ;
chaque Y^{B1} est indépendamment sélectionné dans le groupe consistant en BR, BRR', NR, PR, P(O)R, O, S, Se, C=O, C=S, C=Se, C=NR, C= CRR', S=O, SO₂, CR, CRR', SiRR' et GeRR';
chacun de R^{AA}, R^{BB}, R^{CC} et R^{DD} représente indépendamment une mono-substitution à une substitution maximale admissible, ou aucune substitution ;
chaque R, R', R^{AA}, R^{BB}, R^{CC} et R^{DD} est indépendamment hydrogène ou un substituant sélectionné dans le groupe consistant en deutérium, halogène, alkyle, cycloalkyle, hétéroalkyle, hétérocycloalkyle, boryle, arylalkyle, alcoxy, aryloxy, amino, silyle, germyle, alcényle, cycloalcényle, hétéroalcényle, alcynyle, aryle, hétéroaryle, acyle, acide carboxylique, éther, ester, nitrile, isonitrile, sulfanyle, sulfinyle, sulfonyle, phosphino, sélényle et des combinaisons de ceux-ci ; et
deux substituants quelconques peuvent être liés ou fusionnés pour former un cycle.

7. Composé selon la revendication 1, dans lequel le ligand L_{A} est sélectionné dans le groupe consistant en L_{Ai-m}, dans lequel i est un entier de 1 à 3 136 et m est un entier de 1 à 154, et dans lequel L_{Ai-1} à L_{Ai-149} sont définis comme suit : 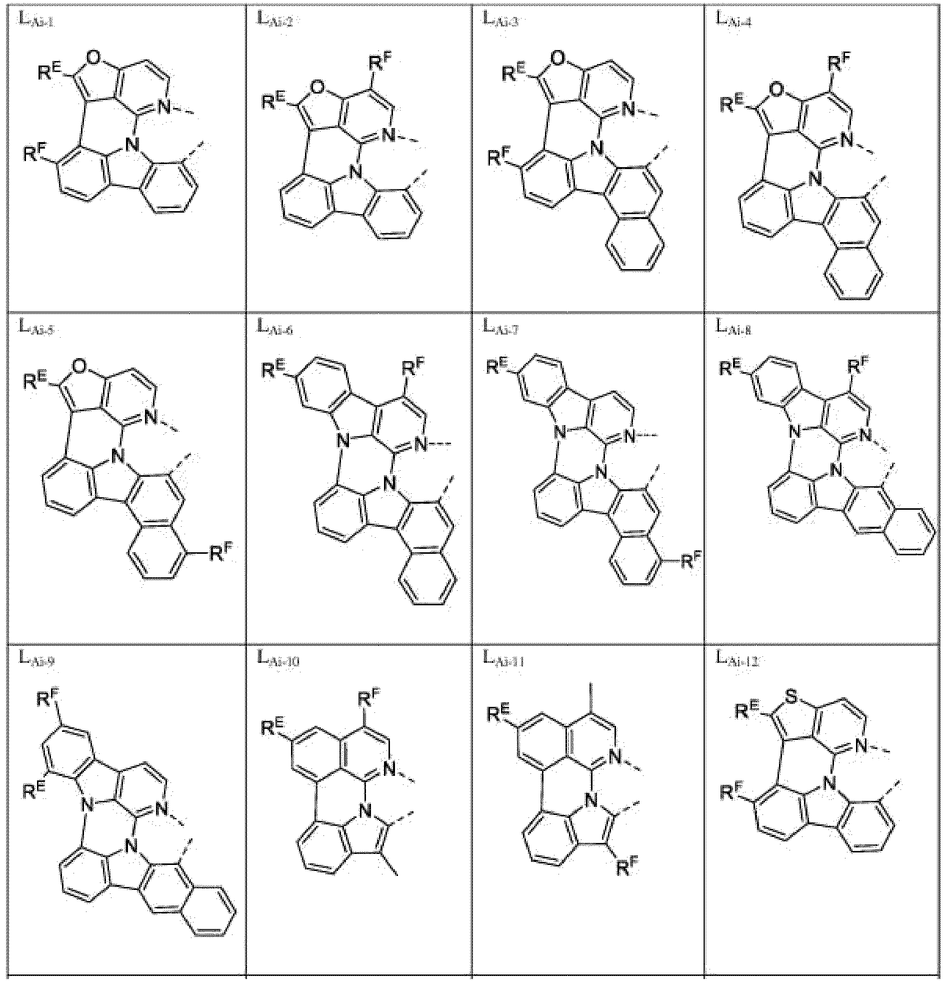 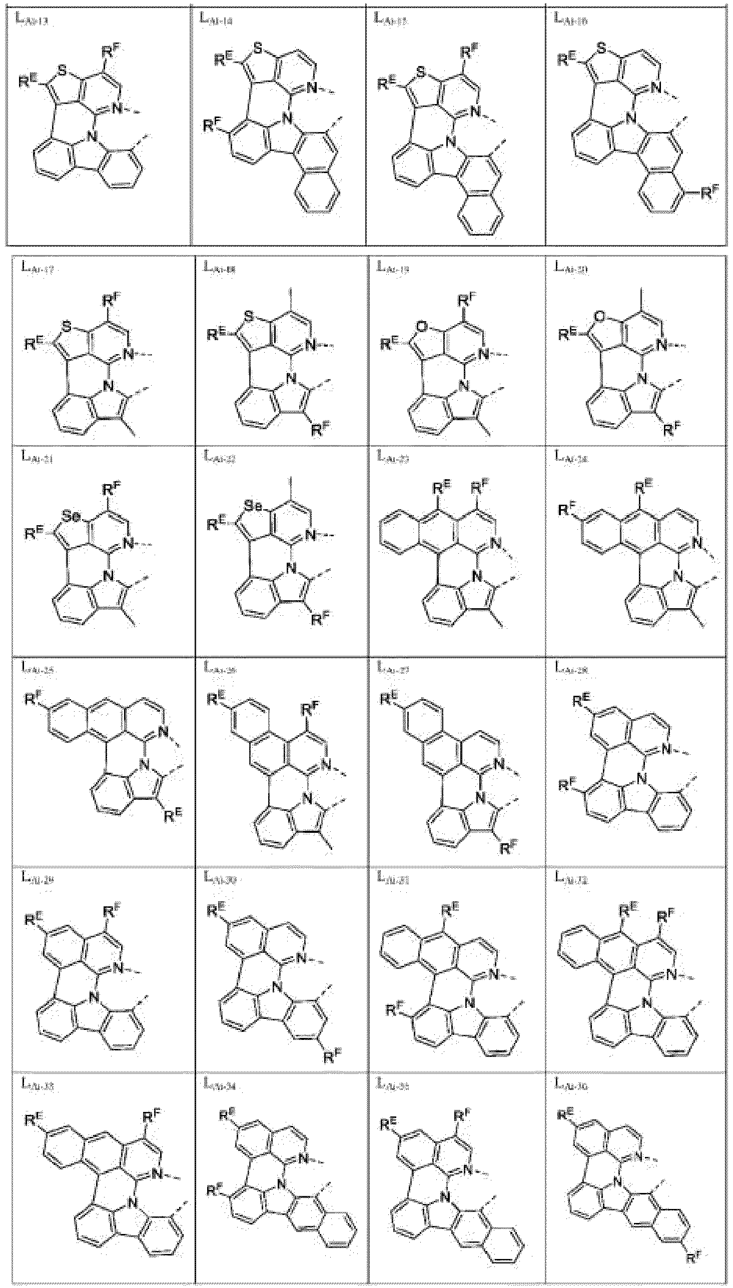 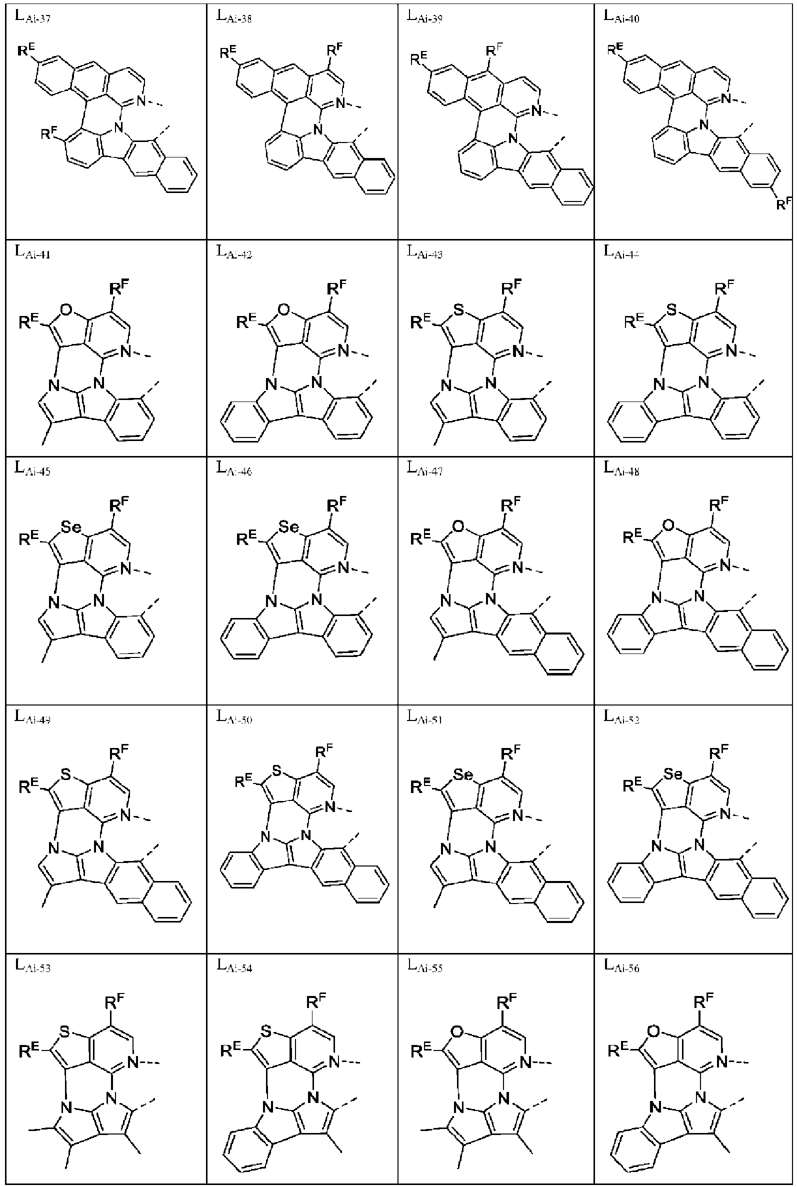 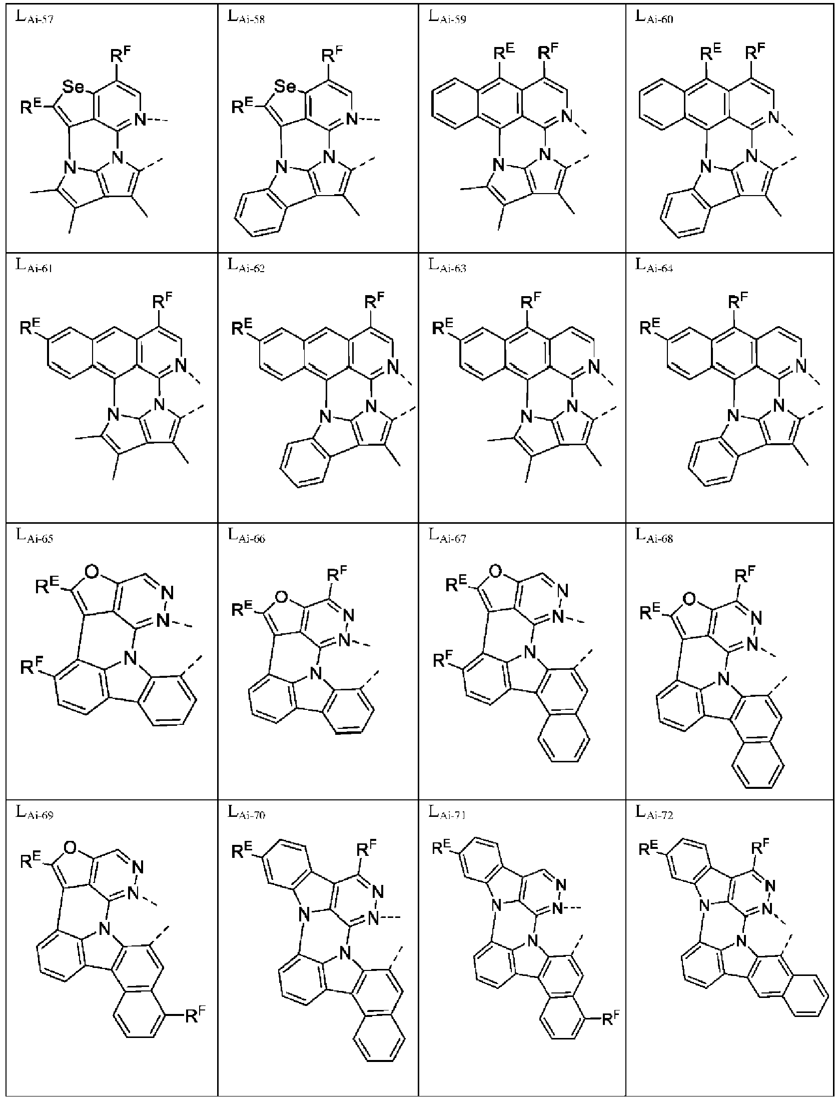 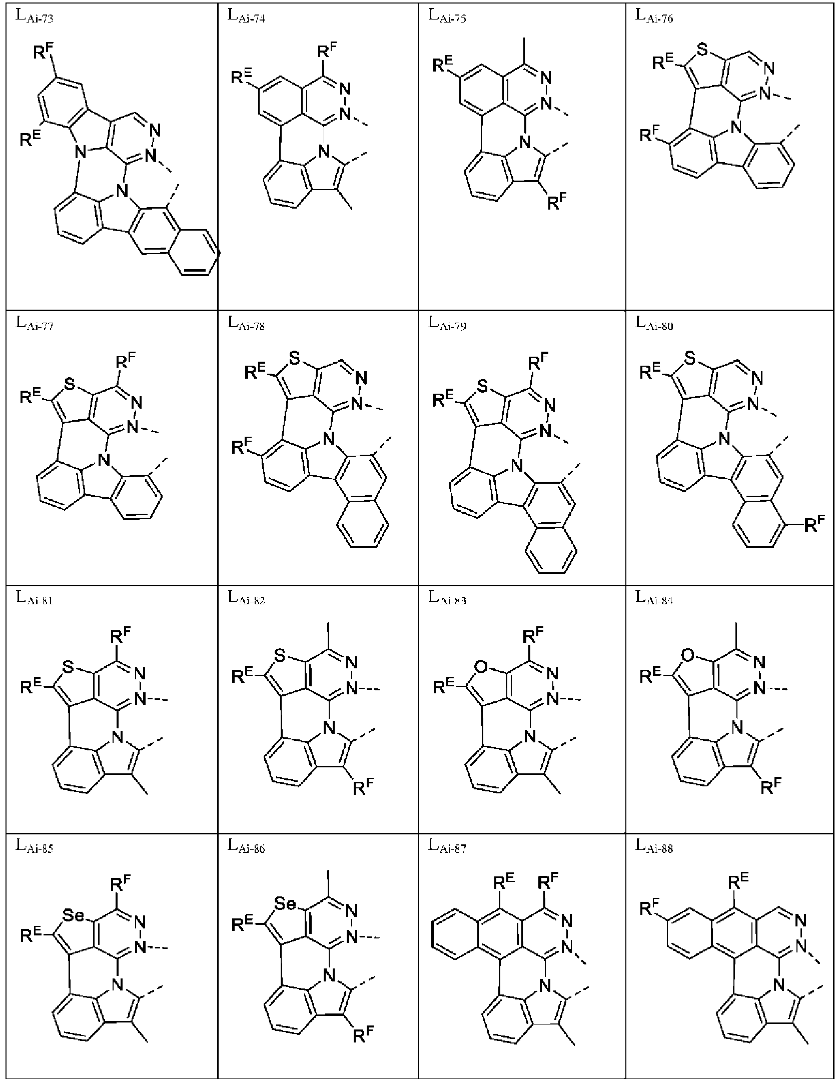 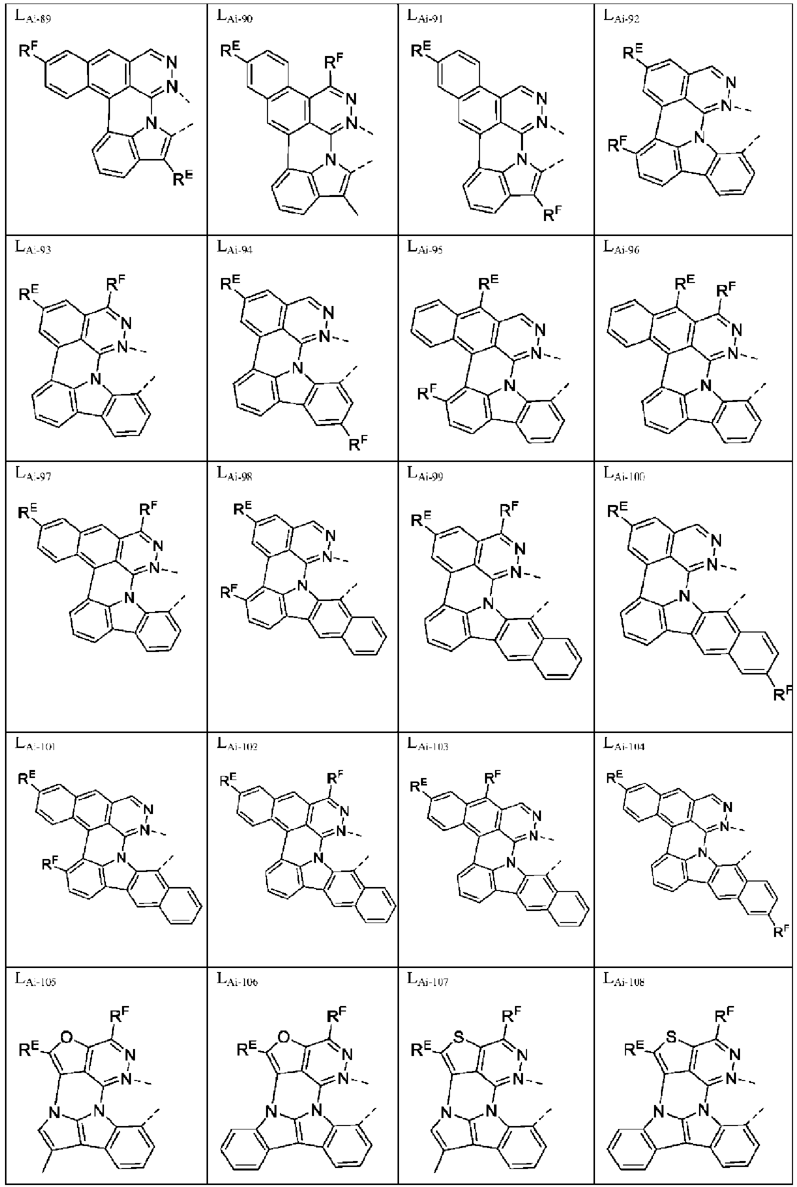 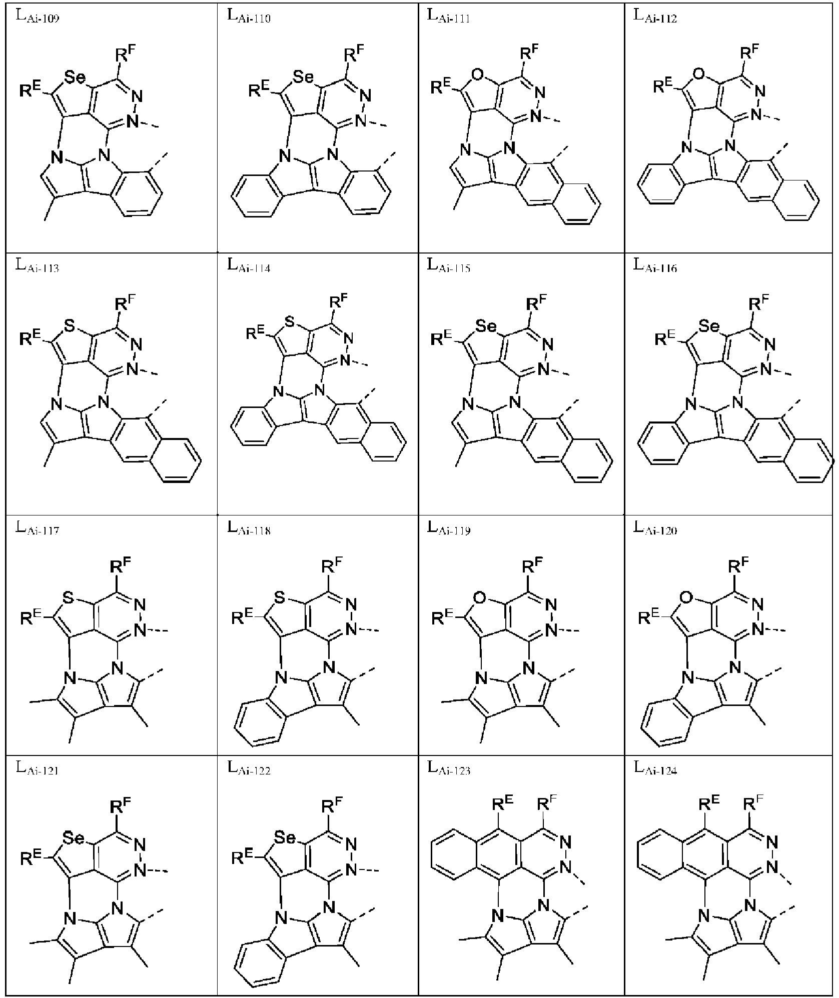 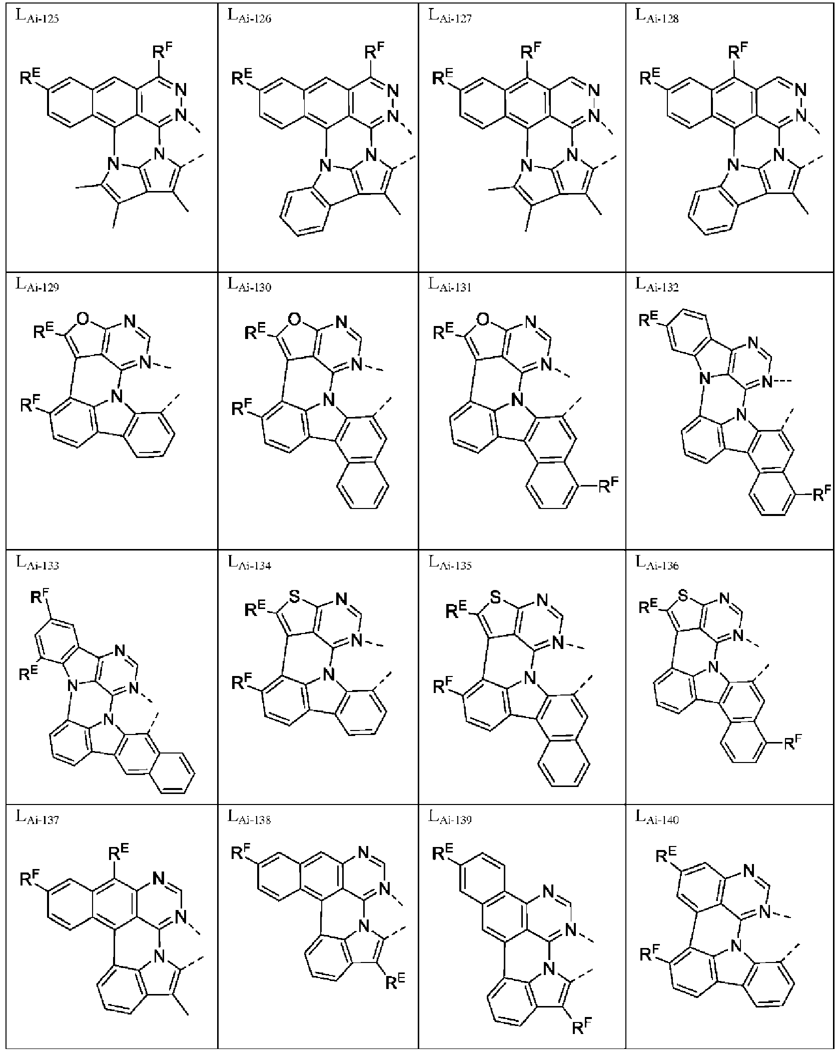 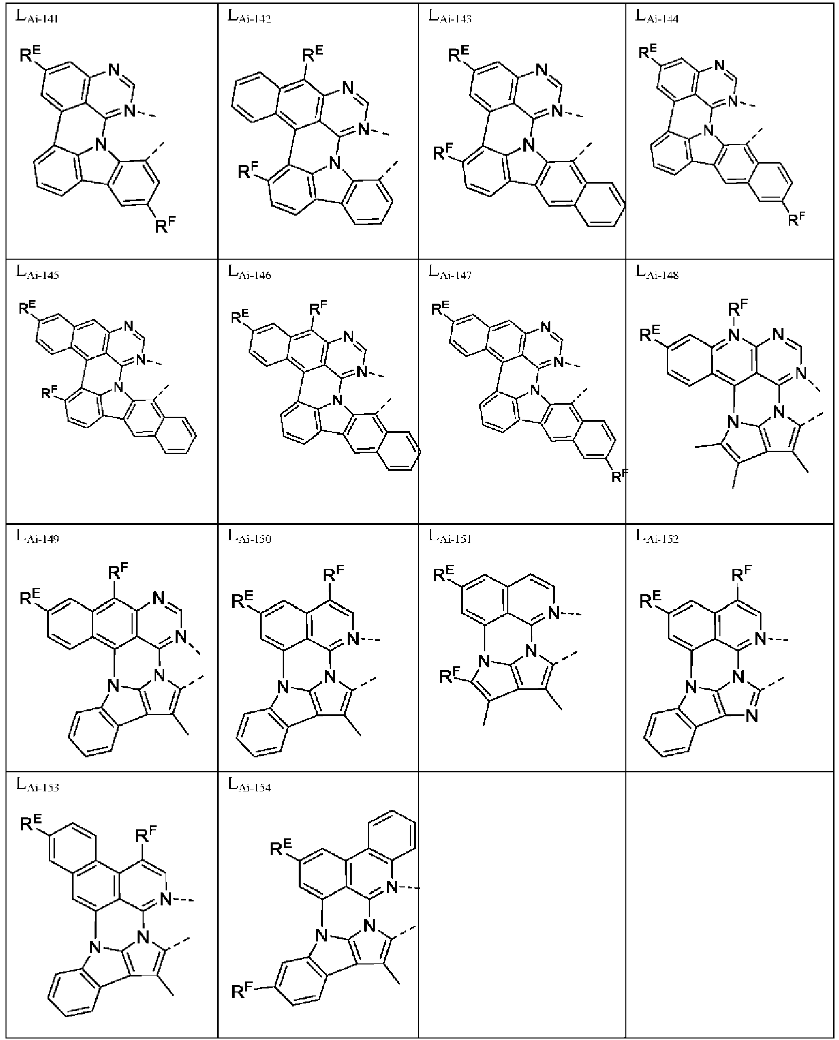 dans lequel, pour chaque i, R^{E} et R^{F} sont définis comme suit : 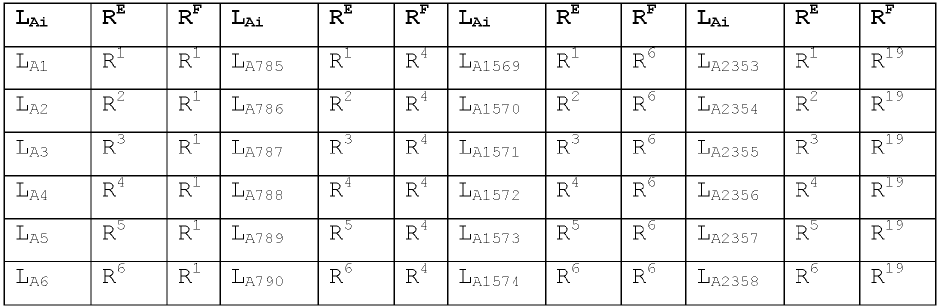 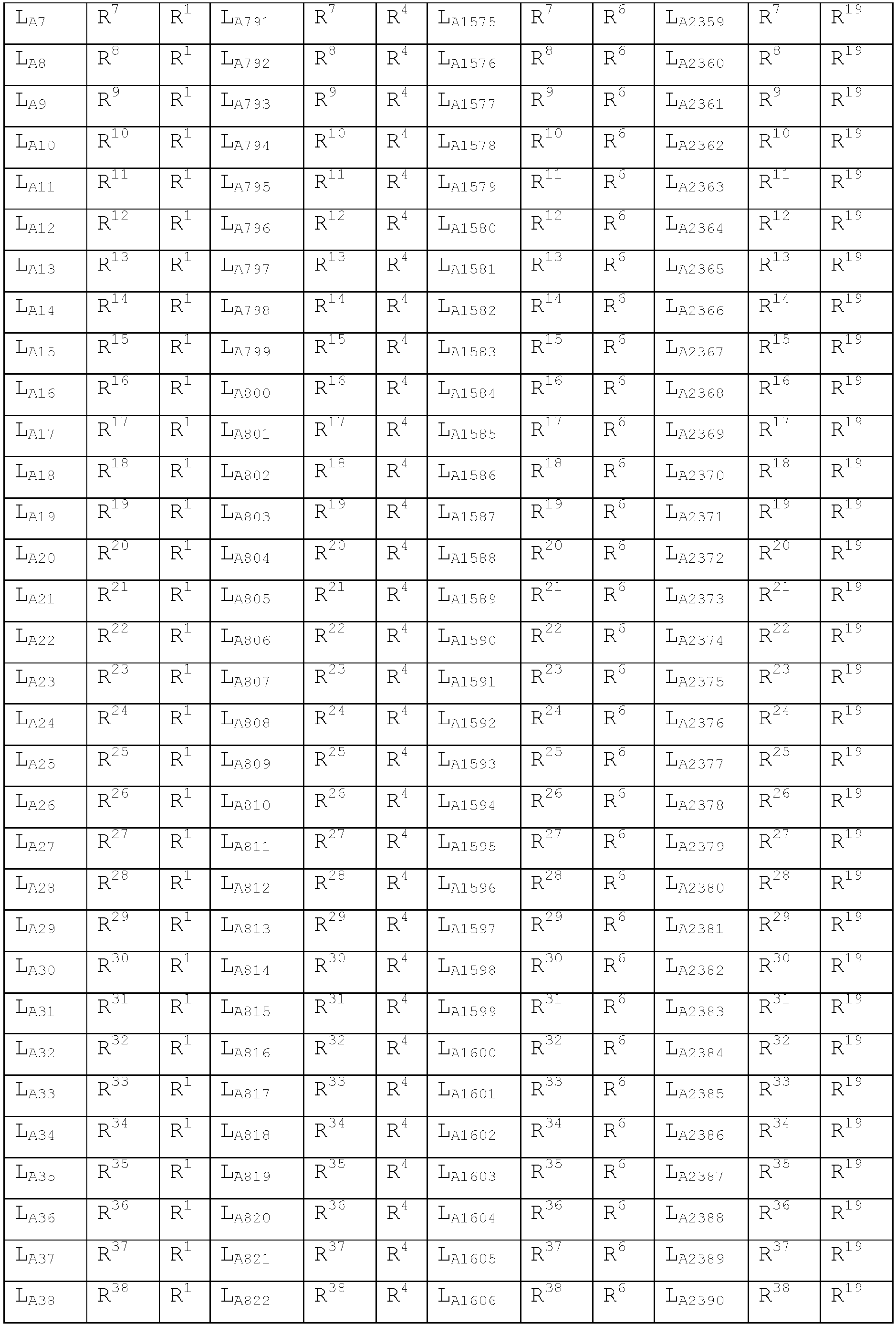 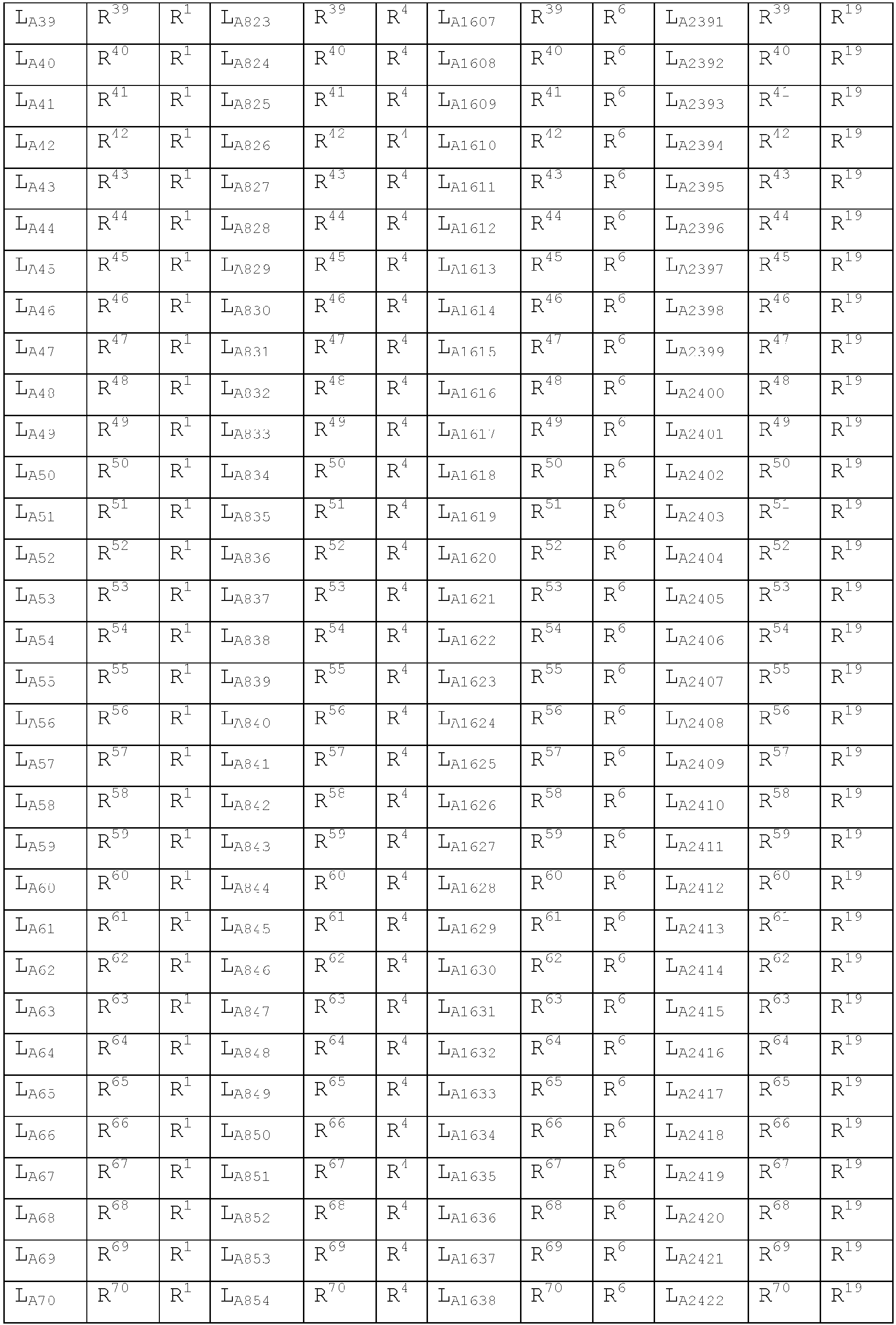 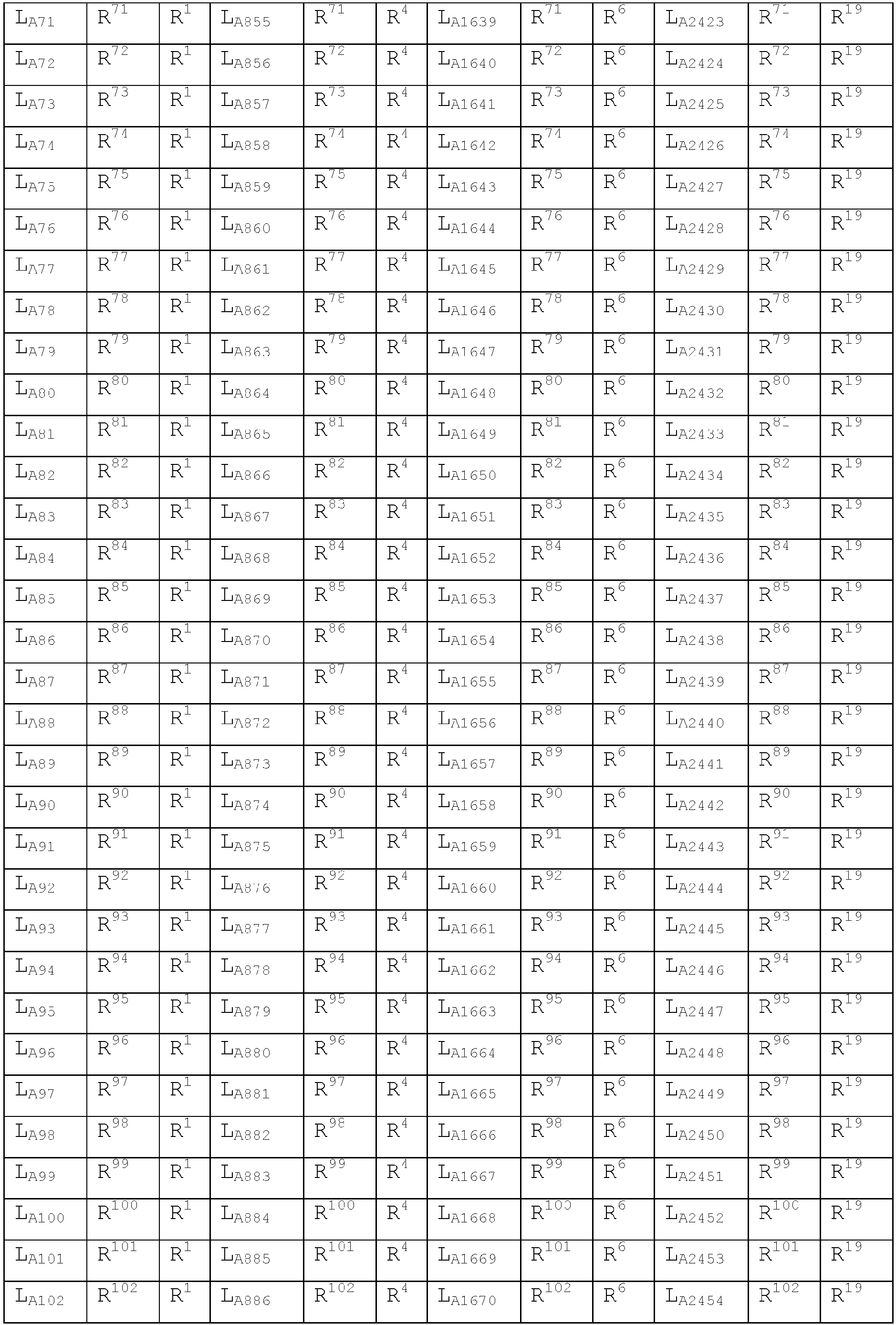 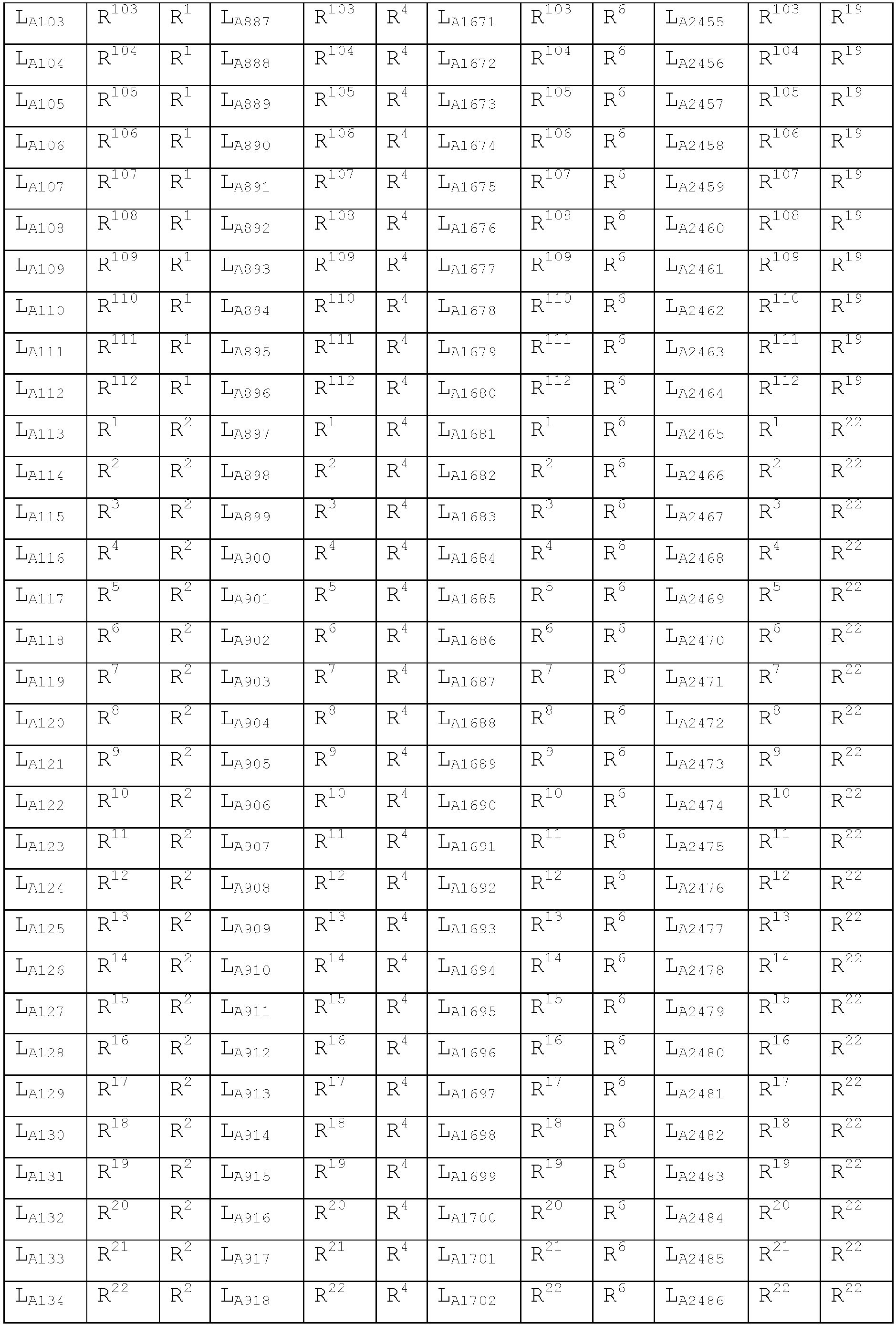 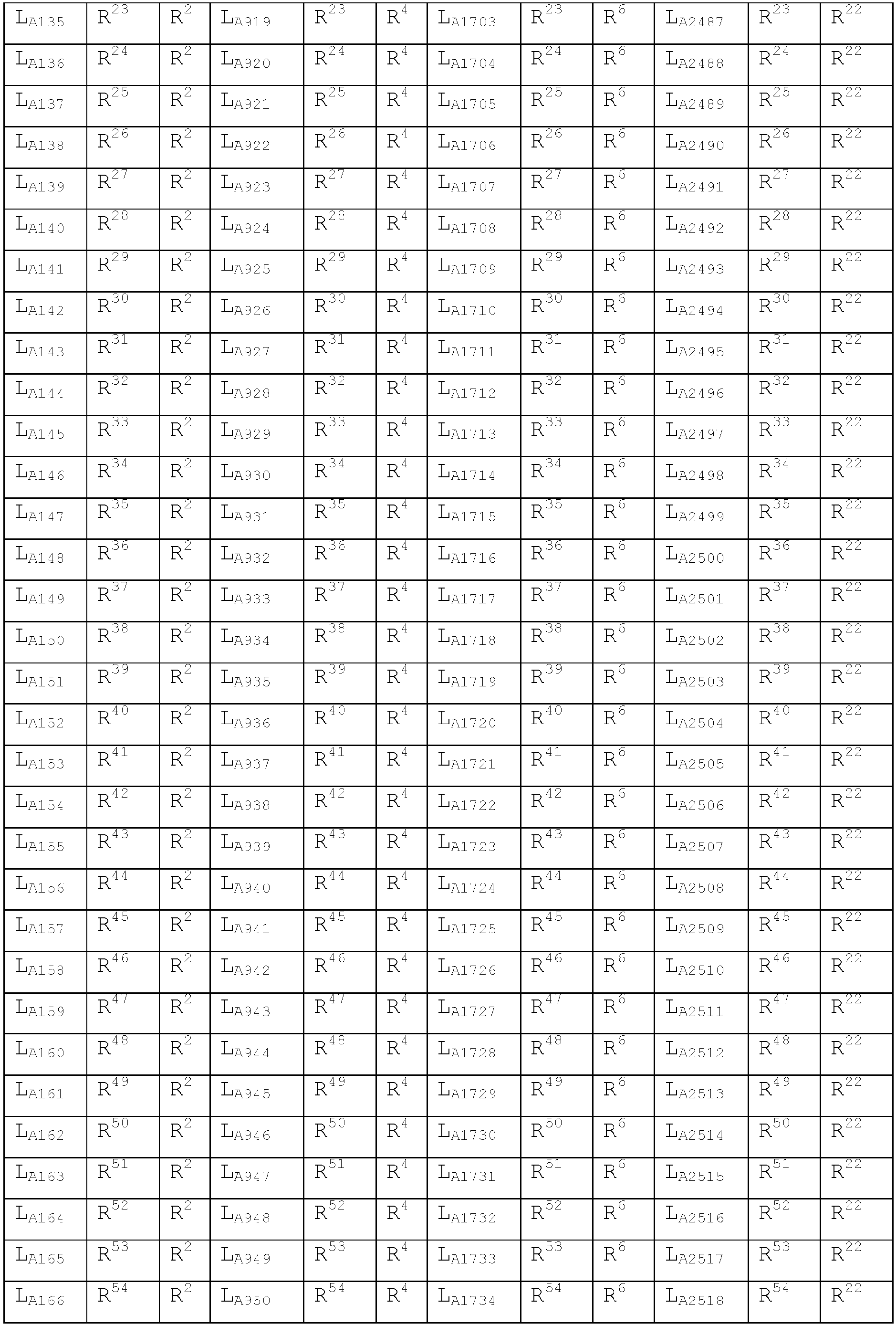 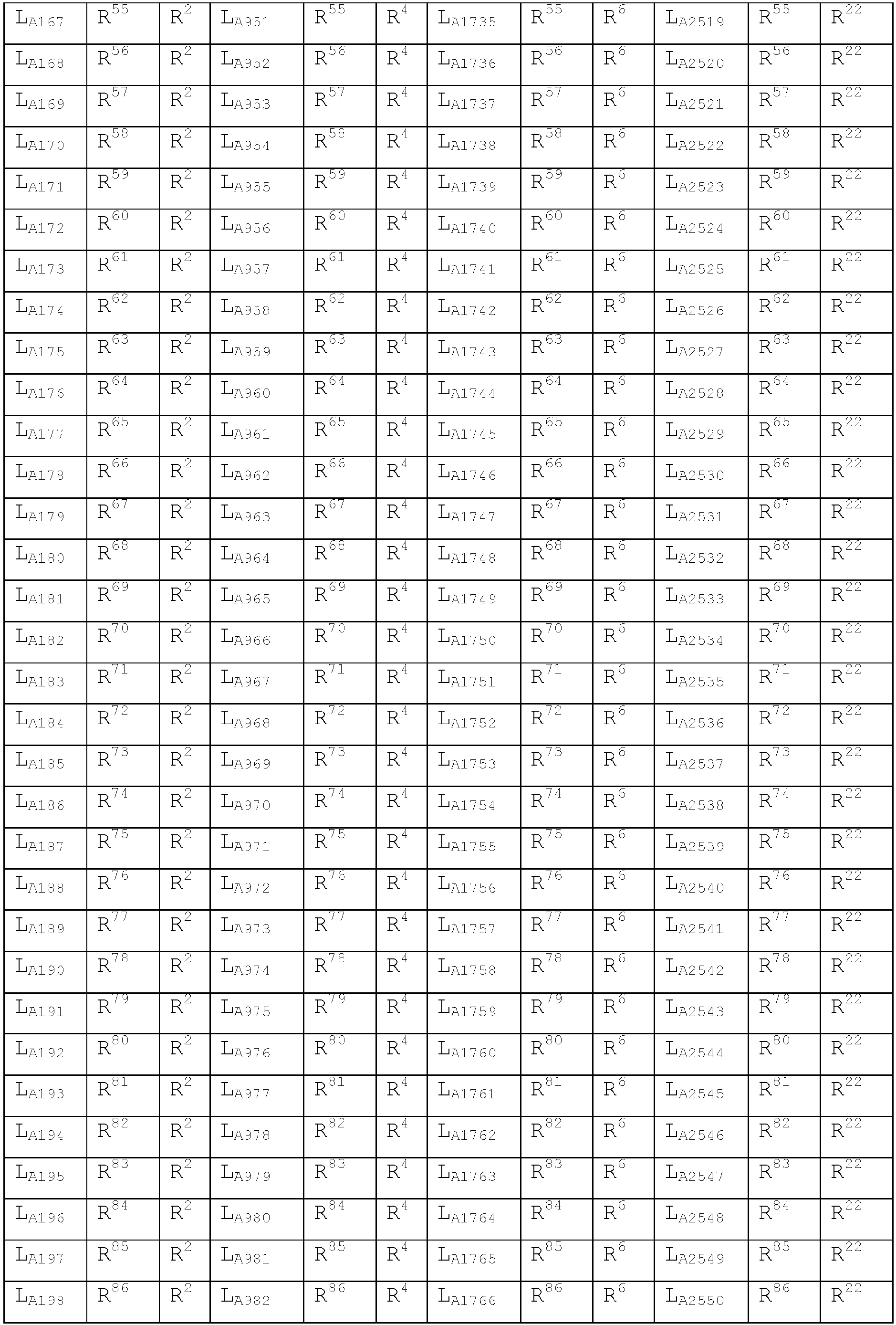 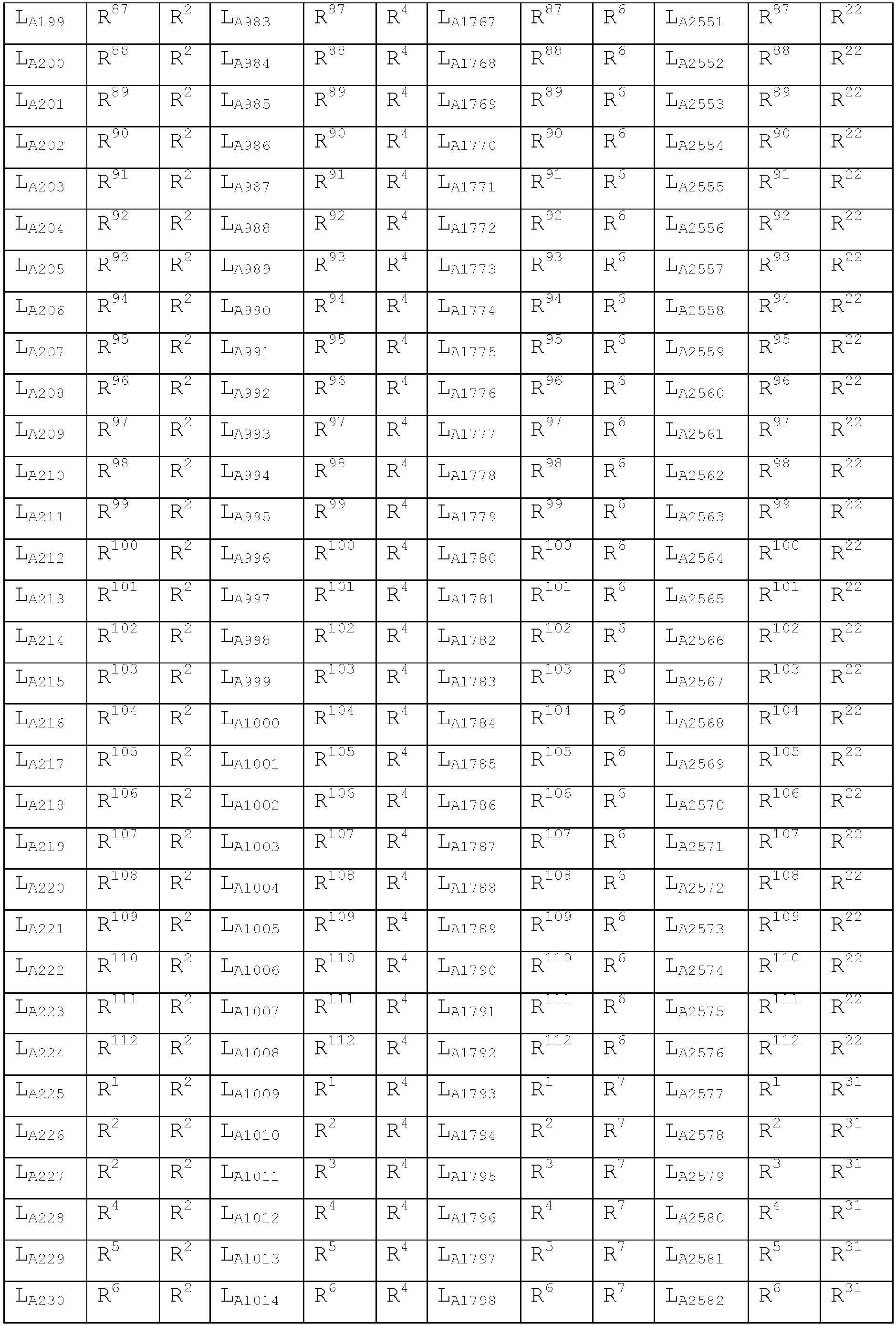 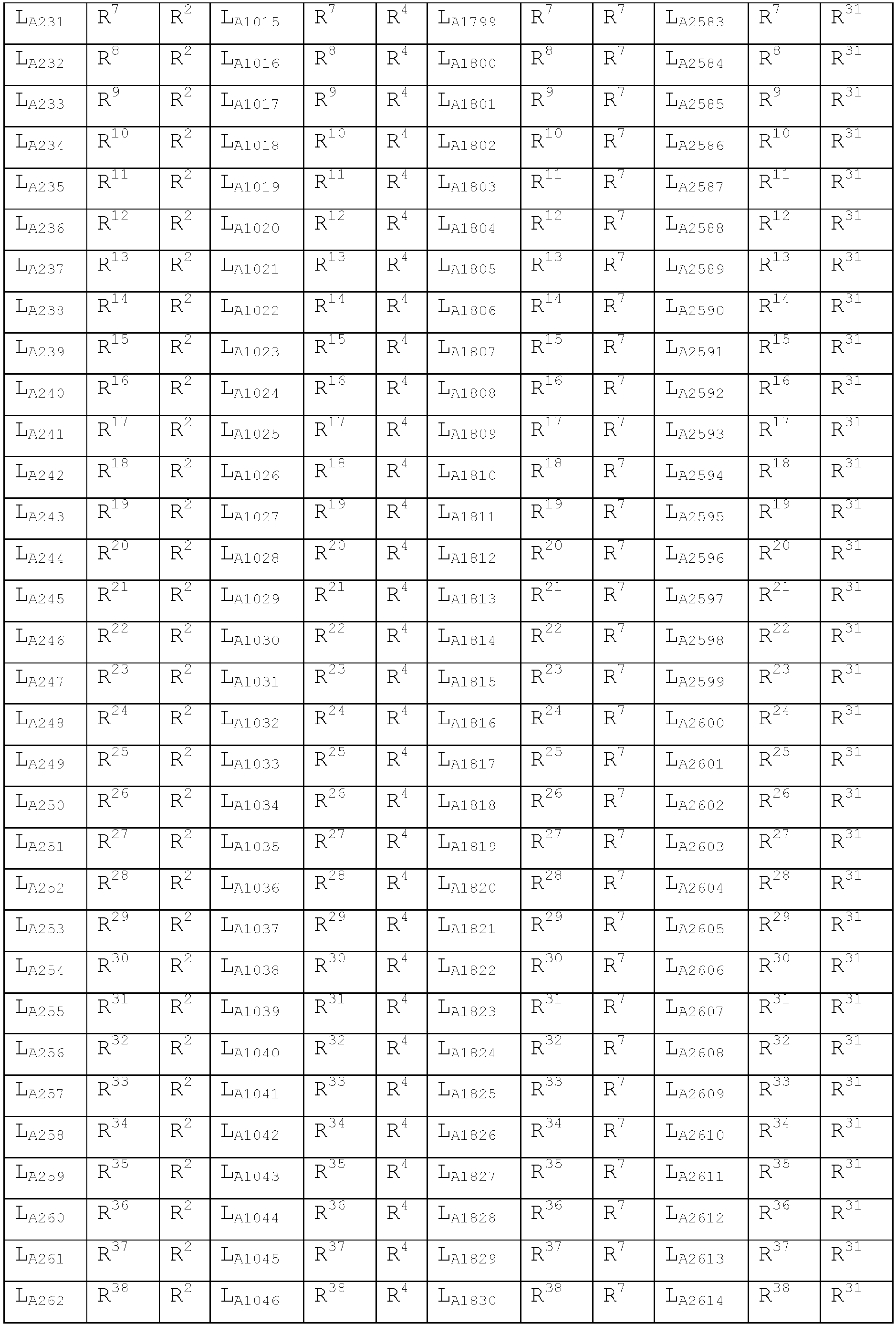 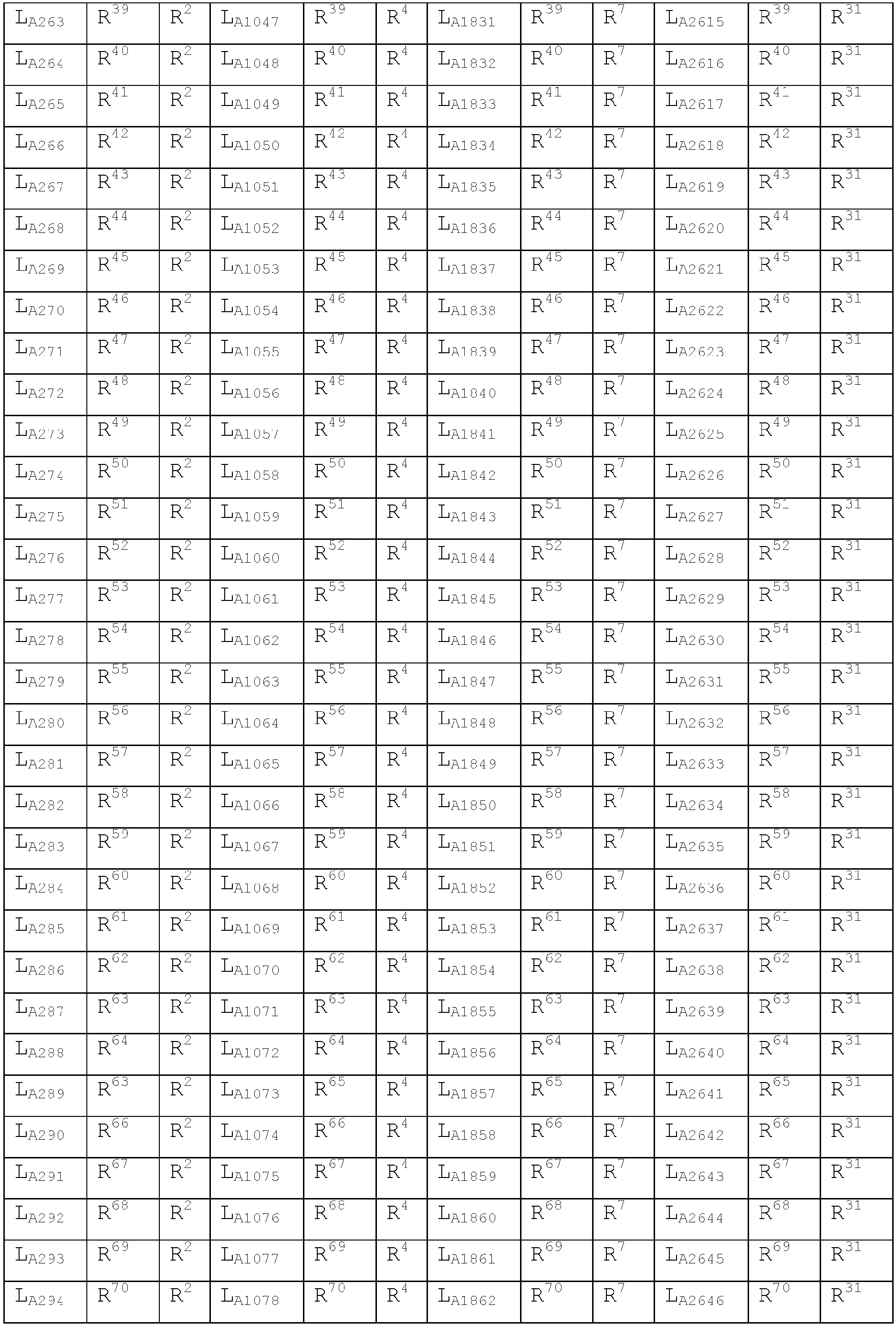 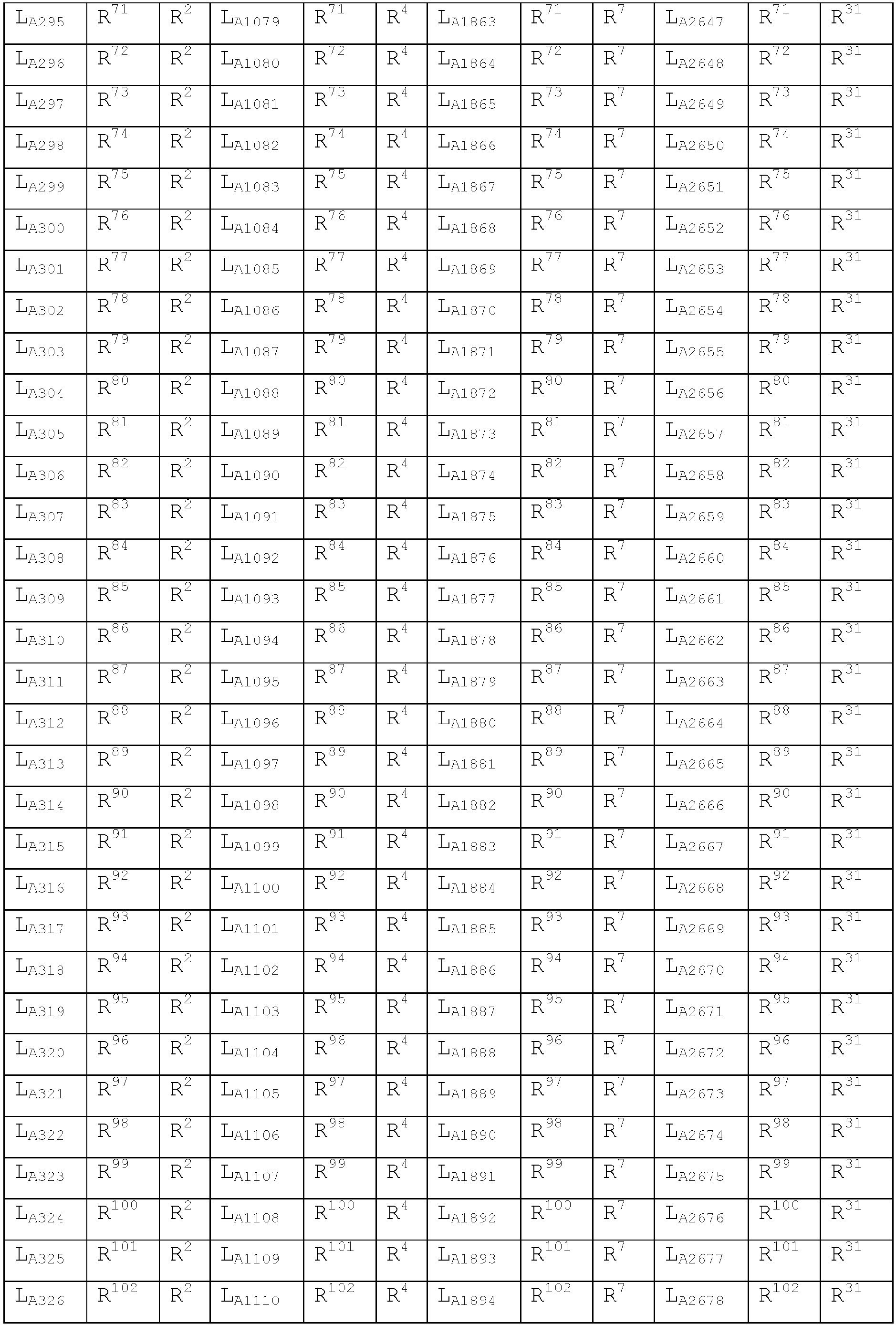 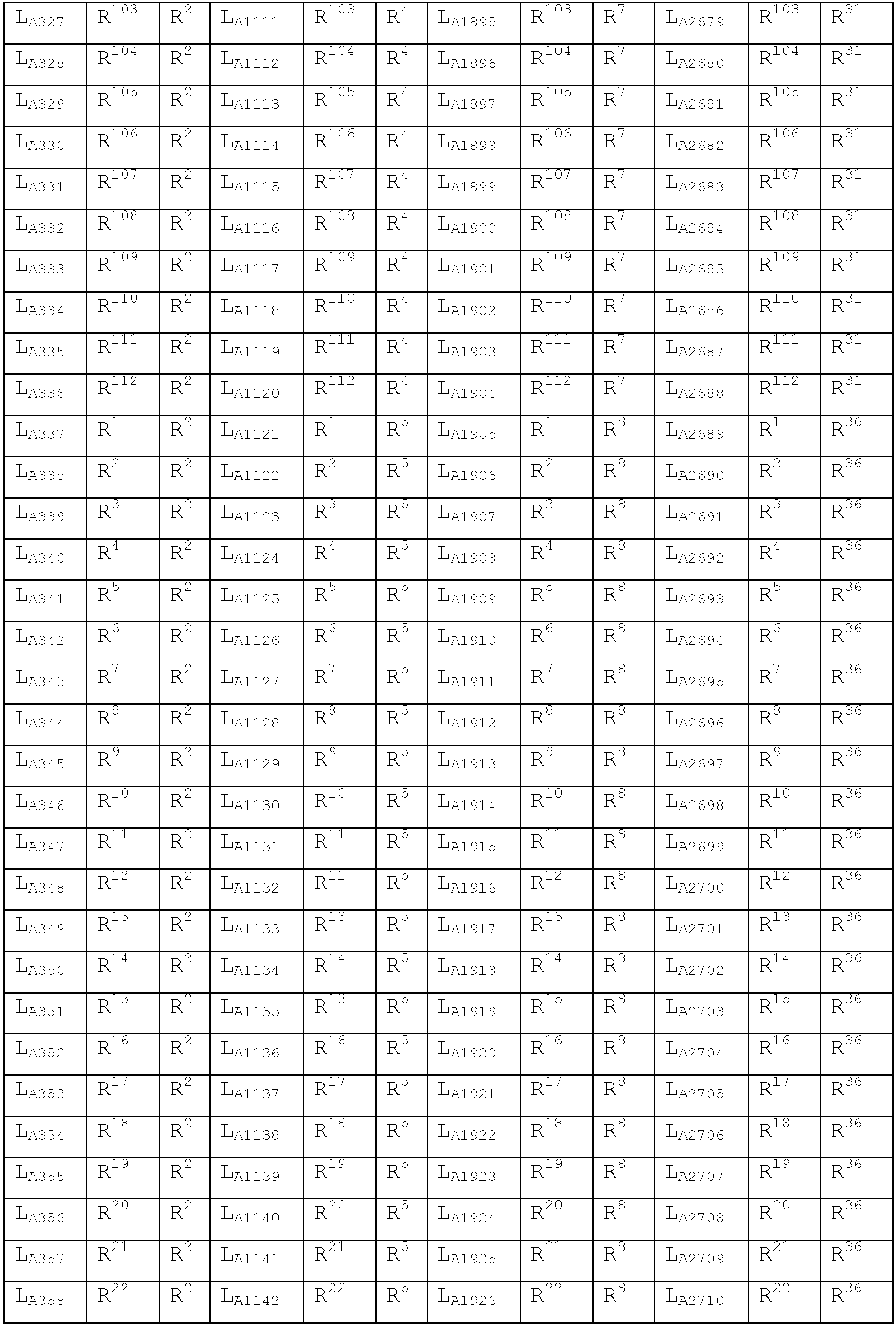 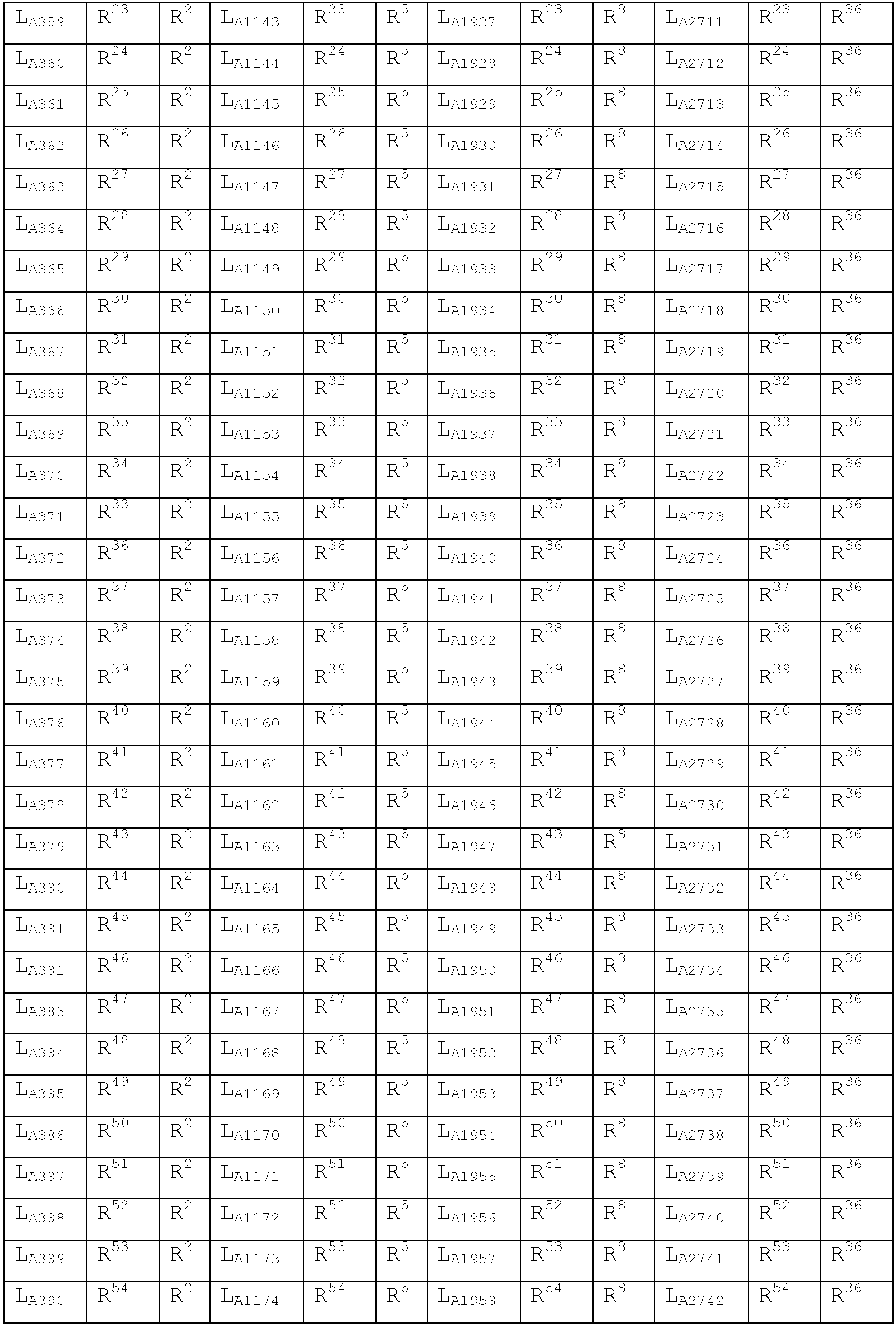 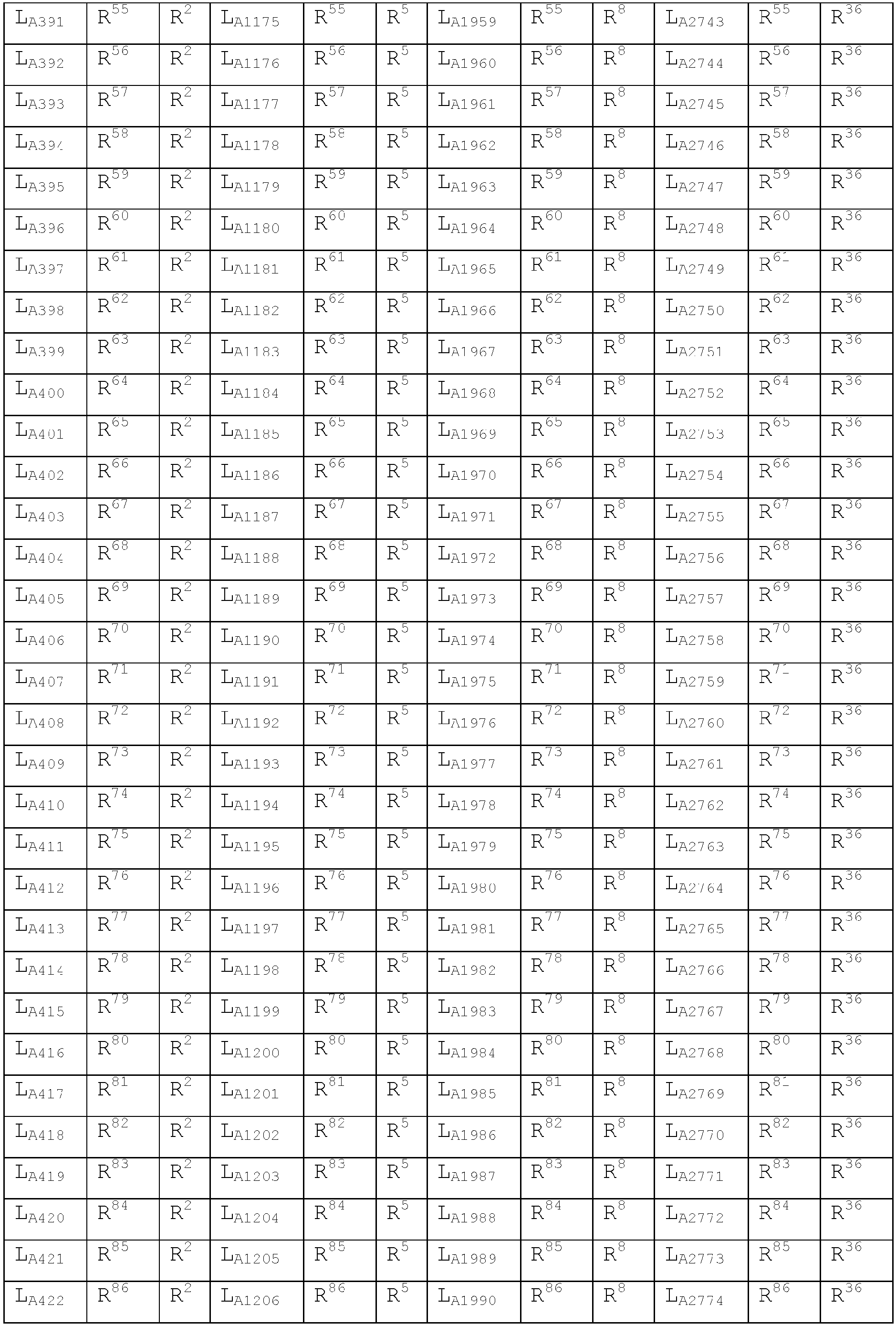 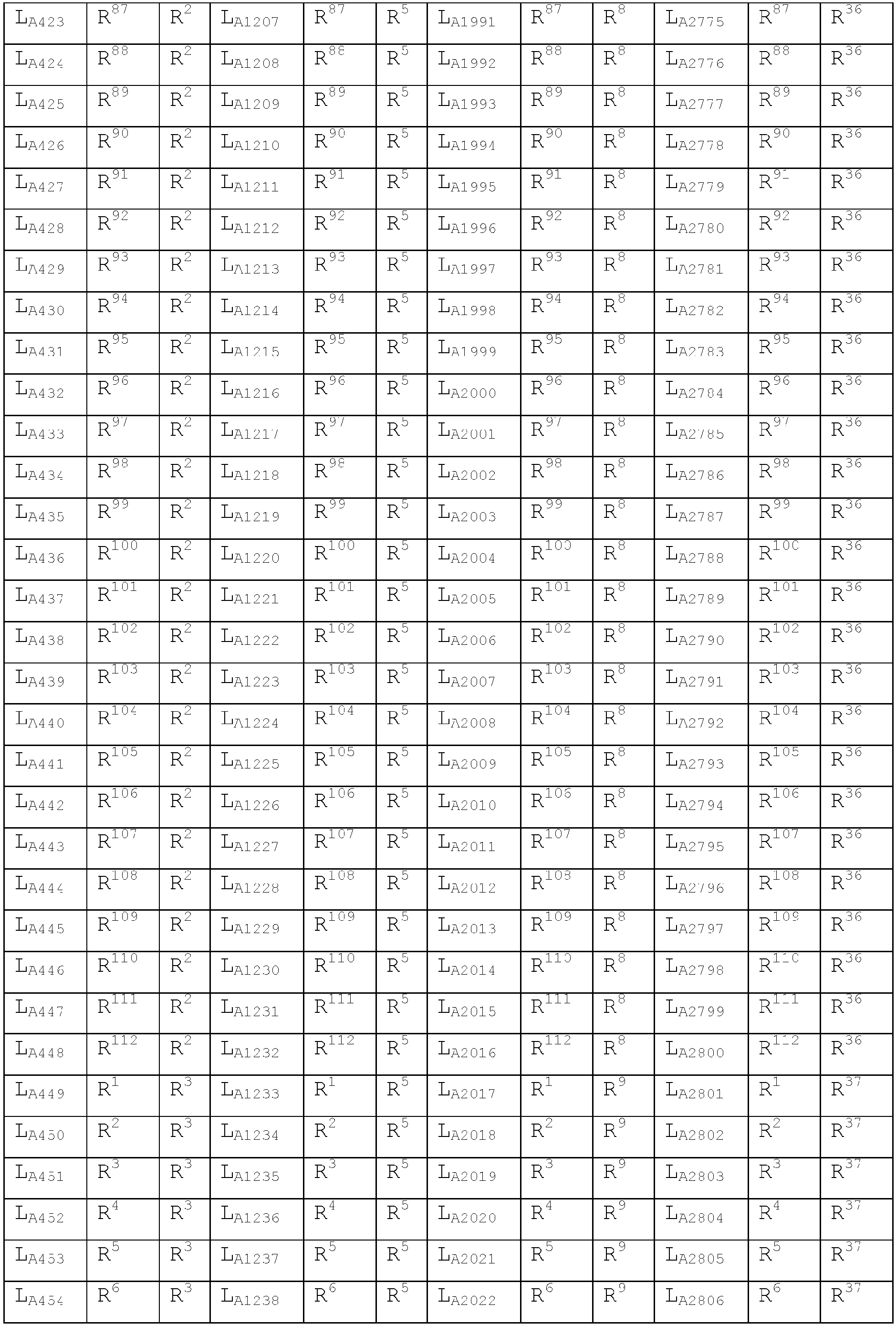 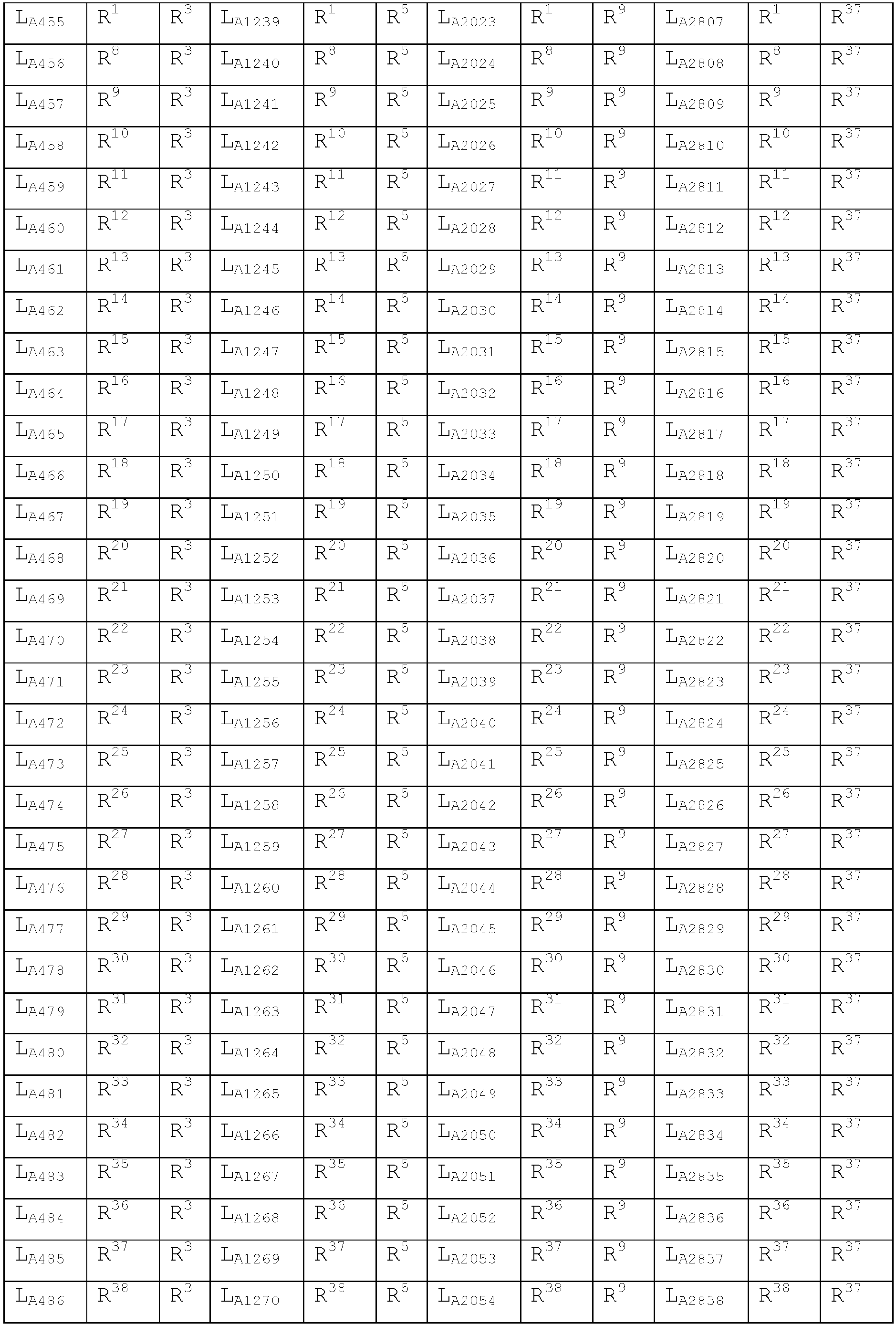 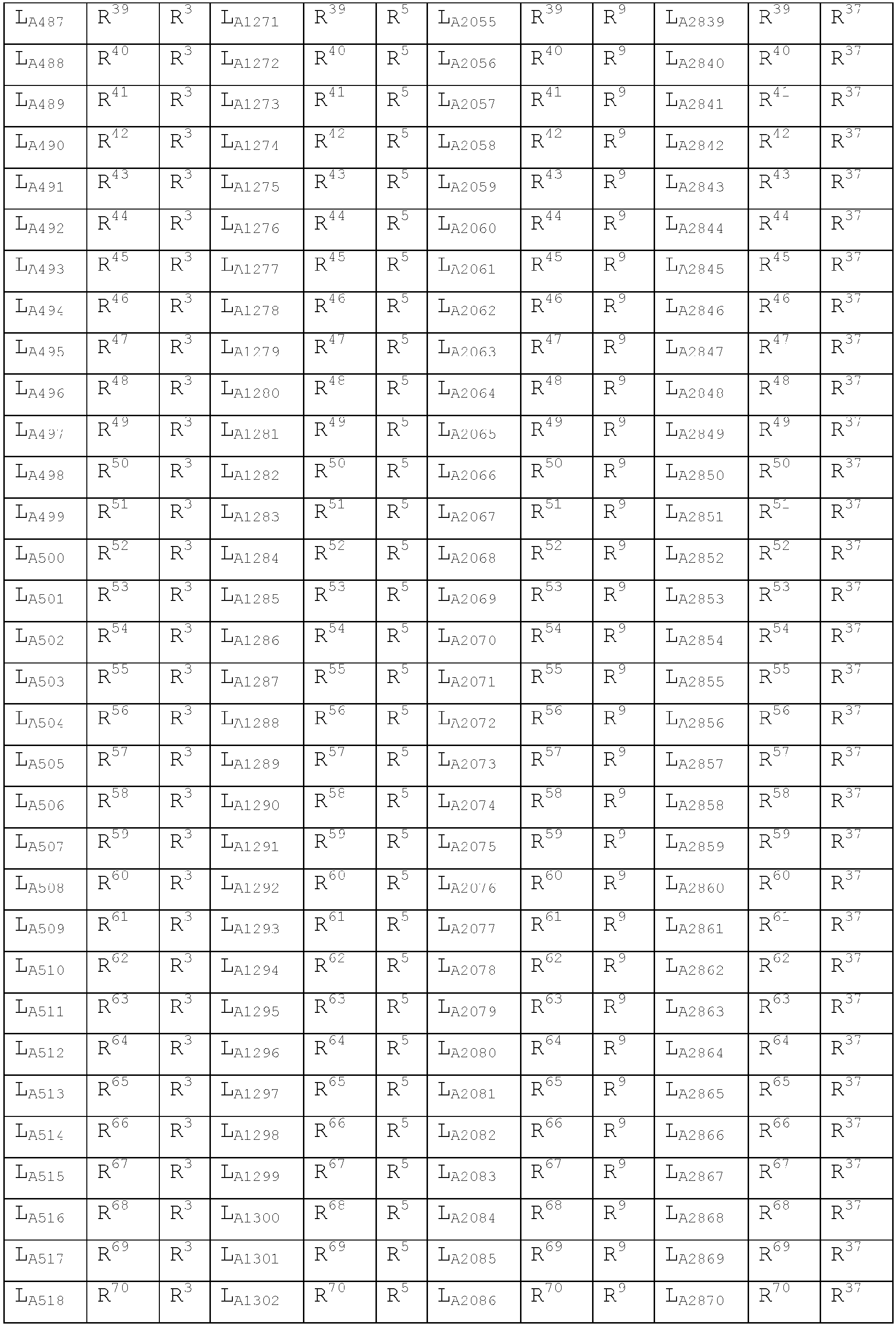 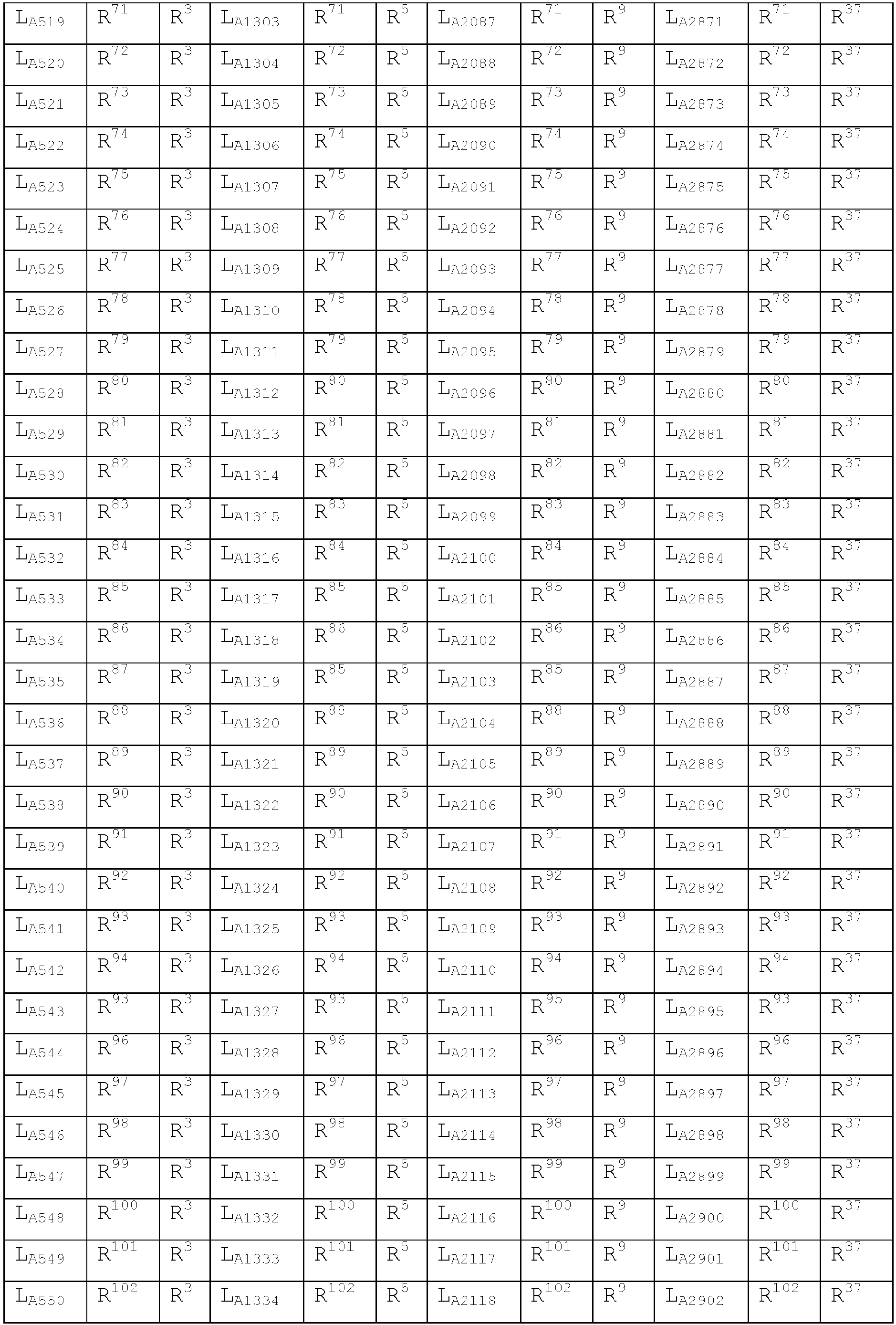 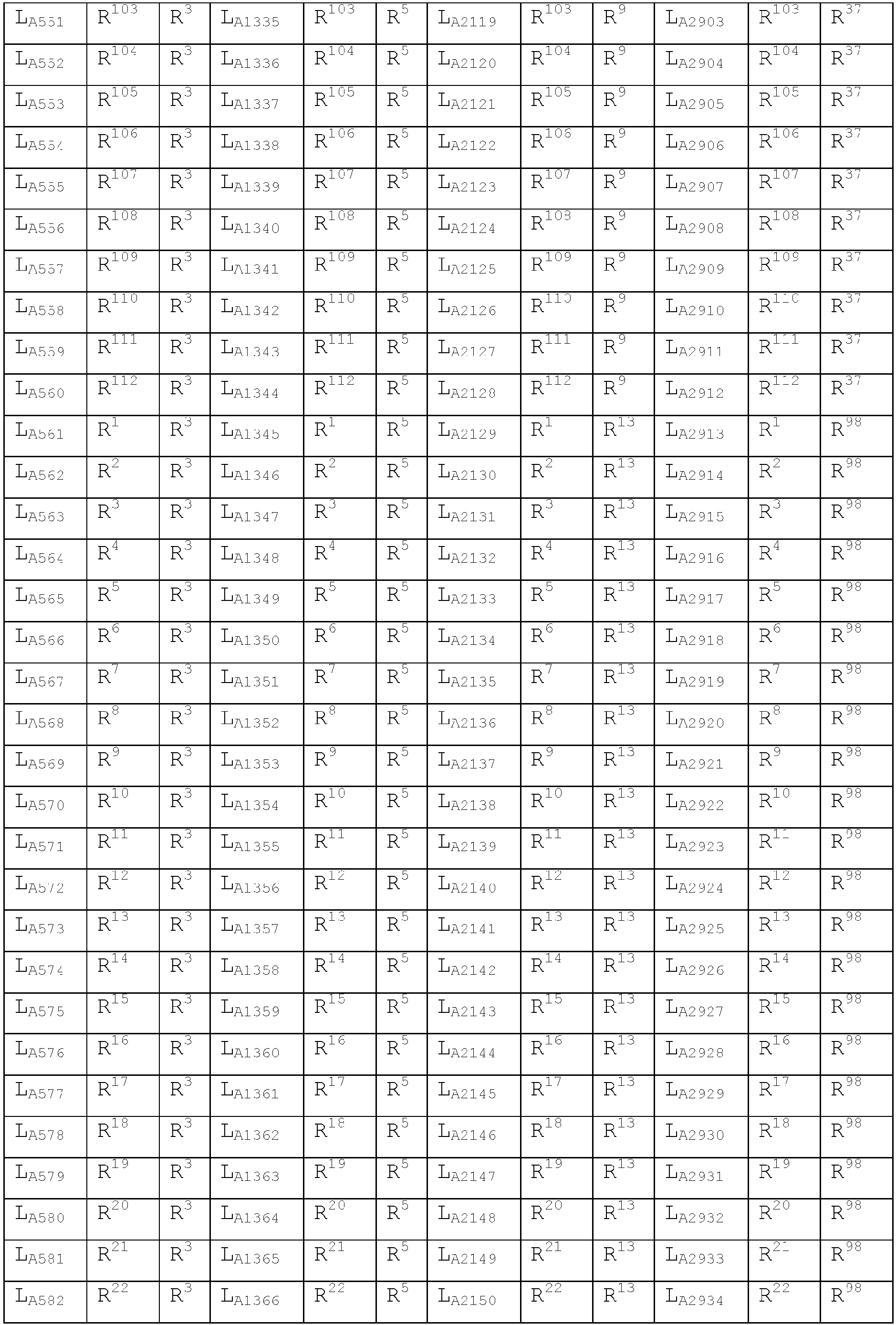 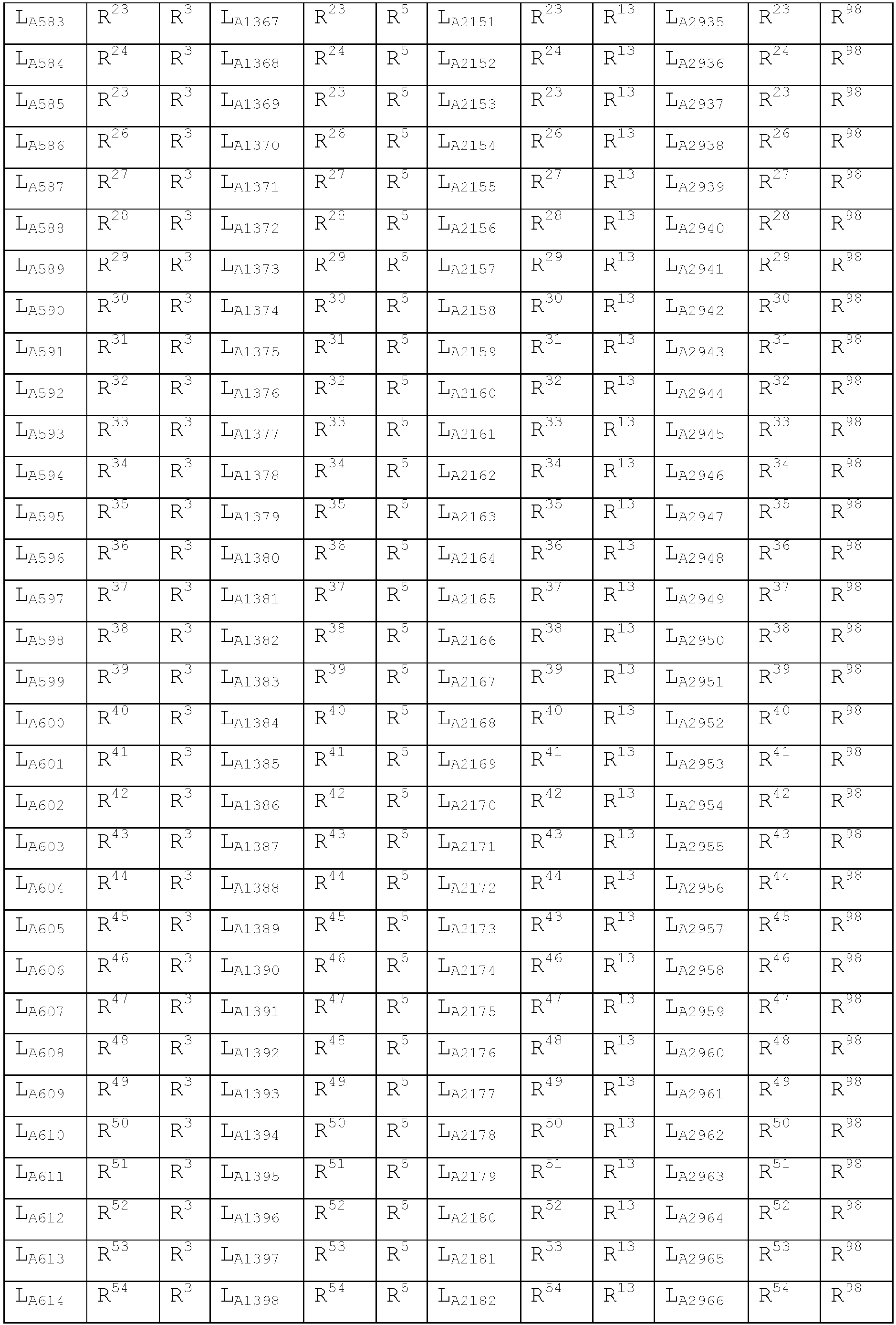 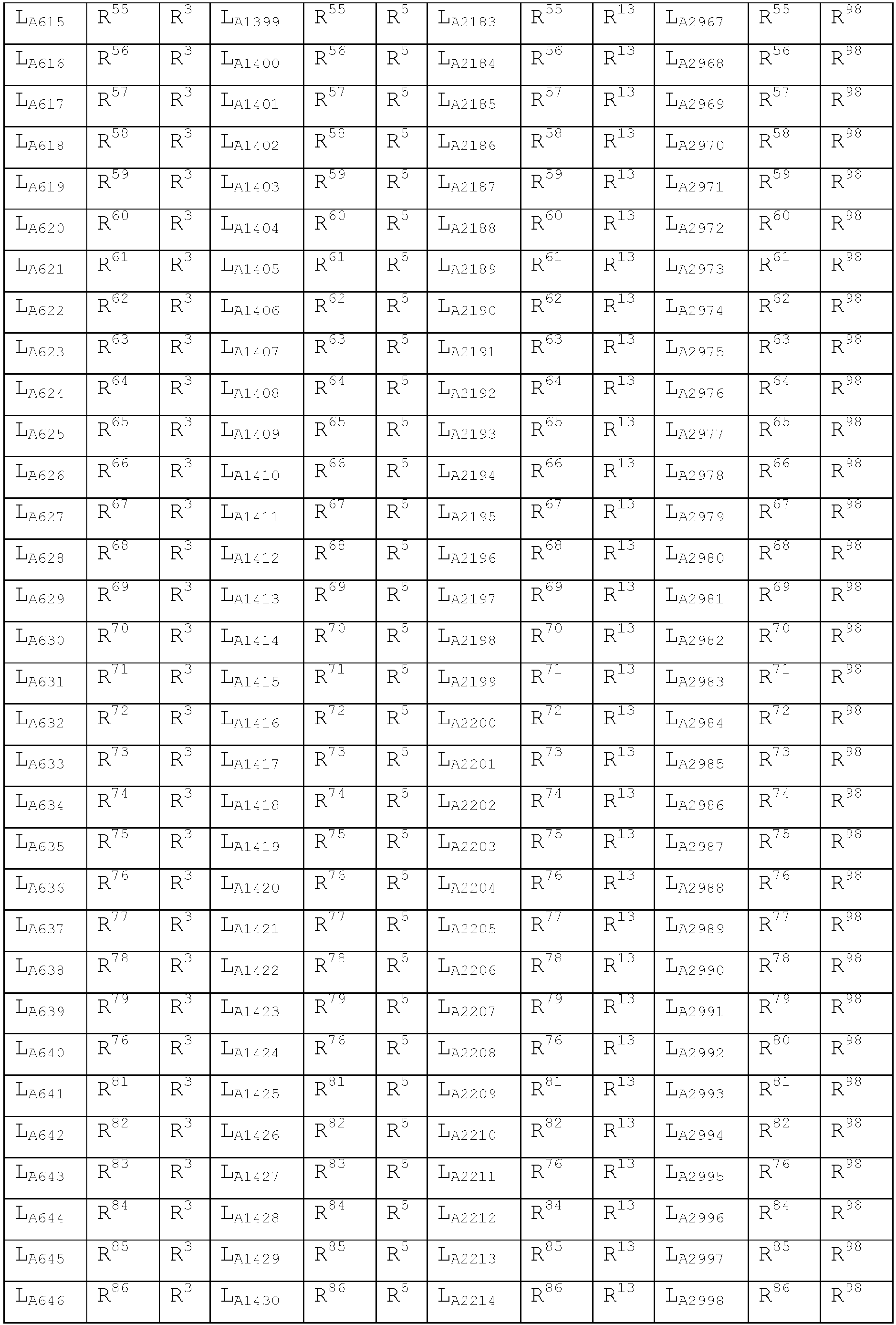 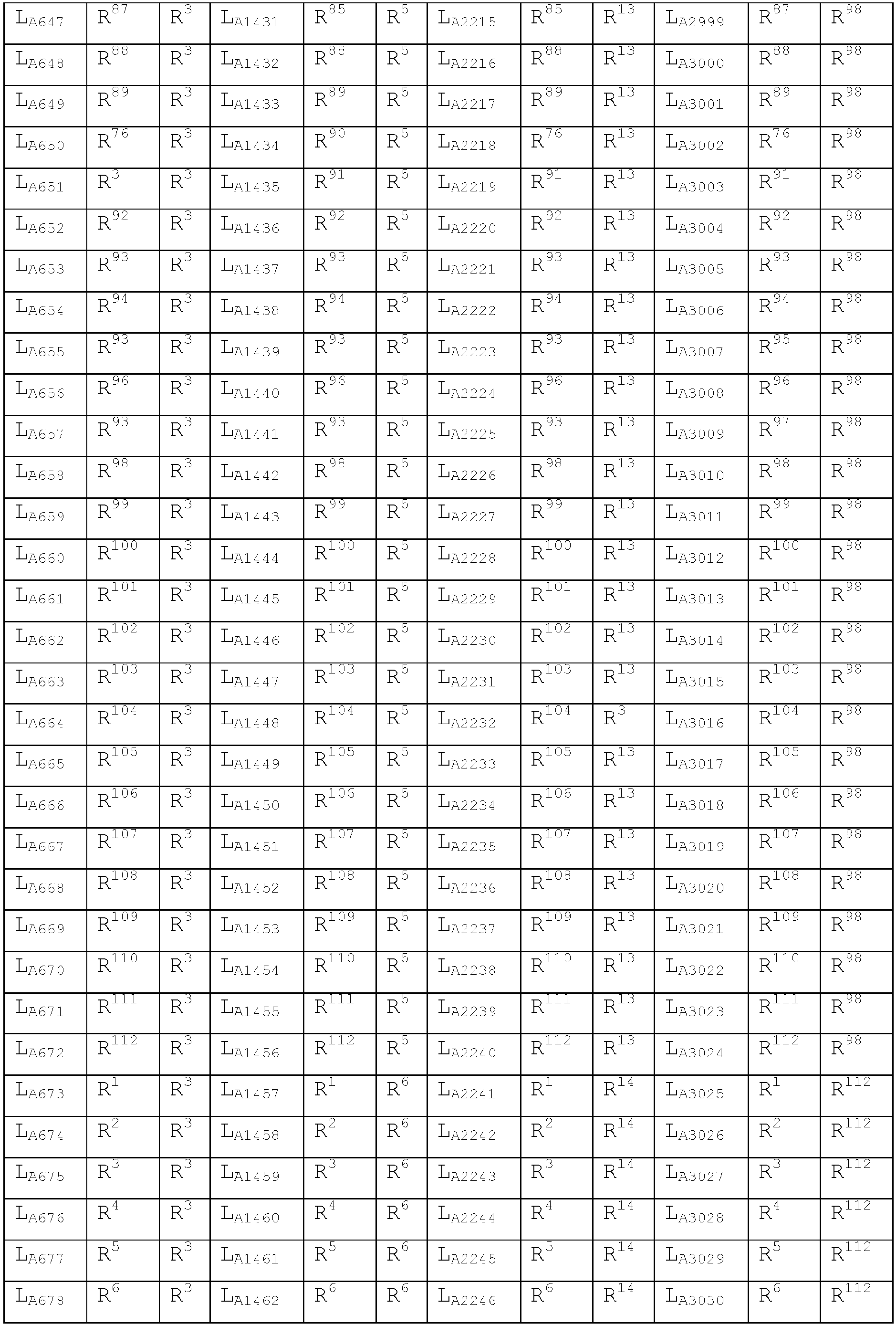 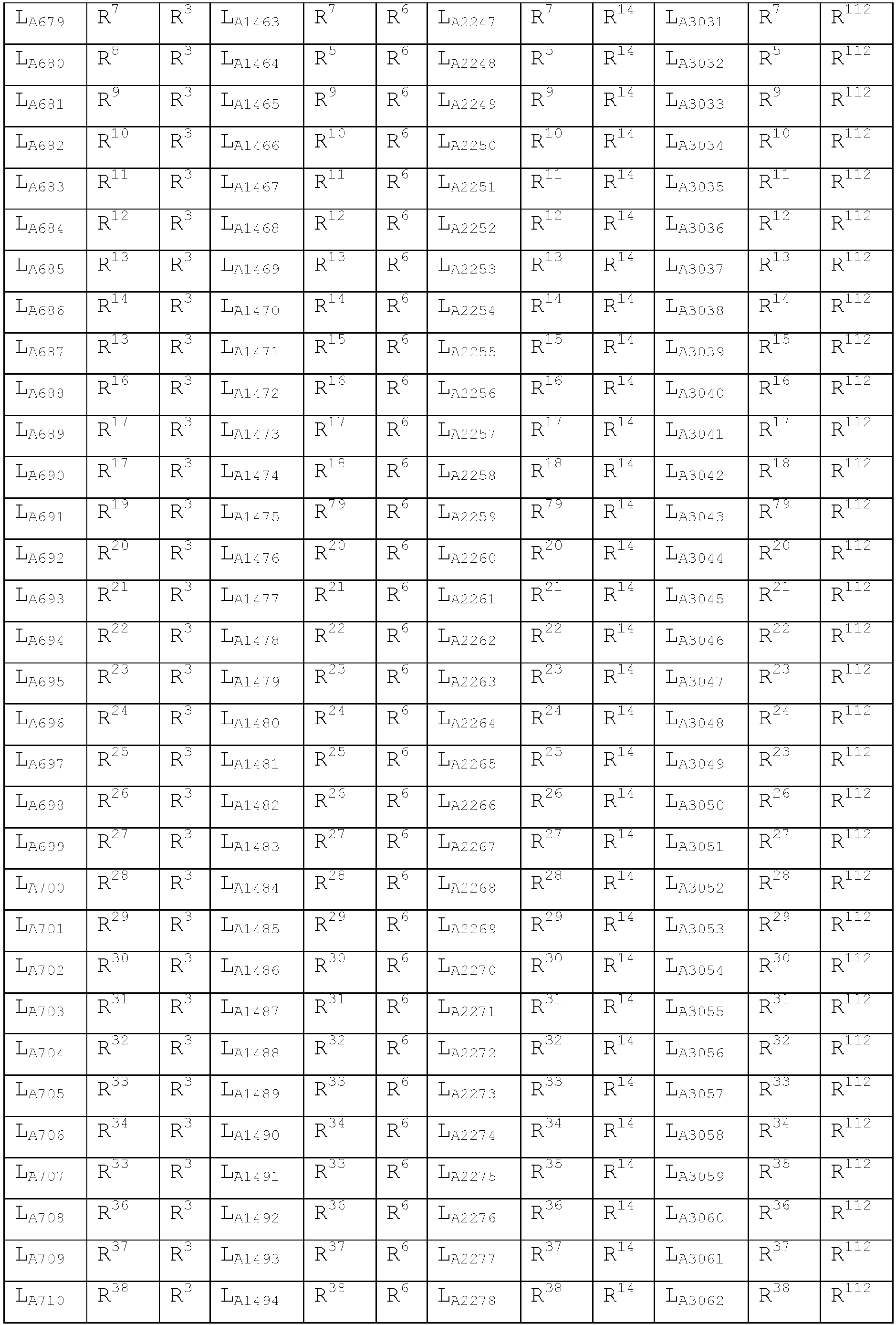 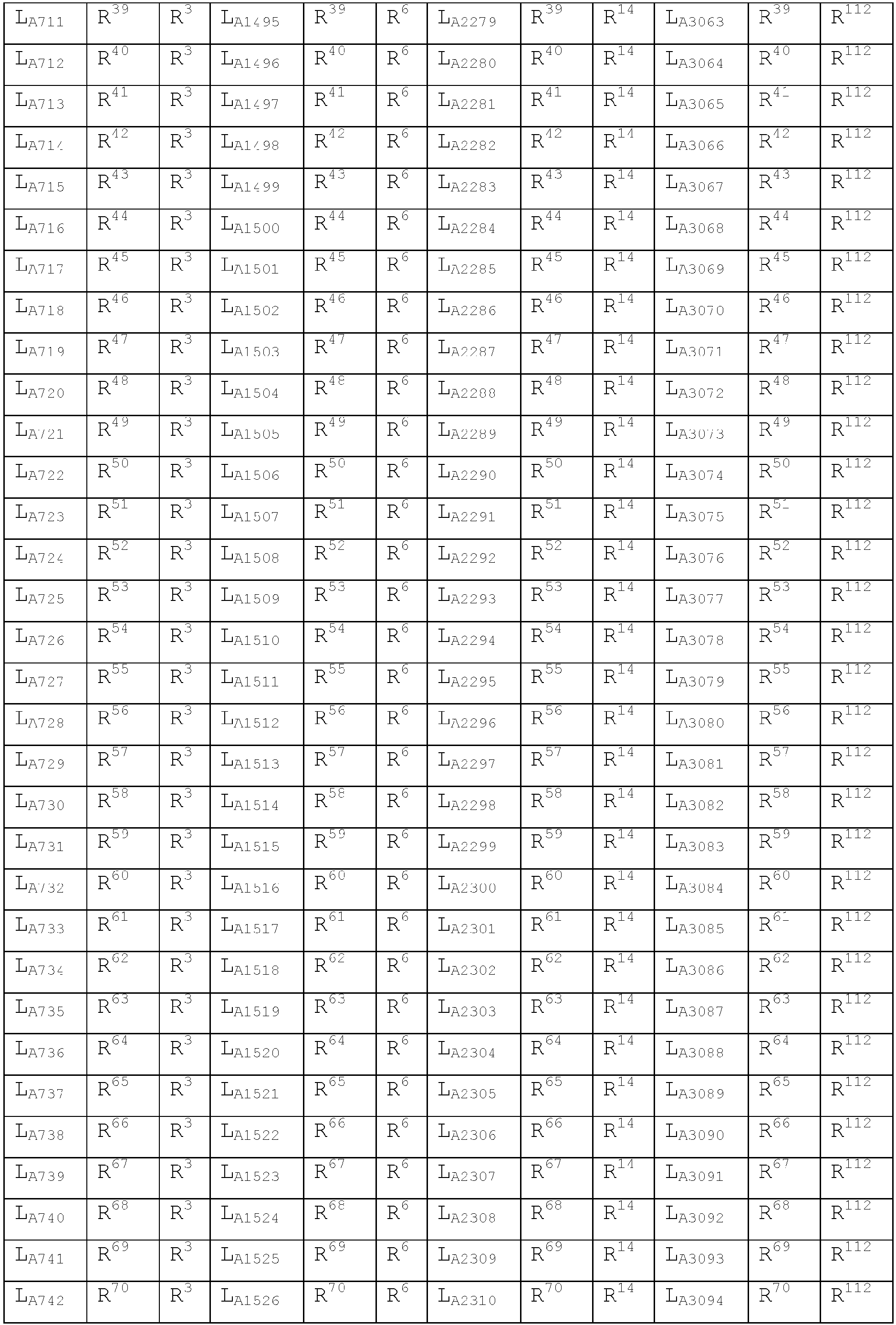 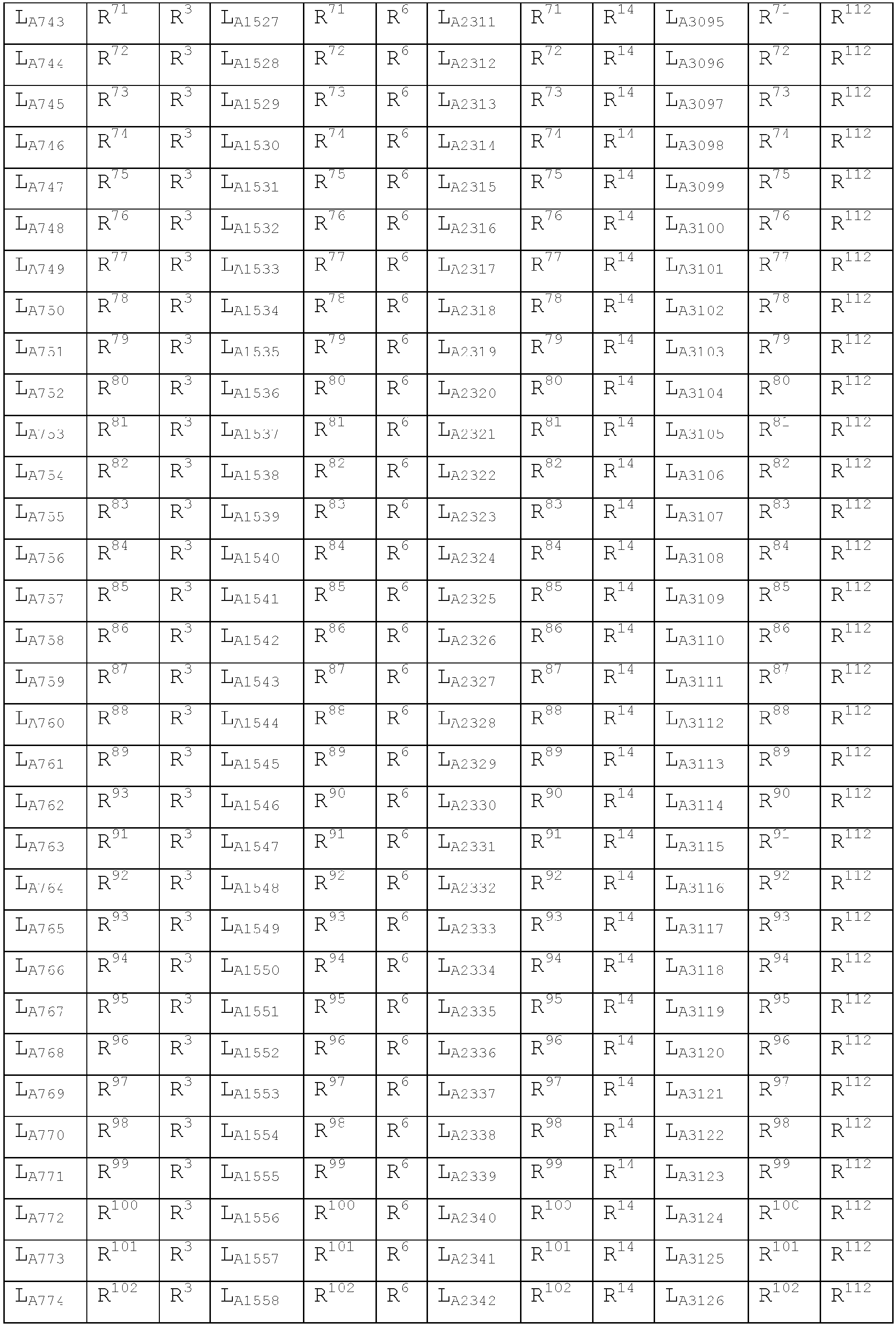 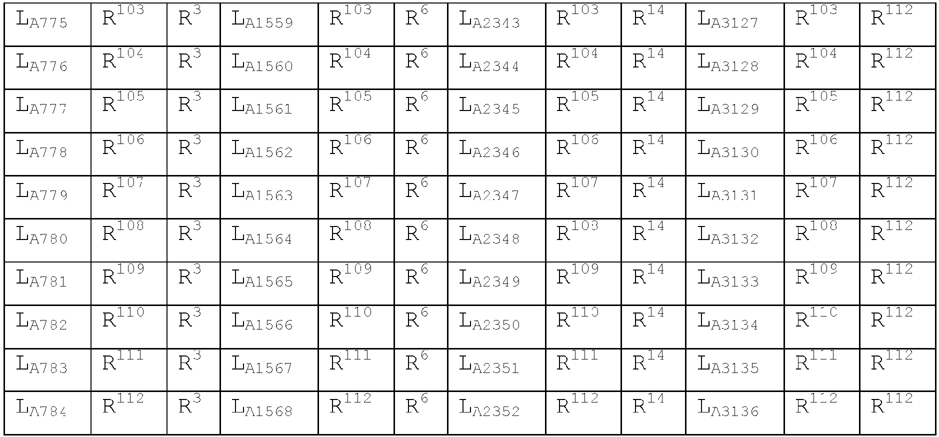 dans lequel R¹ à R¹¹² présentent les structures suivantes :

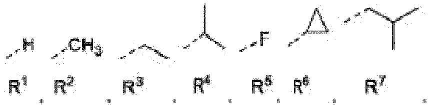

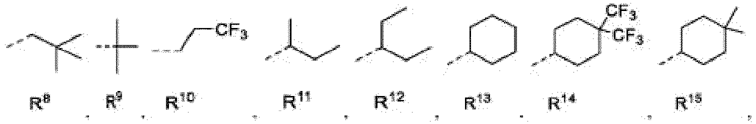

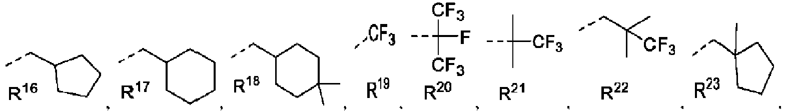

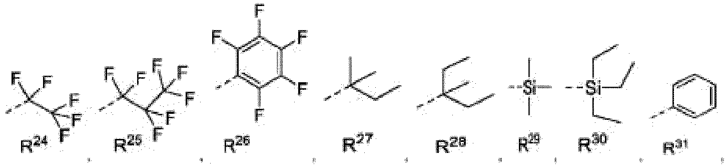

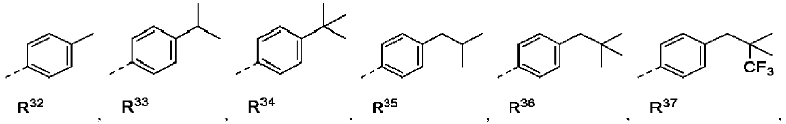

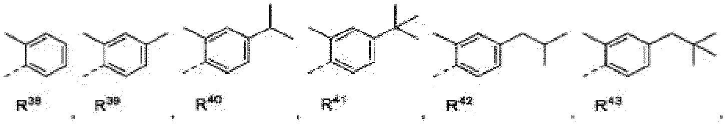

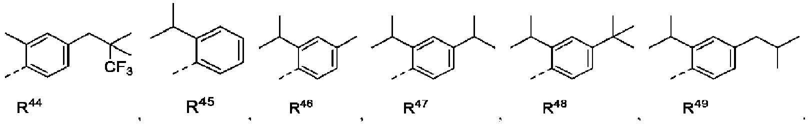

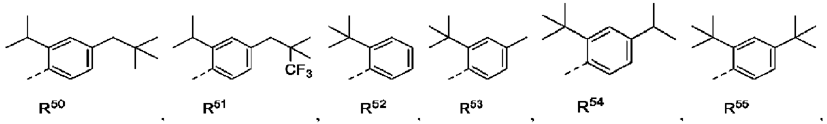

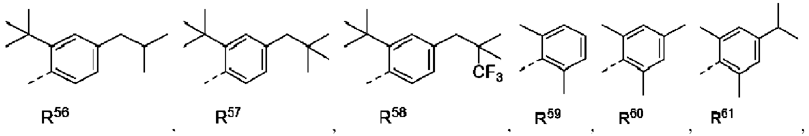

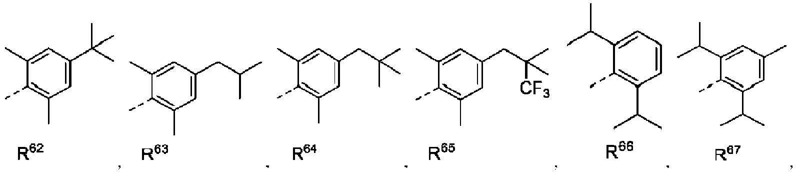

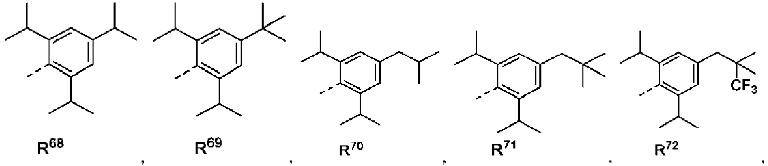

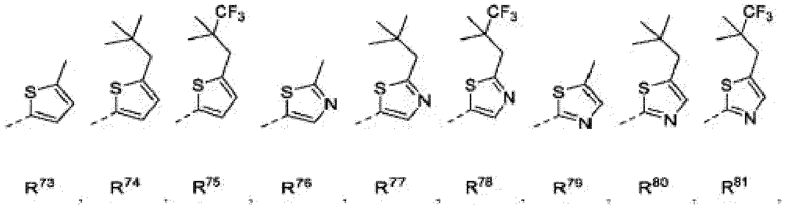

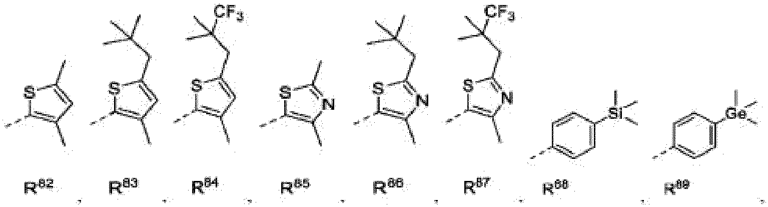

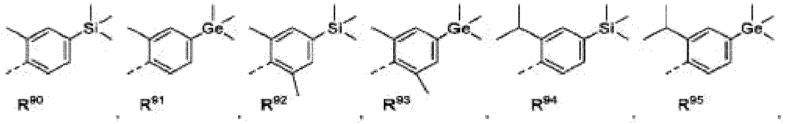

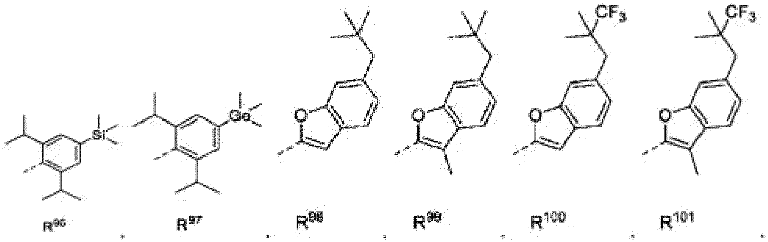

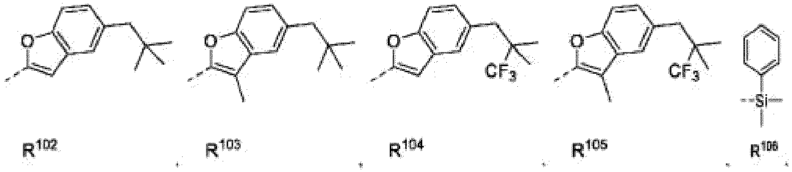

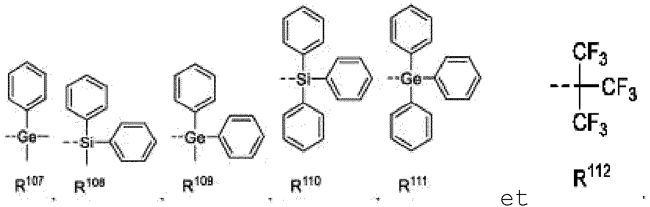

8. Composé selon la revendication 1, dans lequel le composé présente une formule de M(L_{A})ₚ(L_{B})_{q}(L_{C})ᵣ, dans lequel L_{B} et L_{C} sont chacun un ligand bidenté ; et dans lequel p est 1, 2 ou 3 ; q est 0, 1 ou 2 ; r est 0, 1 ou 2 ; et p+q+r est l'état d'oxydation du métal M.

9. Composé selon la revendication 8, dans lequel le composé présente une formule sélectionnée dans le groupe consistant en Ir(L_{A})₃, Ir(L_{A})(L_{B})₂, Ir(L_{A})₂(L_{B}), Ir(L_{A})₂(L_{C}) et Ir(L_{A})(L_{B})(L_{C}) ; et dans lequel L_{A}, L_{B} et L_{C} sont différents les uns des autres ; ou une formule de Pt(L_{A})(L_{B}); et dans lequel L_{A} et L_{B} peuvent être identiques ou différents.

10. Composé selon la revendication 8, dans lequel L_{B} et L_{C} sont chacun indépendamment sélectionnés dans le groupe consistant en : 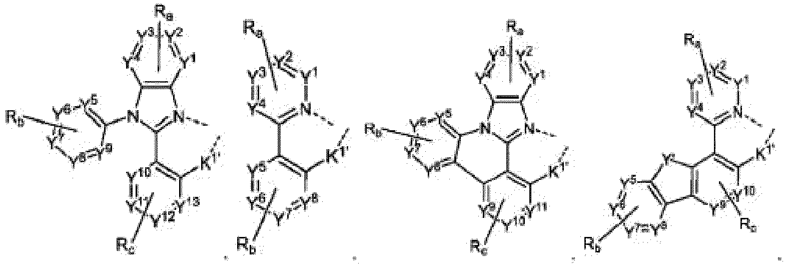 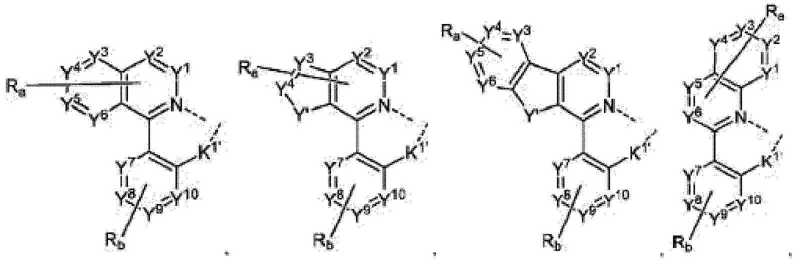 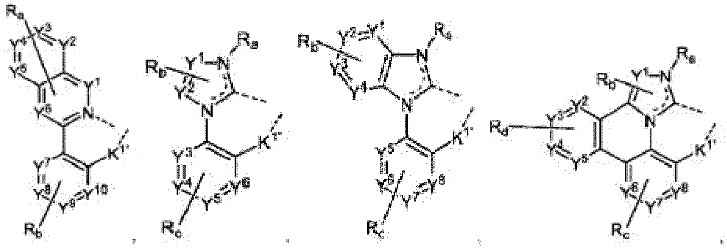 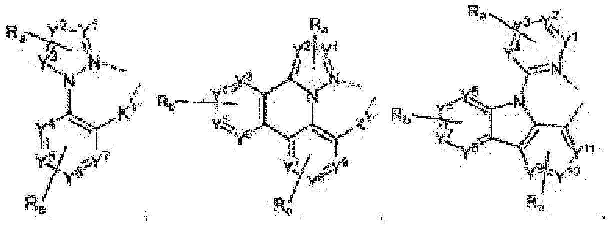 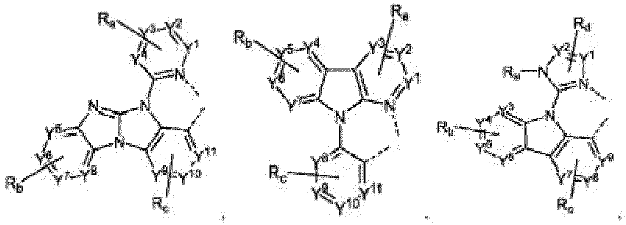 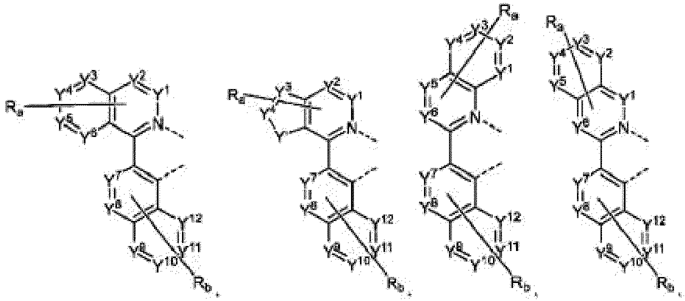 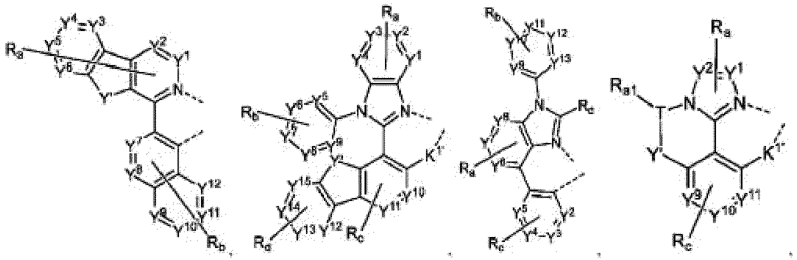 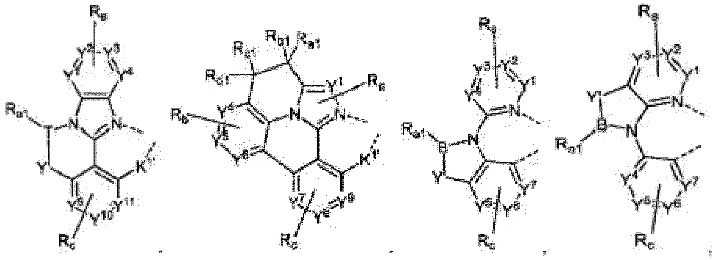 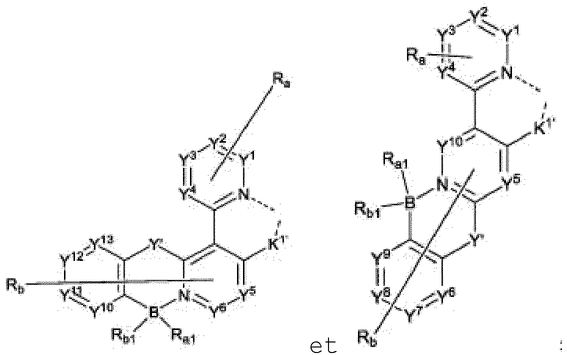 dans lequel :
T est sélectionné dans le groupe consistant en B, Al, Ga et In ;
K^{1'} est sélectionné dans le groupe consistant en une liaison simple, O, S, NRₑ, PRₑ, BRₑ, CRₑR_{f} et SiRₑR_{f} ;
chacun de Y¹ à Y¹³ est sélectionné indépendamment dans le groupe consistant en C et N ;
Y' est sélectionné dans le groupe consistant en BRₑ, BRₑR_{f}, NRₑ, PRₑ, P(O)Rₑ, O, S, Se, C=O, C=S, C=Se, C=NRₑ, C=CRₑR_{f}, S=O, SO₂, CRₑR_{f}, SiRₑR_{f} et GeRₑR_{f} ;
Rₑ et R_{f} peuvent être fusionnés ou liés pour former un cycle ;
chaque Rₐ, R_{b}, R_{c} et R_{d} représente indépendamment une mono-substitution à un nombre maximal de substitutions autorisé, ou aucune substitution ;
chacun de Rₐ₁, R_{b1}, R_{c1}, R_{d1}, Rₐ, R_{b}, R_{c}, R_{d}, Rₑ et R_{f} est indépendamment hydrogène ou un substituant sélectionné dans le groupe consistant en deutérium, halogène, alkyle, cycloalkyle, hétéroalkyle,, arylalkyle, alcoxy, aryloxy, amino, silyle, germyle, boryle, alcényle, cycloalcényle, hétéroalcényle, alcynyle, aryle, hétéroaryle, acyle, carbonyle, acide carboxylique, ester, nitrile, isonitrile, sulfanyle, sélényle, sulfinyle, sulfonyle, phosphino et des combinaisons de ceux-ci ; et
deux substituants quelconques de Rₐ₁, R_{b1}, R_{c1}, R_{d1}, Rₐ, R_{b}, R_{c} et R_{d} peuvent être fusionnés ou liés pour former un cycle ou former un ligand multidenté.

11. Composé selon la revendication 9, dans lequel L_{A} peut être sélectionné parmi L_{A*i*-*m*}, dans lequel *i* est un entier de 1 à 3 136 ; *m* est un entier de 1 à 154 ; et L_{B} peut être sélectionné parmi L_{B*k*}, dans lequel *k* est un entier de 1 à 474, dans lequel :
lorsque le composé présente la formule Ir(L_{A*i*-*m*})₃, le composé est sélectionné dans le groupe consistant en Ir(L_{A*1*-*1*})₃ à Ir(L_{A3136-154})₃ ;
lorsque le composé présente la formule Ir(L_{A*i*-*m*})(L_{B*k*})₂, le composé est sélectionné dans le groupe consistant en Ir(L_{A*1*-*1*})(L_{B*1*})₂ à Ir(L_{A3136-*154*})(L_{B474})₂ ;
lorsque le composé présente la formule Ir(L_{A*i*-*m*})₂(L_{B*k*}), le composé est sélectionné dans le groupe consistant en Ir(L_{A*1*-}*₁)*₂(L_{B*1*}) à Ir(L_{A3136-*154*})₂(L_{B474}) ;
lorsque le composé présente la formule Ir(L_{A*i*-*m*})₂(L_{C*j*-I}), le composé est sélectionné dans le groupe consistant en Ir(L_{A*1*-*1*})₂(L_{C*1*-*1*}) à Ir(L_{A3136-*154*})₂(L_{C*1416*-I}) ; et
lorsque le composé présente la formule Ir(L_{A*i*-*m*})₂(L_{C*j*-II}), le composé est sélectionné dans le groupe consistant en Ir(L_{A*1*-*1*})₂(L_{C*1-*II}) à Ir(L_{A3136-*154*})₂(L_{C*1416*-II}) ;
dans lequel chaque L_{B*k*} présente la structure définie comme suit : 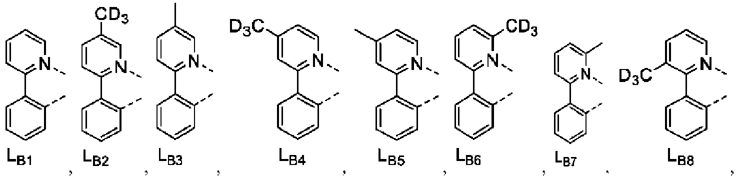 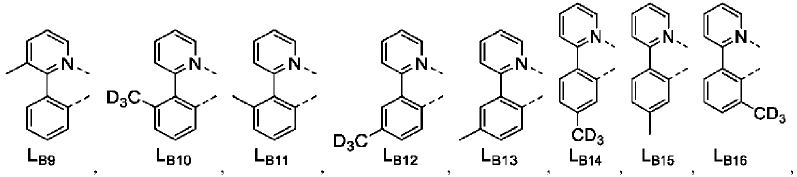 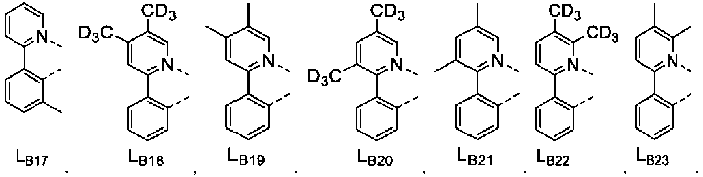 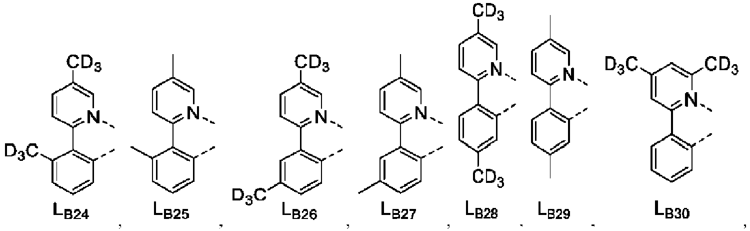 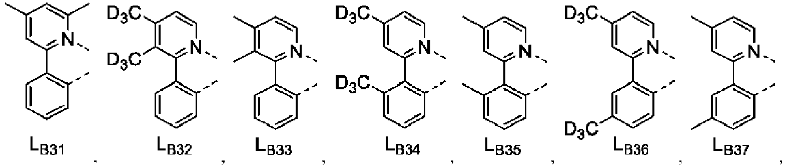 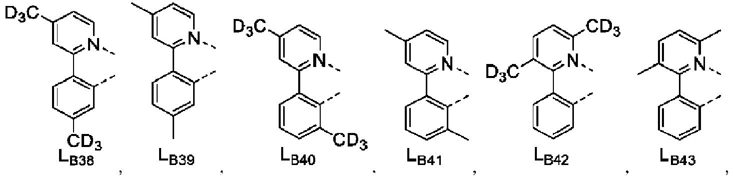 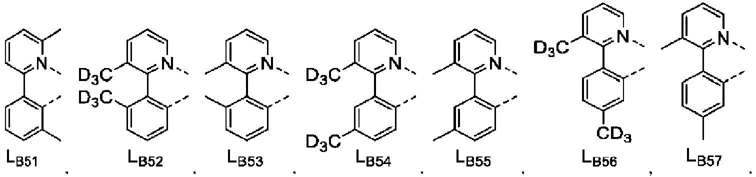 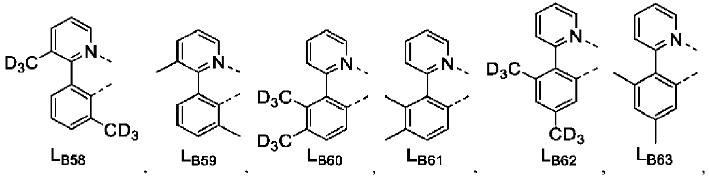 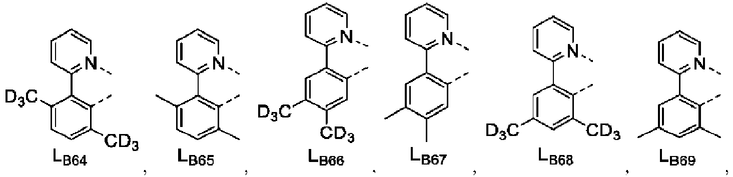 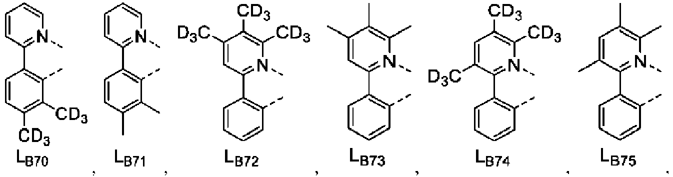 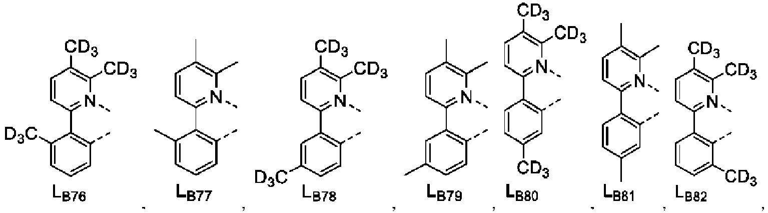 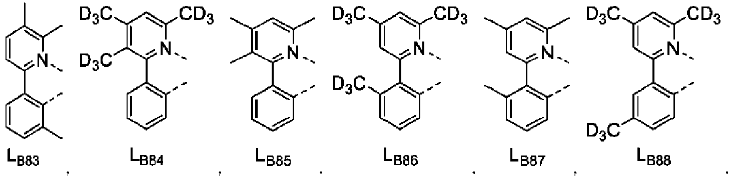 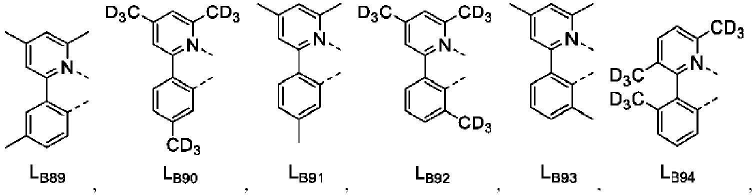 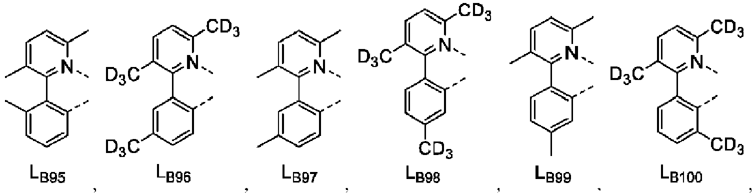 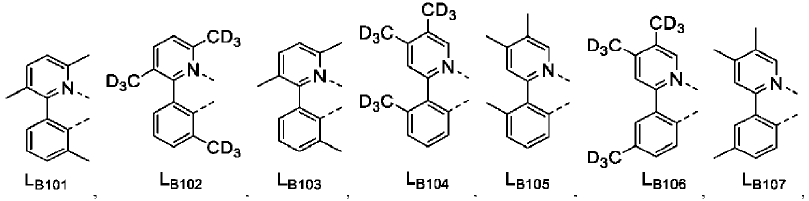 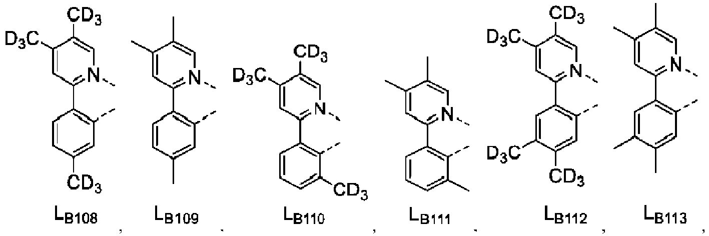 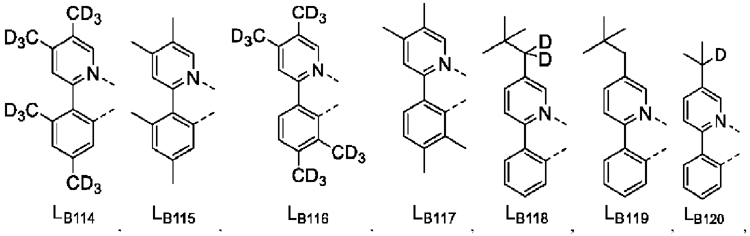 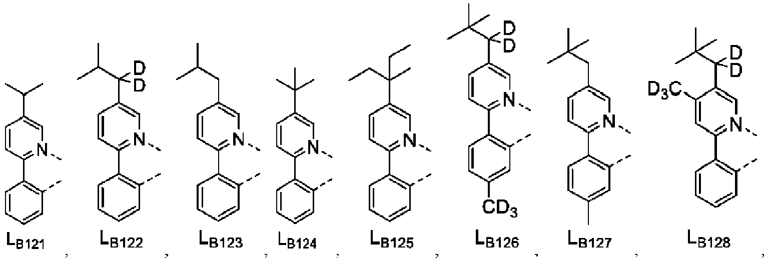 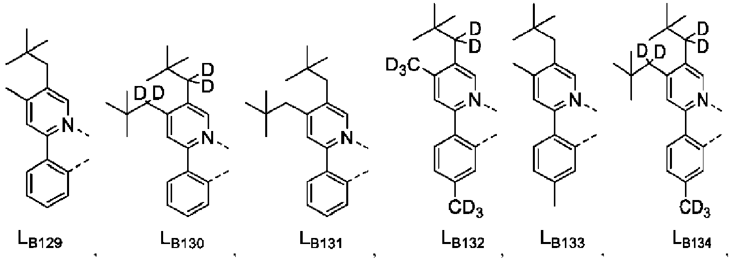 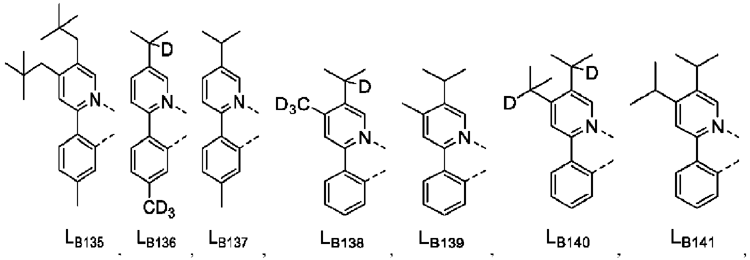 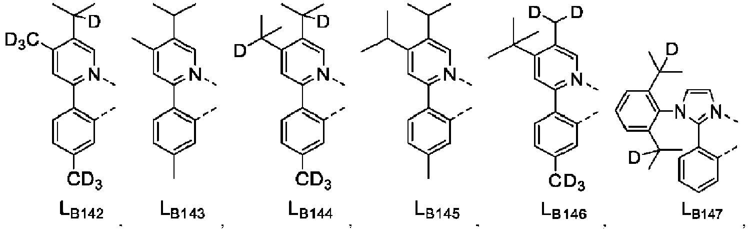 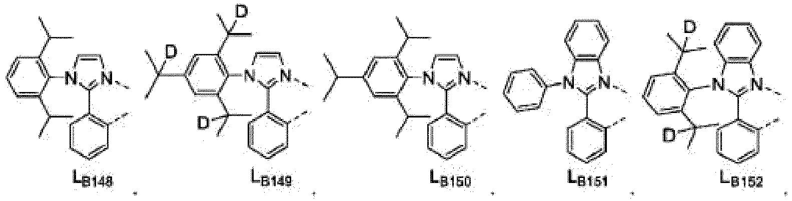 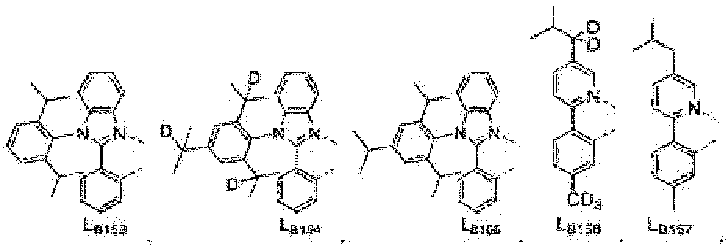 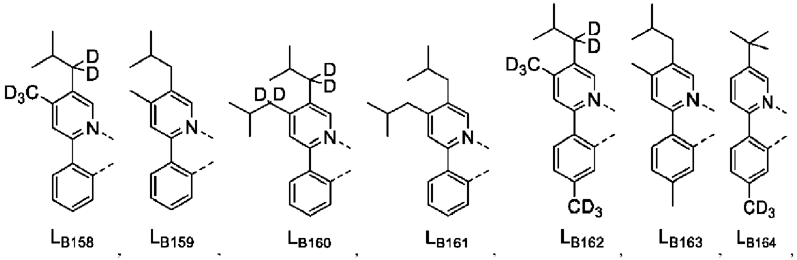 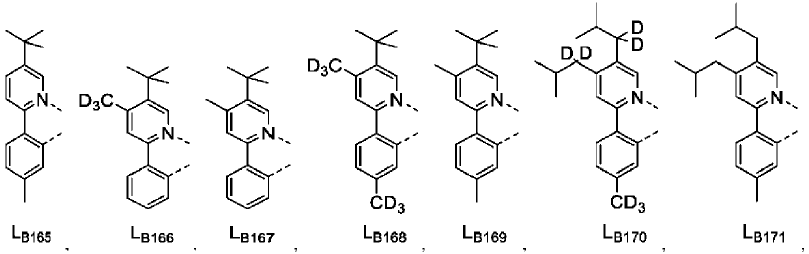 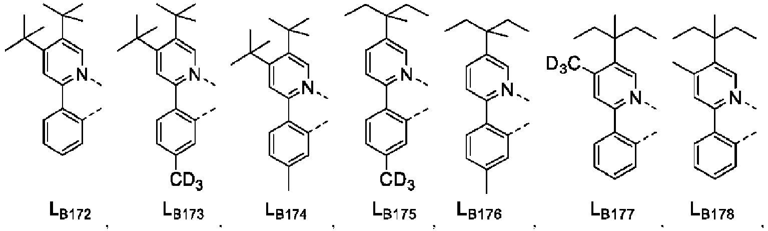 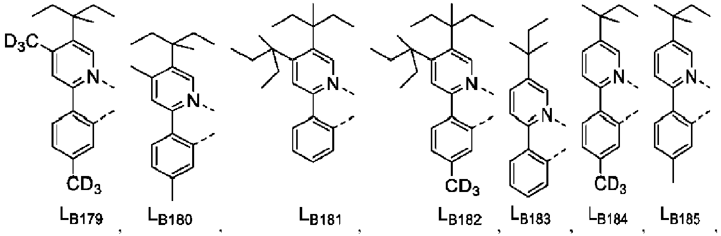 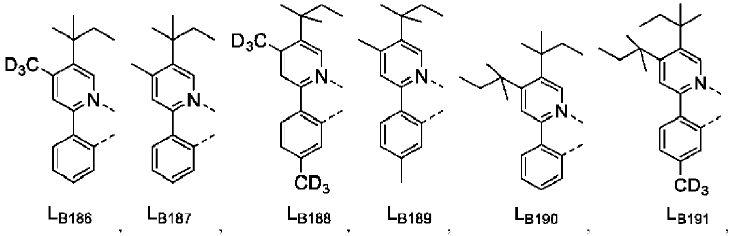 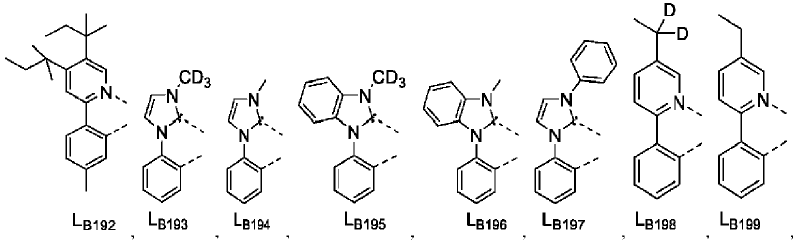 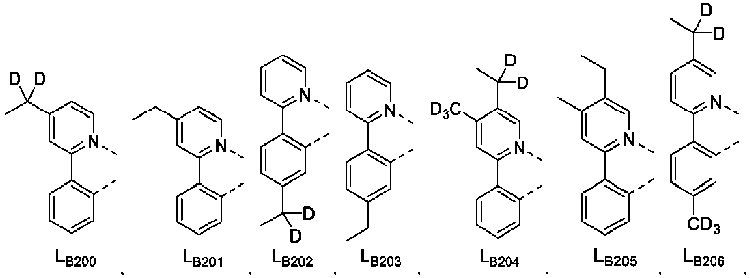 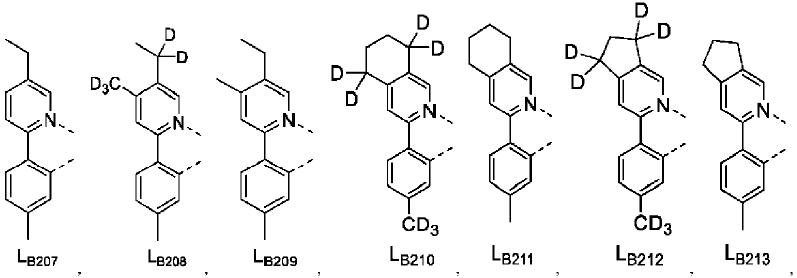 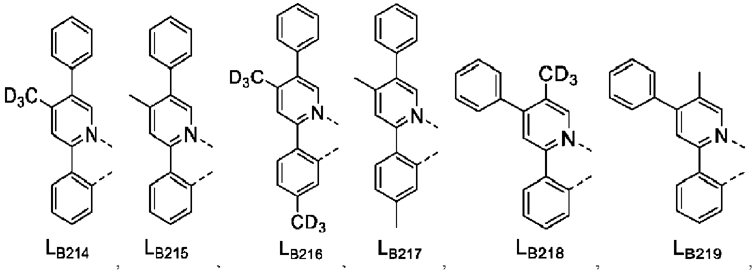 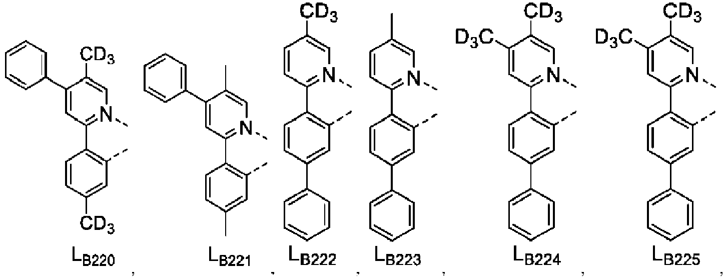 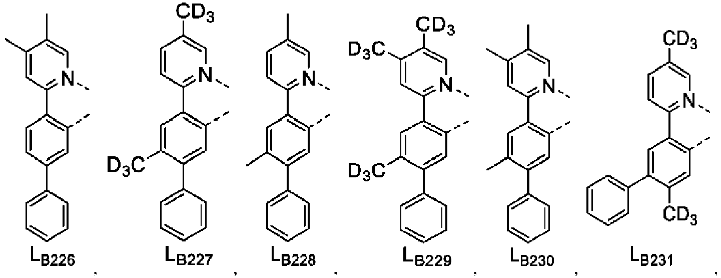 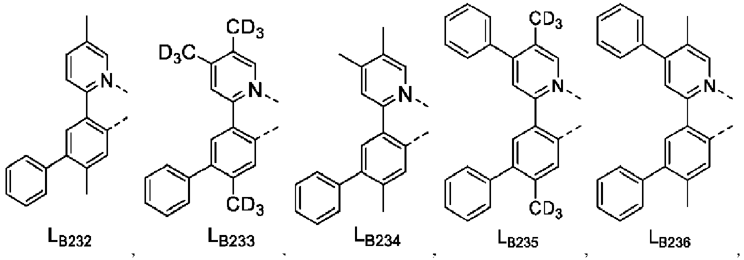 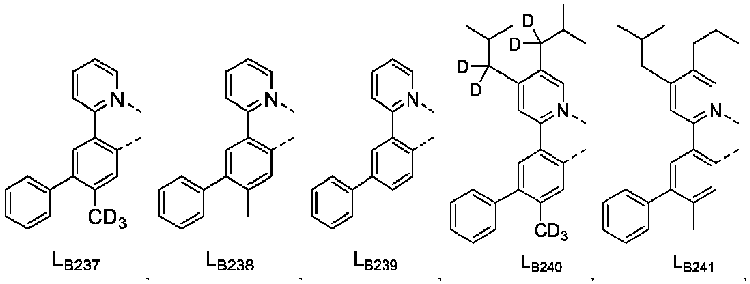 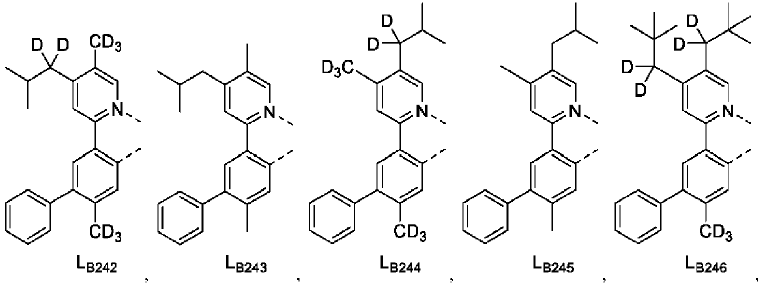 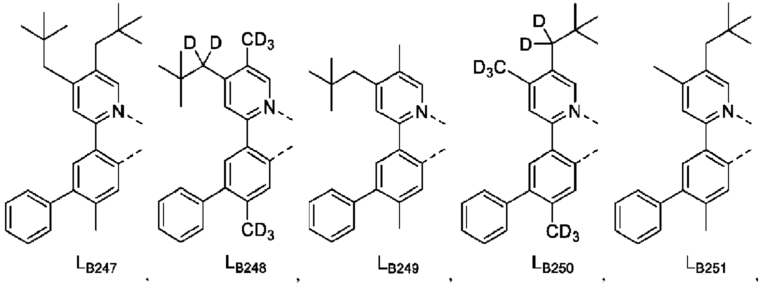 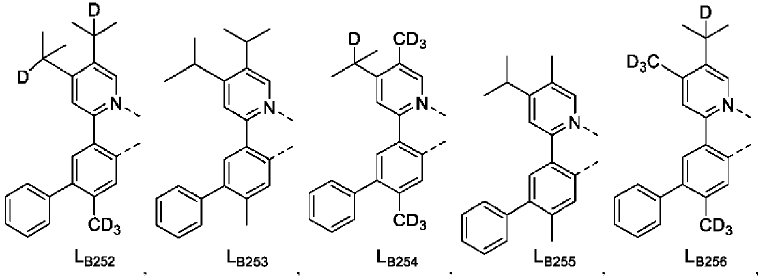 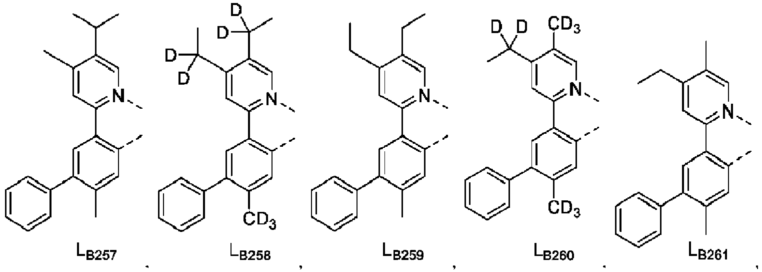 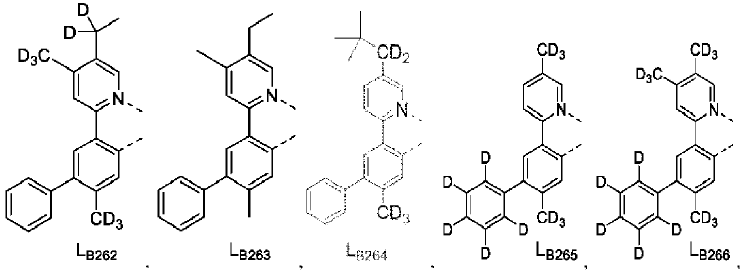 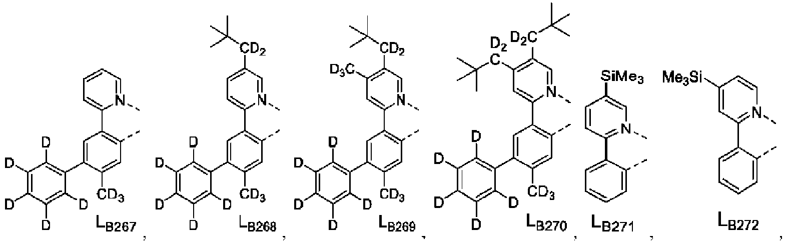 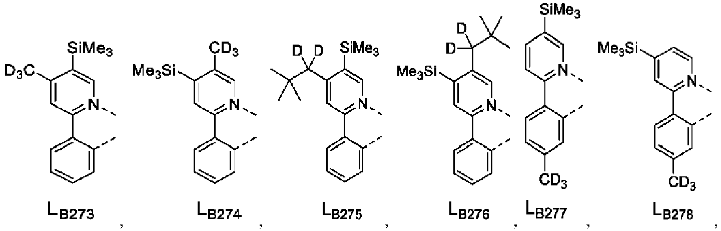 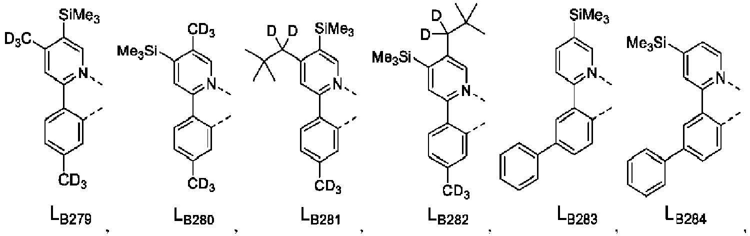 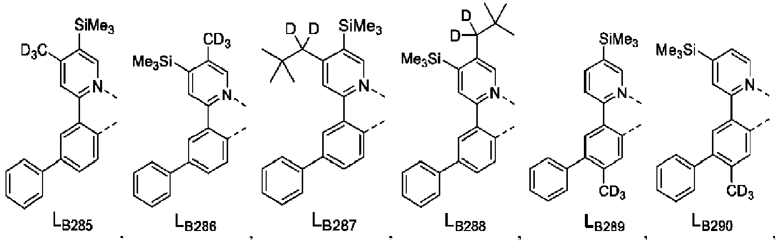 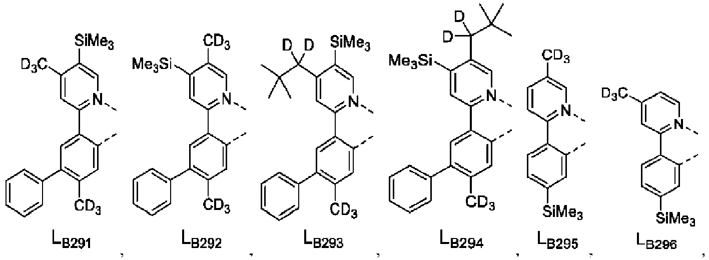 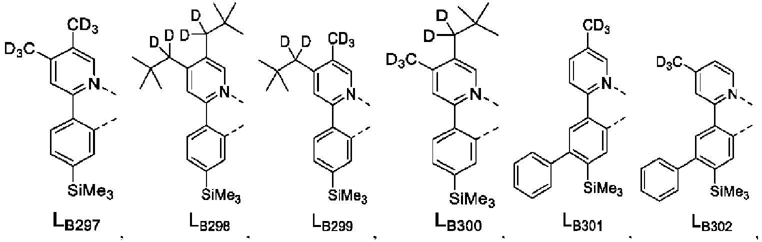 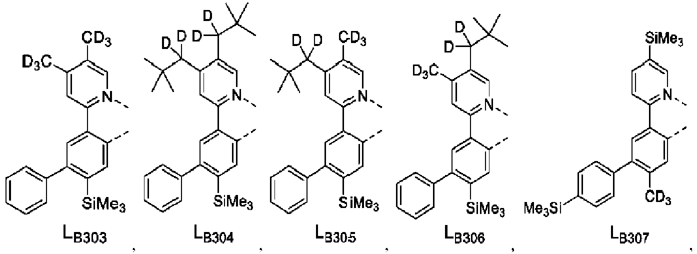 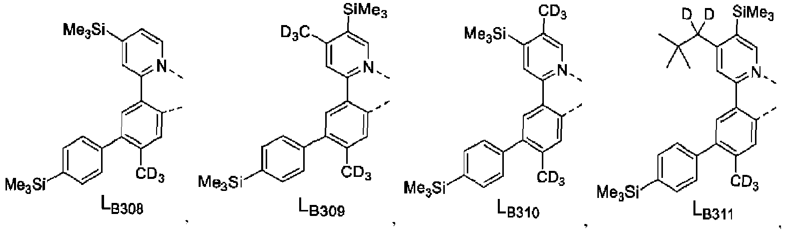 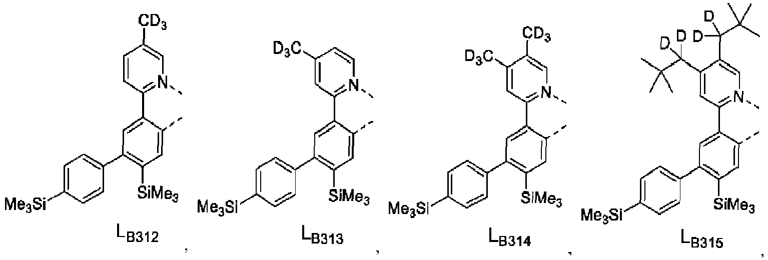 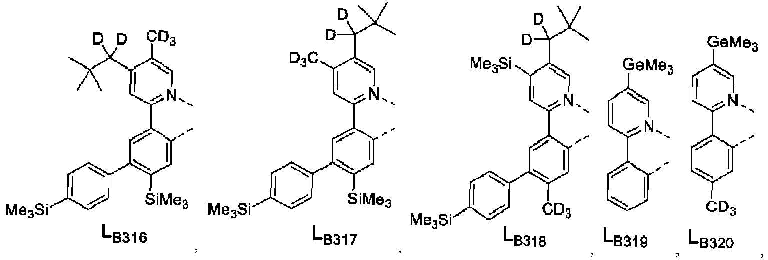 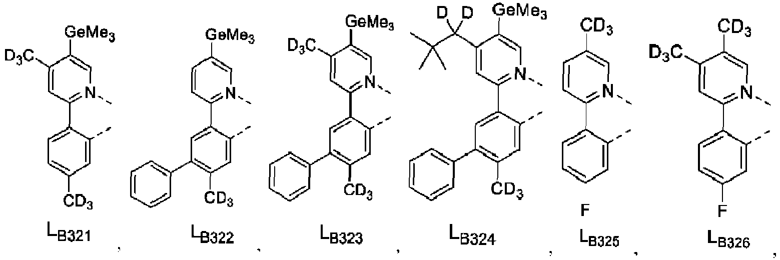 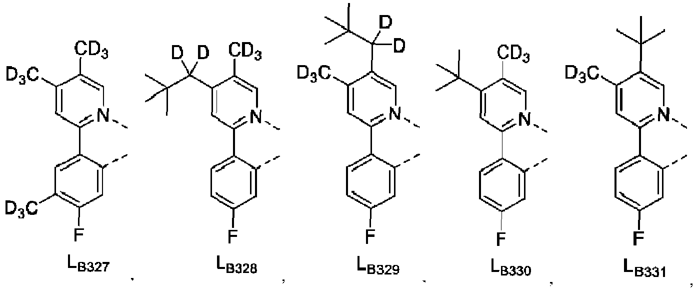 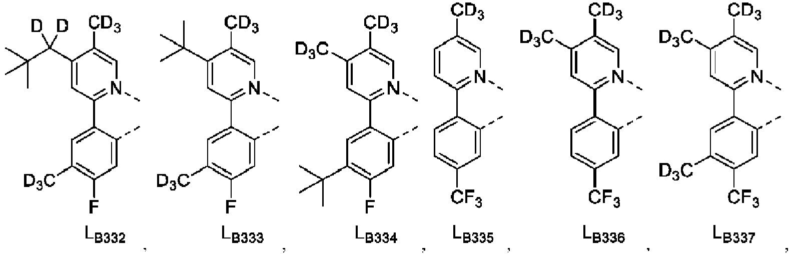 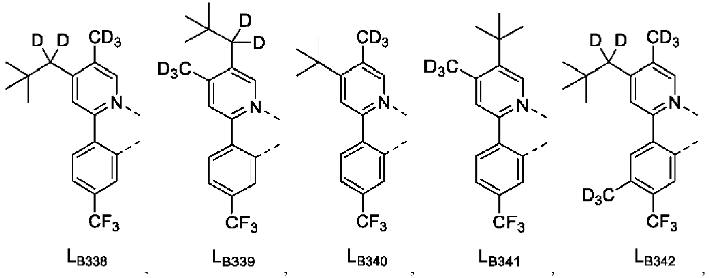 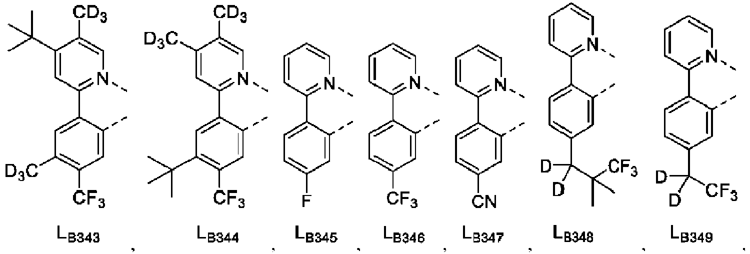 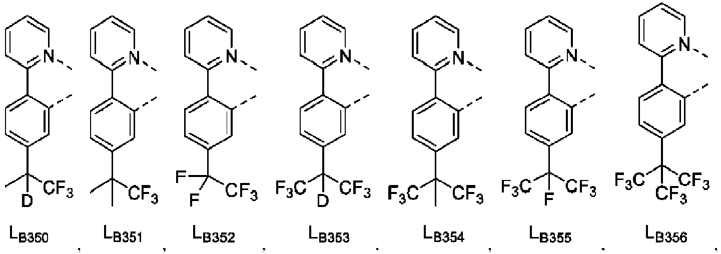 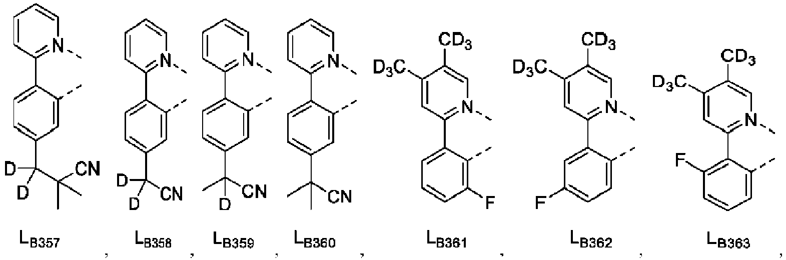 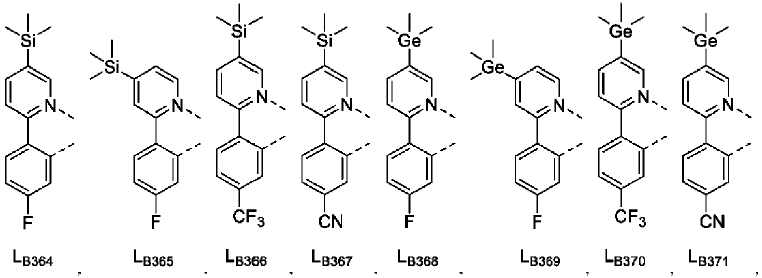 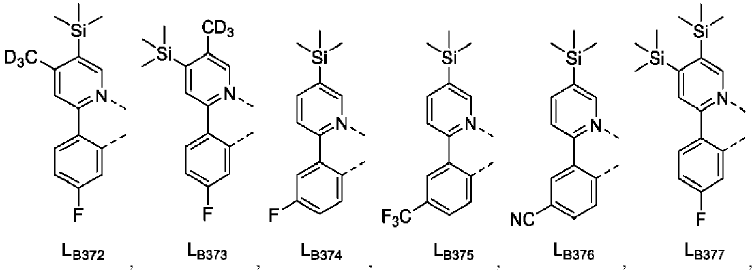 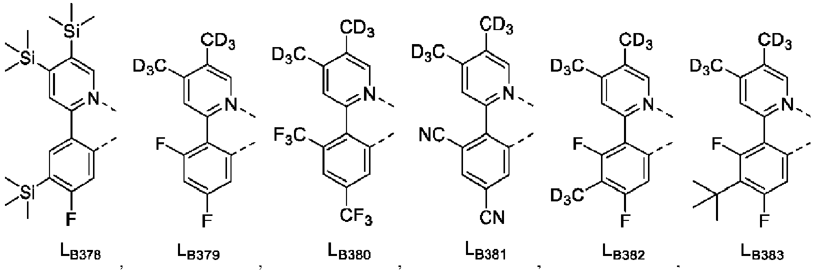 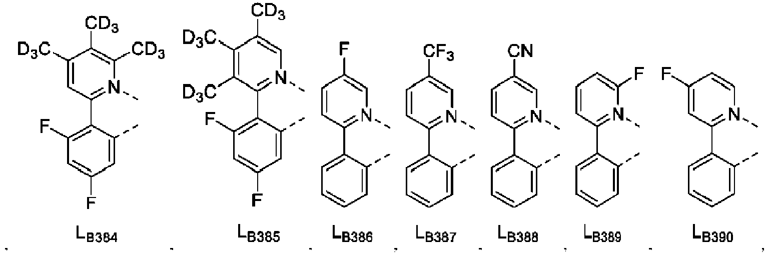 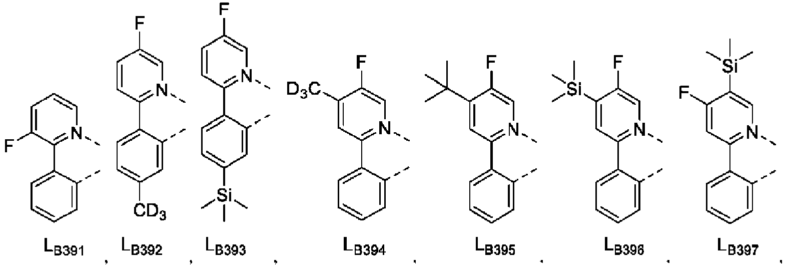 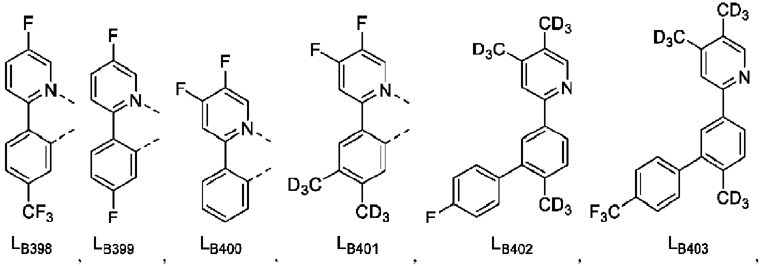 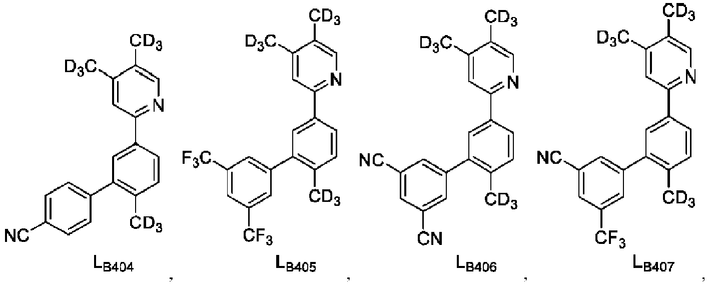 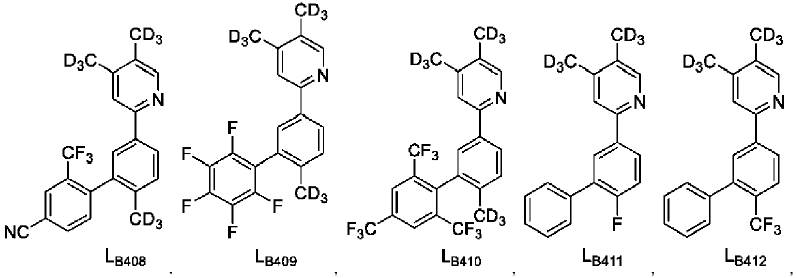 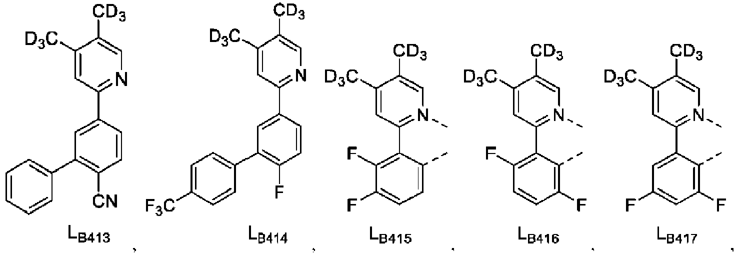 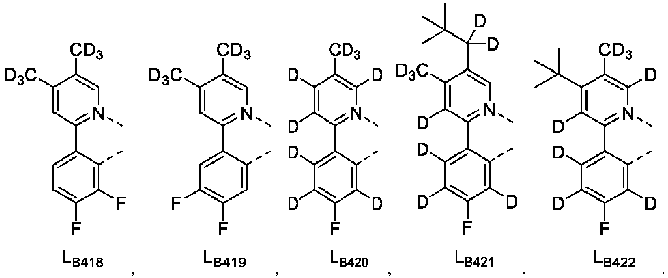 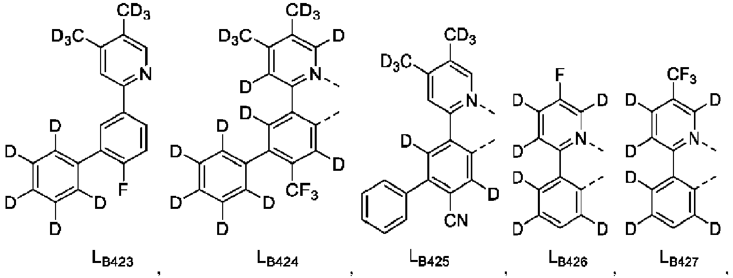 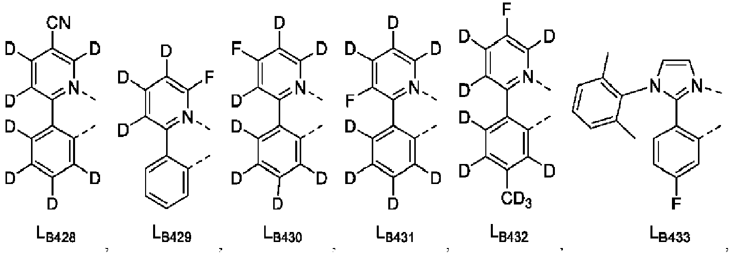 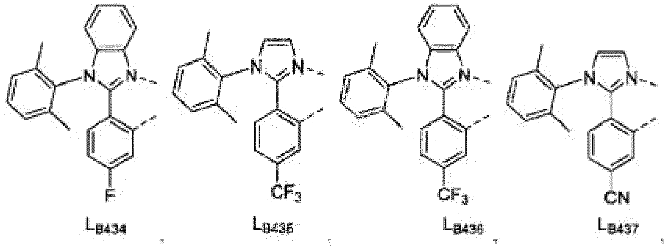 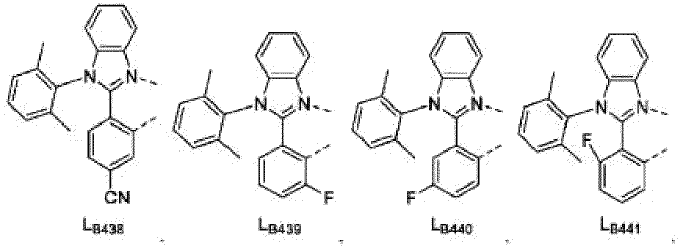 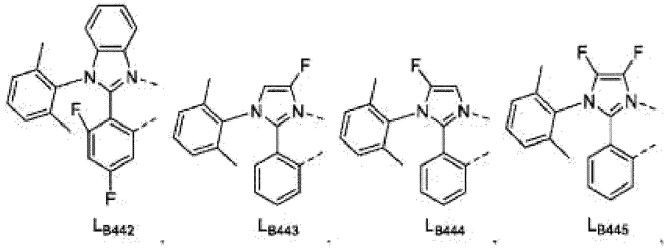 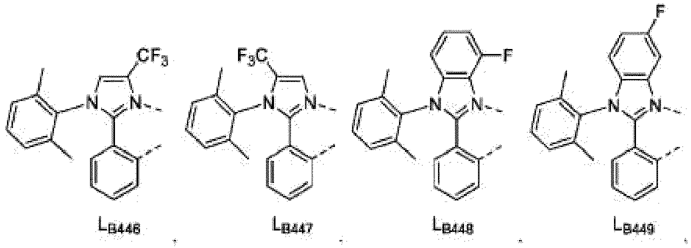 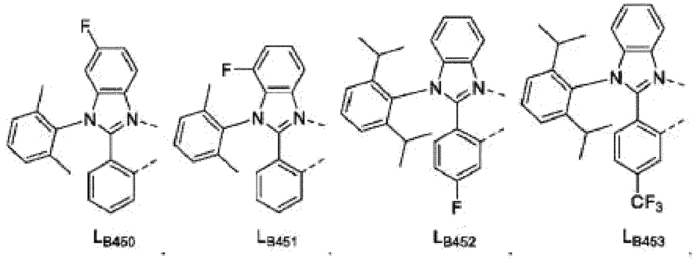 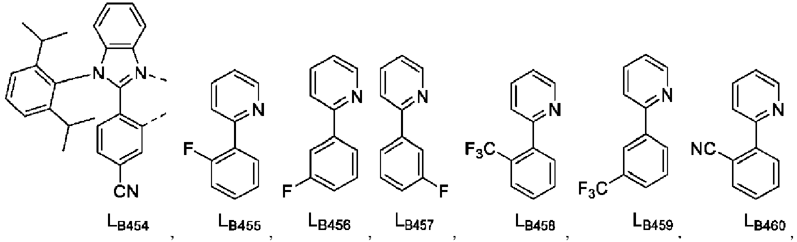 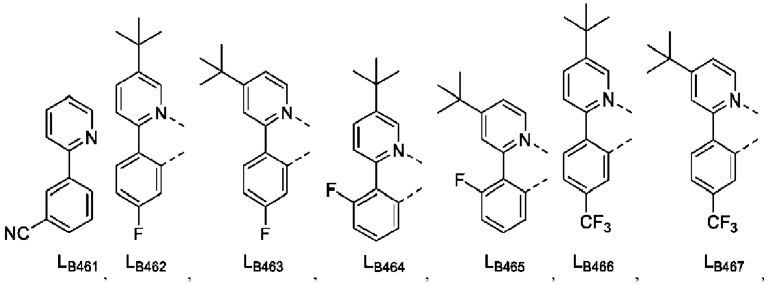 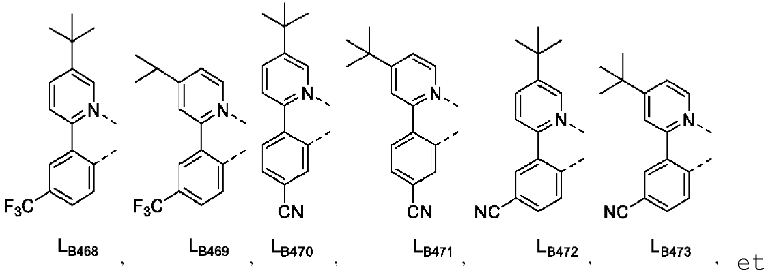 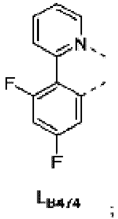
dans lequel chaque L_{C*j*-I} présente une structure basée sur la formule 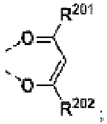 et
chaque L_{C*j*-II} présente une structure basée sur la formule 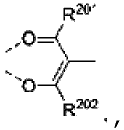 dans lequel pour chaque L_{C*j*} dans L_{C*j*-I} et L_{C*j*-II}, R²⁰¹ et R²⁰² sont chacun indépendamment définis comme suit : 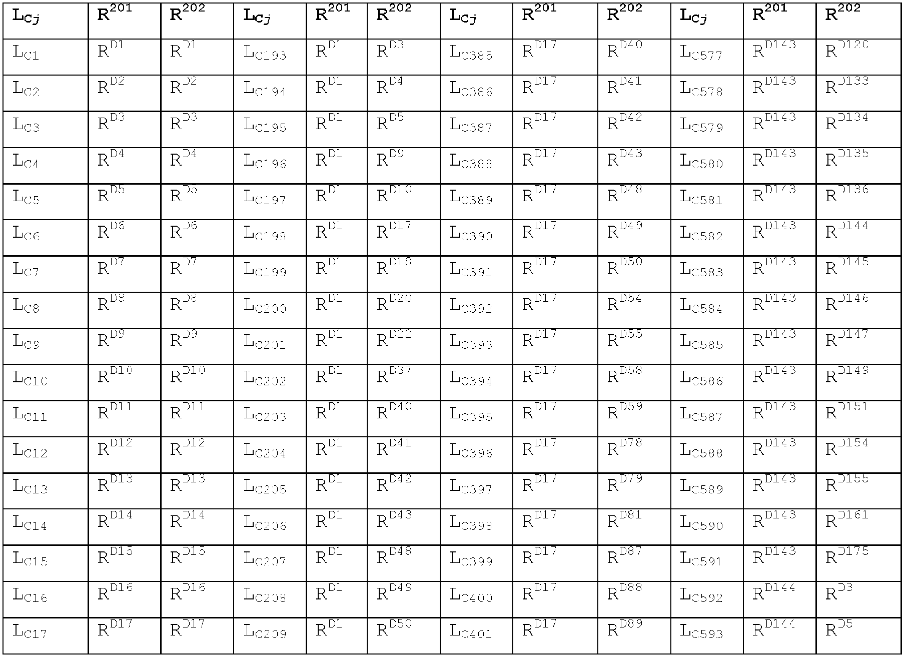 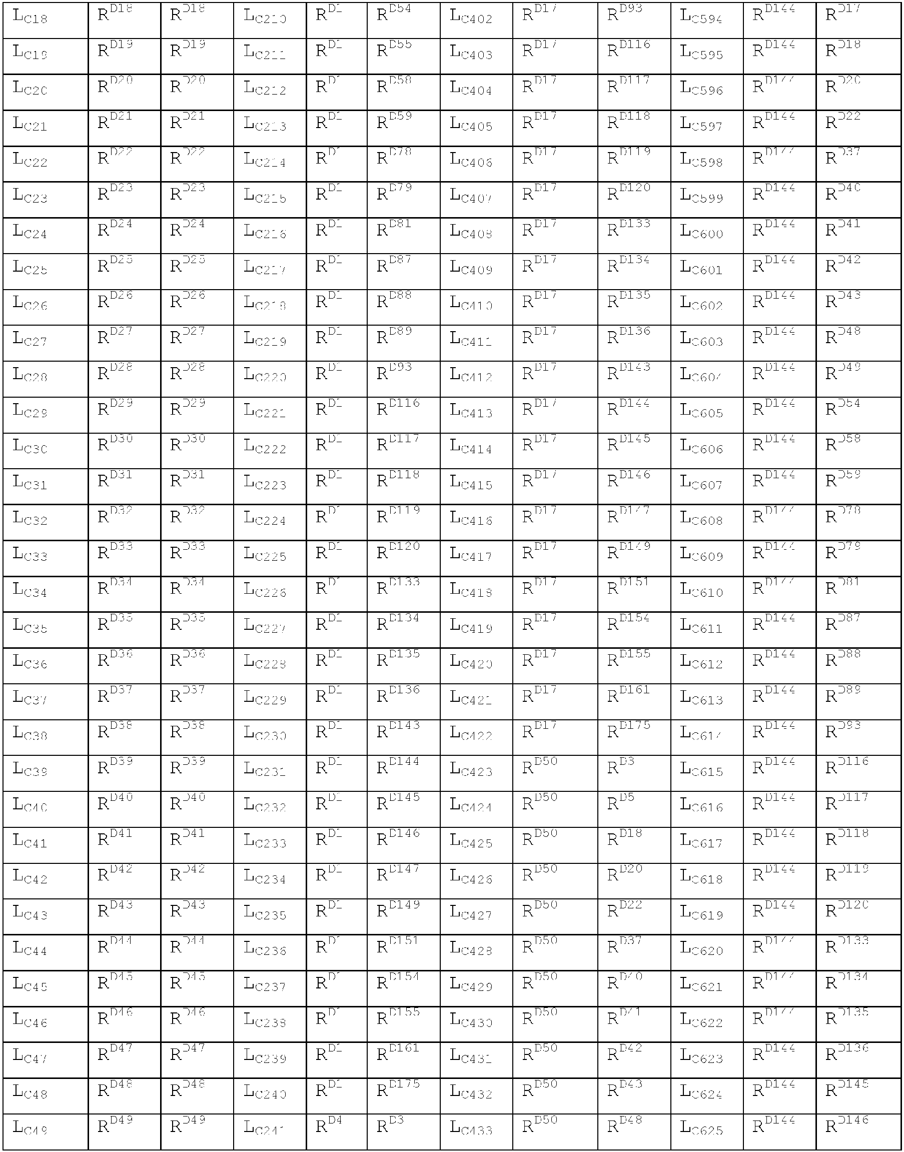 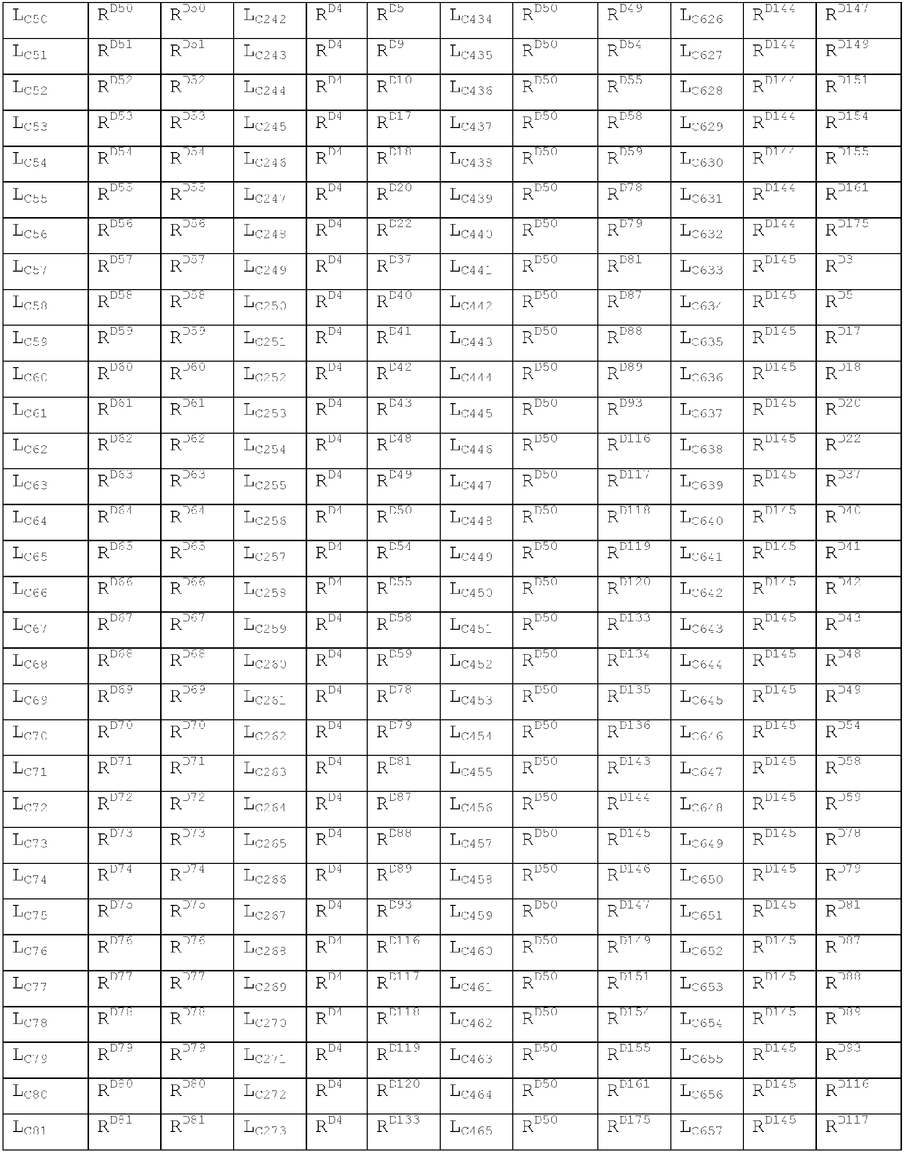 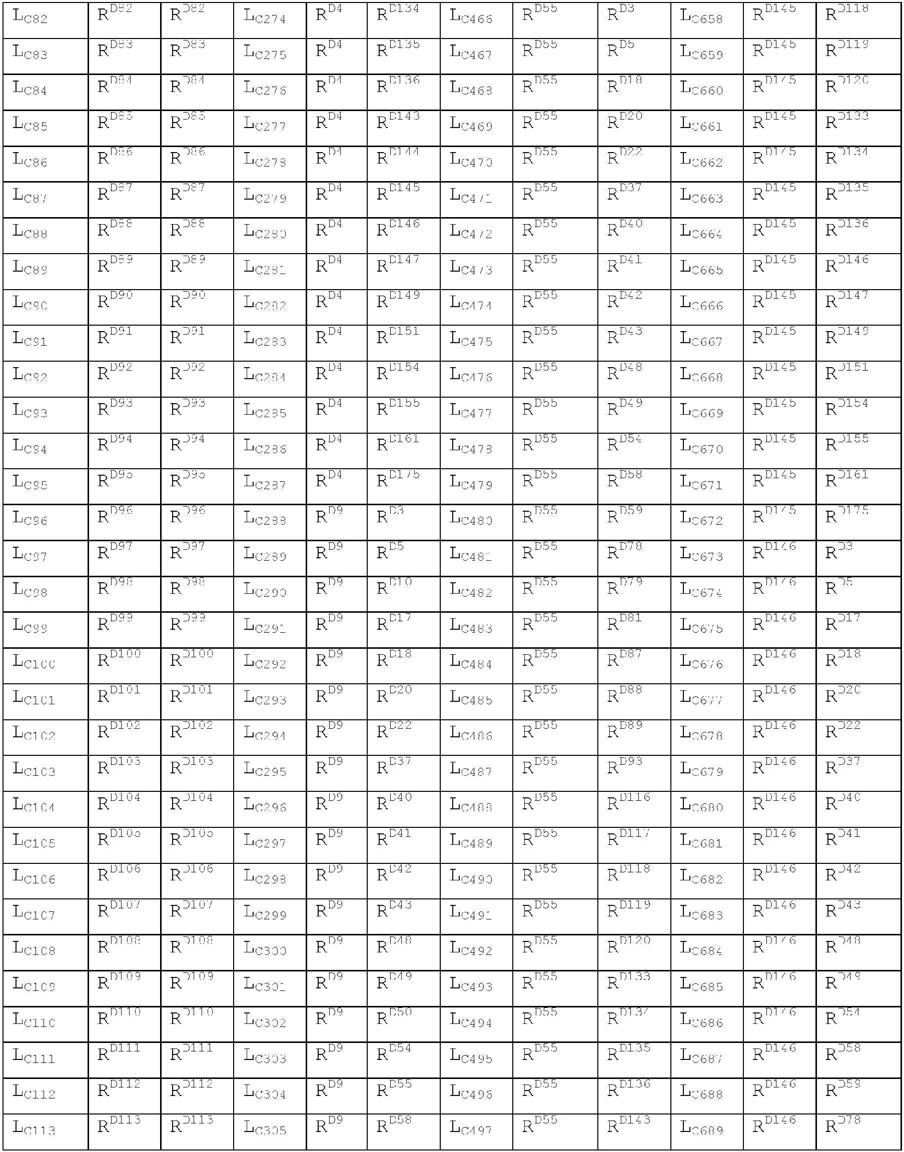 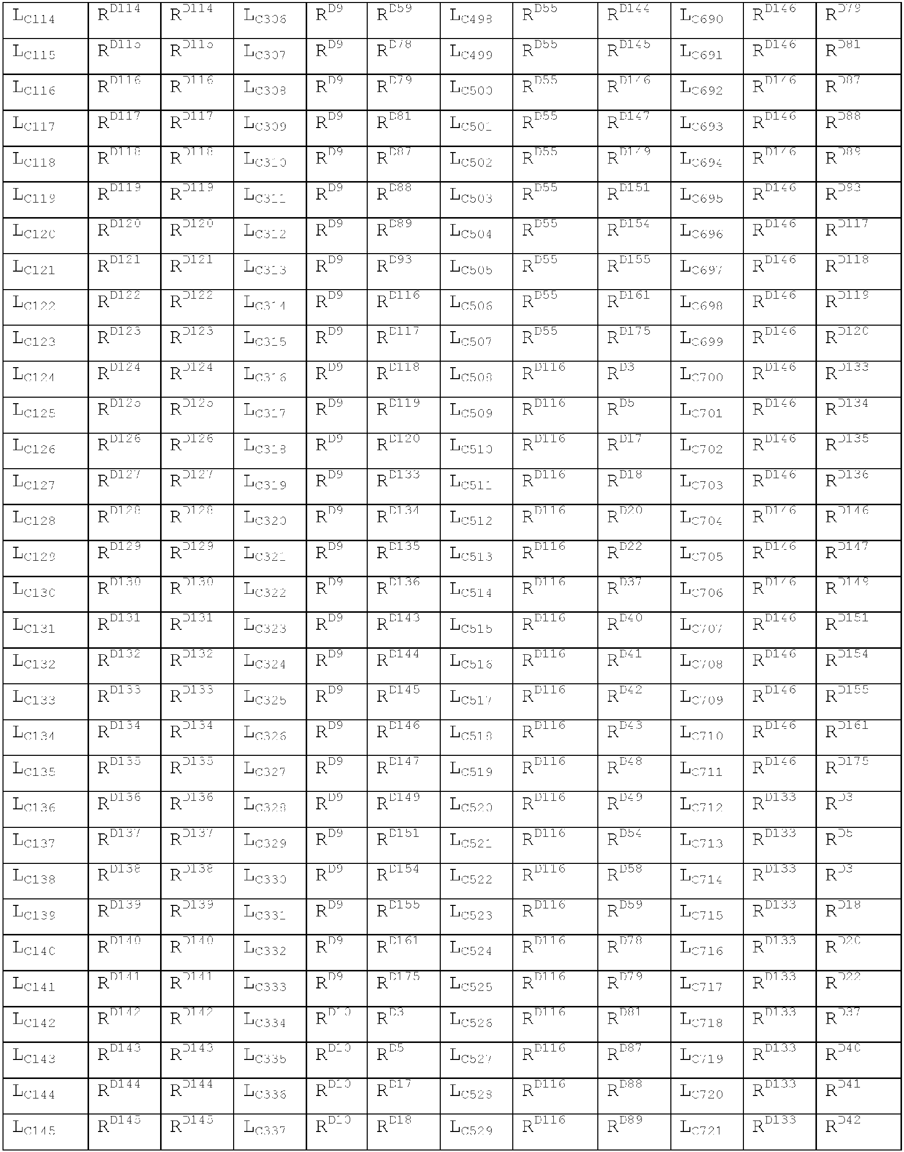 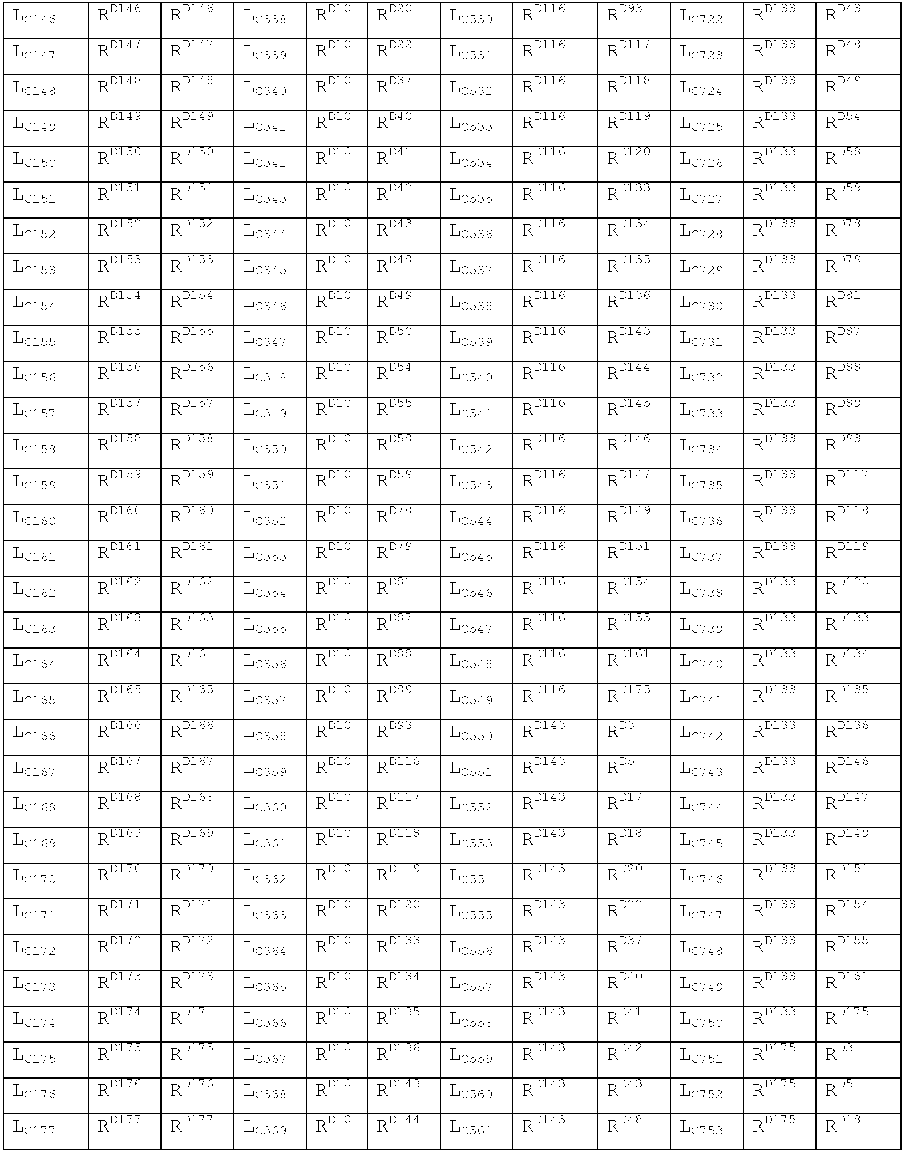 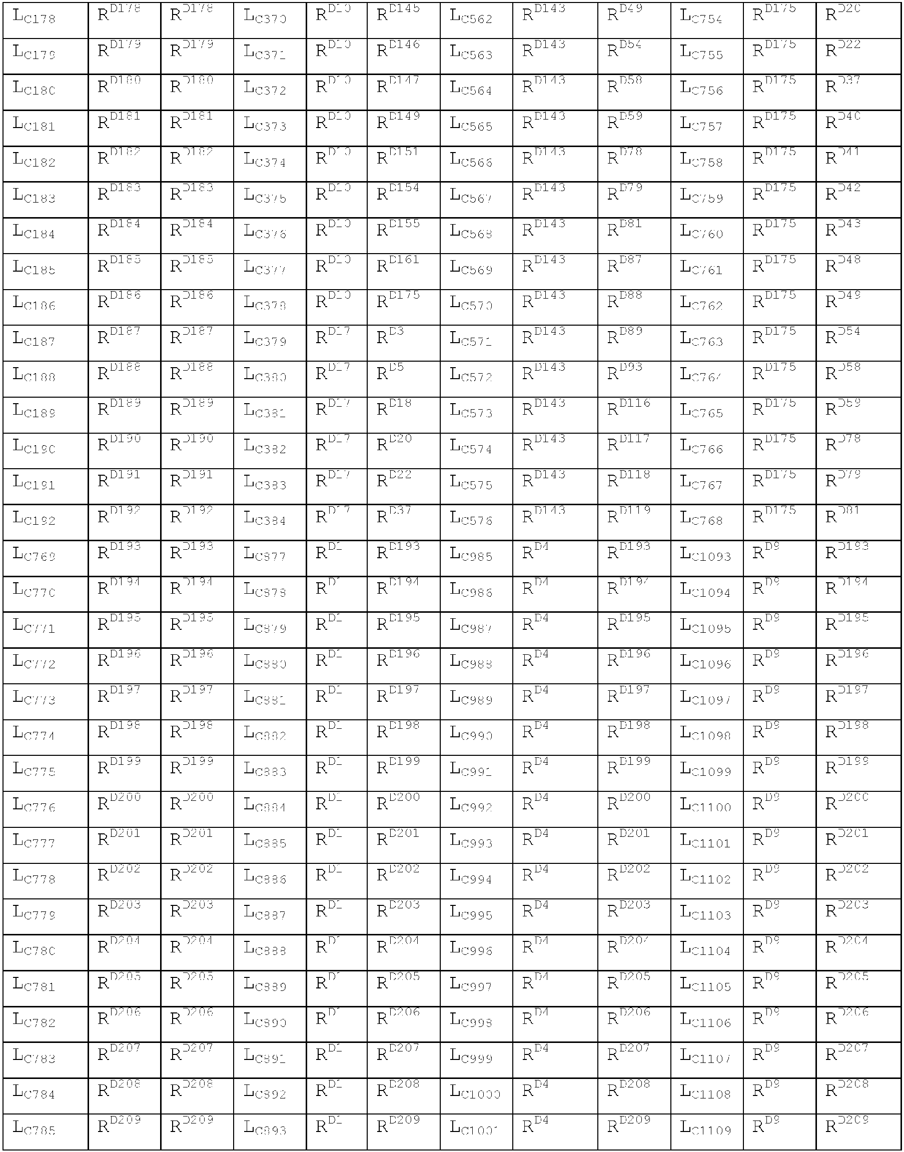 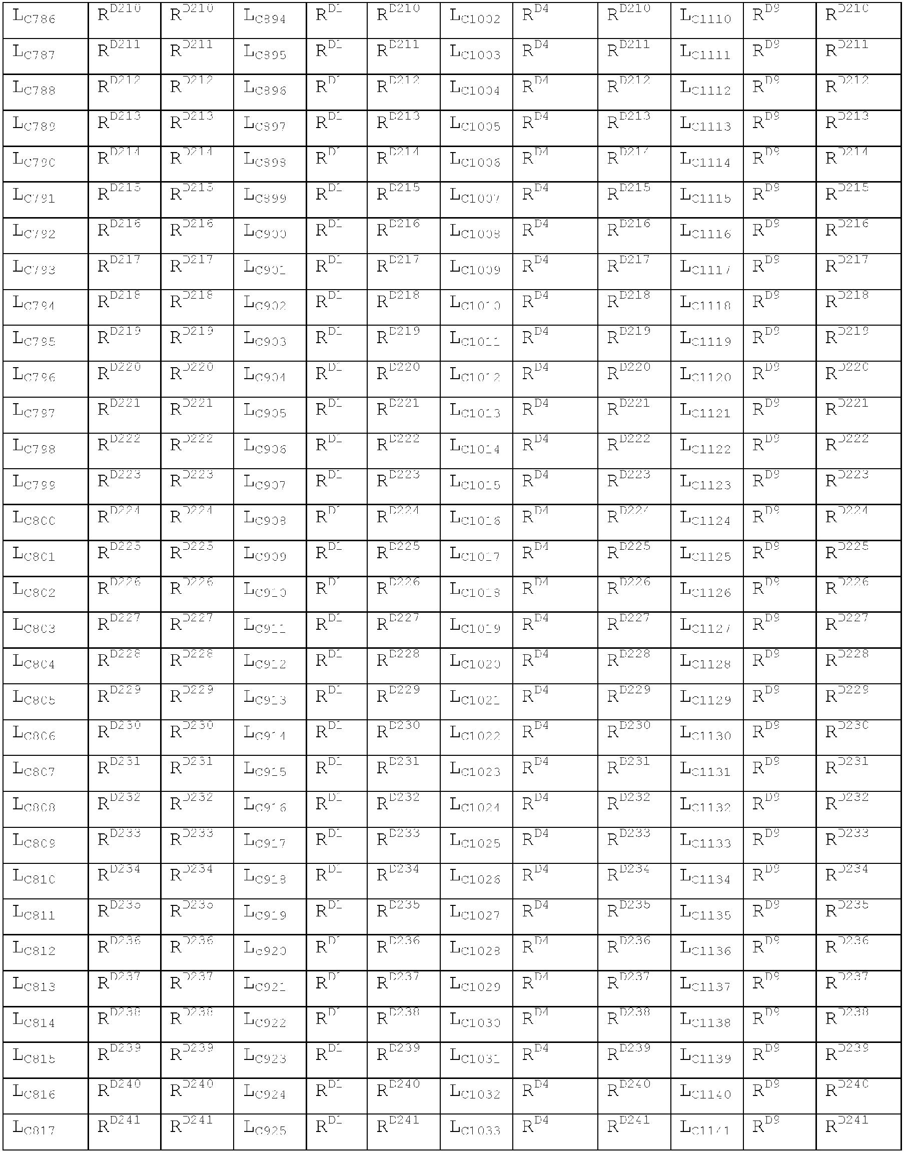 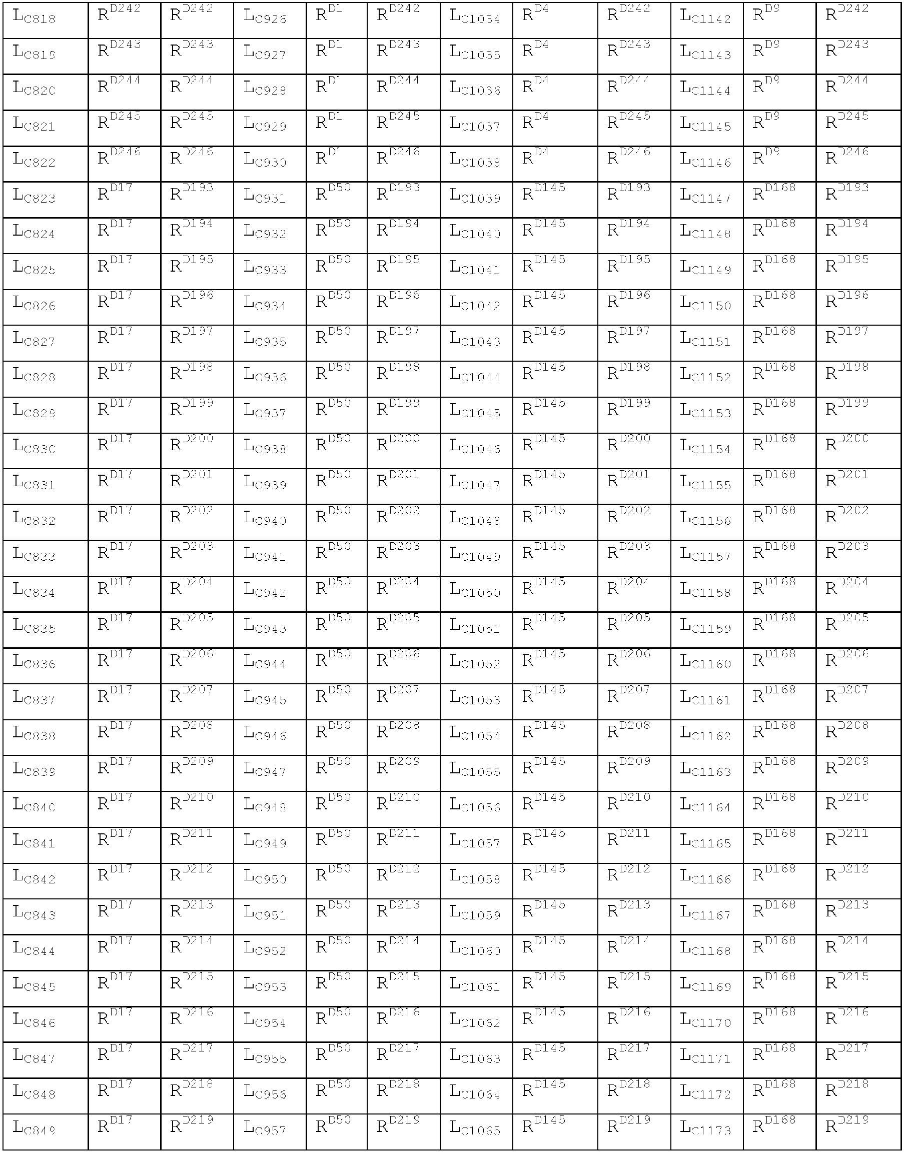 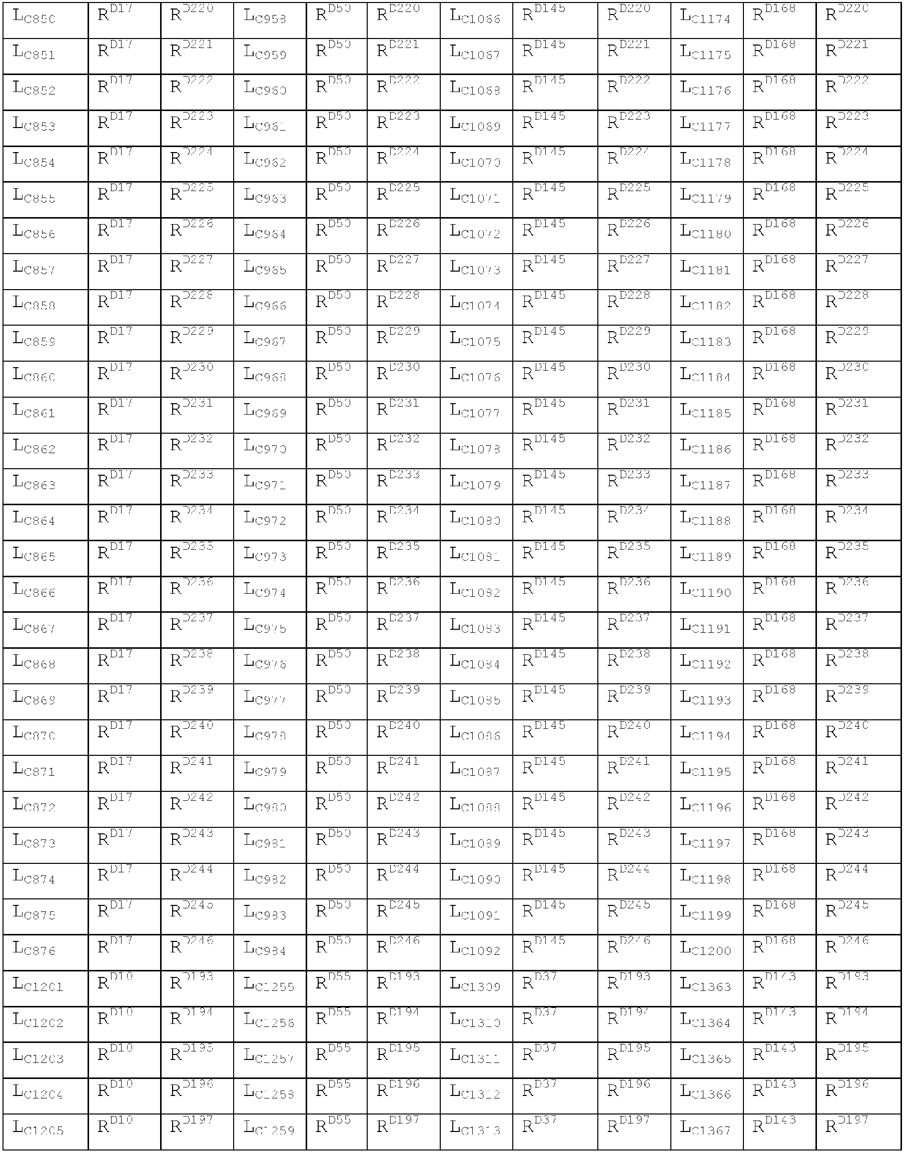 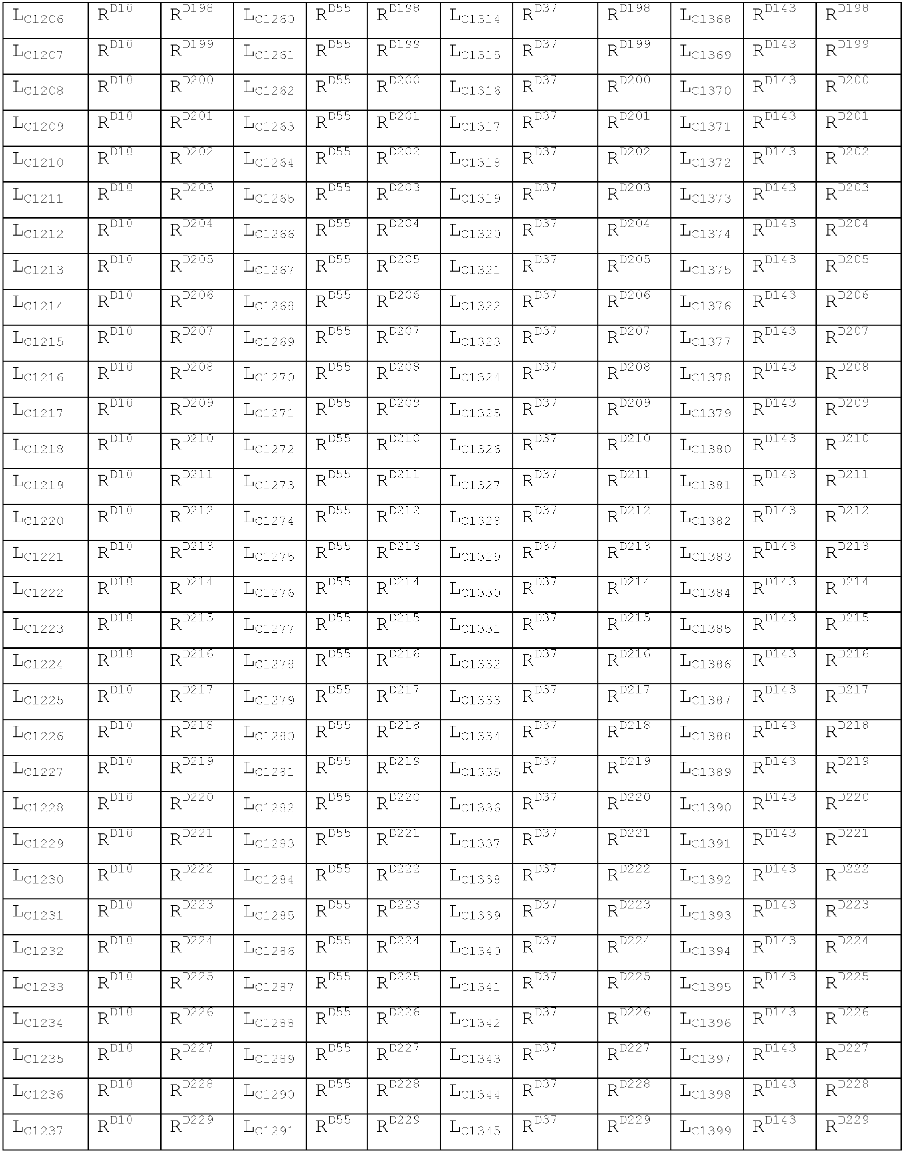 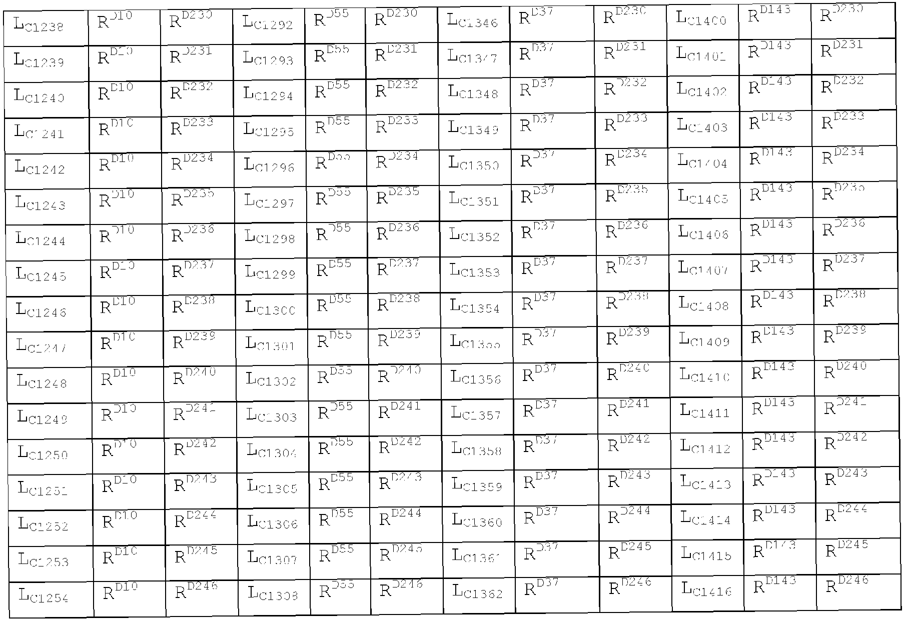
dans lequel R^{D1} à R^{D246} présentent les structures définies comme suit :

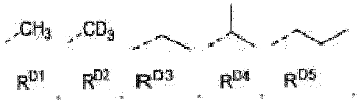

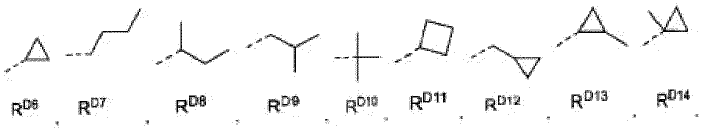

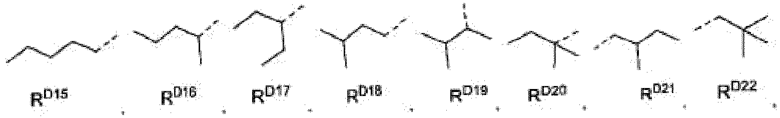

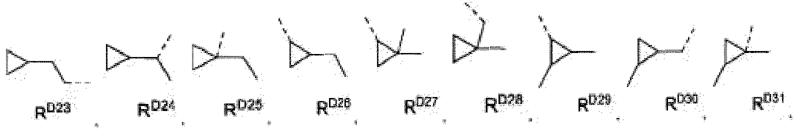

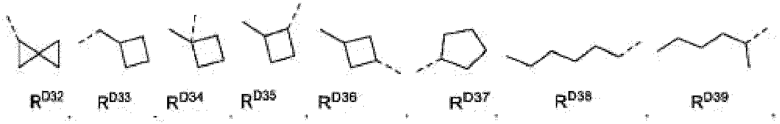

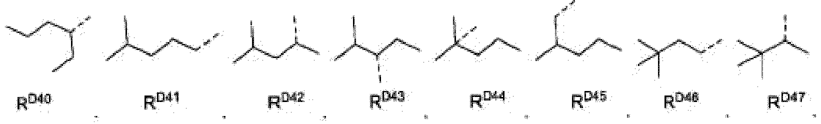

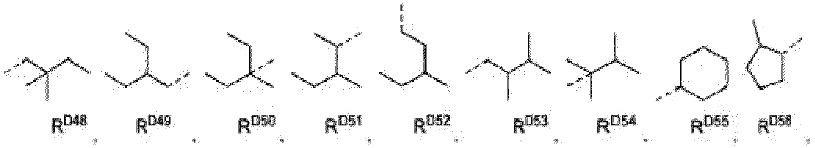

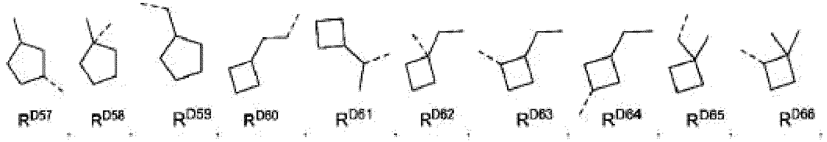

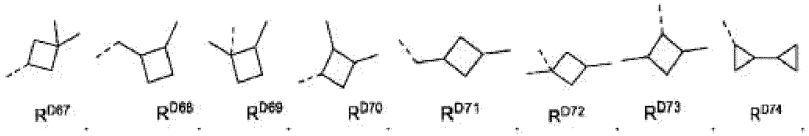

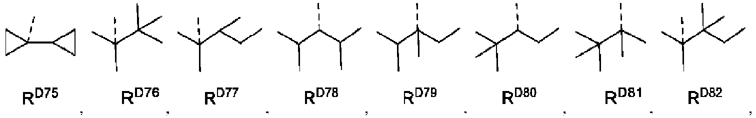

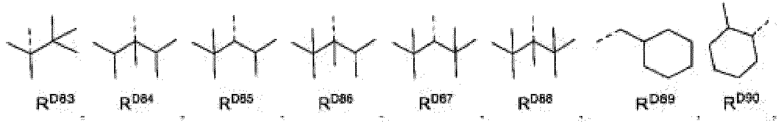

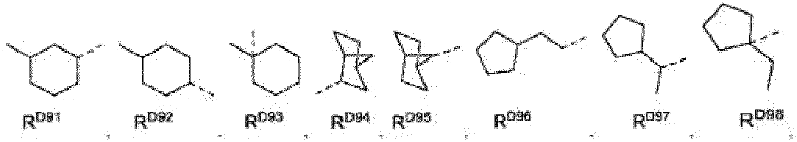

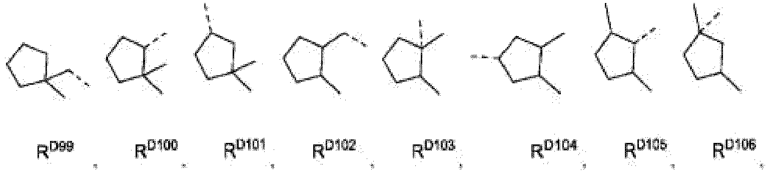

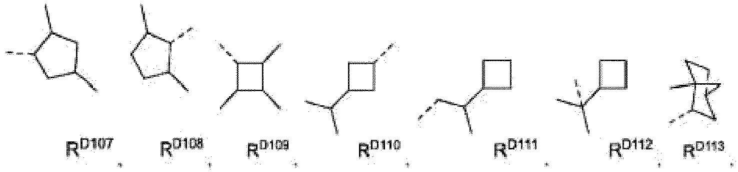

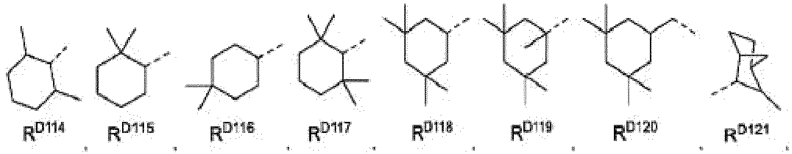

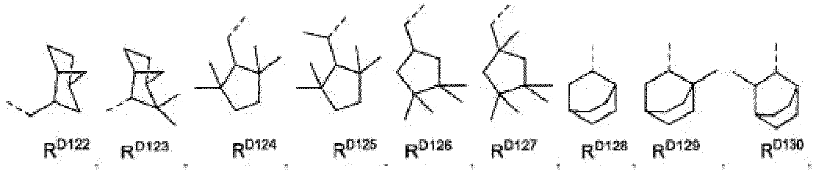

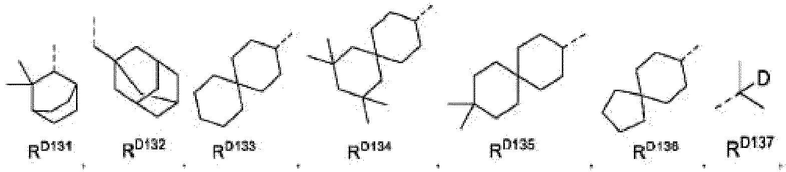

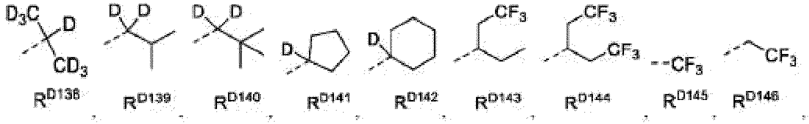

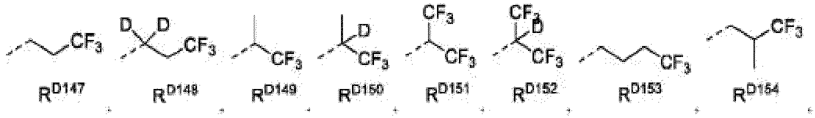

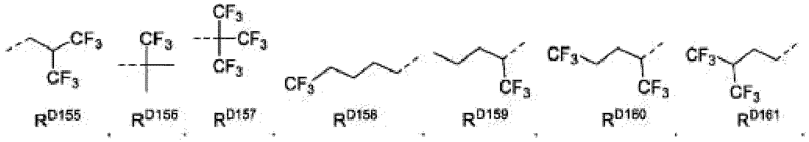

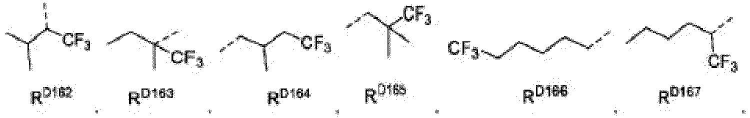

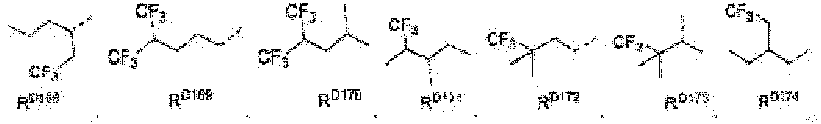

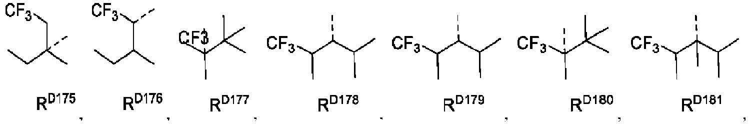

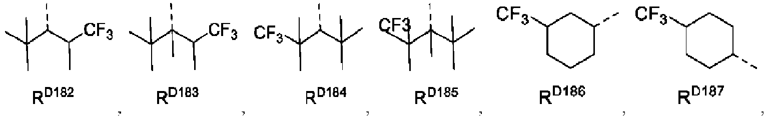

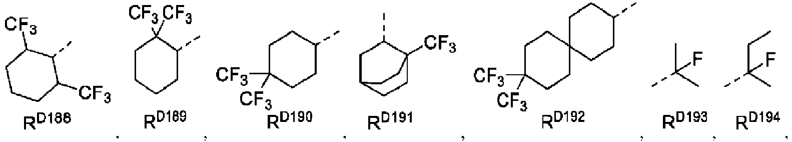

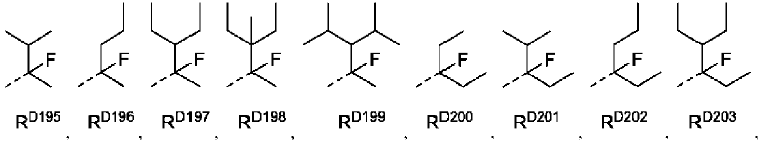

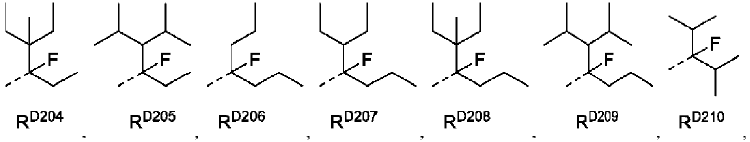

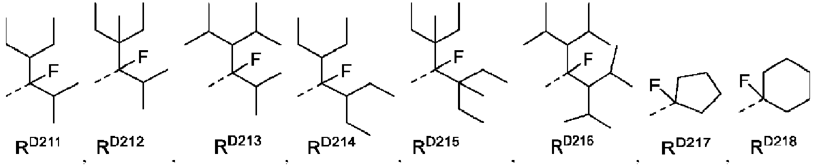

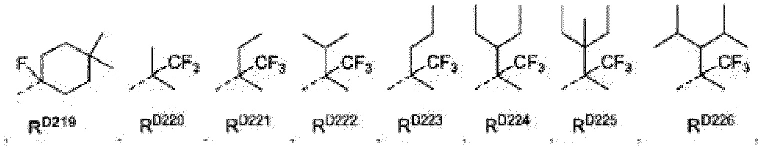

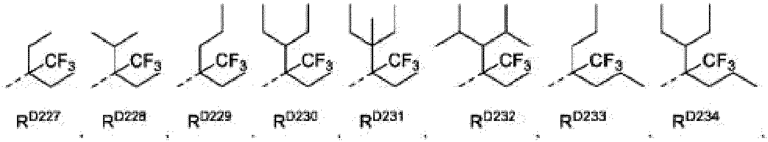

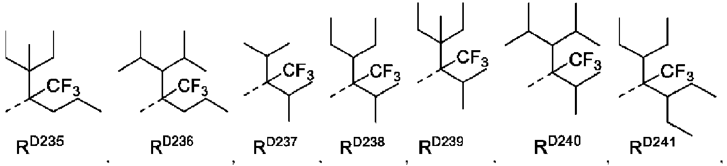

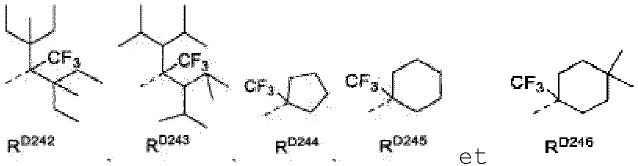

12. Composé selon la revendication 1, dans lequel le composé est sélectionné dans le groupe consistant en les structures de la LISTE 11 définie dans le présent document.

13. Composé selon la revendication 8, dans lequel le composé présente la formule II, 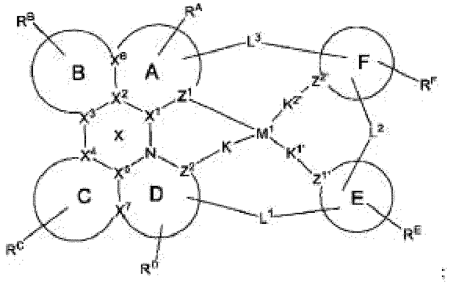 dans lequel :
M¹ est Pd ou Pt ;
les fragments E et F sont chacun indépendamment une structure de cycle monocyclique ou polycyclique comprenant des cycles carbocycliques ou hétérocycliques à 5 chaînons et/ou à 6 chaînons ;
Z^{1'} et Z^{2'} sont chacun indépendamment C ou N ;
K^{1'} et K^{2'} sont chacun indépendamment sélectionnés dans le groupe consistant en une liaison directe, O et S, dans lequel au moins deux parmi K, K^{1'} et K^{2'} sont des liaisons directes ;
L¹, L² et L³ sont chacun indépendamment sélectionnés dans le groupe consistant en une liaison directe,BR, BRR', NR, PR, P(O)R, O, S, Se, C=O, C=S, C=Se, C=NR, C=CRR', S=O, SO₂, CR, CRR', SiRR', GeRR', alkylène, cycloalkyle, aryle, cycloalkylène, arylène, hétéroarylène et des combinaisons de ceux-ci, dans lequel au moins l'un de L¹ et L² est présent ;
R^{E} et R^{F} représentent chacun indépendamment une substitution nulle, une mono-substitution ou peuvent atteindre un nombre maximal de substitutions autorisé à leur cycle associé ;
chacun de R, R', R^{E} et R^{F} est indépendamment hydrogène ou un substituant sélectionné dans le groupe consistant en deutérium, fluor, alkyle, cycloalkyle, hétéroalkyle, alcoxy, aryloxy, amino, silyle, boryle, alcényle, cycloalcényle, hétéroalcényle, aryle, hétéroaryle, nitrile, isonitrile, sulfanyle et des combinaisons de ceux-ci ; et
deux R^{A}, R^{B}, R^{C}, R^{E} et R^{F} adjacents peuvent être liés ou fusionnés pour former un cycle.

14. Dispositif électroluminescent organique comprenant :
une anode ;
une cathode ; et
une couche organique disposée entre l'anode et la cathode,
dans lequel la couche organique comprend un composé selon
la revendication 1.

15. Produit de consommation comprenant un dispositif électroluminescent organique comprenant :
une anode ;
une cathode ; et
une couche organique disposée entre l'anode et la cathode, dans lequel la couche organique comprend un composé selon la revendication 1.
